# EUROPEAN PATENT APPLICATION

(11) **EP 4 847 999 A1**
(43) Date of publication of application: **02.12.2026**
(21) Application number: 26181481.8
(22) Date of filing: 28.05.2026
(51) Int. Cl.: G03F 7/004, G03F 7/039

(54) **CHEMICALLY AMPLIFIED POSITIVE RESIST COMPOSITION AND RESIST PATTERN FORMING PROCESS**

(30) Priority: 28.05.2025 JP 2025089183
(71) Applicant: SHIN-ETSU CHEMICAL CO., LTD., Tokyo 100-0005 (JP)
(72) Inventor: FUKUSHIMA, Masahiro, NIIGATA, 9428601 (JP); WATANABE, Satoshi, NIIGATA, 9428601 (JP); KOTAKE, Masaaki, NIIGATA, 9428601 (JP); MATSUZAWA, Yuta, NIIGATA, 9428601 (JP); HOSHINO, Yuki, NIIGATA, 9428601 (JP); HIROKAWA, Yoshito, NIIGATA, 9428601 (JP)
(74) Representative: Ter Meer und Partner mbB

(57) **Abstract**

A chemically amplified positive resist composition comprising a photoacid generator and a polymer which is decomposed under the action of acid to increase its solubility in an alkaline developer is provided. The photoacid generator is a sulfonium salt consisting of a fused ring type triarylsulfonium cation having fluorine or fluorinated substituent on an aromatic ring and an aromatic sulfonic acid anion having an aromatic ring structure, which has high solvent solubility and generates an acid with adequate acidity and controlled diffusion.

## Description

### TECHNICAL FIELD

This invention relates to a chemically amplified positive resist composition and a resist pattern forming process.

### BACKGROUND ART

Pattern formation to a smaller feature size is required to meet the recent demand for higher integration in integrated circuits. Acid-catalyzed chemically amplified resist compositions are most often used in forming resist patterns with a feature size of 0.2 µm or less. High-energy radiation such as UV, deep-UV or EB is used as the energy source for exposure of these resist compositions. In particular, the EB lithography, which is utilized as the ultra-fine microfabrication technique, is also indispensable in processing a photomask blank into a photomask for use in the fabrication of semiconductor devices. Resist compositions for use in the EB lithography include positive ones wherein exposed regions are dissolved away to form a pattern and negative ones wherein exposed regions are retained to form a pattern. Either one which is easier to use is chosen in accordance with the morphology of the necessary resist pattern.

In general, the EB lithography is by writing an image with EB, without using a mask. In the case of positive resist, those regions of a resist film other than the regions to be retained are successively irradiated with EB having a minute area. In the case of negative resist, those regions of a resist film to be retained are successively irradiated with EB.
The operation of successively scanning all finely divided regions on the work surface takes a long time as compared with full wafer exposure through a photomask. To prevent any throughput decline, a resist film having a high sensitivity is required. Because of a long image writing time, it is likely that a difference arises between an initially imaged portion and a lately imaged portion. The stability with time of the exposed portion in vacuum is one of the important performance factors. One of the important applications of chemically amplified resist material resides in processing of photomask blanks. Some photomask blanks have a surface material that can have an impact on the pattern profile of the overlying chemically amplified resist film, for example, a layer of a chromium compound, typically chromium oxide deposited on a photomask substrate. For high resolution and profile retention after etching, it is one important performance factor to maintain the profile of a resist film pattern rectangular independent of the type of substrate.

Attempts were made to ameliorate resist sensitivity and pattern profile in a controlled way by properly selecting and combining components used in resist compositions and adjusting processing conditions. One outstanding problem is the diffusion of acid, which has a significant impact on the resolution of a chemically amplified resist film. In the processing of photomasks, it is required that the profile of the resist pattern resulting from exposure does not change depending on the time taken until PEB. The major cause for time-dependent changes is the diffusion of acid generated upon exposure. Since the problem of acid diffusion has large impacts on sensitivity and resolution not only in the photomask processing, but also in general resist compositions, many studies are made thereon.

Patent Documents 1 and 2 describe acid generators capable of generating bulky acids upon exposure, for thereby controlling acid diffusion and reducing roughness. Since these acid generators are still insufficient to control acid diffusion, it is desired to have an acid generator with more controlled diffusion.

Patent Document 3 discloses a resist composition comprising a base polymer having bound thereto an acid generator capable of generating a sulfonic acid upon light exposure whereby acid diffusion is controlled. This approach of controlling acid diffusion by binding repeat units capable of generating acid upon exposure to a base polymer is effective in forming a pattern with reduced LER. However, the base polymer having bound therein repeat units capable of generating acid upon exposure encounters a problem with respect to its solubility in organic solvent, depending on the structure and proportion of the relevant units.

Polymers comprising a major proportion of aromatic structure having an acidic side chain, for example, polyhydroxystyrene are useful in resist materials for the KrF lithography. These polymers are not used in resist materials for the ArF lithography since they exhibit strong absorption at a wavelength of around 200 nm. These polymers, however, are expected to form useful resist materials for the EB and EUV lithography for forming patterns of smaller size than the processing limit of ArF lithography because they offer high etching resistance.

Often used as the base polymer in positive resist compositions for EB and EUV lithography is a polymer having an acidic functional group on phenol side chain masked with an acid labile group (or acid-decomposable protective group). Upon exposure to high-energy radiation, the acid labile group is deprotected by the catalysis of an acid generated from a photoacid generator so that the polymer may turn soluble in alkaline developer. Typical of the acid labile group are tertiary alkyl, tert-butoxycarbonyl, and acetal groups. The use of protective groups (e.g., acetal groups) requiring a relatively low level of activation energy for deprotection offers the advantage that a resist film having a high sensitivity is obtainable. However, if the diffusion of generated acid is not fully controlled, deprotection reaction can occur even in the unexposed region of the resist film, giving rise to problems like a degradation of LER and a lowering of in-plane uniformity (CDU) of pattern line width.

Patent Document 4 describes a resist composition comprising a sulfonium salt capable of generating an acid having a low pKa and a high acid strength, typically a fluorinated alkane sulfonic acid and a polymer comprising repeat units having an acetal group. This raises the problem of forming a pattern having increased LER. The acid strength of the fluorinated alkane sulfonic acid is too high for deprotection of an acetal group which requires a relatively low level of activation energy for deprotection. Then, even though acid diffusion is restrained, deprotection reaction can take place with a minor amount of acid which has diffused into the unexposed region.

Patent Documents 5 and 6 describe photoacid generators capable of generating a non-fluorinated aromatic sulfonic acid having a plurality of bulky alkyl substituents. Patent Document 7 proposes a photoacid generator of triarylbenzene sulfonic acid anion structure. Patent Document 8 proposes a photoacid generator capable of generating a non-fluorinated aromatic sulfonic acid having an iodized aromatic ring introduced therein. Patent Document 9 discloses a photoacid generator capable of generating an aromatic sulfonic acid having a tertiary ester type acid labile group introduced therein. They intend to control acid diffusion by introducing a plurality of alkyl substituents, aromatic rings or iodine atoms to increase the molecular weight of the generated acid. The control of acid diffusion is still insufficient for the purpose of forming small-size patterns. There remains room for further improvement.

### Citation List

Patent Document 1: JP-A 2009-053518
Patent Document 2: JP-A 2010-100604
Patent Document 3: JP-A 2011-022564
Patent Document 4: JP 5083528
Patent Document 5: JP 6248882
Patent Document 6: JP 7067271
Patent Document 7: JP 7032549
Patent Document 8: JP-A 2023-177038
Patent Document 9: JP 7531671

### DISCLOSURE OF INVENTION

Resist compositions are recently demanded which are capable of forming not only line-and-space (LS), isolated line (IL) and isolated space (IS) patterns of satisfactory profile, but also hole patterns of satisfactory profile. The acid generator described in Patent Document 5 generates a bulky acid, indicating that acid diffusion is controlled and a pattern with satisfactory resolution and roughness is formed. However, the problem of corner rounding arises when a hole pattern is formed.

An object of the invention is to provide a chemically amplified positive resist composition comprising a photoacid generator having a high solvent solubility and acid generation efficiency and capable of generating an acid with adequate acidity and controlled diffusion and a base polymer which is decomposed under the action of acid to increase its solubility in an alkaline developer, and a resist pattern forming process using the composition.

The inventors have found that a resist composition is formulated by incorporating a sulfonium salt consisting of a fused ring type triarylsulfonium cation having fluorine or fluorinated substituent on an aromatic ring and an aromatic sulfonic acid anion having at least one aromatic ring structure as a photoacid generator, that the sulfonium salt has a high solvent solubility and acid generation efficiency and generates an acid with adequate acidity and controlled diffusion, and that when the resist composition is processed by lithography, resist patterns having satisfactory resolution, reduced LER and minimized development defects are formed. By virtue of proper dissolution inhibition, resist patterns of fully rectangular profile are obtained.

In one aspect, the invention provides a chemically amplified positive resist composition comprising (A) a photoacid generator in the form of a sulfonium salt consisting of a cation having the formula (A1) and an anion having the formula (A2) and (B) a base polymer containing a polymer which is decomposed under the action of acid to increase its solubility in an alkaline developer, the polymer comprising repeat units having the formula (B1).

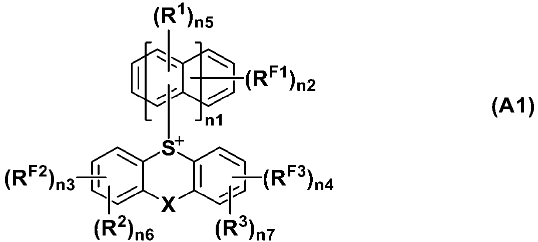

Herein n1 is 0 or 1, n2 is 1 or 2, n3 is 0, 1 or 2, n4 is 0, 1 or 2, n5 is 0, 1 or 2, n6 is 0, 1 or 2, n7 is 0, 1 or 2, meeting 1 ≤ n2+n5 ≤ 5 when n1=0, 0 ≤ n2+n5 ≤ 7 when n1=1, 0 ≤ n3+n6 ≤ 4, and 0 ≤ n4+n7 ≤ 4,
R^{F1}, R^{F2} and R^{F3} are each independently fluorine, a C₁-C₆ fluorinated alkyl group, C₁-C₆ fluorinated alkoxy group, C₁-C₆ fluorinated alkylthio group, or pentafluorosulfanyl,
R¹, R² and R³ are each independently halogen exclusive of fluorine, nitro, cyano, hydroxy, carboxy, a C₁-C₂₀ hydrocarbyl group which may contain a heteroatom, C₁-C₂₀ hydrocarbyloxy group which may contain a heteroatom, or C₁-C₂₀ hydrocarbylthio group which may contain a heteroatom, exclusive of C₁-C₆ fluorinated alkyl group, C₁-C₆ fluorinated alkoxy group, and C₁-C₆ fluorinated alkylthio group; when n5=2, two R¹ may be identical or different and two R¹ may bond together to form a ring with the carbon atom to which they are attached; when n6=2, two R² may be identical or different and two R² may bond together to form a ring with the carbon atom to which they are attached; when n7=2, two R³ may be identical or different and two R³ may bond together to form a ring with the carbon atom to which they are attached;
X is a single bond, -CH₂-, -O-, -S-, -S(=O)-, -SO₂-, -N(H)-, -N(CH₃)- or -C(=O)-.

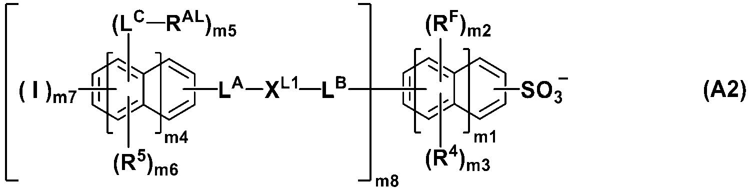

Herein m1 is 0 or 1, m2 is 0, 1, 2, 3 or 4, m3 is 0, 1, 2, 3 or 4, m4 is 0 or 1, m5 is 0, 1, 2, 3 or 4, m6 is 0, 1, 2, 3 or 4, m7 is 0, 1, 2, 3 or 4, m8 is 0, 1, 2, 3 or 4, meeting 1 ≤ m2+m3+m8 ≤ 5 when m1=0, 1 ≤ m2+m3+m8 ≤ 7 when m1=1, and 0 ≤ m5+m6+m7 ≤ 5 when m2=0, 0 ≤ m5+m6+m7 ≤ 7 when m2=1,
R⁴ is halogen exclusive of fluorine, nitro, cyano, hydroxy, carboxy, a C₁-C₂₀ hydrocarbyl group which may contain a heteroatom, C₁-C₂₀ hydrocarbyloxy group which may contain a heteroatom, C₁-C₂₀ hydrocarbylthio group which may contain a heteroatom, or C₂-C₂₀ hydrocarbyloxycarbonyl group which may contain a heteroatom; when m3 is 2, 3 or 4, a plurality of R⁴ may be identical or different and a plurality of R⁴ may bond together to form a ring with the carbon atoms to which they are attached;
R⁵ is halogen exclusive of iodine, nitro, cyano, hydroxy, carboxy, pentafluorosulfanyl, a C₁-C₂₀ hydrocarbyl group which may contain a heteroatom, C₁-C₂₀ hydrocarbyloxy group which may contain a heteroatom, C₁-C₂₀ hydrocarbylthio group which may contain a heteroatom, or C₂-C₂₀ hydrocarbyloxycarbonyl group which may contain a heteroatom; when m6 is 2, 3 or 4, a plurality of R⁵ may be identical or different and a plurality of R⁵ may bond together to form a ring with the carbon atoms to which they are attached;
R^{F} is fluorine, a C₁-C₆ fluorinated saturated hydrocarbyl group, C₁-C₆ fluorinated saturated hydrocarbyloxy group, C₁-C₆ fluorinated saturated hydrocarbylthio group, or pentafluorosulfanyl; when m2 is 2, 3 or 4, a plurality of R^{F} may be identical or different,
R^{AL} is an acid labile group,
L^{A} and L^{B} are each independently a single bond, ether bond, ester bond, sulfonate ester bond, amide bond, sulfonamide bond, carbonate bond or carbamate bond,
L^{C} is an ether bond, ester bond or carbonate bond,
X^{L1} is a single bond or a C₁-C₄₀ hydrocarbylene group which may contain a heteroatom.

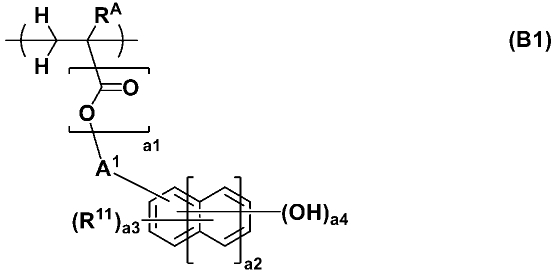

Herein a1 is 0 or 1, a2 is 0, 1 or 2, a3 is an integer meeting 0 ≤ a3 ≤ 5+2(a2)-a4, a4 is 1, 2 or 3,
R^{A} is hydrogen, fluorine, methyl or trifluoromethyl,
R¹¹ is halogen, nitro, carboxy, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group; when a3 is 2 or more, a plurality of R¹¹ may be identical or different, and
A¹ is a single bond or a C₁-C₁₀ saturated hydrocarbylene group in which some -CH₂-may be replaced by -O-.

In a preferred embodiment, the cation has the formula (A1-1): 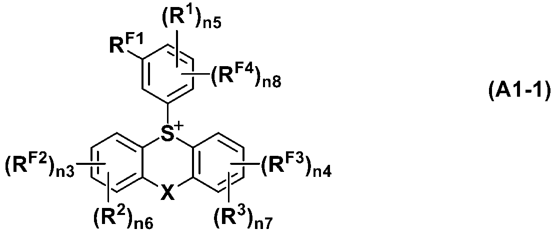 wherein n3 to n7, R^{F1} to R^{F3}, and R¹ to R³ are as defined above,
n8 is 0 or 1, meeting 0 ≤ n5+n8 ≤ 4, and
R^{F4} is fluorine, a C₁-C₆ fluorinated alkyl group, C₁-C₆ fluorinated alkoxy group, C₁-C₆ fluorinated alkylthio group, or pentafluorosulfanyl.

In a preferred embodiment, the anion has the formula (A2-1): 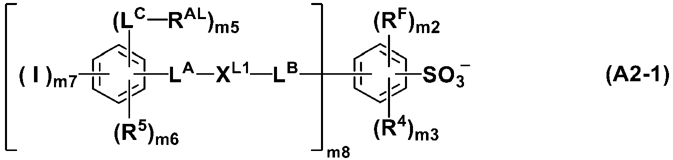 wherein m2, m3, m5 to m8, R⁴, R⁵, R^{F}, R^{AL}, L^{A}, L^{B}, L^{C}, and X^{L1} are as defined above.

In a preferred embodiment, the anion has the formula (A2-2): 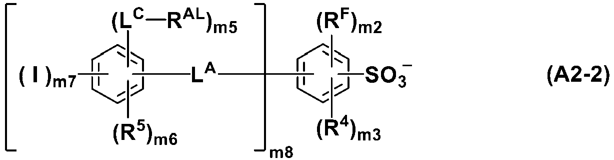 wherein m2, m3, m5 to m8, R⁴, R⁵, R^{F}, R^{AL}, L^{A}, and L^{C} are as defined above.

In a preferred embodiment, the acid labile group has the formula (AL-1) or (AL-2).

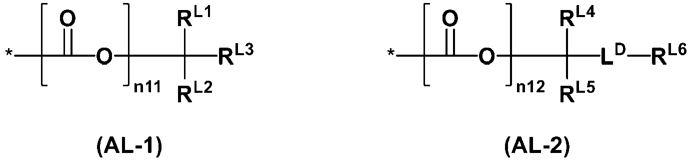

Herein n11 is 0 or 1, n12 is 0 or 1,
R^{L1} and R^{L2} are each independently a C₁-C₁₂ hydrocarbyl group, R^{L3} is hydrogen or a C₁-C₁₂ hydrocarbyl group; some -CH₂- in the hydrocarbyl group represented by R^{L1} R^{L2} and R^{L3} may be replaced by -O- or -S-; when the hydrocarbyl group contains an aromatic ring, some or all of the hydrogen atoms on the aromatic ring may be substituted by halogen, cyano, nitro, a C₁-C₄ alkyl moiety which may contain halogen, or C₁-C₄ alkoxy moiety which may contain halogen; R^{L1} and R^{L2} may bond together to form a ring with the carbon atom to which they are attached, some -CH₂- in the ring may be replaced by -O- or -S-, with the proviso that when R^{L3} is hydrogen, R^{L1} and R^{L2} bond together to form a multiple bond-containing alicyclic structure with the carbon atom to which they are attached, some hydrogen on the alicyclic structure may be substituted by halogen,
R^{L4} and R^{L5} are each independently hydrogen or a C₁-C₁₀ hydrocarbyl group, R^{L6} is a C₁-C₂₀ hydrocarbyl group, some -CH₂- in the hydrocarbyl group may be replaced by -O- or -S-; R^{L5} and R^{L6} may bond together to form a C₃-C₂₀ heterocyclic group with the carbon atom and L^{D} to which they are attached, some -CH₂- in the heterocyclic group may be replaced by -O- or -S-,
L^{D} is -O- or -S-,
* designates a point of attachment to L^{C}.

In a preferred embodiment, the polymer further comprises repeat units having the formula (B2-1).

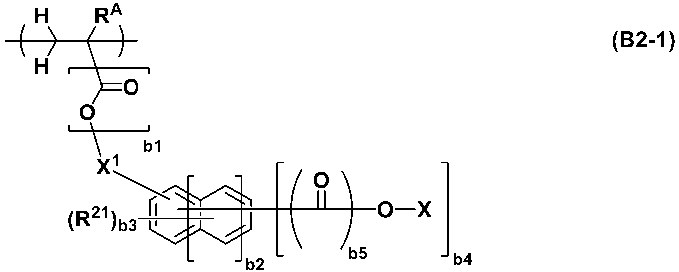

Herein b1 is 0 or 1, b2 is 0, 1 or 2, b3 is an integer meeting 0 ≤ b3 ≤ 5+2(b2)-b4, b4 is 1, 2 or 3, b5 is 0 or 1,
R^{A} is hydrogen, fluorine, methyl or trifluoromethyl,
R²¹ is halogen or an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group, a plurality of R²¹ may be identical or different when b3 is 2 or more,
X¹ is a single bond or C₁-C₁₀ saturated hydrocarbylene group in which some -CH₂-may be replaced by -O-, and
X is an acid labile group when b4=1, and X is each independently hydrogen or an acid labile group, at least one being an acid labile group, when b4 is 2 or 3.

In a preferred embodiment, the polymer further comprises repeat units having the formula (B2-2).

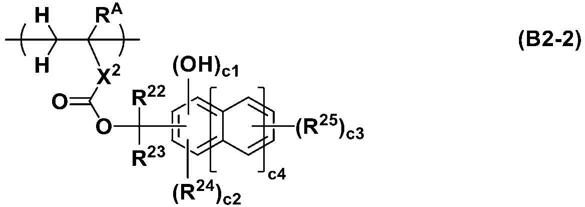

Herein c1 is 0, 1 or 2, c2 is 0, 1 or 2, c3 is 0, 1, 2, 3, 4 or 5, c4 is 0, 1 or 2,
R^{A} is hydrogen, fluorine, methyl or trifluoromethyl,
R²² and R²³ are each independently a C₁-C₁₀ hydrocarbyl group which may contain a heteroatom, R²² and R²³ may bond together to form a ring with the carbon atom to which they are attached,
R²⁴ is each independently fluorine, a C₁-C₅ fluorinated alkyl group or C₁-C₅ fluorinated alkoxy group, two R²⁴ may be identical or different when c2=2,
R²⁵ is each independently a C₁-C₁₀ hydrocarbyl group which may contain a heteroatom, a plurality of R²⁵ may be identical or different when c3 is 2, 3, 4 or 5, and
X² is a single bond, phenylene group, naphthylene group or *-C(=O)-O-X²¹-, X²¹ is a C₁-C₂₀ aliphatic hydrocarbylene group which may contain a hydroxy, ether bond, ester bond or lactone ring, or phenylene group or naphthylene group.

In a preferred embodiment, the polymer further comprises repeat units having the formula (B2-3).

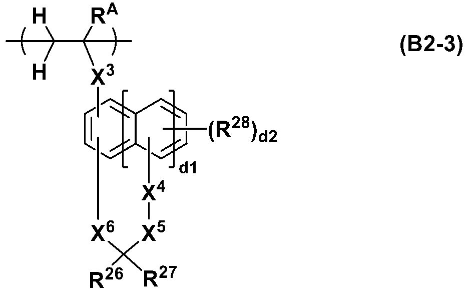

Herein d1 is 0 or 1, d2 is 0, 1, 2 or 3 when d1=0, d2 is 0, 1, 2, 3, 4 or 5 when d1=1,
R^{A} is hydrogen, fluorine, methyl or trifluoromethyl,
X³ is a single bond, *-C(=O)-O- or *-C(=O)-N(H)-, * designates a point of attachment to the carbon atom in the backbone,
X⁴ is a single bond, a C₁-C₄ aliphatic hydrocarbylene group, carbonyl, sulfonyl or a group obtained by combining the foregoing,
X⁵ and X⁶ are each independently oxygen or sulfur, with the proviso that X⁴ and X⁶ are bonded to adjoining carbon atoms on the aromatic ring,
R²⁶ and R²⁷ are each independently hydrogen or a C₁-C₂₀ hydrocarbyl group which may contain a heteroatom, R²⁶ and R²⁷ may bond together to form a ring with the carbon atom to which they are attached, and
R²⁸ is halogen, hydroxy, cyano, nitro, pentafluorosulfanyl, a C₁-C₂₀ hydrocarbyl group which may contain a heteroatom, C₁-C₂₀ hydrocarbyloxy group which may contain a heteroatom, C₂-C₂₀ hydrocarbyloxycarbonyl group which may contain a heteroatom, C₁-C₂₀ hydrocarbylthio group which may contain a heteroatom, or -N(R^{28A})(R^{28B}), R^{28A} and R^{28B} are each independently hydrogen or a C₁-C₆ hydrocarbyl group; when b2 is 2 or more, a plurality of R²⁸ may be identical or different and a plurality of R²⁸ may bond together to form a ring with the carbon atoms on the aromatic ring to which they are attached.

In a preferred embodiment, the polymer further comprises repeat units of at least one type selected from repeat units having the formula (B3), repeat units having the formula (B4), and repeat units having the formula (B5).

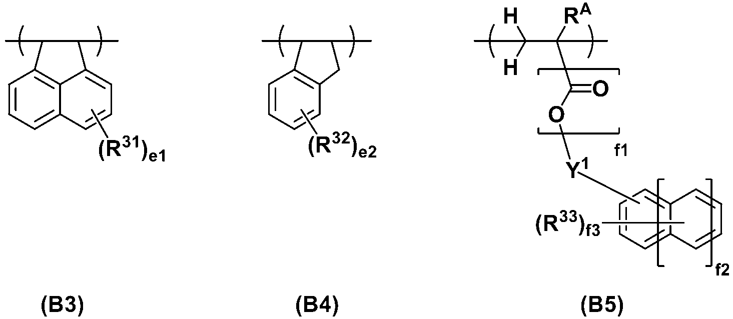

Herein e1 is 0, 1, 2, 3, 4, 5 or 6, e2 is 0, 1, 2, 3 or 4, f1 is 0 or 1, f2 is 0, 1 or 2, f3 is 0, 1, 2, 3, 4 or 5,
R^{A} is hydrogen, fluorine, methyl or trifluoromethyl,
R³¹ and R³² are each independently hydroxy, halogen, an optionally halogenated C₁-C₅ saturated hydrocarbyl group, optionally halogenated C₁-C₈ saturated hydrocarbyloxy group, or optionally halogenated C₂-C₈ saturated hydrocarbylcarbonyloxy group; a plurality of R³¹ may be identical or different when e1 is 2, 3, 4, 5 or 6, and a plurality of R³² may be identical or different when e2 is 2, 3 or 4,
R³³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro, cyano, C₁-C₂₀ saturated hydrocarbylsulfinyl group, or C₁-C₂₀ saturated hydrocarbylsulfonyl group, R³³ may also be hydroxy when f2 is 1 or 2, a plurality of R³³ may be identical or different when f3 is 2, 3, 4 or 5, and
Y¹ is a single bond or C₁-C₁₀ saturated hydrocarbylene group in which some -CH₂-may be replaced by -O-.

In a preferred embodiment, the polymer further comprises repeat units of at least one type selected from repeat units having the formula (B6), repeat units having the formula (B7), repeat units having the formula (B8), repeat units having the formula (B9), and repeat units having the formula (B10).

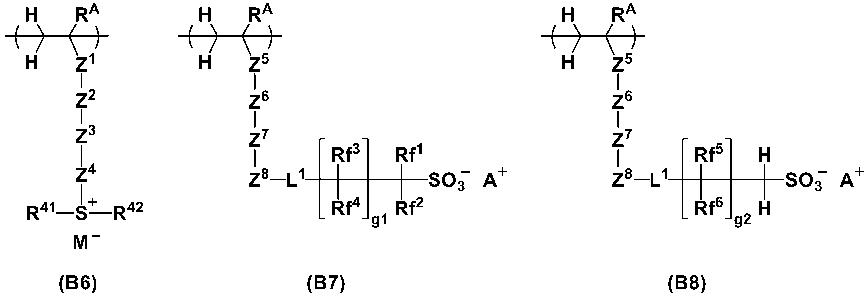

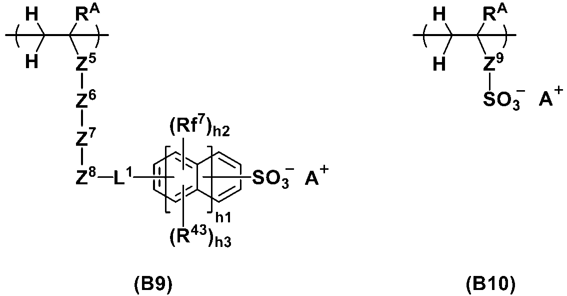

Herein g1 and g2 are each independently 0, 1, 2 or 3, h1 is 0 or 1, h2 is 0, 1, 2, 3 or 4, h3 is 0, 1, 2, 3 or 4, meeting 0 ≤ h2+h3 ≤ 4 when h1=0, and 0 ≤ h2+h3 ≤ 6 when h1=1,
R^{A} is each independently hydrogen, fluorine, methyl or trifluoromethyl,
Z¹ is a single bond or an optionally substituted phenylene group,
Z² is a single bond, **-C(=O)-O-Z²¹-, **-C(=O)-N(H)-Z²¹-, or **-O-Z²¹-, Z²¹ is a C₁-C₆ aliphatic hydrocarbylene group, phenylene group or a divalent group obtained by combining the foregoing, which may contain halogen, carbonyl moiety, ester bond, ether bond or hydroxy moiety,
Z³ is a single bond, ether bond, ester bond, amide bond, sulfonate ester bond, sulfonamide bond, carbonate bond or carbamate bond,
Z⁴ is a single bond, or a C₁-C₆ aliphatic hydrocarbylene group, phenylene group or a divalent group obtained by combining the foregoing, which may contain halogen, carbonyl moiety, ester bond, ether bond or hydroxy moiety,
Z⁵ is each independently a single bond, an optionally substituted phenylene, naphthylene, or *-C(=O)-O-Z⁵¹-, Z⁵¹ is a C₁-C₁₀ aliphatic hydrocarbylene group which may contain halogen, hydroxy moiety, ether bond, ester bond or lactone ring, or phenylene or naphthylene group,
Z⁶ is a single bond, ether bond, ester bond, amide bond, sulfonate ester bond, sulfonamide bond, carbonate bond or carbamate bond,
Z⁷ is each independently a single bond, ***-Z⁷¹-C(=O)-O-, ***-C(=O)-N(H)-Z⁷¹-, or ***-O-Z⁷¹-, Z⁷¹ is a C₁-C₂₀ hydrocarbylene group which may contain a heteroatom,
Z⁸ is each independently a single bond, ****-Z⁸¹-C(=O)-O-, ****-C(=O)-N(H)-Z⁸¹. or ****-O-Z⁸¹-, Z⁸¹ is a C₁-C₂₀ hydrocarbylene group which may contain a heteroatom,
Z⁹ is a single bond, methylene, ethylene, phenylene, fluorinated phenylene, trifluoromethyl-substituted phenylene, *-C(=O)-O-Z⁹¹-, *-C(=O)-N(H)-Z⁹¹-, or *-O-Z⁹¹-, Z⁹¹ is a C₁-C₆ aliphatic hydrocarbylene group, phenylene group, fluorinated phenylene group or trifluoromethyl-substituted phenylene group, which may contain a carbonyl moiety, ester bond, ether bond or hydroxy moiety,
* is a point of attachment to the carbon atom in the backbone, ** is a point of attachment to Z¹, *** is a point of attachment to Z⁶, **** is a point of attachment to Z⁷,
L¹ is a single bond, ether bond, ester bond, carbonyl group, sulfonate ester bond, sulfonamide bond, carbonate bond or carbamate bond,
Rf¹ and Rf² are each independently fluorine or a C₁-C₆ fluorinated saturated hydrocarbyl group,
Rf³ and Rf⁴ are each independently hydrogen, fluorine, or a C₁-C₆ fluorinated saturated hydrocarbyl group,
Rf⁵ and Rf⁶ are each independently hydrogen, fluorine, or a C₁-C₆ fluorinated saturated hydrocarbyl group, excluding that all Rf⁶ and Rf⁶ are hydrogen at the same time,
Rf⁹ is fluorine, a C₁-C₆ fluorinated alkyl group, C₁-C₆ fluorinated alkoxy group, or C₁-C₆ fluorinated alkylthio group, a plurality of Rf⁹ may be identical or different when h2 is 2, 3 or 4,
R⁴¹ and R⁴² are each independently a C₁-C₂₀ hydrocarbyl group which may contain a heteroatom, R⁴¹ and R⁴² may bond together to form a ring with the sulfur atom to which they are attached,
R⁴³ is halogen exclusive of fluorine, or a C₁-C₂₀ hydrocarbyl group which may contain a heteroatom; when h3 is 2, 3 or 4, a plurality of R⁴³ may be identical or different and a plurality of R⁴³ may bond together to form a ring with the carbon atoms to which they are attached,
M⁻ is a non-nucleophilic counter ion, and
A⁺ is an onium cation.

In a preferred embodiment, repeat units having an aromatic ring structure account for at least 60 mol% of the overall repeat units of the polymer in the base polymer.

The positive resist composition may further comprise an organic solvent and/or a quencher.

The positive resist composition may further comprise (D) a fluorinated polymer comprising repeat units of at least one type selected from repeat units having the formula (D1), repeat units having the formula (D2), repeat units having the formula (D3) and repeat units having the formula (D4) and optionally repeat units of at least one type selected from repeat units having the formula (D5) and repeat units having the formula (D6).

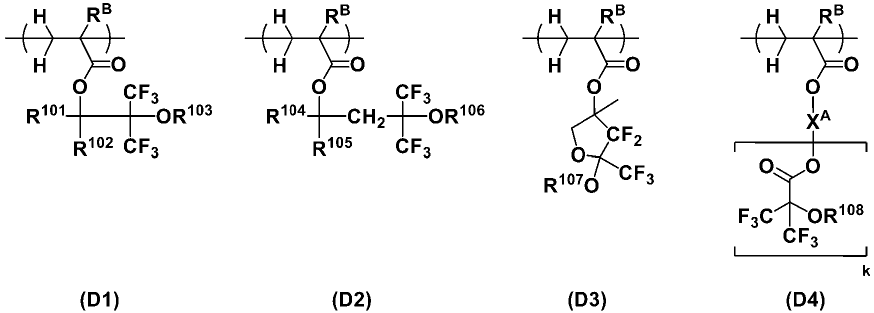

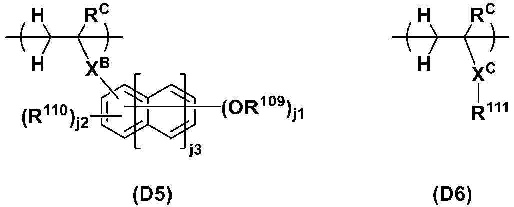

Herein j1 is 1, 2 or 3, j2 is an integer meeting 0 ≤ j2 ≤ 5+2(j3)j1, j3 is 0 or 1, k is 1, 2 or 3,
R^{B} is each independently hydrogen, fluorine, methyl or trifluoromethyl,
R^{C} is each independently hydrogen or methyl,
R¹⁰¹, R¹⁰², R¹⁰⁴ and R¹⁰⁵ are each independently hydrogen or a C₁-C₁₀ saturated hydrocarbyl group,
R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, and when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond, a plurality of R¹⁰⁹ may be identical or different when j1 is 2 or 3,
R¹¹⁰ is a C₁-C₅ straight or branched hydrocarbyl group in which a heteroatom-containing moiety may intervene in a carbon-carbon bond, a plurality of R¹¹⁰ may be identical or different when j2 is 2 or more,
R¹¹¹ is a C₁-C₂₀ saturated hydrocarbyl group in which at least one hydrogen is substituted by fluorine, and in which some -CH₂- may be replaced by an ester bond or ether bond,
X^{A} is a C₁-C₂₀ (k+1)-valent hydrocarbon group or C₁-C₂₀ (k+1)-valent fluorinated hydrocarbon group,
X^{B} is a single bond, *-C(=O)-O- or *-C(=O)-N(H)-, * designates a point of attachment to the carbon atom in the backbone,
X^{C} is a single bond, -O-, *-C(=O)=O-X^{C1}-X^{C2}- or *-C(=O)-N(H)-X^{C1}-X^{C2}-, X^{C1} is a single bond or C₁-C₁₀ saturated hydrocarbylene group, X^{C2} is a single bond, ester bond, ether bond, or sulfonamide bond, and * designates a point of attachment to the carbon atom in the backbone.
The positive resist composition may further comprise a photoacid generator other than the photoacid generator defined herein.
In another aspect, the invention provides a resist pattern forming process comprising the steps of applying the chemically amplified positive resist composition defined herein onto a substrate to form a resist film thereon, exposing the resist film patternwise to high-energy radiation, and developing the exposed resist film in an alkaline developer.

Typically, the high-energy radiation is EUV of wavelength 3 to 15 nm or EB.

In one embodiment, the substrate has the outermost surface of a chromium-containing material. The substrate is typically a photomask blank.

### ADVANTAGEOUS EFFECTS OF THE INVENTION

When processed by the microfabrication technology, especially EB and EUV lithography processes, a chemically amplified positive resist composition comprising the inventive sulfonium salt having formula (A1)-(A2) as a photoacid generator can form a resist pattern having high sensitivity, high resolution, and reduced LER. By virtue of adequate dissolution inhibition, a pattern of rectangular profile is obtainable.

### DESCRIPTION OF THE PREFERRED EMBODIMENTS

As used herein, the singular forms "a," "an" and "the" include plural referents unless the context clearly dictates otherwise. "Optional" or "optionally" means that the subsequently described event or circumstances may or may not occur, and that description includes instances where the event or circumstance occurs and instances where it does not. The notation (Cn-Cm) means a group containing from n to m carbon atoms per group. In chemical formulae, the broken line (---) and asterisk (*) each designate a point of attachment, namely valence bond. Me stands for methyl and Ac for acetyl. As used herein, the term "halogenated" refers to a halogen-substituted or halogen-containing compound or group. For example, "fluorinated" refers to a fluorine-substituted or fluorine-containing compound or group. The terms "group" and "moiety" are interchangeable.

The abbreviations and acronyms have the following meaning.
PAG: photoacid generator
Mw: weight average molecular weight
Mn: number average molecular weight
Mw/Mn: molecular weight distribution or dispersity
GPC: gel permeation chromatography
PEB: post-exposure baking
LER: line edge roughness
CDU: critical dimension uniformity

It is understood that for some structures represented by chemical formulae, there can exist enantiomers and diastereomers because of the presence of asymmetric carbon atoms. In such a case, a single formula collectively represents all such isomers. The isomers may be used alone or in admixture.

### Positive resist composition

One embodiment of the invention is a chemically amplified positive resist composition comprising (A) a photoacid generator in the form of a sulfonium salt consisting of a fused ring type triarylsulfonium cation having fluorine or fluorinated substituent on an aromatic ring and an anion capable of generating an arene sulfonic acid and (B) a base polymer containing a specific polymer.

### (A) Photoacid generator

The photoacid generator as component (A) is a sulfonium salt containing a sulfonium cation represented by the formula (A1).

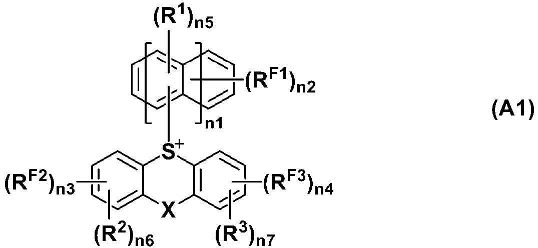

In formula (A1), n1 is 0 or 1. The relevant structure is a benzene ring when n1=0, and a naphthalene ring when nl=1. The benzene ring corresponding to n1=0 is preferred from the aspect of solvent solubility. The subscript n2 is 1 or 2, n3 is 0, 1 or 2, and n4 is 0, 1 or 2. The subscript n5 is 0, 1 or 2, preferably n5 is 0 or 1 as viewed from reactant availability. The subscript n6 is 0, 1 or 2, preferably n6 is 0 or 1 as viewed from reactant availability. The subscript n7 is 0, 1 or 2, preferably n7 is 0 or 1 as viewed from reactant availability. It is noted that n1 to n7 are in the range: 1 ≤ n2+n5 ≤ 5 when n1=0, 0 ≤ n2+n5 ≤ 7 when n1=1, 0 ≤ n3+n6 ≤ 4, and 0 ≤ n4+n7 ≤ 4.

In formula (A1), R^{F1}, R^{F2} and R^{F3} are each independently fluorine, a C₁-C₆ fluorinated alkyl group, C₁-C₆ fluorinated alkoxy group, C₁-C₆ fluorinated alkylthio group, or pentafluorosulfanyl. Preferably at least one of these substituents is bonded to the carbon atom at meta-position relative to the carbon atom to which S⁺ of the sulfonium cation is bonded. It is believed that the substitution of fluorine or fluorinated substituent at meta-position exerts an electron-withdrawing effect, by which the energy level of LUMO in the frontier orbit theory for the sulfonium cation is lowered. There is a more likelihood to accept secondary electrons released upon EB exposure. This promotes the decomposition of the sulfonium cation and efficient generation of acid, leading to an improvement in the sensitivity of a resist film. R^{F1}, R^{F2} and R^{F3} are preferably fluorine, trifluoromethyl, difluoromethyl, trifluoromethoxy, difluoromethoxy, trifluoromethylthio, difluoromethylthio or pentafluorosulfanyl, more preferably fluorine, trifluoromethyl, trifluoromethoxy or pentafluorosulfanyl. When n2=2, two R^{F1} may be identical or different. When n3=2, two R^{F2} may be identical or different. When n4=2, two R^{F3} may be identical or different.

In formula (A1), R¹, R² and R³ are each independently halogen exclusive of fluorine, nitro, cyano, hydroxy, carboxy, a C₁-C₂₀ hydrocarbyl group which may contain a heteroatom, C₁-C₂₀ hydrocarbyloxy group which may contain a heteroatom, or C₁-C₂₀ hydrocarbylthio group which may contain a heteroatom. Notably, C₁-C₆ fluorinated alkyl groups, C₁-C₆ fluorinated alkoxy groups, and C₁-C₆ fluorinated alkylthio groups are excluded. Suitable halogen atoms exclusive of fluorine include chlorine, bromine and iodine. The hydrocarbyl group and hydrocarbyl moiety in the hydrocarbyloxy and hydrocarbylthio groups may be saturated or unsaturated and straight, branched or cyclic. Examples thereof include C₁-C₂₀ alkyl groups such as methyl, ethyl, n-propyl, isopropyl, n-butyl, isobutyl, sec-butyl, tert-butyl, n-pentyl, n-hexyl, n-octyl, n-nonyl, n-decyl, undecyl, dodecyl, tridecyl, tetradecyl, pentadecyl, heptadecyl, octadecyl, nonadecyl, and icosyl; C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl, and adamantyl; C₂-C₂₀ alkenyl groups such as vinyl, 1-propenyl, 2-propenyl, butenyl and hexenyl; C₃-C₂₀ cyclic unsaturated hydrocarbyl groups such as cyclohexenyl; C₆-C₂₀ aryl groups such as phenyl and naphthyl; C₇-C₂₀ aralkyl groups such as benzyl, 1-phenylethyl and 2-phenylethyl, and combinations thereof. Of these, aryl groups are preferred. In the hydrocarbyl group, some or all hydrogen may be substituted by a moiety containing a heteroatom such as oxygen, sulfur, nitrogen or halogen, and some -CH₂- may be replaced by a moiety containing a heteroatom such as oxygen, sulfur or nitrogen, so that the group may contain a hydroxy, cyano, fluorine, chlorine, bromine, iodine, carbonyl, ether bond, ester bond, sulfonate ester bond, carbonate bond, lactone ring, sultone ring, carboxylic anhydride (-C(=O)-O-C(=O)-) or haloalkyl moiety.

When n5=2, two R¹ may be identical or different. When n5=2, two R¹ may bond together to form a ring with the carbon atom to which they are attached. The ring is preferably 5 to 8-membered. When n6=2, two R² may be identical or different. When n6=2, two R² may bond together to form a ring with the carbon atom to which they are attached. The ring is preferably 5 to 8-membered. When n7=2, two R³ may be identical or different. When n7=2, two R³ may bond together to form a ring with the carbon atom to which they are attached. The ring is preferably 5 to 8-membered.

In formula (A1), X is a single bond, -CH₂-, -O-, -S-, -S(=O)-, -SO₂-, -N(H)-, -N(CH₃)- or -C(=O)-. X is preferably a single bond, -CH₂-, -O-, -S-, -S(=O)-, -SO₂- or -C(=O)-, more preferably a single bond, -CH₂-, -O- or -S-.

Of the sulfonium cations having formula (A1), those cations having the formula (A1-1) are preferred.

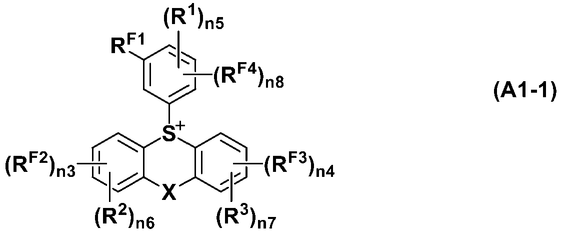

Herein n3 to n7, R^{F1} to R^{F3}, and R¹ to R³ are as defined above.

In formula (A1-1), n8 is 0 or 1, meeting 0 ≤ n5+n8 ≤ 4.

In formula (A1-1), R^{F4} is fluorine, a C₁-C₆ fluorinated alkyl group, C₁-C₆ fluorinated alkoxy group, C₁-C₆ fluorinated alkylthio group, or pentafluorosulfanyl. R^{F4} is preferably fluorine, trifluoromethyl, difluoromethyl, trifluoromethoxy, difluoromethoxy, trifluoromethylthio, difluoromethylthio or pentafluorosulfanyl, more preferably fluorine, trifluoromethyl, trifluoromethoxy or pentafluorosulfanyl.

Examples of the sulfonium cation having formula (A1) are given below, but not limited thereto.

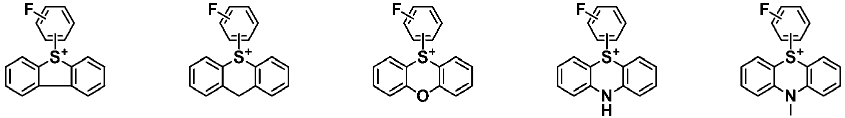

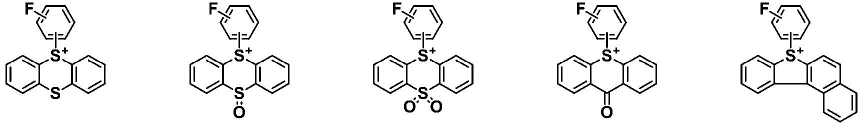

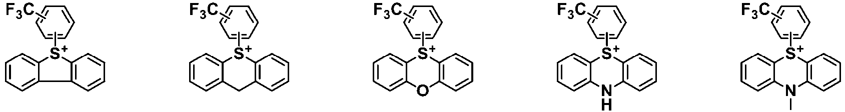

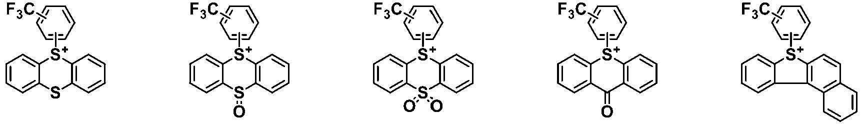

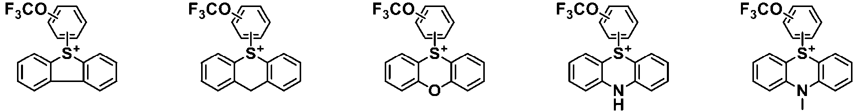

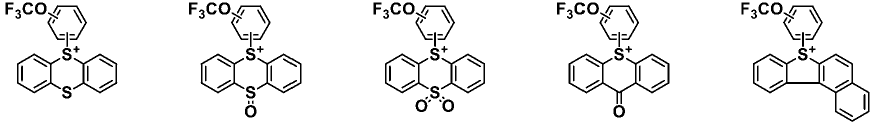

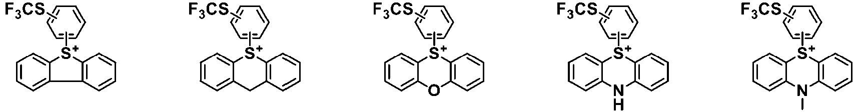

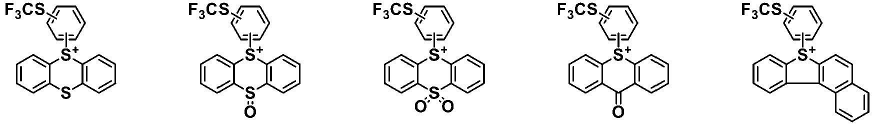

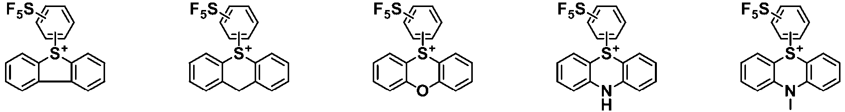

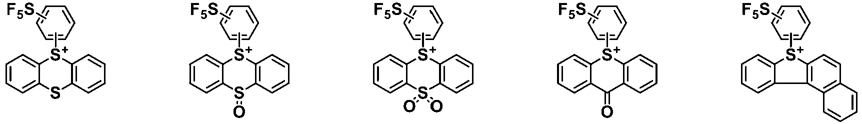

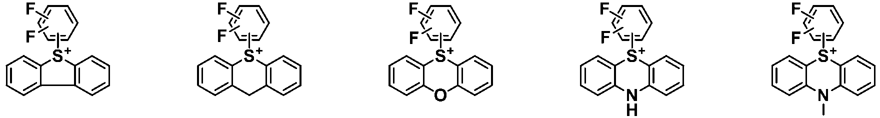

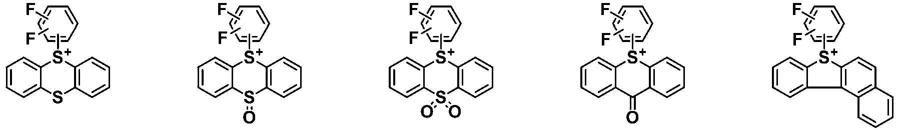

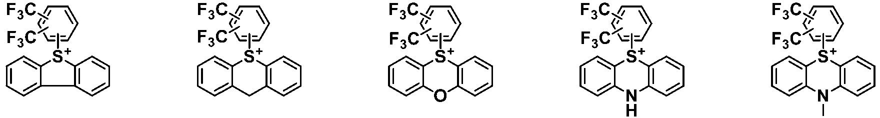

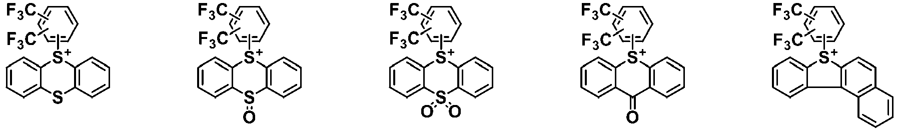

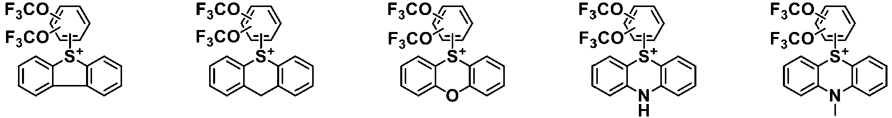

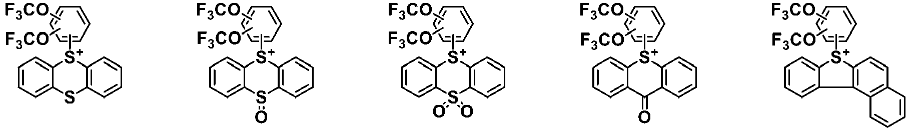

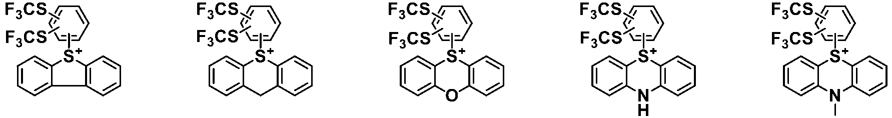

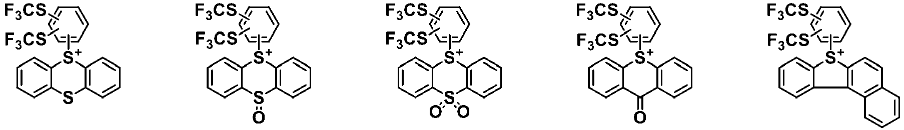

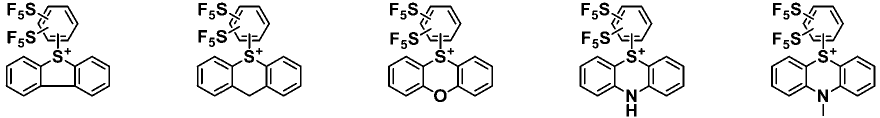

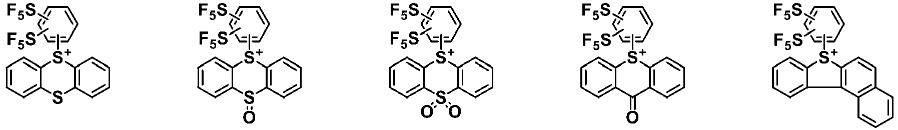

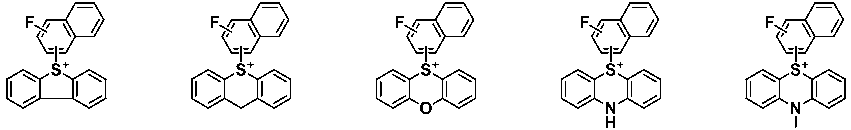

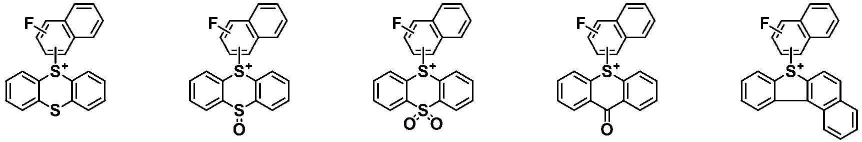

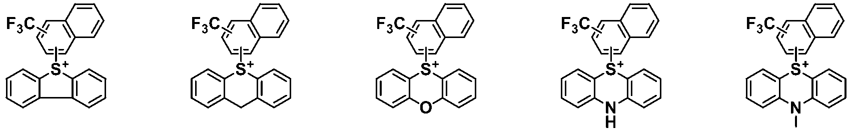

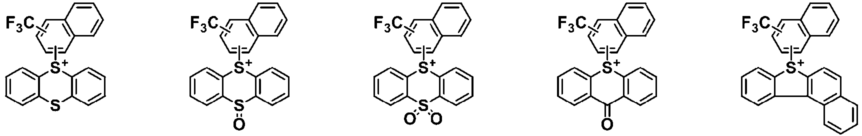

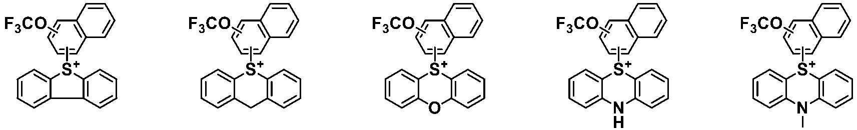

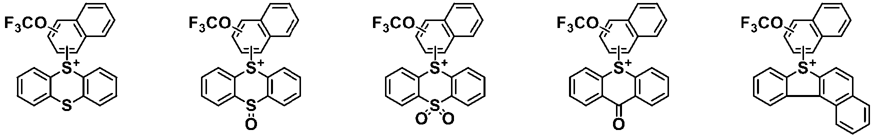

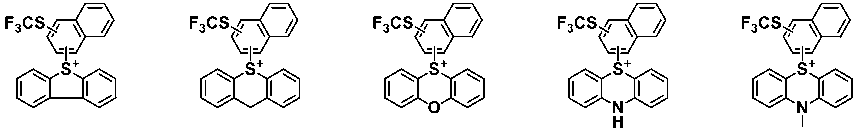

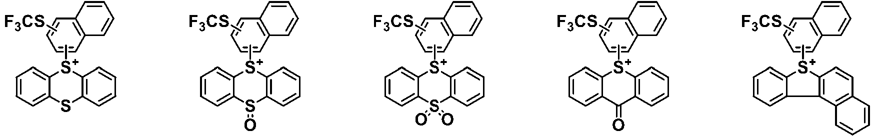

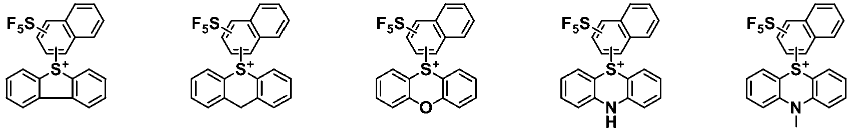

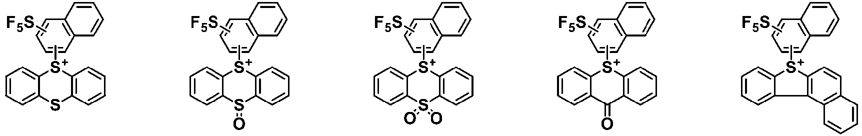

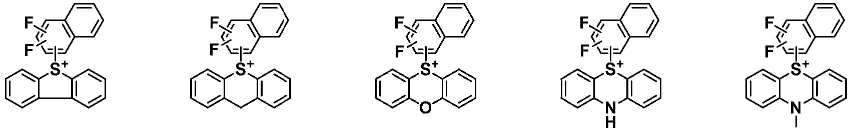

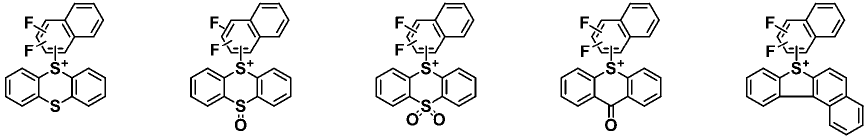

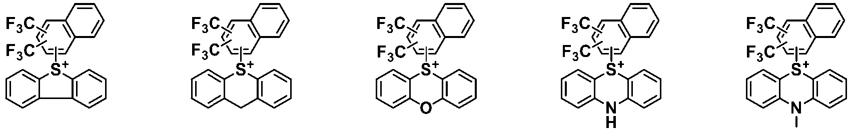

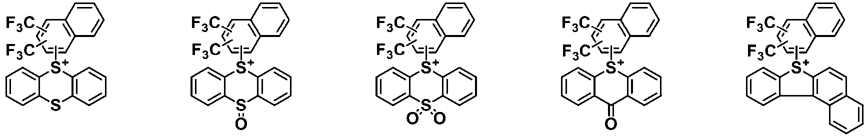

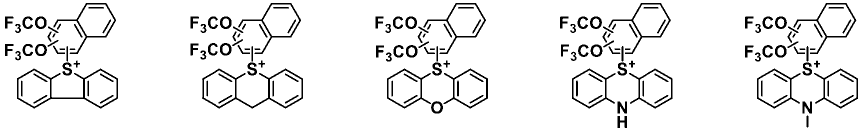

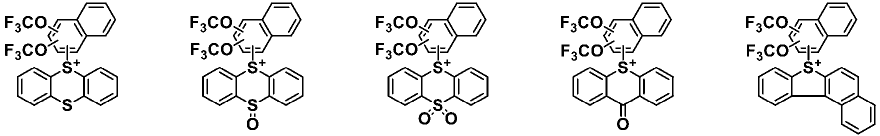

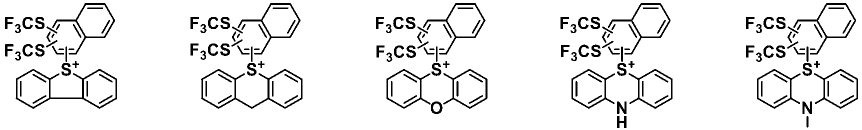

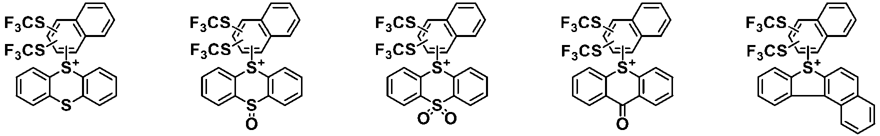

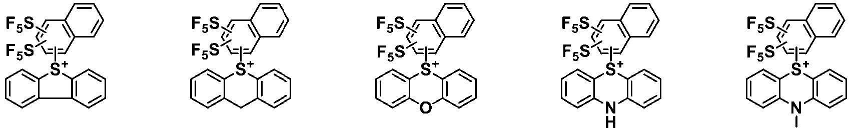

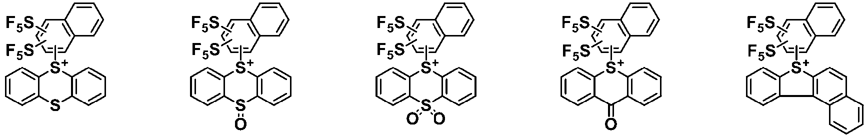

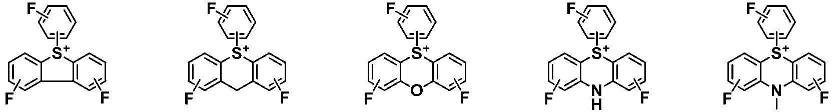

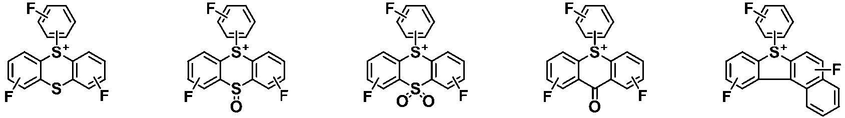

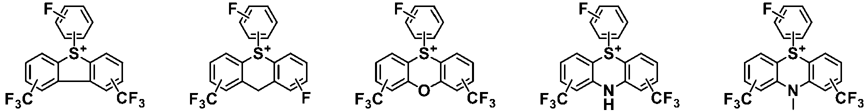

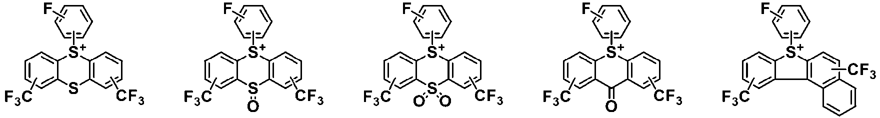

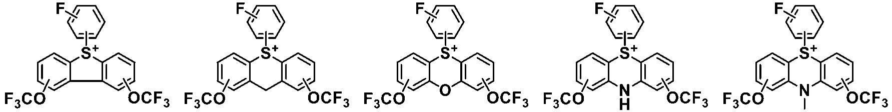

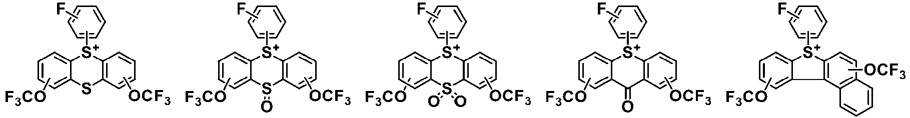

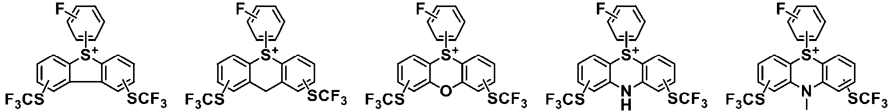

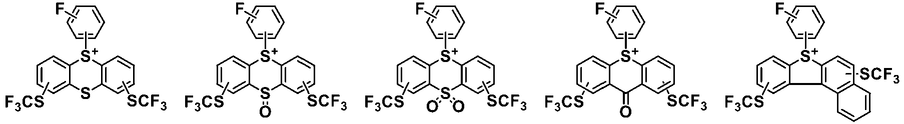

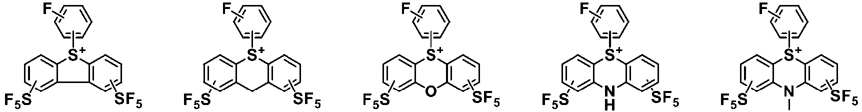

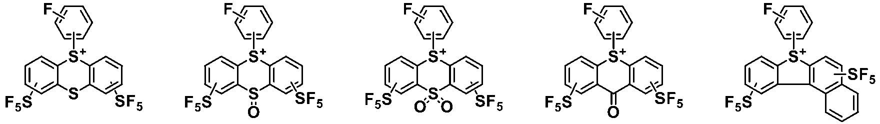

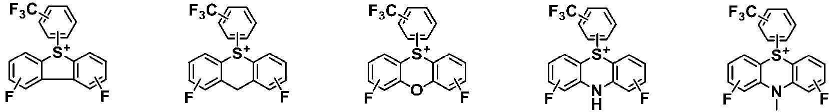

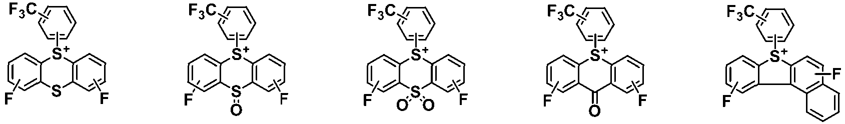

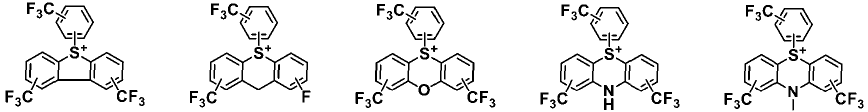

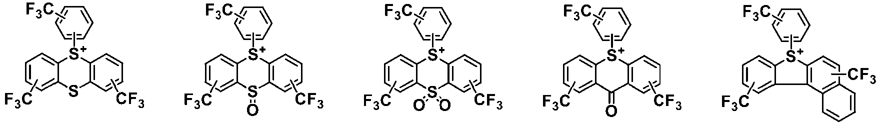

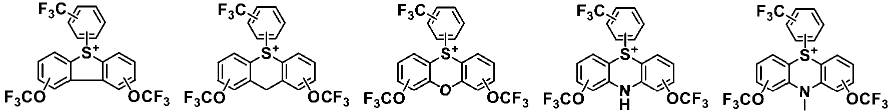

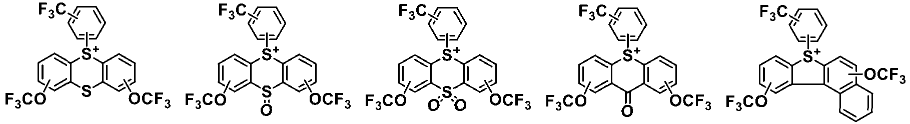

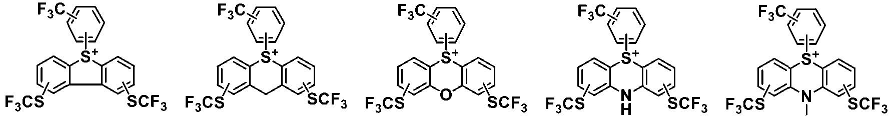

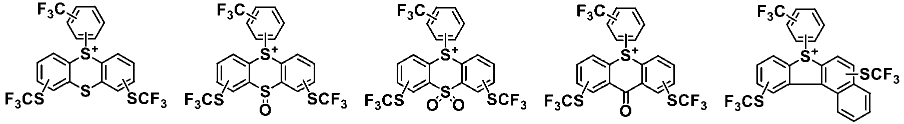

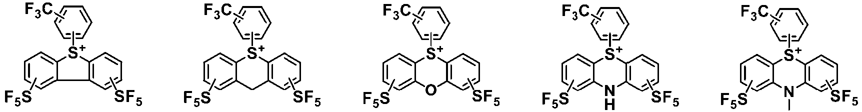

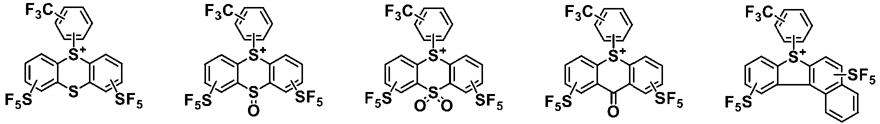

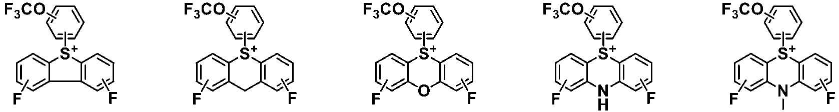

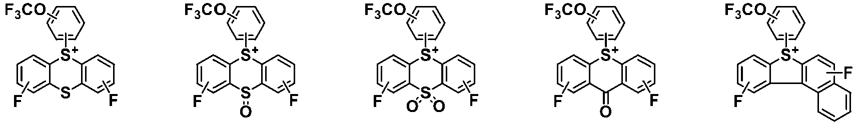

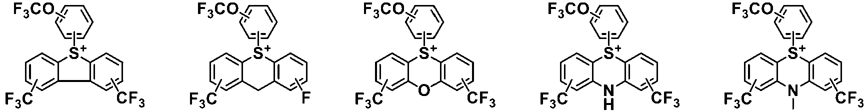

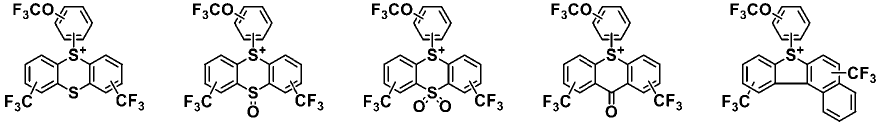

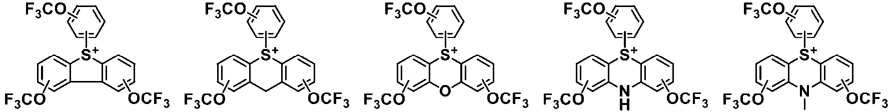

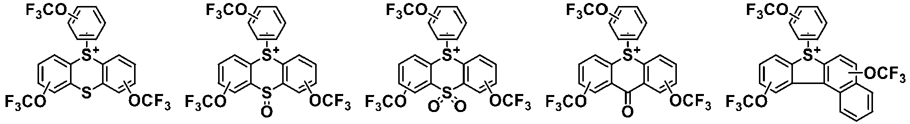

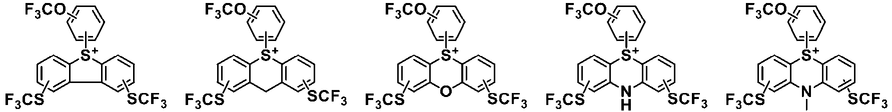

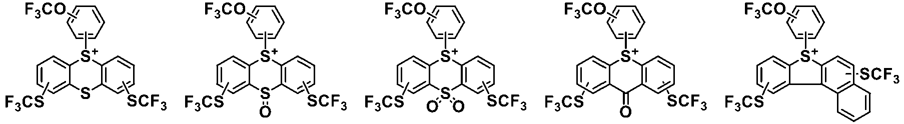

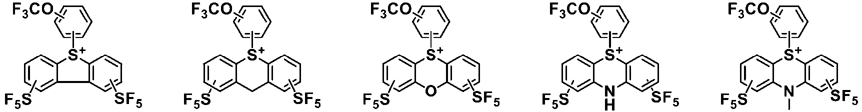

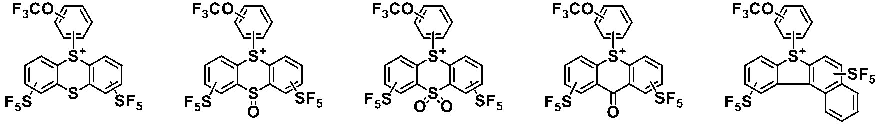

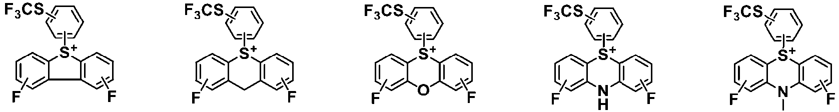

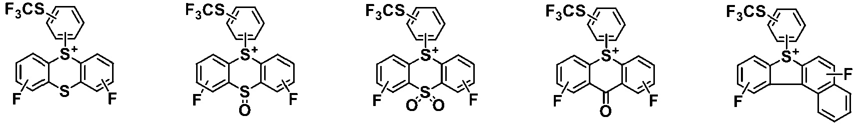

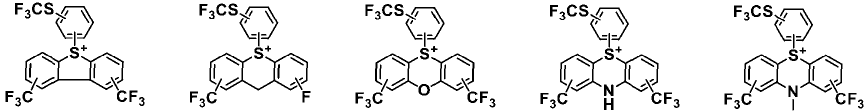

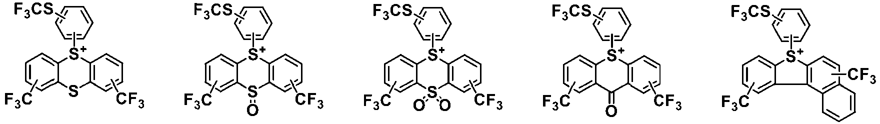

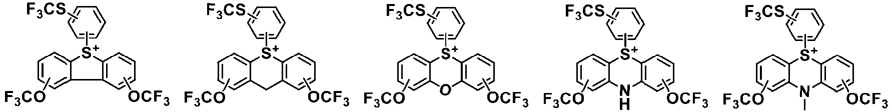

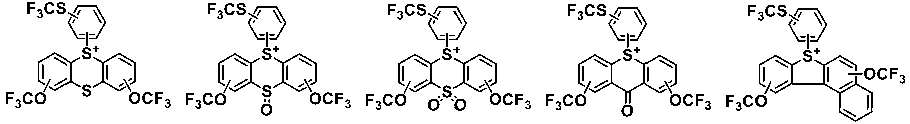

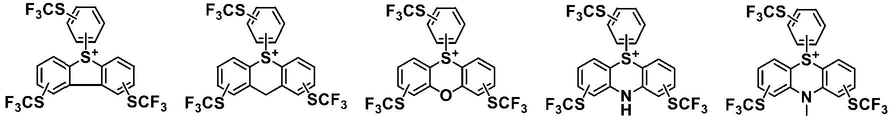

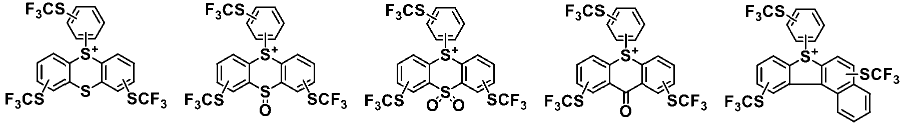

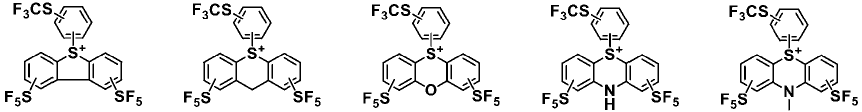

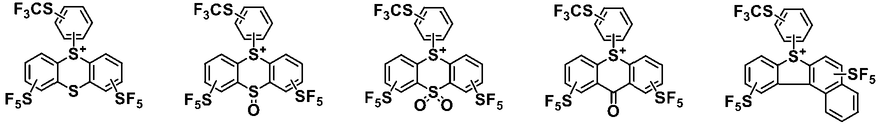

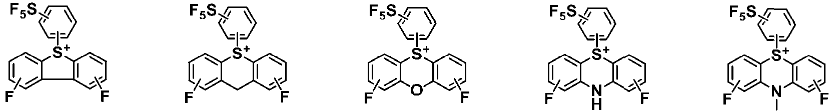

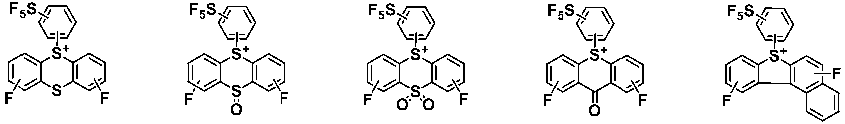

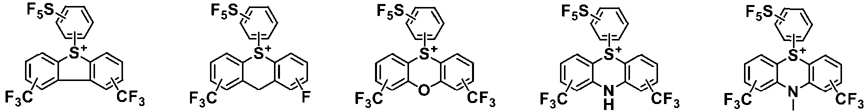

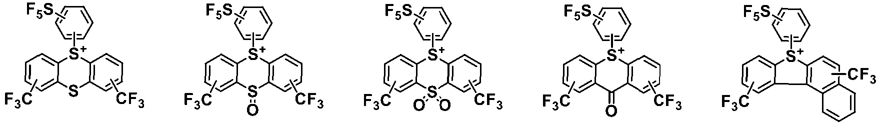

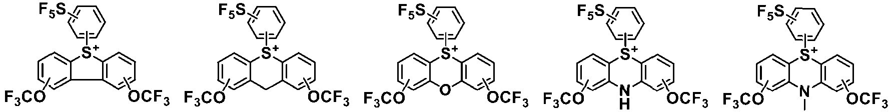

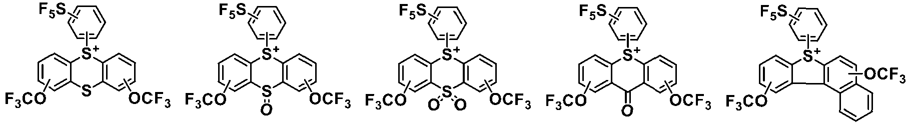

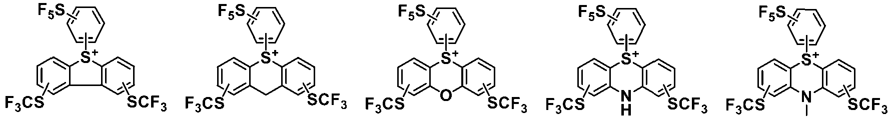

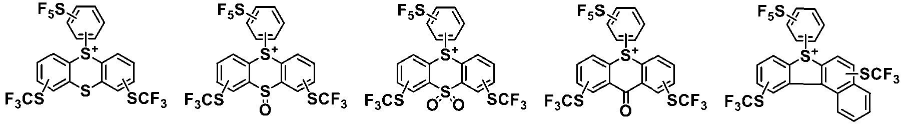

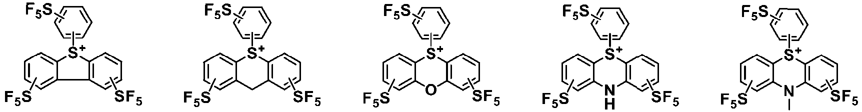

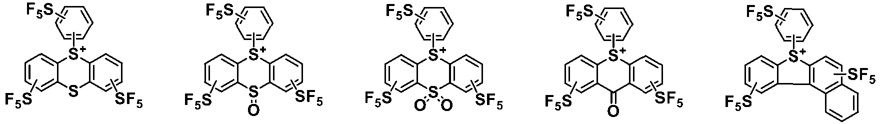

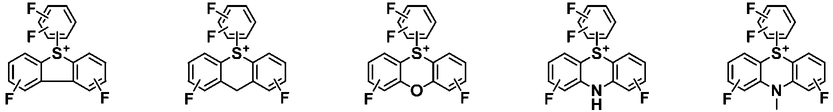

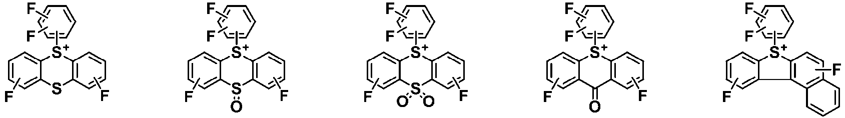

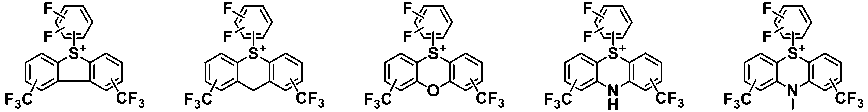

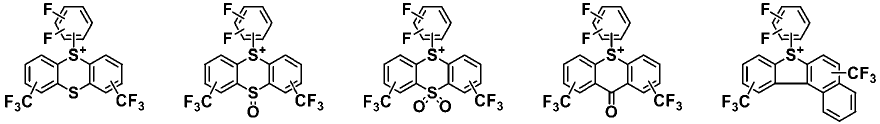

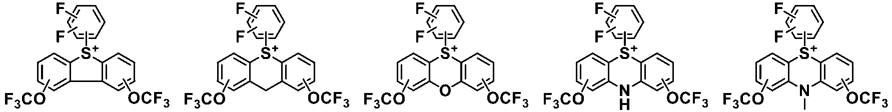

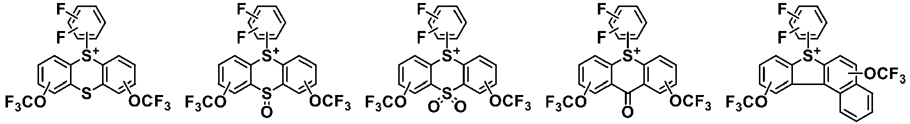

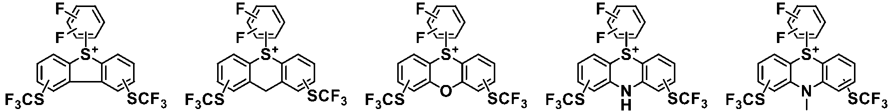

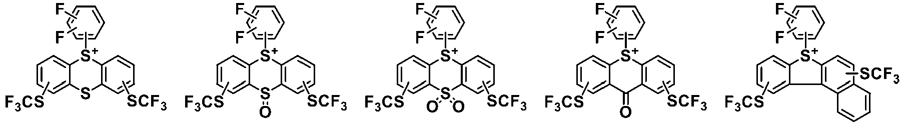

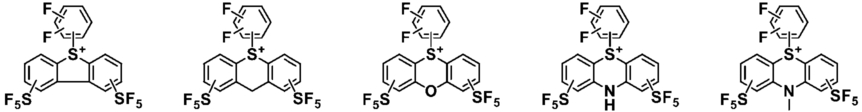

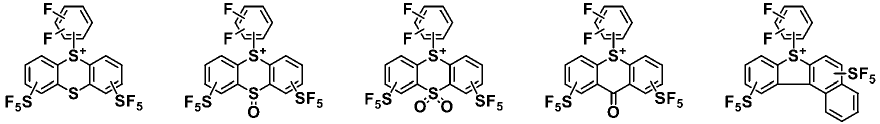

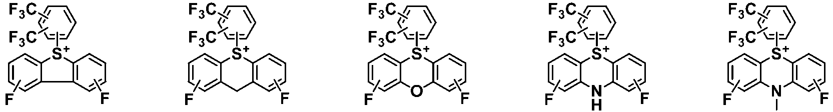

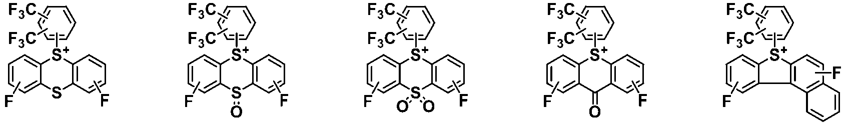

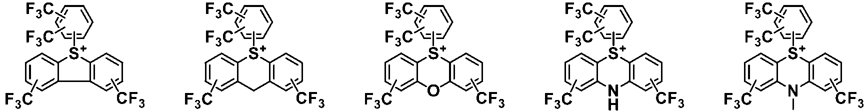

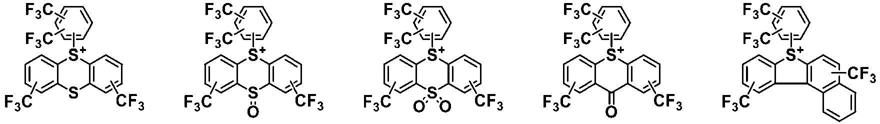

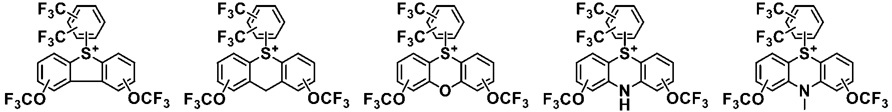

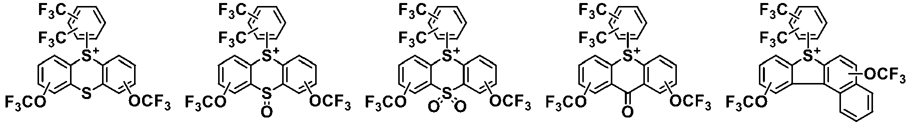

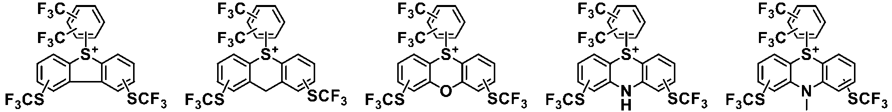

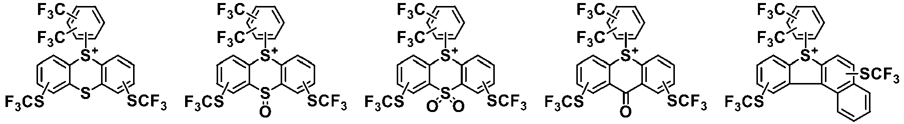

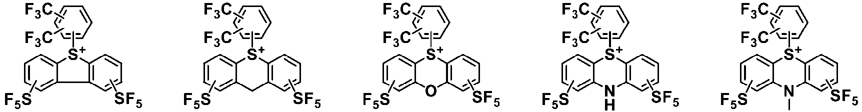

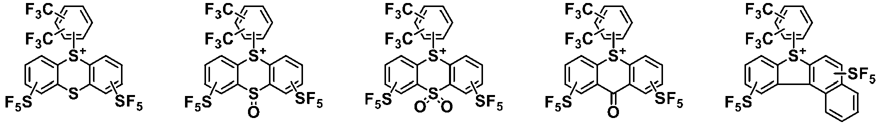

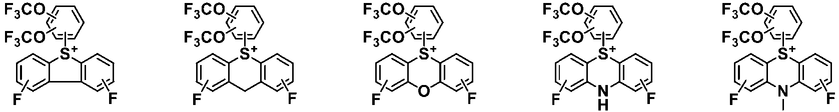

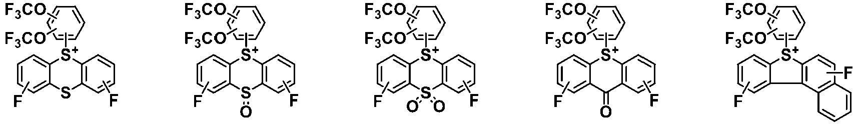

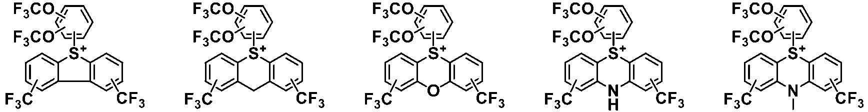

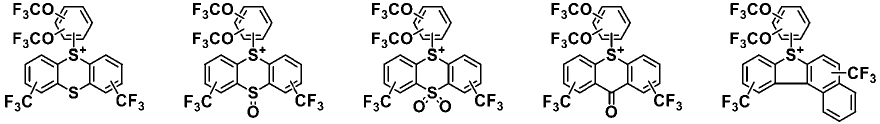

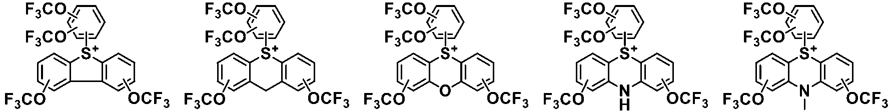

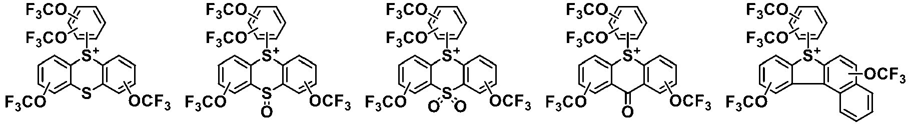

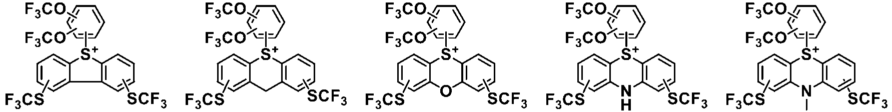

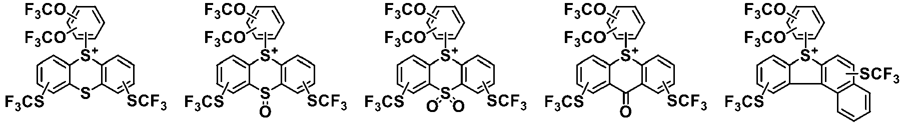

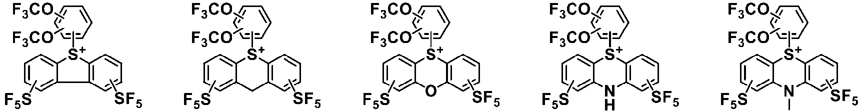

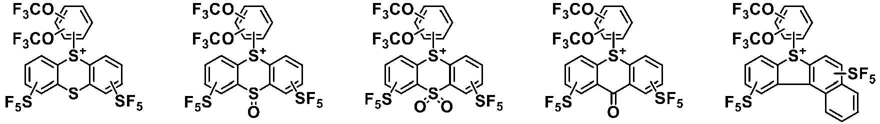

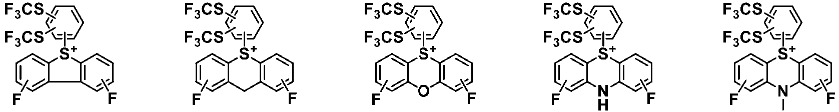

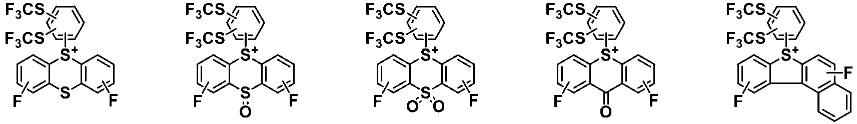

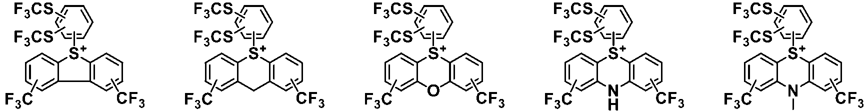

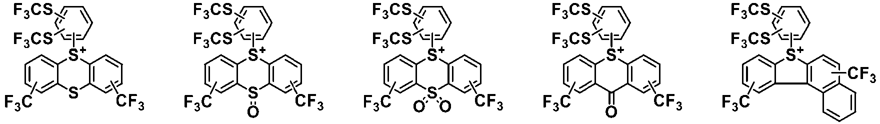

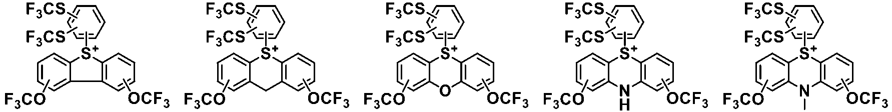

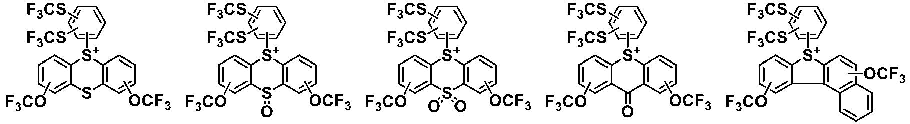

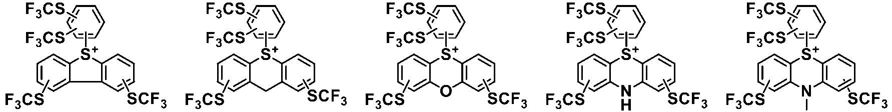

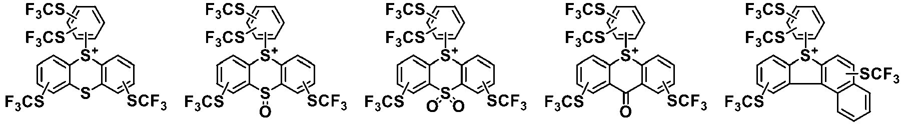

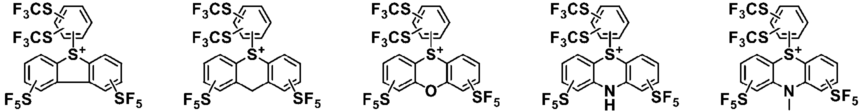

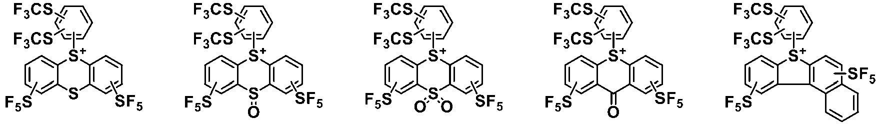

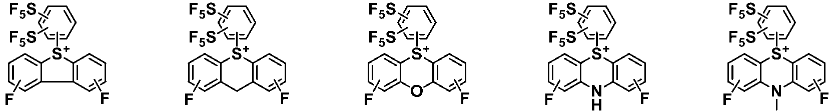

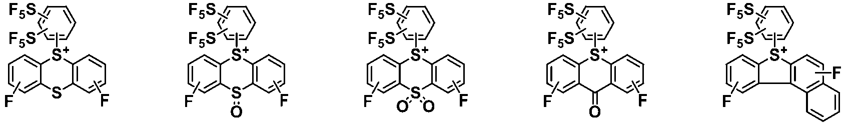

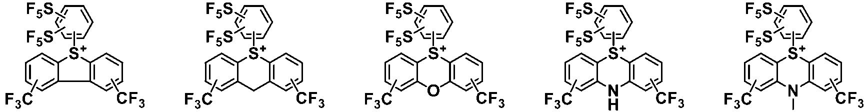

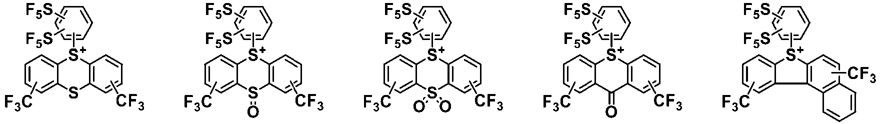

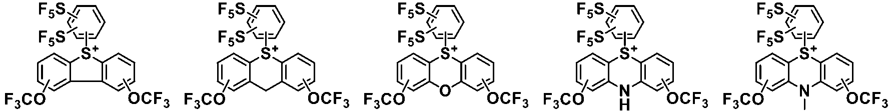

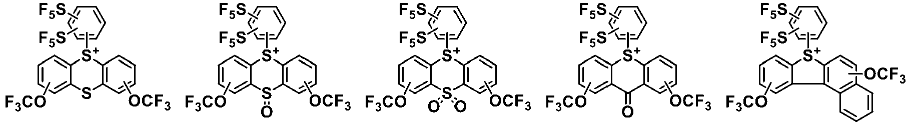

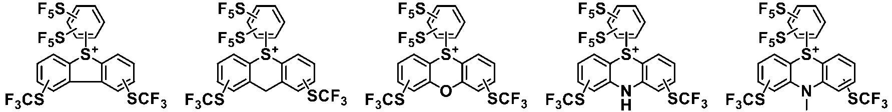

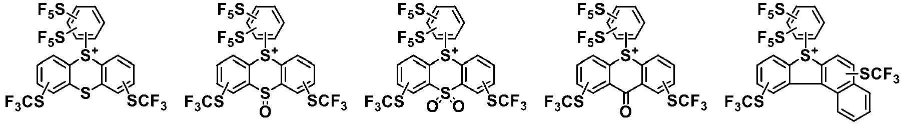

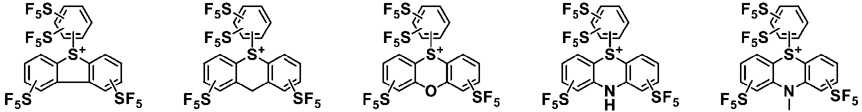

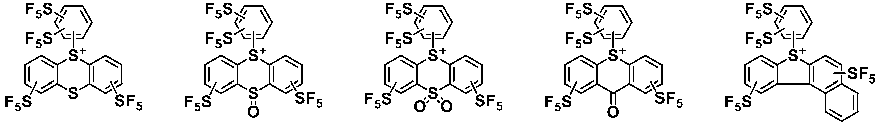

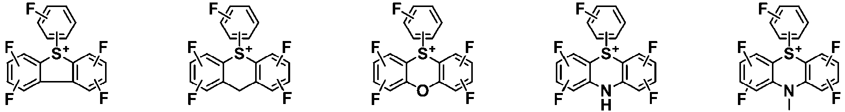

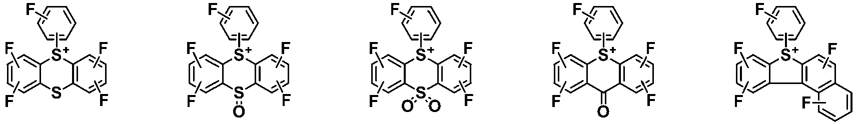

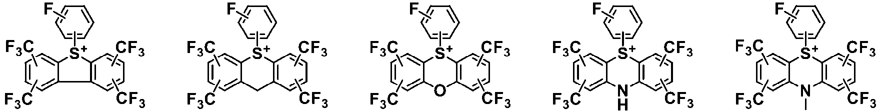

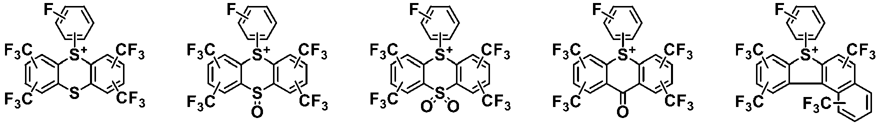

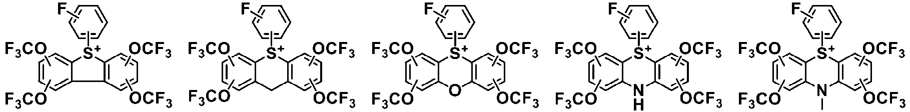

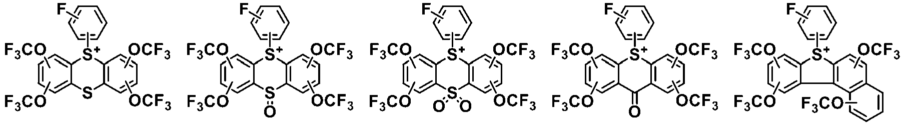

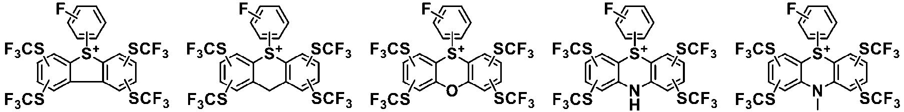

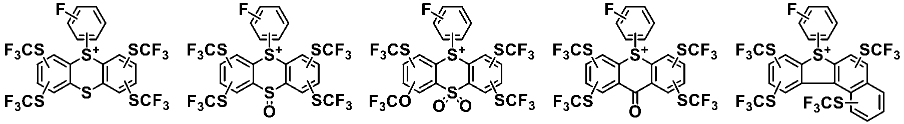

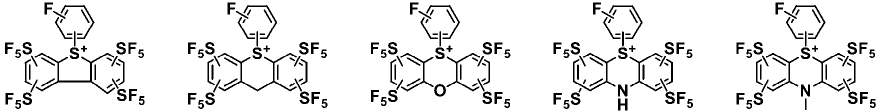

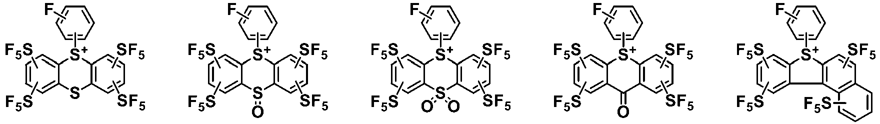

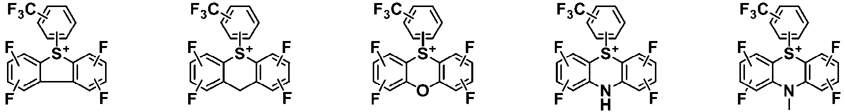

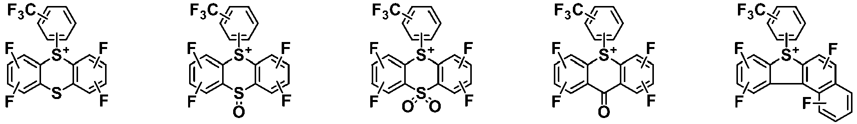

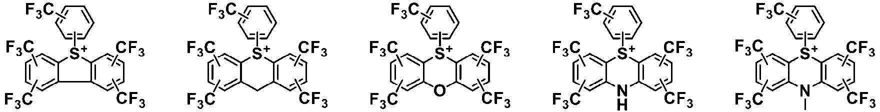

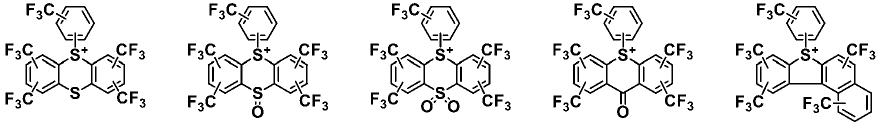

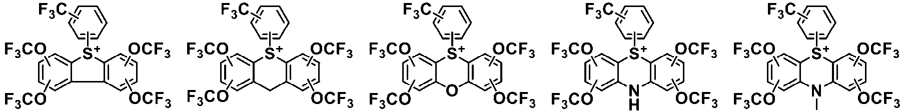

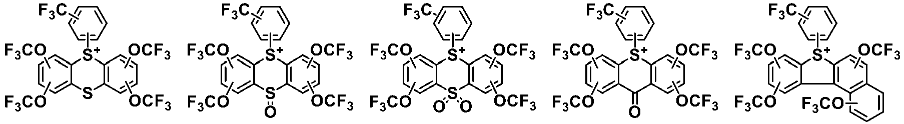

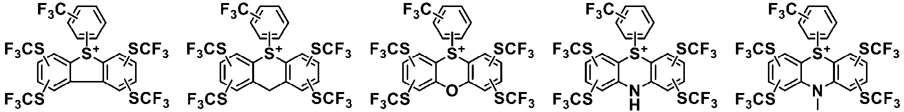

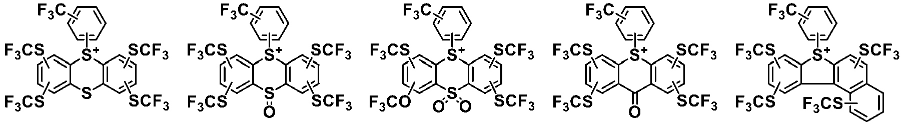

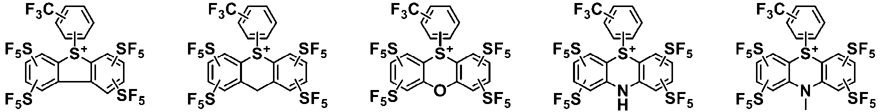

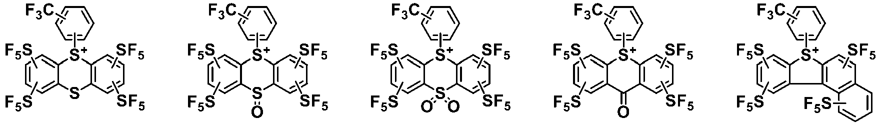

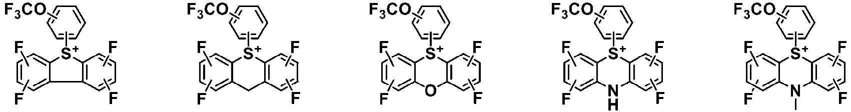

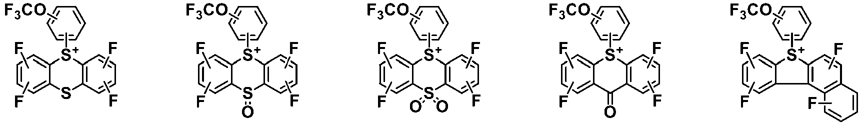

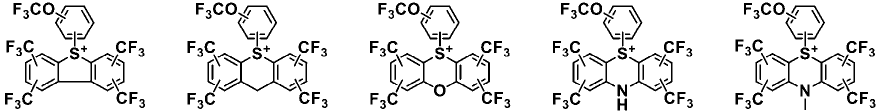

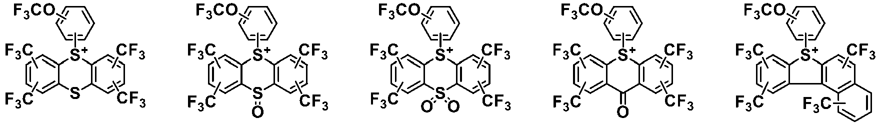

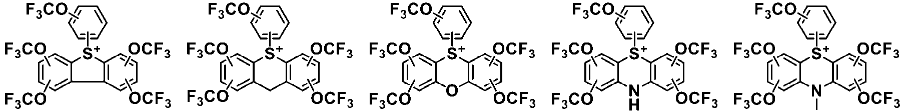

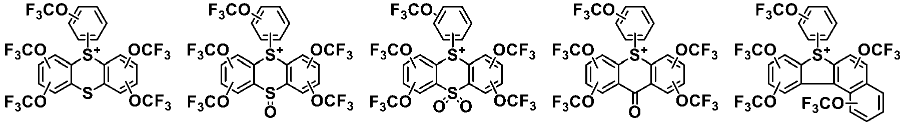

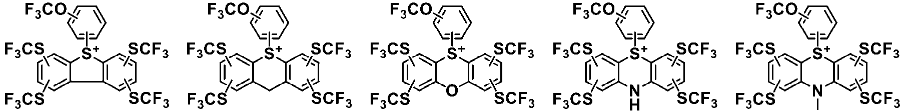

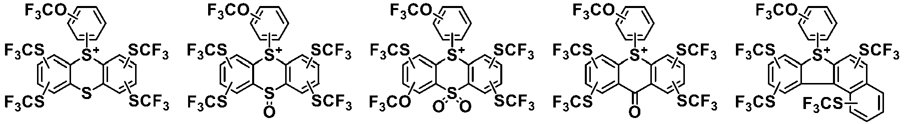

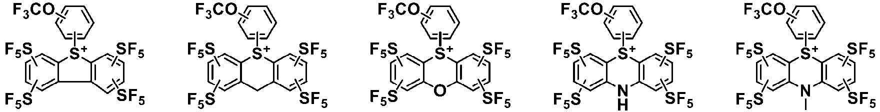

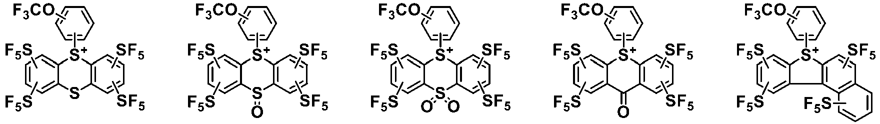

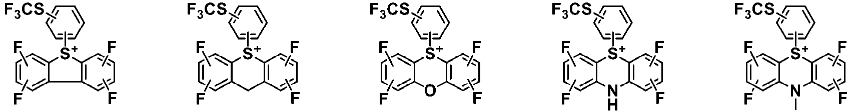

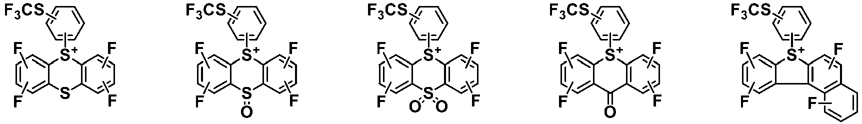

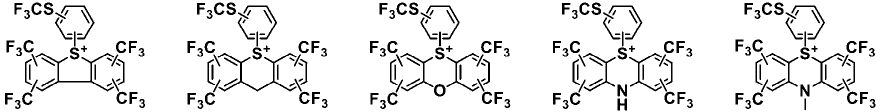

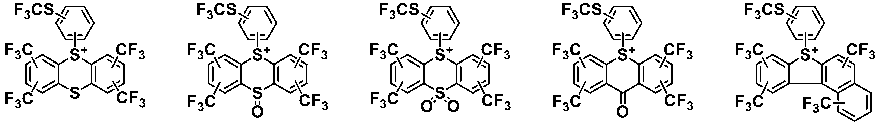

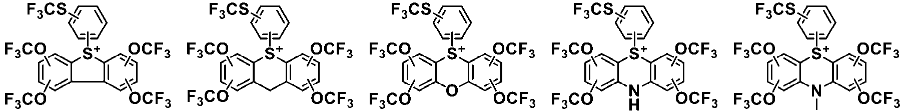

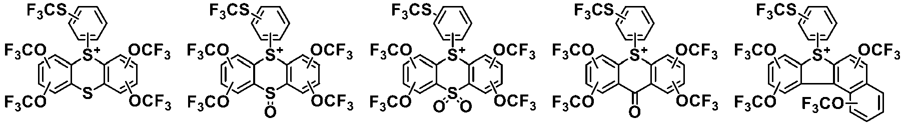

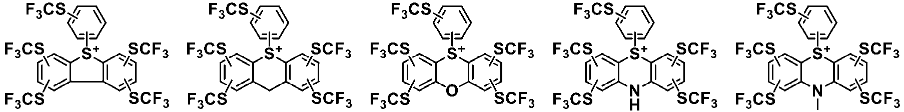

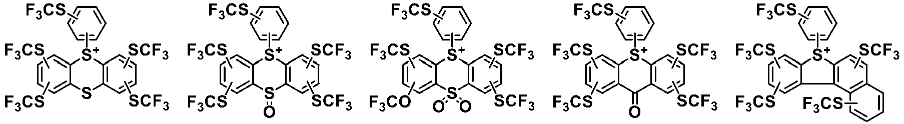

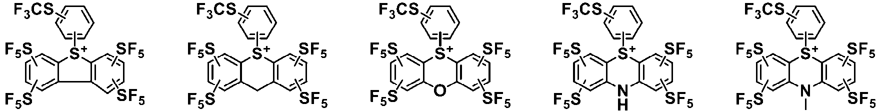

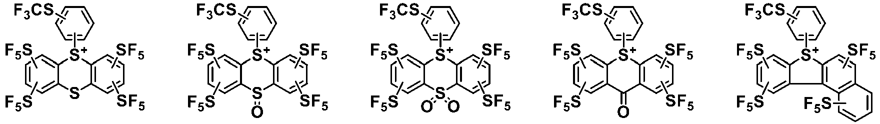

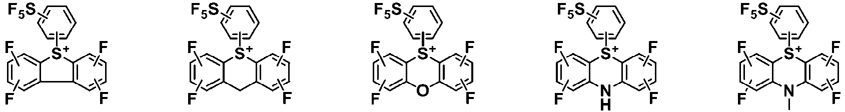

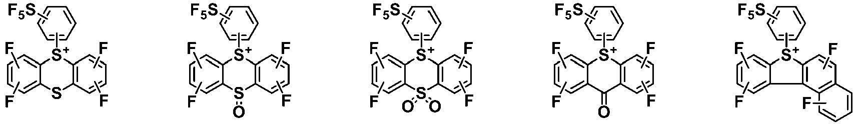

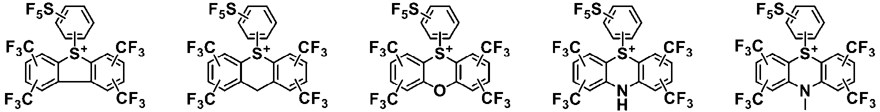

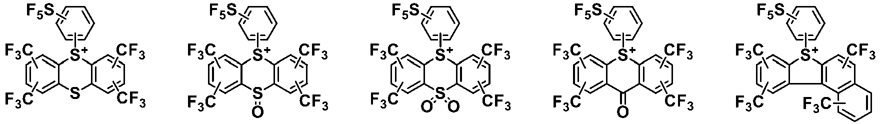

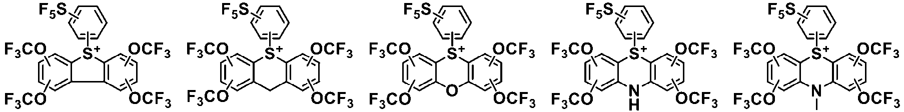

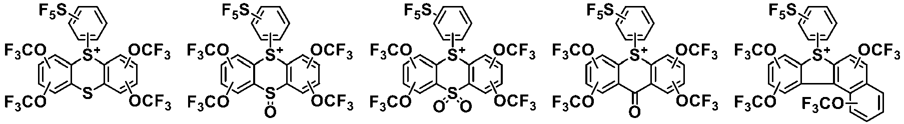

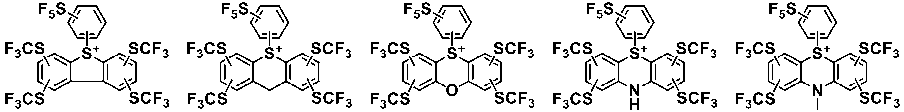

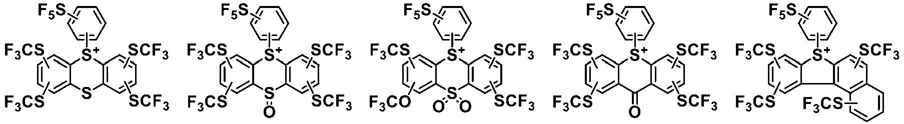

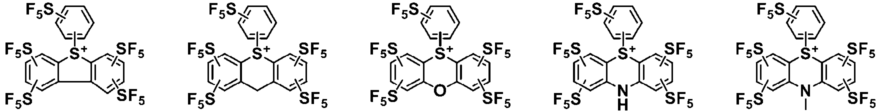

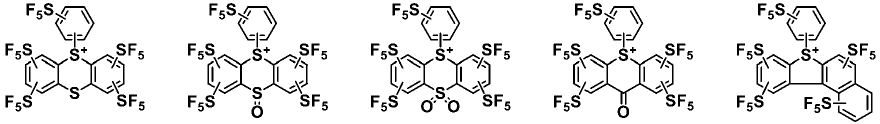

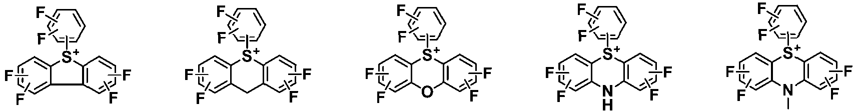

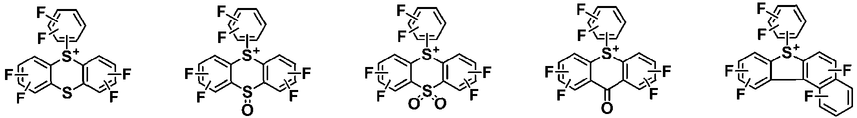

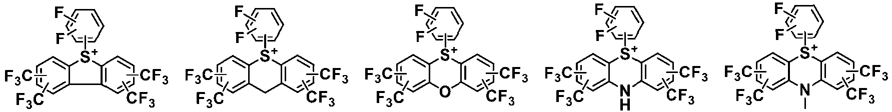

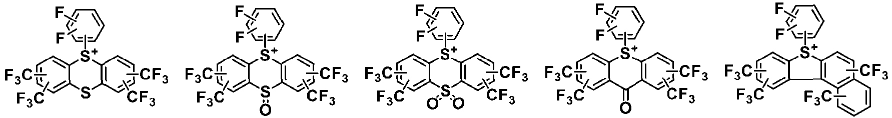

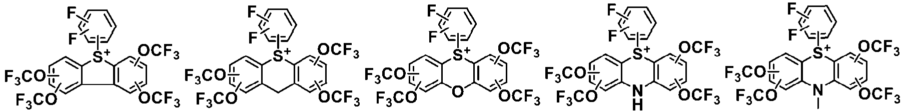

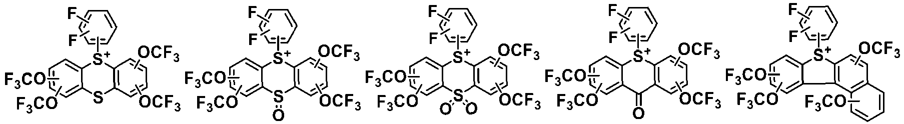

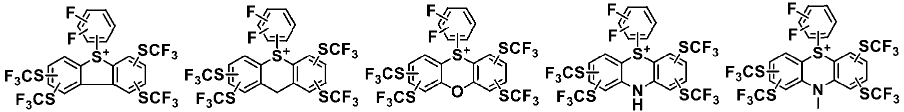

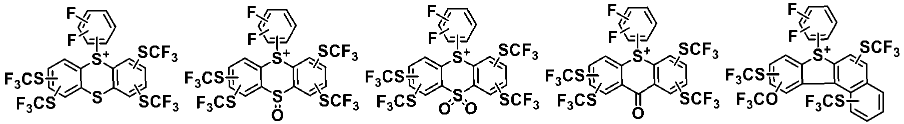

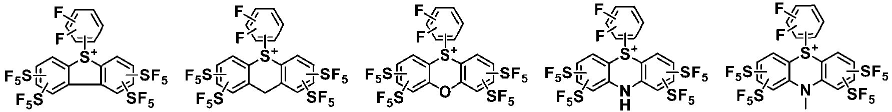

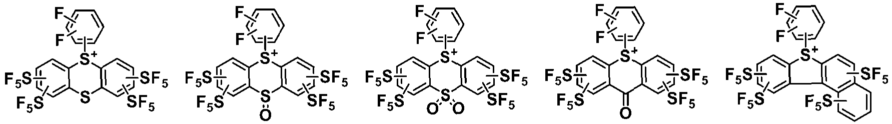

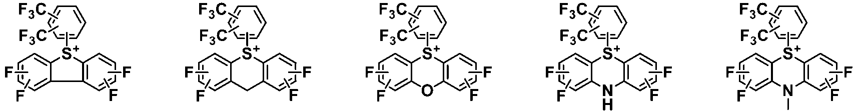

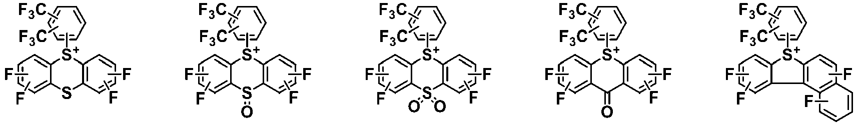

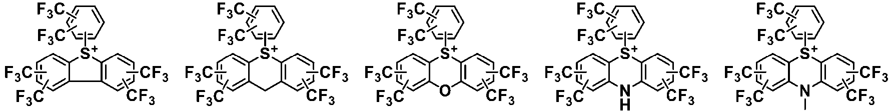

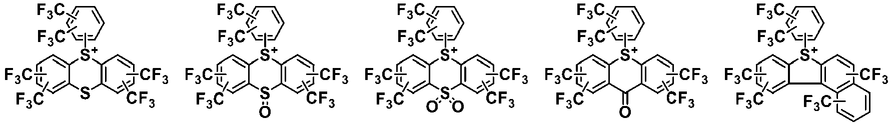

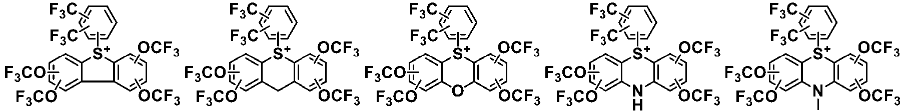

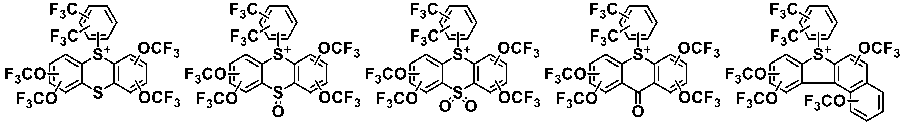

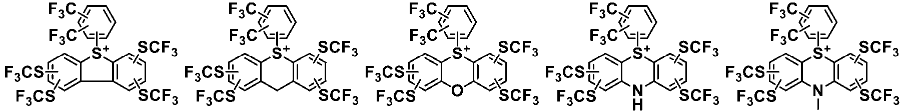

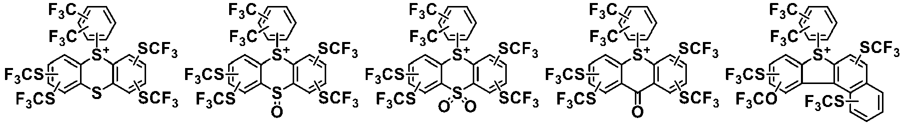

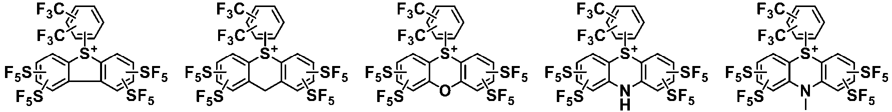

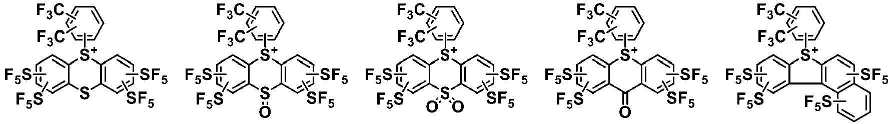

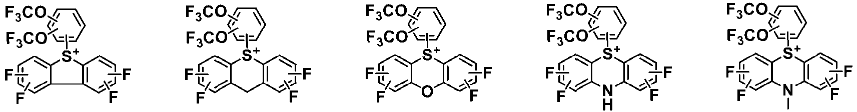

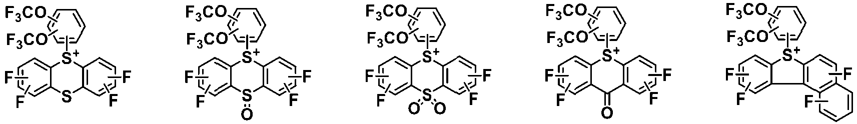

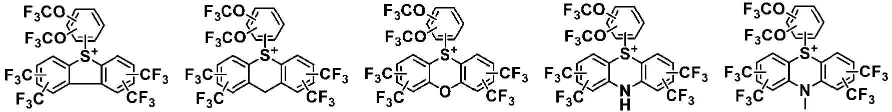

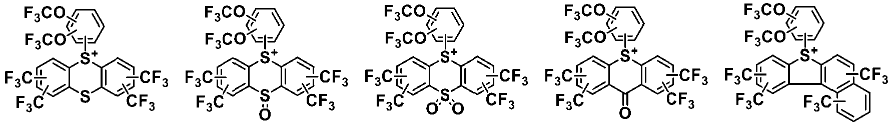

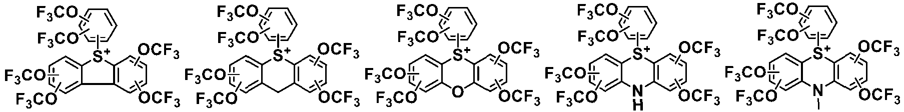

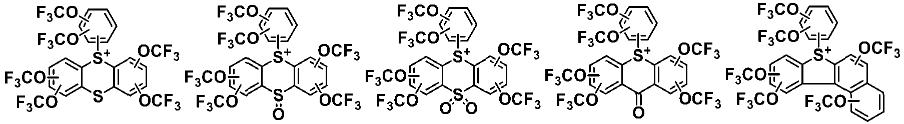

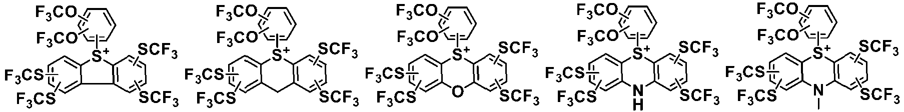

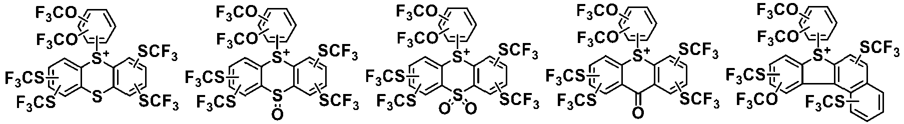

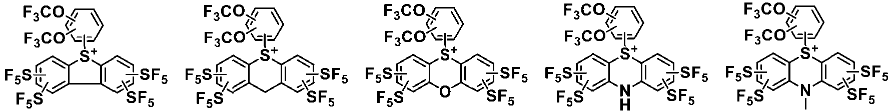

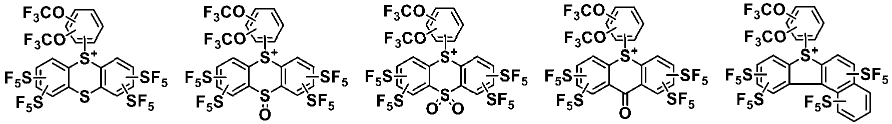

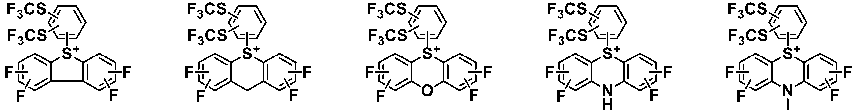

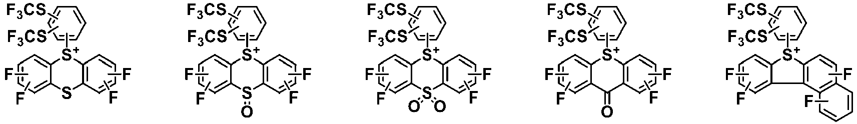

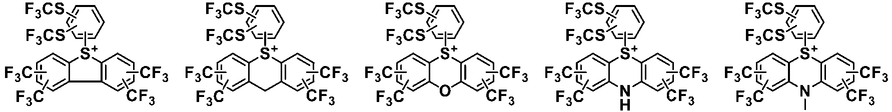

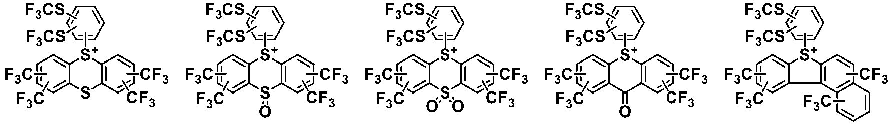

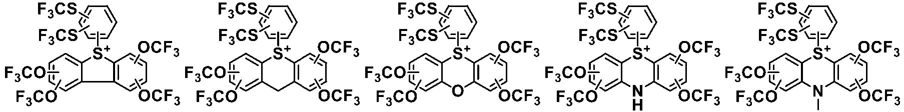

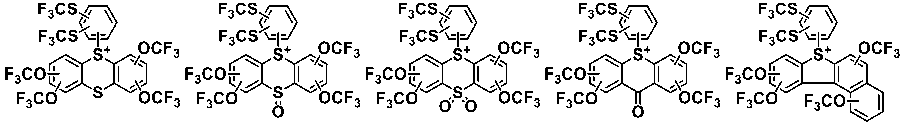

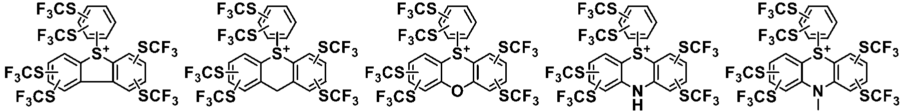

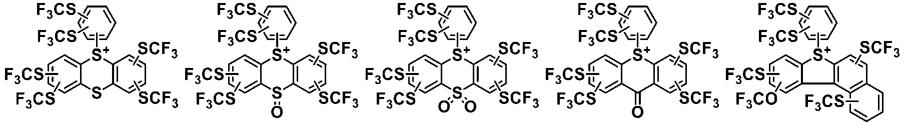

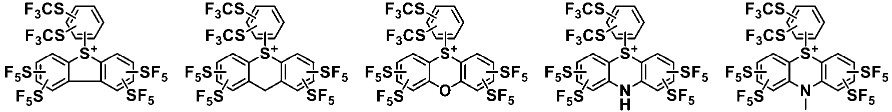

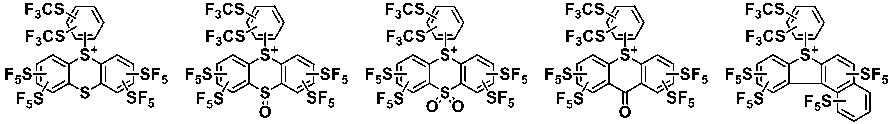

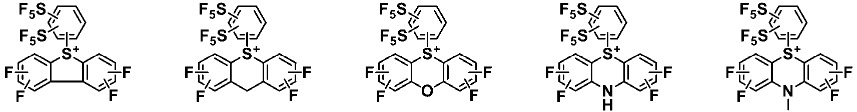

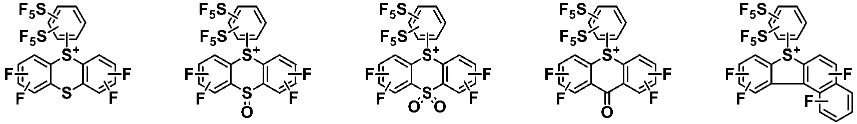

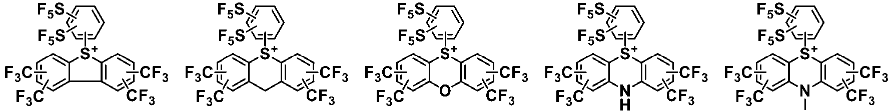

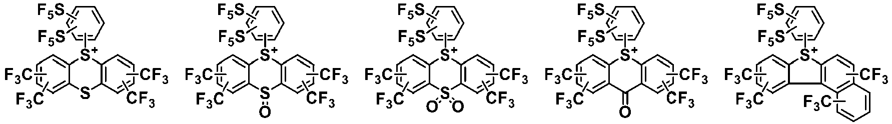

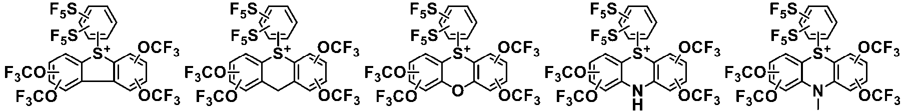

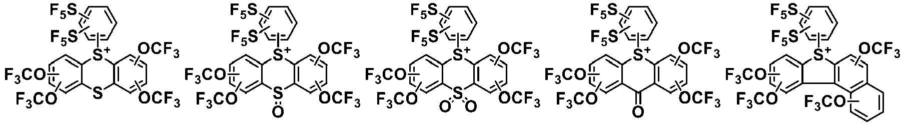

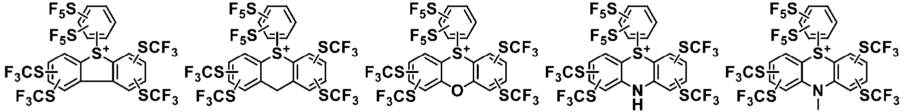

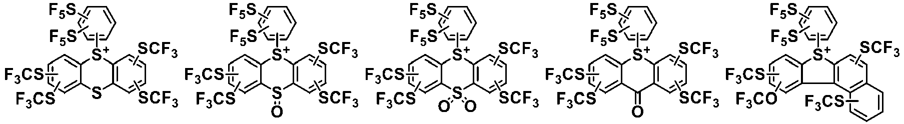

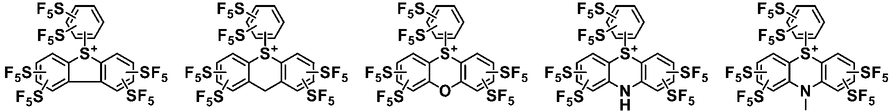

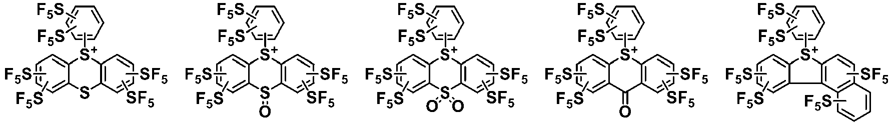

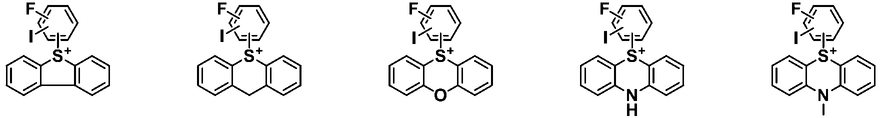

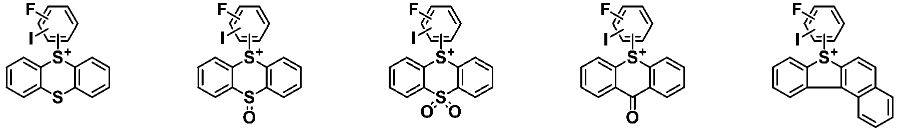

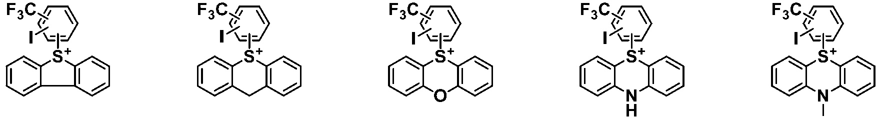

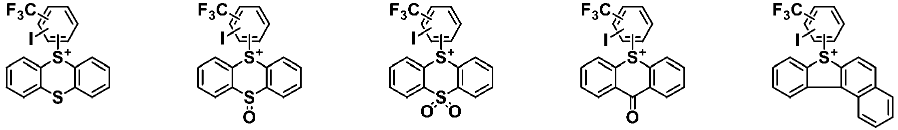

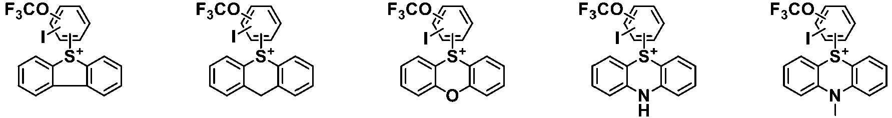

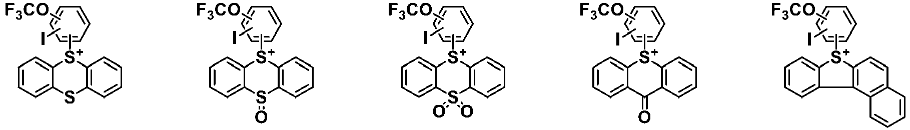

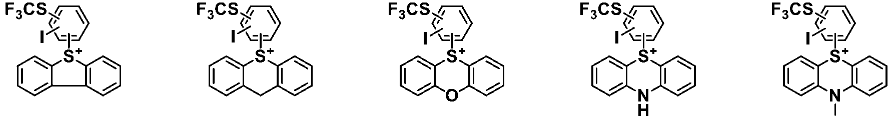

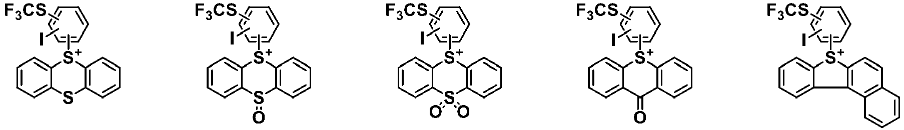

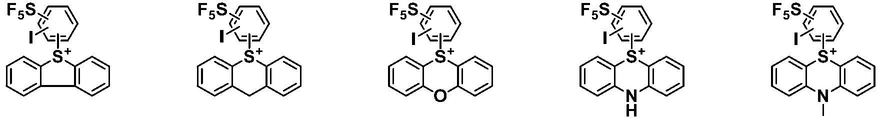

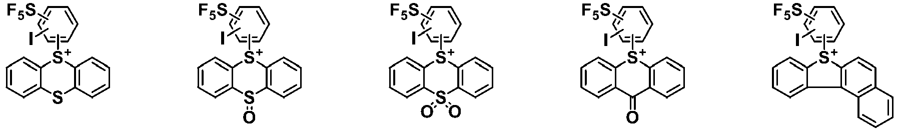

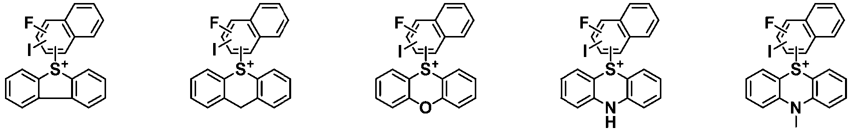

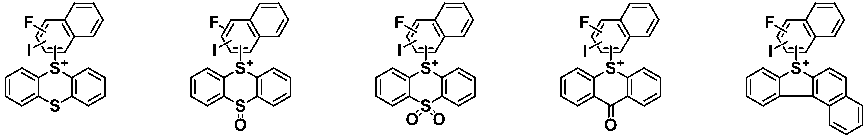

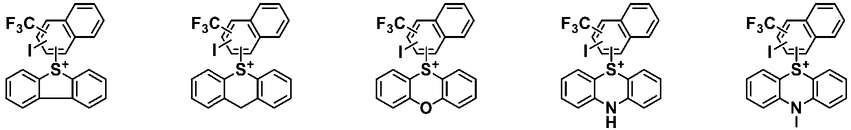

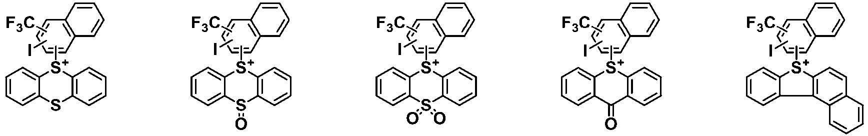

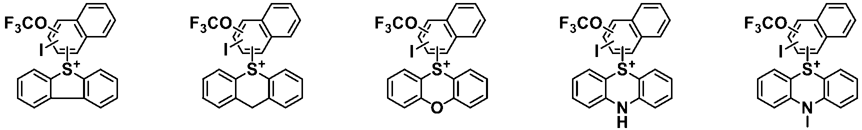

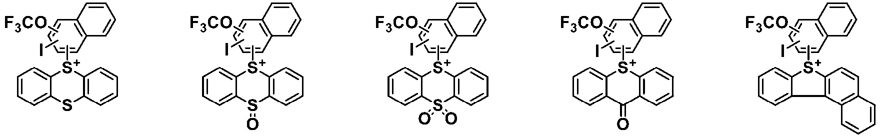

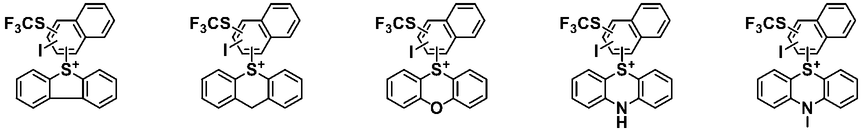

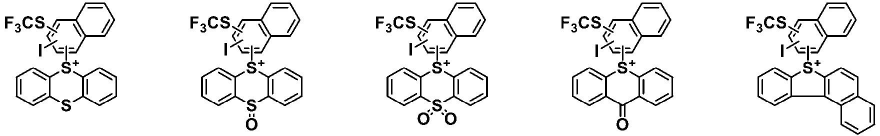

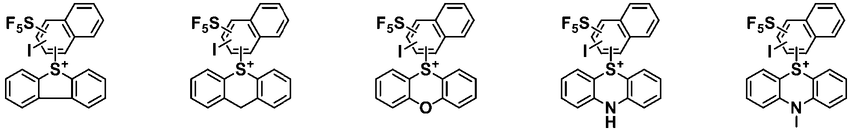

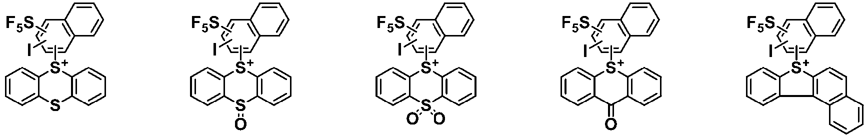

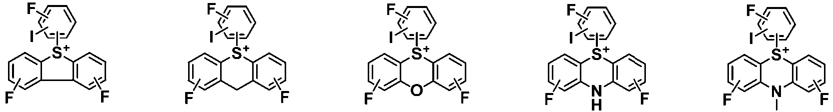

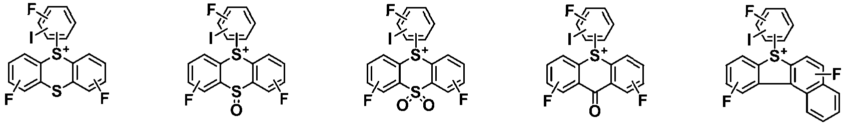

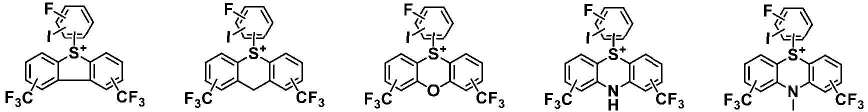

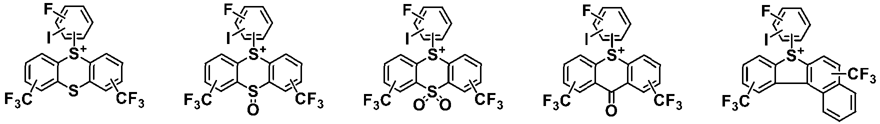

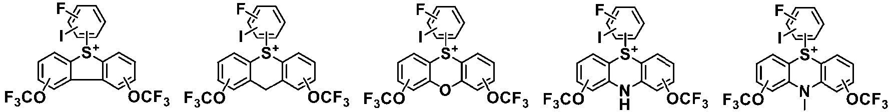

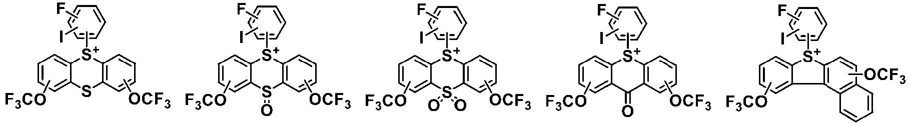

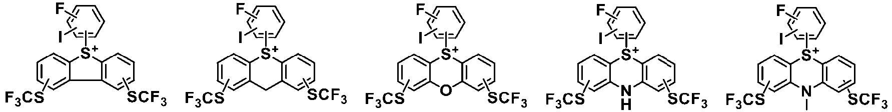

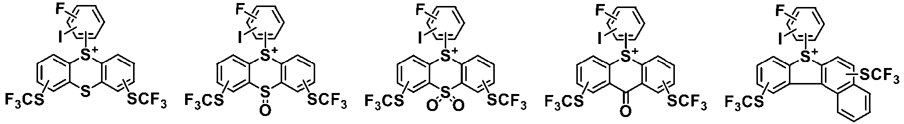

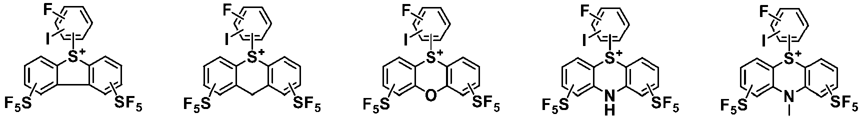

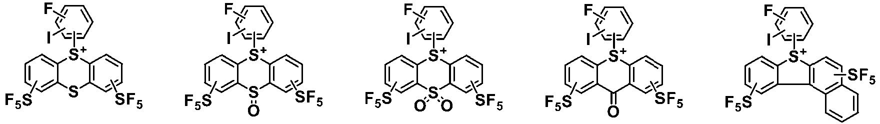

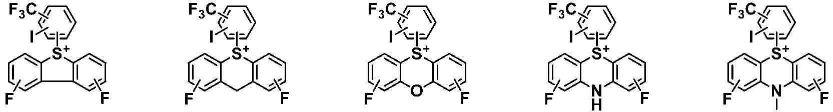

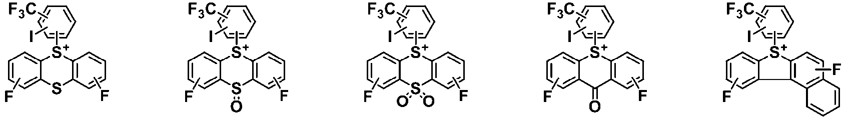

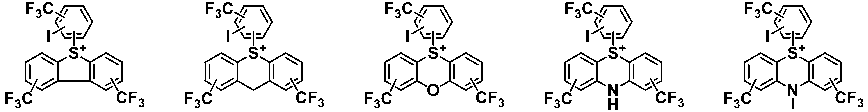

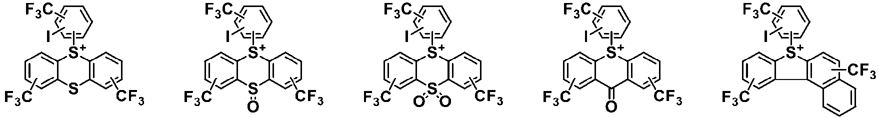

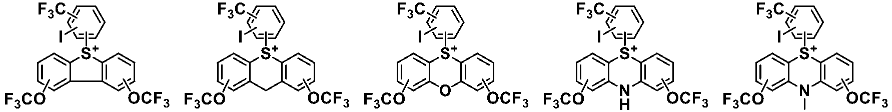

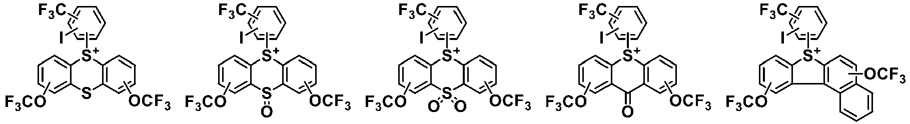

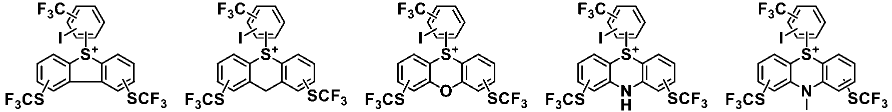

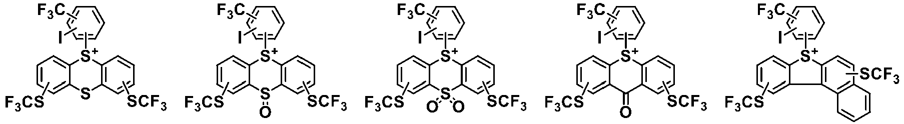

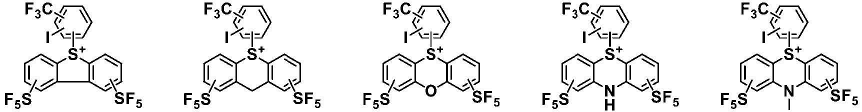

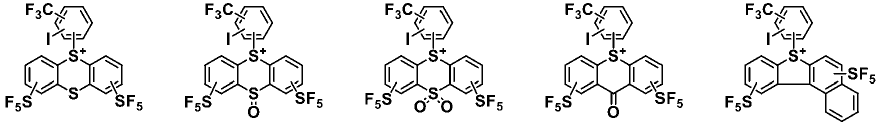

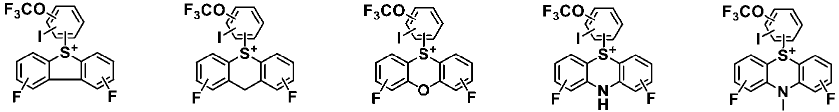

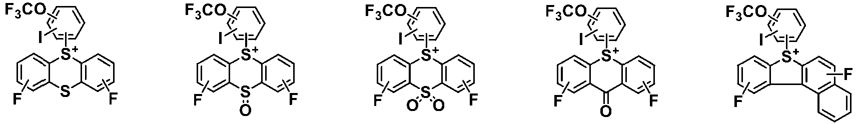

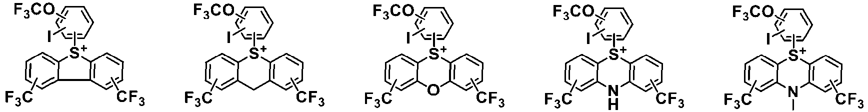

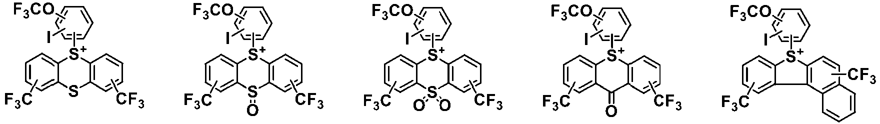

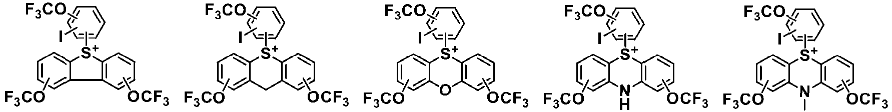

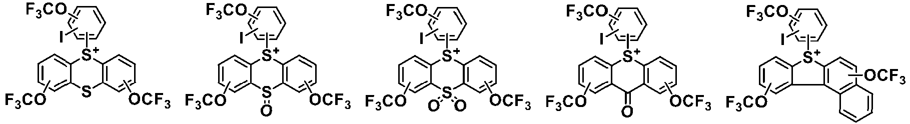

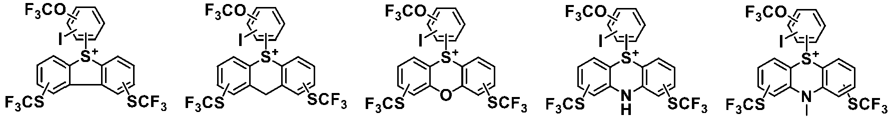

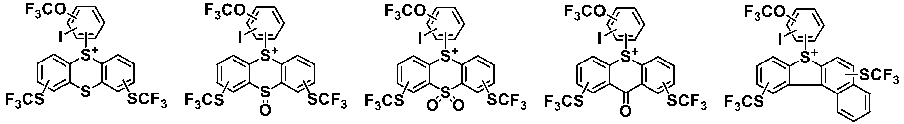

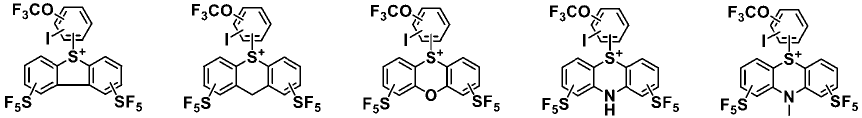

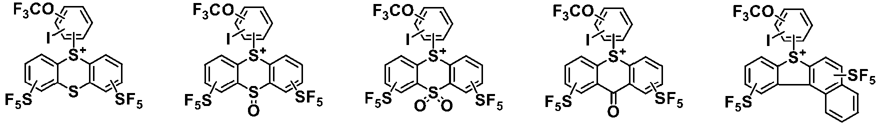

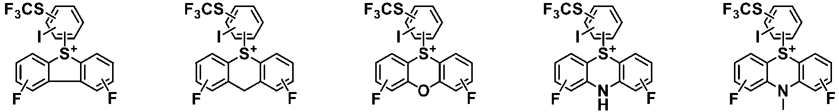

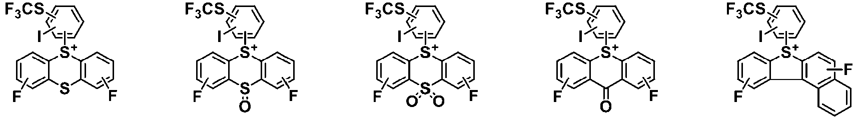

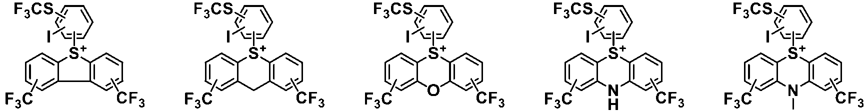

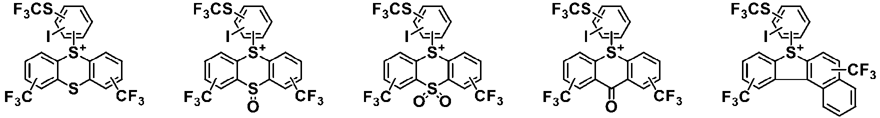

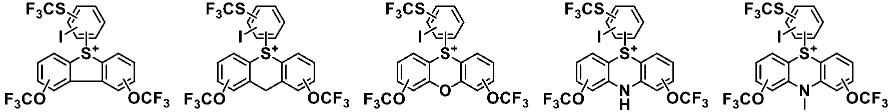

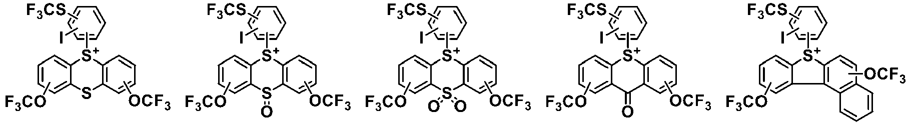

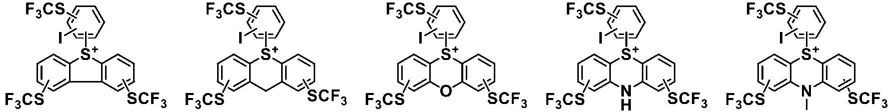

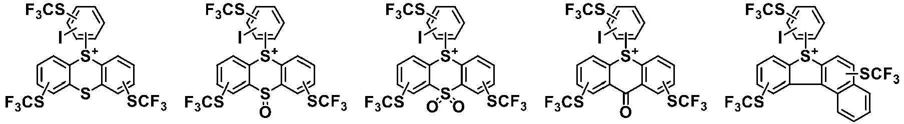

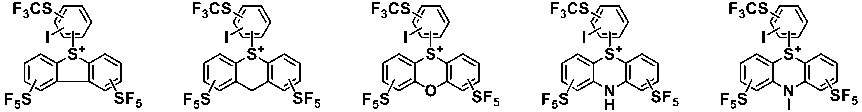

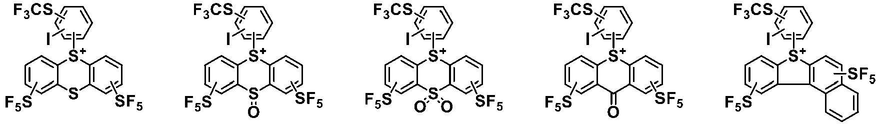

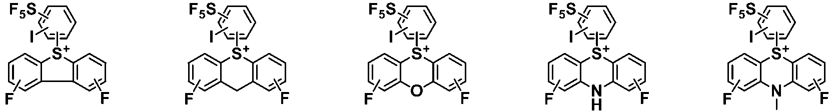

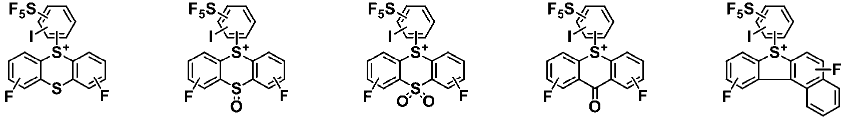

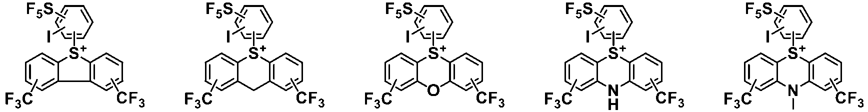

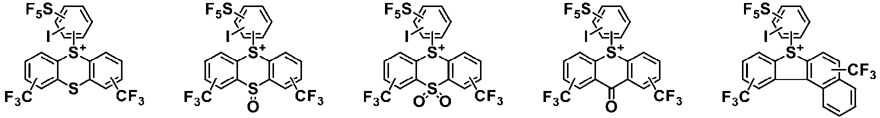

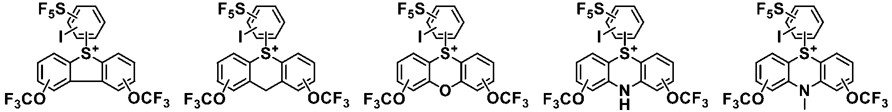

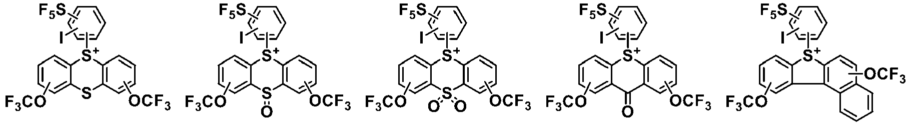

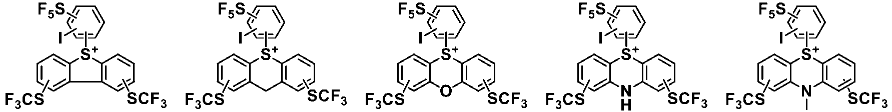

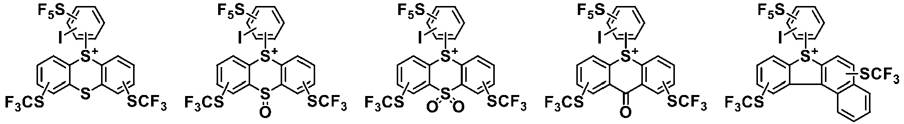

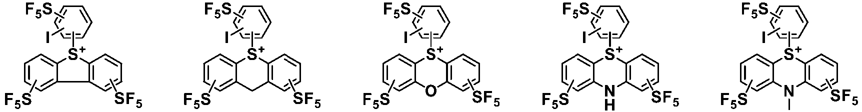

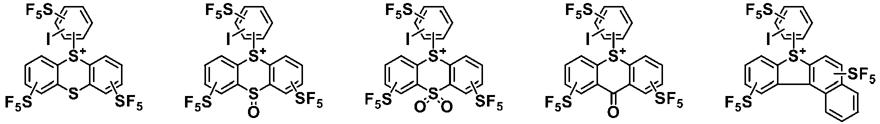

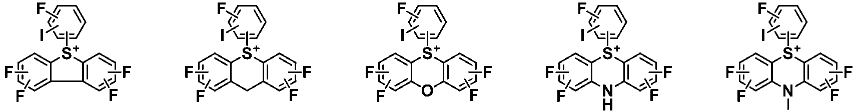

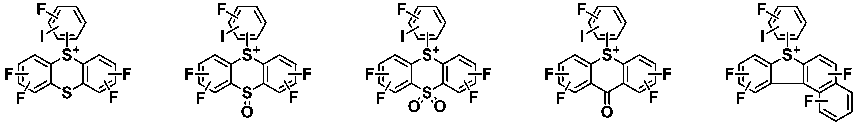

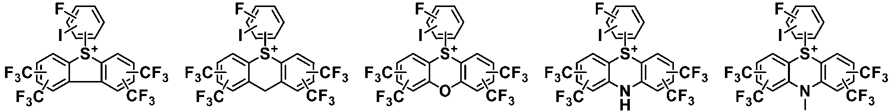

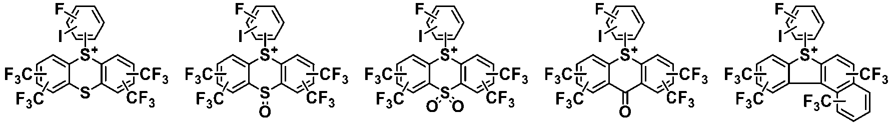

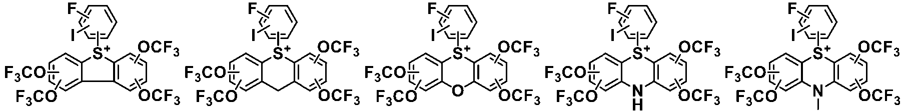

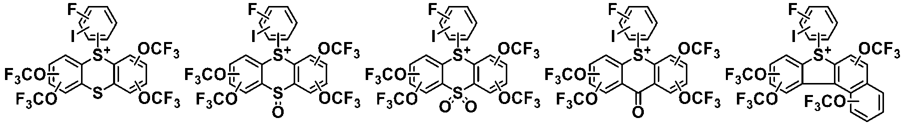

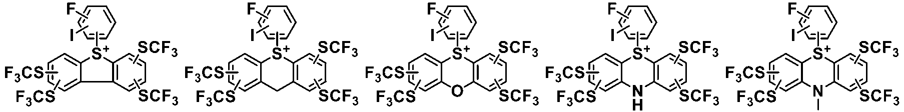

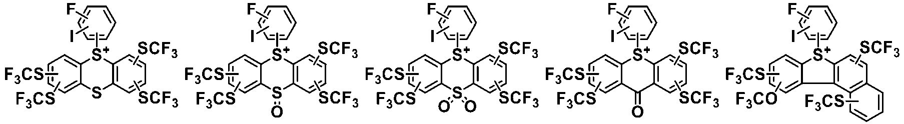

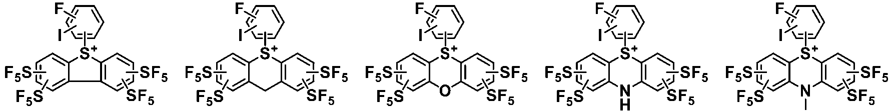

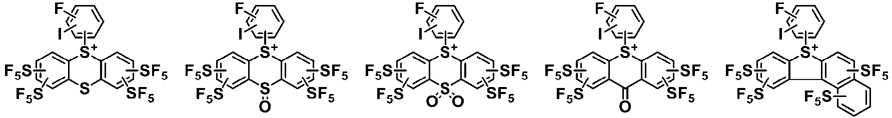

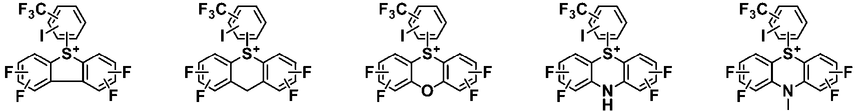

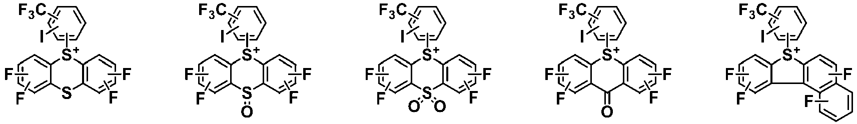

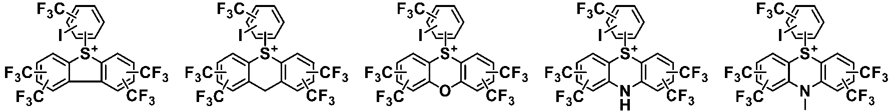

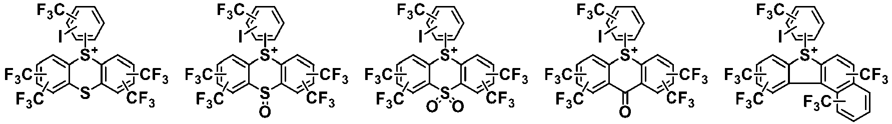

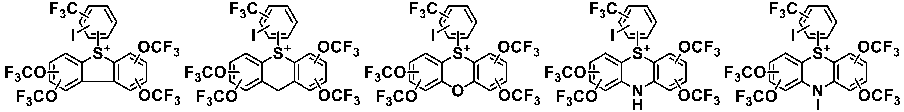

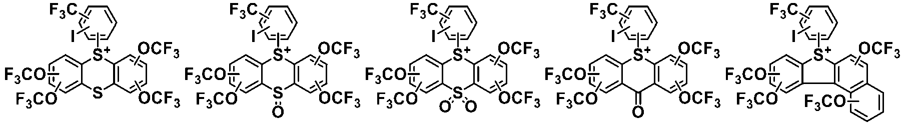

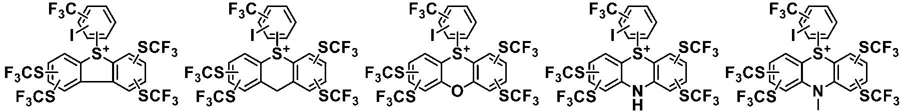

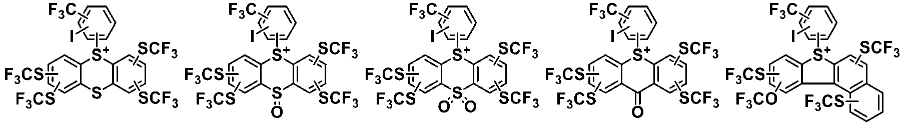

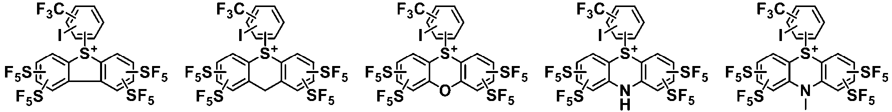

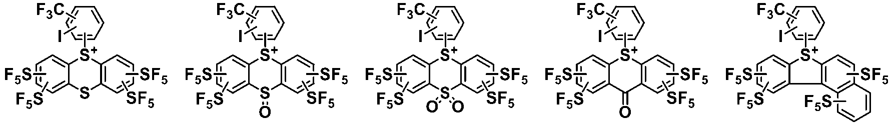

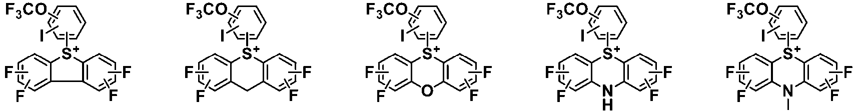

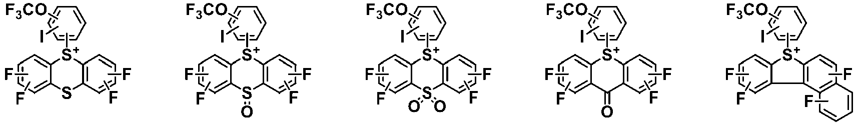

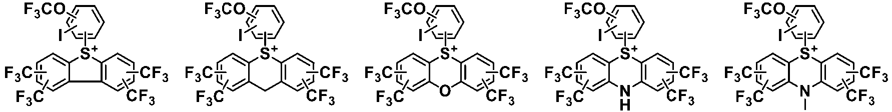

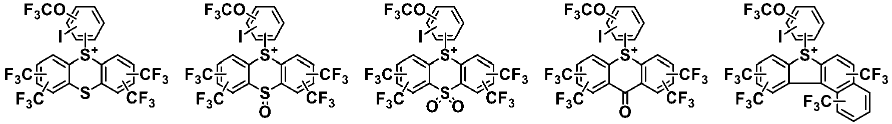

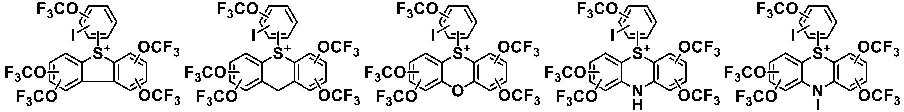

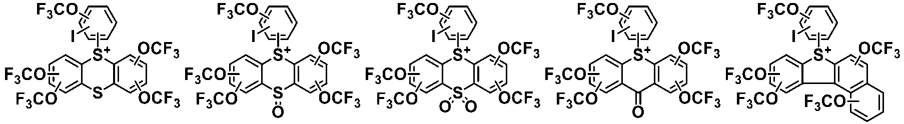

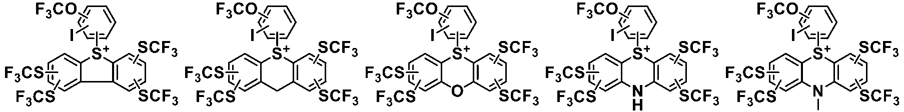

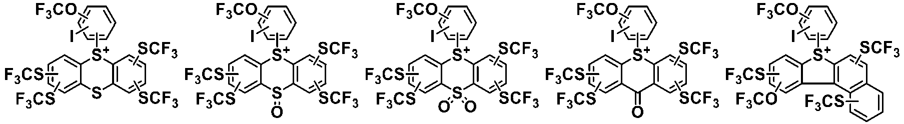

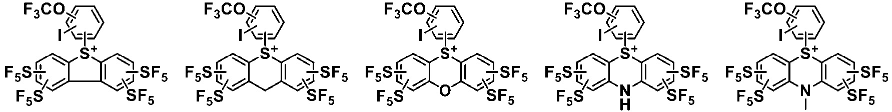

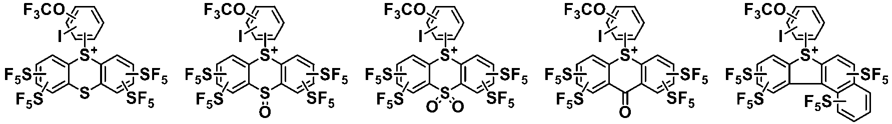

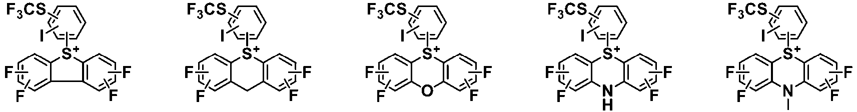

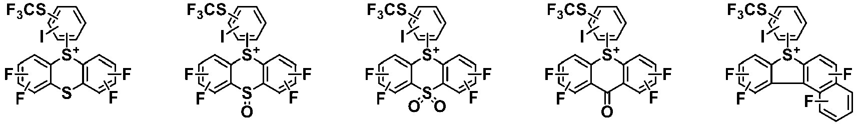

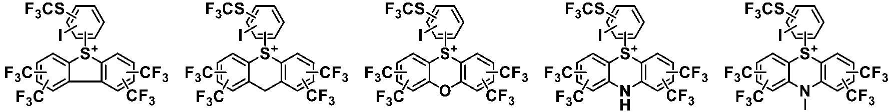

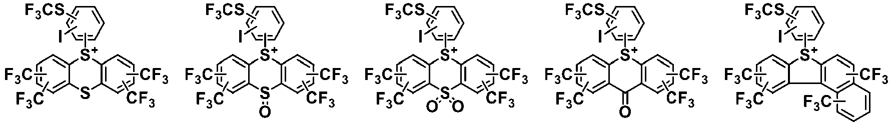

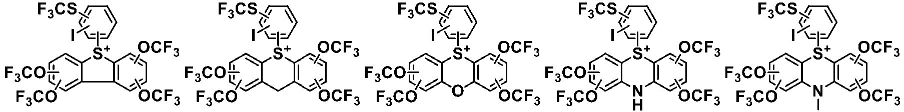

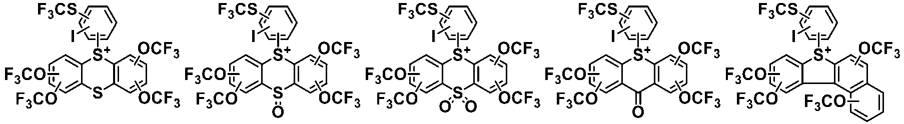

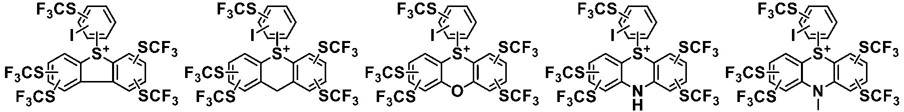

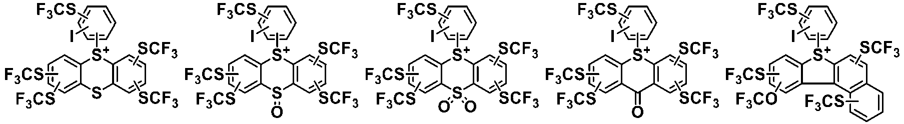

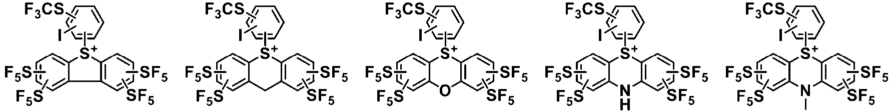

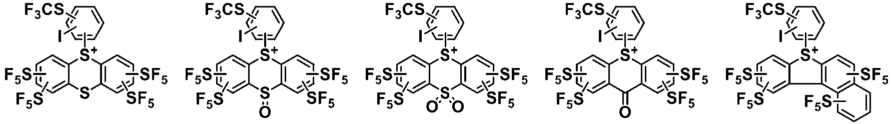

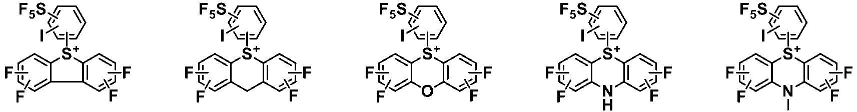

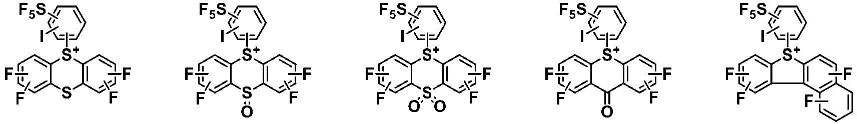

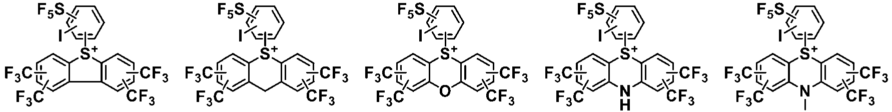

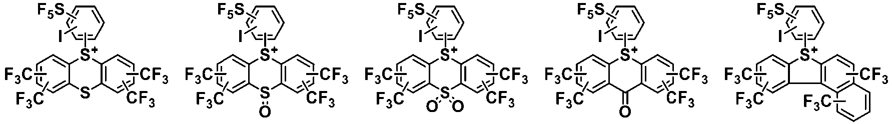

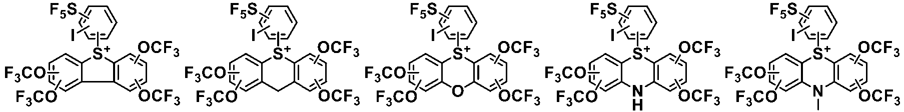

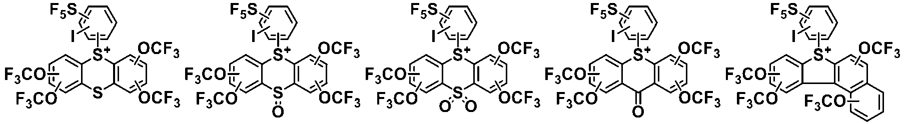

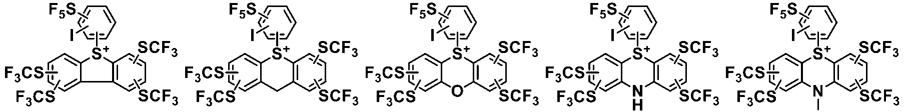

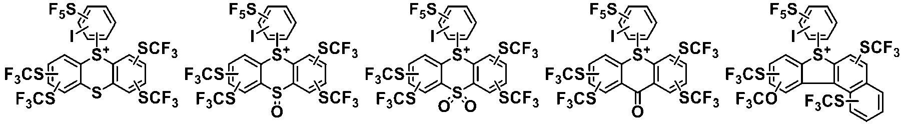

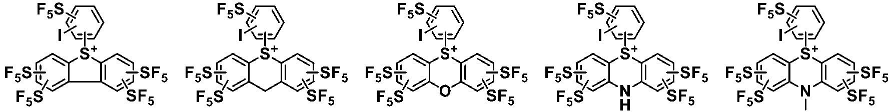

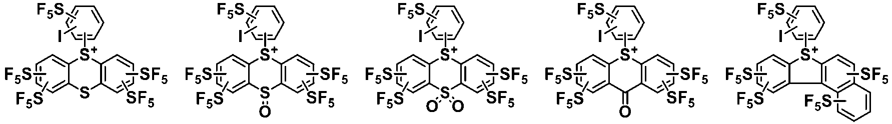

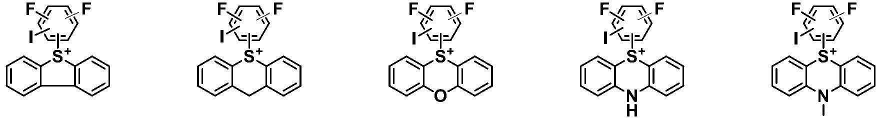

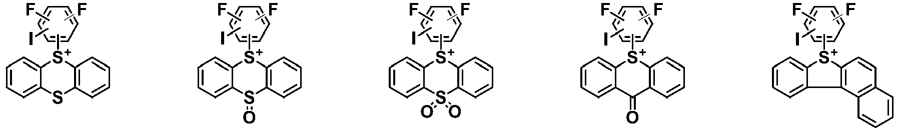

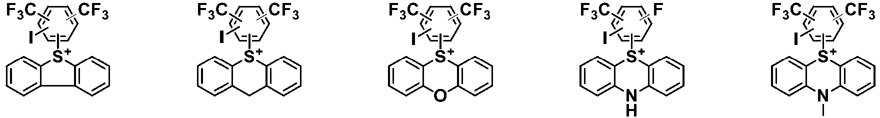

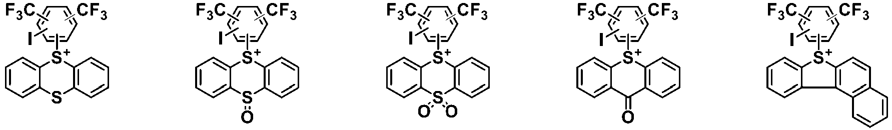

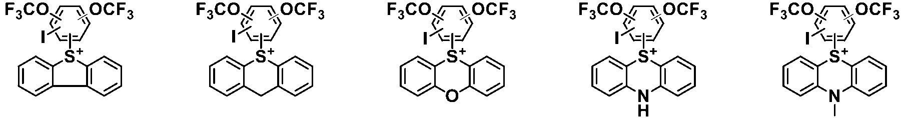

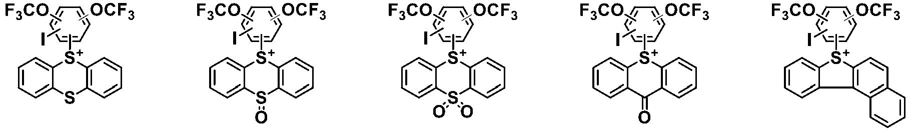

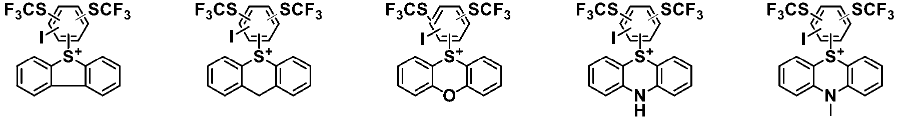

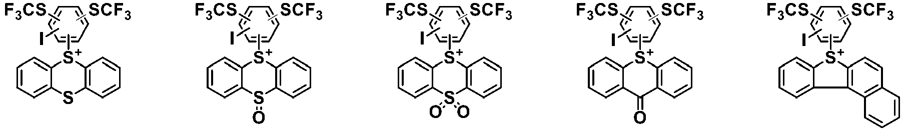

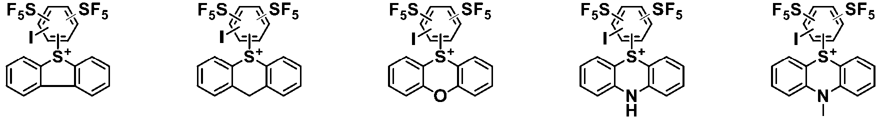

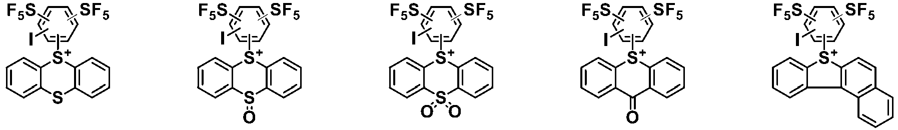

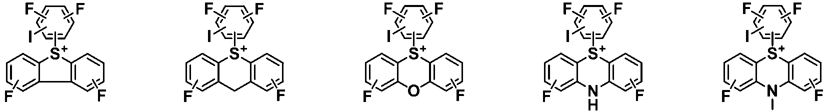

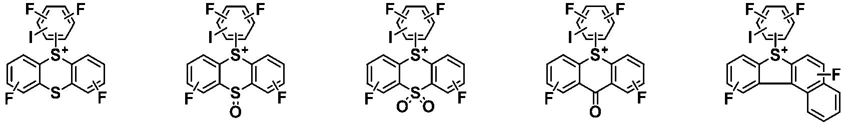

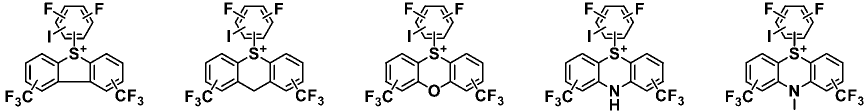

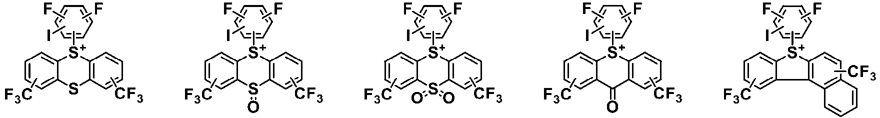

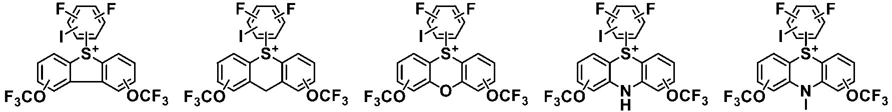

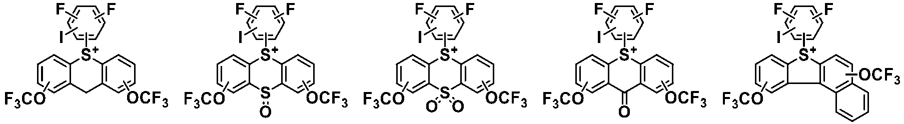

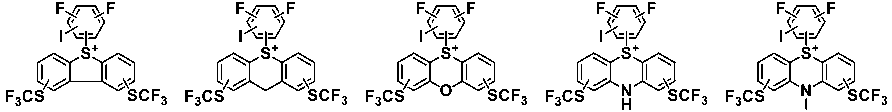

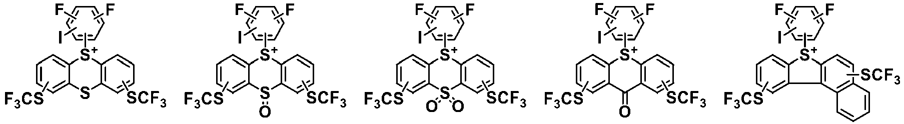

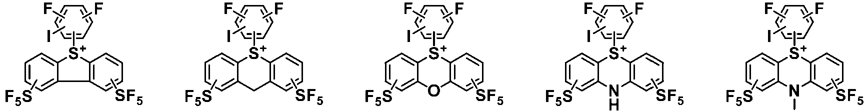

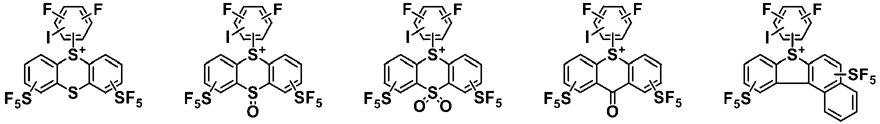

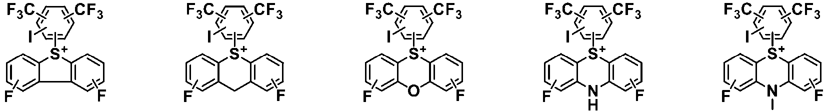

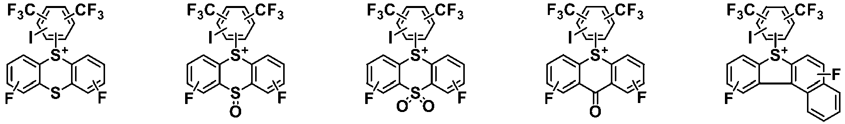

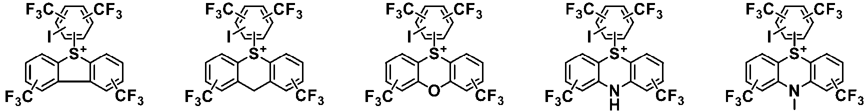

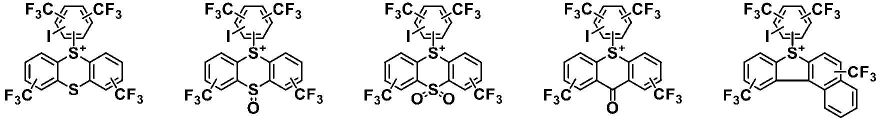

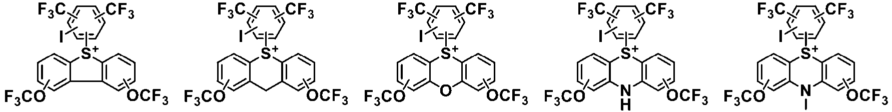

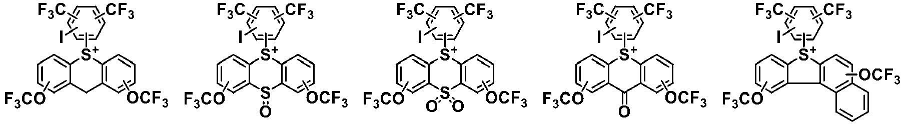

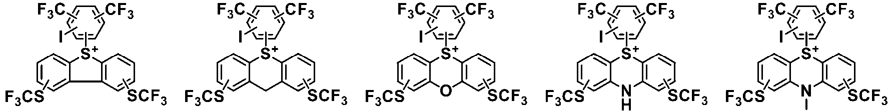

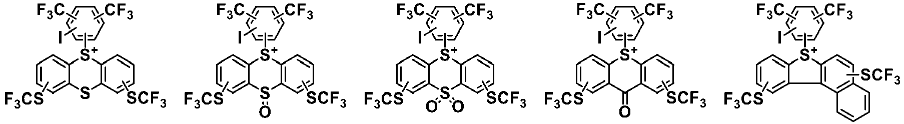

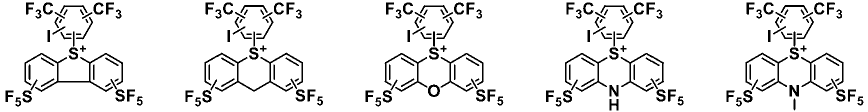

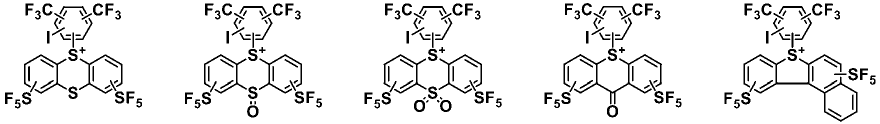

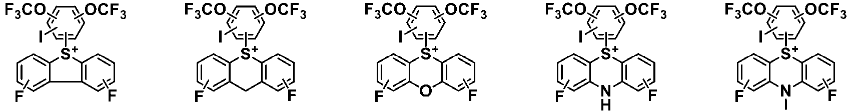

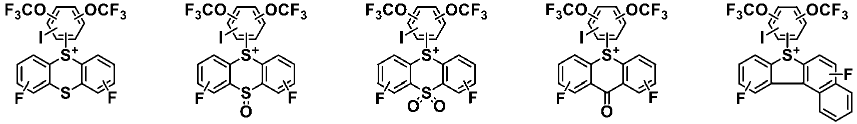

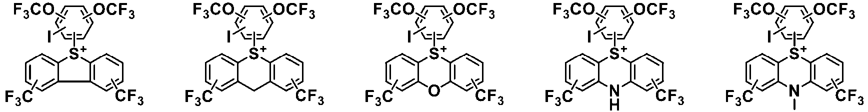

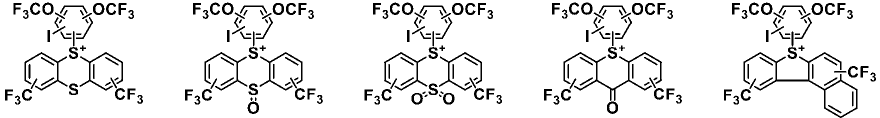

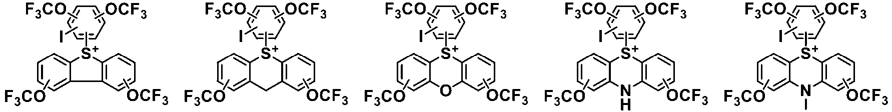

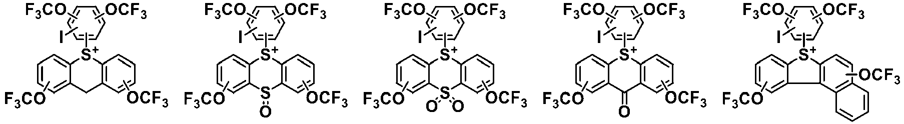

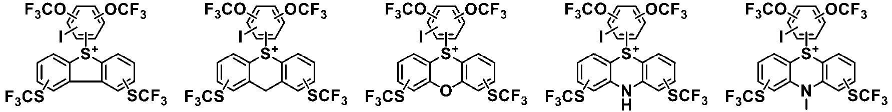

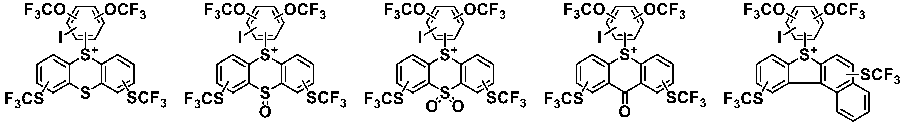

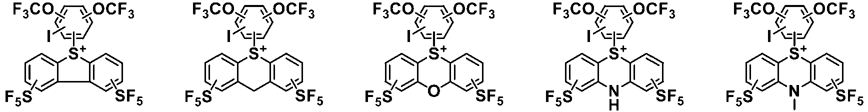

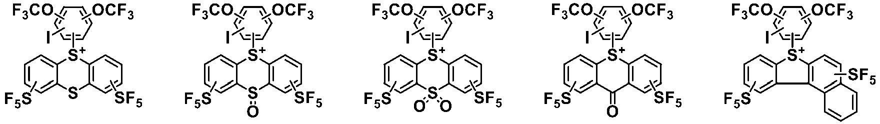

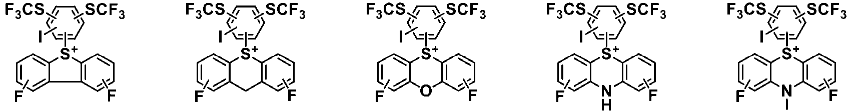

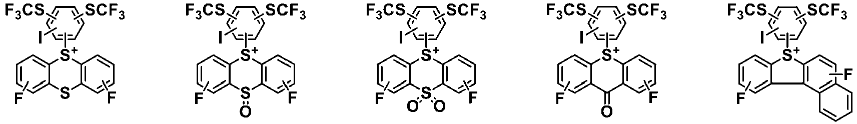

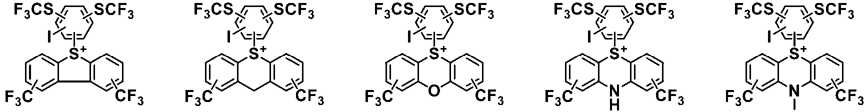

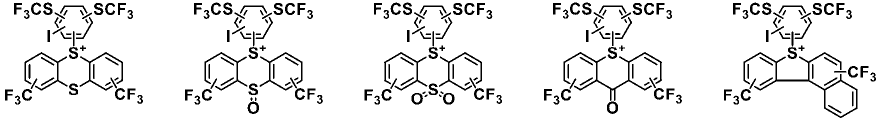

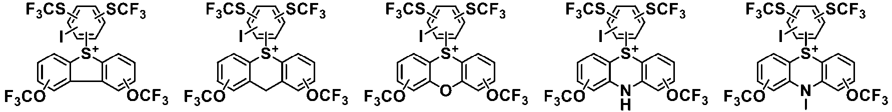

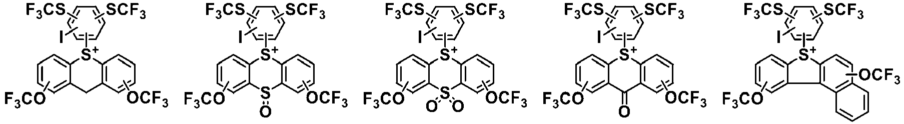

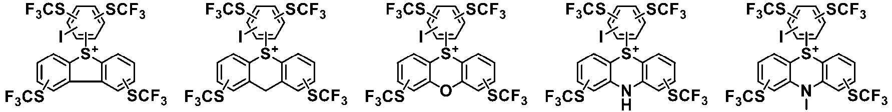

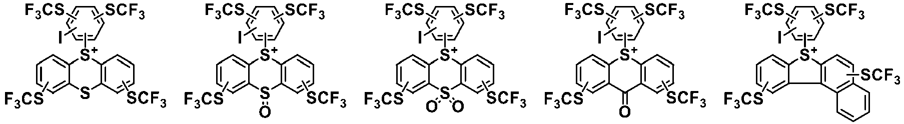

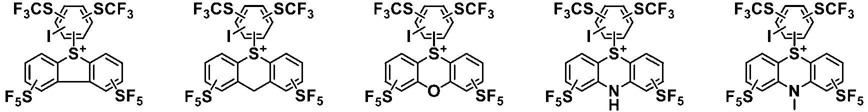

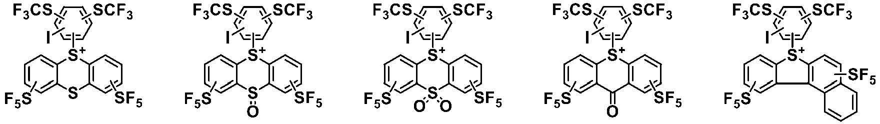

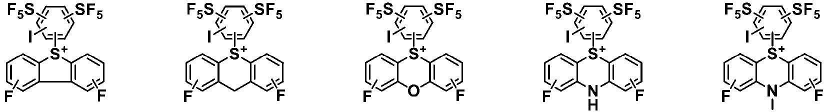

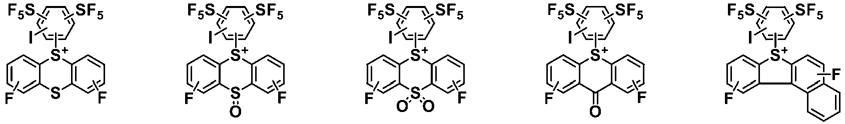

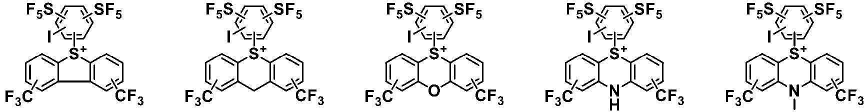

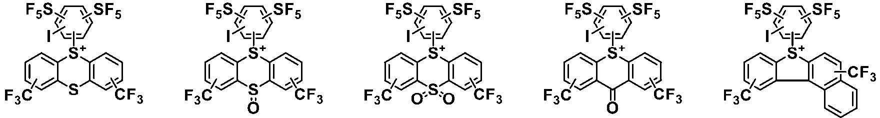

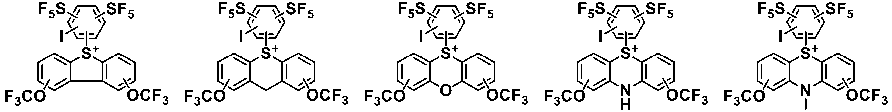

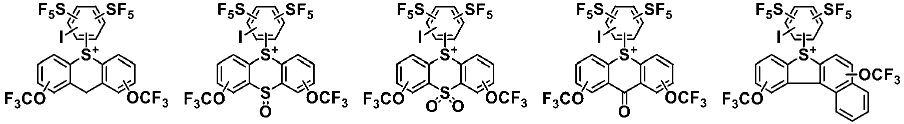

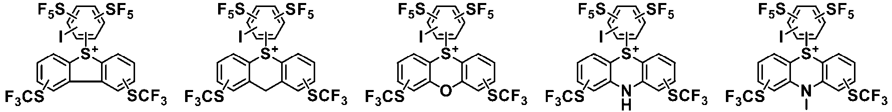

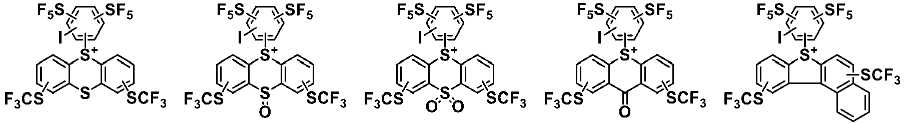

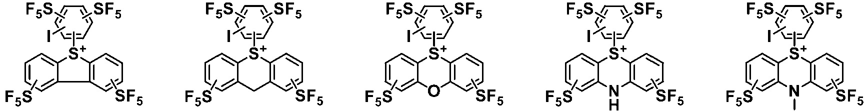

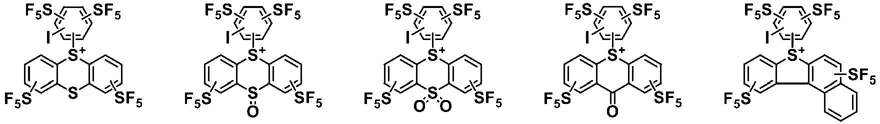

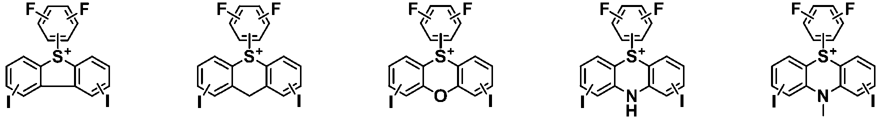

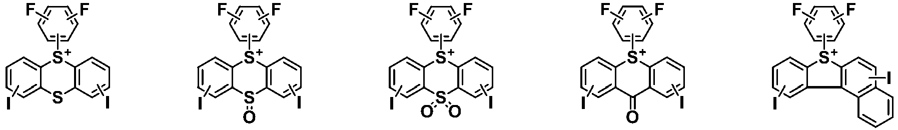

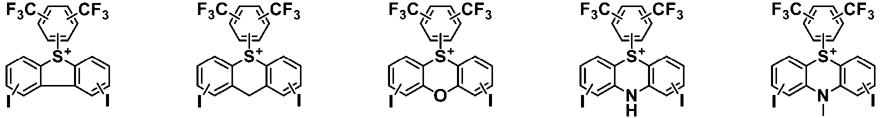

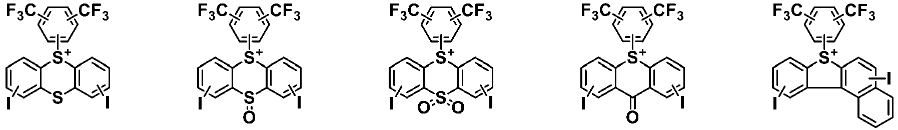

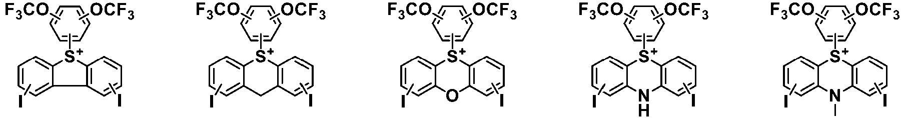

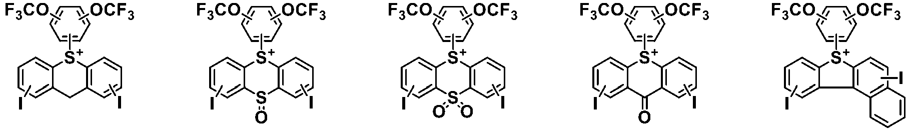

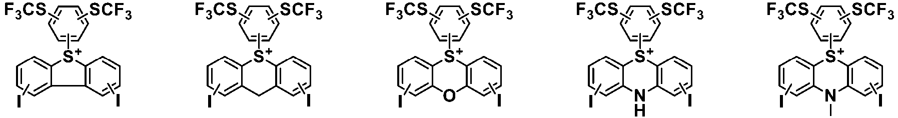

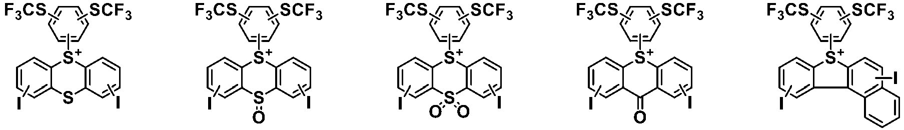

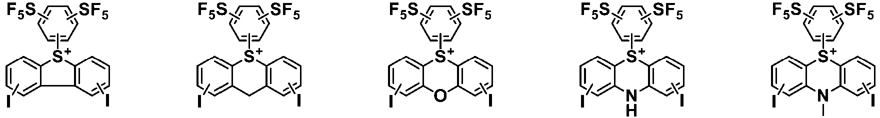

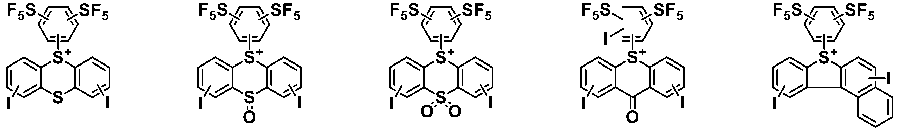

The sulfonium salt as the photoacid generator (A) contains an anion having the formula (A2).

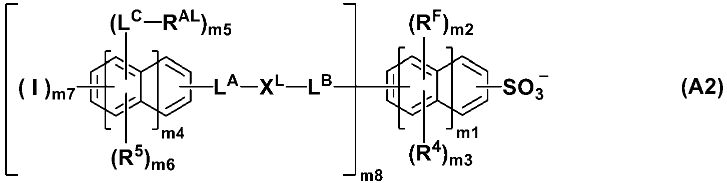

In formula (A2), m1 is 0 or 1. The relevant structure is a benzene ring when m1=0, and a naphthalene ring when m1=1. The benzene ring corresponding to m1=0 is preferred from the aspect of solvent solubility. The subscript m2 is 0, 1, 2, 3 or 4. The subscript m3 is 0, 1, 2, 3 or 4. It is preferred from the aspect of reactant availability that m3 be 0, 1, 2 or 3, and more preferred from the aspect of solvent solubility that m3 be 0, 1 or 2. The subscript m4 is 0 or 1. The relevant structure is a benzene ring when m4=0, and a naphthalene ring when m4=1. The benzene ring corresponding to m4=0 is preferred from the aspect of solvent solubility. The subscript m5 is 0, 1, 2, 3 or 4. It is preferred from the aspect of reactant availability that m5 be 0, 1 or 2. The subscript m6 is 0, 1, 2, 3 or 4.

It is preferred from the aspect of reactant availability that m6 be 0, 1, 2 or 3. The subscript m7 is 0, 1, 2, 3 or 4. It is preferred from the aspect of reactant availability that m7 be 0, 1, 2 or 3. The subscript m8 is 0, 1, 2, 3 or 4. It is preferred from the aspect of reactant availability that m8 be 0, 1, 2 or 3. The subscripts m1 to m8 are in the range: 1 ≤ m2+m3+m8 ≤ 5 when m1=0, 1 ≤ m2+m3+m8 ≤ 7 when m1=1, and 0 ≤ m5+m6+m7 ≤ 5 when m2=0, and 0 ≤ m5+m6+m7 ≤ 7 when m2=1.

In formula (A2), R⁴ is halogen exclusive of fluorine, nitro, cyano, hydroxy, carboxy, a C₁-C₂₀ hydrocarbyl group which may contain a heteroatom, C₁-C₂₀ hydrocarbyloxy group which may contain a heteroatom, C₁-C₂₀ hydrocarbylthio group which may contain a heteroatom, or C₂-C₂₀ hydrocarbyloxycarbonyl group which may contain a heteroatom. Suitable halogen atoms exclusive of fluorine include chlorine, bromine and iodine, with iodine being preferred. The hydrocarbyl group may be saturated or unsaturated and straight, branched or cyclic. Examples thereof include C₁-C₂₀ alkyl groups such as methyl, ethyl, n-propyl, isopropyl, n-butyl and tert-butyl; C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl and adamantyl; C₂-C₂₀ alkenyl groups such as vinyl, allyl, propenyl, butenyl and hexenyl; C₃-C₂₀ cyclic unsaturated hydrocarbyl groups such as cyclohexenyl; C₆-C₂₀ aryl groups such as phenyl and naphthyl; C₇-C₂₀ aralkyl groups such as benzyl, 1-phenyloethyl and 2-phenylethyl, and combinations thereof. In the hydrocarbyl group, some or all hydrogen may be substituted by a moiety containing a heteroatom such as oxygen, sulfur, nitrogen or halogen, and some -CH₂- may be replaced by a moiety containing a heteroatom such as oxygen, sulfur or nitrogen, so that the group may contain a hydroxy, cyano, fluorine, chlorine, bromine, iodine, carbonyl, ether bond, ester bond, sulfonate ester bond, carbonate bond, lactone ring, sultone ring, carboxylic anhydride (-C(=O)-O-C(=O)-) or haloalkyl moiety. When m3 is 2, 3 or 4, a plurality of R⁴ may be identical or different.

When m3 is 2, 3 or 4, a plurality of R⁴ may bond together to form a ring with the carbon atom to which they are attached. The ring is preferably 5- to 8-membered.

In formula (A2), R⁵ is halogen exclusive of iodine, nitro, cyano, hydroxy, carboxy, pentafluorosulfanyl, a C₁-C₂₀ hydrocarbyl group which may contain a heteroatom, C₁-C₂₀ hydrocarbyloxy group which may contain a heteroatom, C₁-C₂₀ hydrocarbylthio group which may contain a heteroatom, or C₂-C₂₀ hydrocarbyloxycarbonyl group which may contain a heteroatom. Suitable halogen atoms exclusive of iodine include fluorine, chlorine, and bromine, with fluorine being preferred. The hydrocarbyl group may be saturated or unsaturated and straight, branched or cyclic. Examples thereof are as exemplified above for R⁴, but not limited thereto. When m6 is 2, 3 or 4, a plurality of R⁵ may be identical or different.

When m6 is 2, 3 or 4, a plurality of R⁵ may bond together to form a ring with the carbon atom to which they are attached. The ring is preferably 5- to 8-membered.

In formula (A2), R^{F} is fluorine, a C₁-C₆ fluorinated saturated hydrocarbyl group, C₁-C₆ fluorinated saturated hydrocarbyloxy group, C₁-C₆ fluorinated saturated hydrocarbylthio group, or pentafluorosulfanyl. R^{F} is preferably fluorine, trifluoromethyl, difluoromethyl, trifluoromethoxy, difluoromethoxy, trifluoromethylthio, difluoromethylthio or pentafluorosulfanyl, more preferably fluorine, trifluoromethyl, trifluoromethoxy, trifluoromethylthio or pentafluorosulfanyl. Since fluorine or fluorine-containing substituent exerts an electron-withdrawing effect, the strength of generated acid is so increased that when a polymer having an acid labile group such as tertiary ester or tertiary ether group is used, deprotection reaction of the acid labile group may smoothly take place. When m2 is 2, 3 or 4, a plurality of R^{F} may be identical or different.

In formula (A2), R^{AL} is an acid labile group. The preferred acid labile group has the formula (AL-1) or (AL-2).

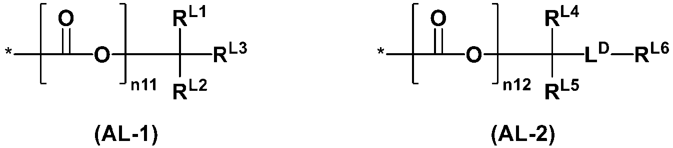

Herein * designates a point of attachment to L^{C}.

In formulae (AL-1) and (AL-2), n11 and n12 are each independently 0 or 1.

In formula (AL-1), R^{L1} and R^{L2} are each independently a C₁-C₁₂ hydrocarbyl group. R^{L3} is hydrogen or a C₁-C₁₂ hydrocarbyl group. In the hydrocarbyl group represented by R^{L1}, R^{L2} and R^{L3}, some -CH₂- may be replaced by -O- or -S-. When the hydrocarbyl group contains an aromatic ring, some or all of the hydrogen atoms on the aromatic ring may be substituted by halogen, cyano, nitro, optionally halogenated C₁-C₄ alkyl moiety or optionally halogenated C₁-C₄ alkoxy moiety. The C₁-C₁₂ hydrocarbyl group represented by R^{L1}, R^{L2} and R^{L3} may be saturated or unsaturated and straight, branched or cyclic. Examples thereof are as exemplified for the hydrocarbyl group represented by R¹, R² and R³, but of 1 to 12 carbon atoms. Also, R^{L1} and R^{L2} may bond together to form a ring with the carbon atom to which they are attached. Some -CH₂- in the ring may be replaced by -O- or -S-. When R^{L3} is hydrogen, R^{L1} and R^{L2} bond together to form a multiple bond-containing alicyclic structure with the carbon atom to which they are attached. Some hydrogen on the alicyclic structure may be substituted by halogen.

In formula (AL-2), R^{L4} and R^{L5} are each independently hydrogen or a C₁-C₁₀ hydrocarbyl group. The C₁-C₁₀ hydrocarbyl group represented by R^{L4} and R^{L5} may be saturated or unsaturated and straight, branched or cyclic. Examples thereof are as exemplified above for the hydrocarbyl groups R¹, R² and R³, but of 1 to 10 carbon atoms. R^{L6} is a C₁-C₂₀ hydrocarbyl group in which some -CH₂- may be replaced by -O- or -S-. Also, R^{L5} and R^{L6} may bond together to form a C₃-C₂₀ heterocyclic group with the carbon atom and L^{D} to which they are attached. Some -CH₂- in the heterocyclic group may be replaced by -O- or -S-. The C₁-C₂₀ hydrocarbyl group represented by R^{L6} may be saturated or unsaturated and straight, branched or cyclic. Examples thereof are as exemplified above for the hydrocarbyl groups R¹, R² and R³.

In formula (AL-2), L^{A} is -O- or -S-.

Examples of the acid labile group having formula (AL-1) are shown below, but not limited thereto. Herein, * designates a point of attachment to L^{C}.

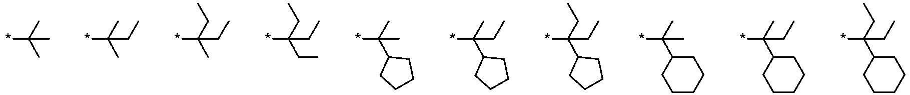

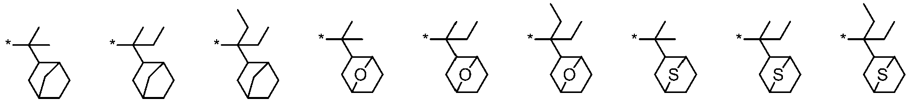

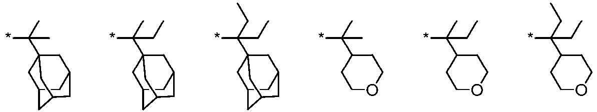

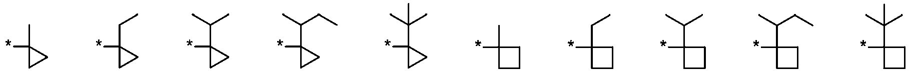

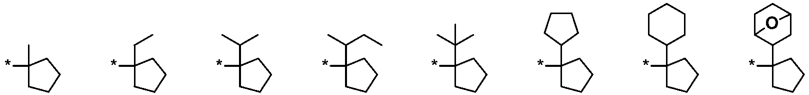

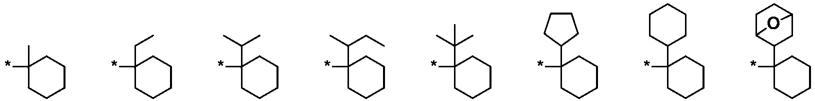

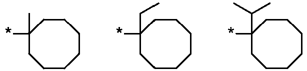

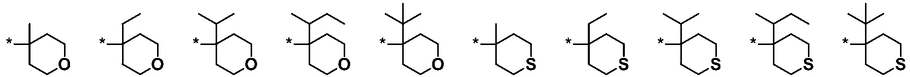

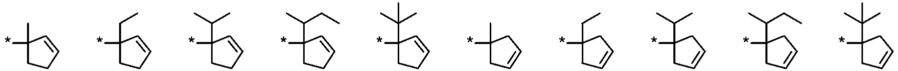

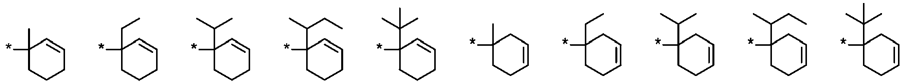

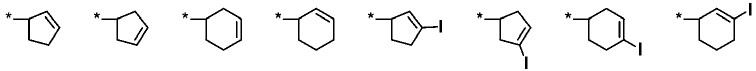

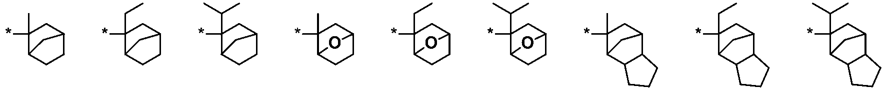

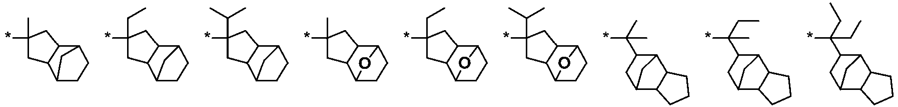

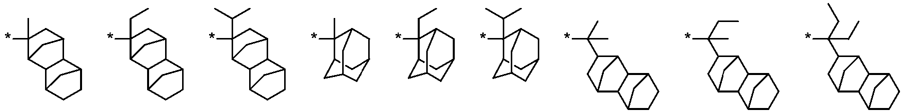

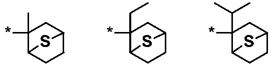

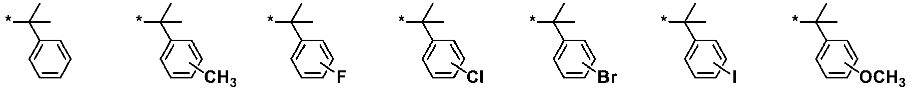

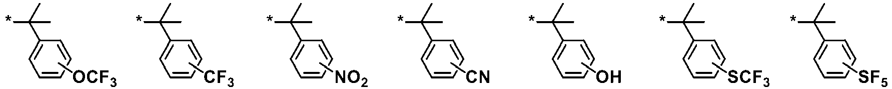

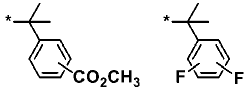

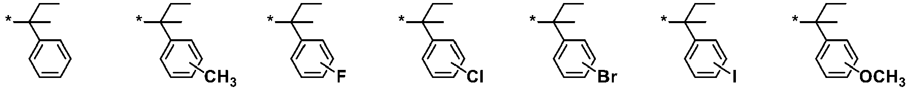

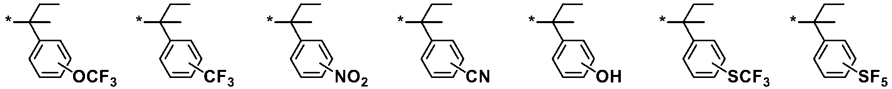

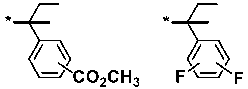

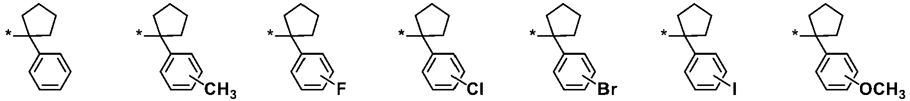

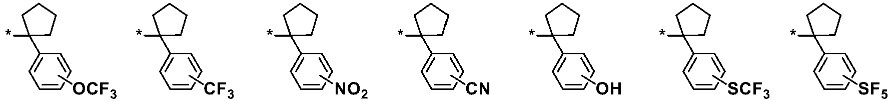

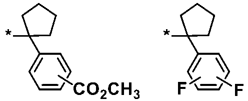

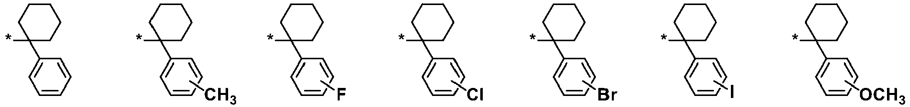

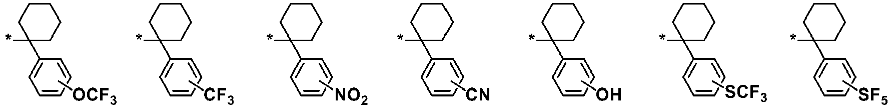

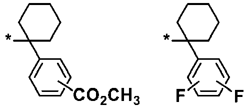

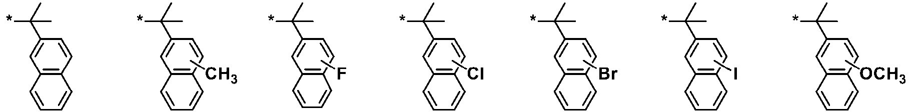

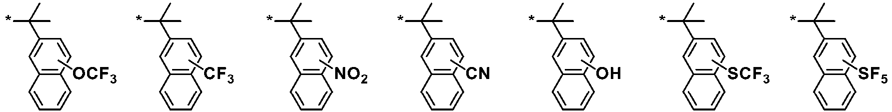

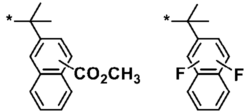

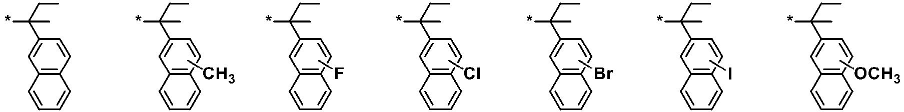

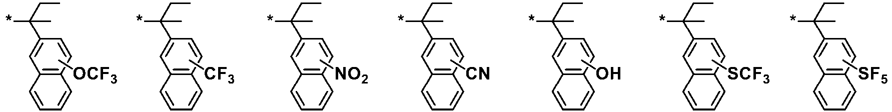

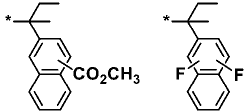

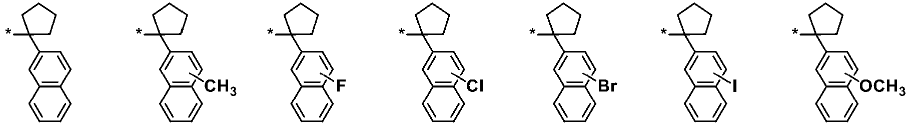

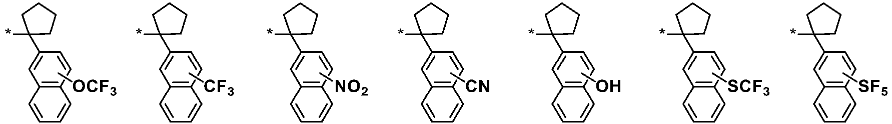

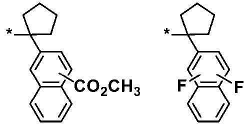

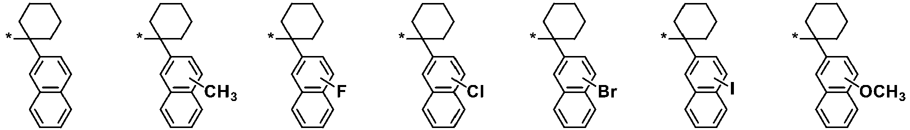

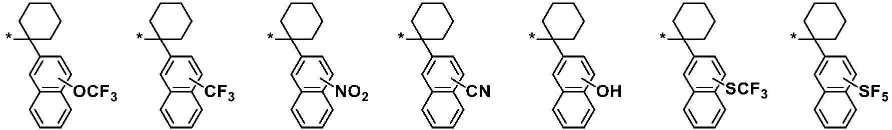

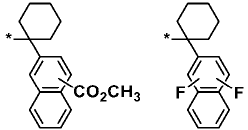

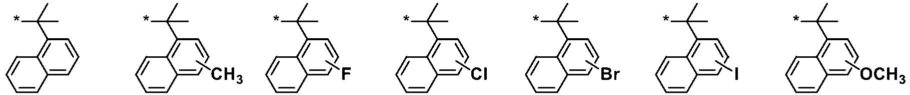

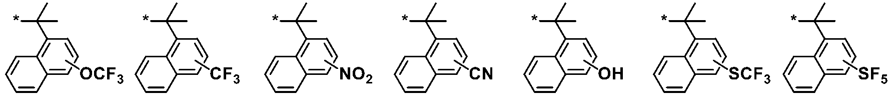

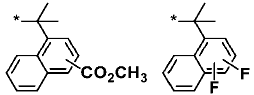

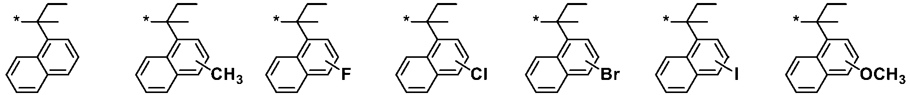

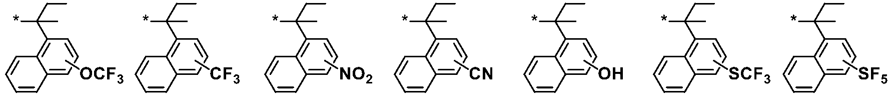

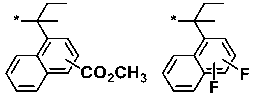

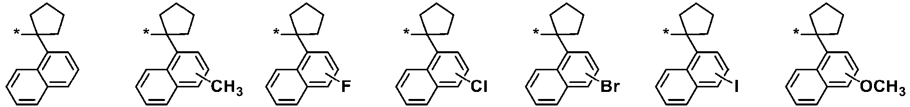

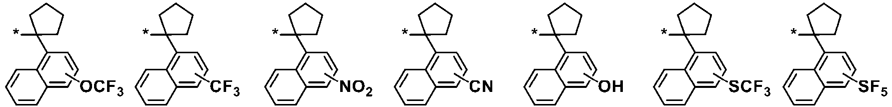

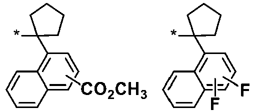

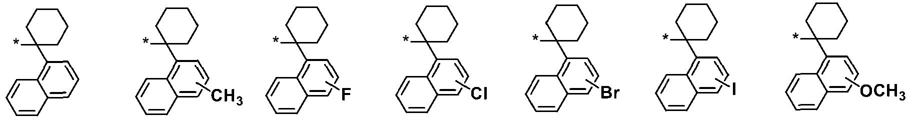

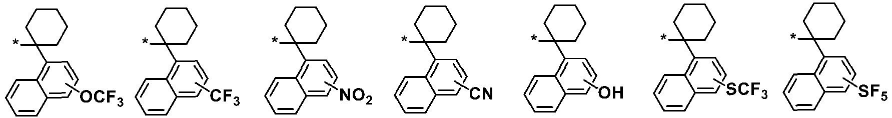

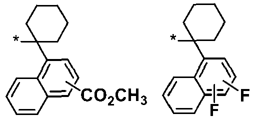

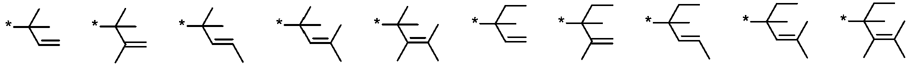

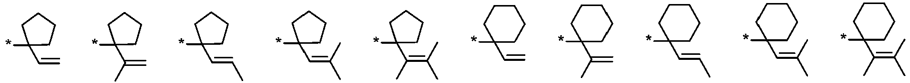

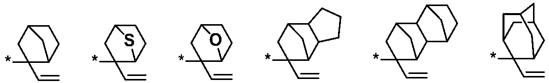

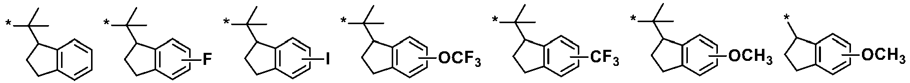

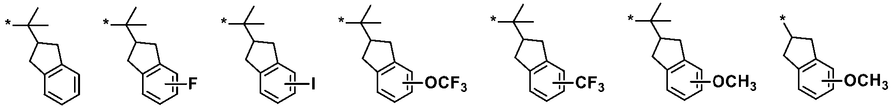

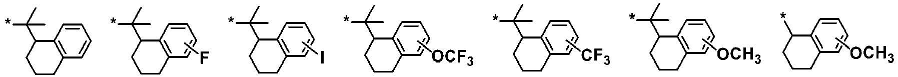

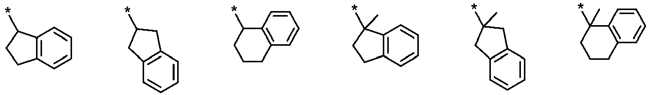

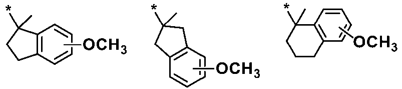

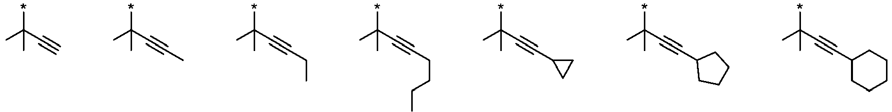

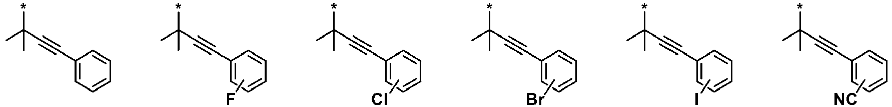

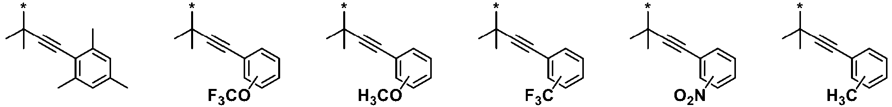

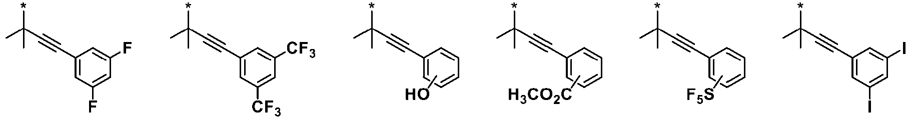

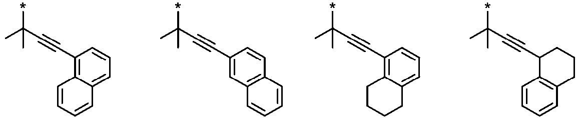

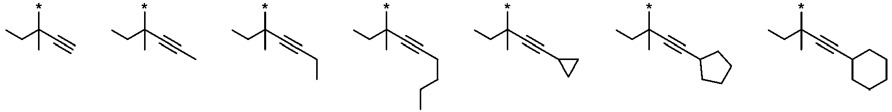

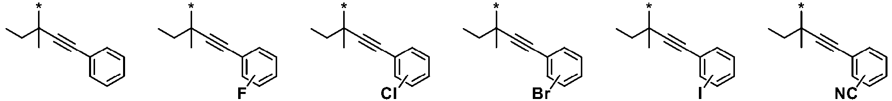

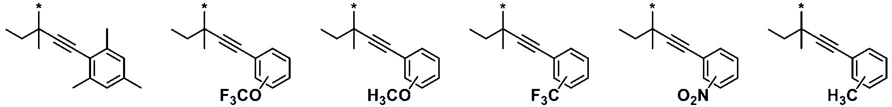

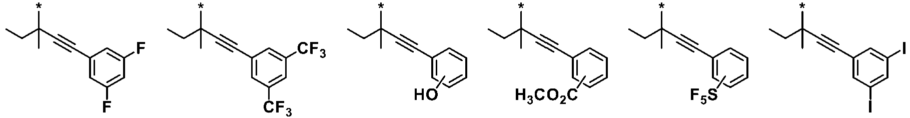

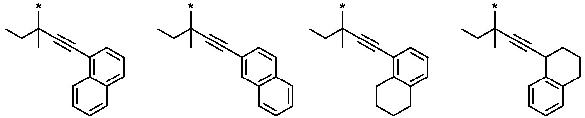

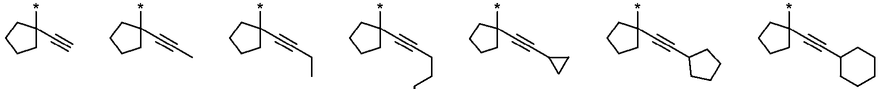

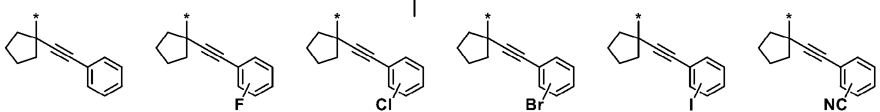

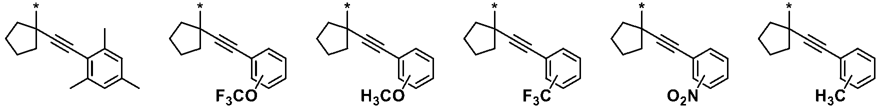

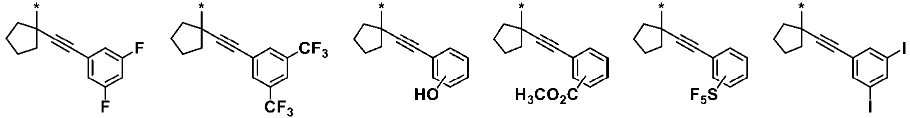

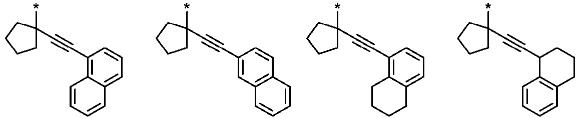

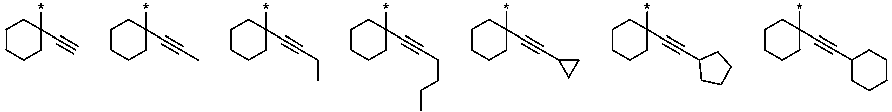

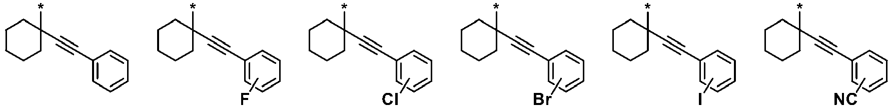

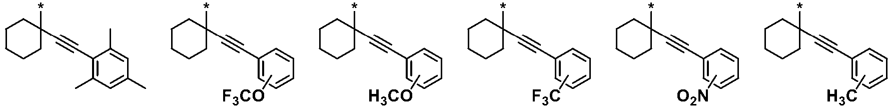

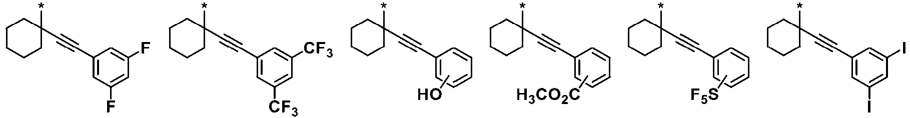

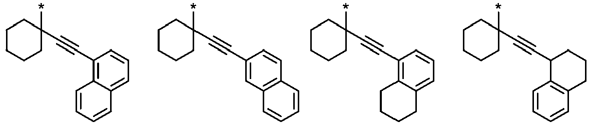

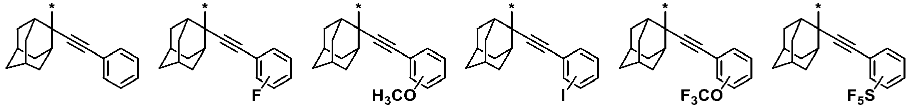

Examples of the acid labile group having formula (AL-2) are shown below, but not limited thereto. Herein, * designates a point of attachment to L^{C}.

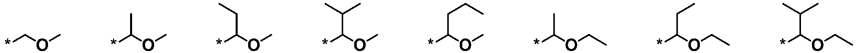

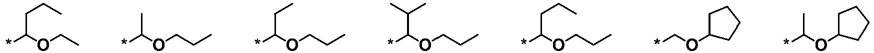

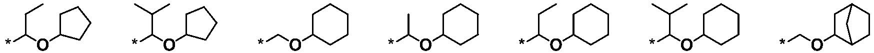

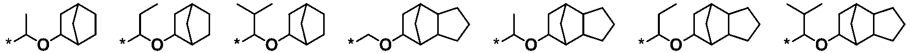

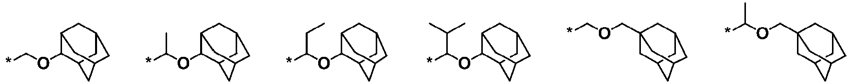

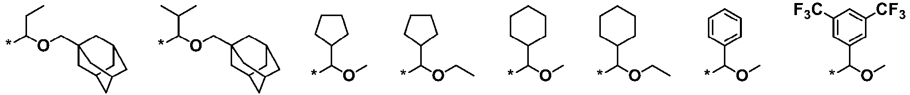

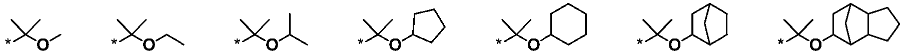

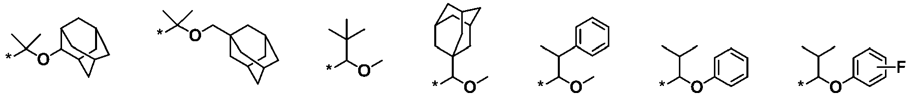

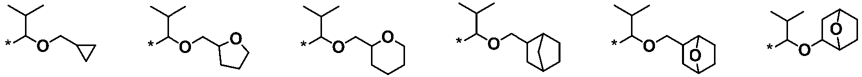

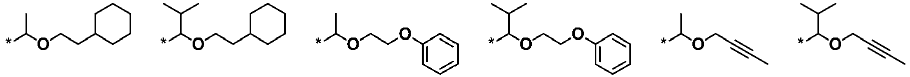

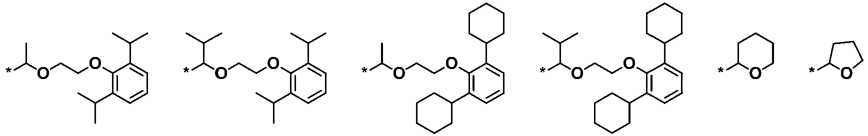

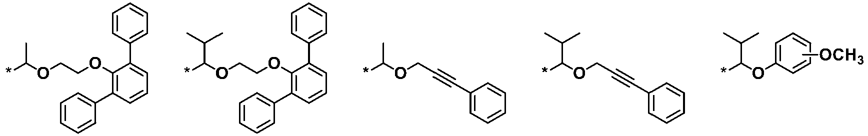

In formula (A2), L^{A} and L^{B} are each independently a single bond, ether bond, ester bond, sulfonate ester bond, amide bond, sulfonamide bond, carbonate bond or carbamate bond. L^{A} is preferably a single bond, ether bond, ester bond or sulfonate ester bond, more preferably an ester bond or sulfonate ester bond. L^{B} is preferably a single bond, ether bond, ester bond or sulfonate ester bond, more preferably a single bond, ester bond or sulfonate ester bond.

In formula (A2), L^{C} is an ether bond, ester bond or carbonate bond. Preferably L^{C} is an ether bond or ester bond.

In formula (A2), X^{L1} is a single bond or a C₁-C₄₀ hydrocarbylene group which may contain a heteroatom. The hydrocarbylene group may be straight, branched or cyclic and examples thereof include alkanediyl, cyclic saturated hydrocarbylene and arylene groups. Exemplary heteroatoms include oxygen, nitrogen and sulfur.

Examples of the C₁-C₄₀ hydrocarbylene group which may contain a heteroatom, represented by X^{L1}, are shown below, but not limited thereto. Herein, * designates a point of attachment to L^{A} or L^{B}.

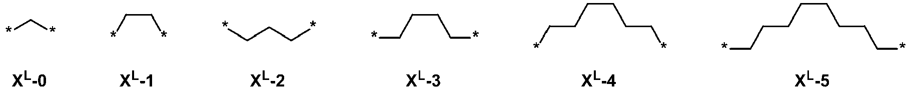

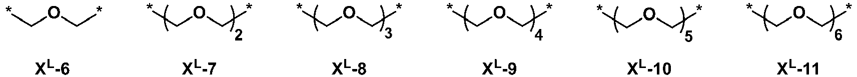

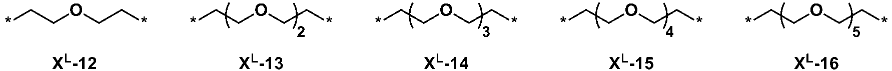

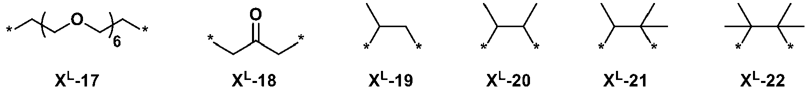

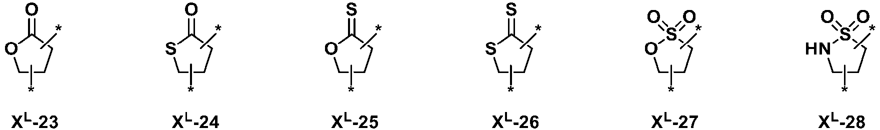

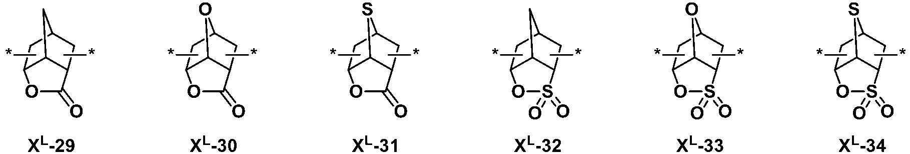

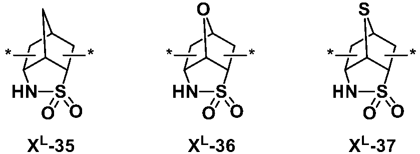

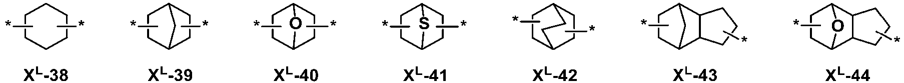

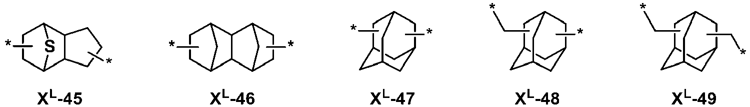

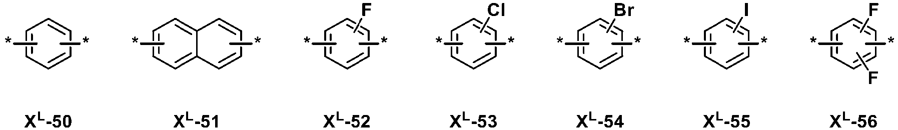

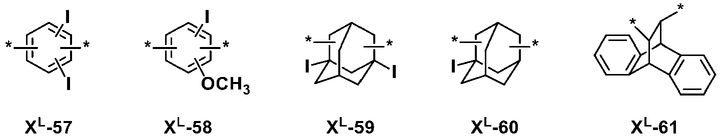

Of these, X^{L}-0 to X^{L}-22, X^{L}-29 to X^{L}-34, and X^{L}-47 to X^{L}-61 are preferred.

Of the anions having formula (A2), those having the formula (A2-1) are preferred.

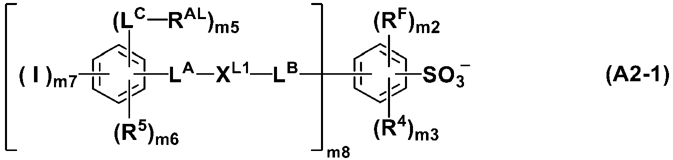

Herein m2, m3, m5 to m8, R⁴, R⁵, R^{F}, L^{A}, L^{B}, L^{C}, and X^{L1} are as defined above. Of the anions having formula (A2-1), those having the formula (A2-2) are preferred.

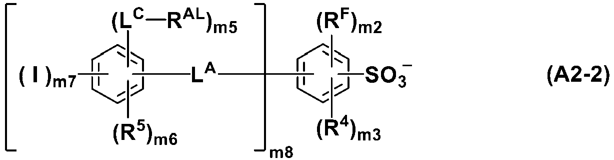

Herein m2, m3, m5 to m8, R⁴, R⁵, R^{F}, R^{AL}, L^{A}, and L^{C} are as defined above.

Non-limiting examples of the anion having formula (A2) include those described in JP 6248882, paragraphs [0027]-[0029], JP 6648726, paragraphs [0029]-[0034], JP 7067271, paragraphs [0028]-[0029], JP-A 2024-104830, paragraphs [0037]-[0060], JP-A 2025-000201, paragraphs [0040]-[0071], JP-A 2023-177038, paragraphs [0039]-[0066], JP 7032549, paragraphs [0220]-[0225], and JP-A 2024-077330, paragraphs [0229]-[0231].

Specific examples of the anion having formula (A2) are shown below, but not limited thereto.

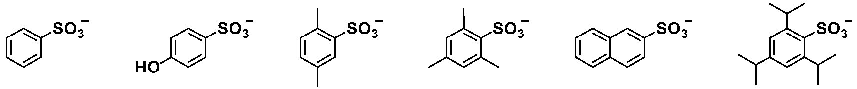

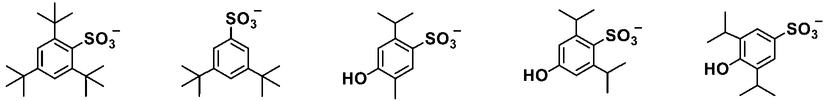

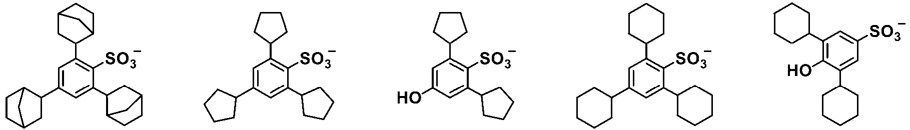

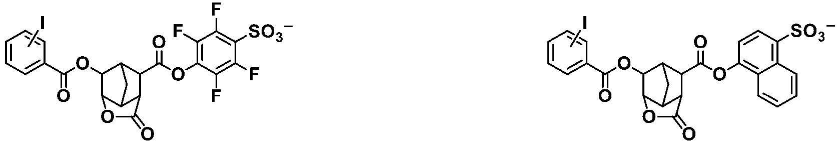

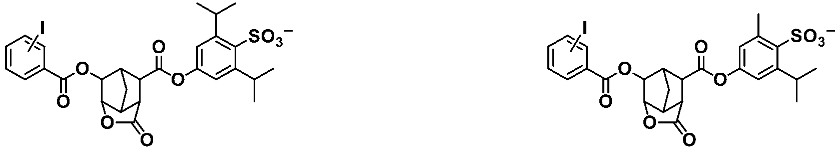

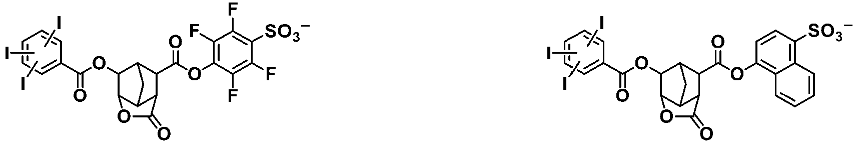

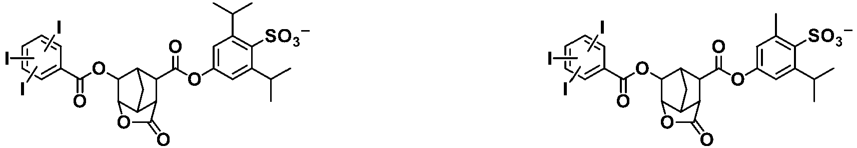

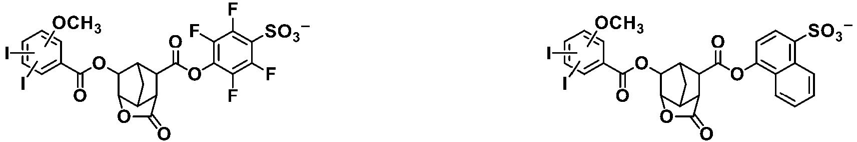

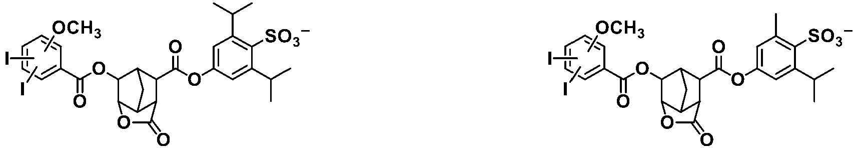

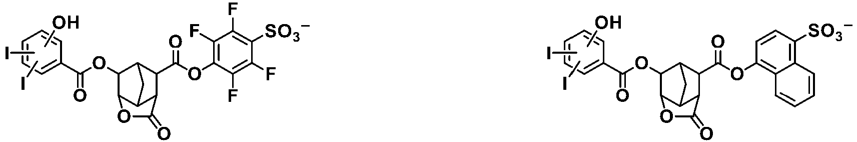

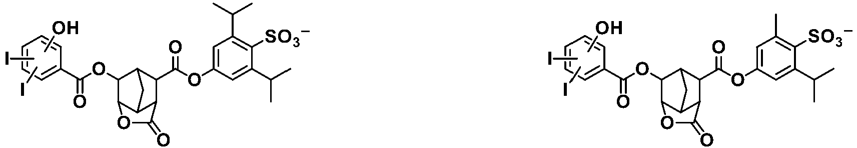

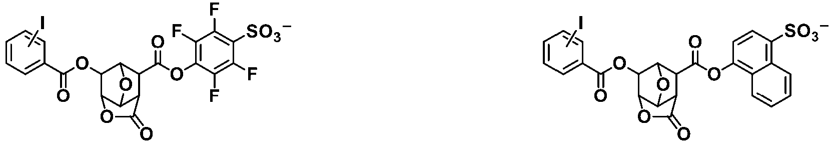

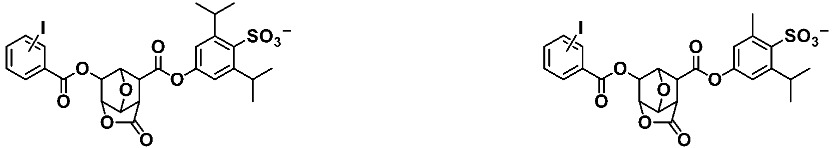

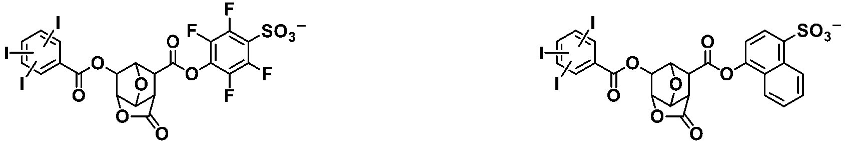

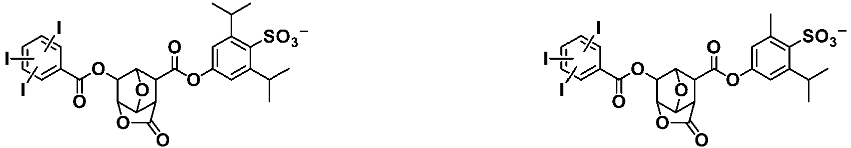

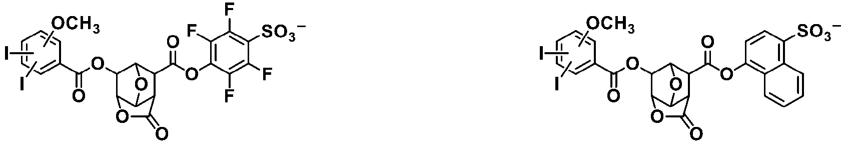

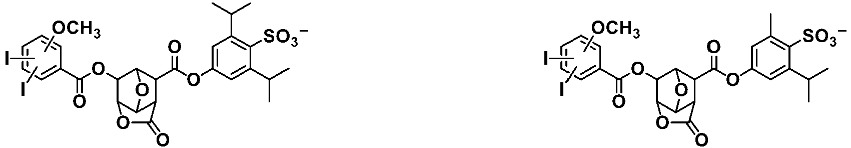

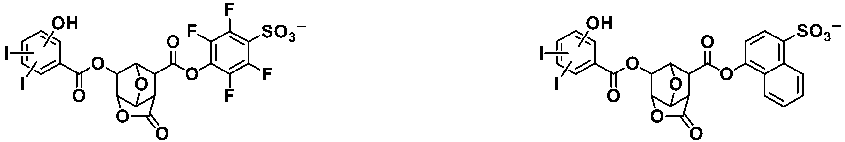

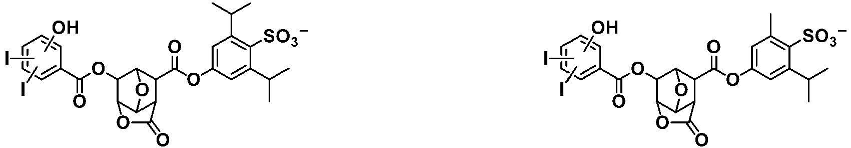

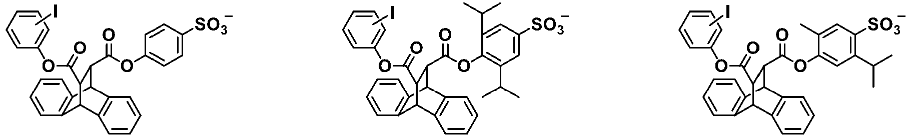

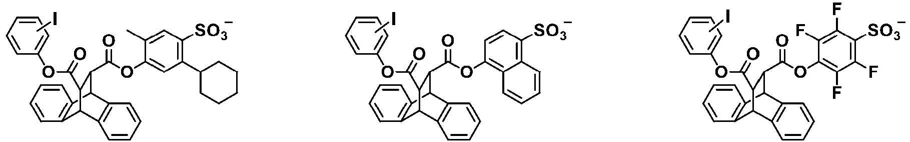

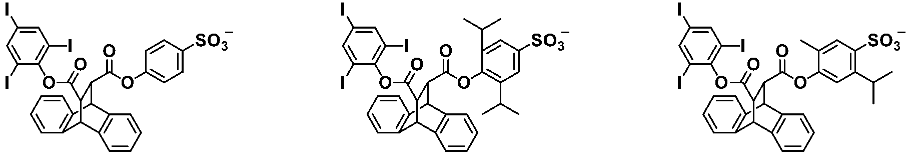

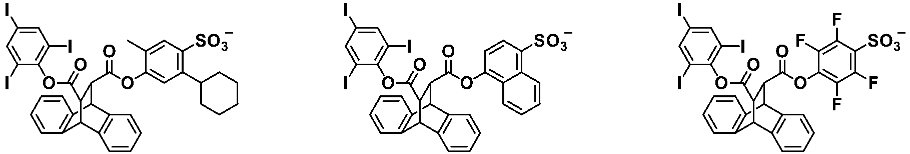

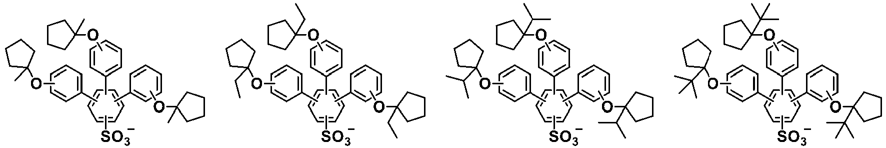

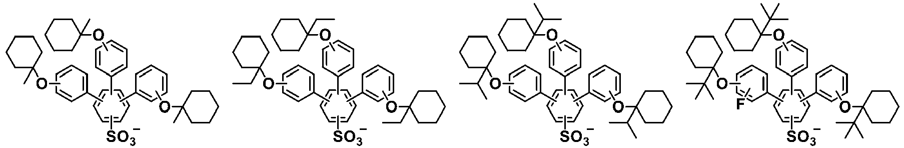

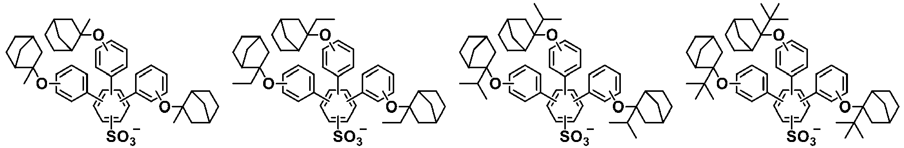

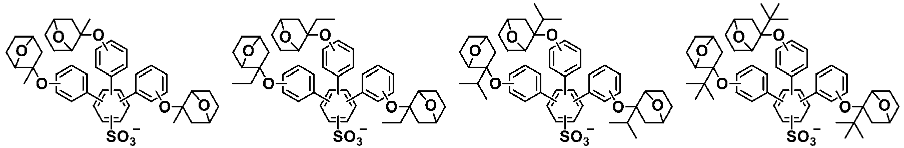

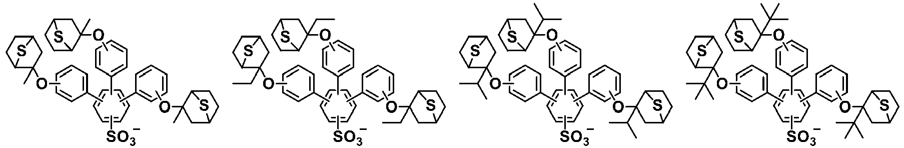

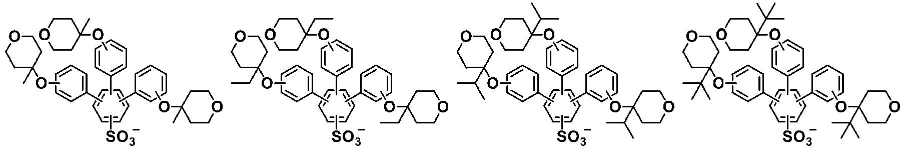

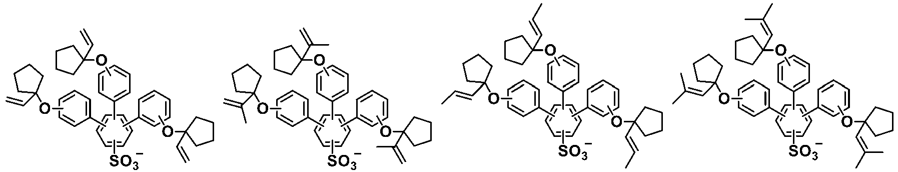

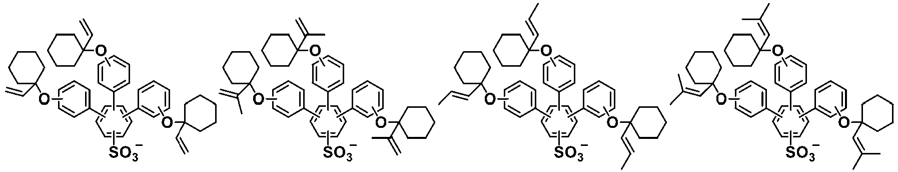

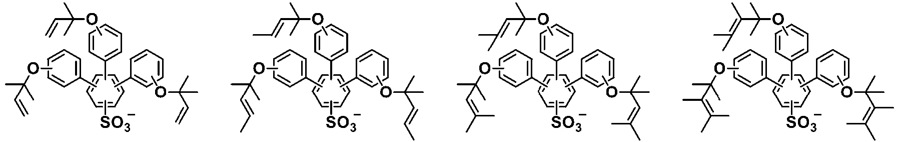

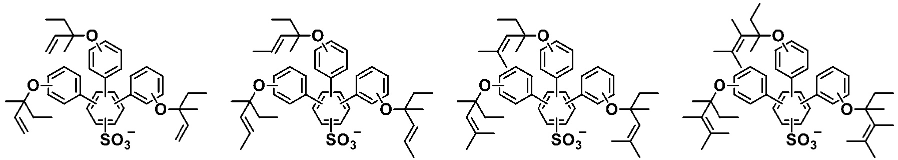

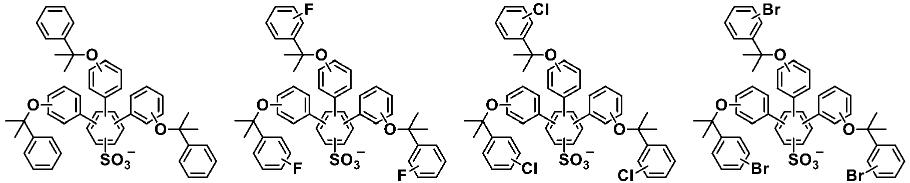

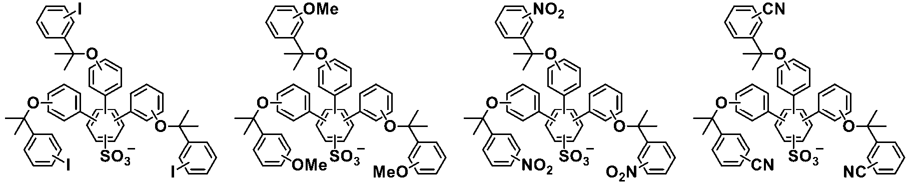

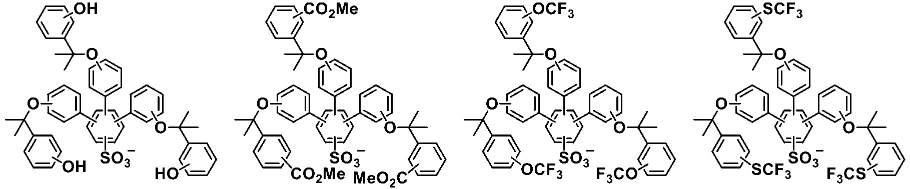

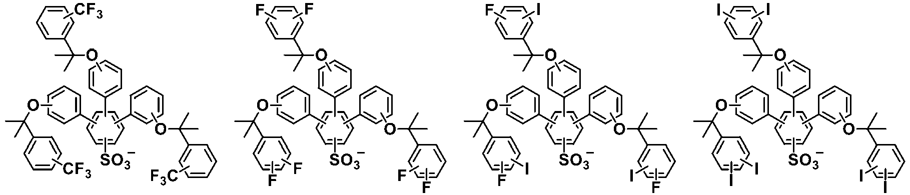

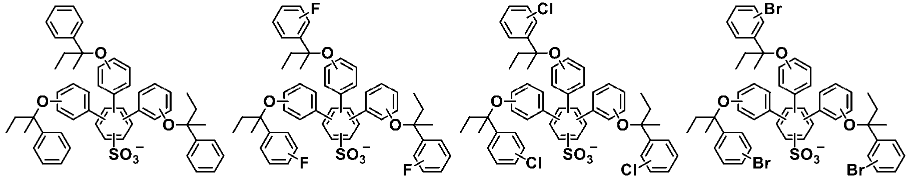

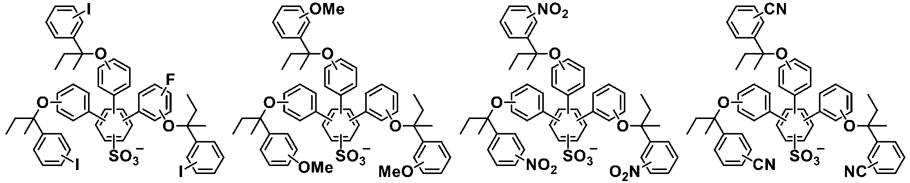

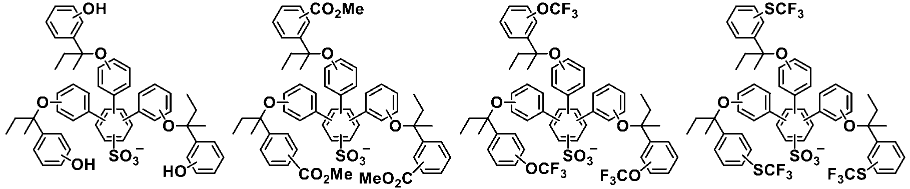

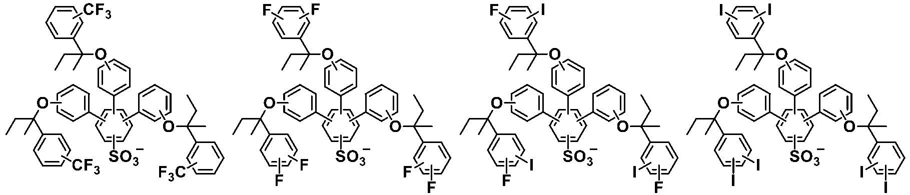

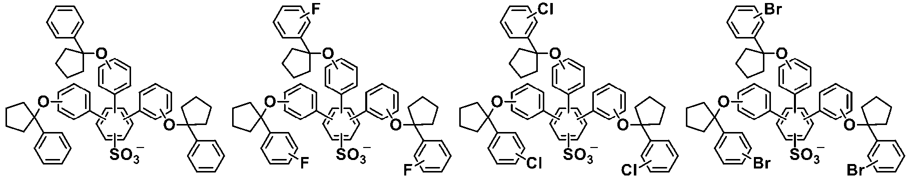

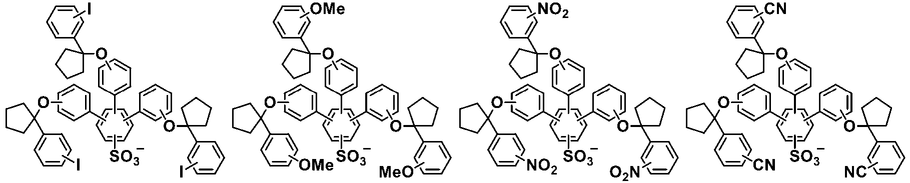

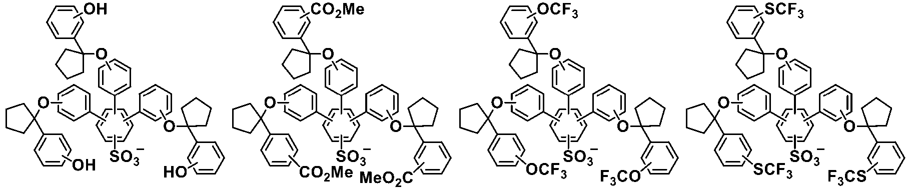

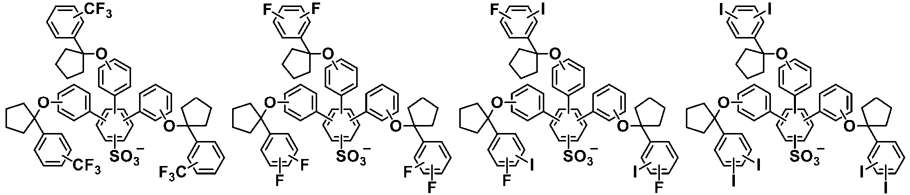

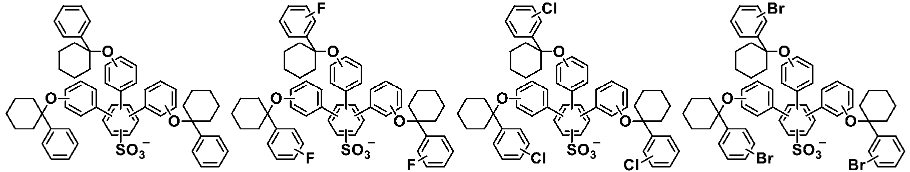

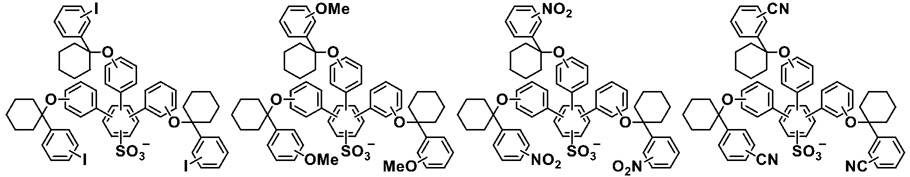

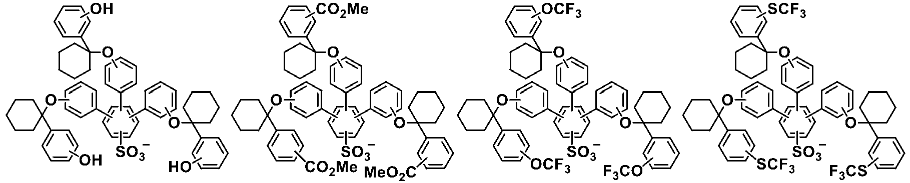

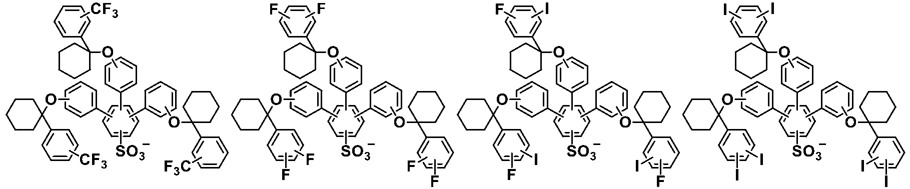

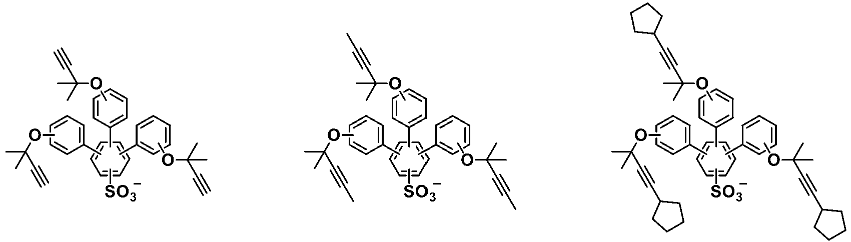

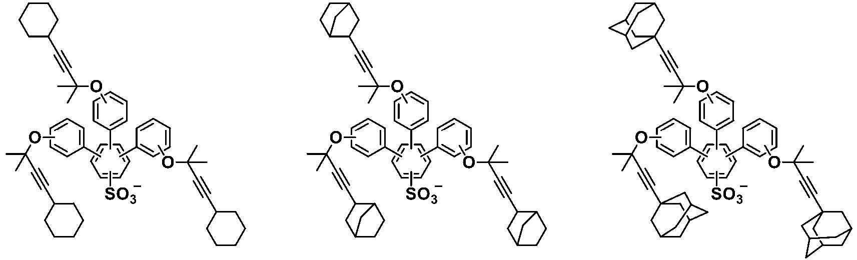

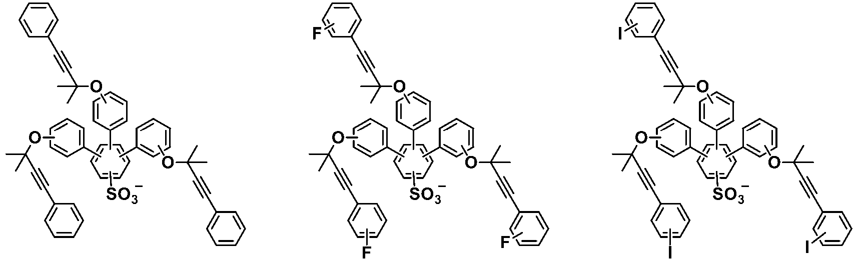

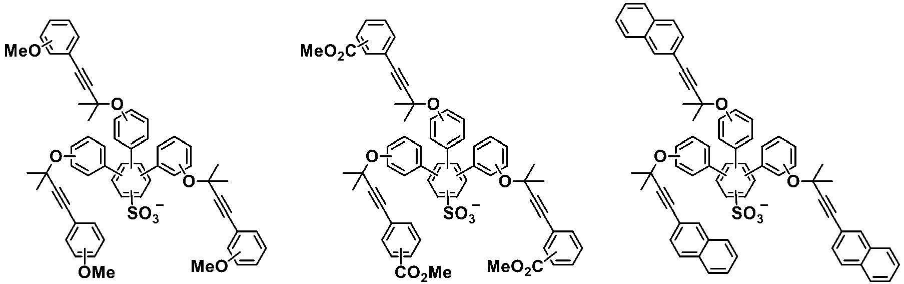

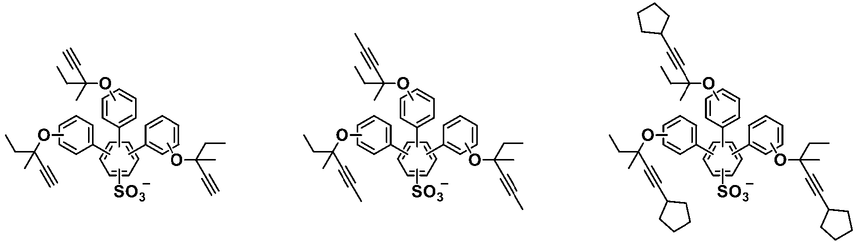

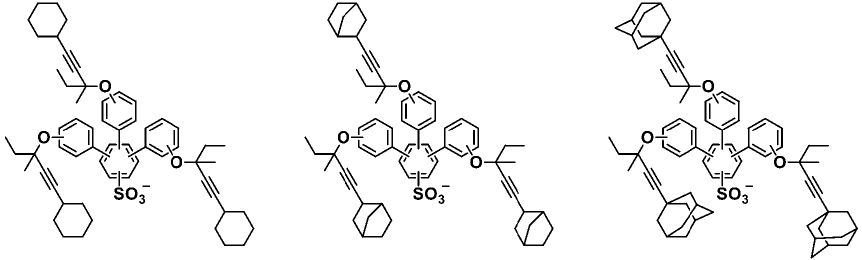

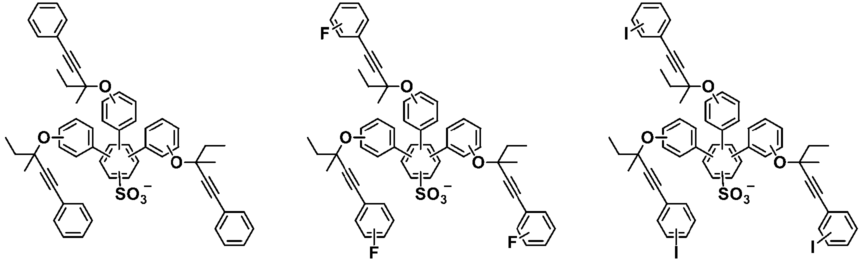

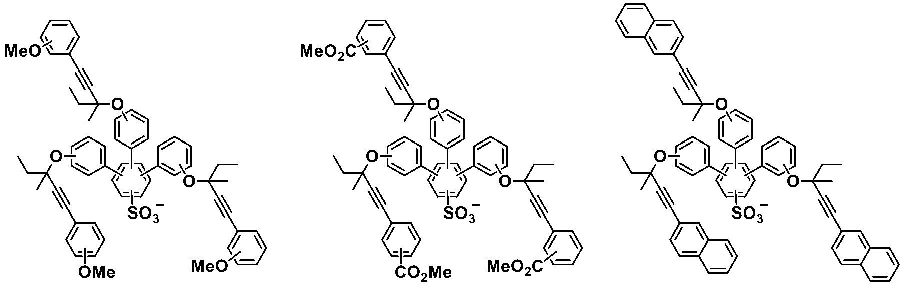

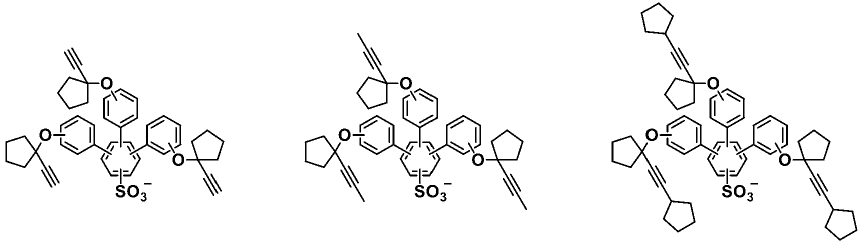

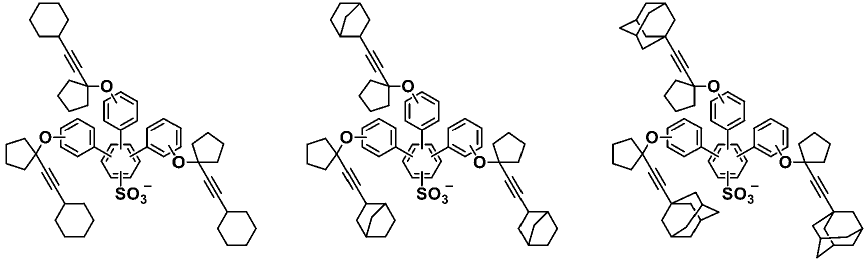

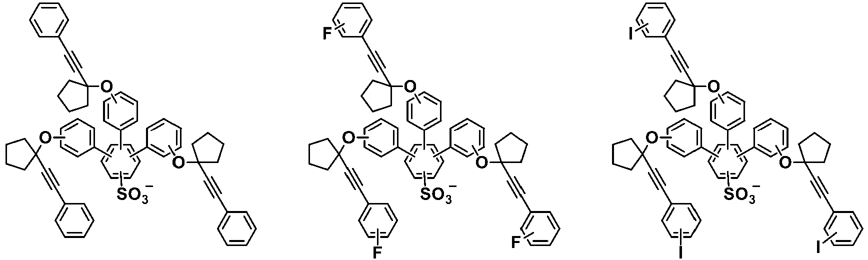

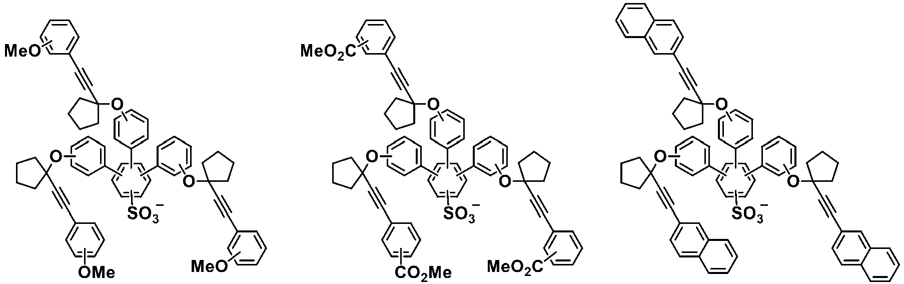

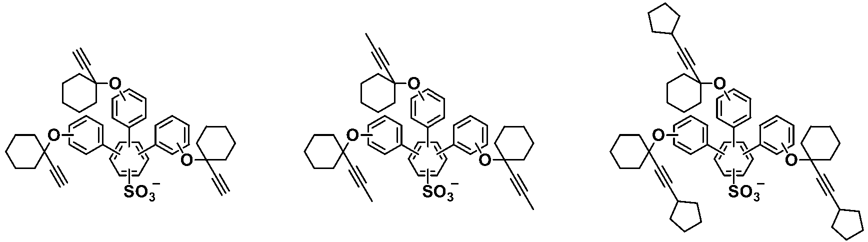

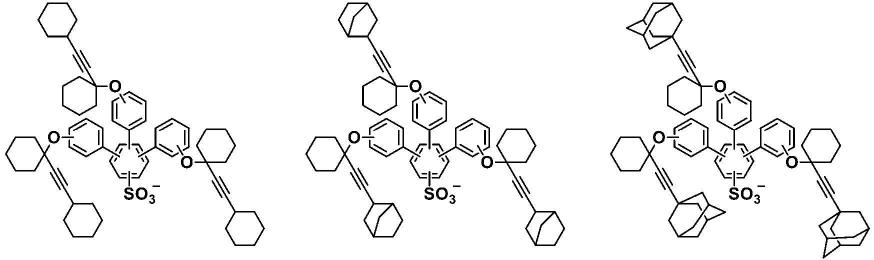

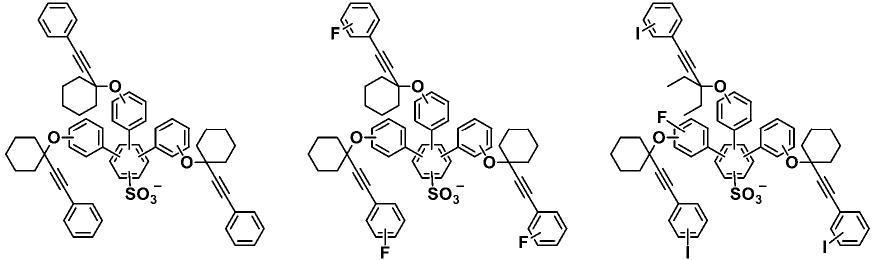

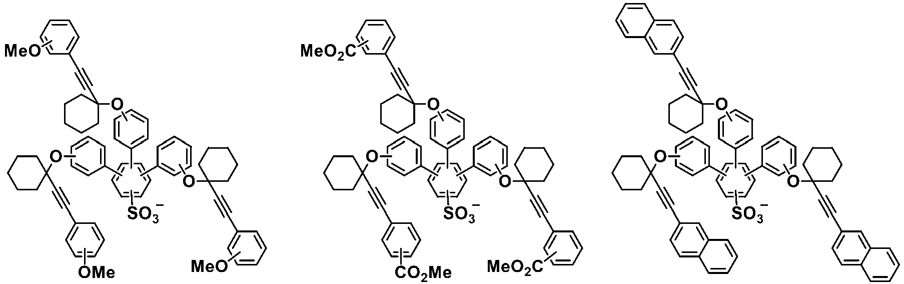

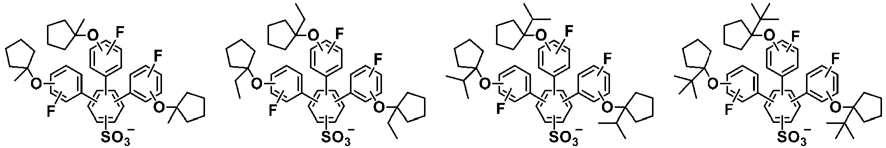

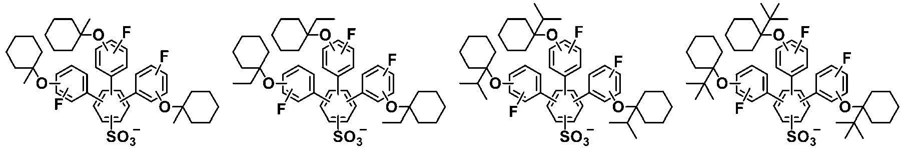

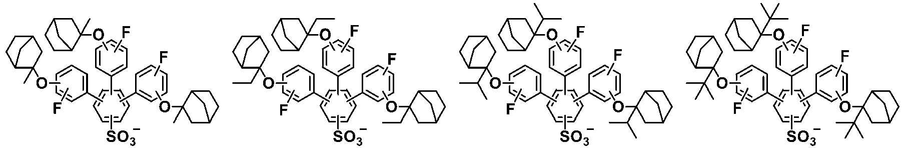

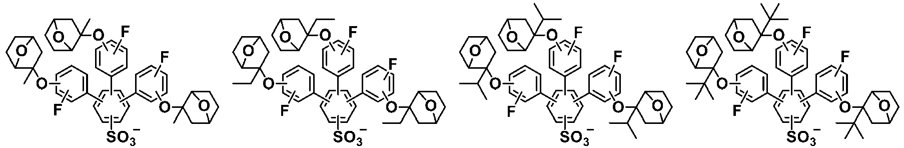

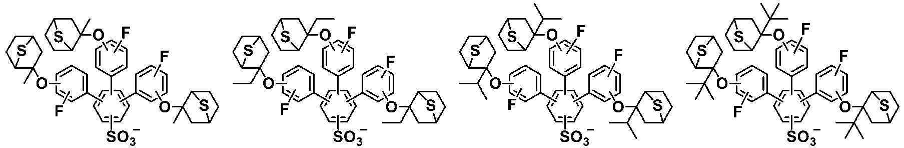

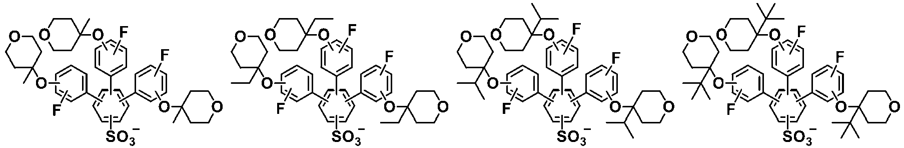

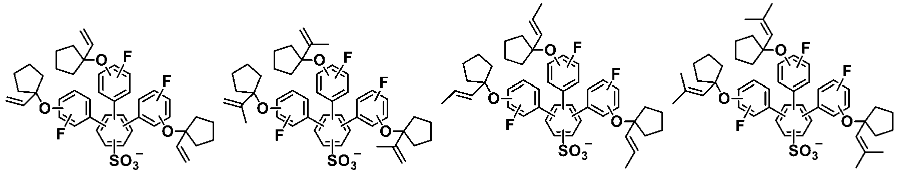

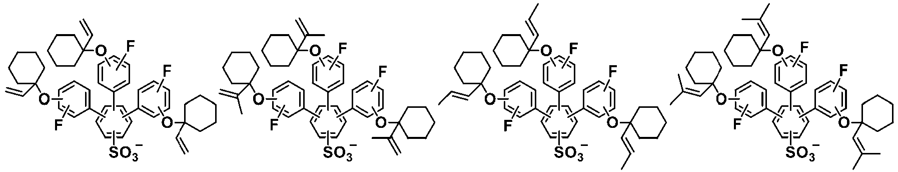

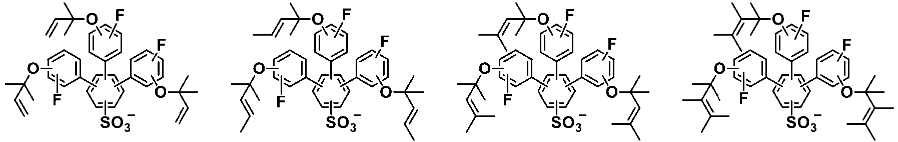

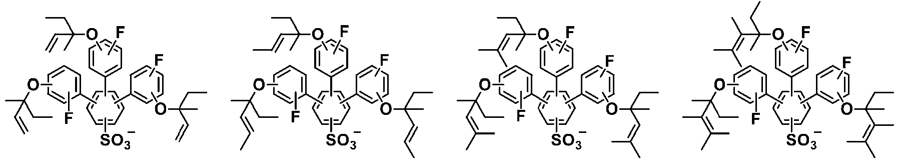

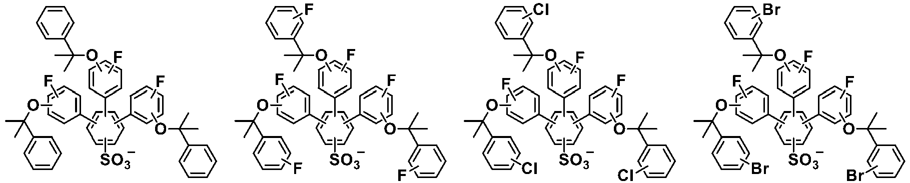

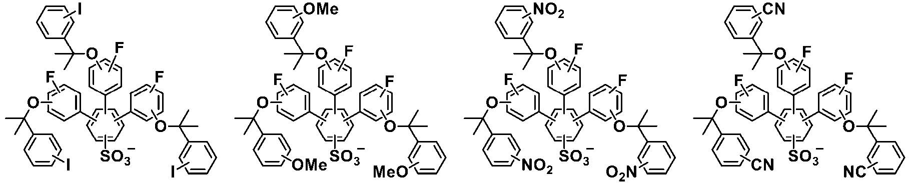

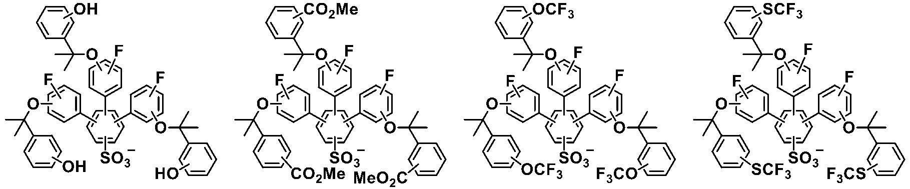

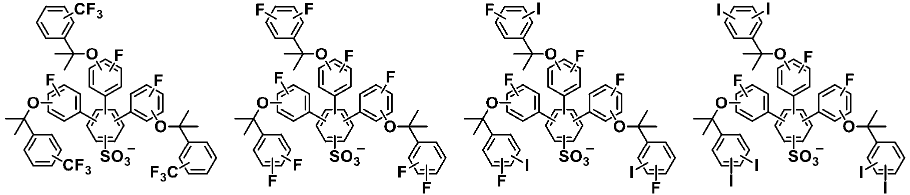

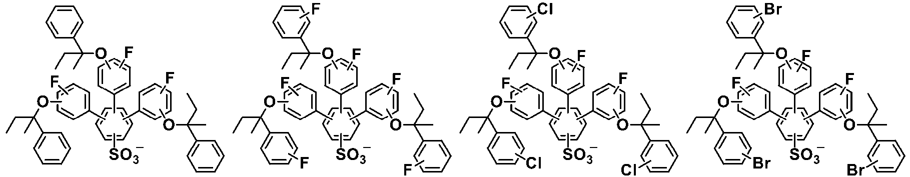

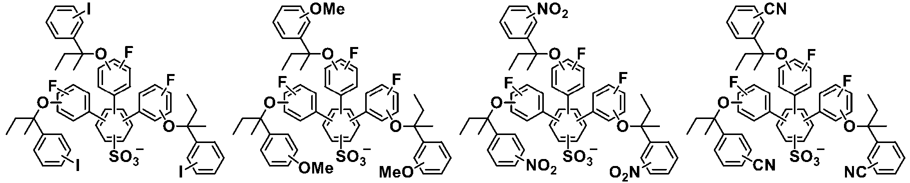

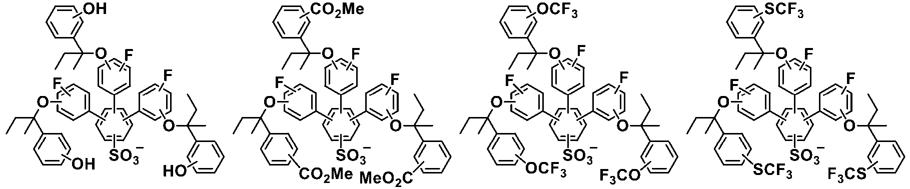

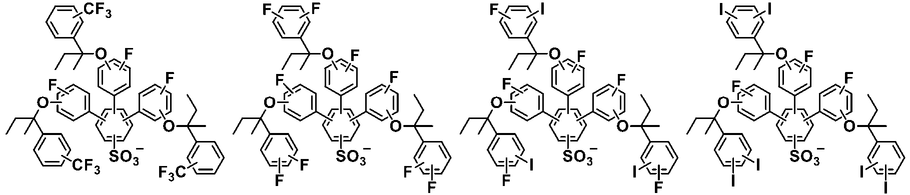

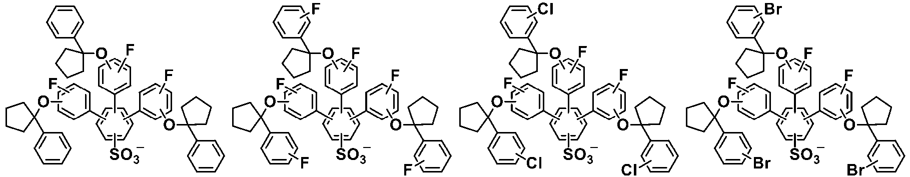

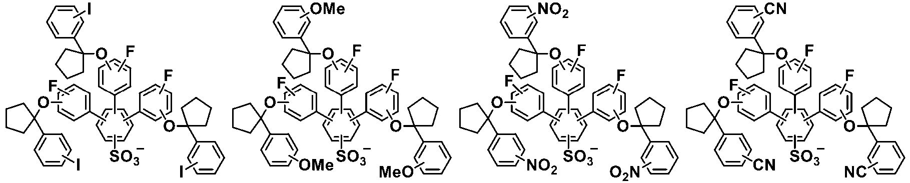

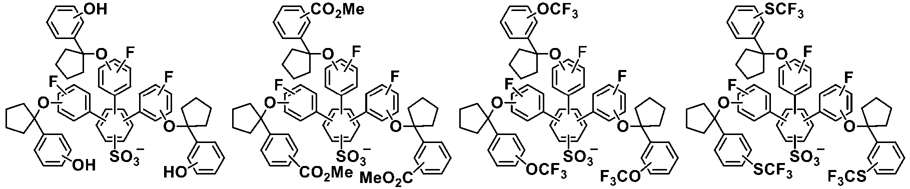

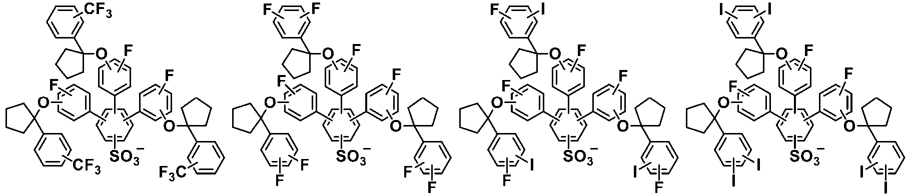

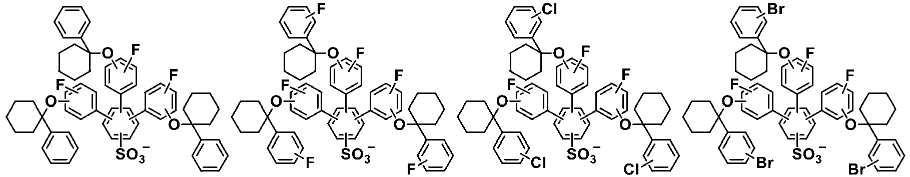

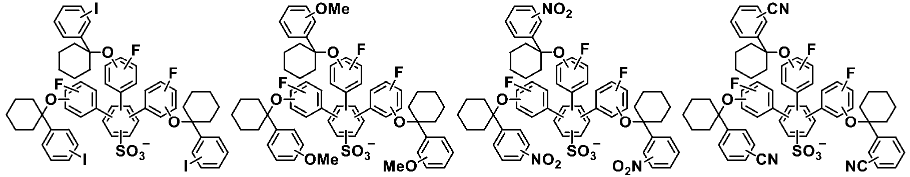

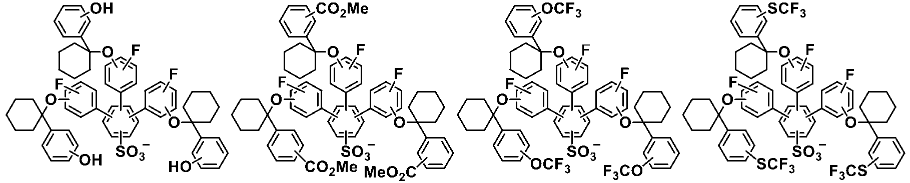

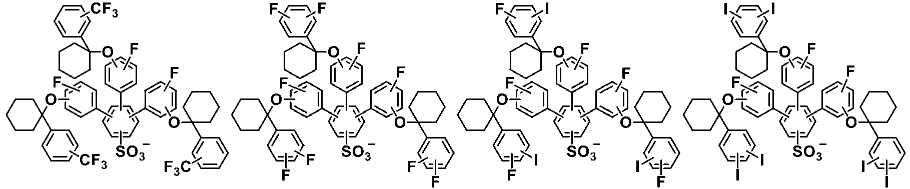

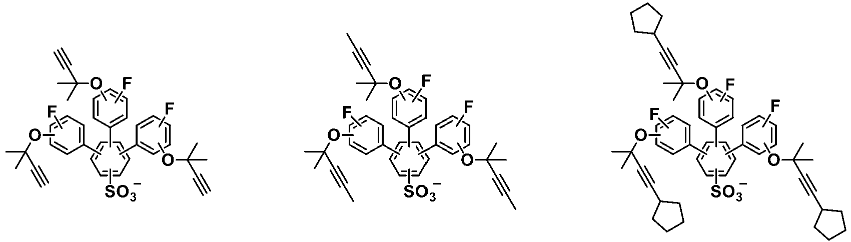

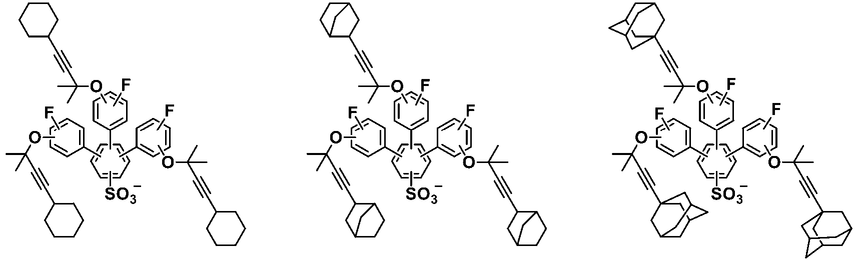

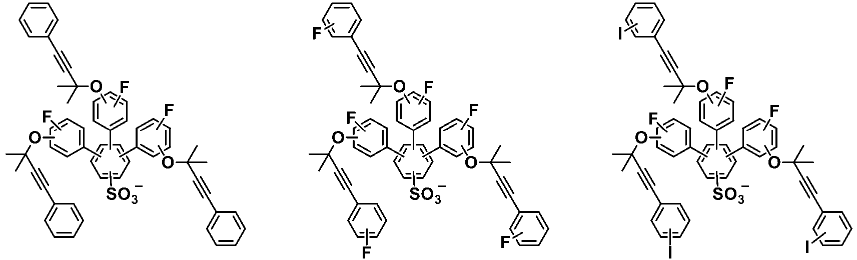

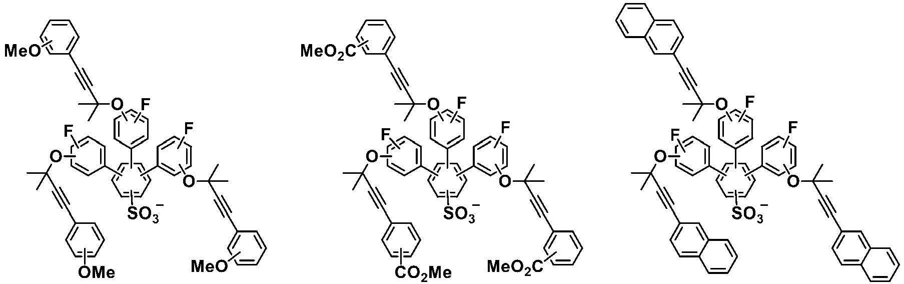

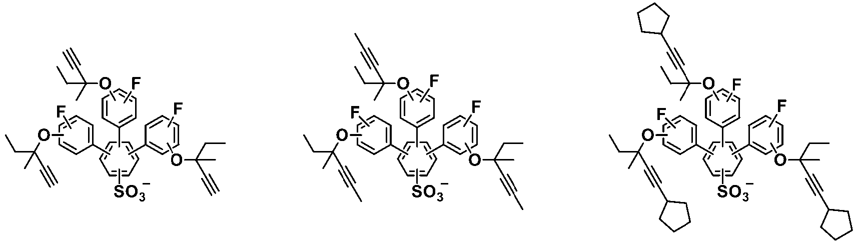

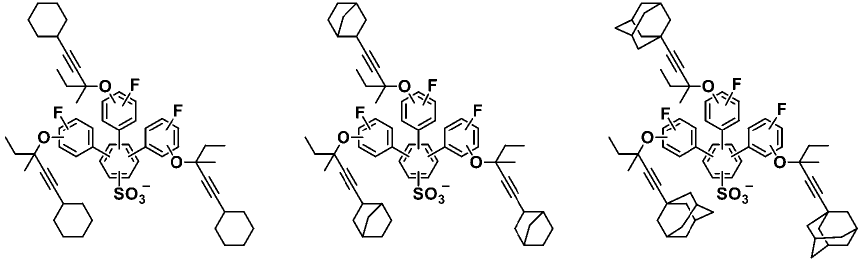

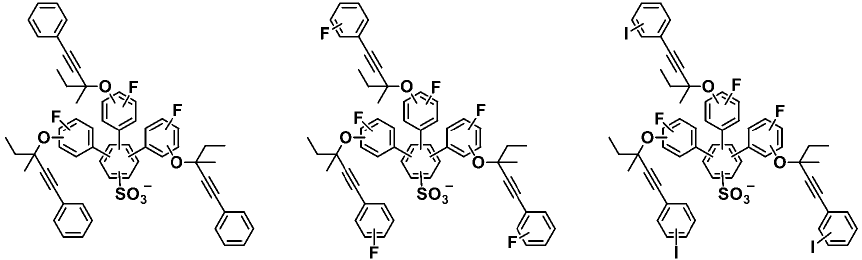

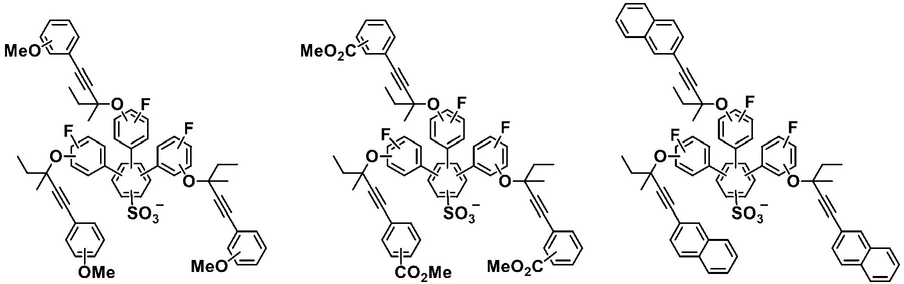

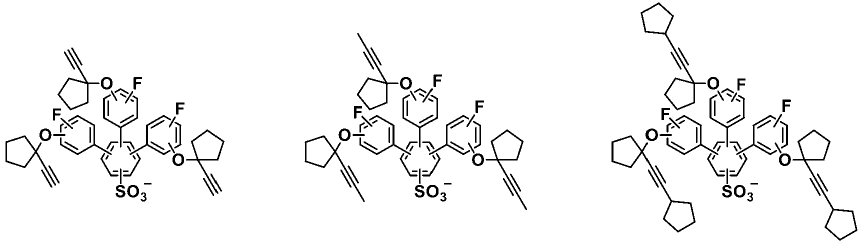

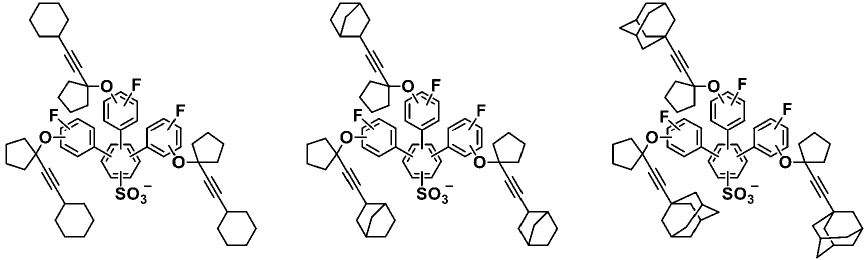

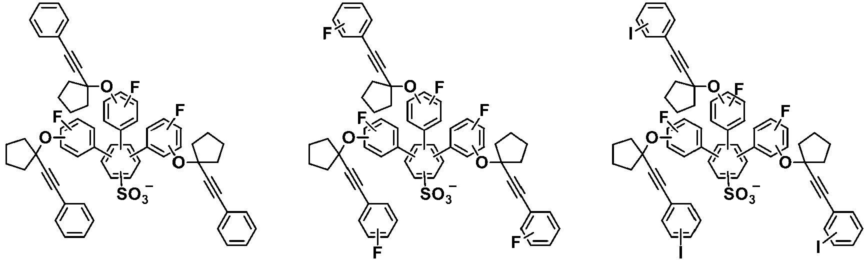

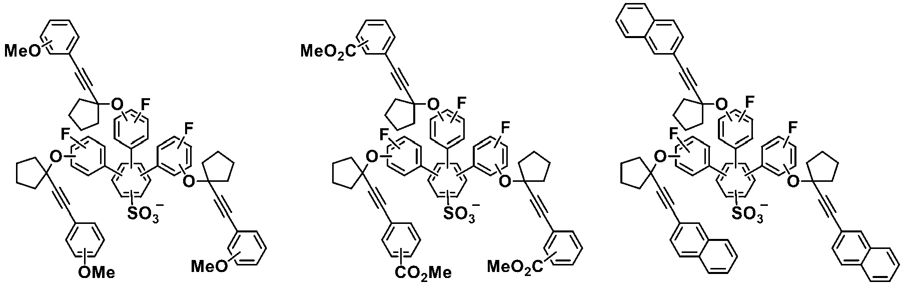

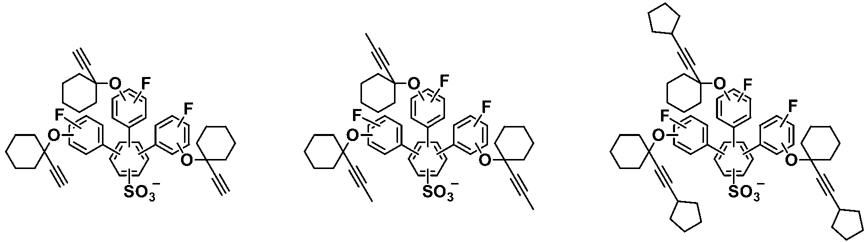

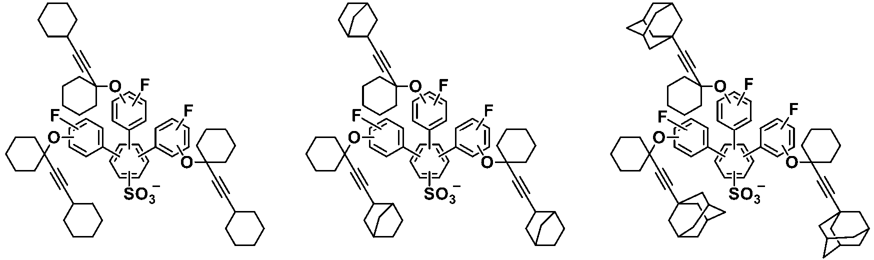

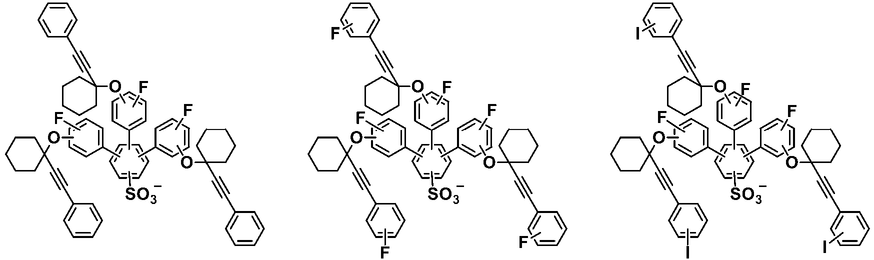

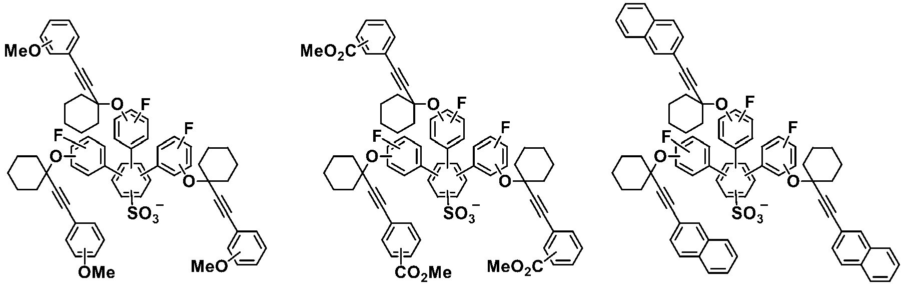

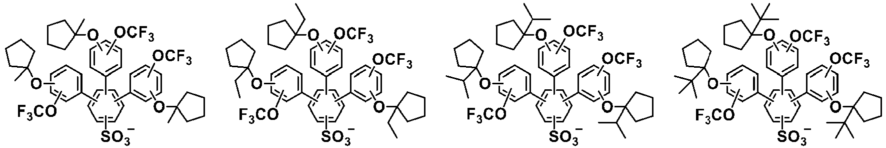

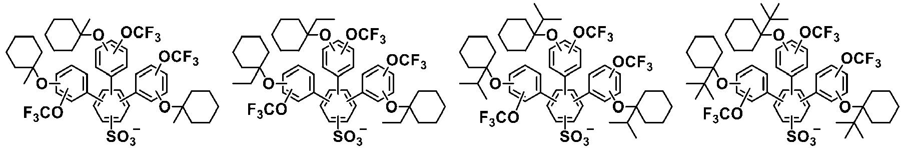

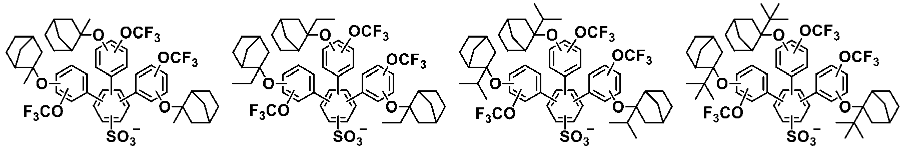

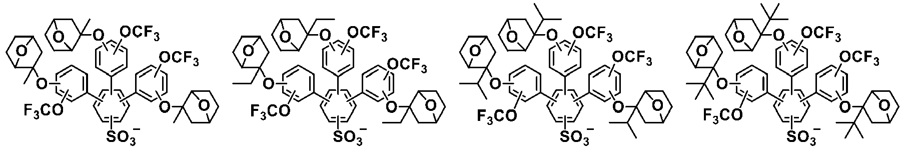

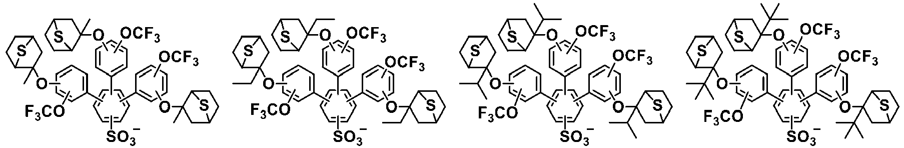

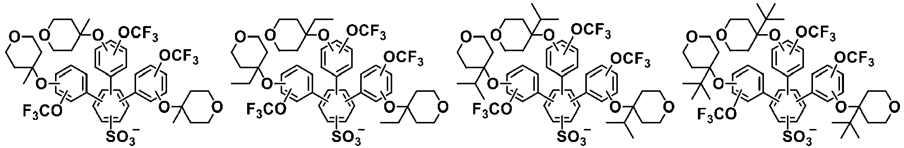

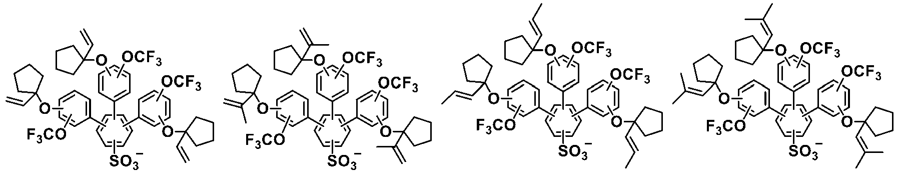

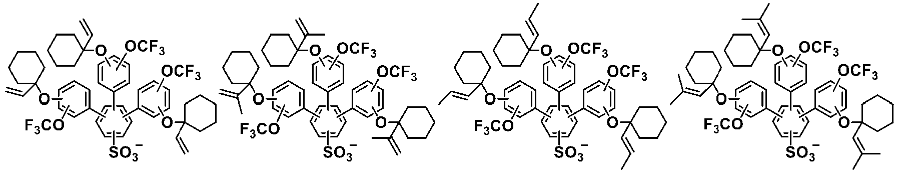

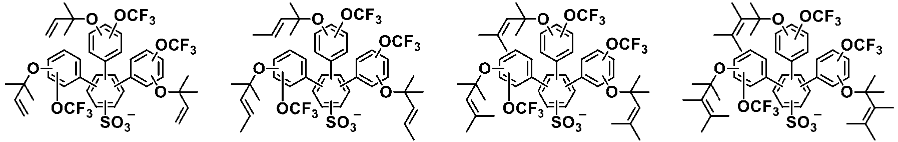

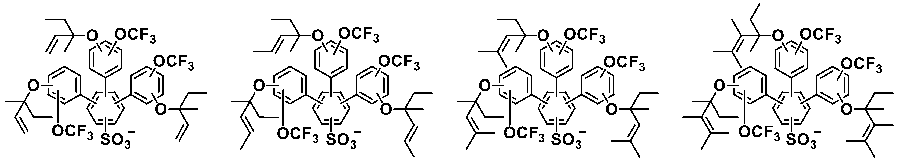

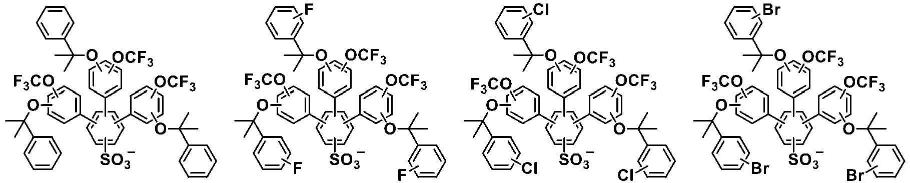

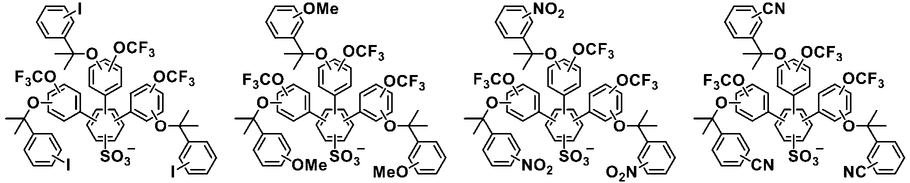

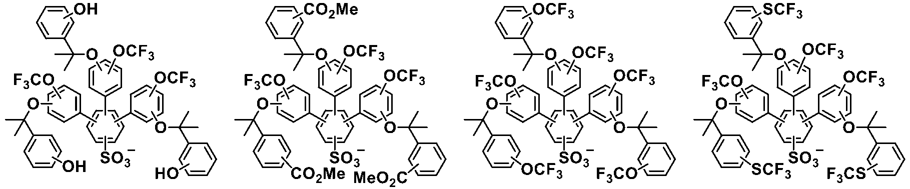

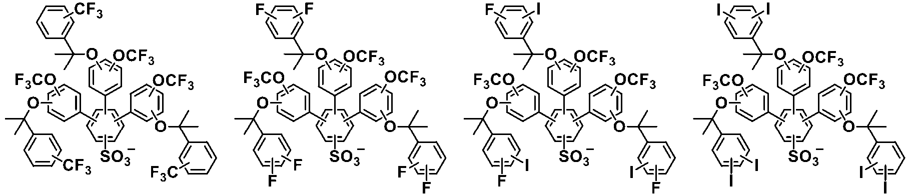

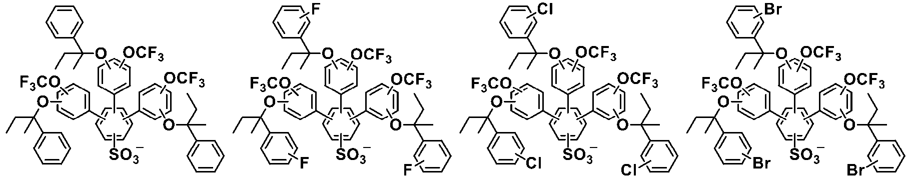

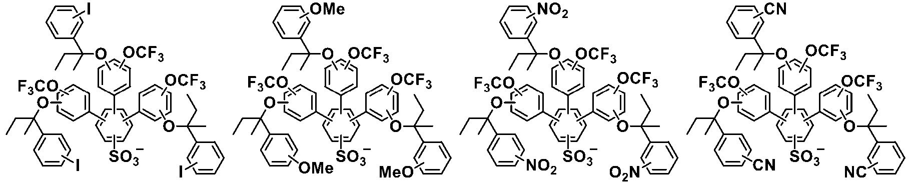

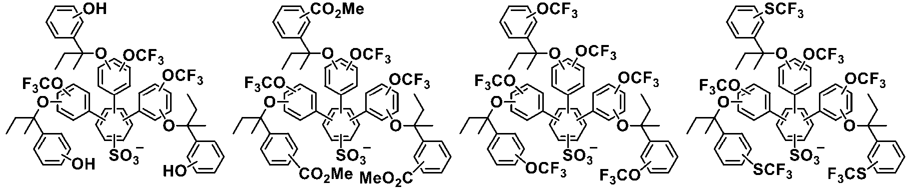

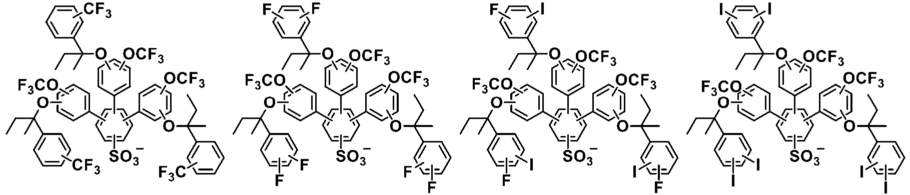

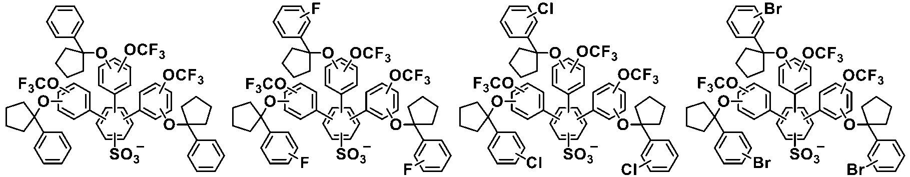

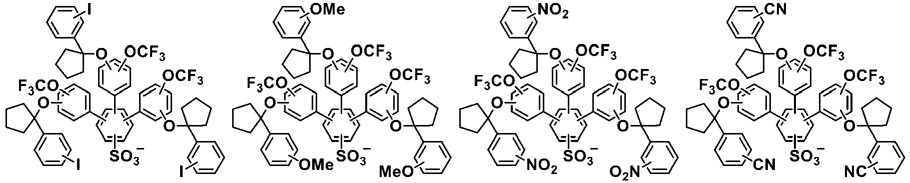

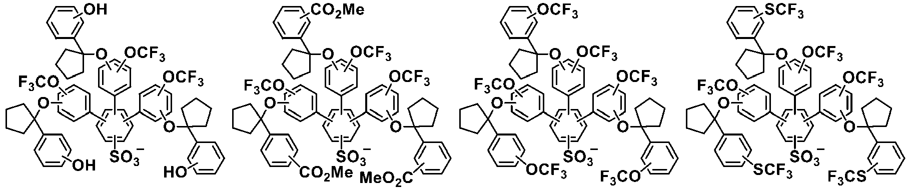

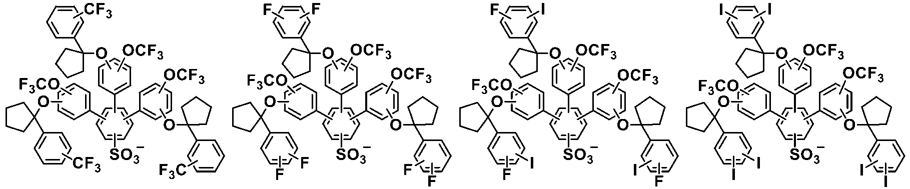

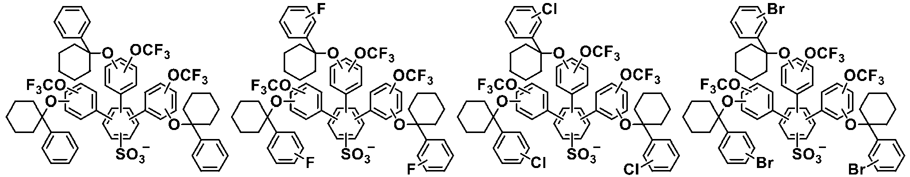

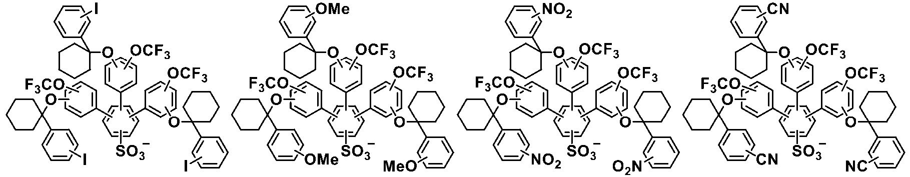

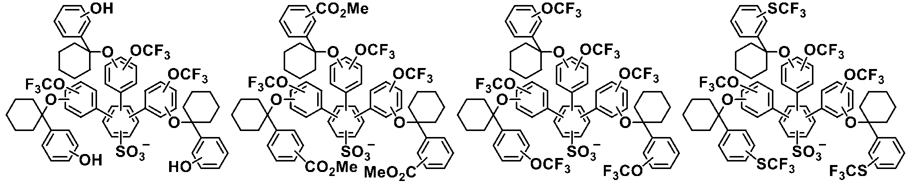

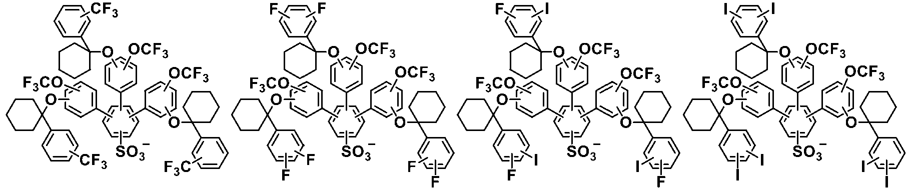

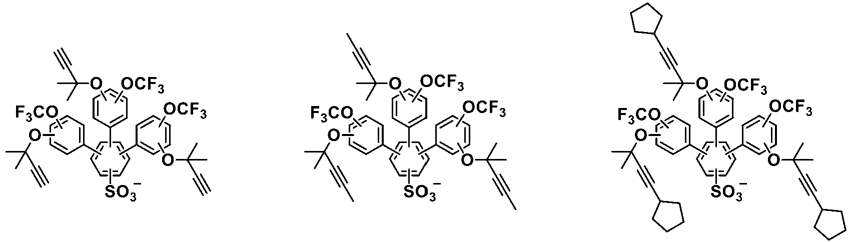

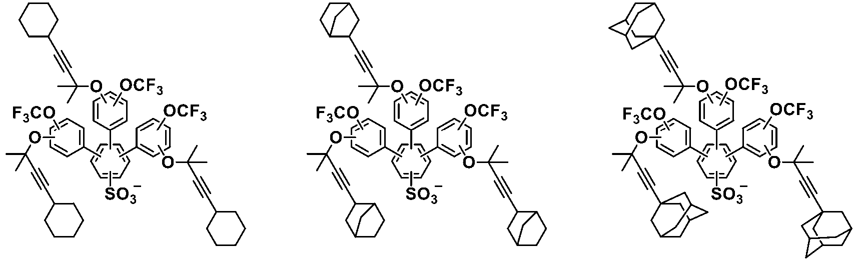

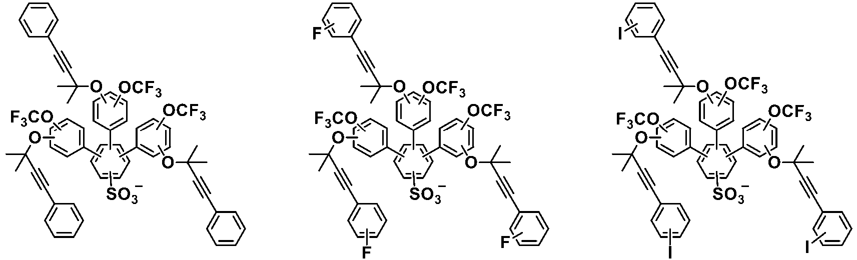

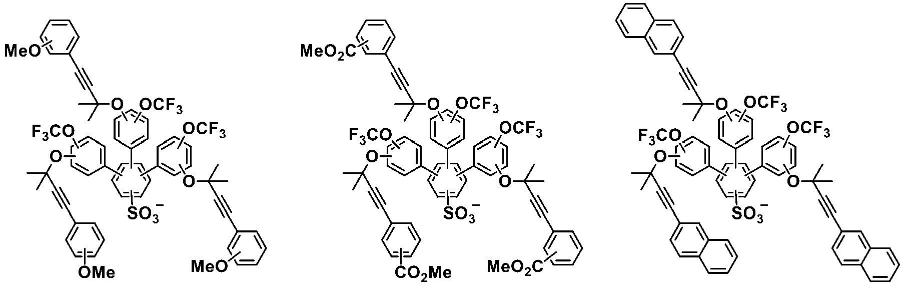

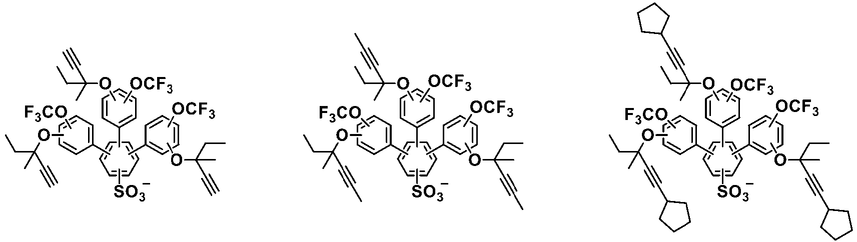

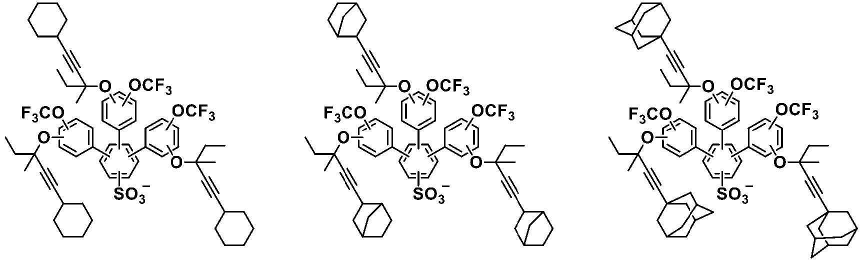

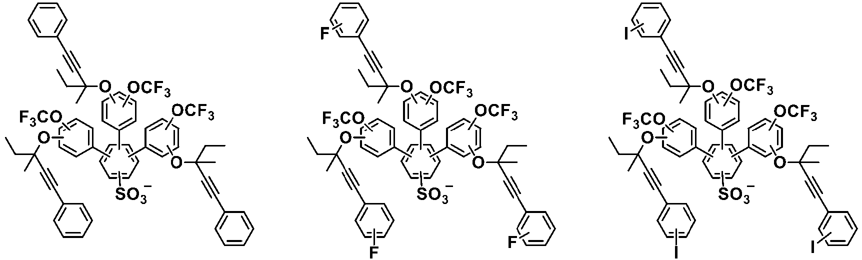

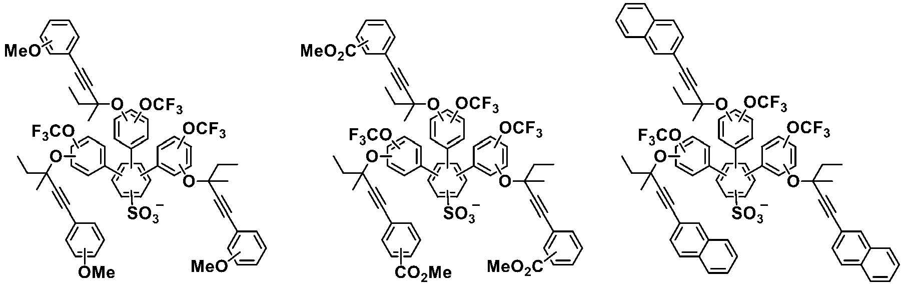

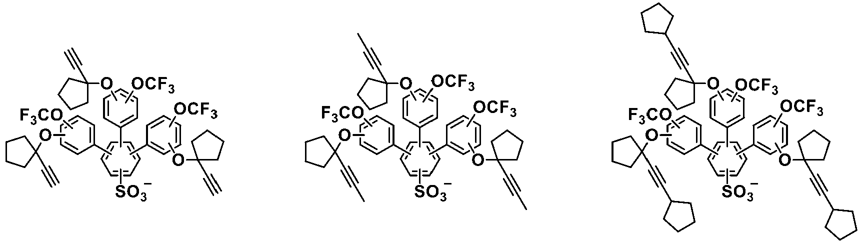

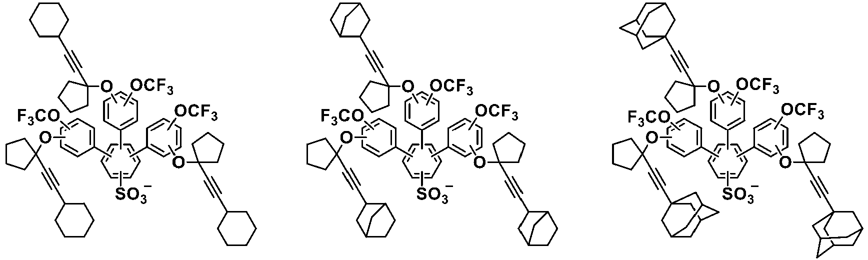

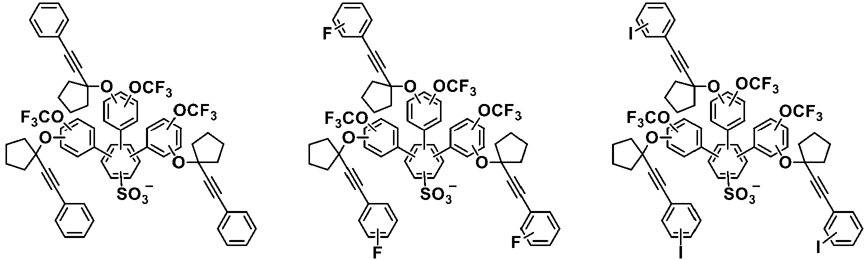

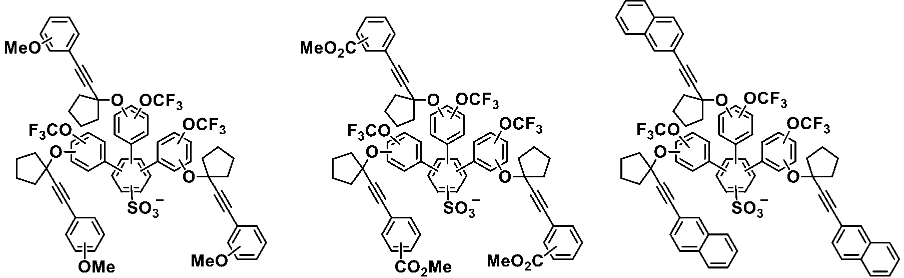

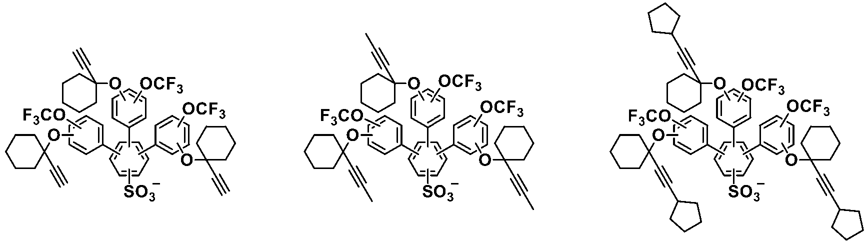

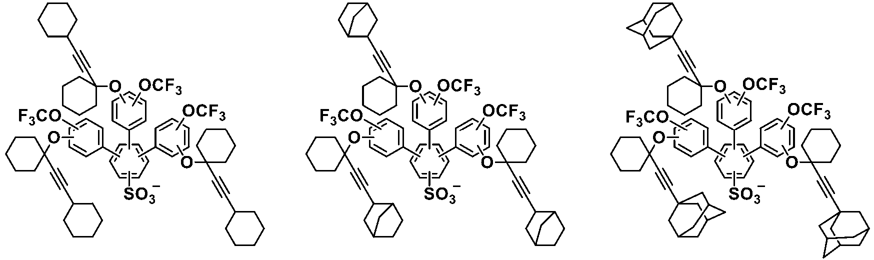

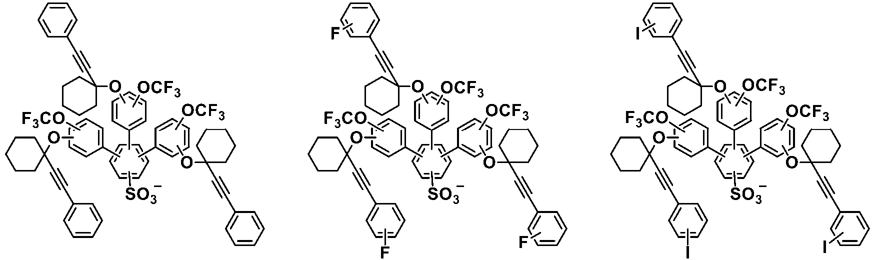

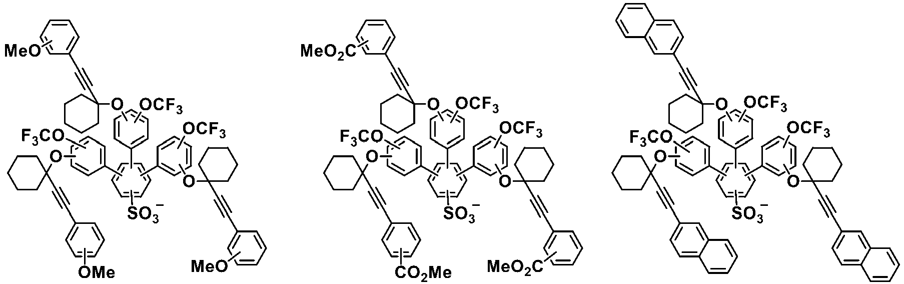

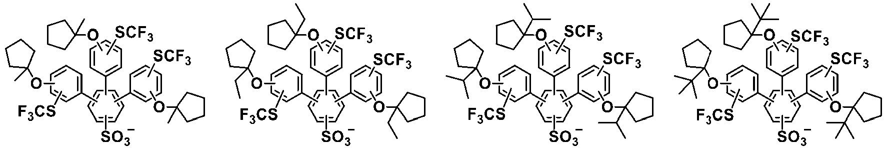

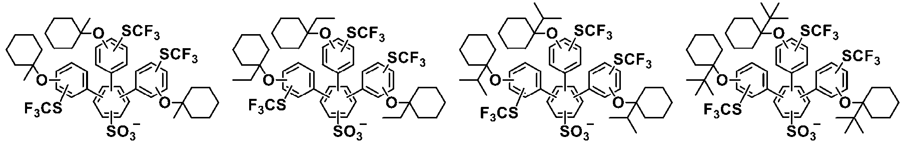

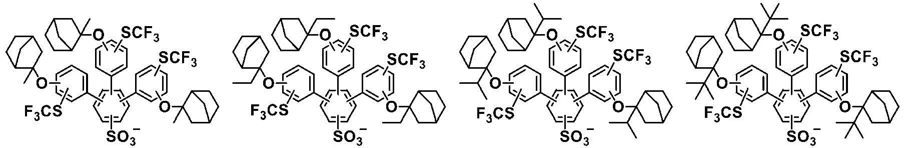

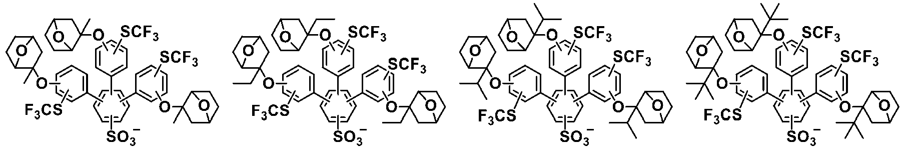

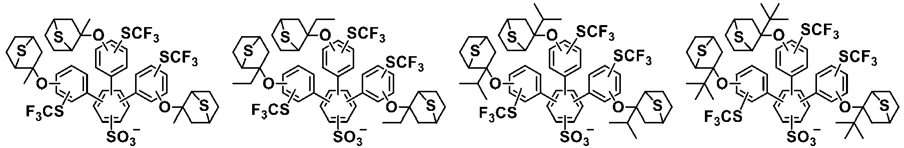

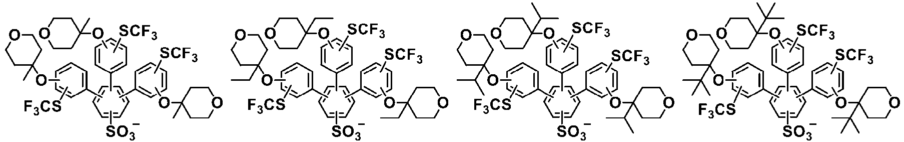

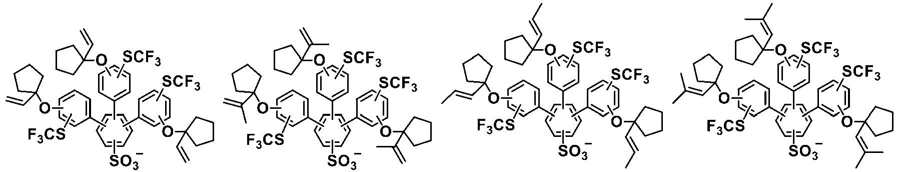

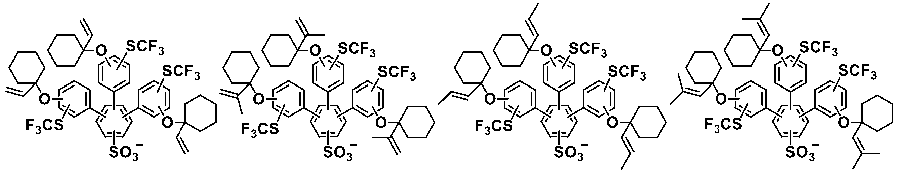

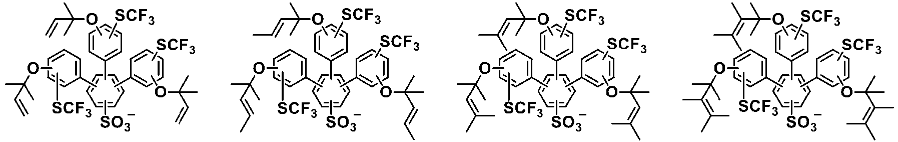

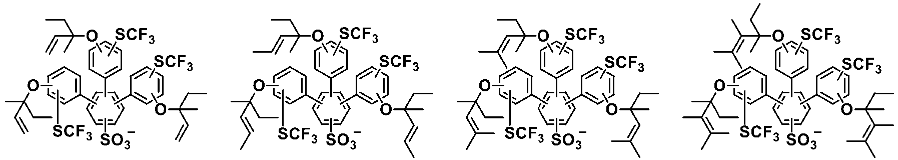

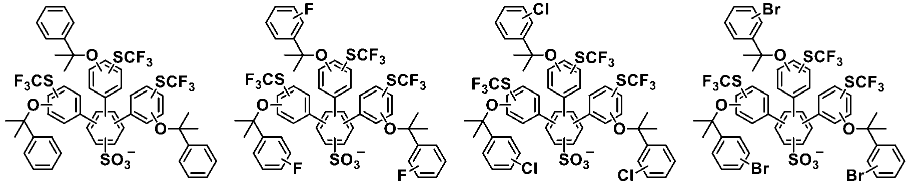

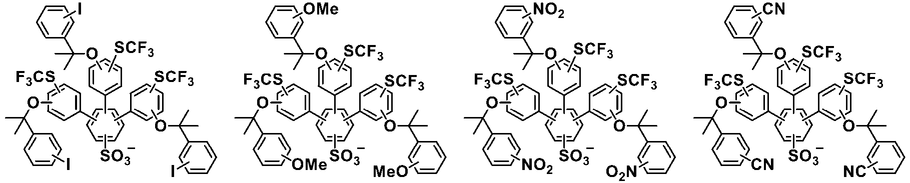

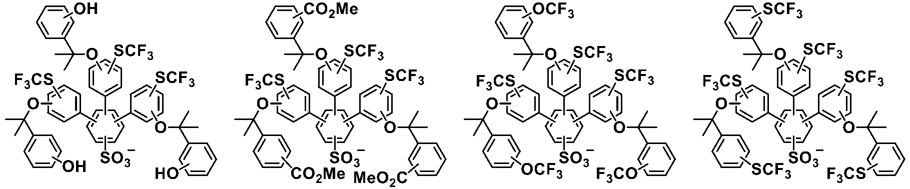

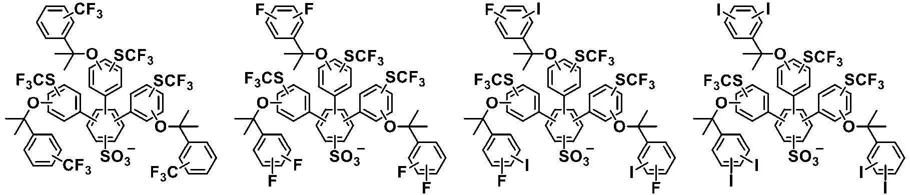

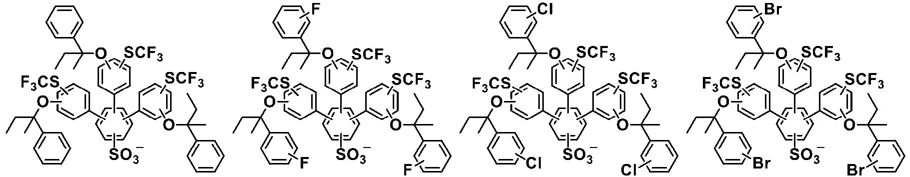

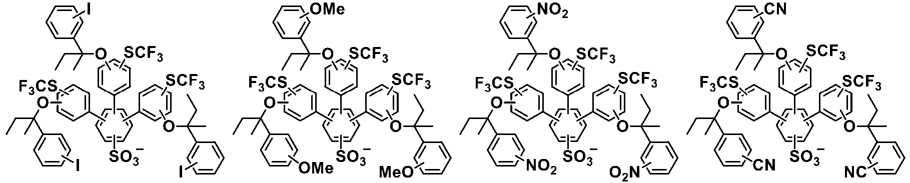

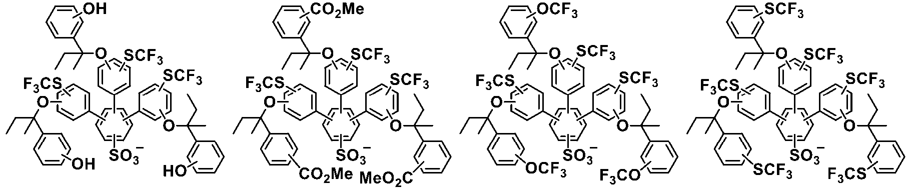

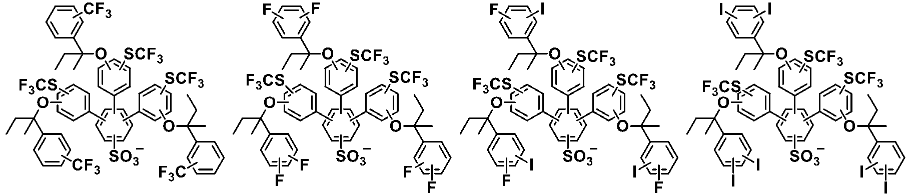

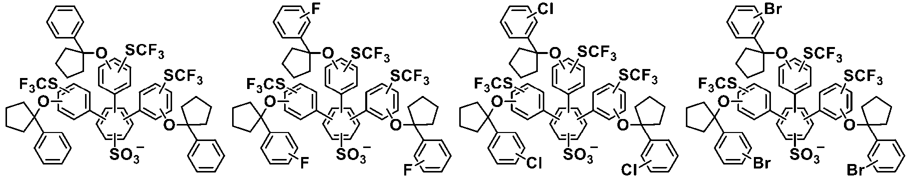

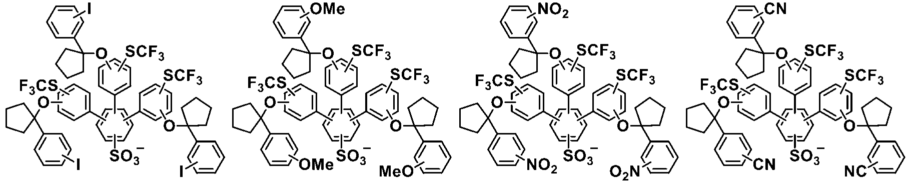

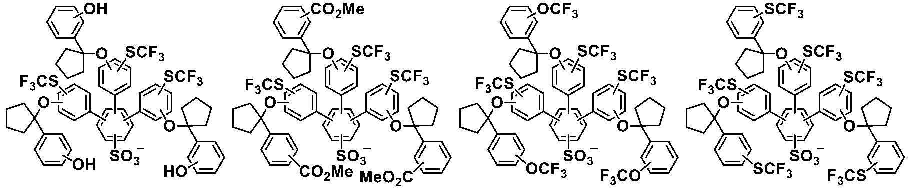

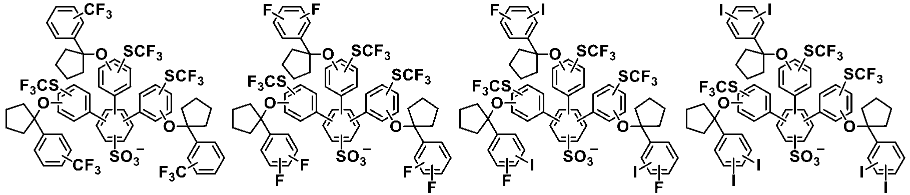

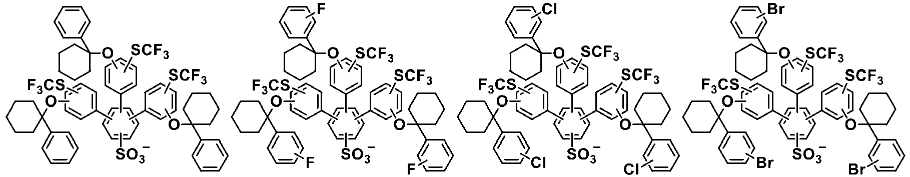

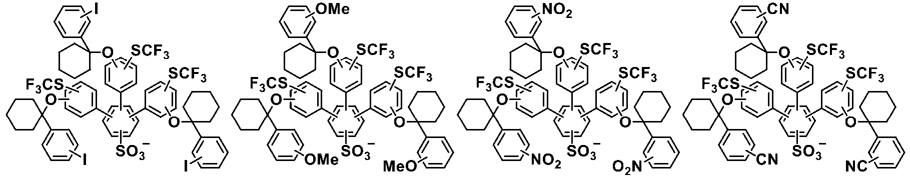

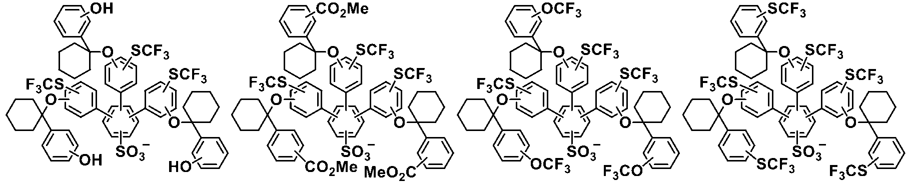

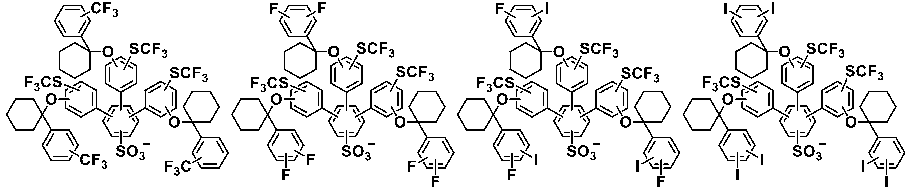

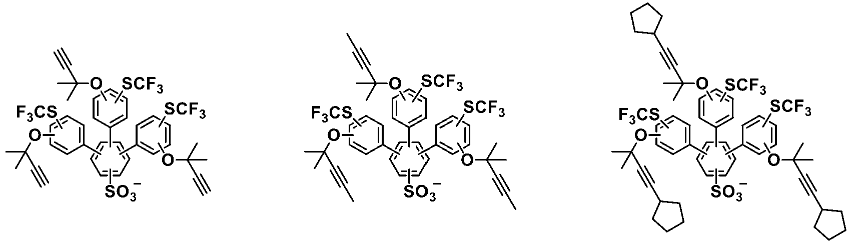

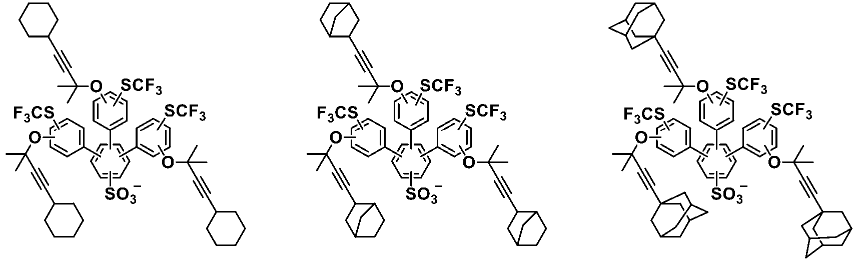

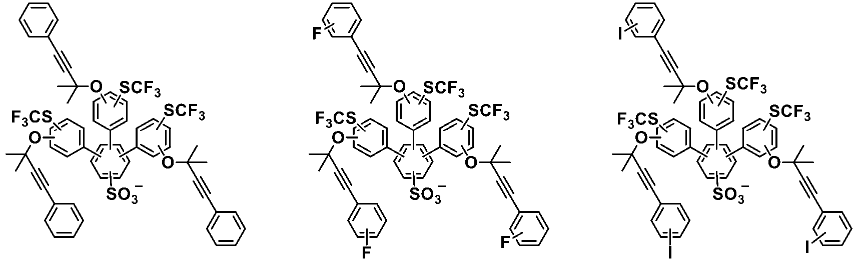

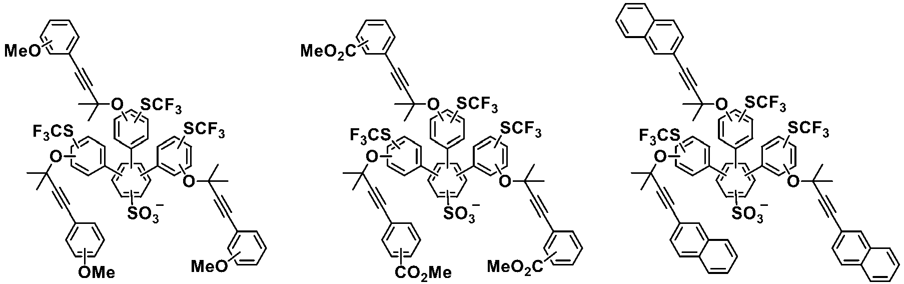

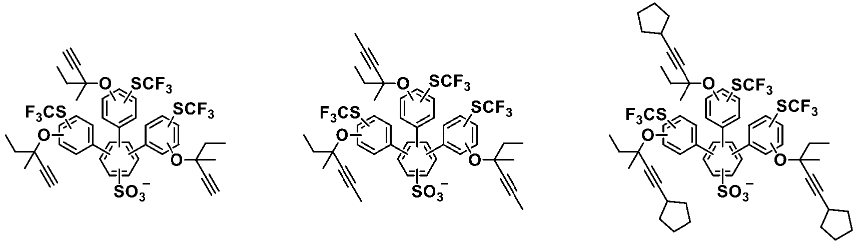

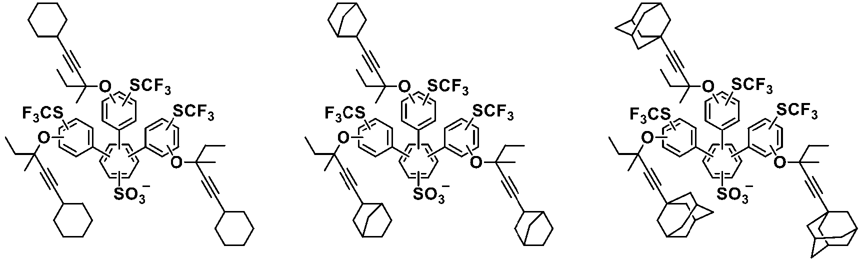

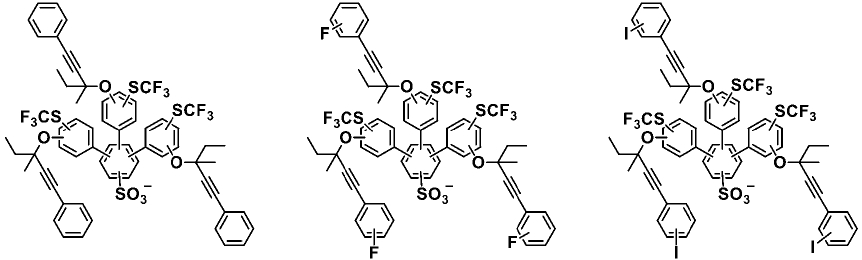

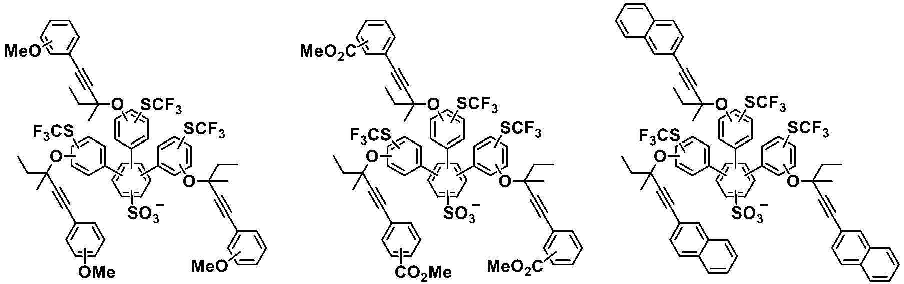

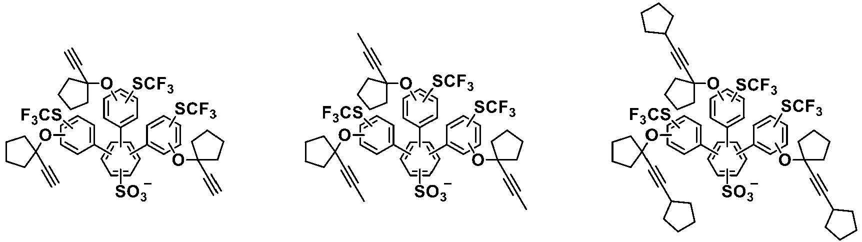

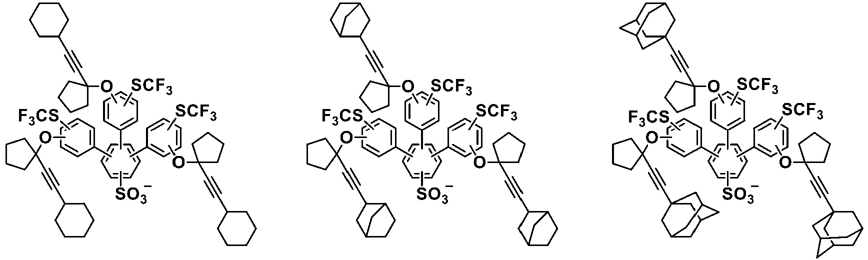

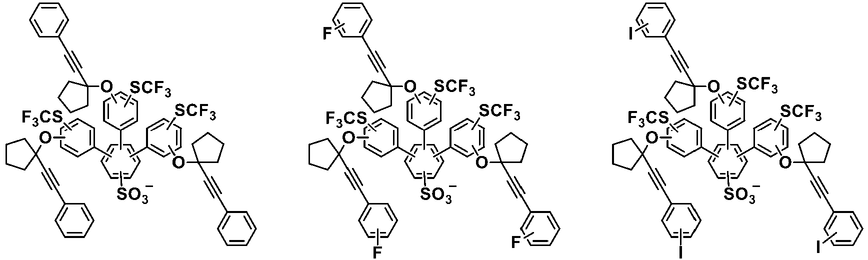

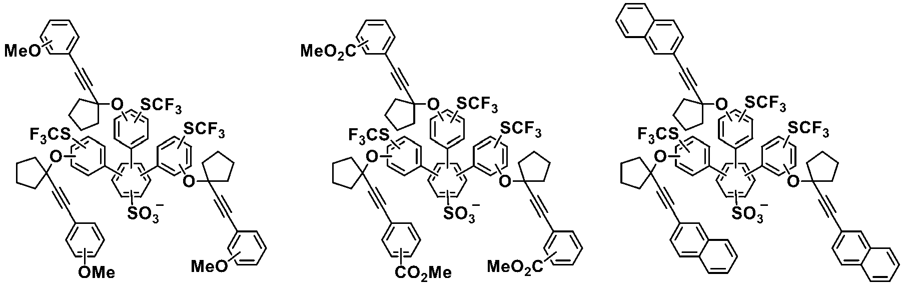

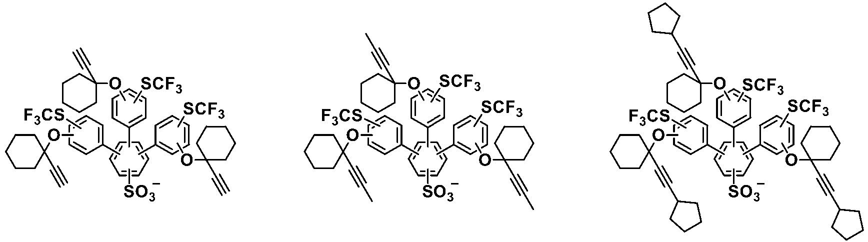

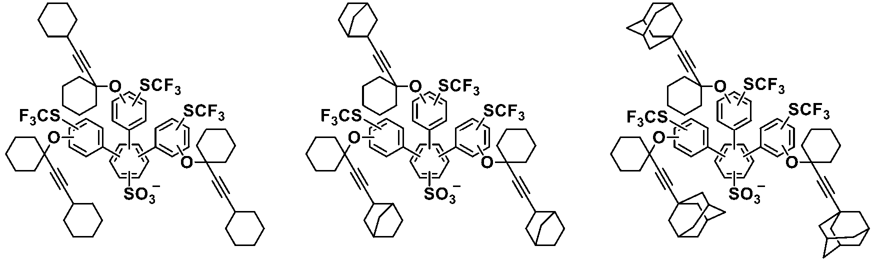

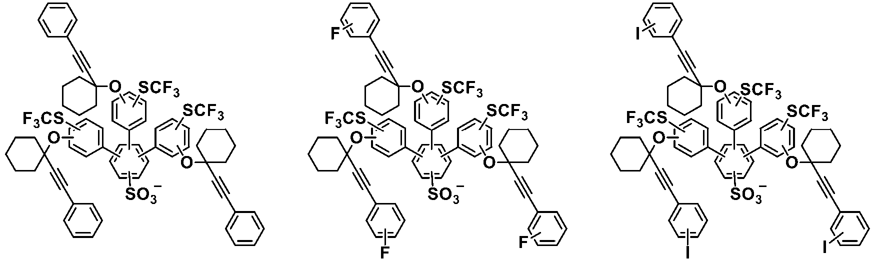

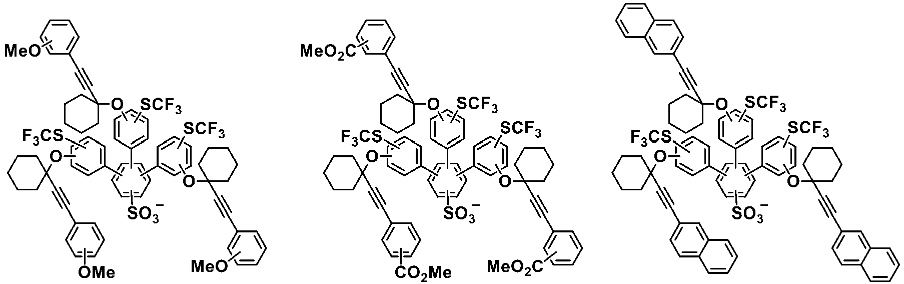

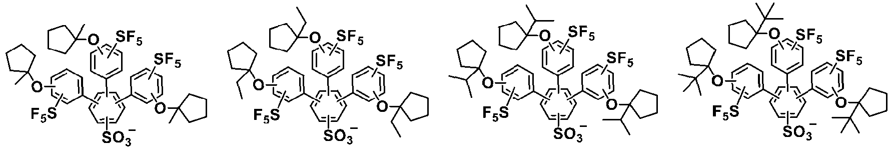

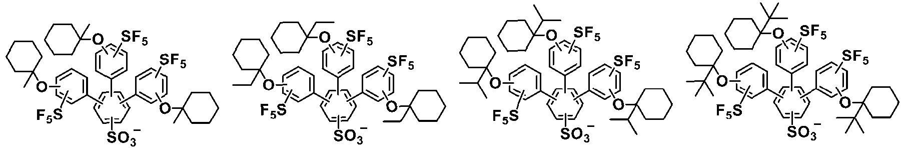

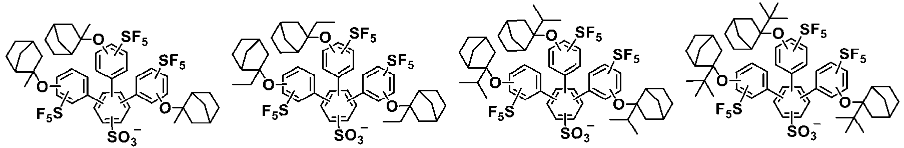

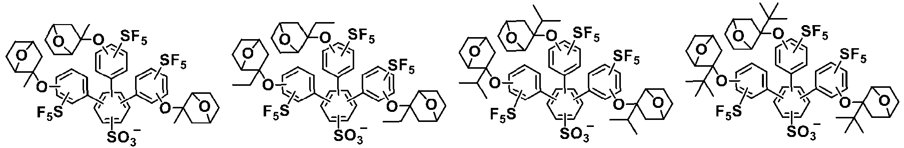

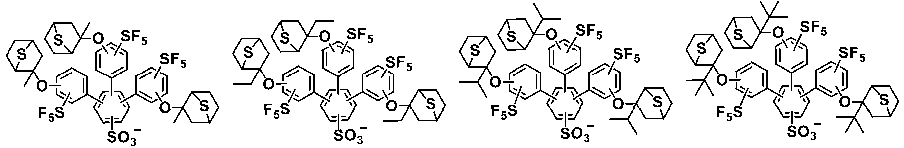

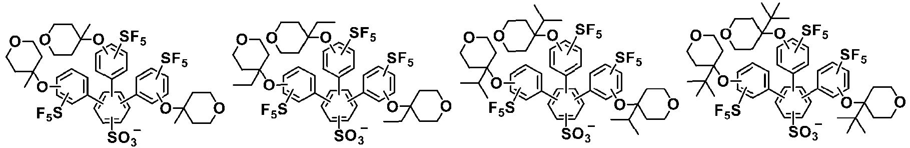

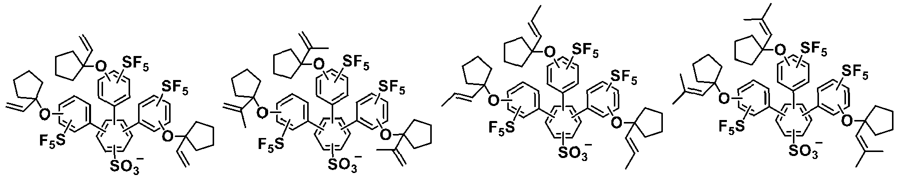

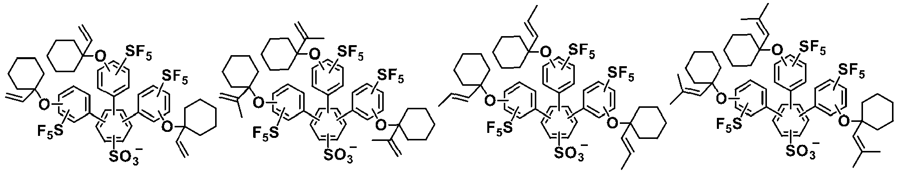

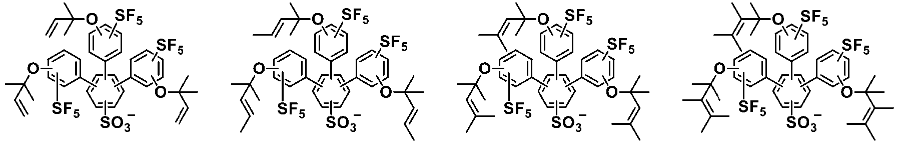

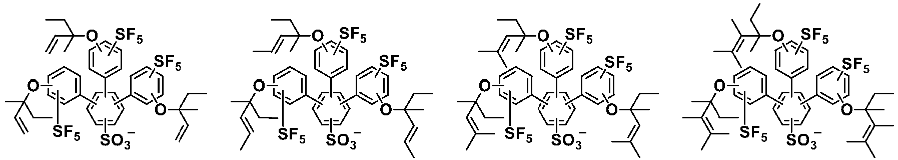

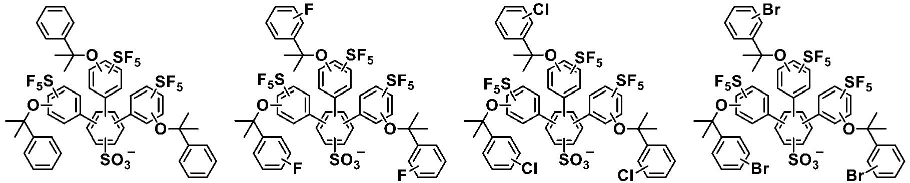

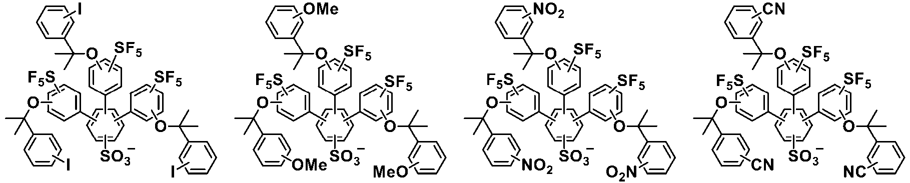

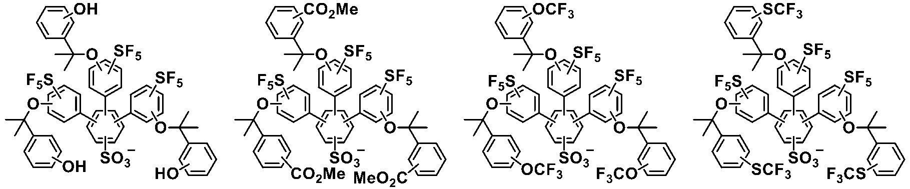

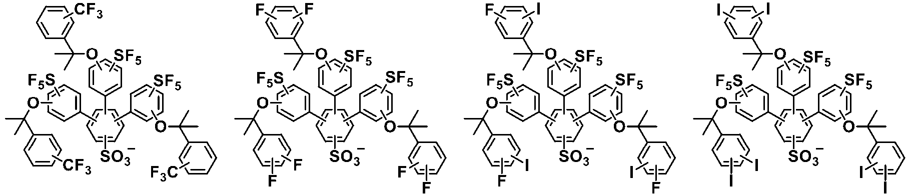

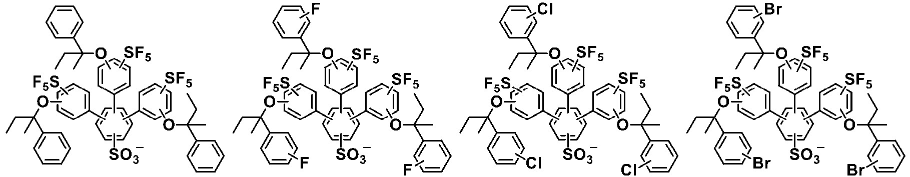

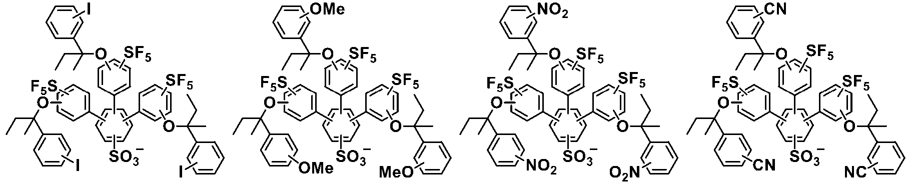

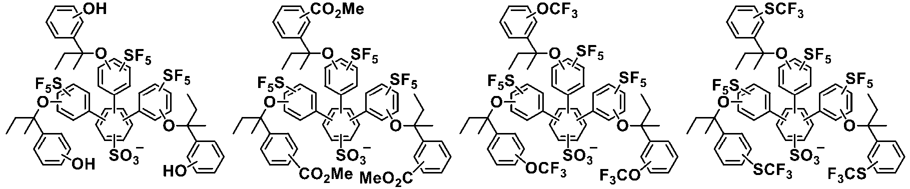

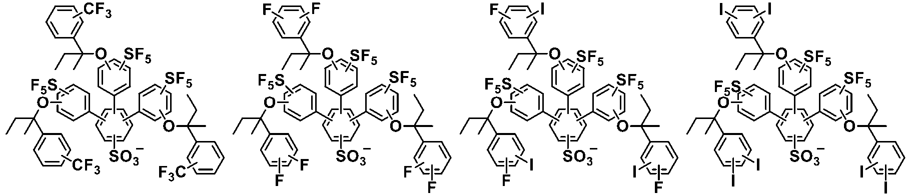

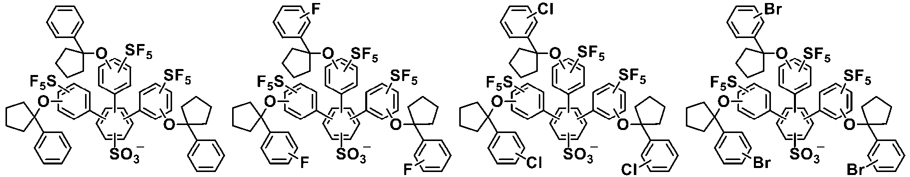

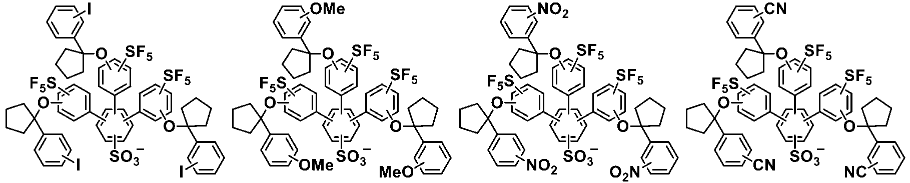

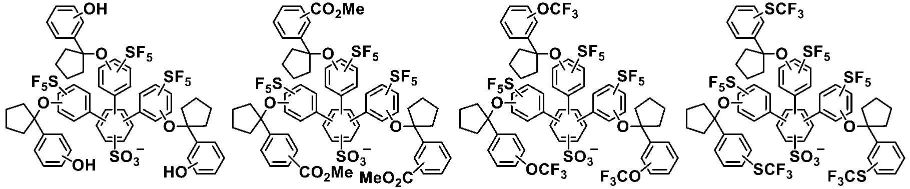

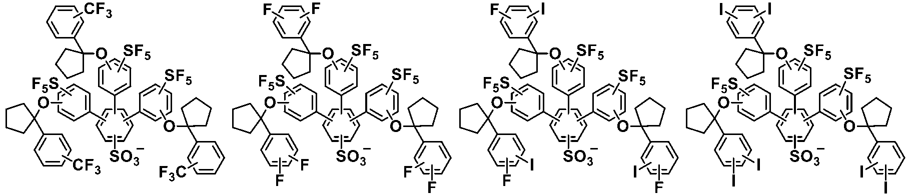

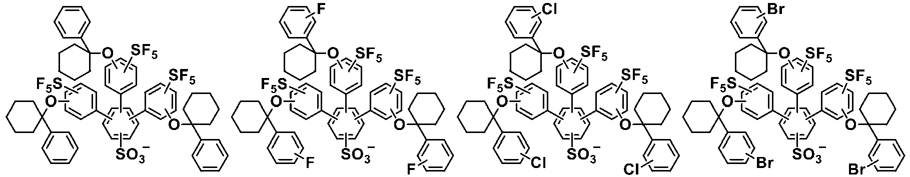

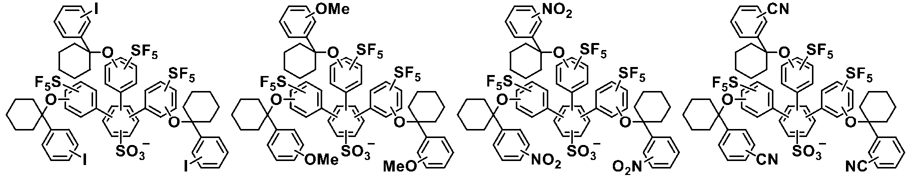

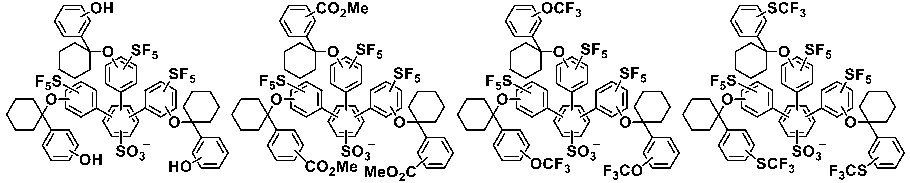

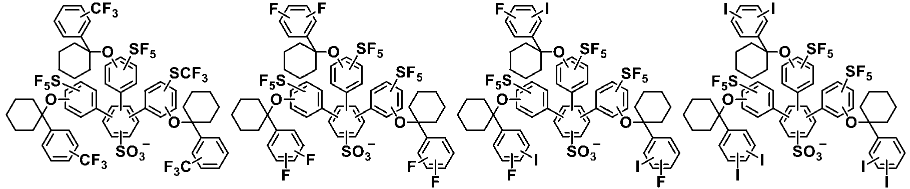

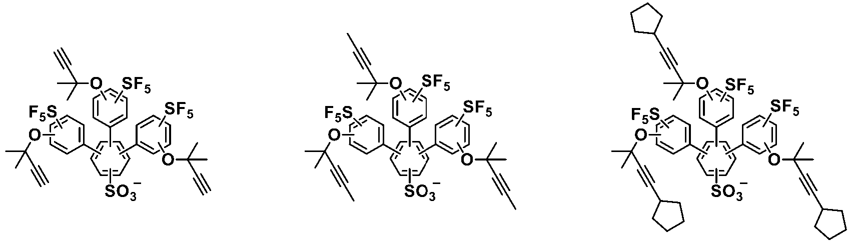

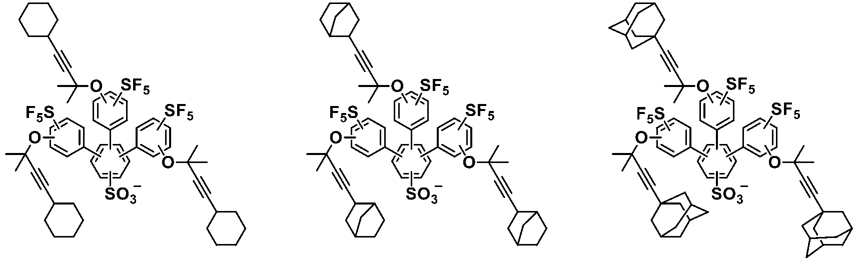

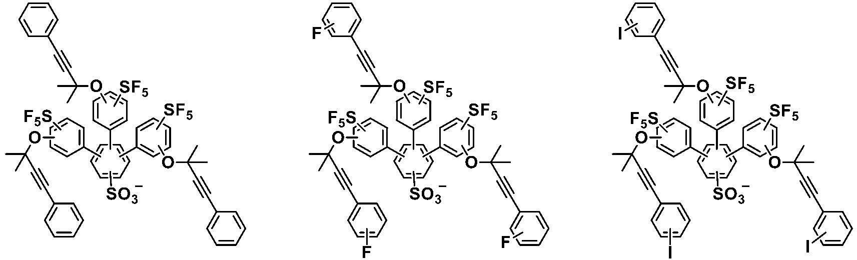

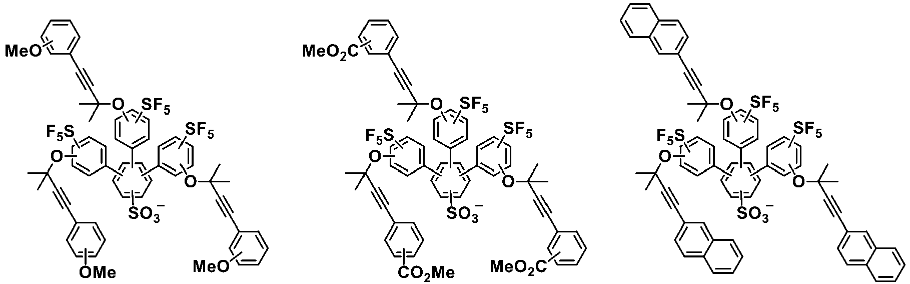

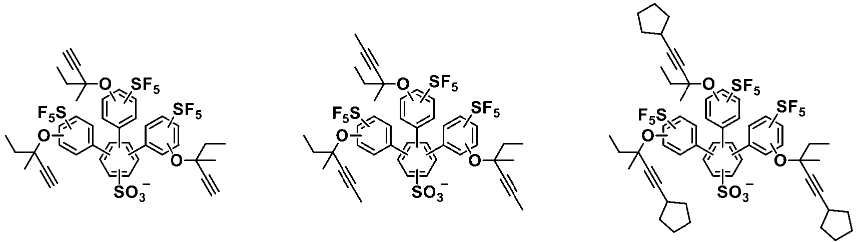

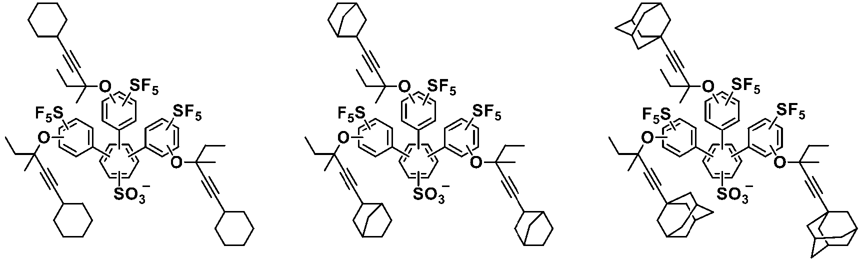

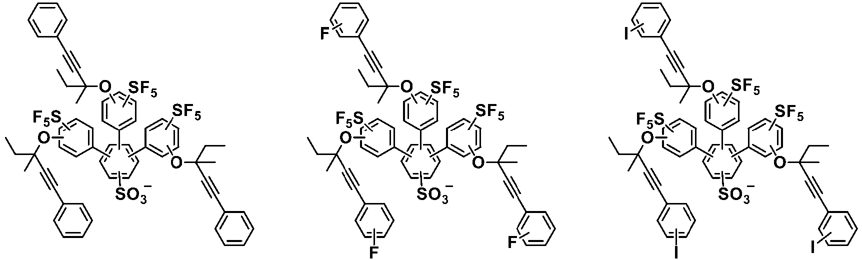

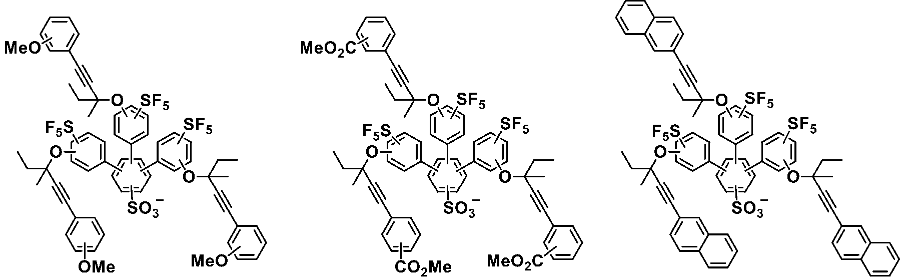

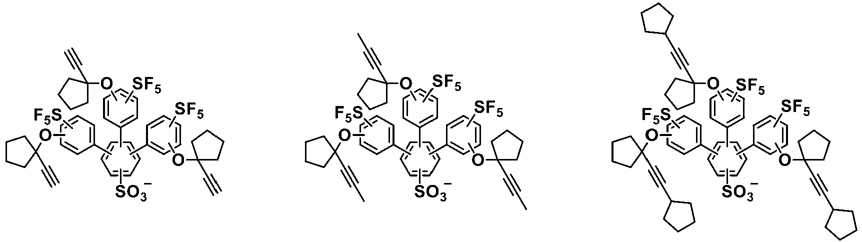

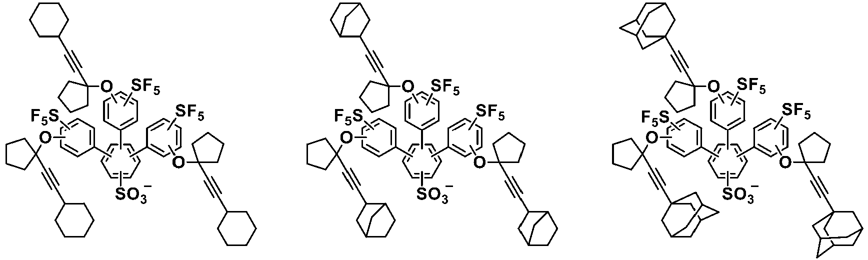

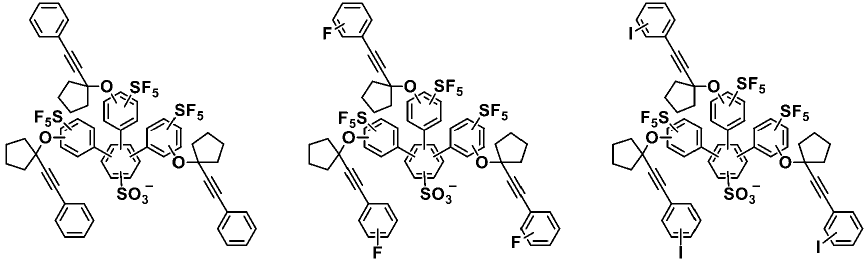

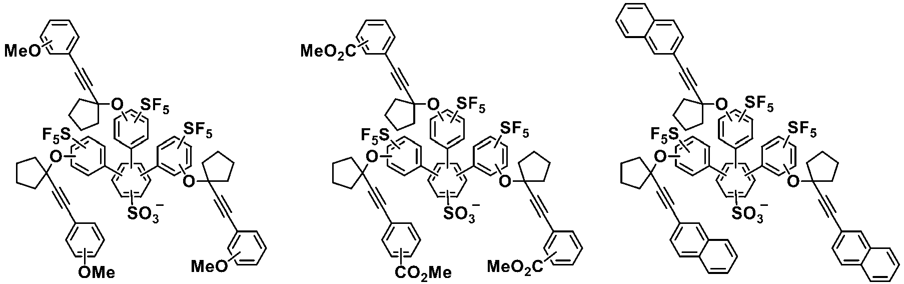

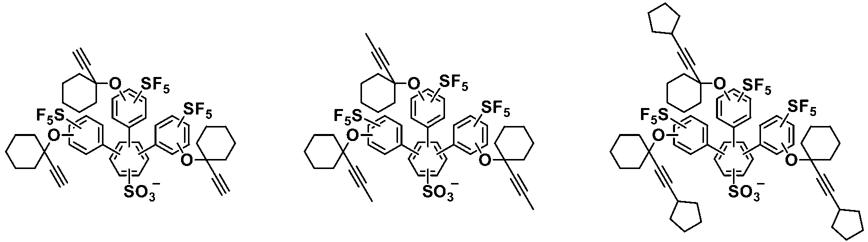

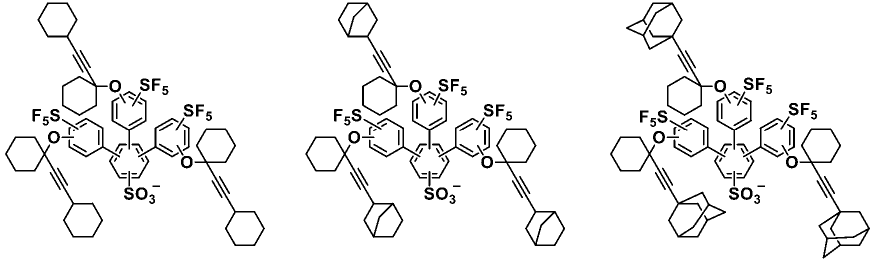

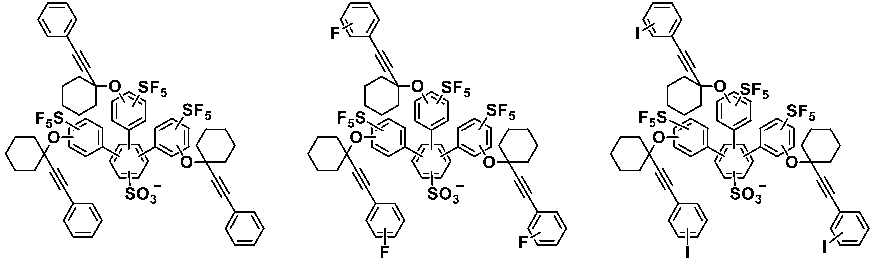

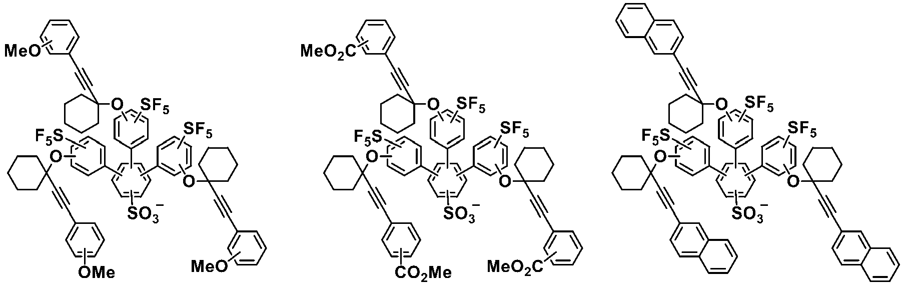

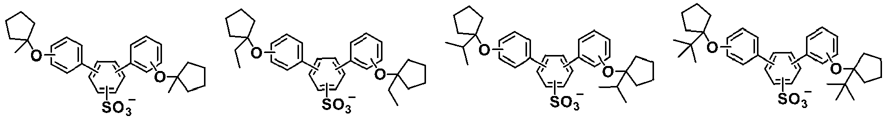

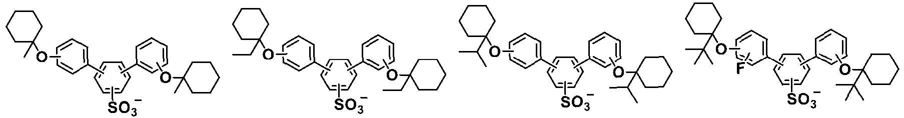

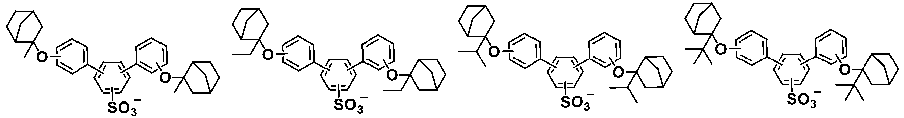

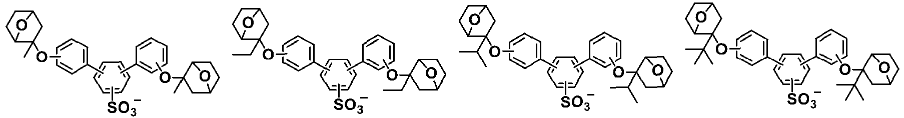

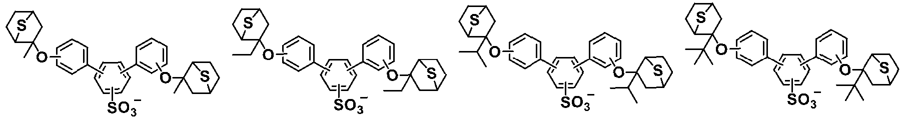

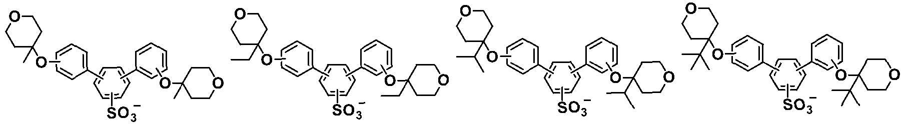

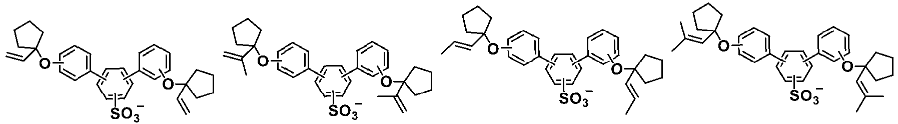

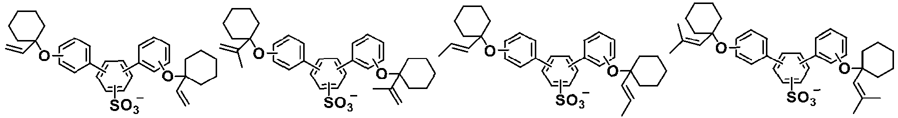

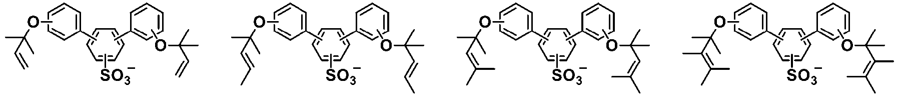

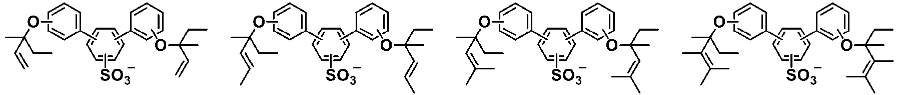

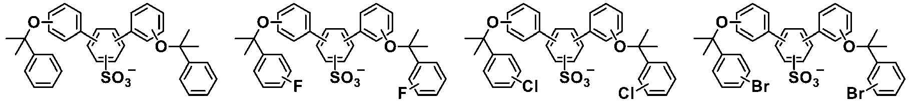

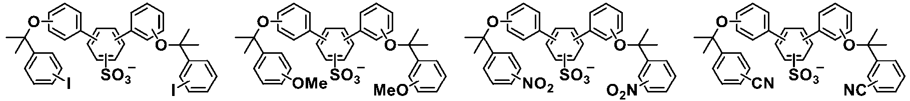

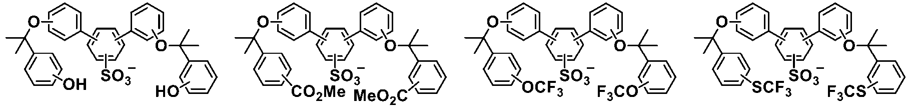

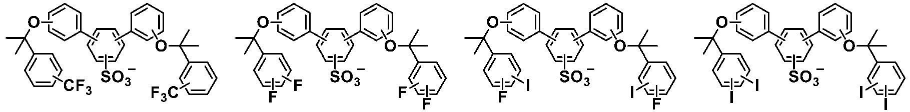

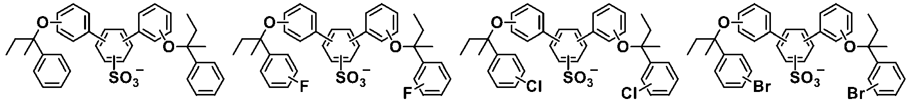

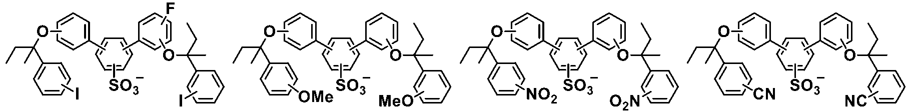

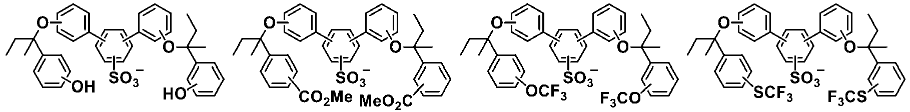

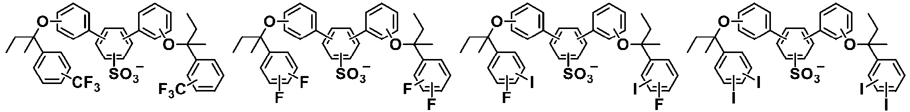

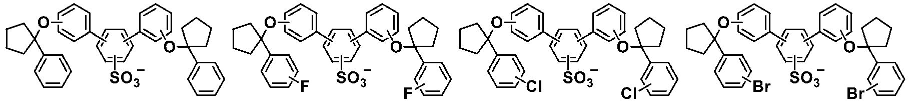

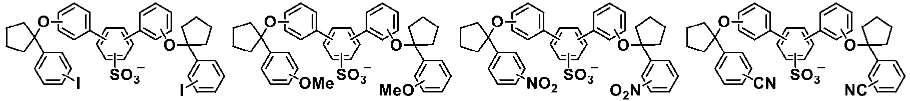

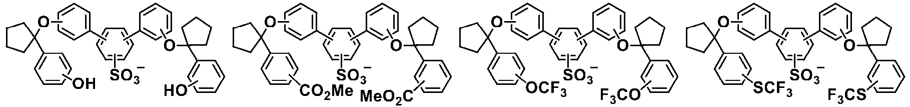

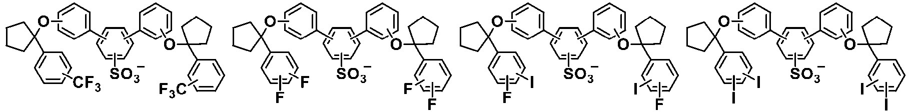

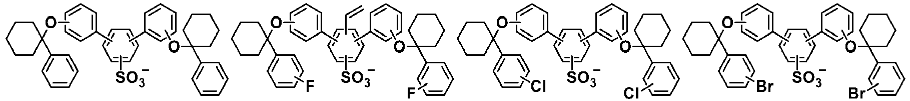

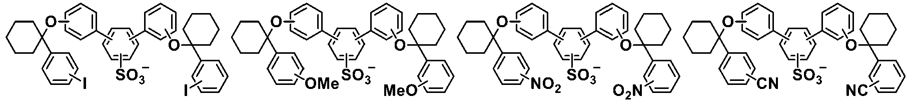

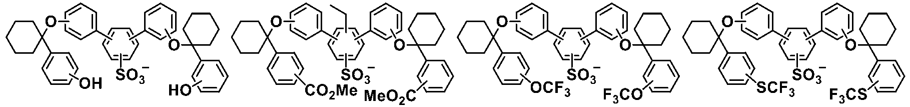

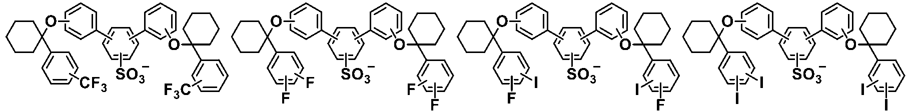

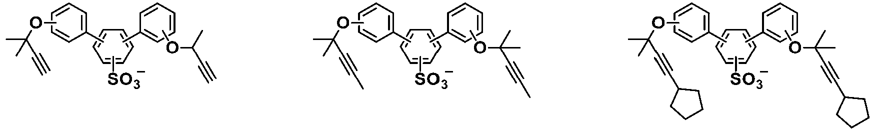

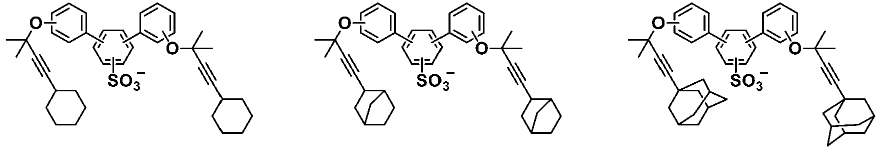

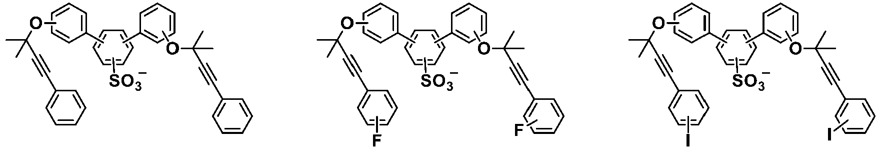

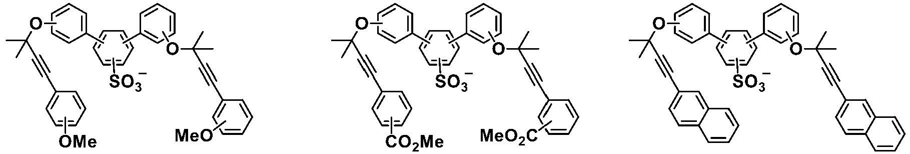

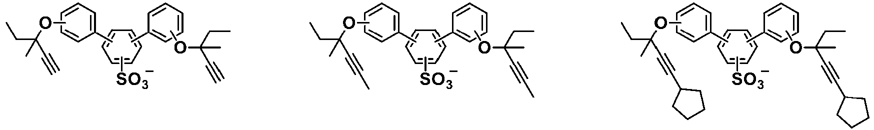

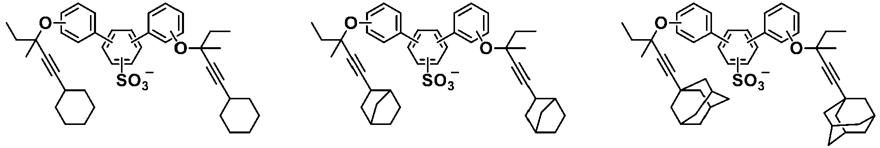

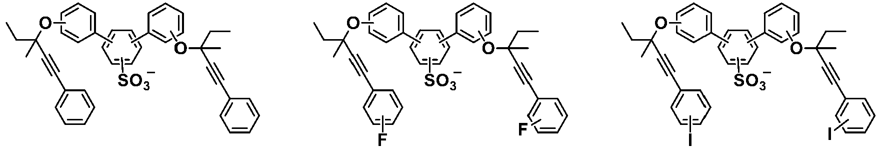

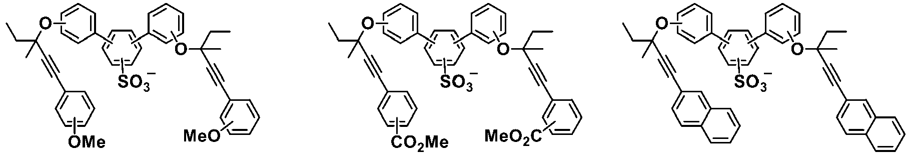

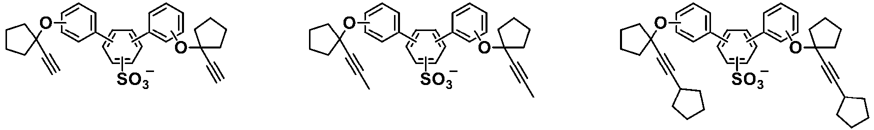

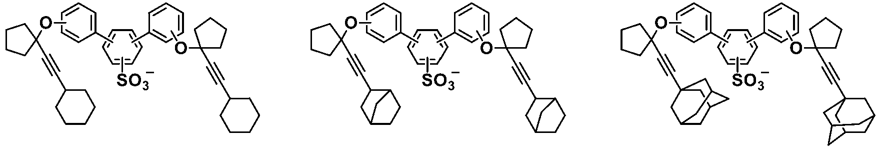

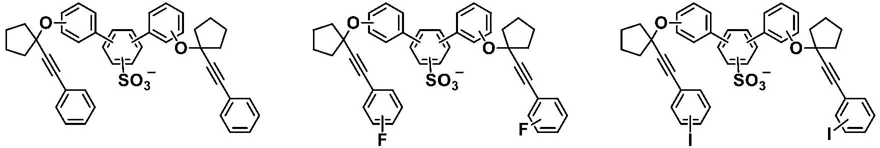

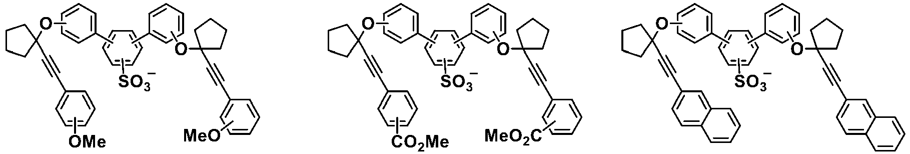

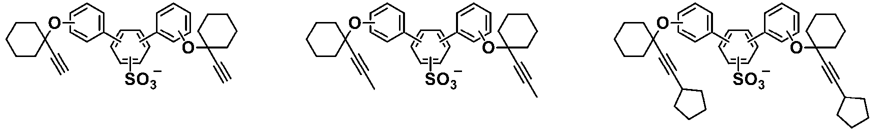

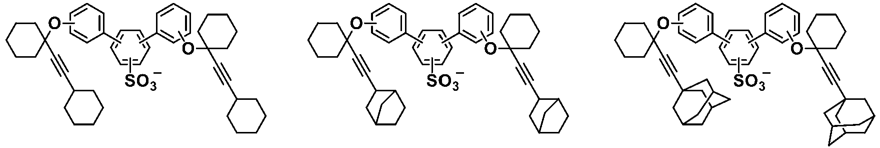

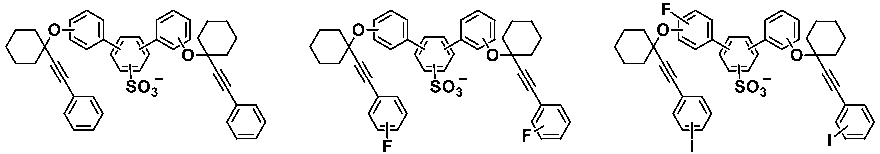

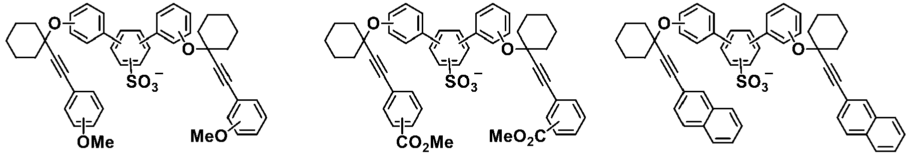

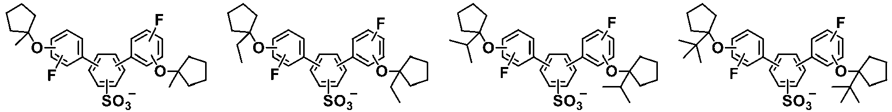

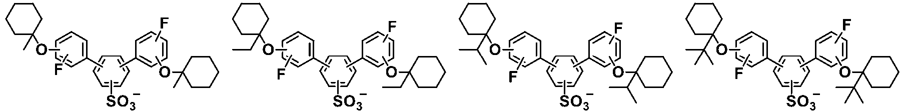

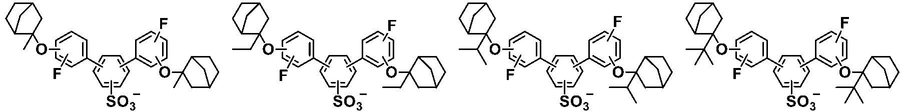

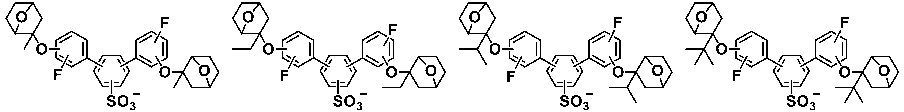

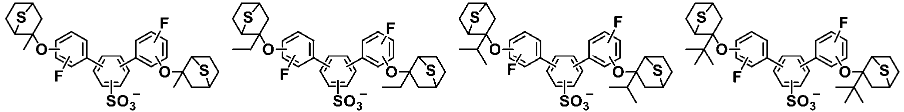

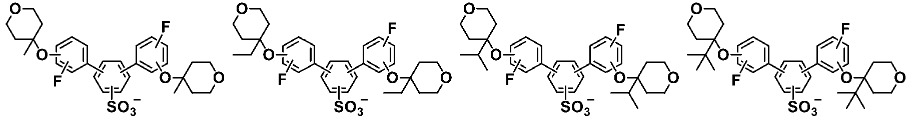

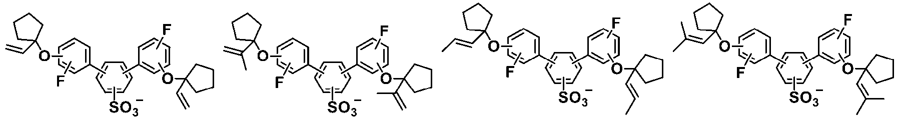

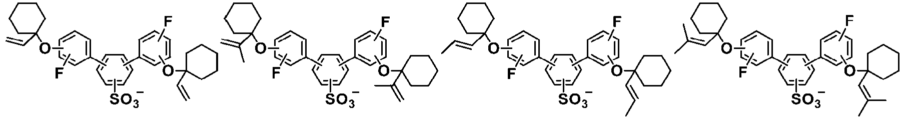

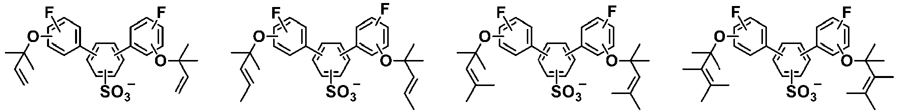

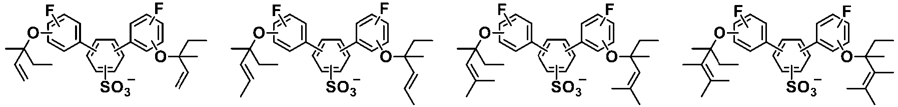

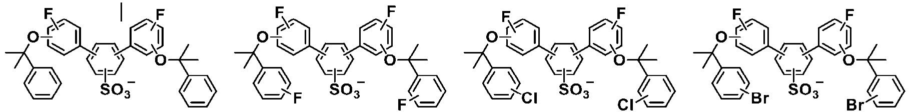

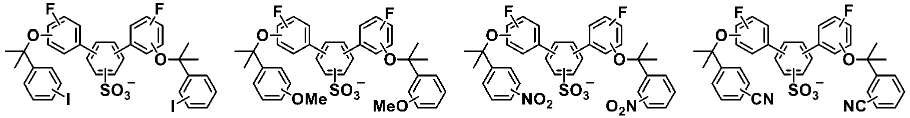

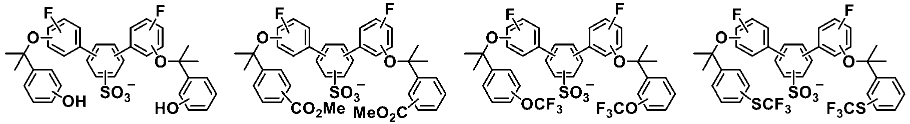

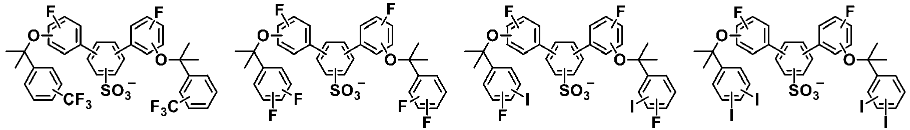

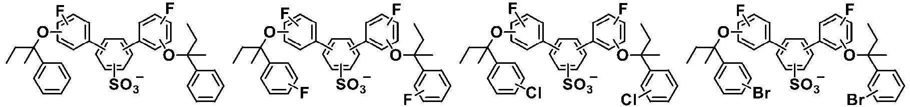

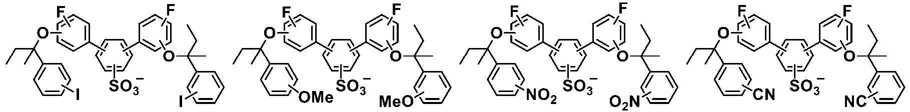

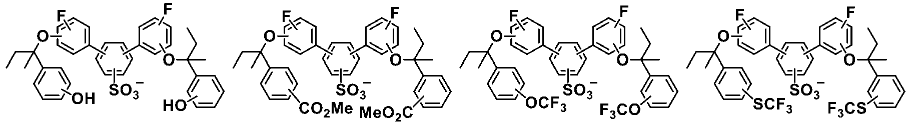

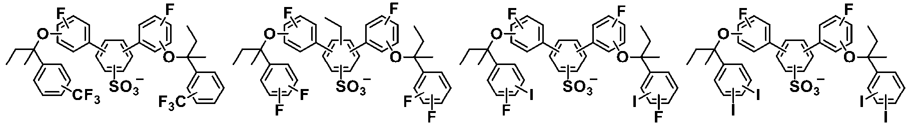

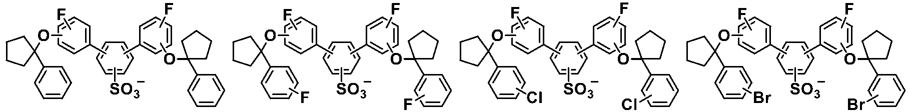

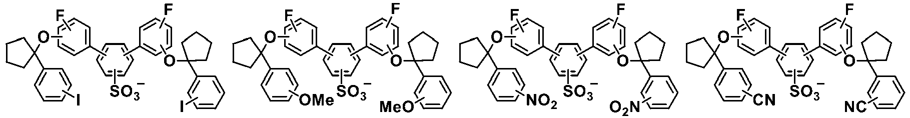

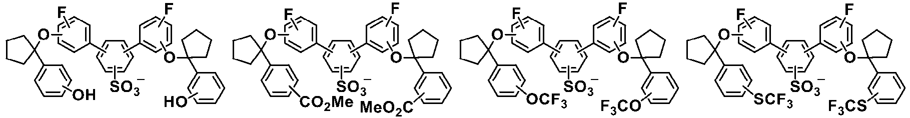

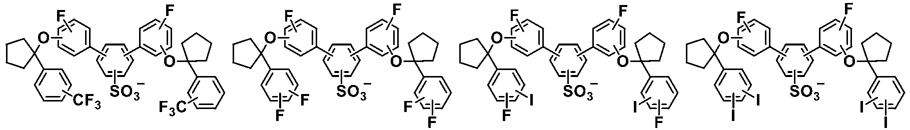

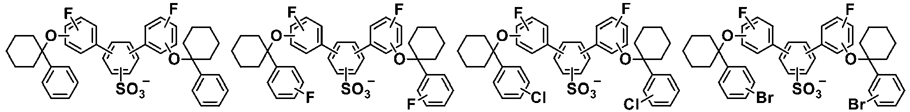

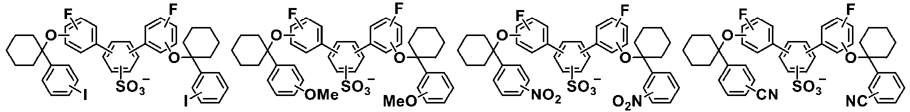

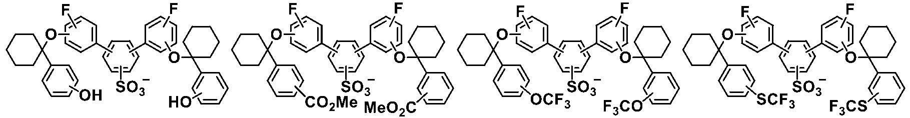

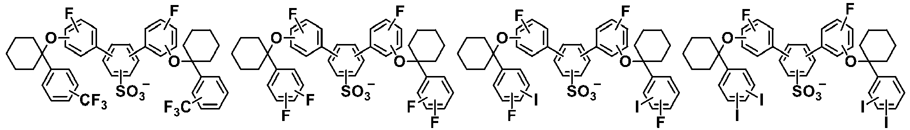

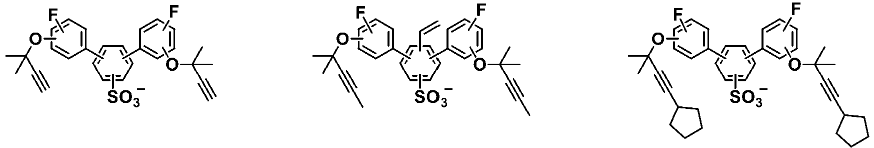

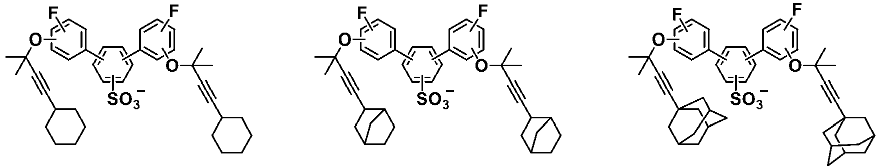

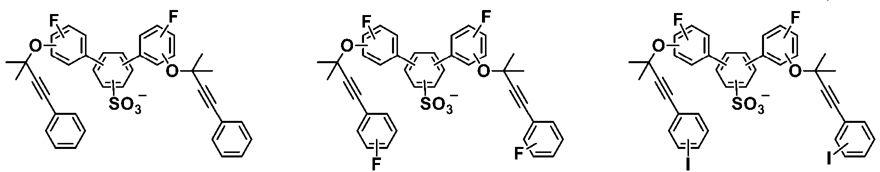

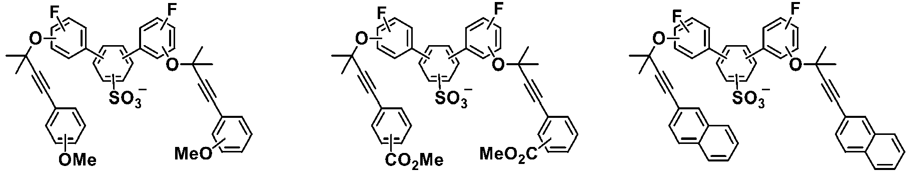

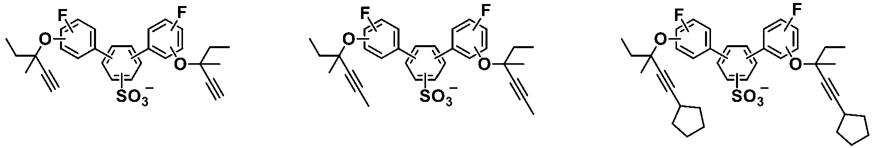

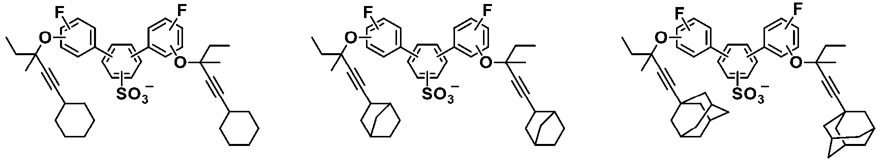

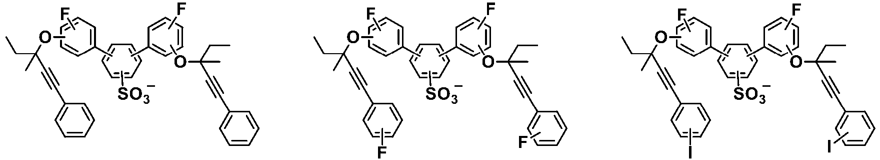

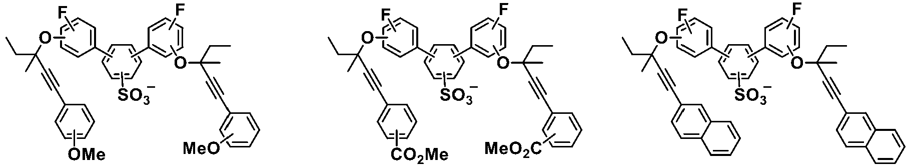

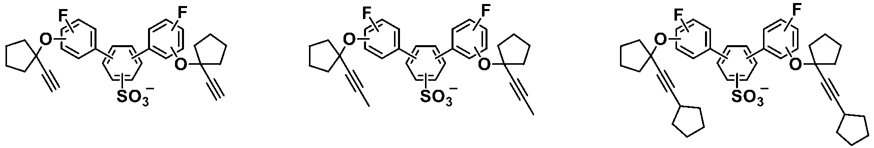

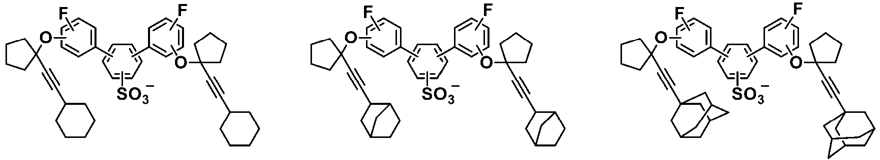

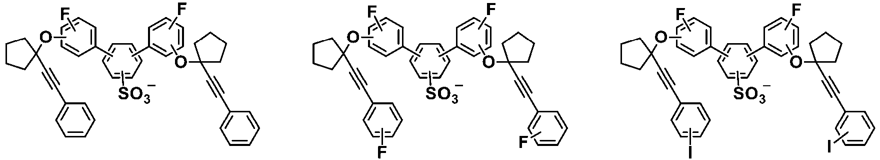

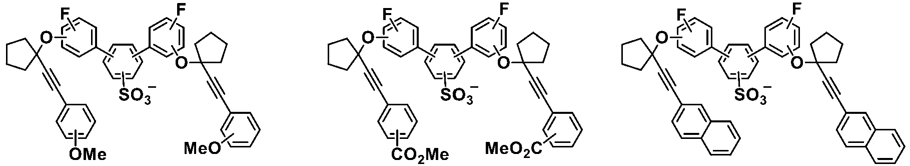

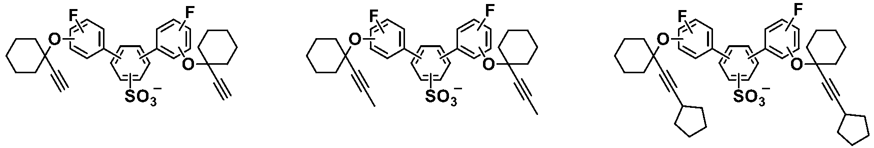

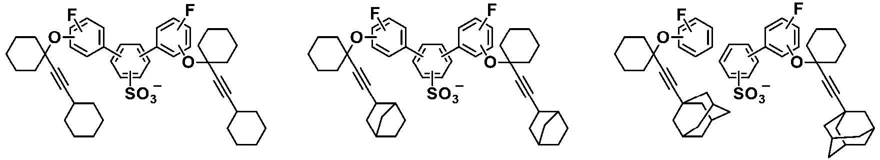

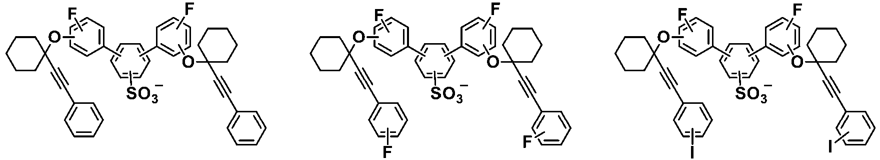

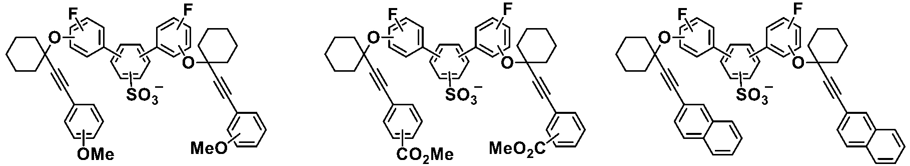

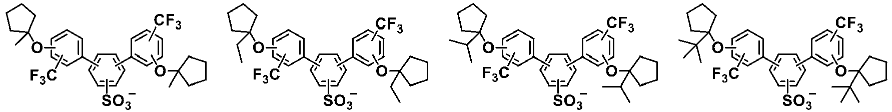

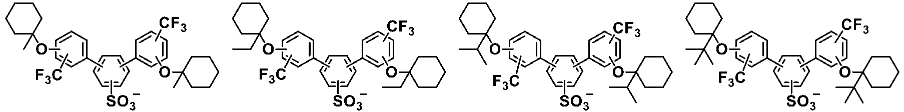

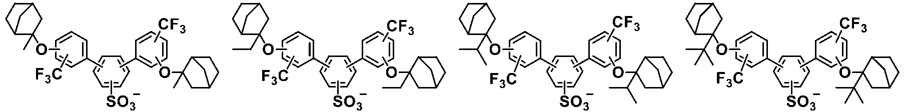

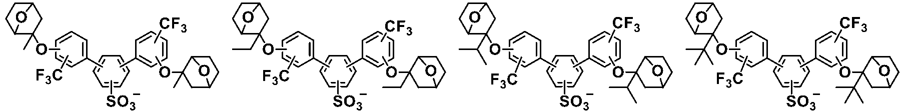

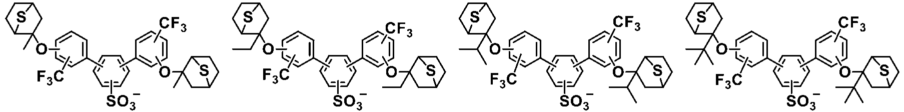

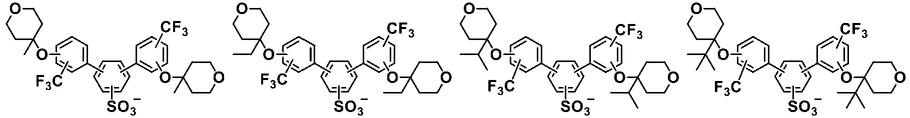

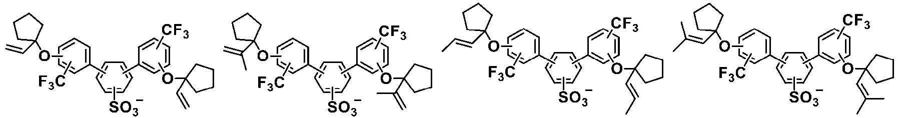

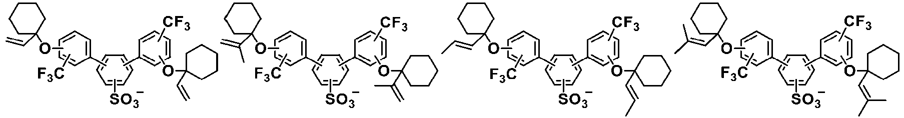

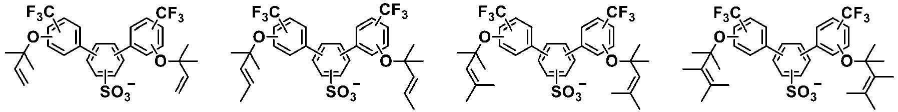

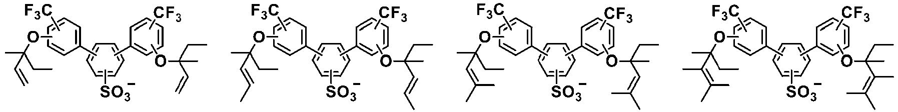

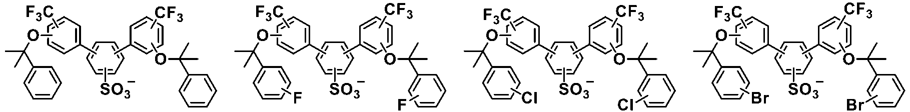

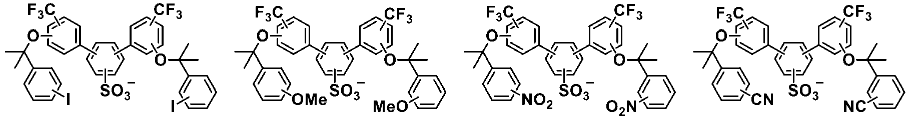

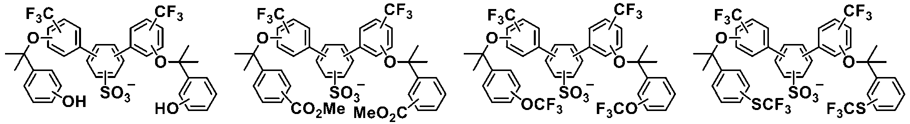

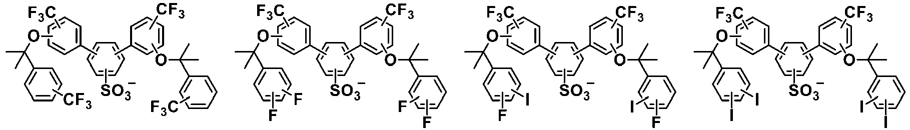

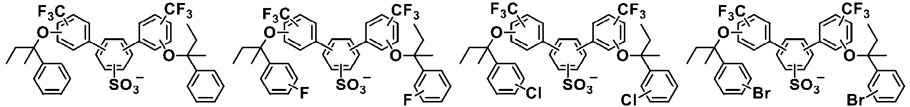

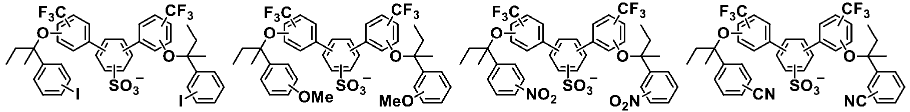

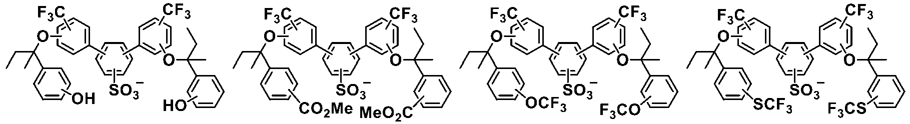

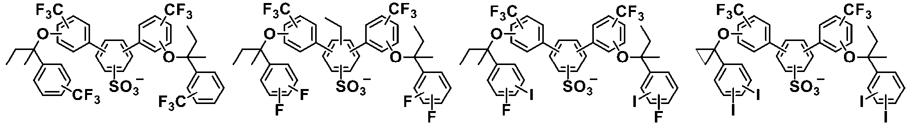

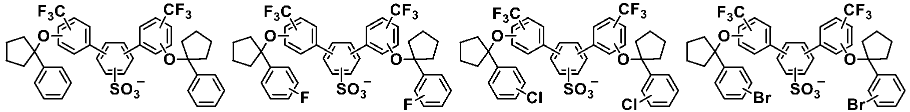

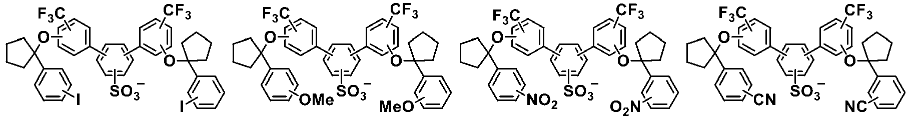

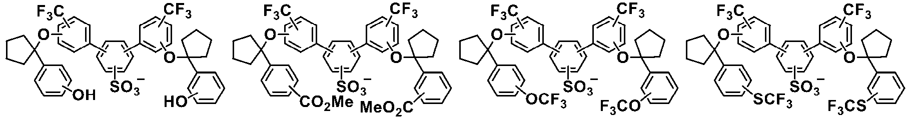

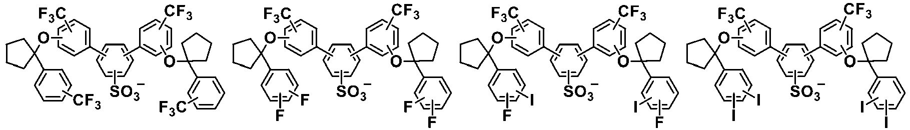

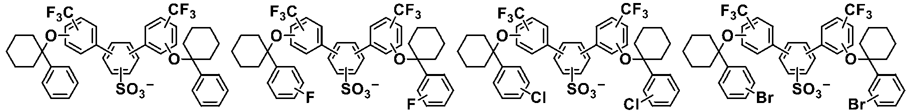

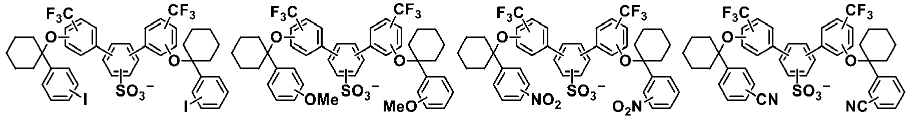

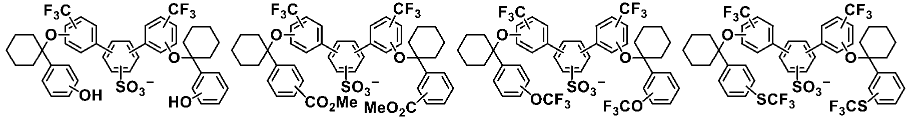

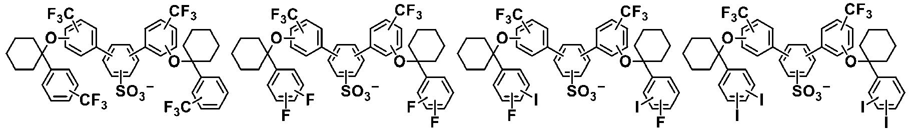

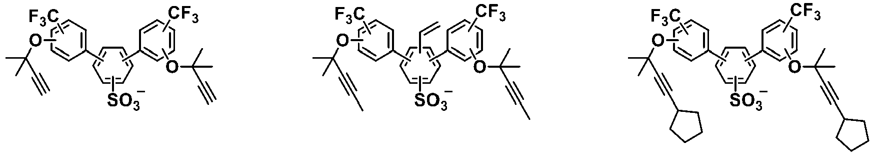

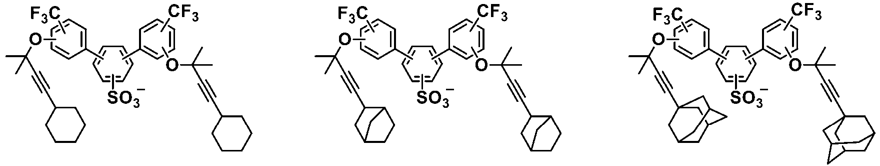

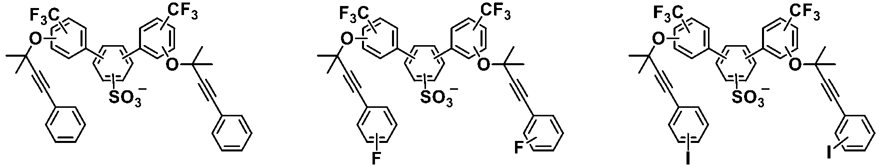

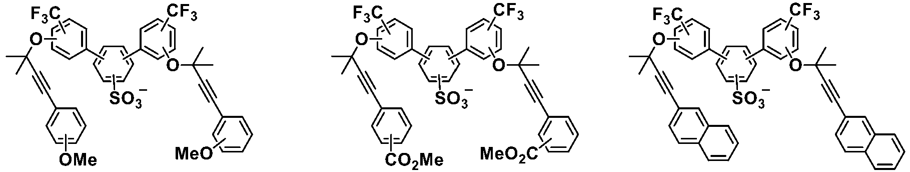

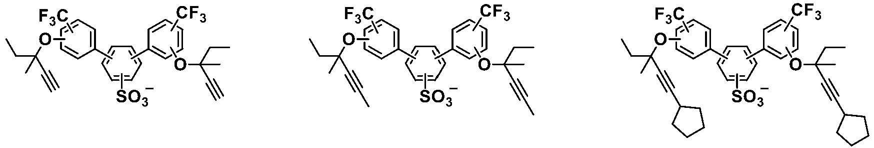

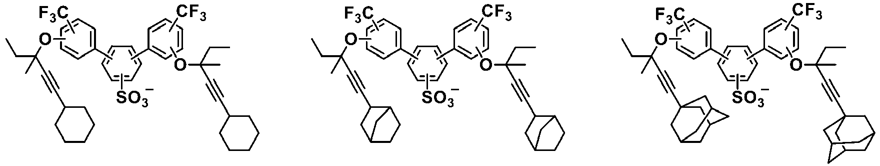

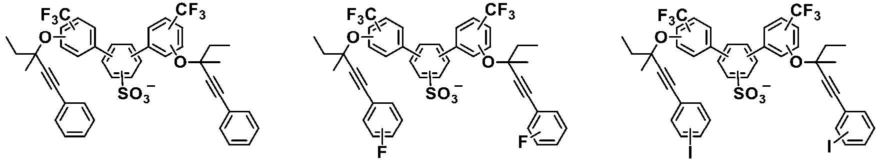

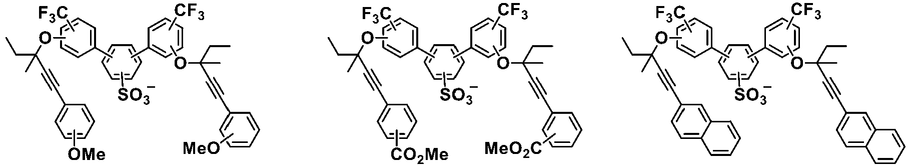

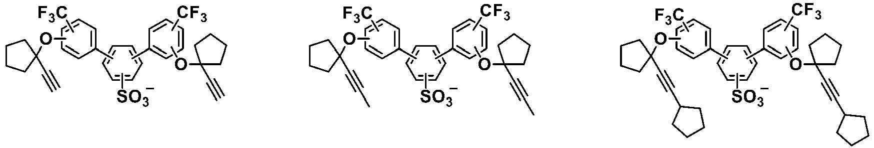

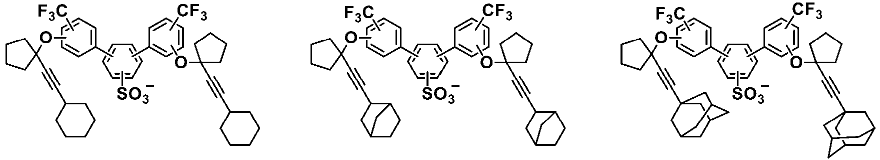

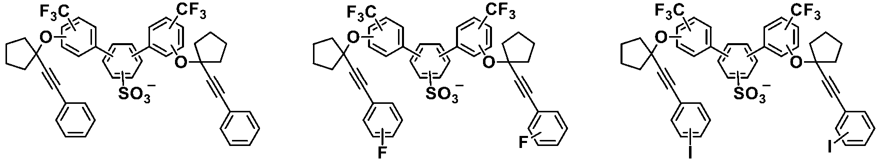

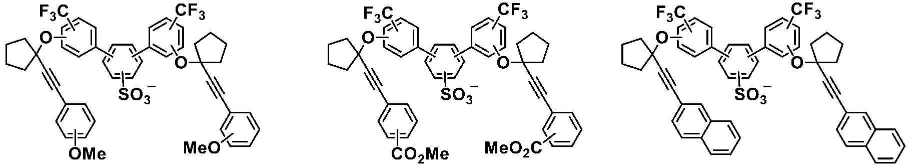

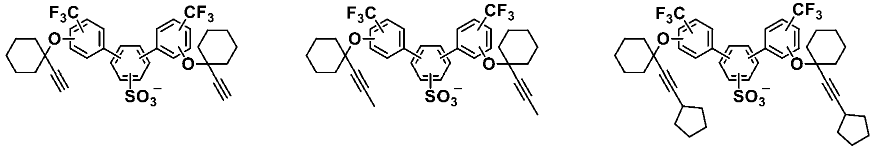

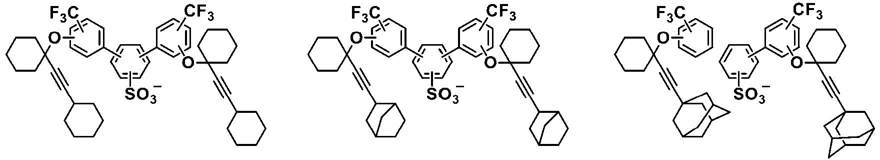

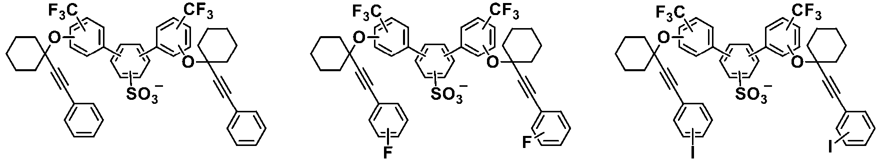

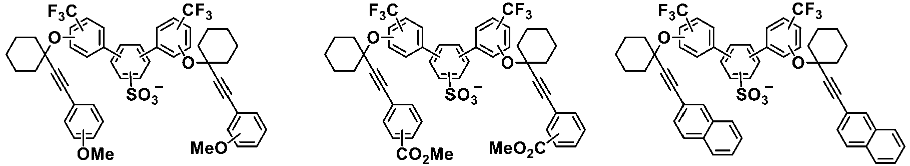

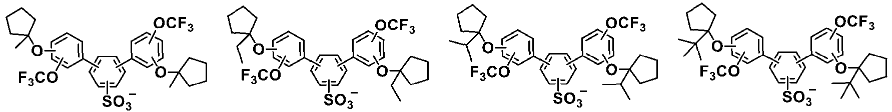

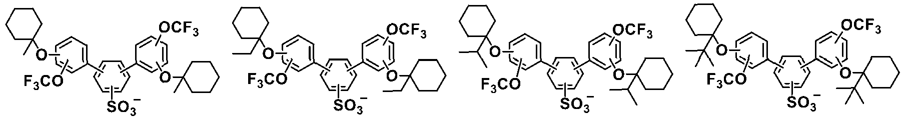

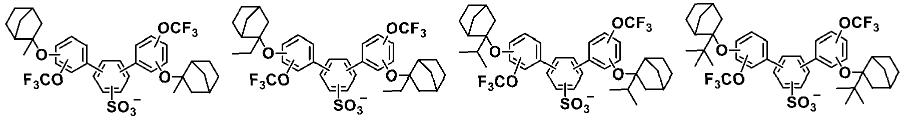

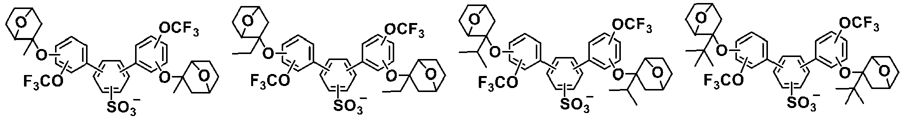

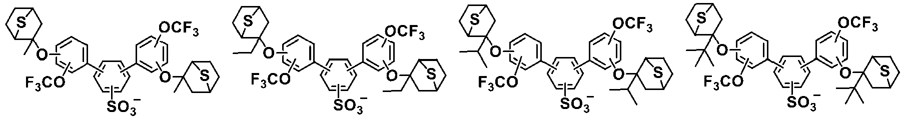

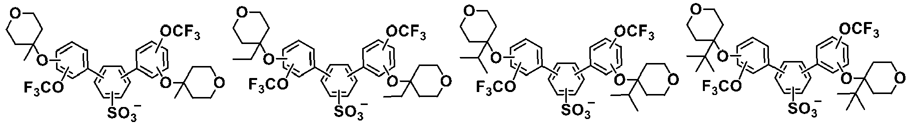

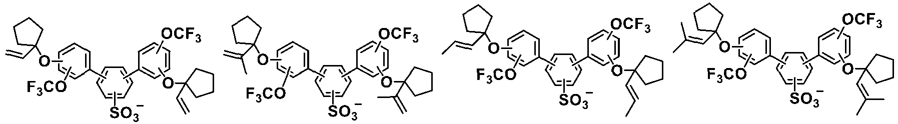

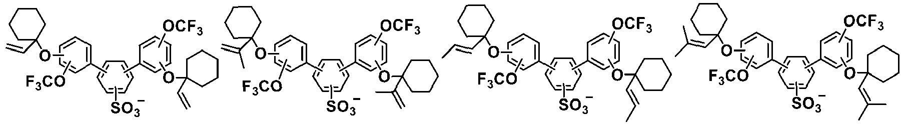

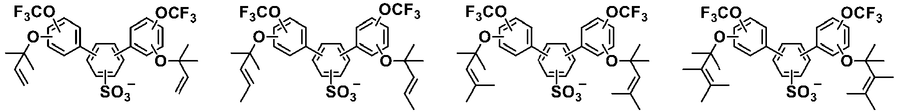

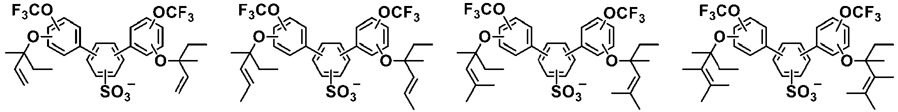

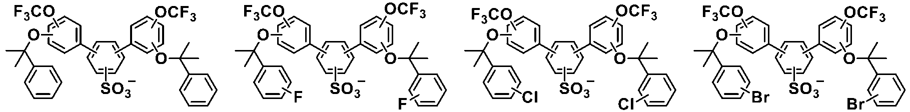

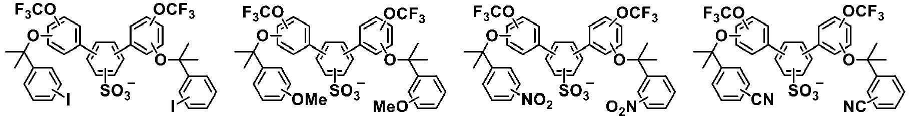

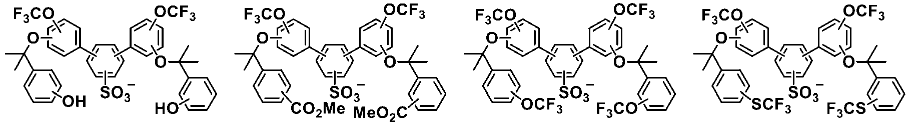

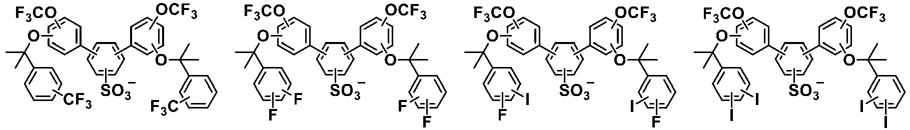

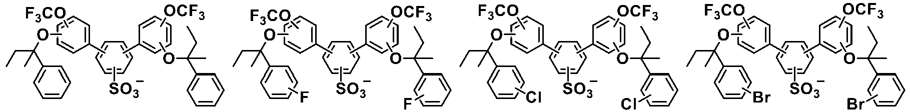

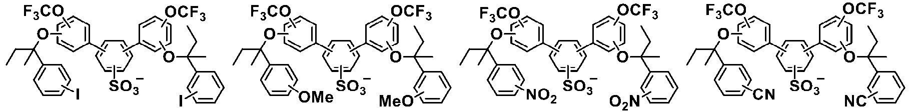

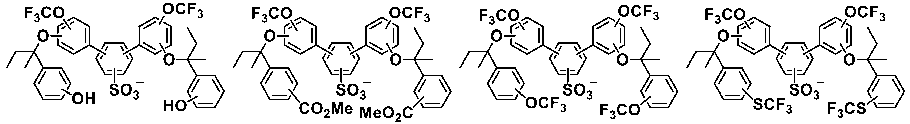

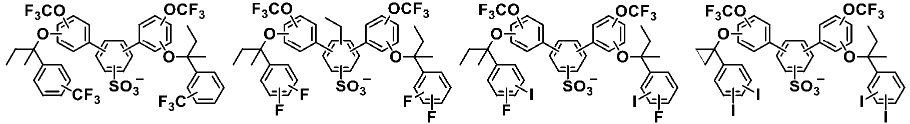

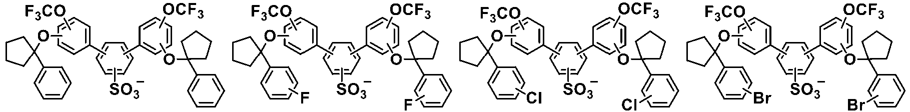

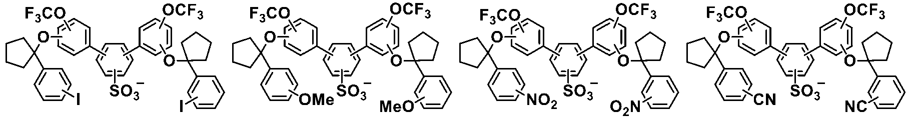

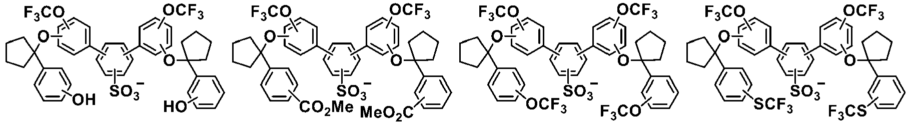

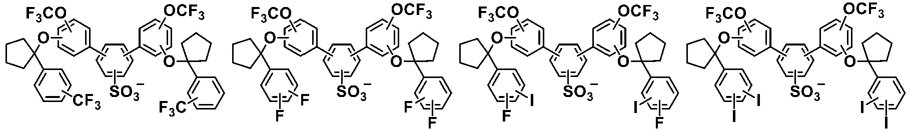

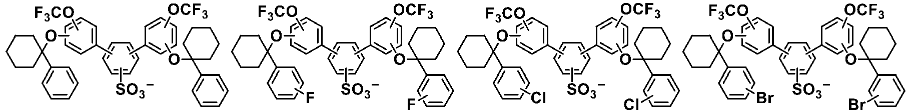

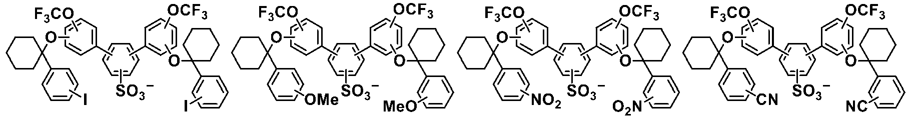

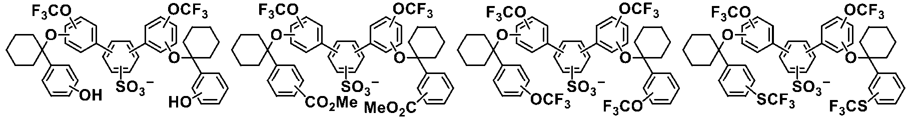

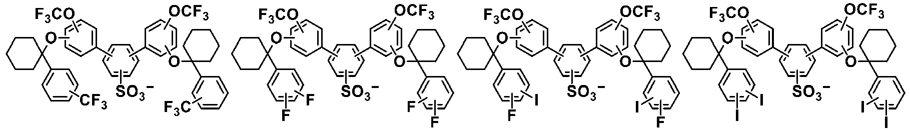

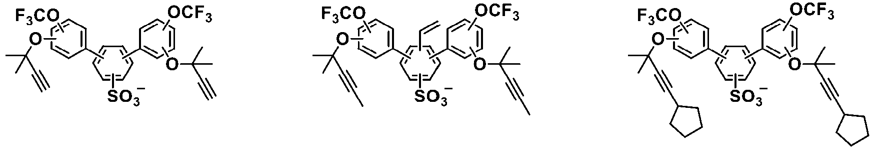

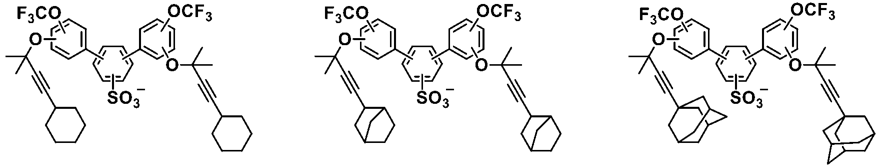

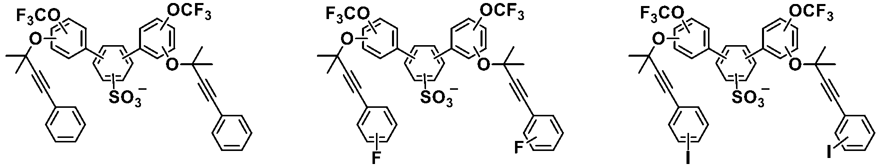

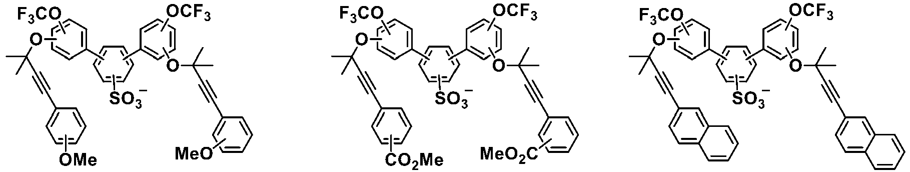

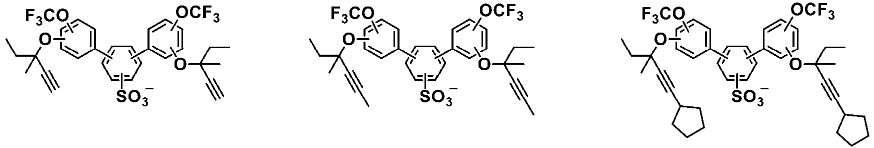

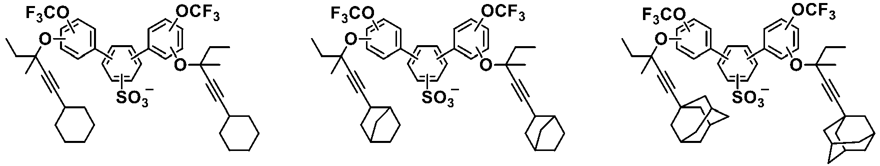

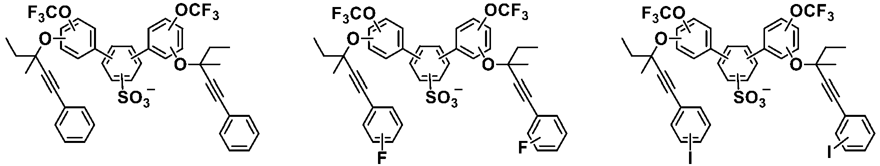

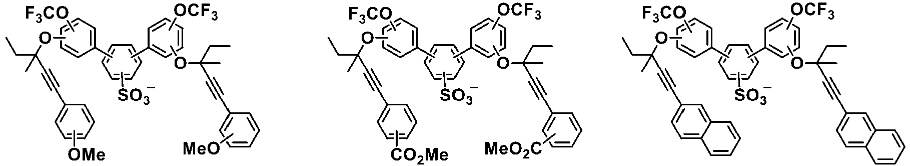

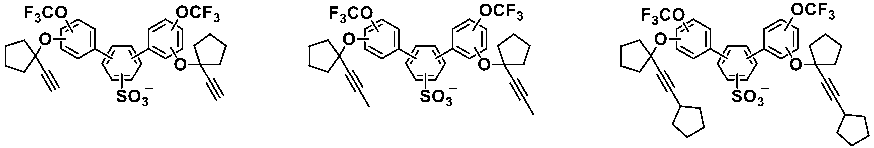

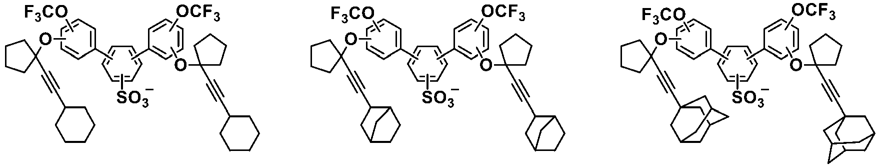

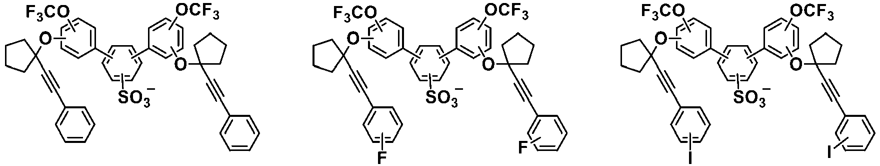

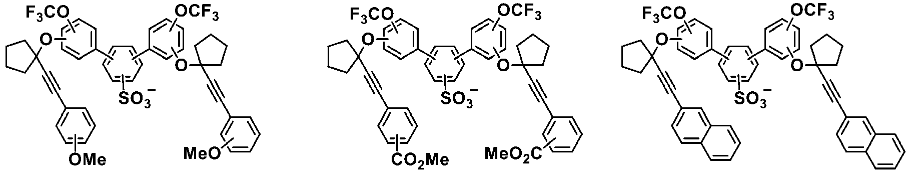

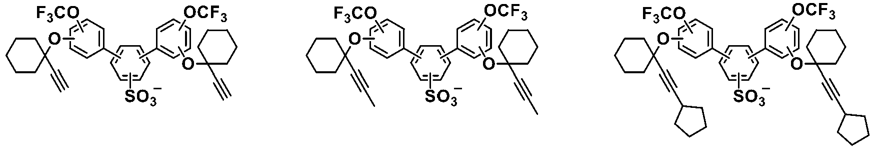

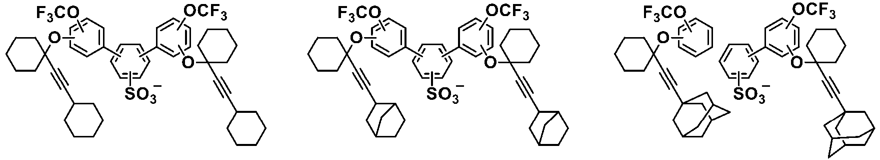

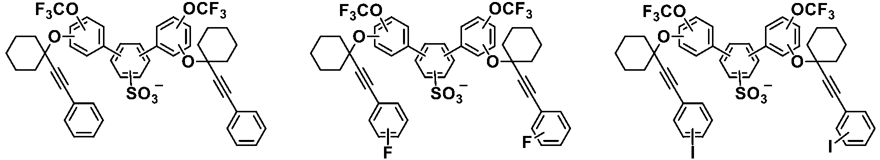

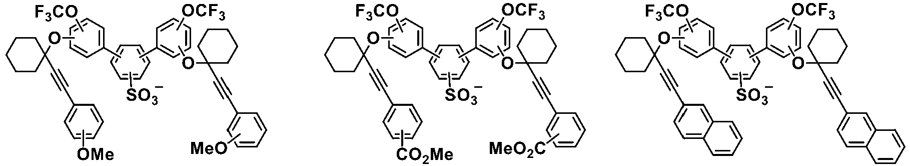

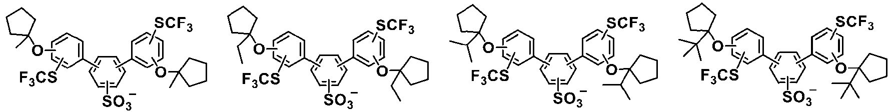

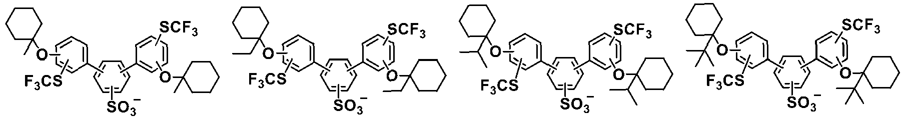

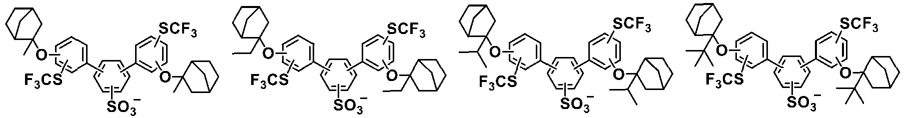

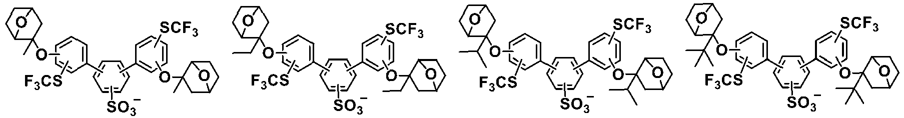

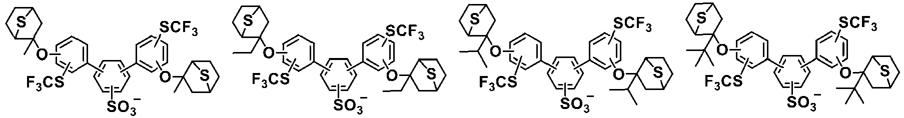

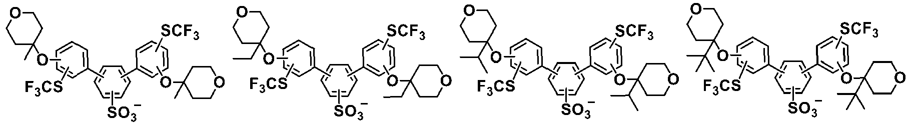

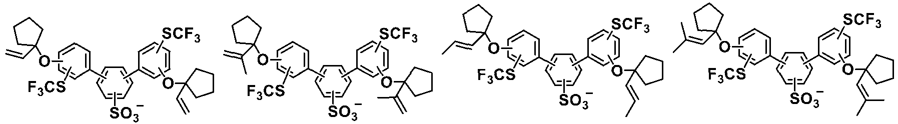

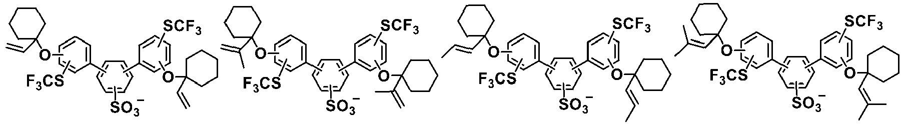

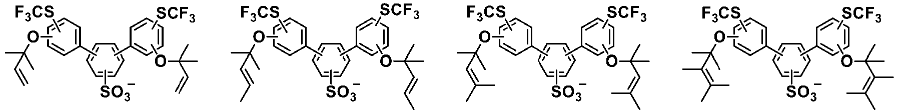

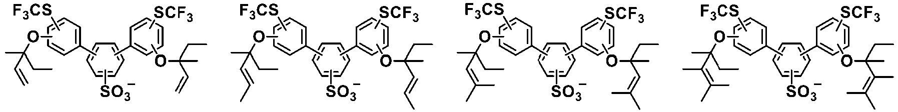

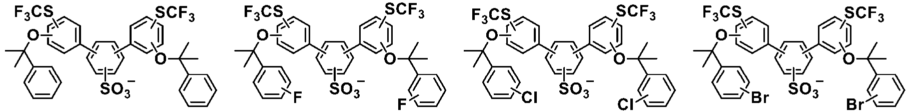

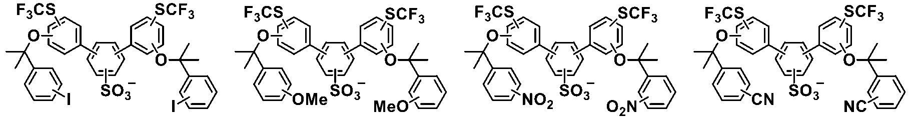

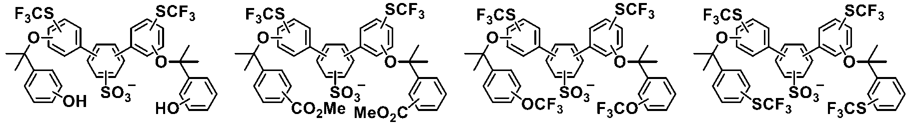

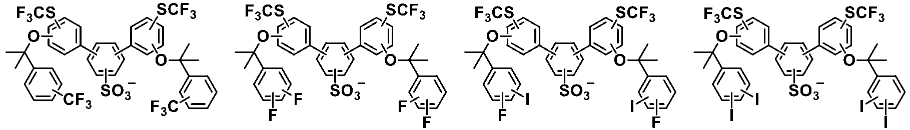

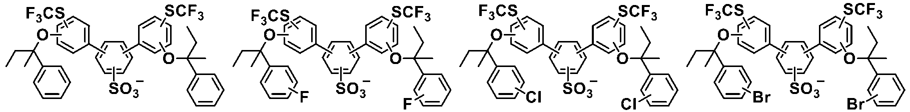

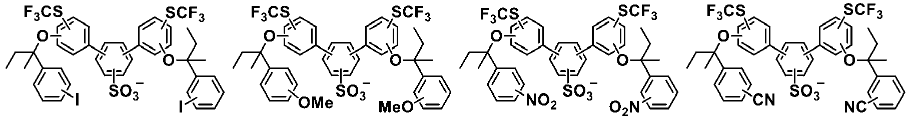

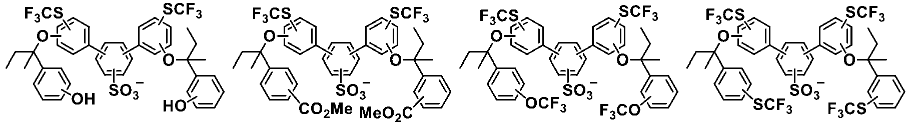

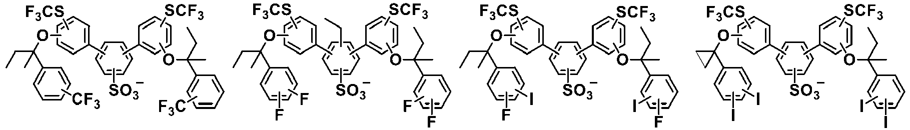

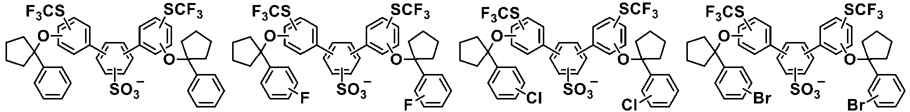

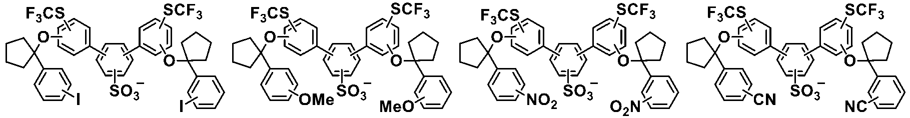

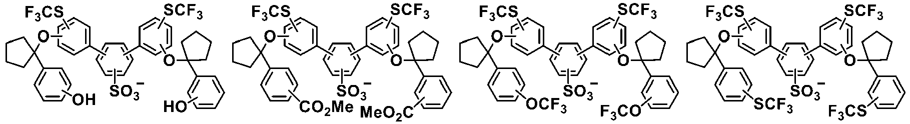

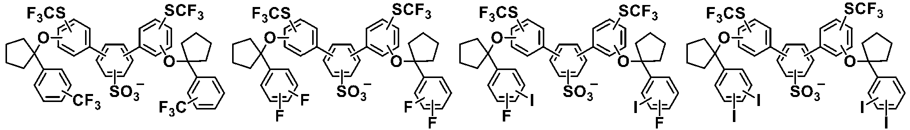

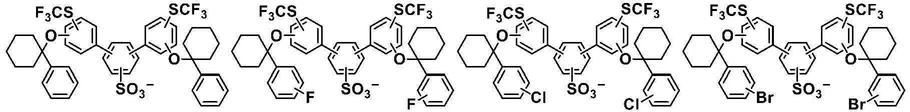

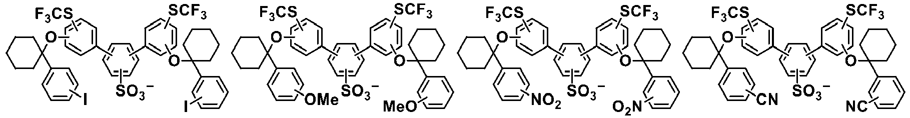

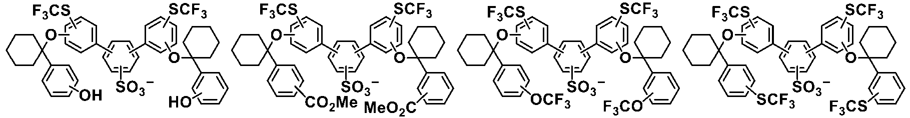

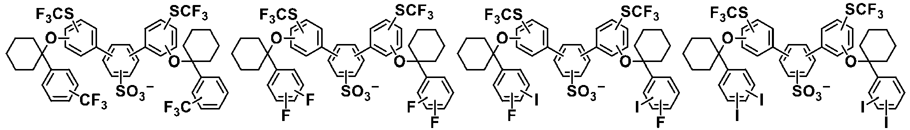

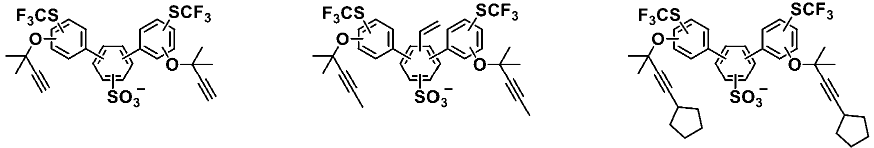

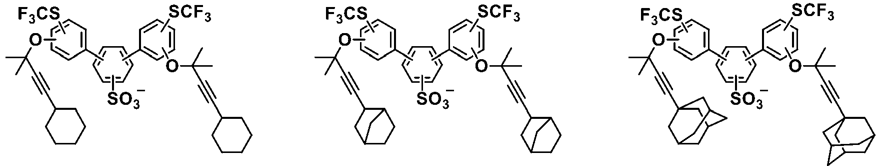

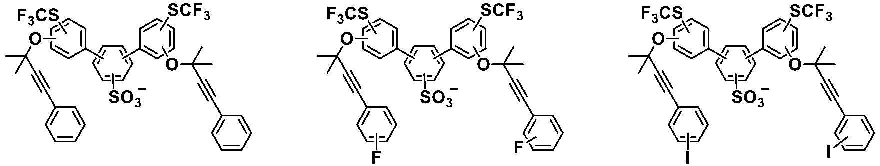

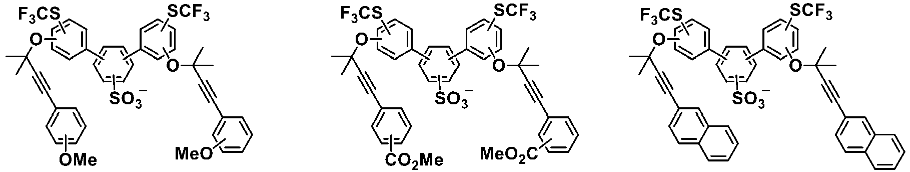

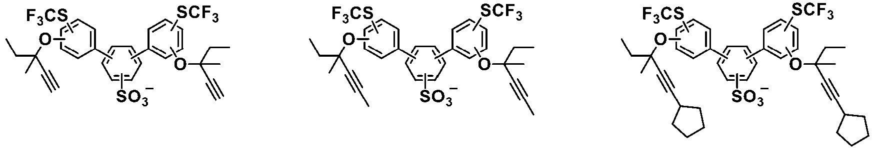

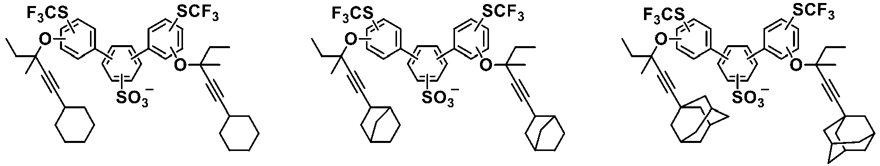

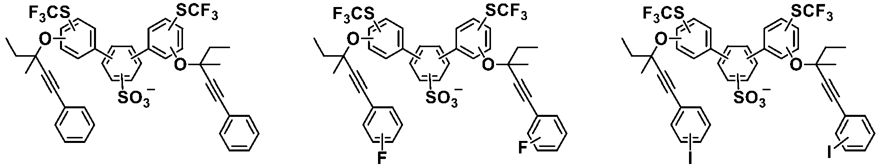

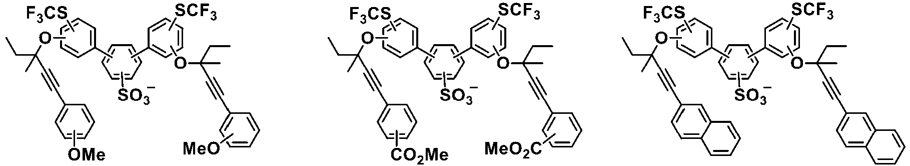

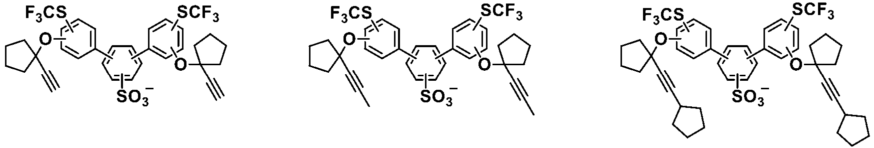

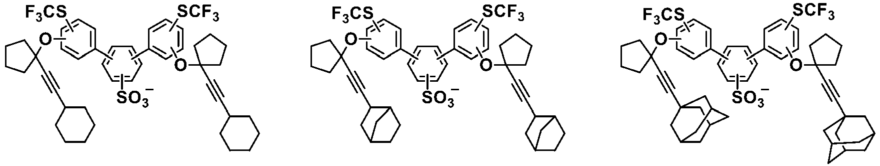

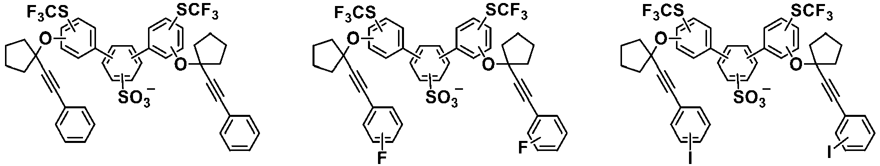

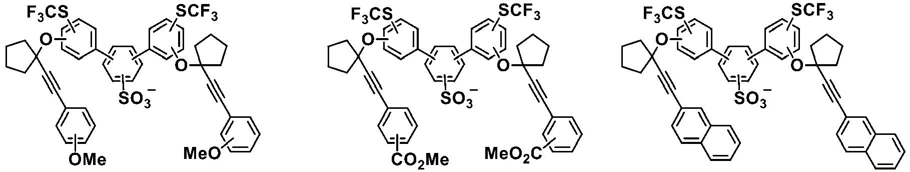

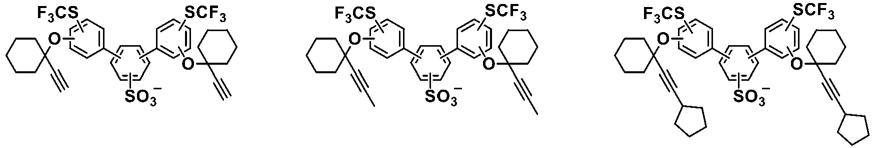

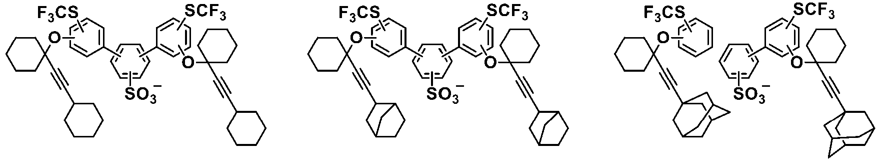

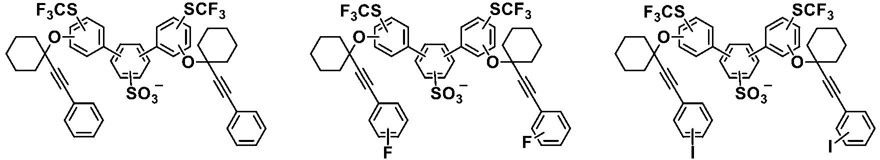

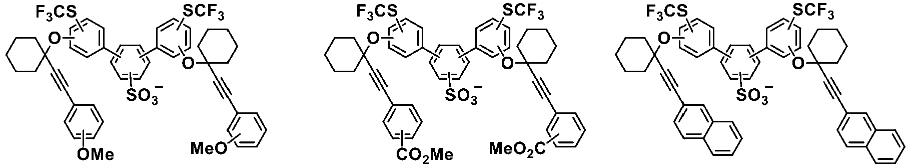

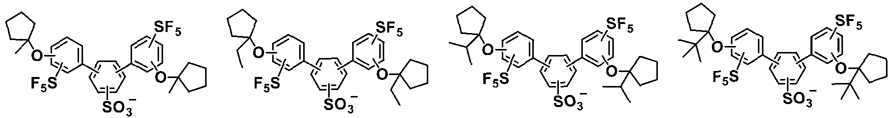

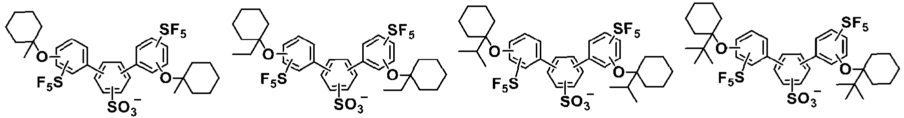

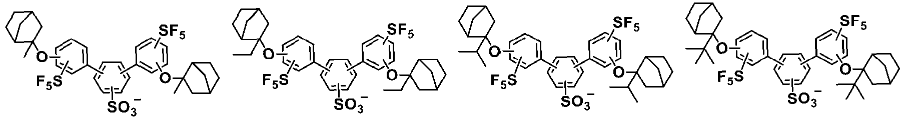

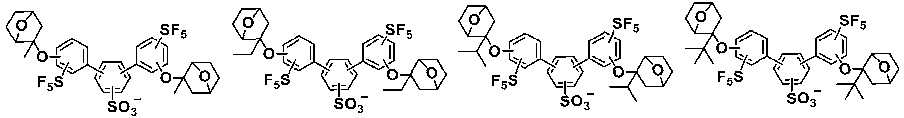

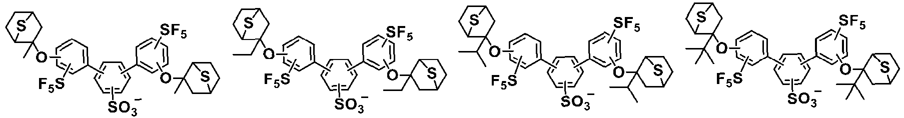

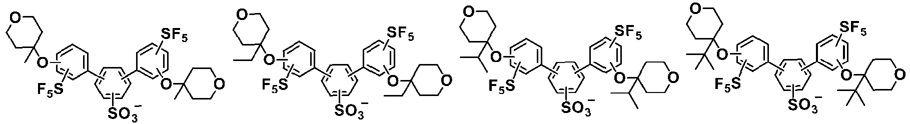

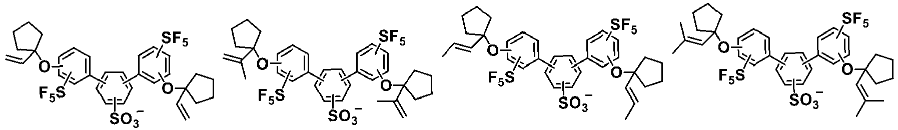

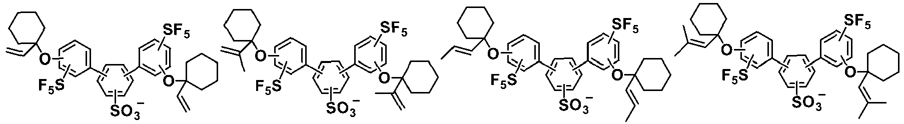

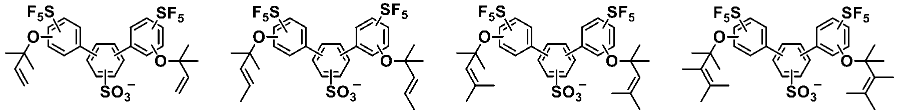

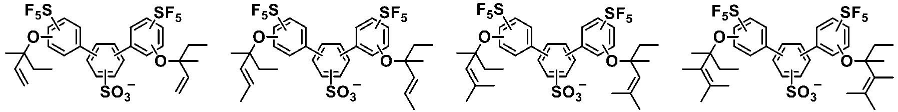

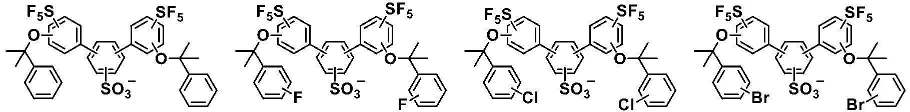

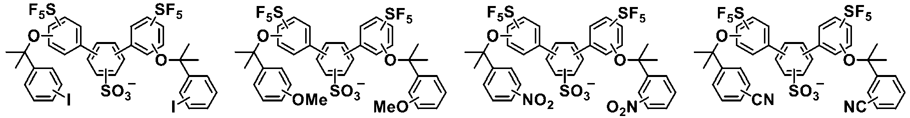

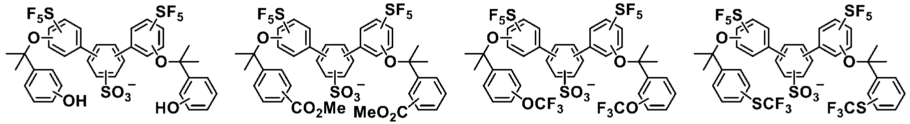

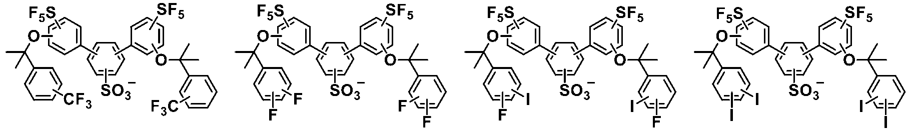

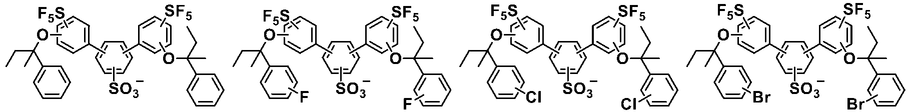

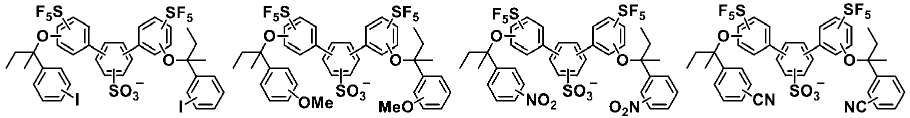

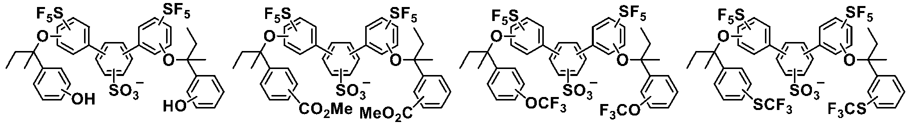

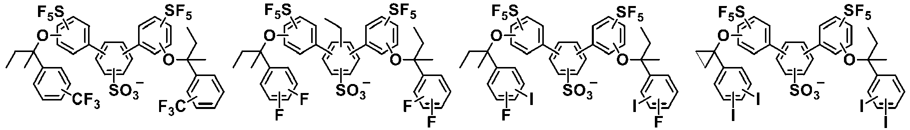

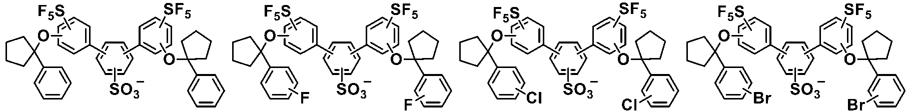

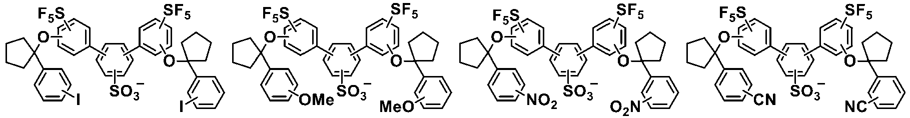

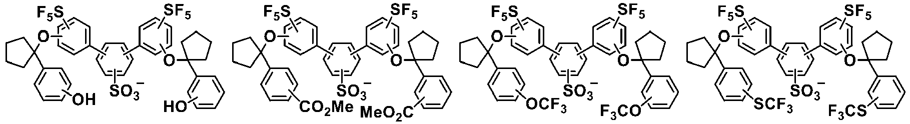

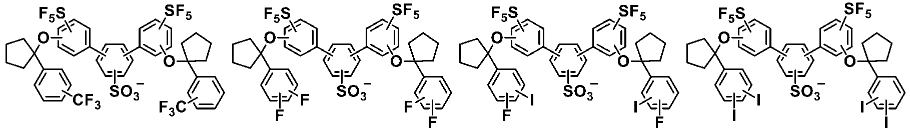

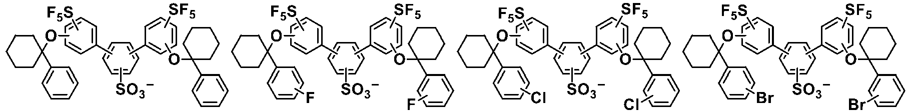

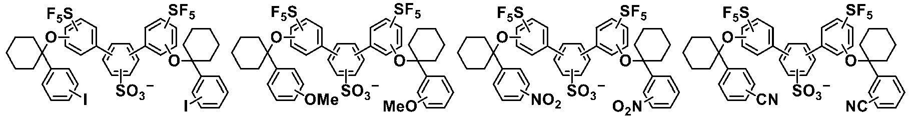

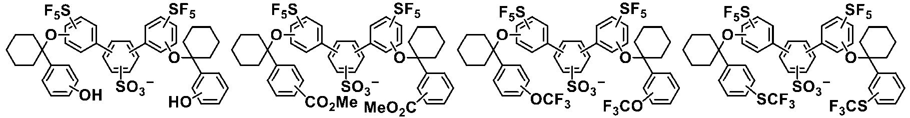

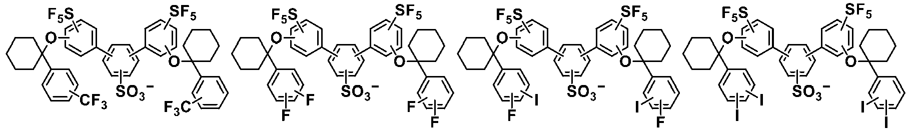

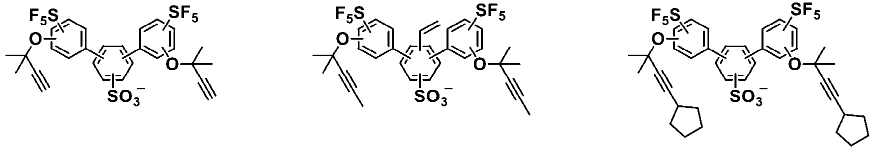

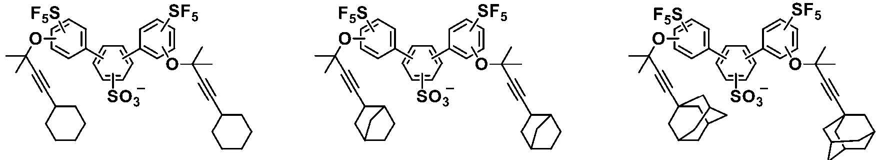

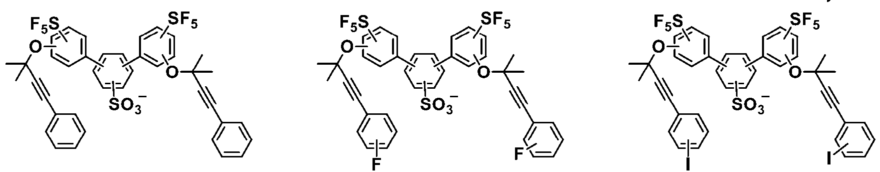

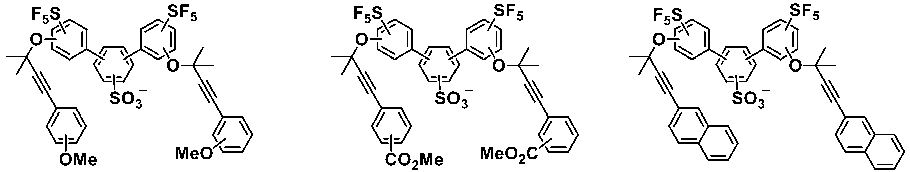

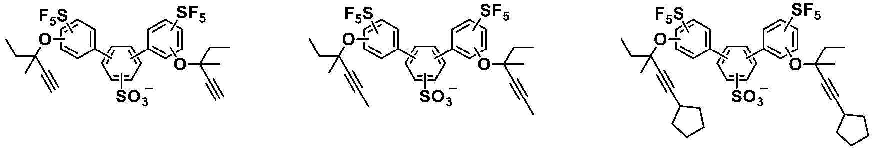

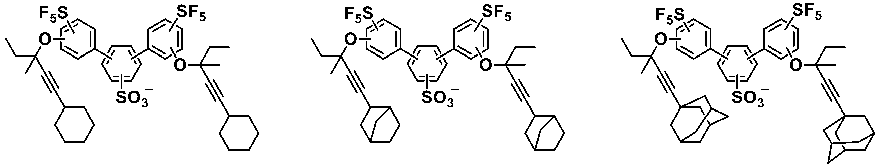

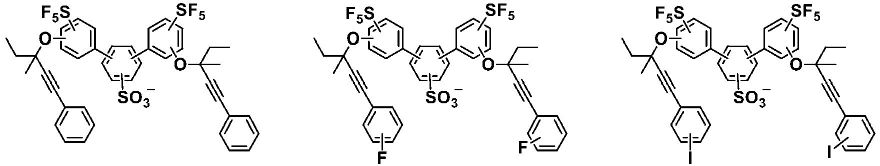

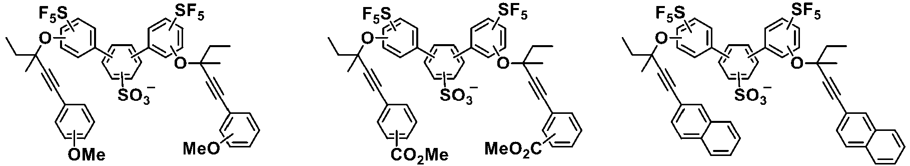

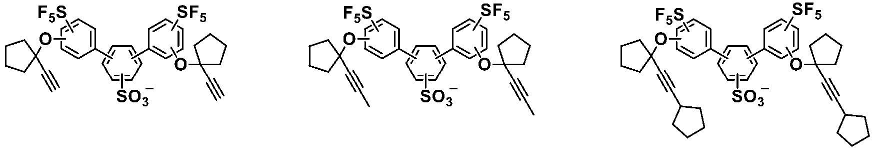

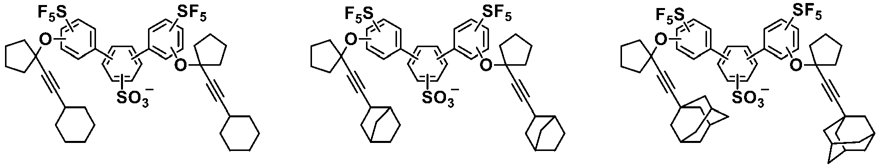

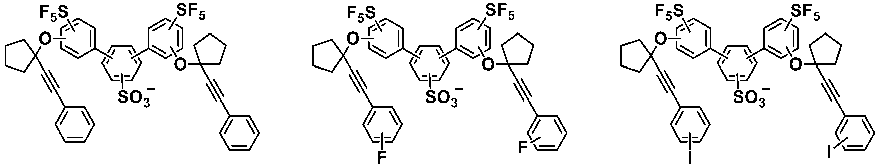

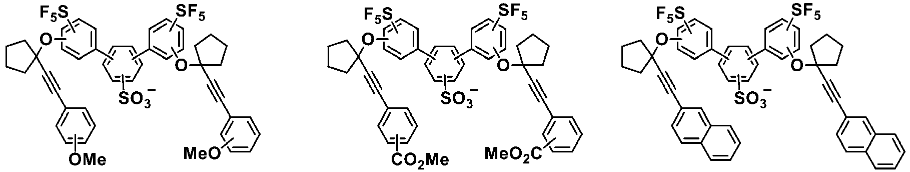

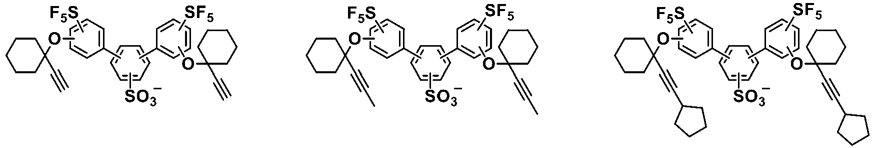

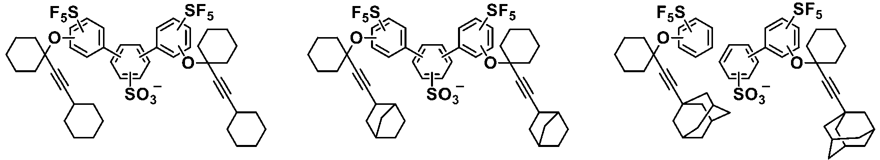

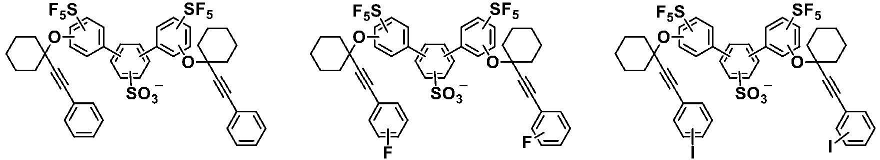

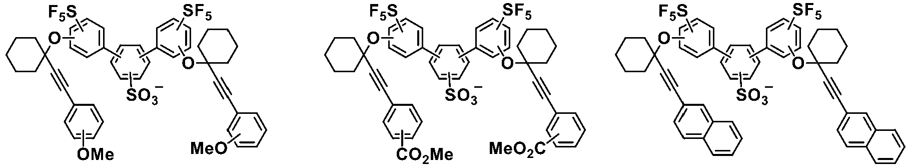

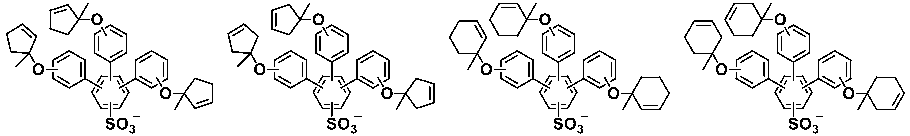

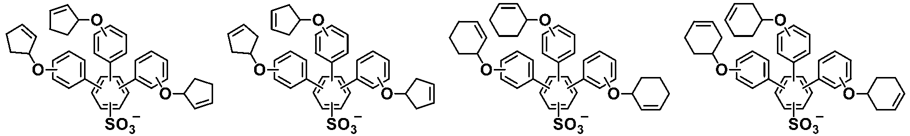

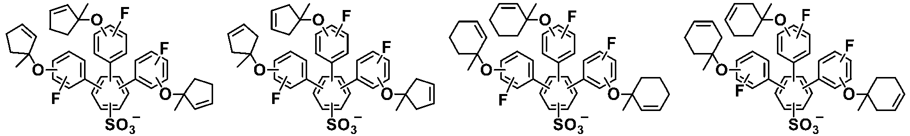

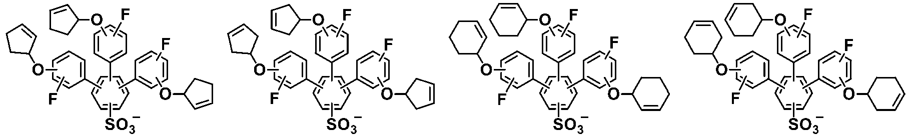

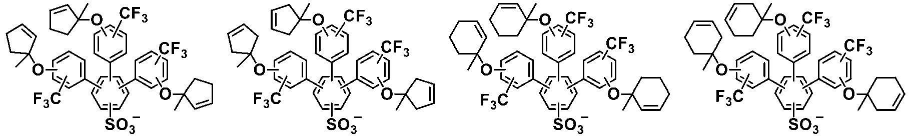

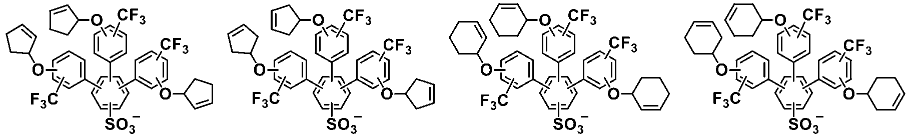

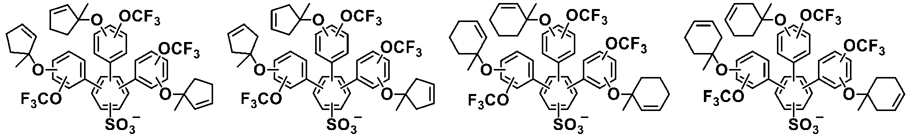

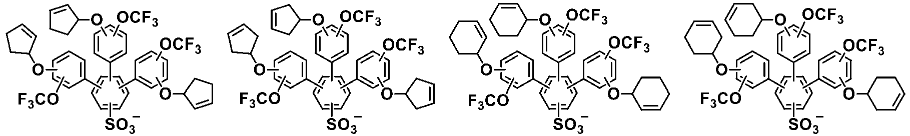

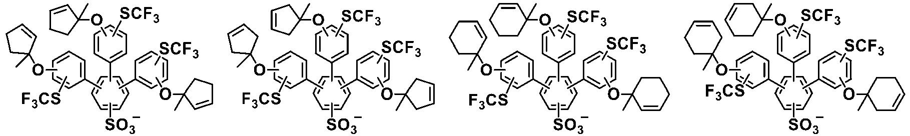

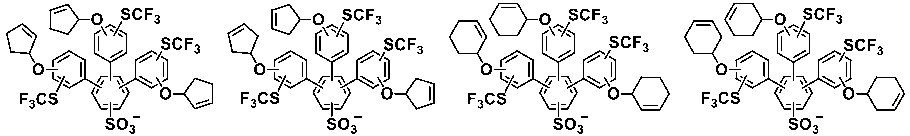

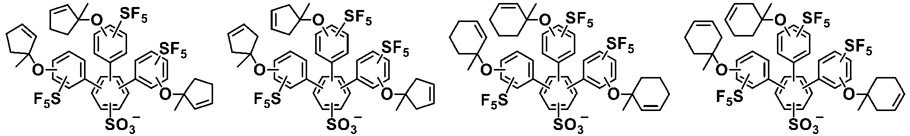

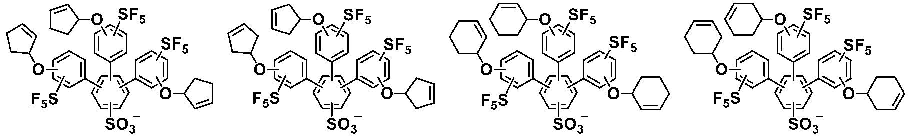

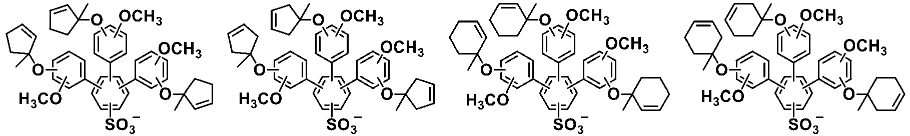

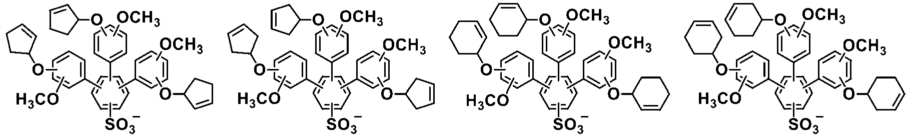

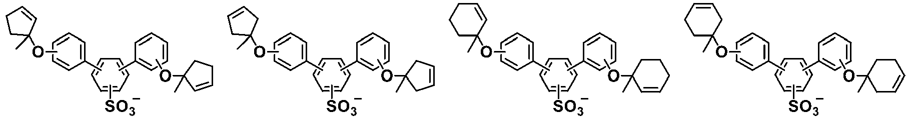

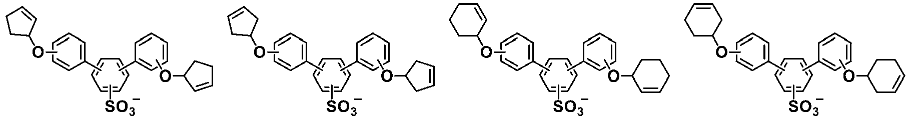

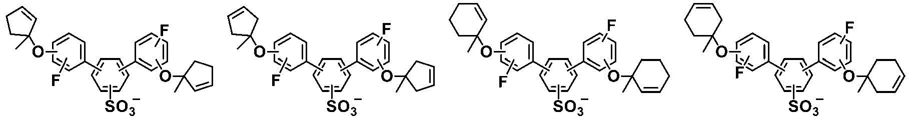

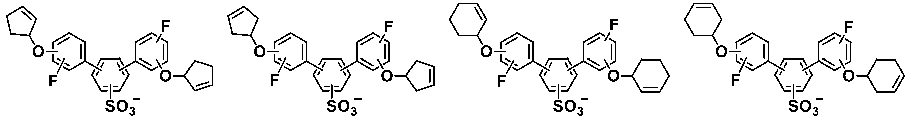

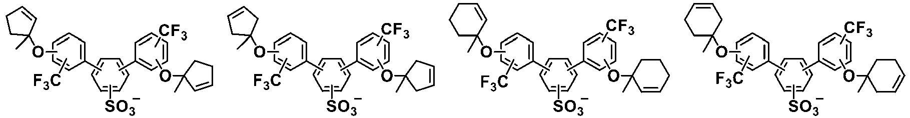

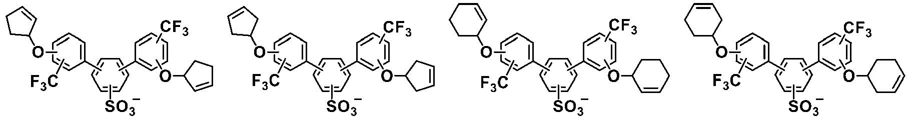

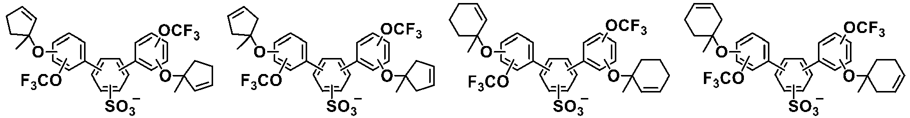

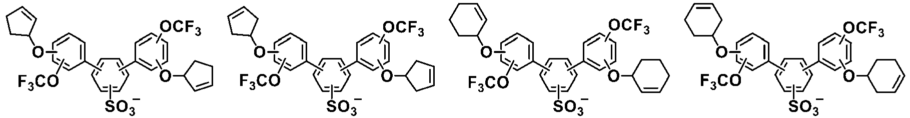

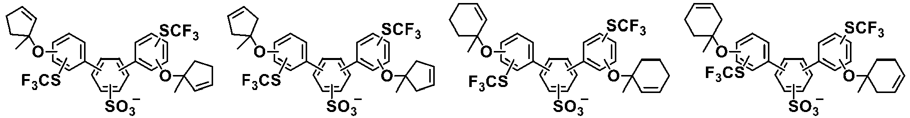

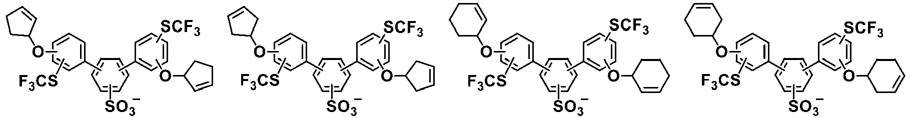

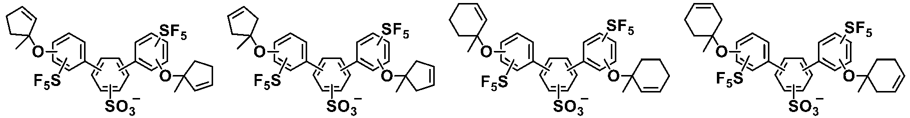

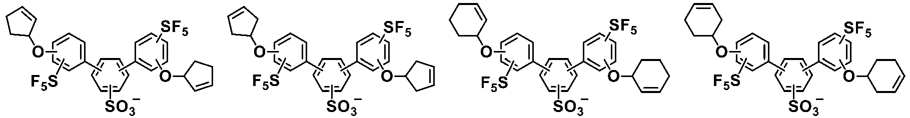

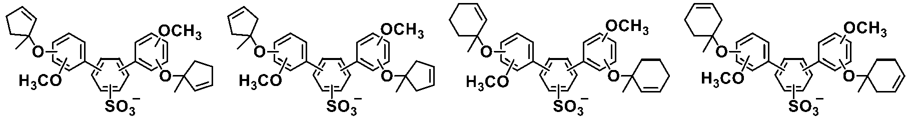

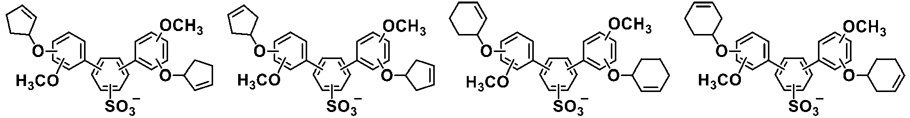

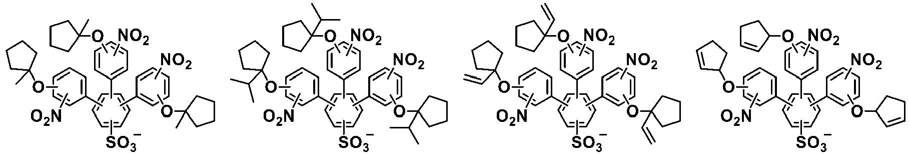

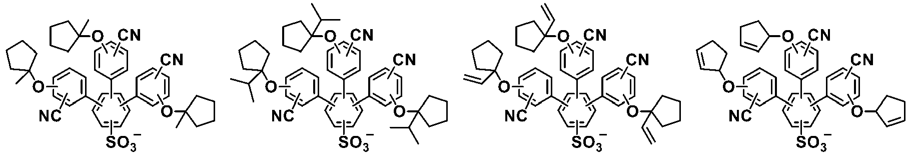

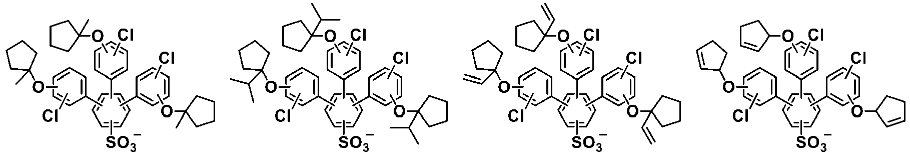

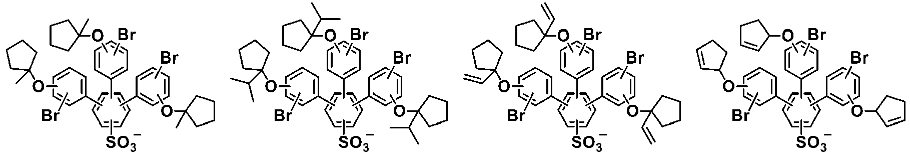

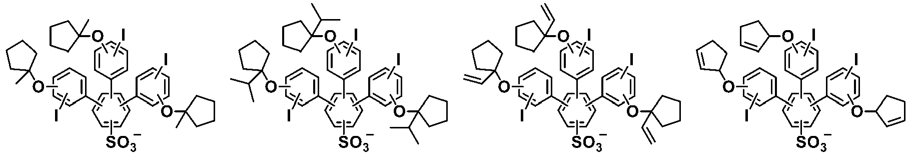

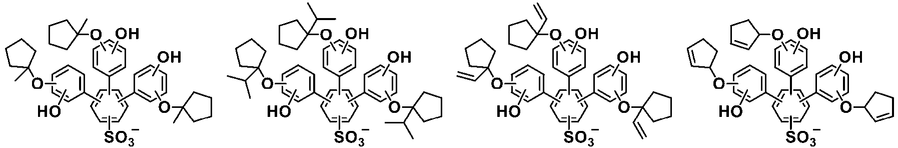

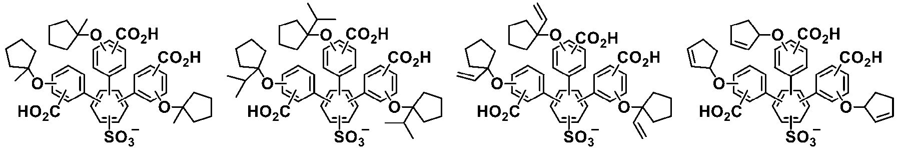

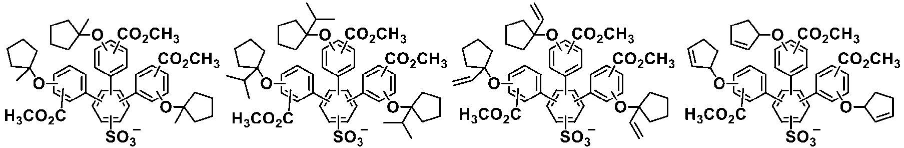

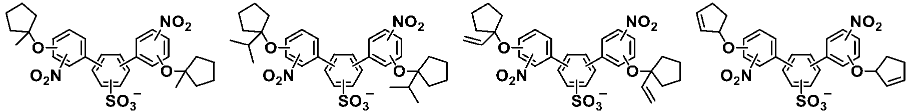

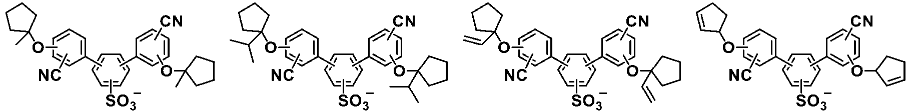

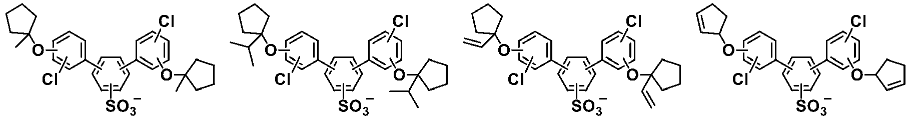

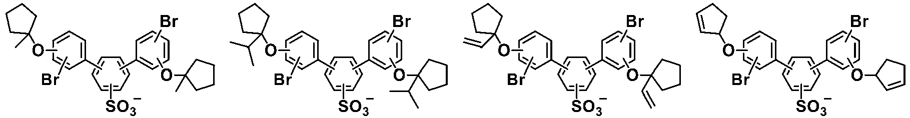

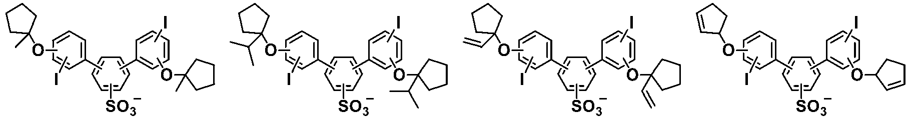

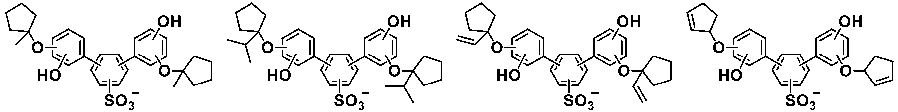

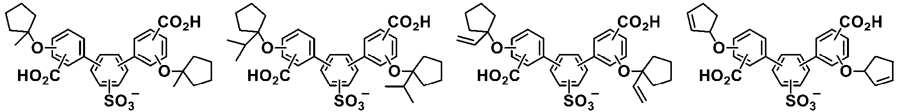

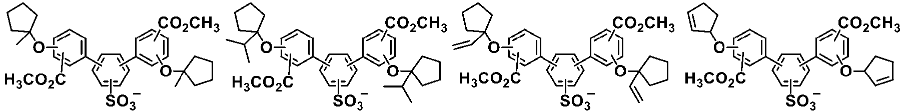

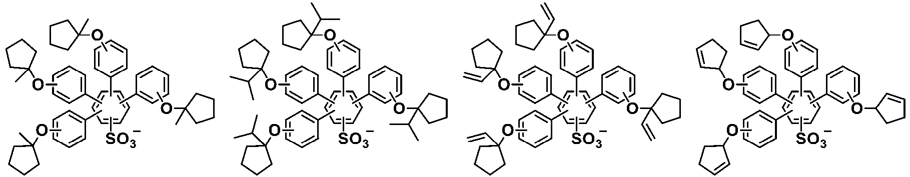

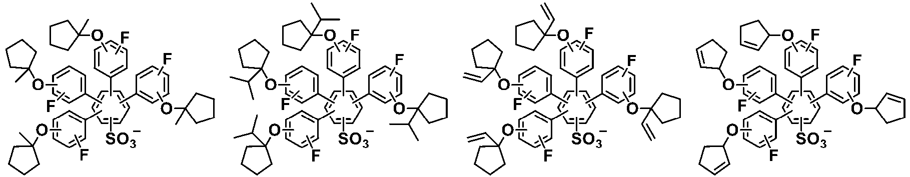

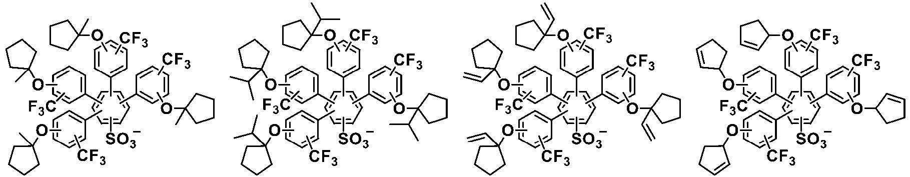

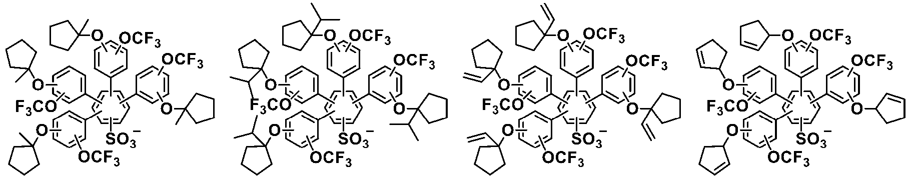

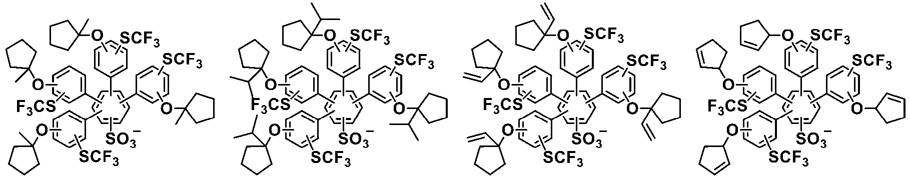

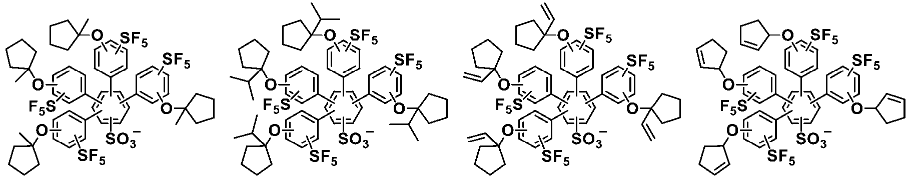

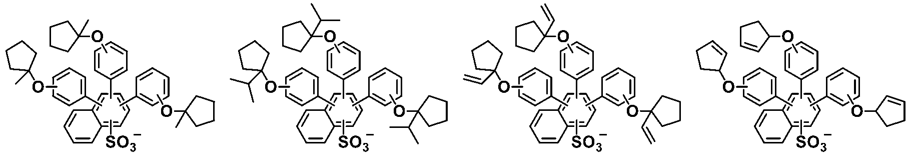

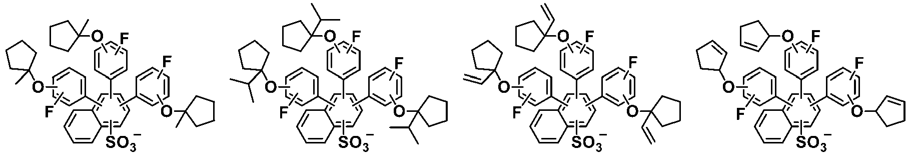

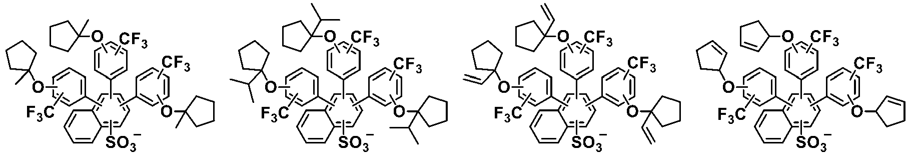

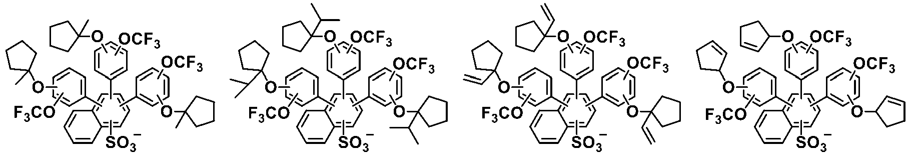

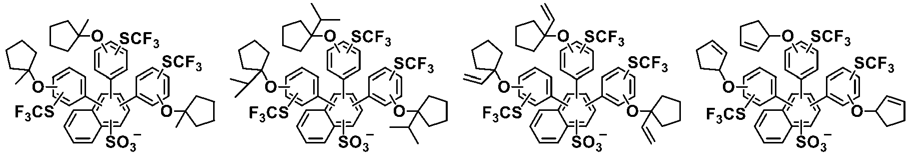

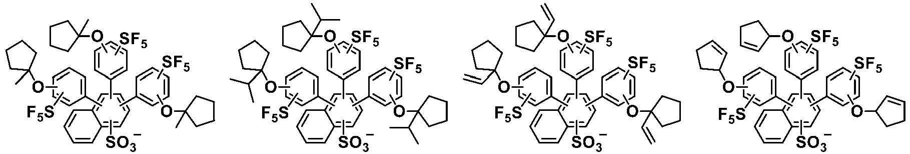

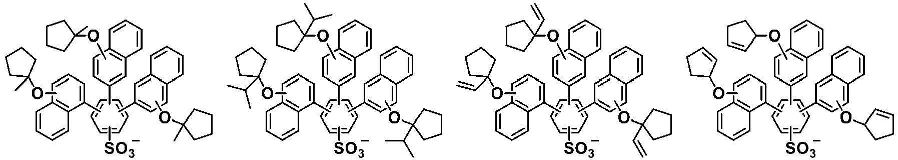

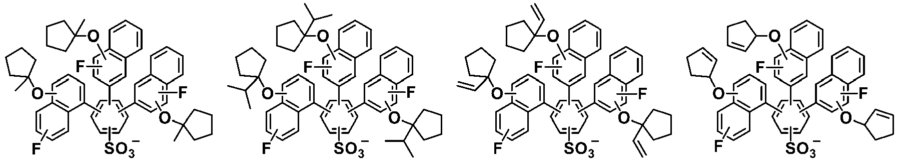

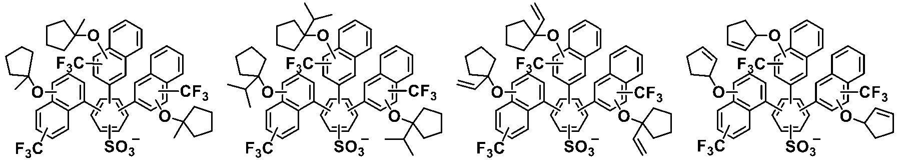

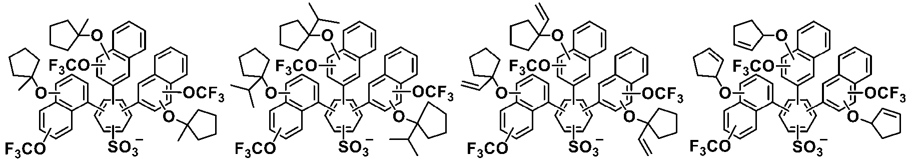

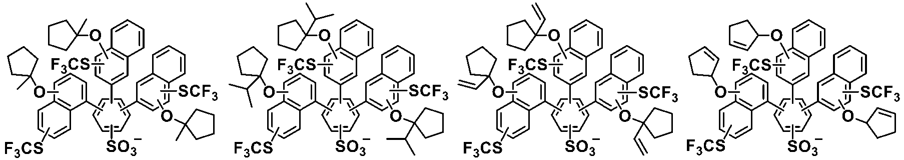

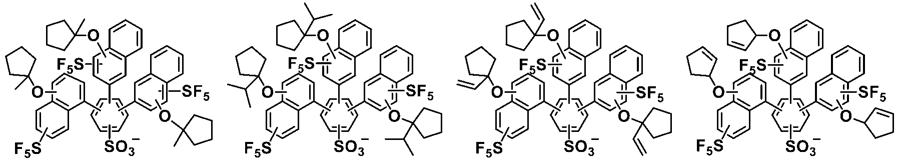

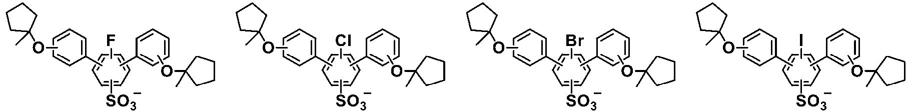

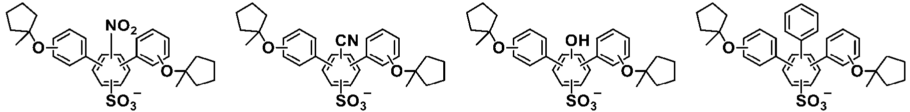

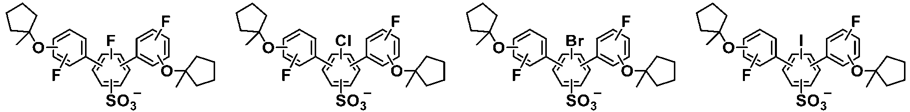

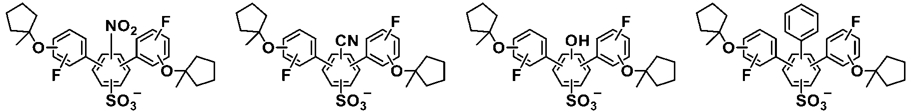

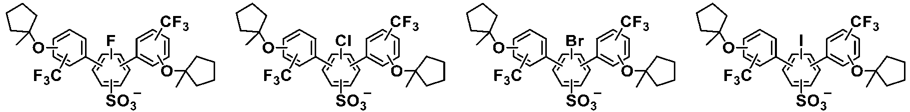

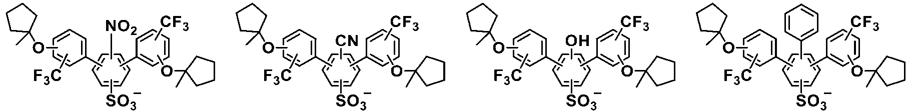

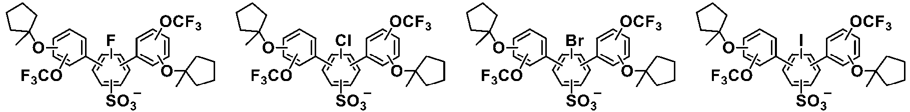

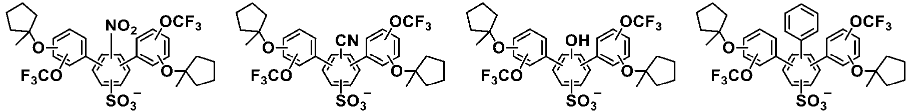

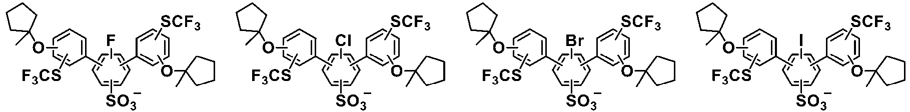

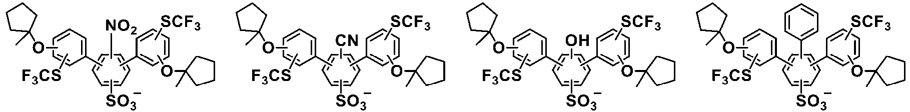

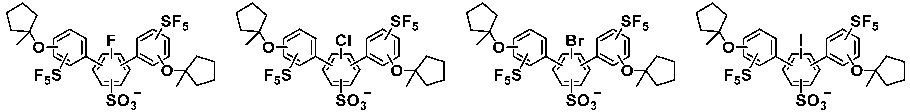

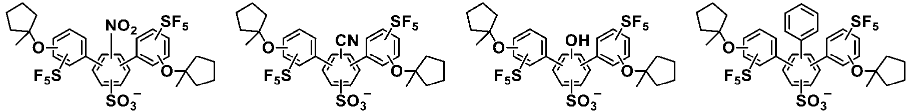

Examples of the sulfonium salt as PAG (A) include arbitrary combinations of anions with cations, both as exemplified above.

The sulfonium salt can be synthesized by well-known methods. For example, reference is made to the synthesis examples described in JP 7032549, paragraphs [0363]-[0368], but the synthesis method is not limited thereto.

The photoacid generator in the chemically amplified positive resist composition is structurally characterized in that it is a sulfonium salt consisting of a triarylsulfonium cation of fused ring form having fluorine or fluorine-containing substituent on an aromatic ring and an aromatic sulfonic acid anion having at least one aromatic ring structure. Since strain is introduced when the triarylsulfonium cation has the fused ring structure in which two aromatic rings are bonded directly or via a linking group, decomposition is promoted in order to release the strain. The linking group linking the aromatic rings is preferably -O-, -S-, -S(=O)-, -SO₂-, -N(H)-, -N(CH₃)- or -C(=O)-. The control of acid diffusion by the formation of a hydrogen bond with proton of the lone pair in the heteroatom is expectable. It is believed that the substitution of fluorine or fluorine-containing substituent on the carbon atom at meta-position relative to the carbon atom to which S+ of the sulfonium cation is bonded exerts an electron-withdrawing effect, by which the energy level of LUMO in the frontier orbit theory for the sulfonium cation is lowered. There is a more likelihood to accept secondary electrons released upon EB exposure. This promotes the decomposition of the sulfonium cation and efficient acid generation, leading to an improvement in the sensitivity of a resist film. It is preferred that the number of fluorine or fluorine-containing substituent per aryl group in the triarylsulfonium cation be 1 or 2. JP-A 2021-151989 describes the structure in which the number of fluorine or fluorine-containing substituent per aryl group in the triarylsulfonium cation is 3. Since the too high electron withdrawal of this structure causes to make the sulfonium cation unstable, partial decomposition occurs in the course of synthesis of the sulfonium cation. Since the inventive sulfonium salt is an onium salt of aromatic sulfonic acid, an acid having an adequate strength can be generated upon exposure to high-energy radiation. Also preferably, the anion has at least one hydrocarbyl group containing iodine atom or cyclic structure on an aromatic ring other than the aromatic sulfonic acid site in the anion. Then the hydrocarbyl group acts as a bulky substituent having a large excluded volume, and fully restrains the diffusion of generated acid. Because of resistance to alkaline developer, the film thickness loss of a pattern in unexposed region is reduced. Further preferably, the anion has an acid labile group because it is expectable that the deprotection reaction of the acid labile group after exposure leads to an increase in dissolution contrast and hence, an improvement in resolution. Also, a plurality of aromatic rings in the anion contribute to improved compatibility due to their interaction (π-π stacking interaction) with aromatic rings in the base polymer, and an effect of restraining excessive acid diffusion is expectable. Owing to these effects, an acid with adequate strength and controlled diffusion is generated and distributed in the resist film uniformly. Then, a chemically amplified positive resist composition comprising the inventive sulfonium salt can form small-size patterns with satisfactory resolution and reduced LER. When the positive resist composition is developed in an alkaline developer, patterns of rectangular profile are formed due to adequate dissolution inhibition.

In the chemically amplified positive resist composition, the amount of the PAG (A) is preferably 0.1 to 40 parts by weight, more preferably 1 to 20 parts by weight per 80 parts by weight of a base polymer (B) to be described just below. As long as the amount of PAG (A) is in the range, an acid is generated in an amount necessary for deprotection of acid labile groups. In addition, the composition has storage stability. The PAG (A) may be used alone or in admixture of two or more.

### (B) Base polymer

The resist composition further comprises (B) a base polymer containing a polymer which is decomposed under the action of acid to increase its solubility in an alkaline developer.

Preferred is a polymer comprising repeat units having the formula (B1), which are referred to as units B1, hereinafter.

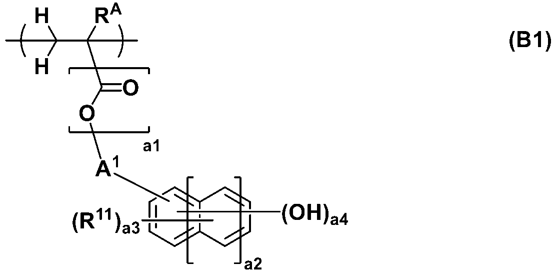

In formula (B1), a1 is 0 or 1. The subscript a2 is 0, 1 or 2. The relevant structure is a benzene skeleton when a2=0, a naphthalene skeleton when a2=1, and an anthracene skeleton when a2=2. The subscript a3 is an integer meeting 0 ≤ a3 ≤ 5+2(a2)-a4, and a4 is 1, 2 or 3. When a2 is 0, preferably a3 is 0, 1, 2 or 3 and a4 is 1, 2 or 3. When a2 is 1 or 2, preferably a3 is 0, 1, 2, 3 or 4 and a4 is 1, 2 or 3.

In formula (B1), R^{A} is hydrogen, fluorine, methyl or trifluoromethyl.

In formula (B1), R¹¹ is halogen, nitro, carboxy, an optionally halogenated C₁-C₆ saturated hydrocarbyl group, optionally halogenated C₁-C₆ saturated hydrocarbyloxy group or optionally halogenated C₂-C₈ saturated hydrocarbylcarbonyloxy group. The saturated hydrocarbyl group and saturated hydrocarbyl moiety in the saturated hydrocarbyloxy and saturated hydrocarbylcarbonyloxy groups may be straight, branched or cyclic. Examples thereof include alkyl groups such as methyl, ethyl, n-propyl, isopropyl, butyl, pentyl, hexyl, and structural isomers thereof; cycloalkyl groups such as cyclopropyl, cyclobutyl, cyclopentyl and cyclohexyl; and combinations thereof. A carbon count within the upper limit ensures a satisfactory solubility in alkaline developer. A plurality of R¹¹ may be identical or different when a3 is 2 or more.

In formula (B1), A¹ is a single bond or C₁-C₁₀ saturated hydrocarbylene group in which some -CH₂- may be replaced by -O-. The saturated hydrocarbylene group may be straight, branched or cyclic and examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of a1=1 in formula (B1), the ether bond may be incorporated at any position excluding the position between the α- and β-carbons relative to the ester oxygen. In case of a1=0, the atom bonding to the backbone becomes an ether oxygen atom, and a second ether bond may be incorporated at any position excluding the position between the α- and β-carbons relative to the ether oxygen. Saturated hydrocarbylene groups having no more than 10 carbon atoms are desirable because of a sufficient solubility in alkaline developer.

Preferred examples of the repeat units B1 wherein a1=0 and A¹ is a single bond (meaning that the aromatic ring is directly bonded to the backbone of the polymer), that is, repeat units free of a linker: -C(=O)-O-A¹- include units derived from 3-hydroxystyrene, 4-hydroxystyrene, 5-hydroxy-2-vinylnaphthalene, and 6-hydroxy-2-vinylnaphthalene. Examples of repeat unit B1 are shown below, but not limited thereto. Herein R^{A} is as defined above.

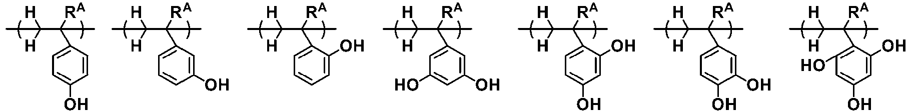

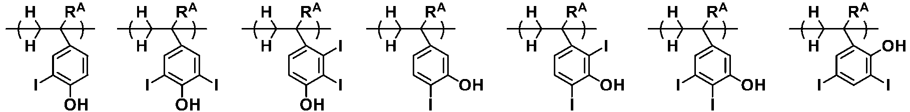

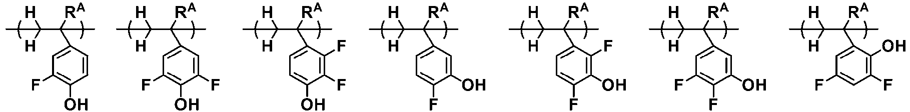

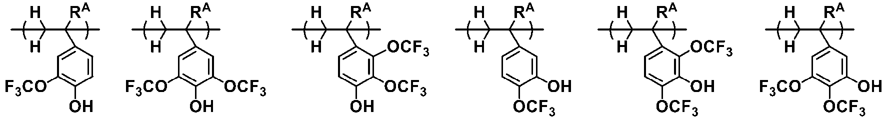

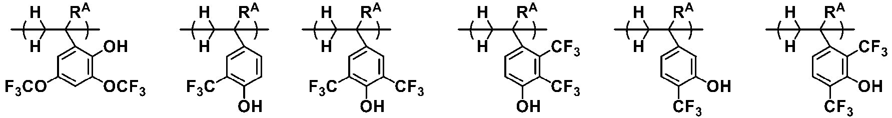

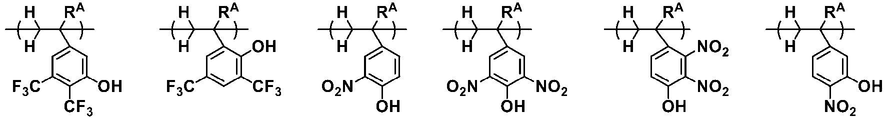

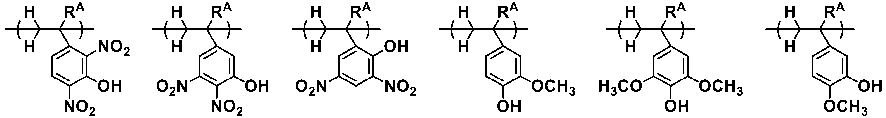

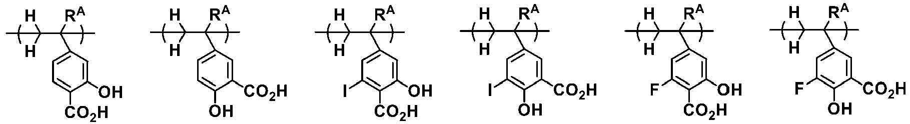

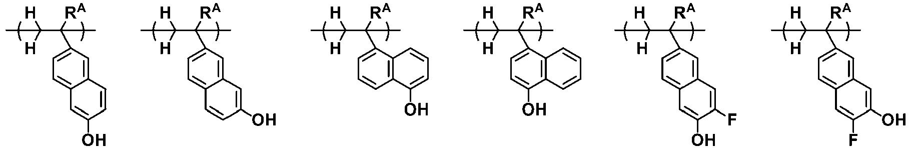

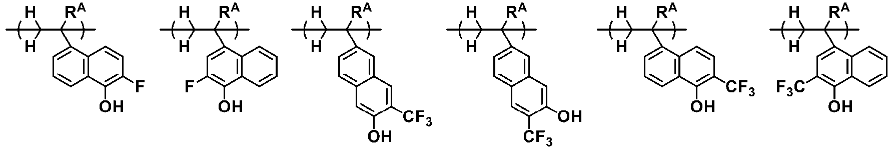

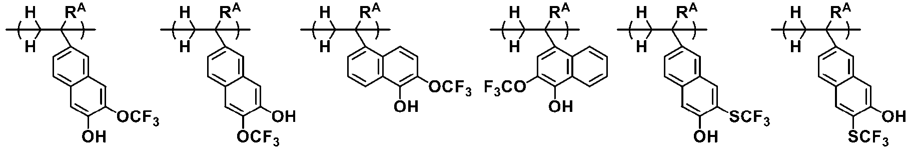

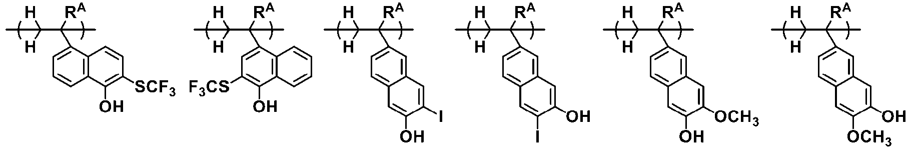

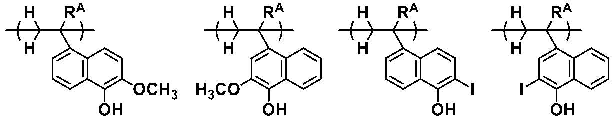

Preferred examples of the repeat units B1 wherein a1=1, that is, having a linker: -C(=O)-O-A¹- are shown below, but not limited thereto. Herein R^{A} is as defined above.

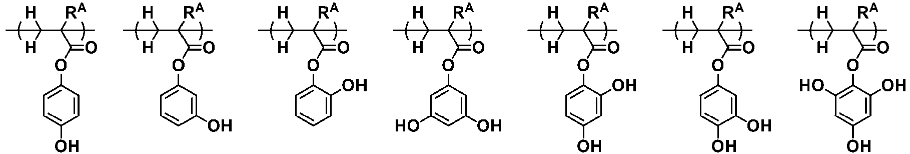

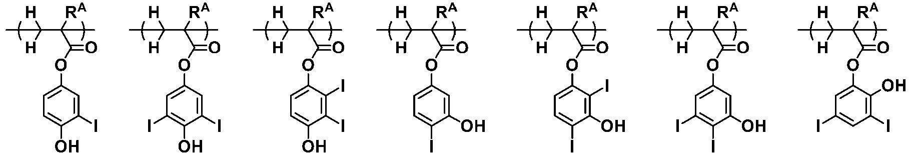

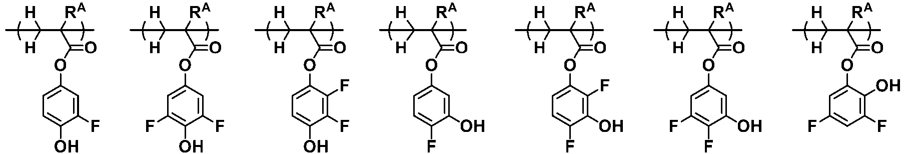

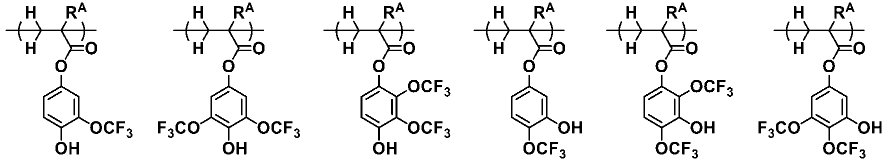

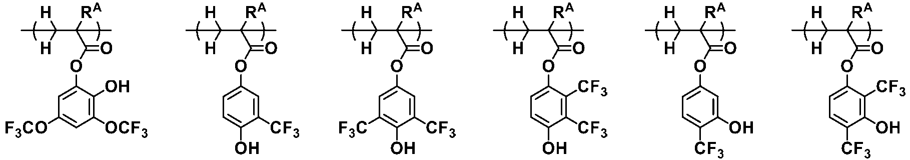

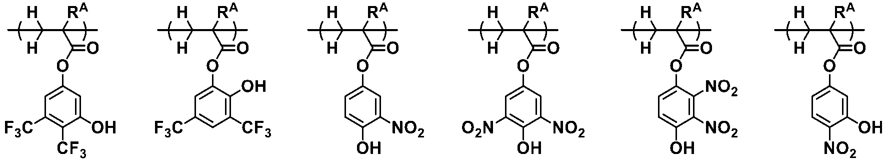

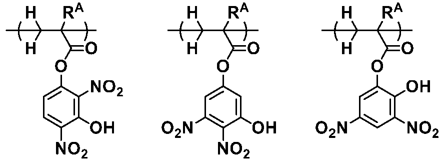

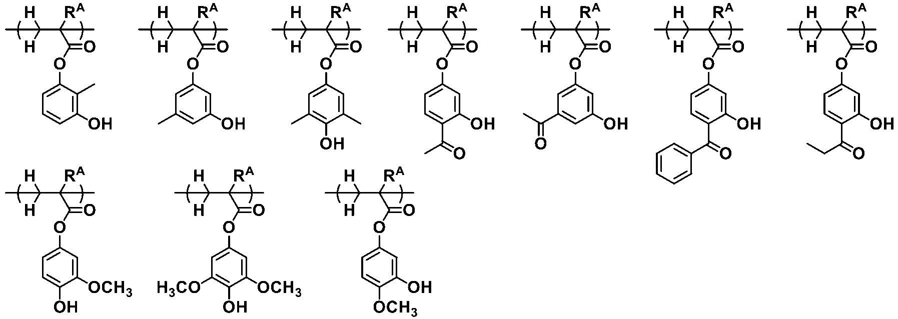

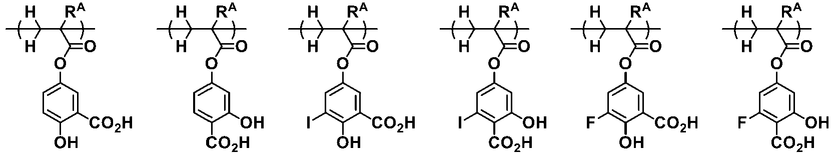

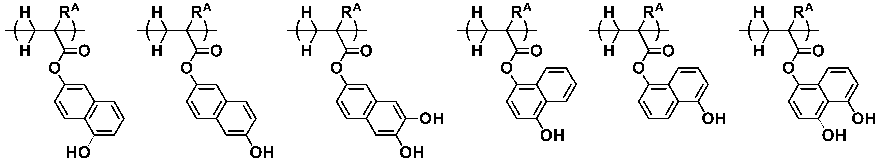

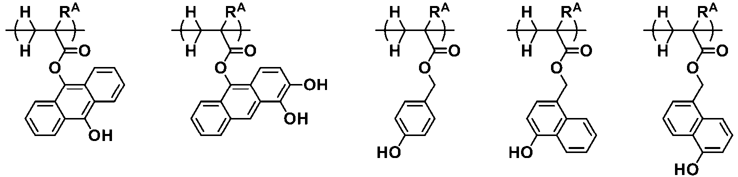

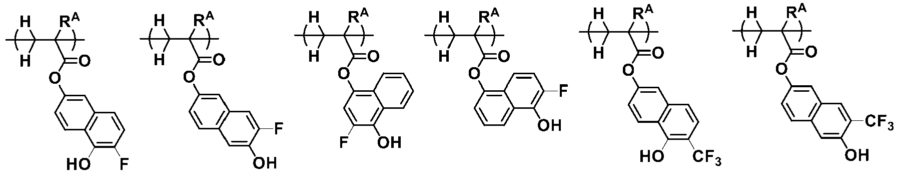

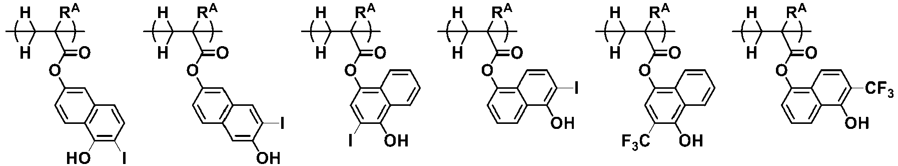

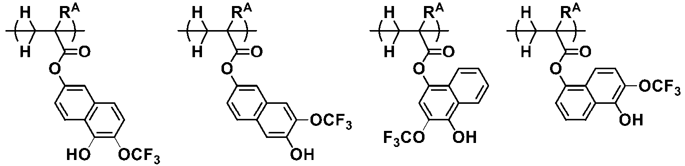

The content of repeat units B1 is preferably 15 to 90 mol%, more preferably 15 to 80 mol% of the overall repeat units of the polymer. Notably, when the polymer contains repeat units of at least one type selected from repeat units having formula (B3) and repeat units having formula (B4) for providing the polymer with higher etching resistance, the repeat units having a phenolic hydroxy group as a substituent, the content of repeat units B1 plus repeat units B3 and B4 should preferably be in the range. The repeat units B1 may be of one type or a combination of plural types.

In order to provide the positive resist composition with such properties that a resist film in the exposed region may be dissolvable in alkaline developer, the polymer preferably comprises repeat units having an acidic functional group protected with an acid labile group, that is, repeat units protected with an acid labile group such that the polymer may turn alkaline soluble under the action of acid, which are referred to as repeat units B2, hereinafter.

Preferably, the repeat unit B2 has the formula (B2-1), which are referred to as repeat units B2-1, hereinafter.

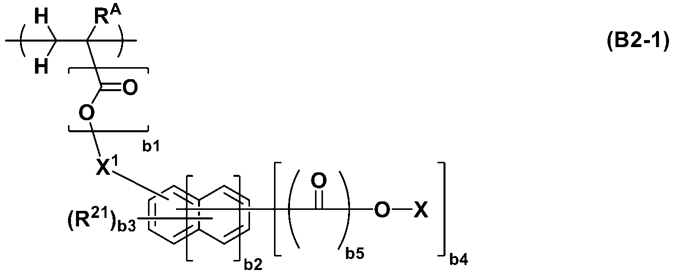

In formula (B2-1), b1 is 0 or 1. The subscript b2 is 0, 1 or 2. The relevant structure is a benzene skeleton when b2=0, a naphthalene skeleton when b2=1, and an anthracene skeleton when b2=2. The subscript b3 is an integer meeting 0 ≤ b3 ≤ 5+2(b2)-b4, b4 is 1, 2 or 3, and b5 is 0 or 1. When b2 is 0, preferably b3 is 0, 1, 2 or 3 and b4 is 1, 2 or 3. When b2 is 1 or 2, preferably b3 is 0, 1, 2, 3 or 4 and b4 is 1, 2 or 3.

In formula (B2-1), R^{A} is hydrogen, fluorine, methyl or trifluoromethyl.

In formula (B2-1), R²¹ is halogen, an optionally halogenated C₁-C₆ saturated hydrocarbyl group, optionally halogenated C₁-C₆ saturated hydrocarbyloxy group or optionally halogenated C₂-C₈ saturated hydrocarbylcarbonyloxy group. The saturated hydrocarbyl group and saturated hydrocarbyl moiety in the saturated hydrocarbyloxy and saturated hydrocarbylcarbonyloxy groups may be straight, branched or cyclic. Examples thereof include alkyl groups such as methyl, ethyl, n-propyl, isopropyl, butyl, pentyl, hexyl, and structural isomers thereof; cycloalkyl groups such as cyclopropyl, cyclobutyl, cyclopentyl and cyclohexyl; and combinations thereof. A carbon count within the upper limit ensures a satisfactory solubility in alkaline developer. A plurality of R²¹ may be identical or different when b3 is 2 or more.

In formula (B2-1), X¹ is a single bond or C₁-C₁₀ saturated hydrocarbylene group in which some -CH₂- may be replaced by -O-. The saturated hydrocarbylene group may be straight, branched or cyclic and examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of b1=1 in formula (B2-1), the ether bond may be incorporated at any position excluding the position between the α- and β-carbons relative to the ester oxygen. In case of b1=0, the atom bonding to the backbone becomes an ether oxygen atom, and a second ether bond may be incorporated at any position excluding the position between the α- and β-carbons relative to the ether oxygen. Of the saturated hydrocarbylene groups, those having 10 or less carbon atoms are preferred because of sufficient solubility in alkaline developer

In formula (B2-1), when b4=1, X is an acid labile group. When b4 is 2 or 3, X is each independently hydrogen or an acid labile group, at least one being an acid labile group. That is, in repeat unit B2-1, at least one of phenolic hydroxy groups bonded to an aromatic ring is protected with an acid labile group, or a carboxy group bonded to an aromatic ring is protected with an acid labile group. The acid labile group used herein is not particularly limited as long as it is used in many well-known chemically amplified positive resist compositions and is detached under the action of acid to provide an acidic group.

Exemplary of the acid labile group are tertiary saturated hydrocarbyl groups. Inter alia, tertiary saturated hydrocarbyl groups of 4 to 18 carbon atoms are preferred because the corresponding monomer for polymerization can be recovered by distillation.

In the tertiary saturated hydrocarbyl group, the saturated hydrocarbyl group bonded to tertiary carbon atom is preferably of 1 to 15 carbon atoms. The C₁-C₁₅ saturated hydrocarbyl group may be straight, branched or cyclic, and an oxygen-containing functional group such as ether bond or carbonyl may intervene in a carbon-carbon bond. Also, the saturated hydrocarbyl groups bonded to tertiary carbon atom may bond together to form a ring with the tertiary carbon atom to which they are bonded.

Examples of the alkyl substituent include methyl, ethyl, propyl, adamantyl, norbornyl, tetrahydrofuran-2-yl, 7-oxanorbornan-2-yl, cyclopentyl, 2-tetrahydrofuryl, tricyclo[5.2.1.0^{2,6}]decyl, 8-ethyl-8-tricyclo[5.2.1.0^{2,6}]decyl, 3-methyl-3-tetracyclo[4.4.0.1^{2,5}.1^{7,10}]dodecyl, tetracyclo[4.4.0.1^{2,5}.1^{7,10}]dodecyl, and 3-oxo-1-cyclohexyl.

Examples of the tertiary saturated hydrocarbyl group include, but are not limited to, tert-butyl, tert-pentyl, 1-ethyl-1-methylpropyl, 1,1-diethylpropyl, 1,1,2-trimethylpropyl, 1-adamantyl-1-methylethyl, 1-methyl-1-(2-norbornyl)ethyl, 1-methyl-1-(tetrahydrofuran-2-yl)ethyl, 1-methyl-1-(7-oxanorbornan-2-yl)ethyl, 1-methylcyclopentyl, 1-ethylcyclopentyl, 1-propylcyclopentyl, 1-cyclopentylcyclopentyl, 1-cyclohexylcyclopentyl, 1-(2-tetrahydrofuryl)cyclopentyl, 1-(7-oxanorbornan-2-yl)cyclopentyl, 1-methylcyclohexyl, 1-ethylcyclohexyl, 1-cyclopentylcyclohexyl, 1-cyclohexylcyclohexyl, 2-methyl-2-norbornyl, 2-ethyl-2-norbornyl, 8-methyl-8-tricyclo[5.2.1.0^{2,6}]decyl, 8-ethyl-8-tricyclo[5.2.1.0^{2,6}]decyl, 3-methyl-3-tetracyclo[4.4.0.1^{2,5}.1^{7,10}]dodecyl, 3-ethyl-3-tetracyclo[4.4.0.1^{2,5}.1^{7,10}]dodecyl, 2-methyl-2-adamantyl, 2-ethyl-2-adamantyl, 1-methyl-3-oxo-1-cyclohexyl, 1-methyl-1-(tetrahydrofuran-2-yl)ethyl, 5-hydroxy-2-methyl-2-adamantyl, and 5-hydroxy-2-ethyl-2-adamantyl.

A group having the following formula (B2-1-1) is also suitable as the acid labile group. The group having formula (B2-1-1) is often used as the acid labile group. It is a good choice of the acid labile group that ensures to form a pattern having a relatively rectangular pattern-substrate interface in a consistent manner. An acetal structure is formed when X is a group having the formula (B2-1-1).

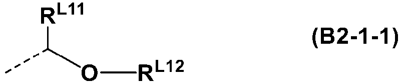

In formula (B2-1-1), R^{L11} is hydrogen or a C₁-C₁₀ saturated hydrocarbyl group. The saturated hydrocarbyl group may be straight, branched or cyclic.

A choice of R^{L11} may depend on the designed sensitivity of labile group to acid. For example, hydrogen or a group in which the carbon atom bonded to acetal carbon is tertiary is selected when the acid labile group is designed to ensure relatively high stability and to be decomposed with strong acid. Examples of R^{L11} bonded to acetal carbon via tertiary carbon include tert-butyl, tert-pentyl, and 1-adamantyl, but are not limited thereto. A straight alkyl group is selected when the acid labile group is designed to have relatively high reactivity and high sensitivity to pH changes. Although the choice varies with a particular combination of acid generator and quencher in the resist composition, R^{L11} is preferably a group in which the carbon in bond with acetal carbon is secondary, when R^{L12} is a relatively large saturated hydrocarbyl group at the end and the acid labile group is designed to undergo a substantial change of solubility by decomposition. Examples of R^{L11} bonded to acetal carbon via secondary carbon include isopropyl, sec-butyl, cyclopentyl, and cyclohexyl, but are not limited thereto.

In formula (B2-1-1), R^{L12} is a C₁-C₃₀ hydrocarbyl group. The hydrocarbyl group may be saturated or unsaturated and straight, branched or cyclic. Some constituent -CH₂-in the hydrocarbyl group may be replaced by a heteroatom such as oxygen or sulfur so that the group may contain an ether bond or sulfide bond. Illustrative are C₁-C₃₀ saturated hydrocarbyl groups and C₆-C₃₀ aryl groups. R^{L12} is preferably a C₁-C₆ hydrocarbyl group for acquiring a higher resolution in forming small-size patterns. When R^{L12} is a C₁-C₆ hydrocarbyl group, the alcohol created after a progress of acid-aided deprotection reaction is water soluble. Then, when a positive pattern is formed using an alkaline developer, the alcohol is dissolved in the developer so that defects remaining in the exposed region are minimized.

Preferred examples of the group having formula (B2-1-1) are given below, but not limited thereto. Herein R^{L11} is as defined above.

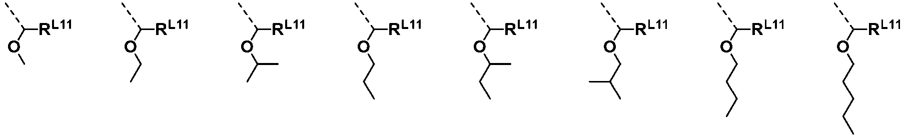

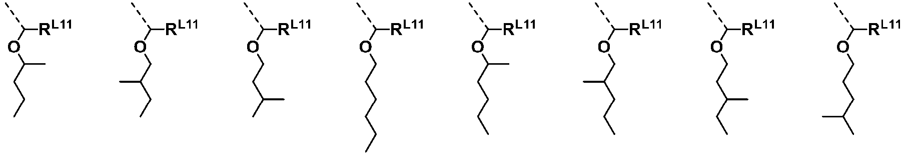

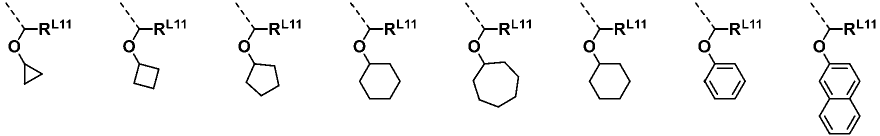

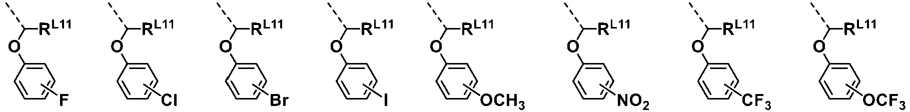

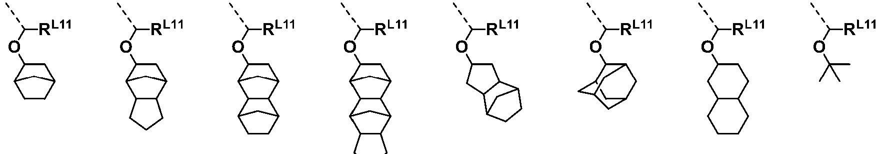

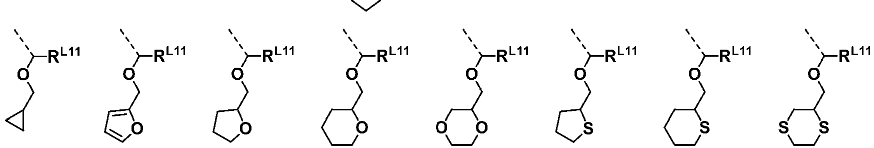

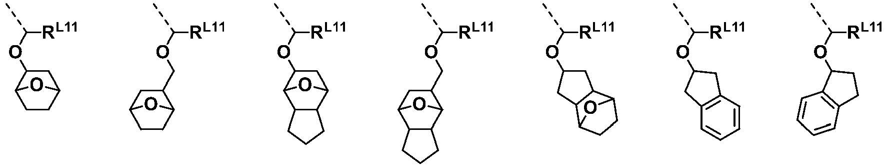

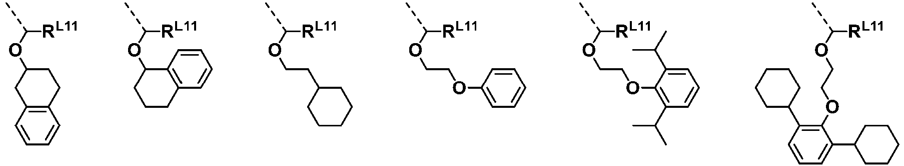

Another acid labile group which can be used herein is a phenolic hydroxy group whose hydrogen is substituted by -CH₂COO-(tertiary saturated hydrocarbyl group). The tertiary saturated hydrocarbyl group may be the same as the foregoing tertiary saturated hydrocarbyl group used for the protection of a phenolic hydroxy group.

Also included in repeat units B2 are repeat units having the following formula (B2-2), which are referred to as repeat units B2-2, hereinafter. Since the repeat unit B2-2 serves to increase the dissolution rate in the exposed region, it is a good choice of acid labile group-containing unit that exerts satisfactory performance against a line width variation upon development loading.

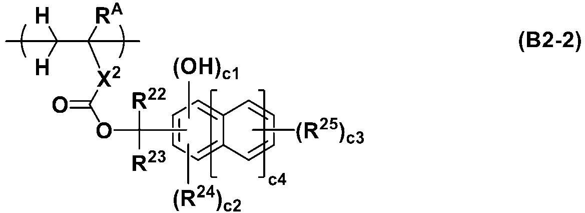

In formula (B2-2), c1 is 0, 1 or 2, c2 is 0, 1 or 2, c3 is 0, 1, 2, 3, 4 or 5, and c4 is 0, 1 or 2.

In formula (B2-2), R^{A} is hydrogen, fluorine, methyl or trifluoromethyl.

In formula (B2-2), R²² and R²³ are each independently a C₁-C₁₀ hydrocarbyl group which may contain a heteroatom. R²² and R²³ may bond together to form a ring with the carbon atom to which they are attached.

In formula (B2-2), R²⁴ is each independently fluorine, a C₁-C₅ fluorinated alkyl group or C₁-C₅ fluorinated alkoxy group. Two R²⁴ may be identical or different when c2=2.

In formula (B2-2), R²⁵ is each independently a C₁-C₁₀ hydrocarbyl group which may contain a heteroatom. A plurality of R²⁵ may be identical or different when c3 is 2, 3, 4 or 5.

In formula (B2-2), X² is a single bond, phenylene group, naphthylene group or *-C(=O)-O-X²¹-. X²¹ is a C₁-C₂₀ aliphatic hydrocarbylene group which may contain a hydroxy, ether bond, ester bond or lactone ring, or phenylene group or naphthylene group. Herein * designates a point of attachment to the carbon atom in the backbone.

Preferred examples of repeat unit B2-2 are shown below, but not limited thereto. Herein R^{A} is as defined above.

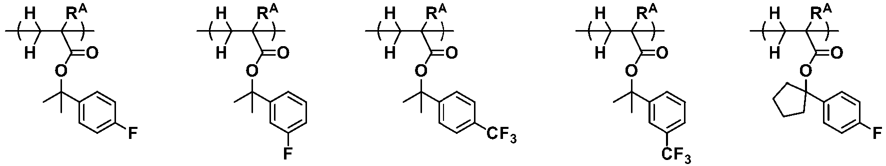

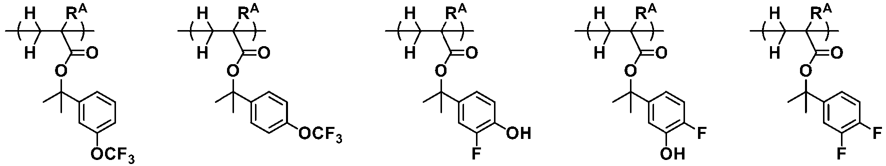

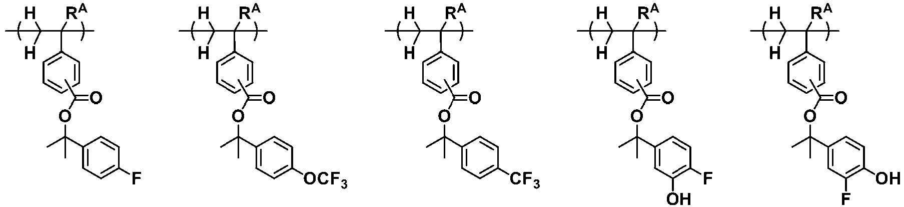

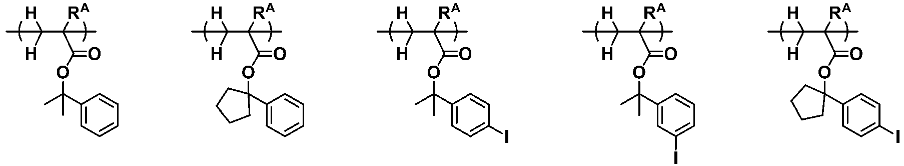

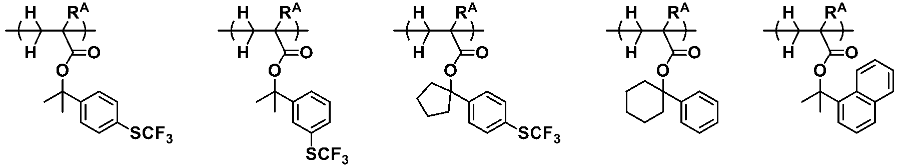

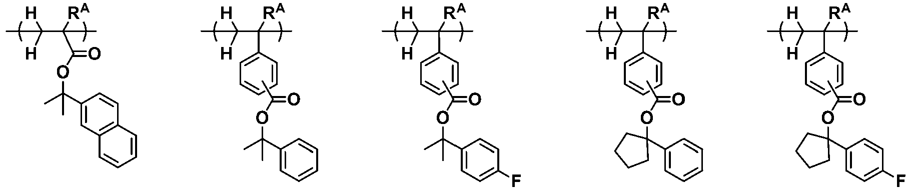

Also included in repeat units B2 are repeat units having the following formula (B2-3), which are referred to as repeat units B2-3, hereinafter. Since the repeat unit B2-3 serves to increase the dissolution rate in the exposed region, it is a good choice of acid labile group-containing unit that exerts satisfactory performance against a line width variation upon development loading.

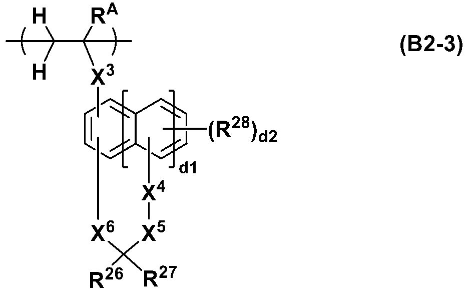

In formula (B2-3), d1 is 0 or 1. The relevant structure is a benzene ring when d1=0, and a naphthalene ring when d1=1. The benzene ring corresponding to d1=0 is preferred from the aspect of solvent solubility. The subscript d2 is 0, 1, 2 or 3 when d1=0, and d2 is 0, 1, 2, 3, 4 or 5 when d1=1. As viewed from reactant availability, d2 is preferably 0, 1, 2 or 3, more preferably 0, 1 or 2.

In formula (B2-3), R^{A} is hydrogen, fluorine, methyl or trifluoromethyl. R^{A} is preferably hydrogen or methyl, more preferably hydrogen.

In formula (B2-3), X³ is a single bond, *-C(=O)-O- or *-C(=O)-N(H)-, wherein * designates a point of attachment to the carbon atom in the backbone. X³ is preferably a single bond or *-C(=O)-O-, more preferably a single bond.

In formula (B2-3), X⁴ is a single bond, a C₁-C₄ aliphatic hydrocarbylene group, carbonyl, sulfonyl or a group obtained by combining the foregoing. X⁴ is preferably a single bond, carbonyl or sulfonyl group for reactant availability, more preferably a single bond or carbonyl group as viewed from a polar group created after reaction.

In formula (B2-3), X⁵ and X⁶ are each independently oxygen or sulfur. It is provided that X⁴ and X⁶ are bonded to adjoining carbon atoms on the aromatic ring. X⁵ and X⁶ may be identical or different. It is preferred from the aspect of reactivity that both X⁵ and X⁶ be oxygen.

In formula (B2-3), R²⁶ and R²⁷ are each independently hydrogen or a C₁-C₂₀ hydrocarbyl group which may contain a heteroatom. The hydrocarbyl group may be saturated or unsaturated and straight, branched or cyclic. Examples thereof include C₁-C₂₀ alkyl groups such as methyl, ethyl, n-propyl, isopropyl, n-butyl, isobutyl, sec-butyl, tert-butyl, n-pentyl, n-hexyl, n-octyl, n-nonyl, n-decyl, undecyl, dodecyl, tridecyl, tetradecyl, pentadecyl, heptadecyl, octadecyl, nonadecyl, and icosyl; C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl, and adamantyl; C₂-C₂₀ alkenyl groups such as vinyl, 1-propenyl, 2-propenyl, butenyl and hexenyl; C₃-C₂₀ cyclic unsaturated hydrocarbyl groups such as cyclohexenyl; C₆-C₂₀ aryl groups such as phenyl and naphthyl; C₇-C₂₀ aralkyl groups such as benzyl, 1-phenylethyl and 2-phenylethyl, and combinations thereof. In the hydrocarbyl group, some or all hydrogen may be substituted by a moiety containing a heteroatom such as oxygen, sulfur, nitrogen or halogen, and some -CH₂- may be replaced by a moiety containing a heteroatom such as oxygen, sulfur or nitrogen, so that the group may contain a hydroxy, cyano, fluorine, chlorine, bromine, iodine, carbonyl, ether bond, ester bond, sulfonate ester bond, carbonate bond, lactone ring, sultone ring, carboxylic anhydride (-C(=O)-O-C(=O)-) or haloalkyl moiety.

R²⁶ and R²⁷ may bond together to form a ring with the carbon atom to which they are attached. Examples of the ring thus formed include cyclopropane, cyclobutane, cyclopentane, cyclohexane, norbornane, and adamantane rings. In the ring, some or all of the hydrogen atoms may be substituted by a moiety containing a heteroatom such as oxygen, sulfur, nitrogen or halogen, and some -CH₂- may be replaced by a moiety containing a heteroatom such as oxygen, sulfur or nitrogen, so that the ring may contain a hydroxy, fluorine, chlorine, bromine, iodine, cyano, carbonyl, ether bond, ester bond, sulfonate ester bond, carbonate bond, lactone ring, sultone ring, carboxylic anhydride (-C(=O)-O-C(=O)-) or haloalkyl moiety.

In formula (B2-3), R²⁸ is halogen, hydroxy, cyano, nitro, pentafluorosulfanyl, a C₁-C₂₀ hydrocarbyl group which may contain a heteroatom, C₁-C₂₀ hydrocarbyloxy group which may contain a heteroatom, C₂-C₂₀ hydrocarbyloxycarbonyl group which may contain a heteroatom, C₁-C₂₀ hydrocarbylthio group which may contain a heteroatom, or -N(R^{28A})(R^{28B}). R^{28A} and R^{28B} are each independently hydrogen or a C₁-C₆ hydrocarbyl group. Suitable halogen atoms include fluorine, chlorine, bromine and iodine, with fluorine and iodine being preferred. The hydrocarbyl group and hydrocarbyl moiety in the hydrocarbyloxy, hydrocarbyloxycarbonyl and hydrocarbylthio groups may be saturated or unsaturated and straight, branched or cyclic. Examples thereof are as exemplified above for the hydrocarbyl group R²⁶ and R²⁷. In the hydrocarbyl group, some or all of the hydrogen atoms may be substituted by a moiety containing a heteroatom such as oxygen, sulfur, nitrogen or halogen, and some -CH₂- may be replaced by a moiety containing a heteroatom such as oxygen, sulfur or nitrogen, so that the group may contain a hydroxy, cyano, fluorine, chlorine, bromine, iodine, carbonyl, ether bond, ester bond, sulfonate ester bond, carbonate bond, lactone ring, sultone ring, carboxylic anhydride (-C(=O)-O-C(=O)-) or haloalkyl moiety. When b2 is 2 or more, a plurality of R²⁸ may be identical or different.

When b2 is 2 or more, a plurality of R²⁸ may bond together to form a ring with the carbon atoms on the aromatic ring to which they are attached. Examples of the ring thus formed include cyclopropane, cyclobutane, cyclopentane, cyclohexane, norbornane, and adamantane rings. In the ring, some or all of the hydrogen atoms may be substituted by a moiety containing a heteroatom such as oxygen, sulfur, nitrogen or halogen, and some -CH₂-may be replaced by a moiety containing a heteroatom such as oxygen, sulfur or nitrogen, so that the ring may contain a hydroxy, fluorine, chlorine, bromine, iodine, cyano, carbonyl, ether bond, ester bond, sulfonate ester bond, carbonate bond, lactone ring, sultone ring, carboxylic anhydride (-C(=O)-O-C(=O)-) or haloalkyl moiety.

Examples of repeat unit B2-3 are shown below, but not limited thereto. Herein R^{A} is as defined above. The positions of attachment of substituent groups on the aromatic ring are interchangeable.

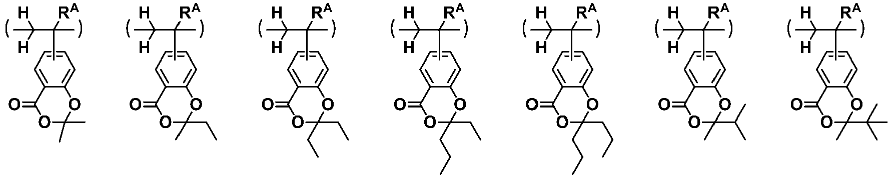

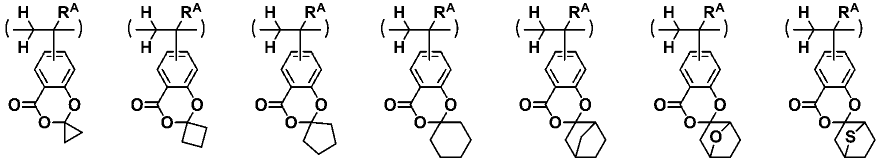

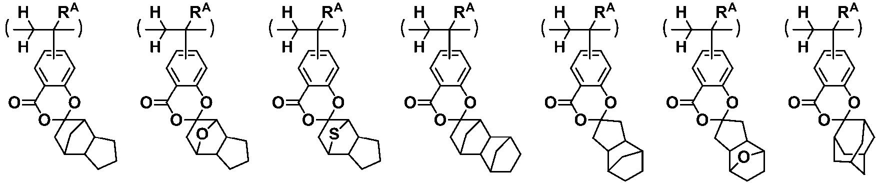

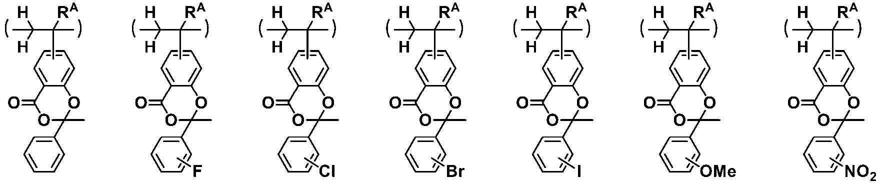

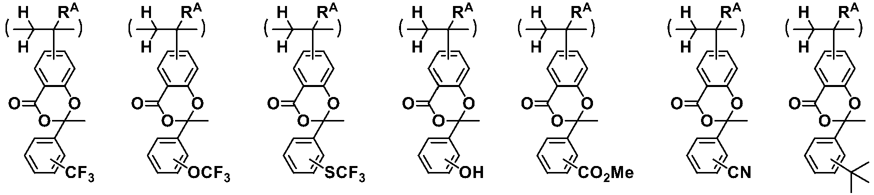

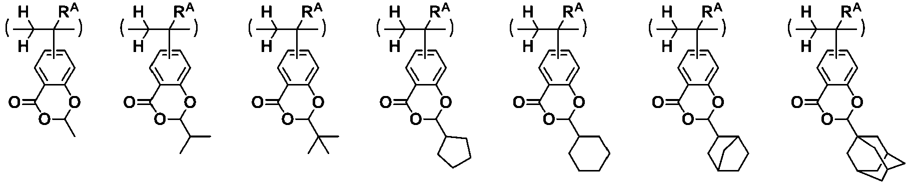

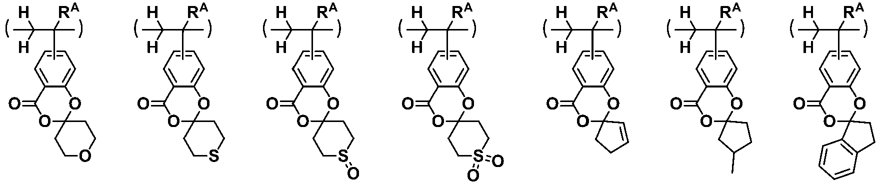

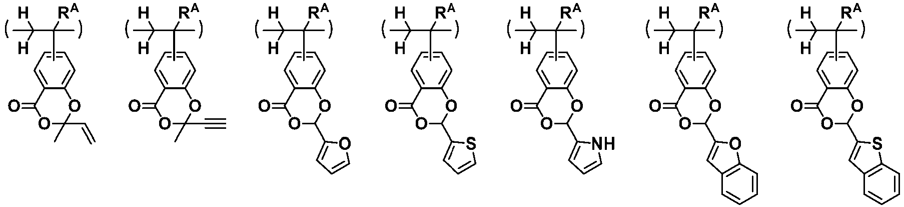

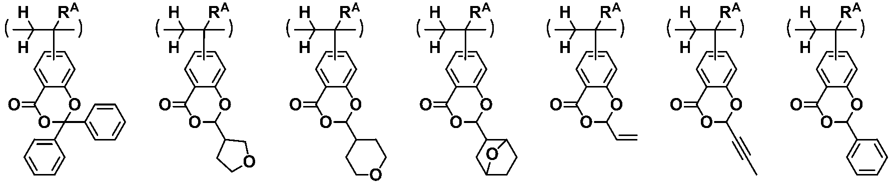

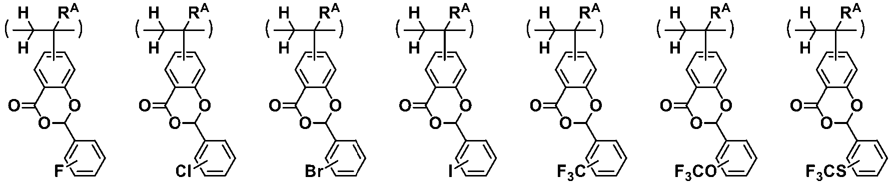

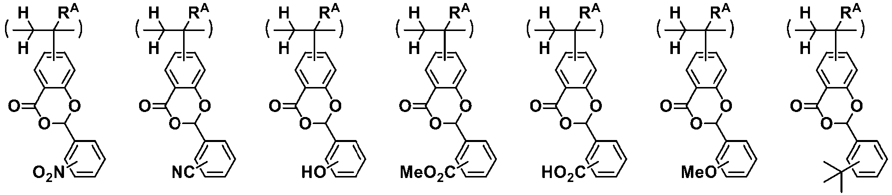

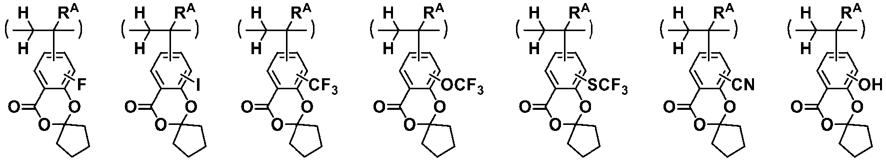

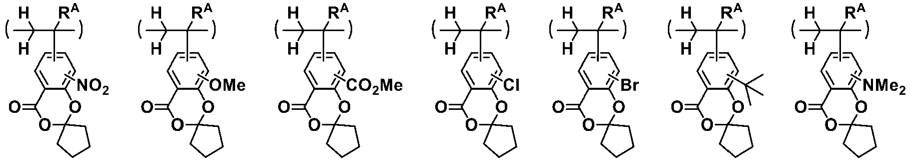

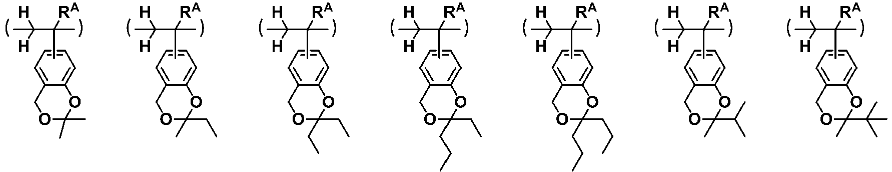

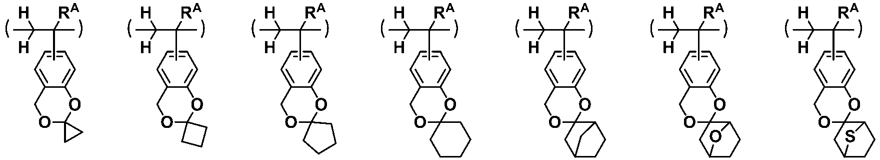

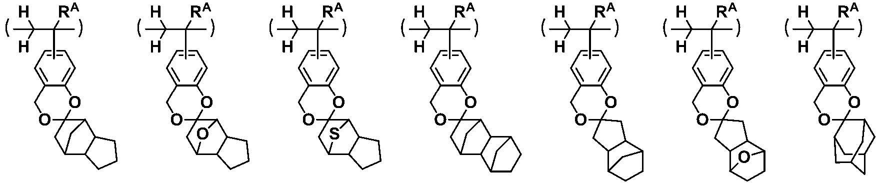

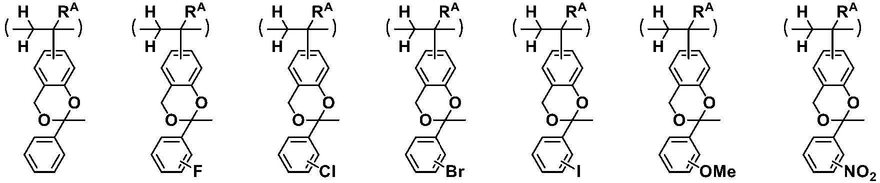

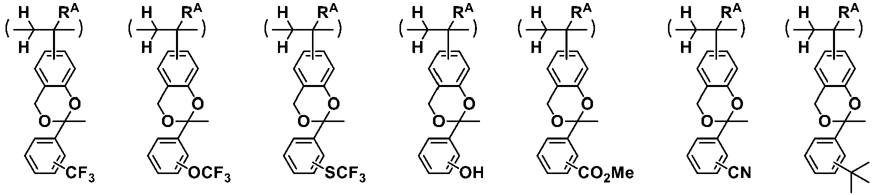

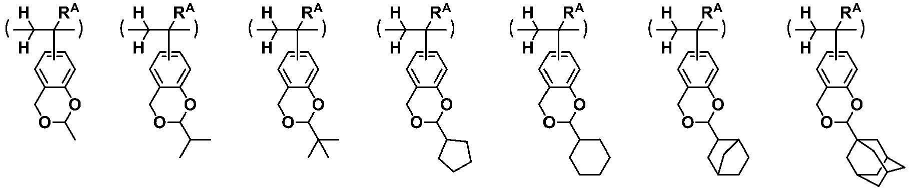

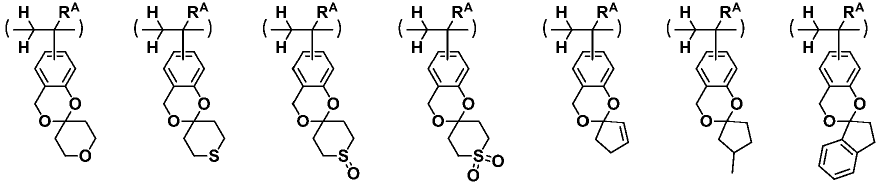

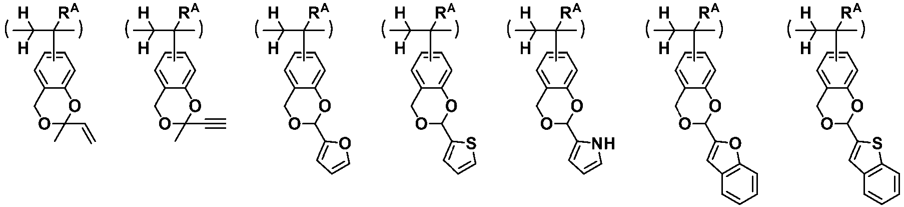

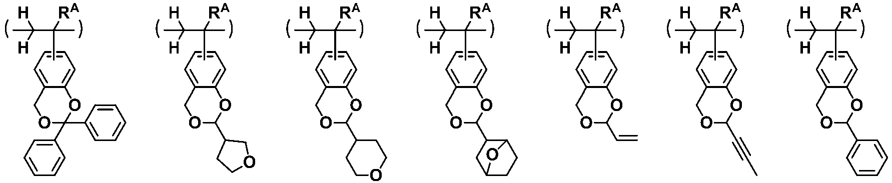

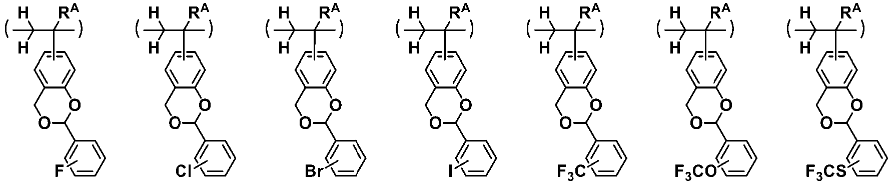

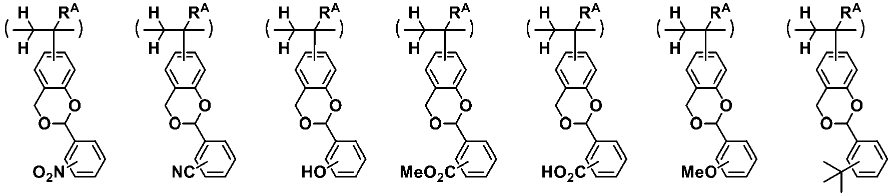

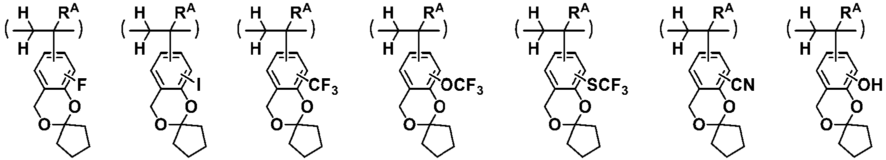

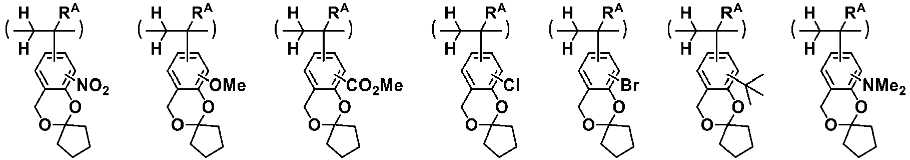

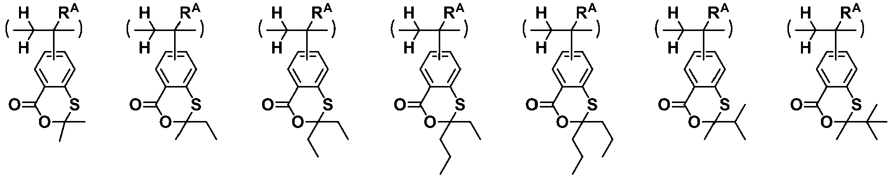

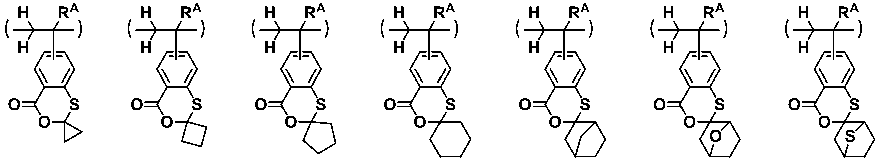

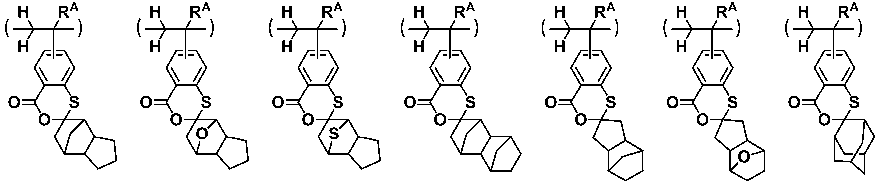

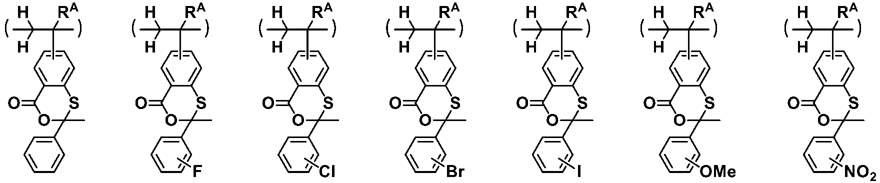

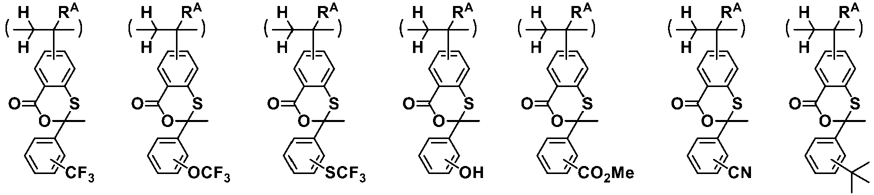

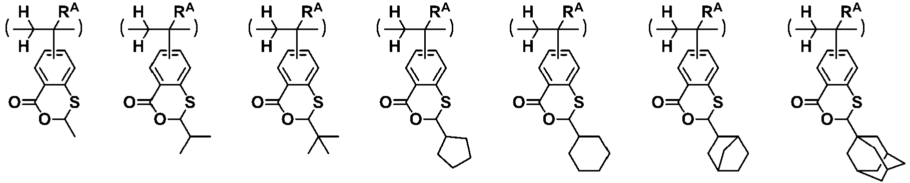

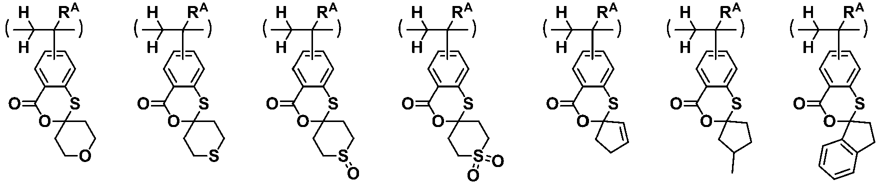

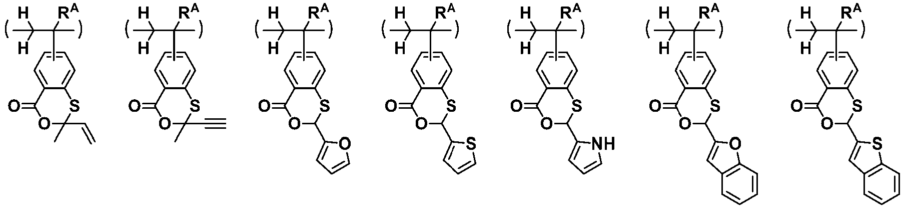

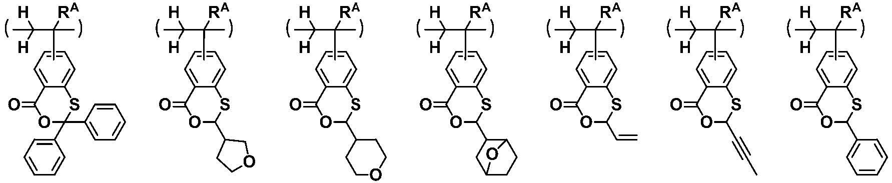

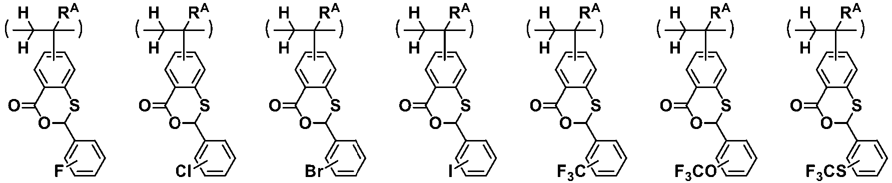

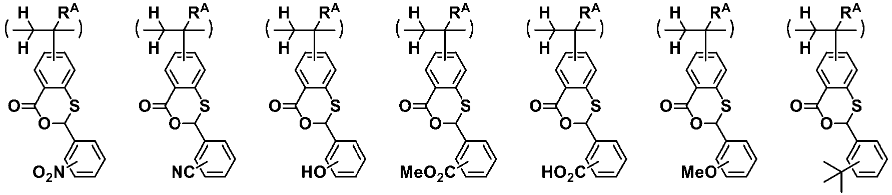

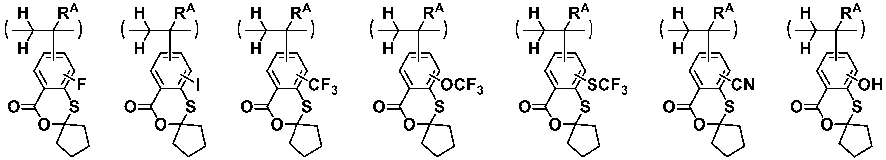

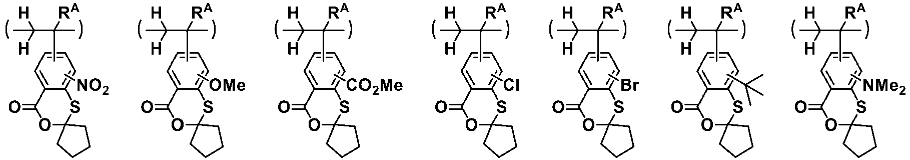

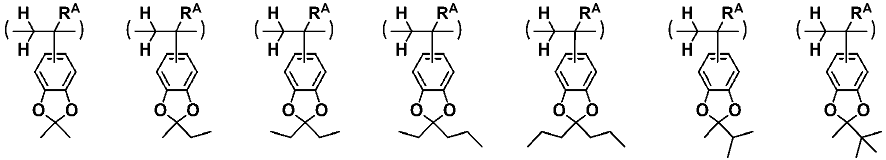

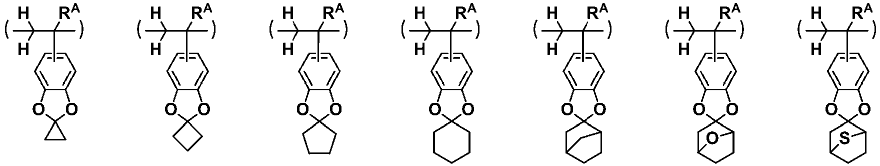

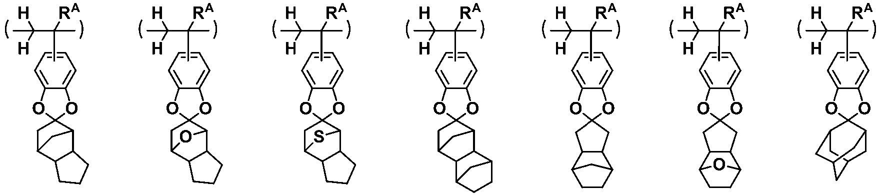

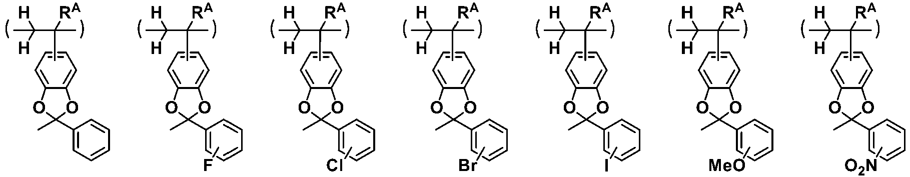

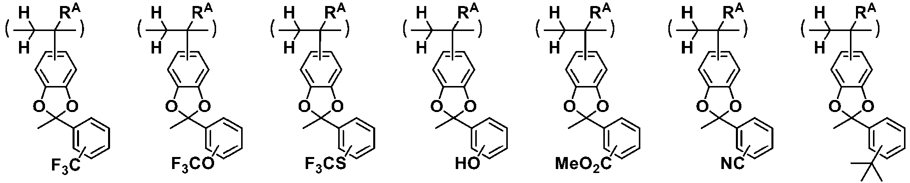

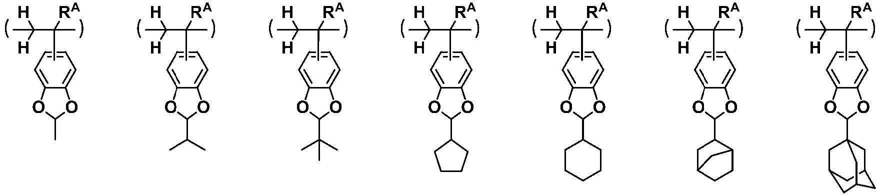

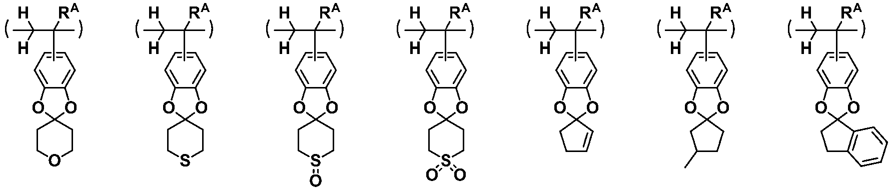

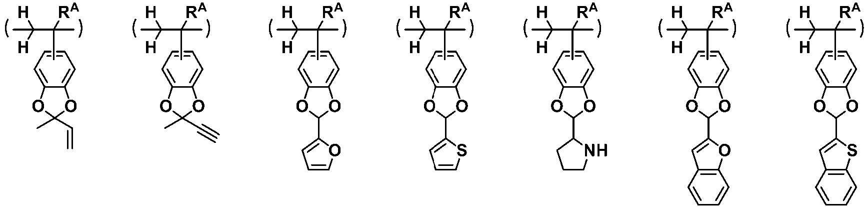

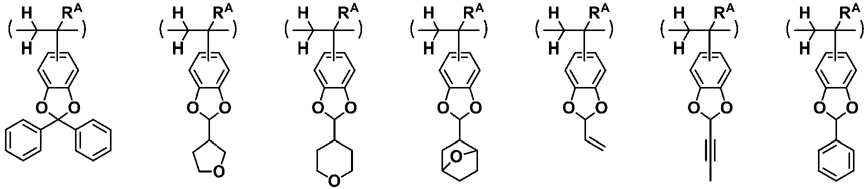

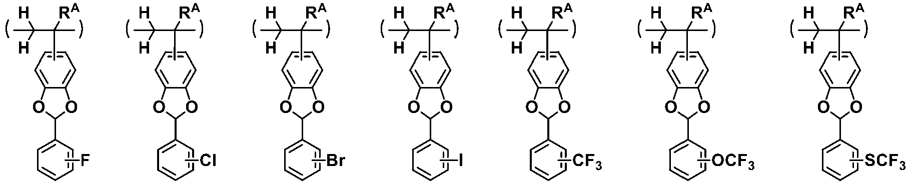

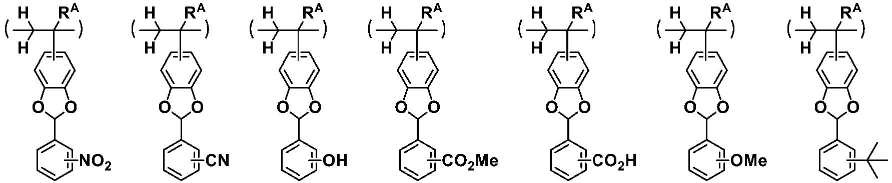

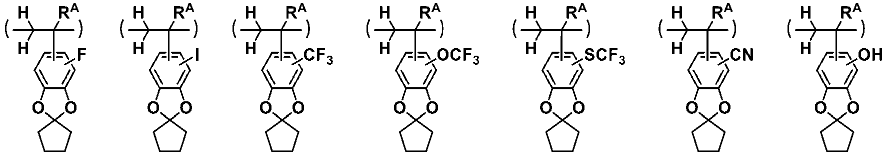

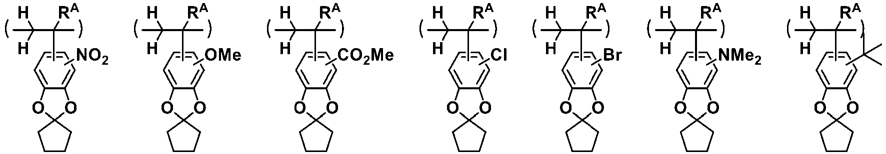

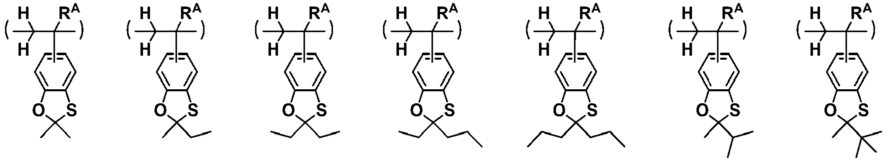

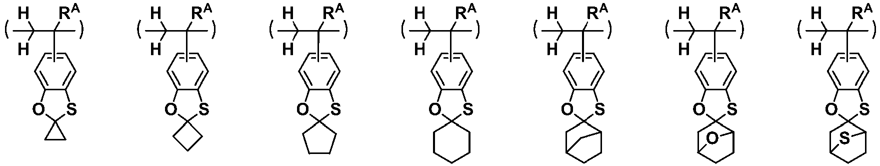

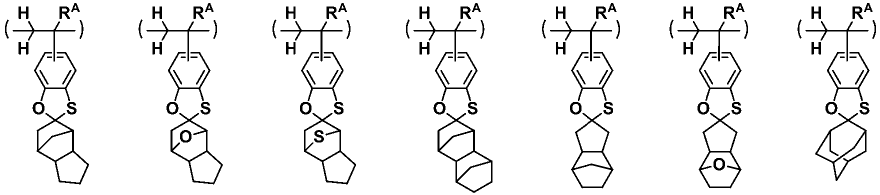

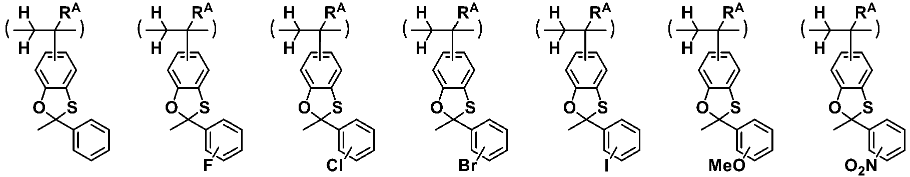

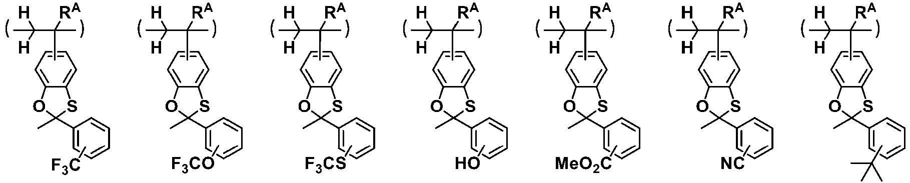

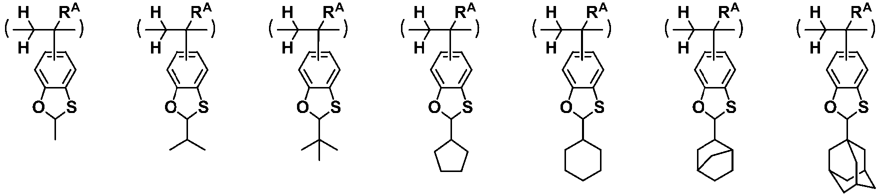

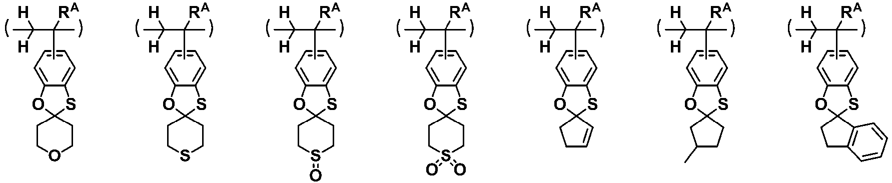

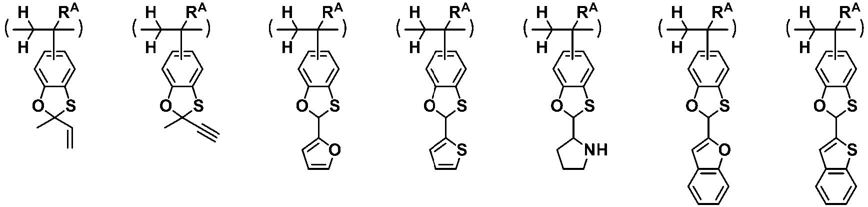

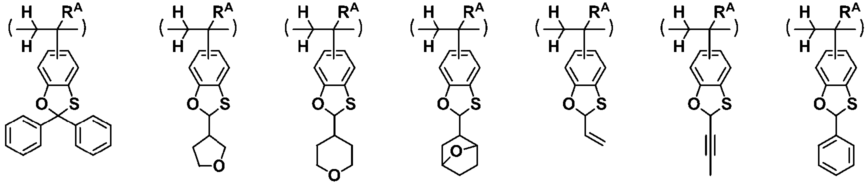

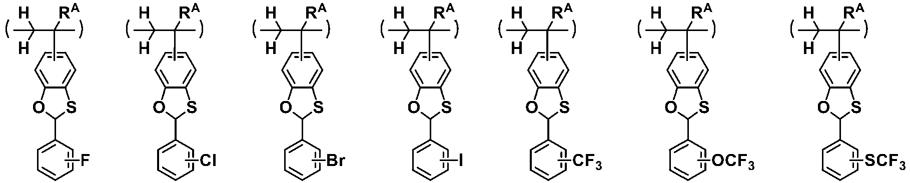

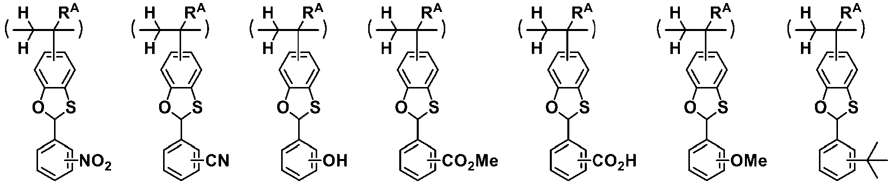

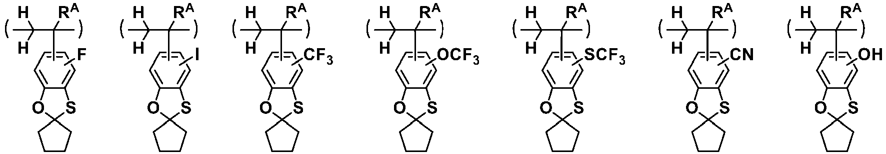

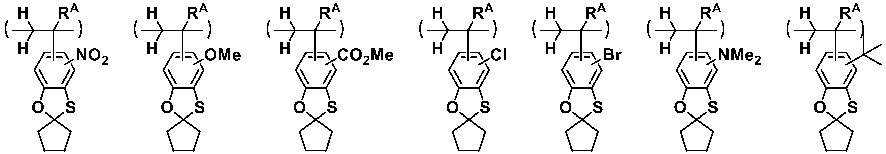

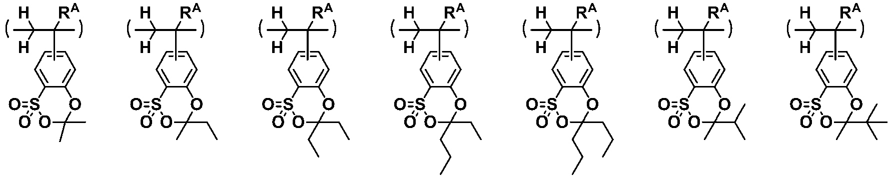

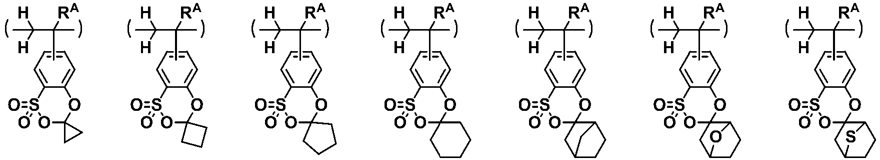

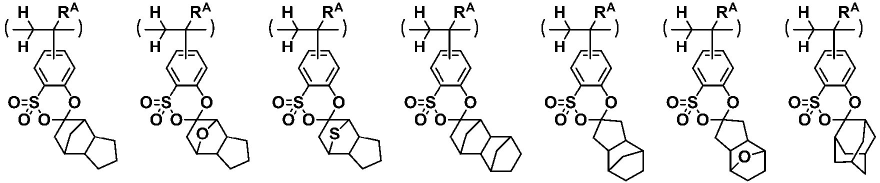

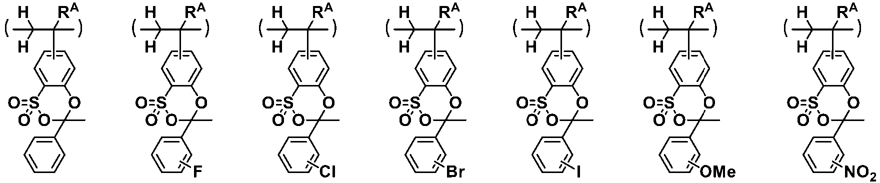

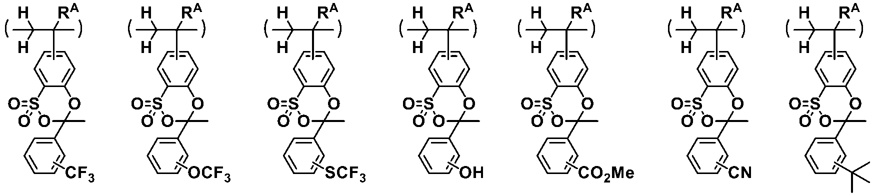

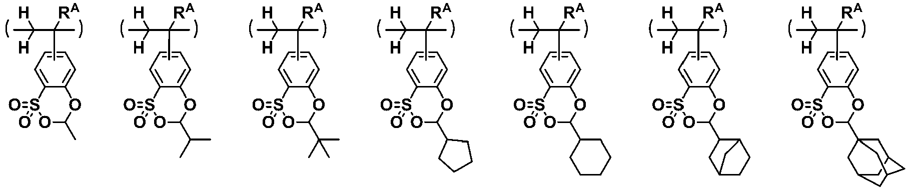

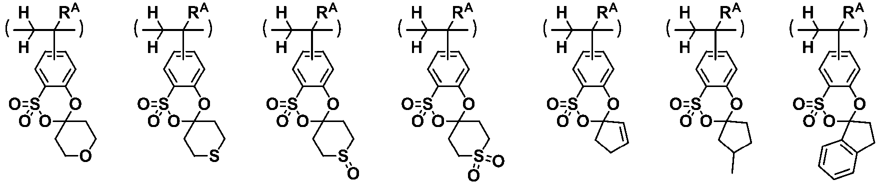

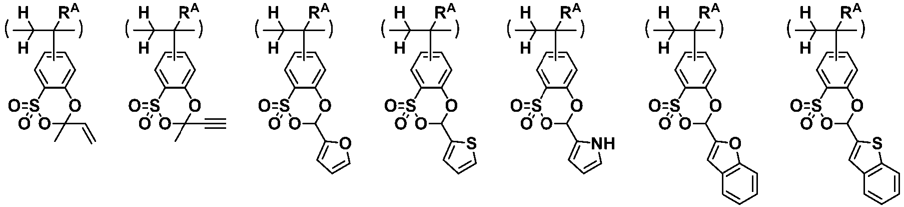

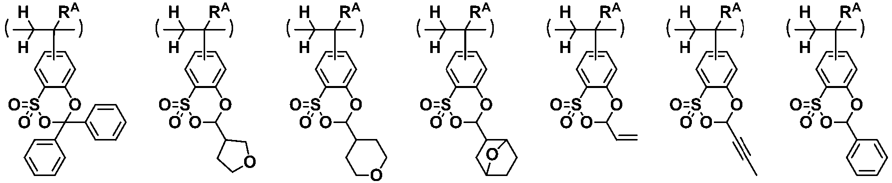

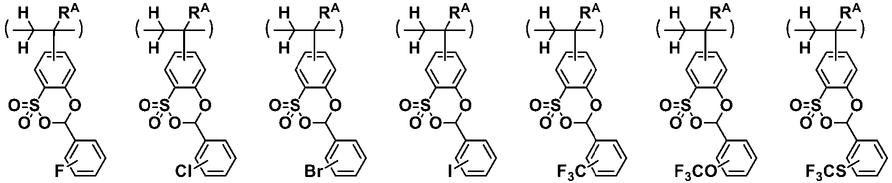

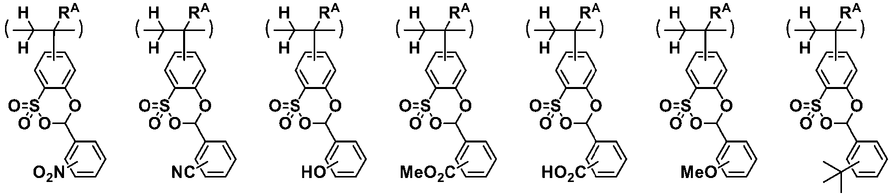

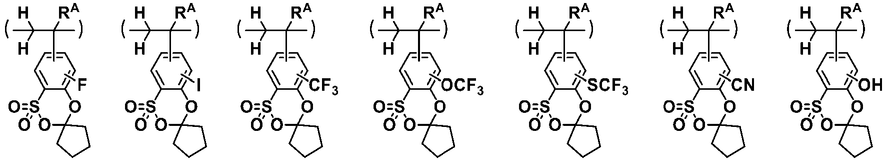

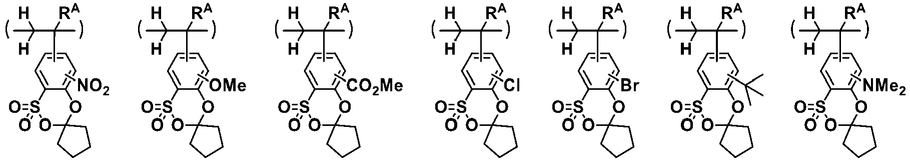

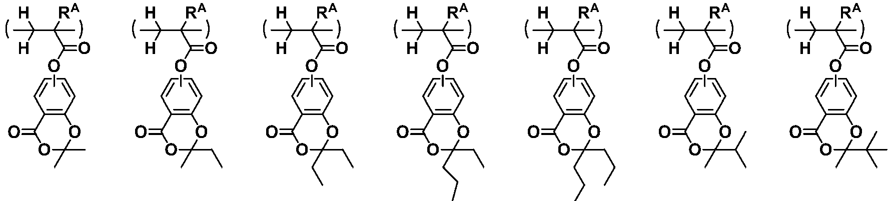

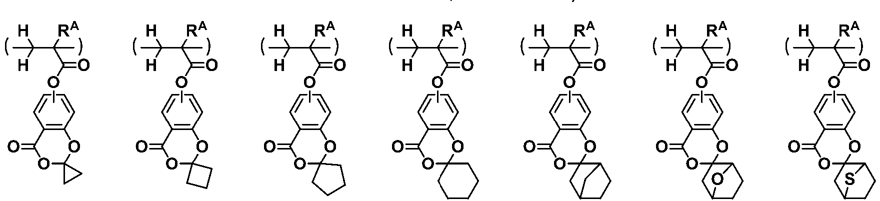

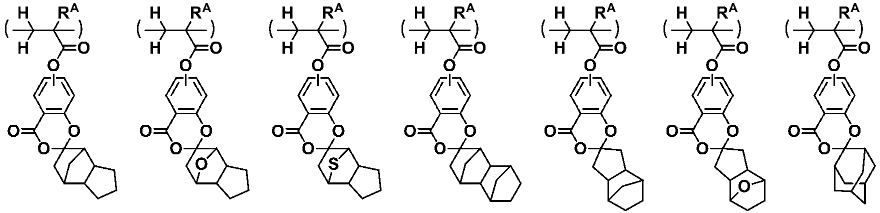

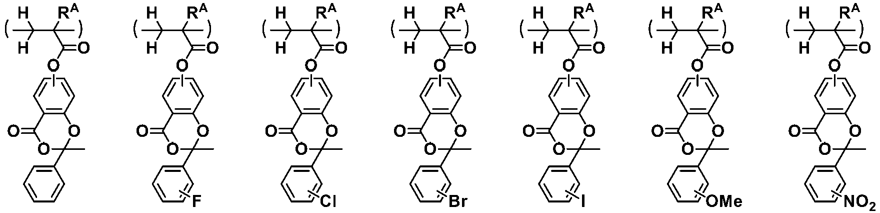

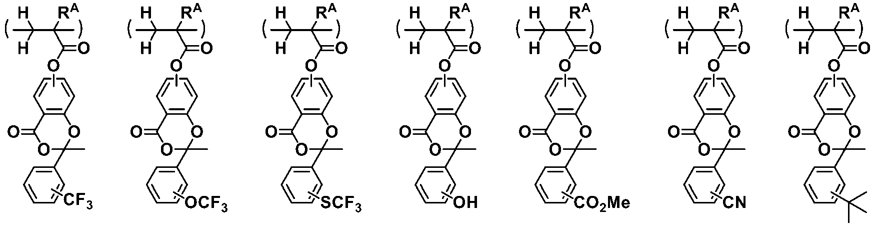

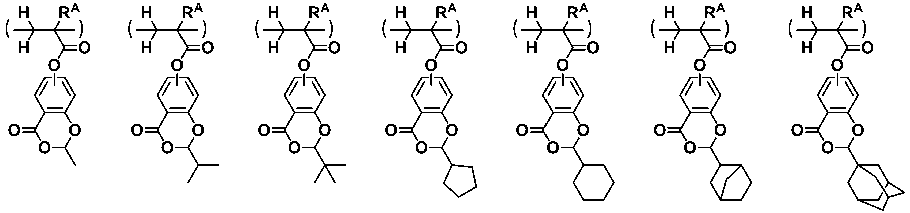

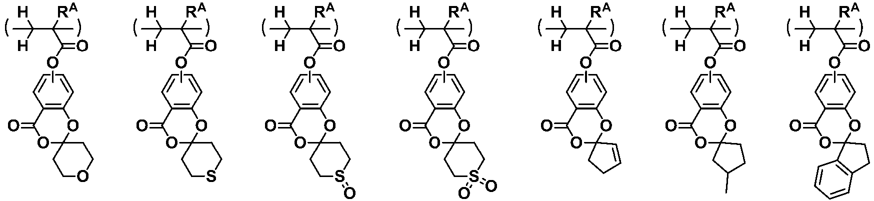

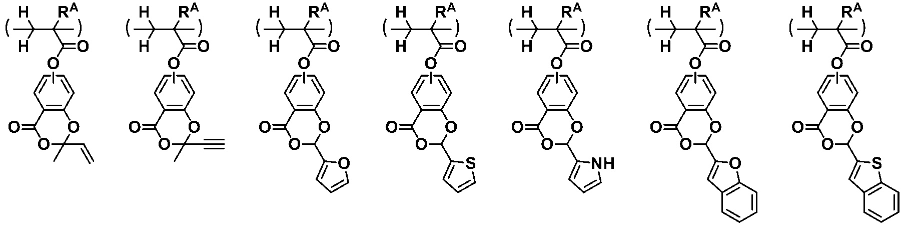

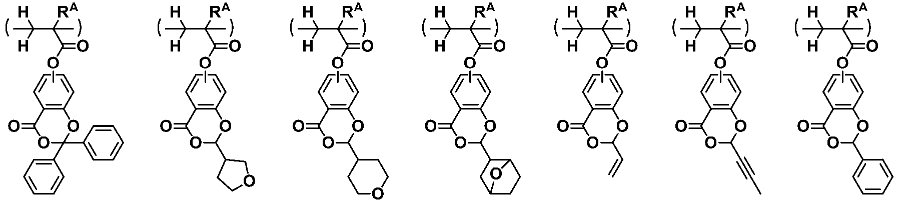

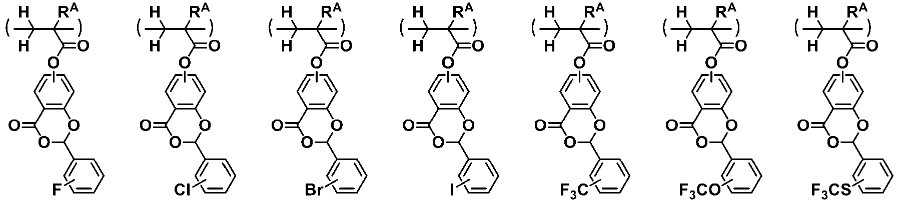

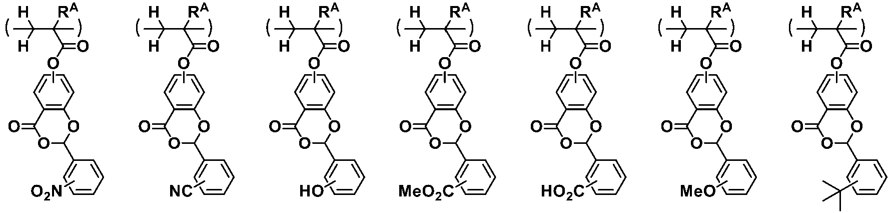

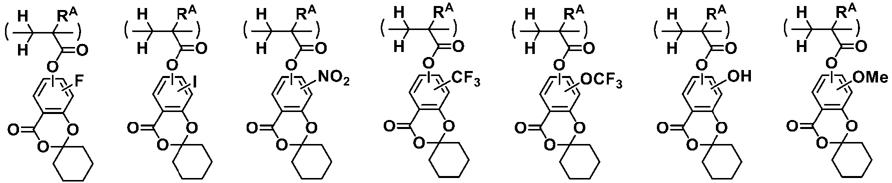

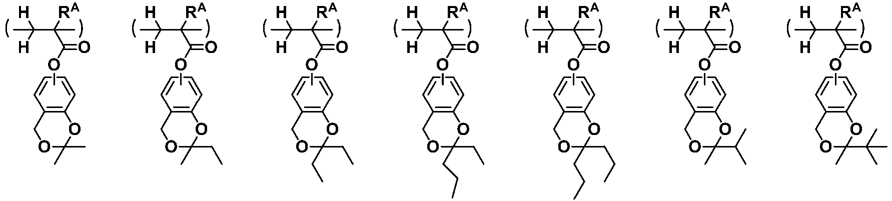

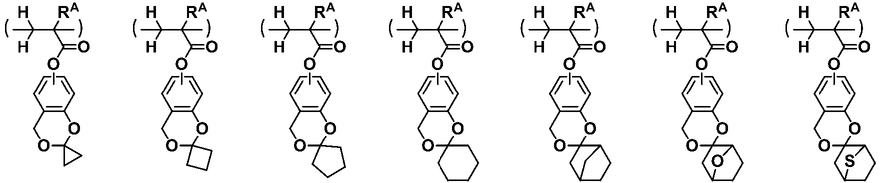

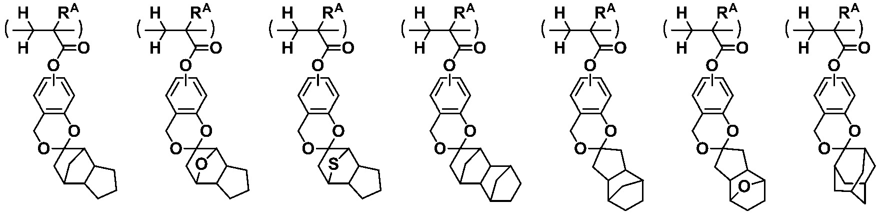

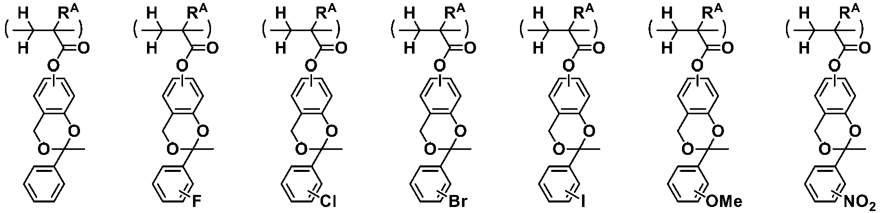

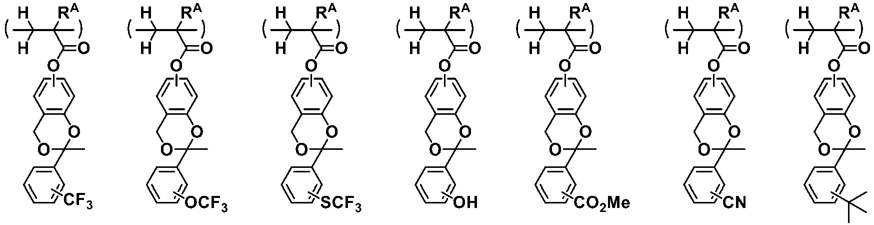

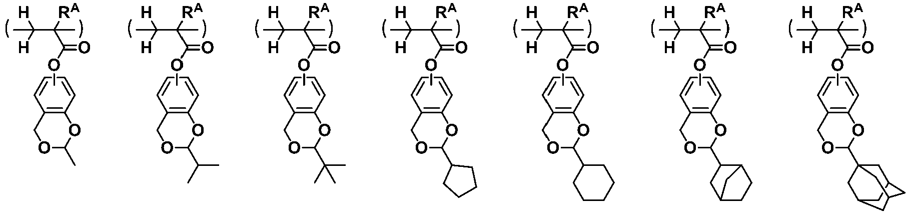

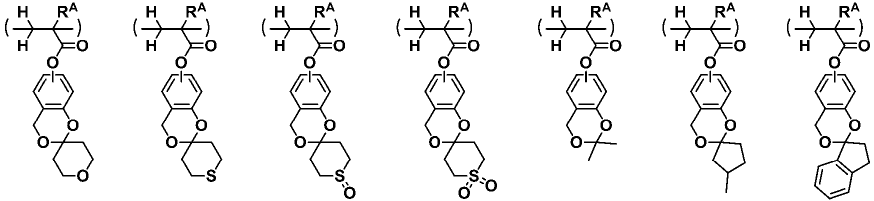

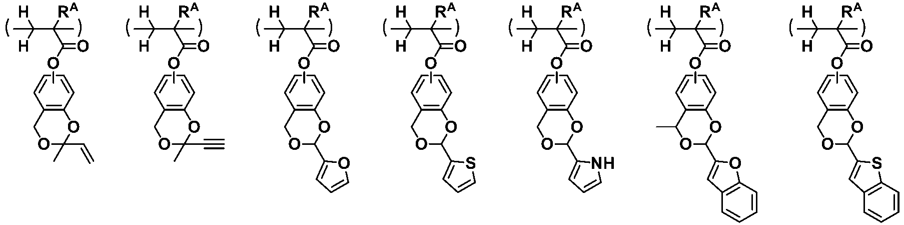

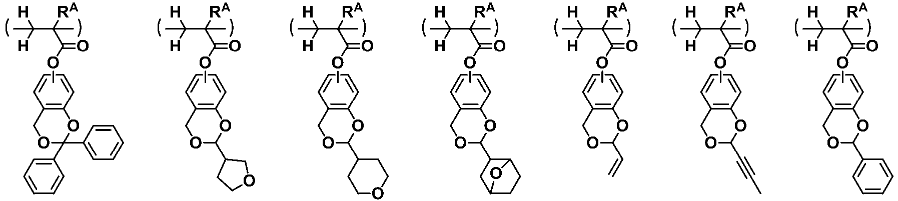

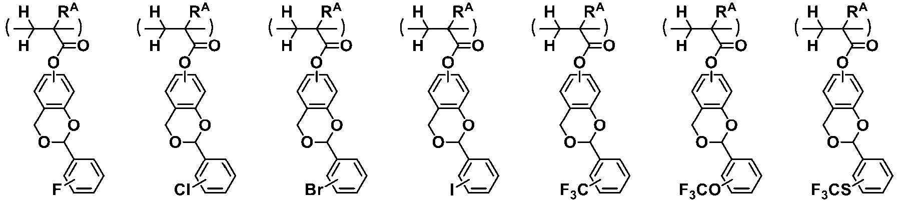

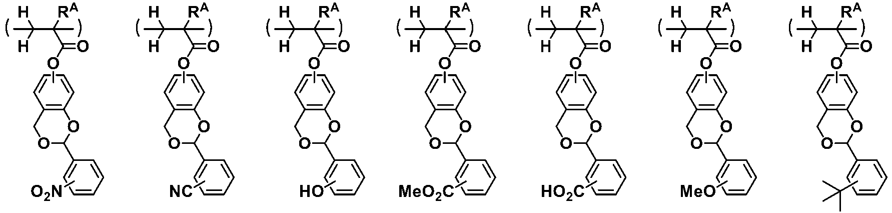

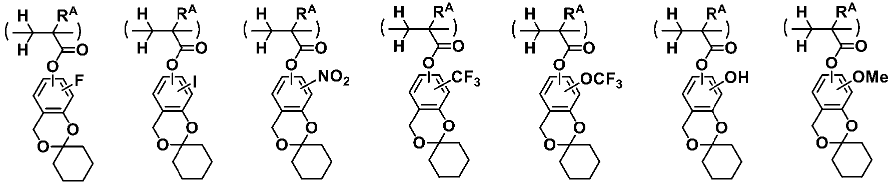

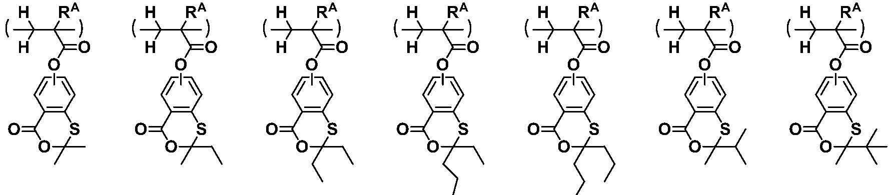

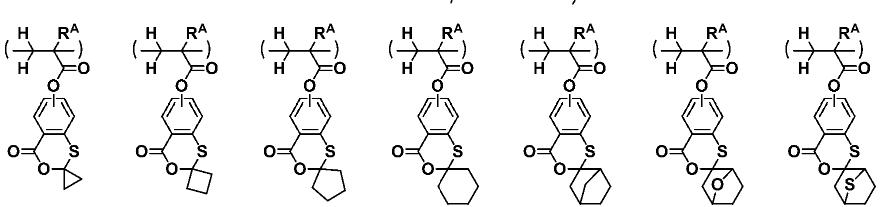

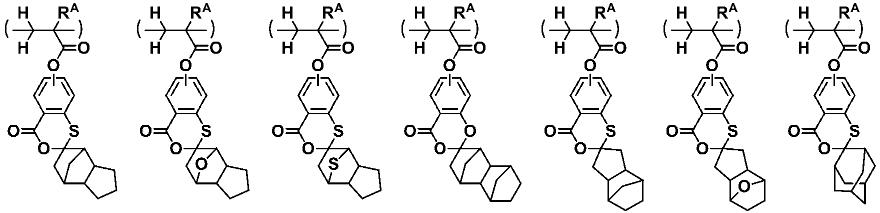

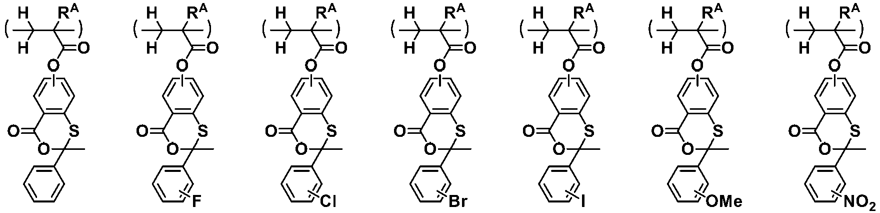

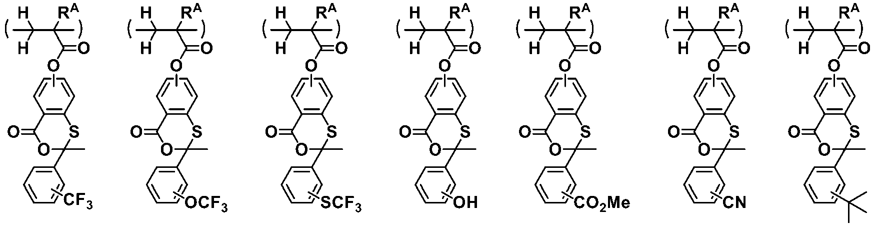

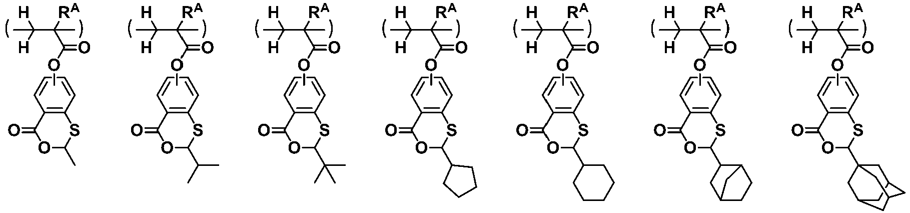

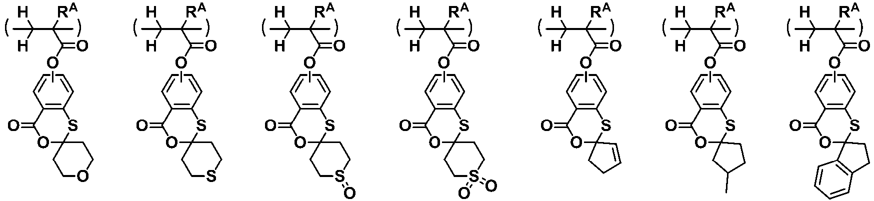

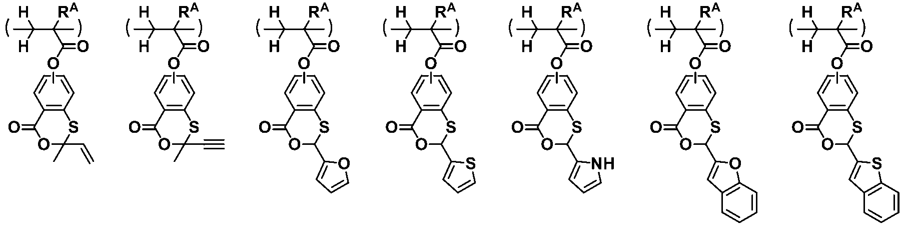

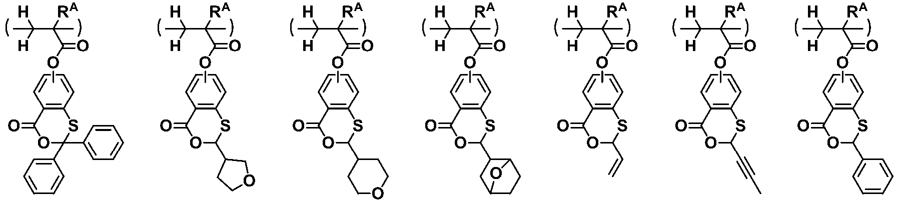

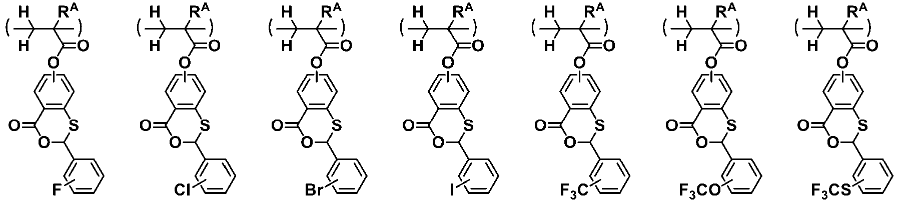

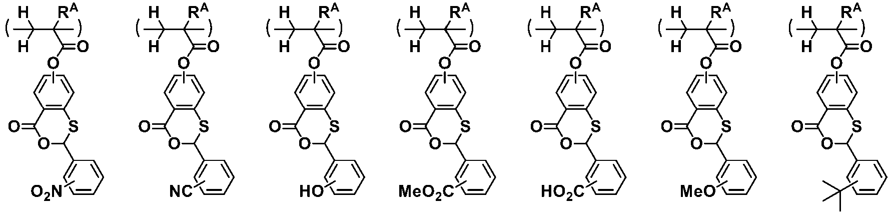

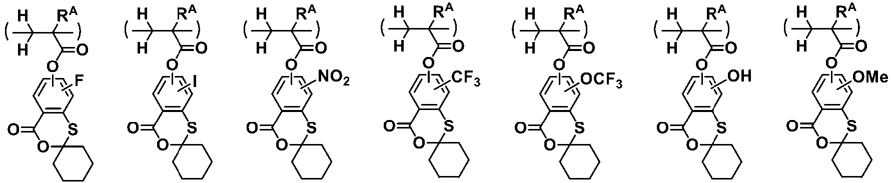

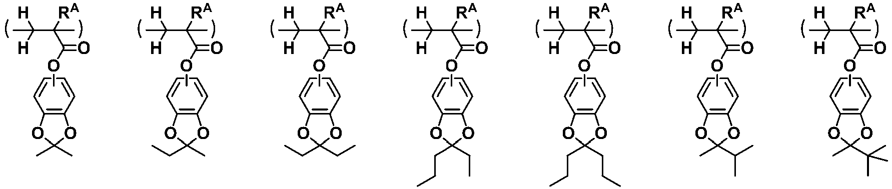

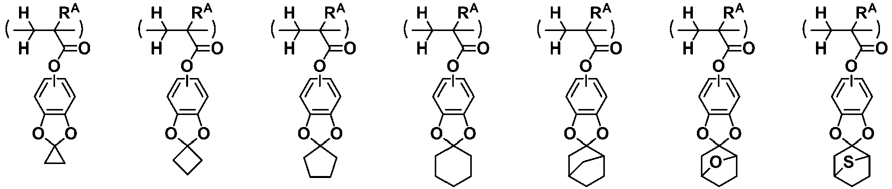

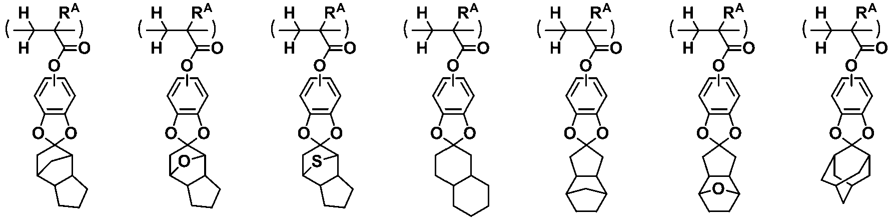

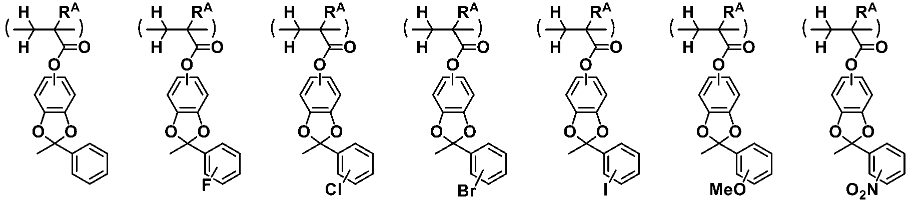

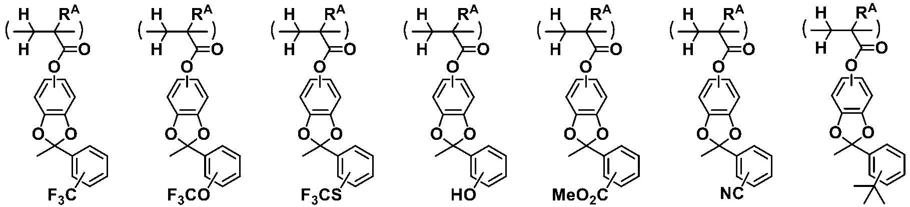

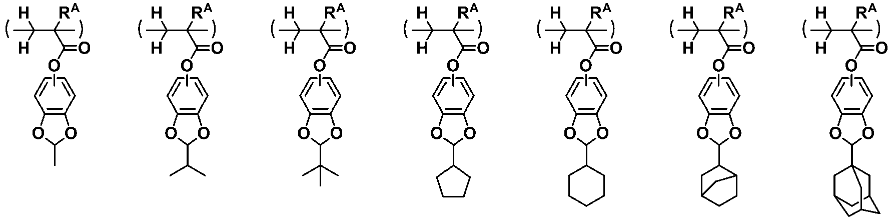

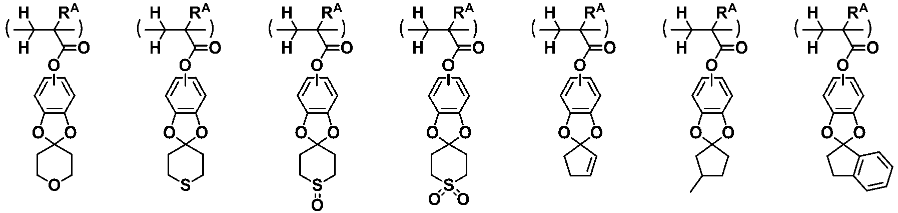

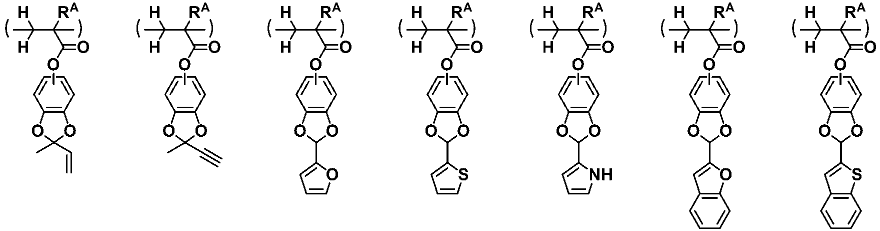

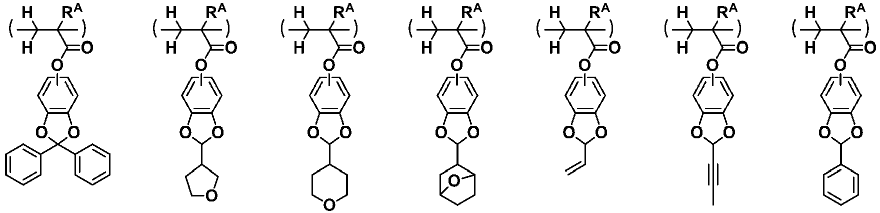

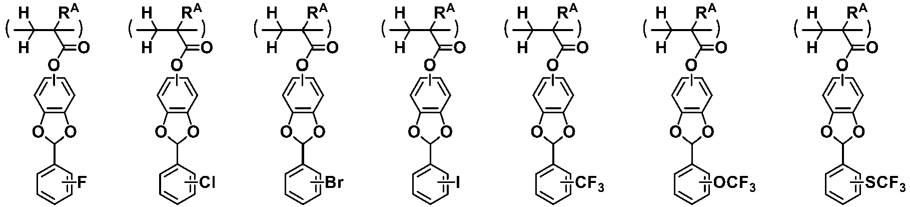

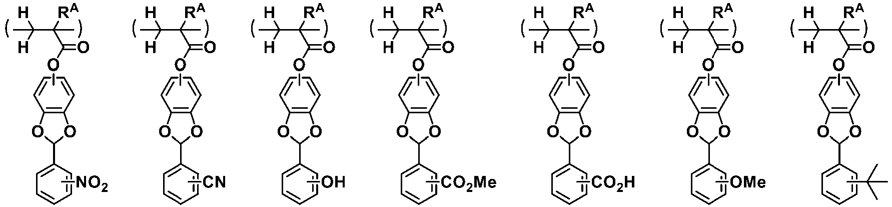

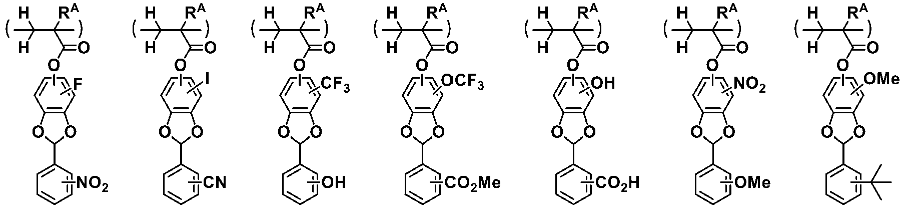

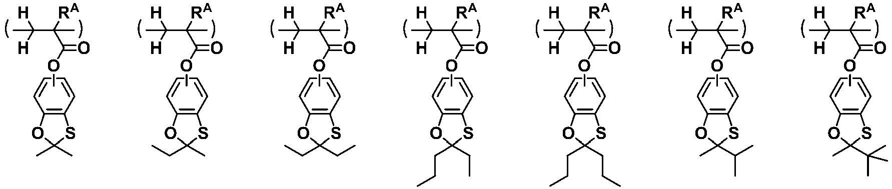

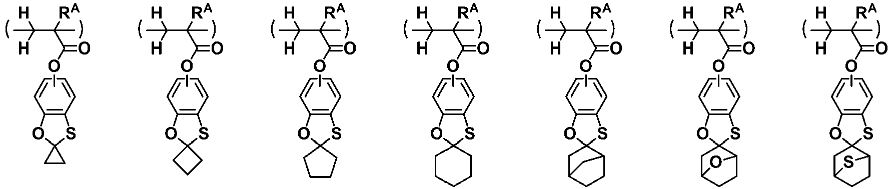

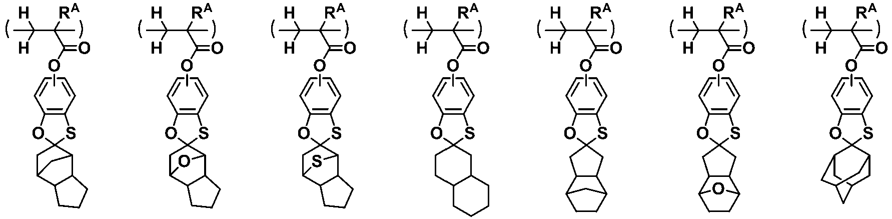

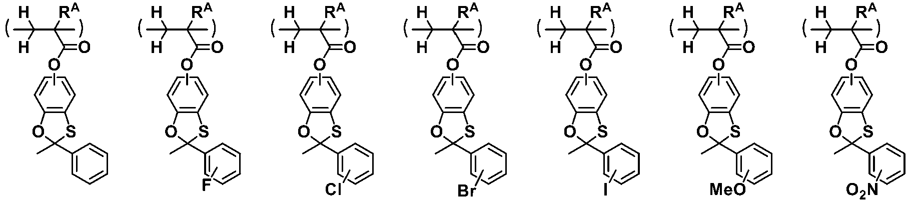

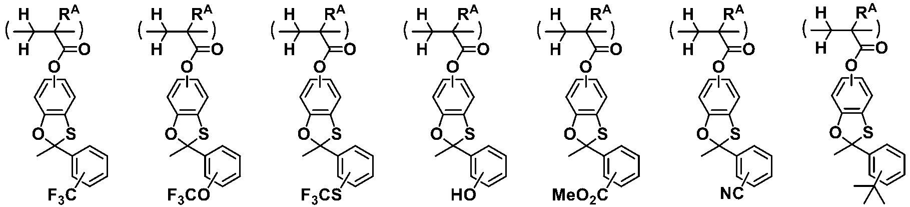

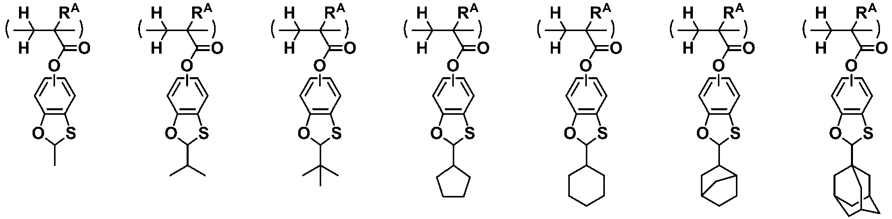

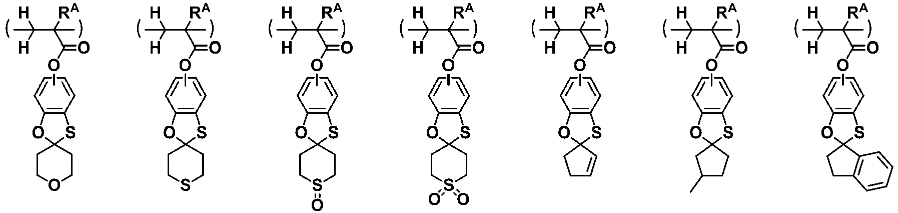

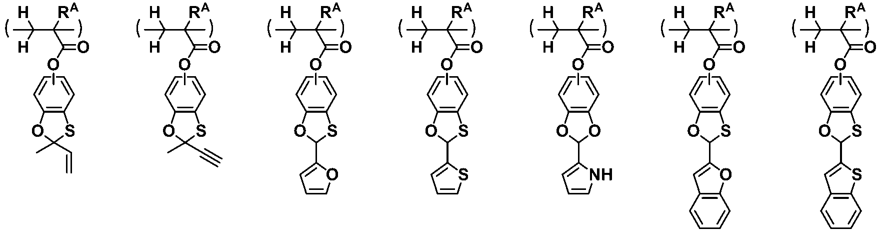

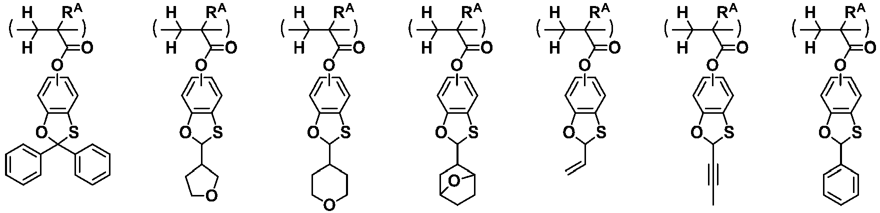

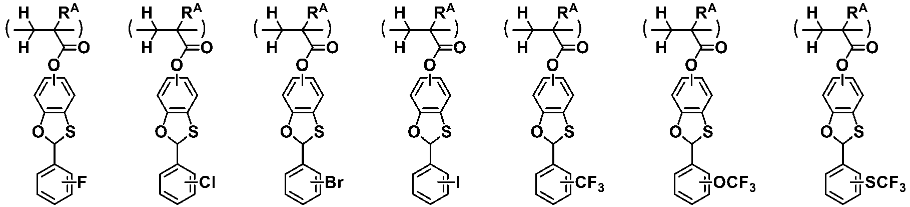

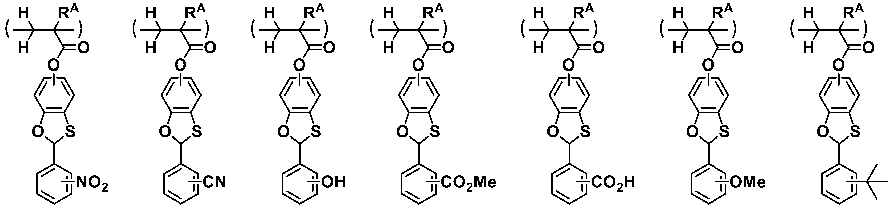

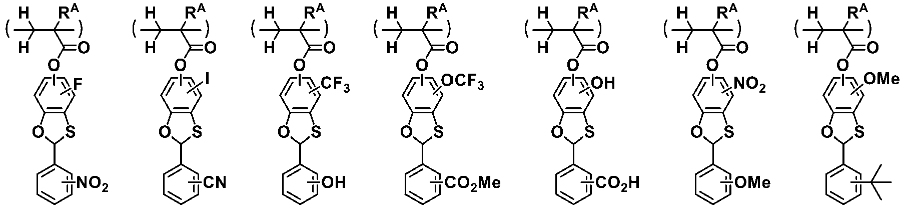

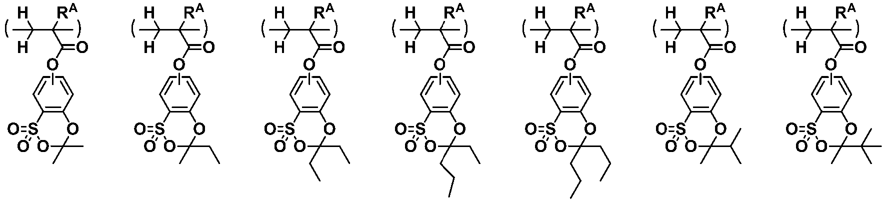

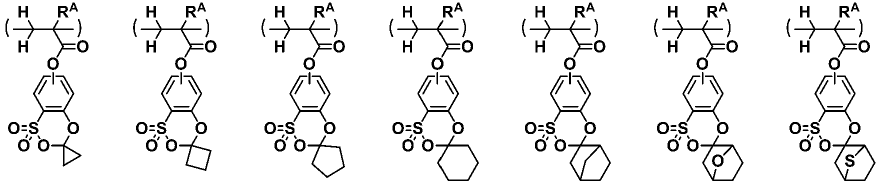

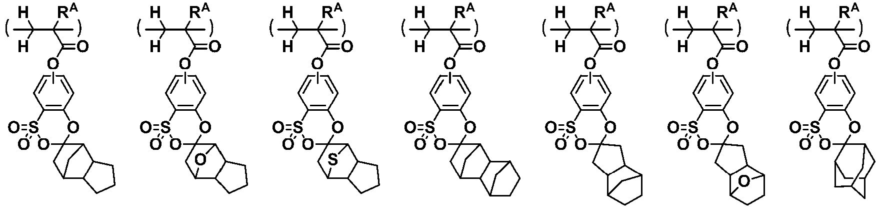

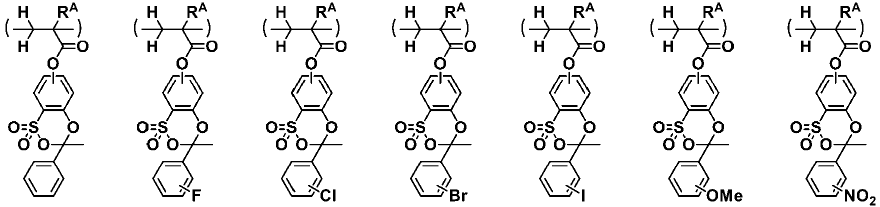

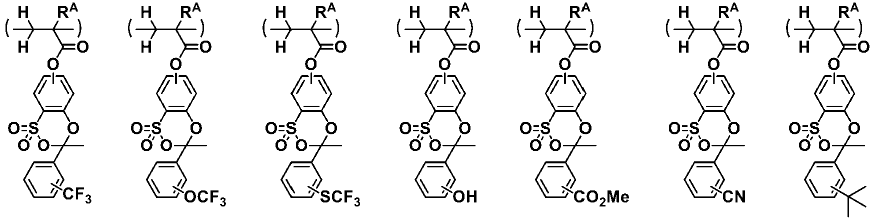

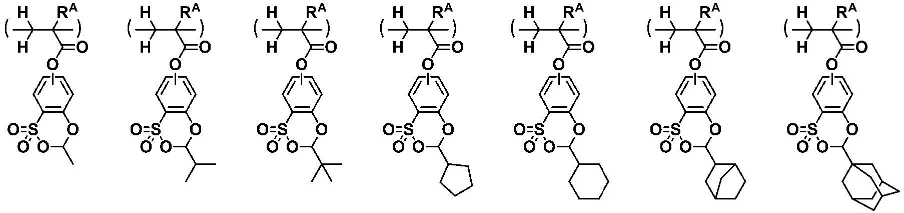

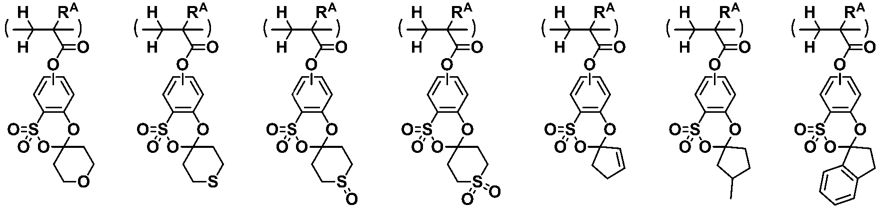

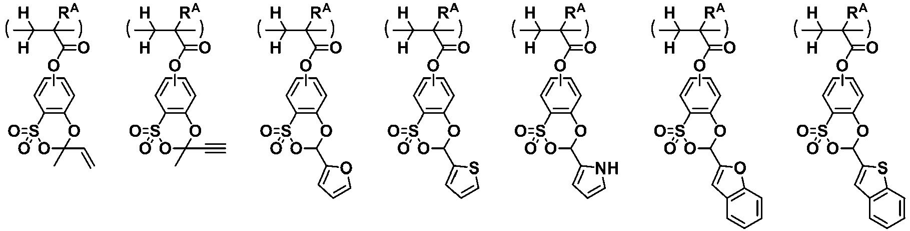

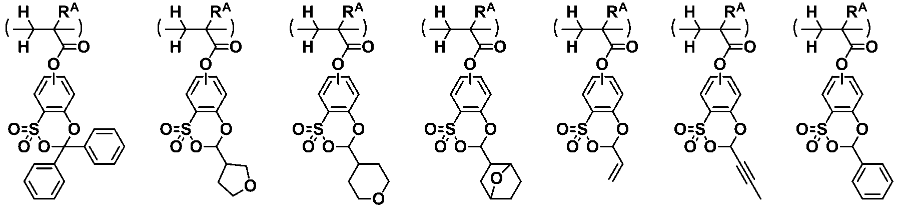

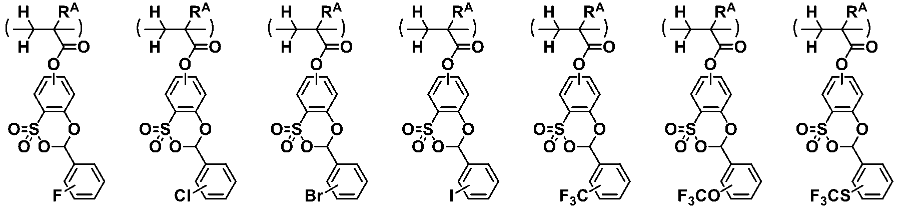

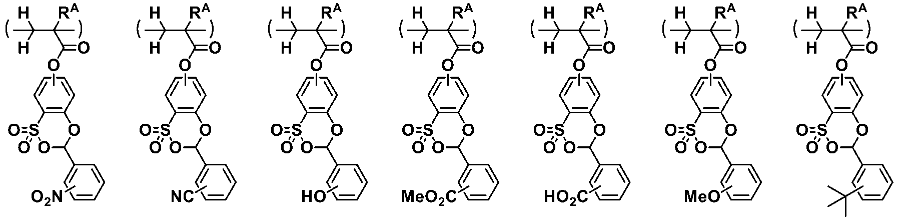

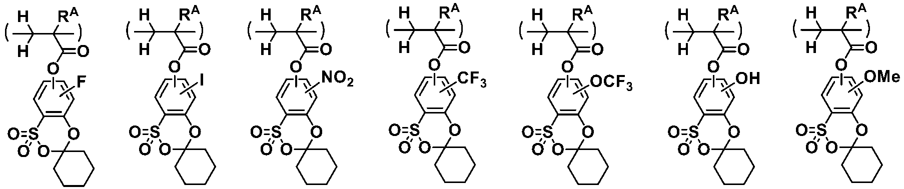

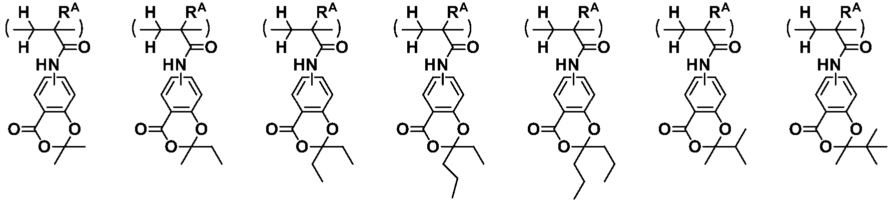

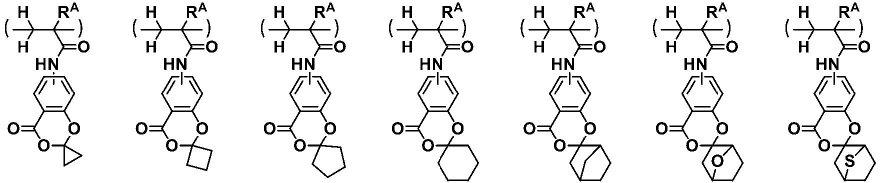

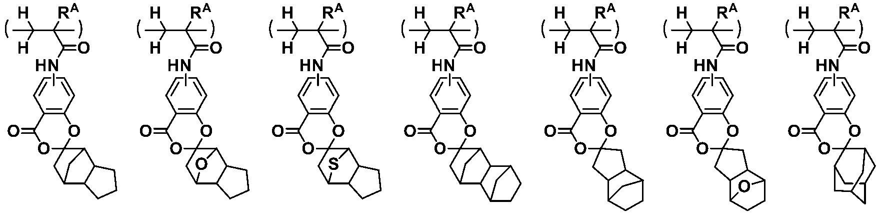

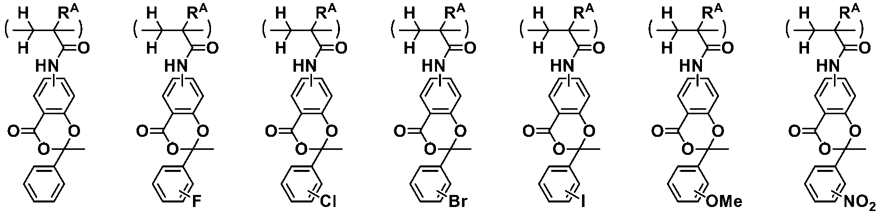

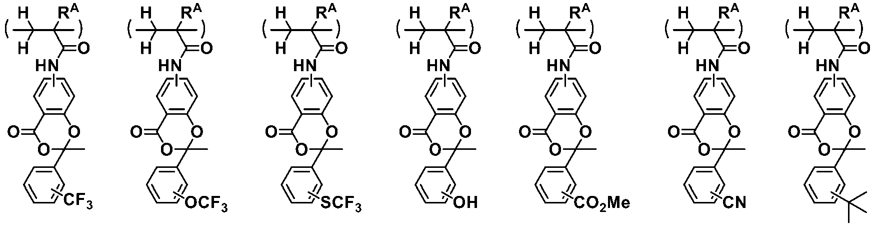

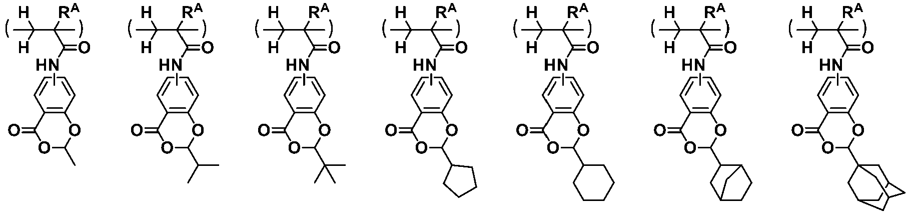

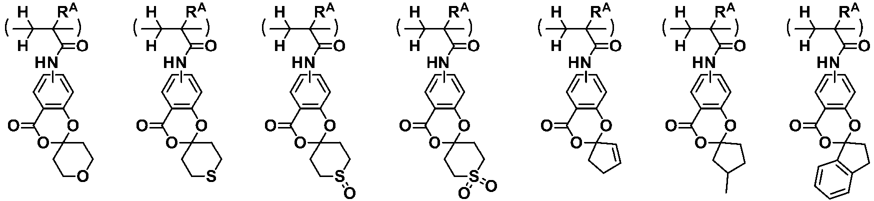

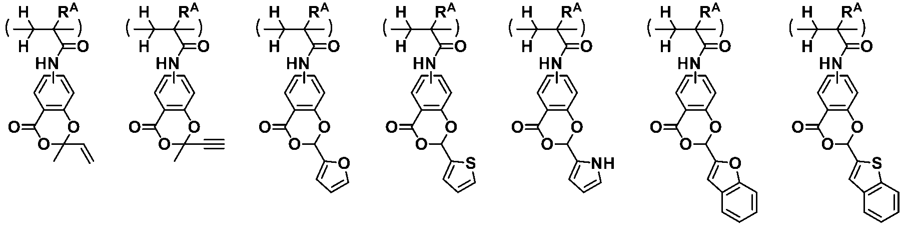

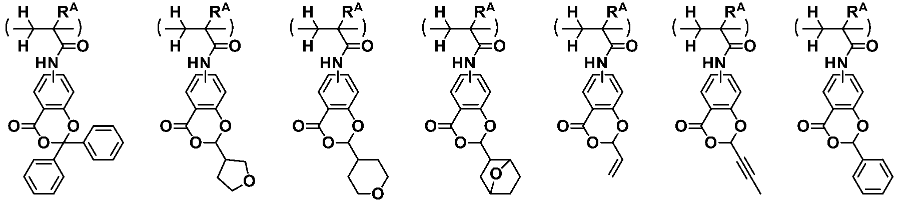

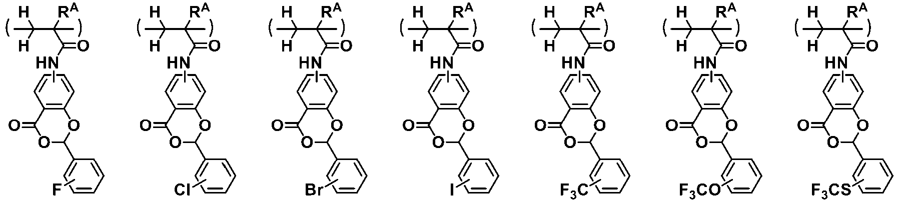

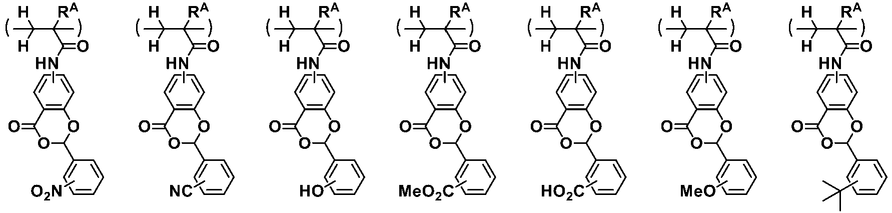

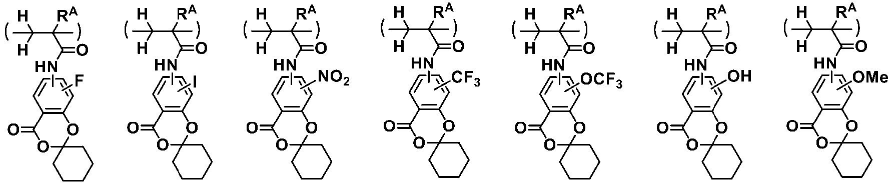

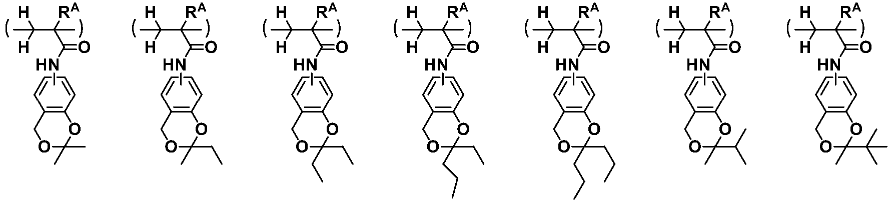

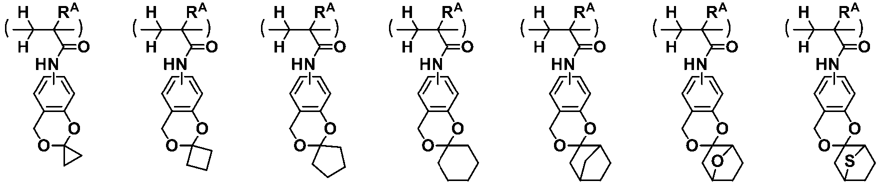

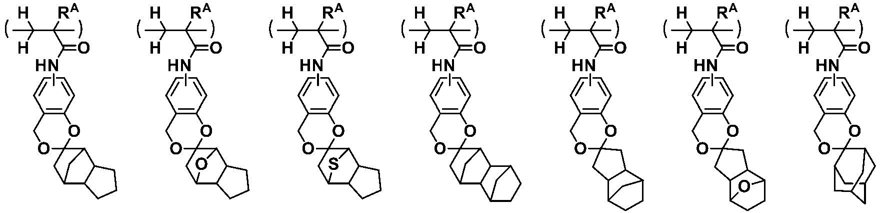

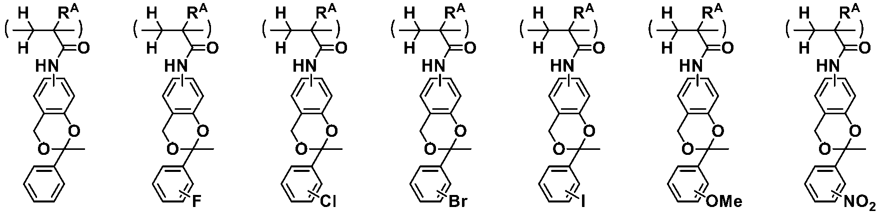

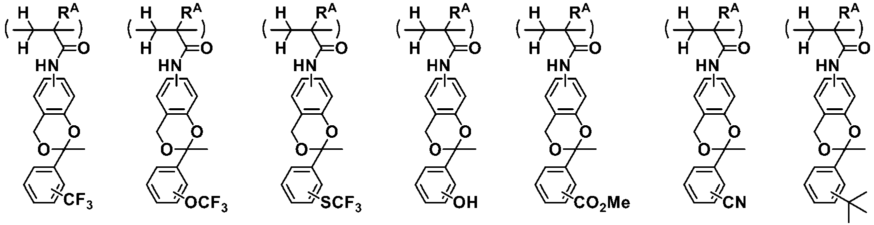

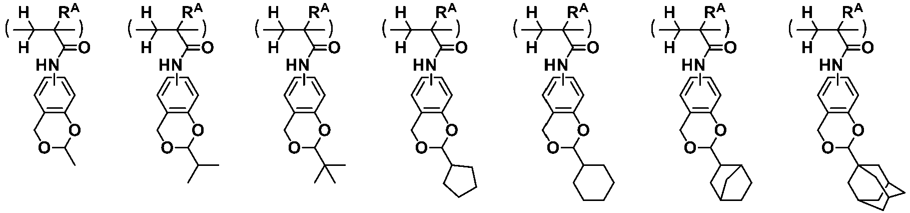

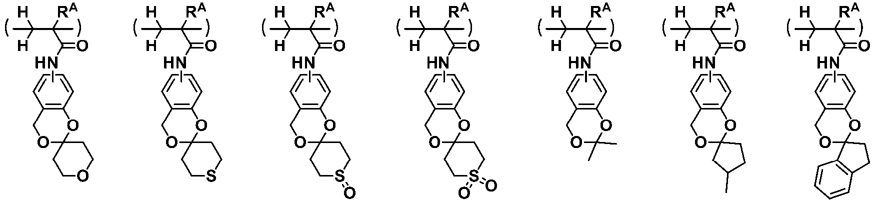

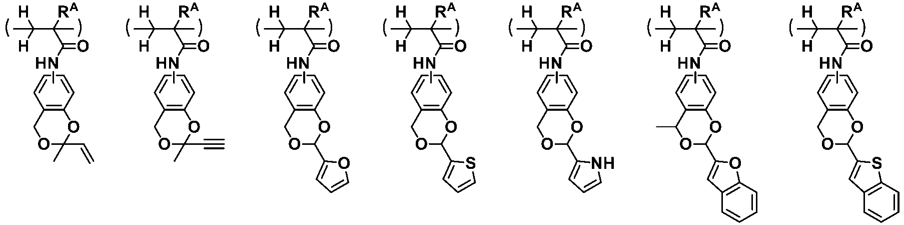

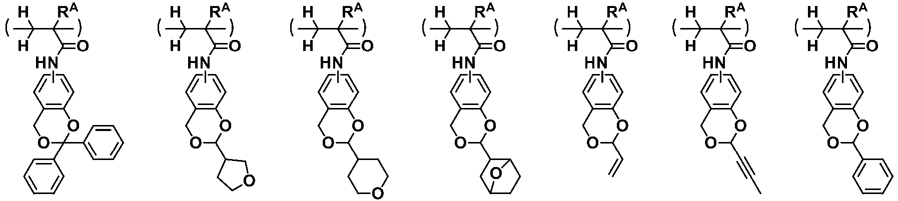

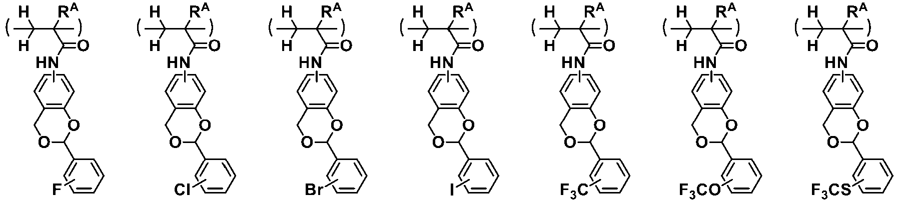

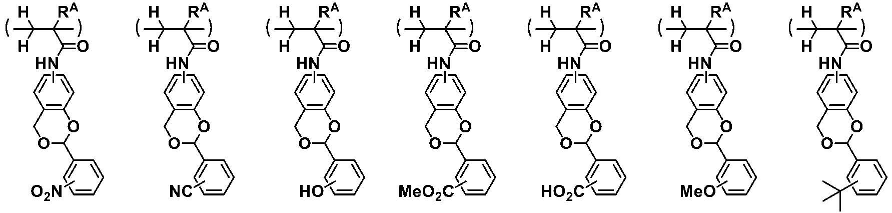

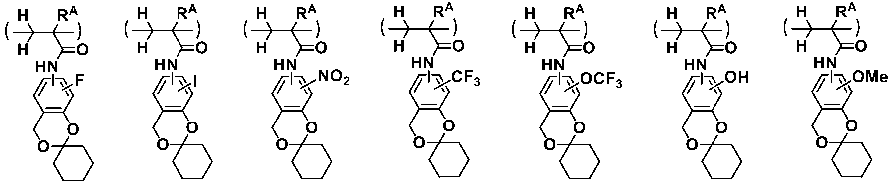

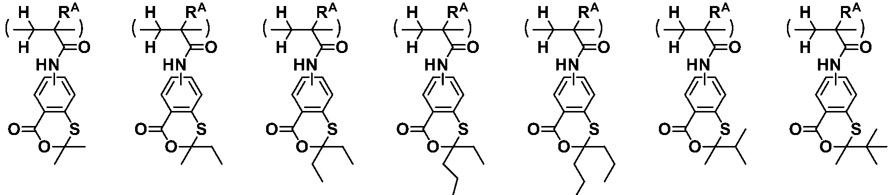

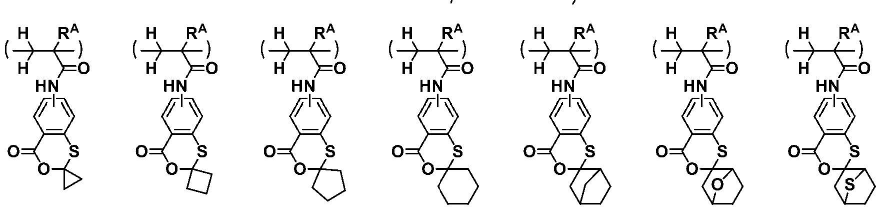

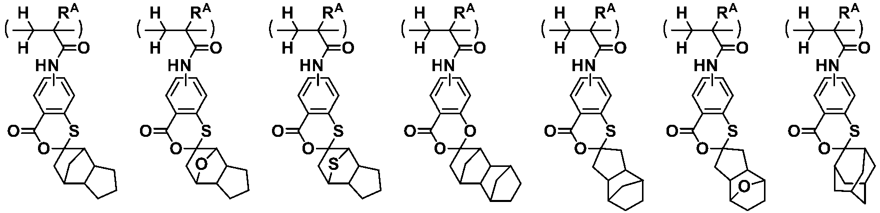

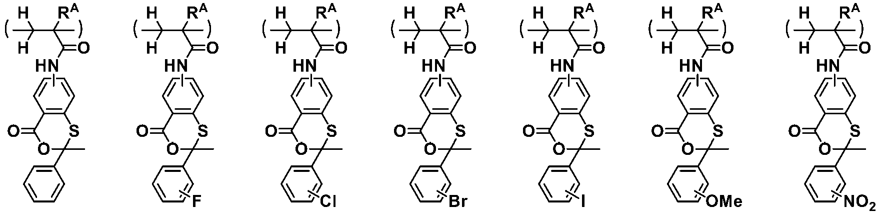

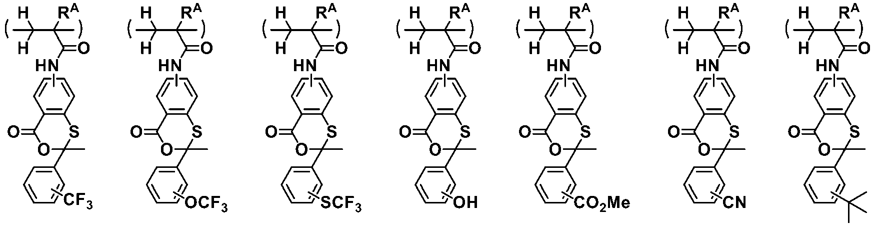

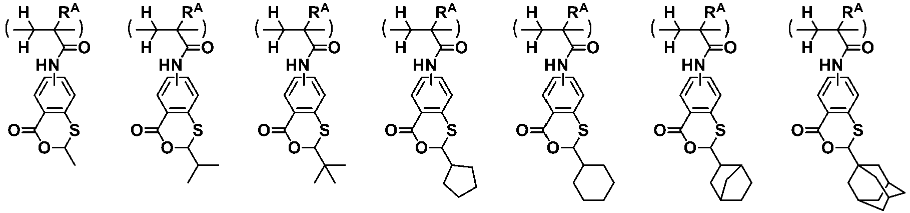

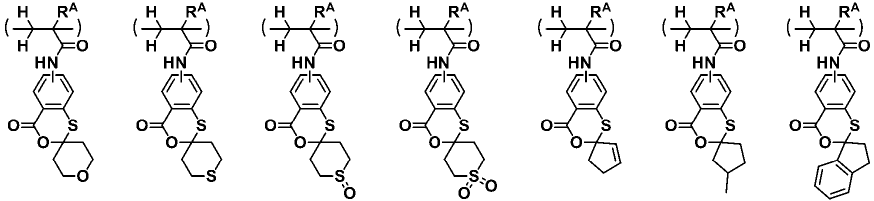

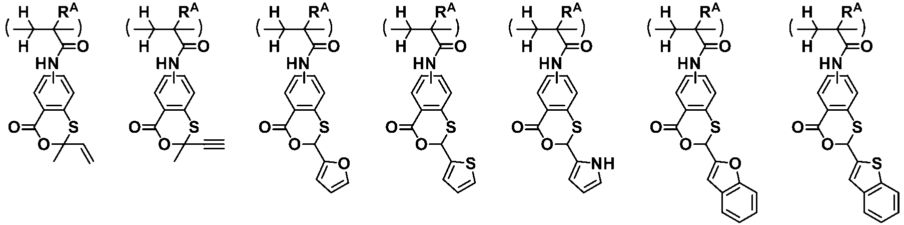

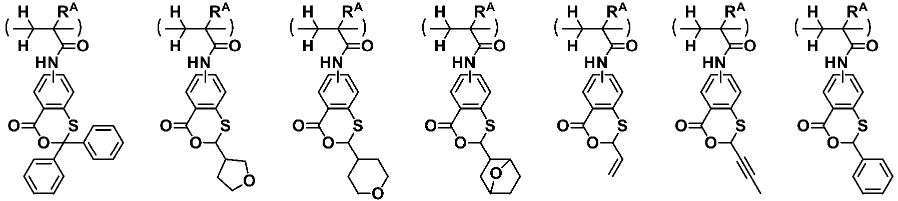

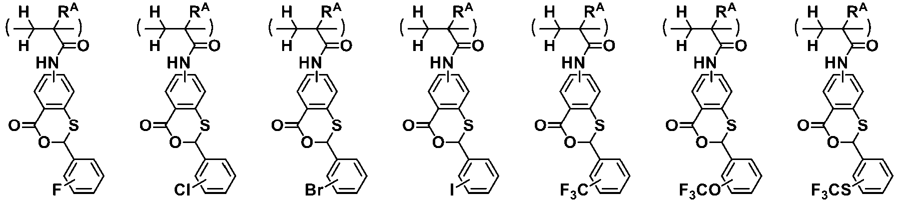

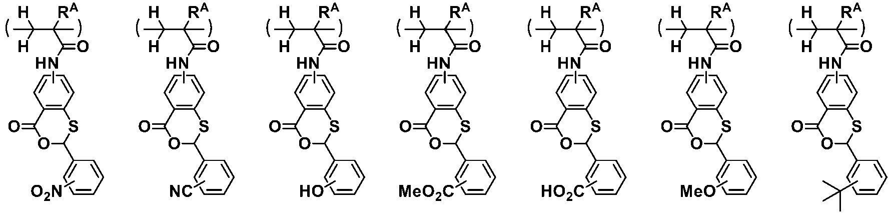

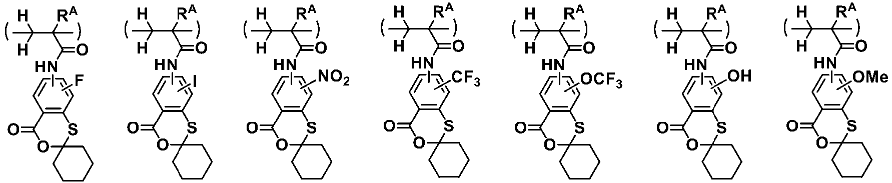

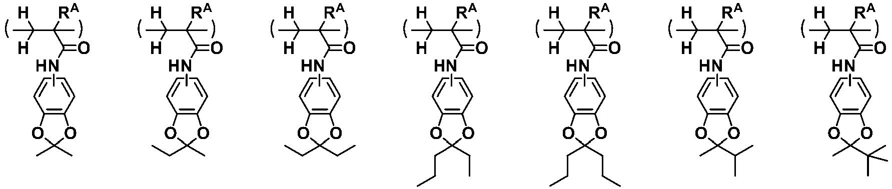

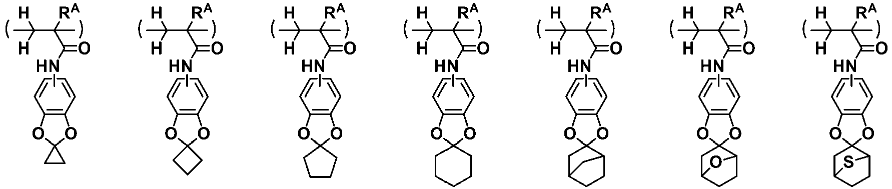

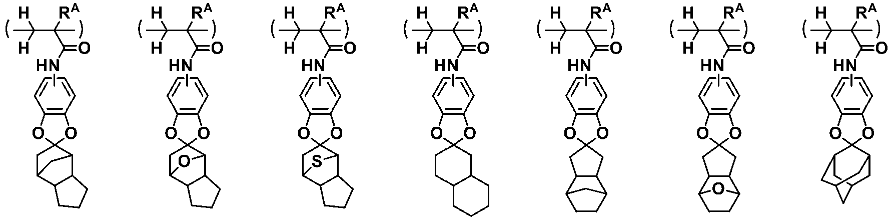

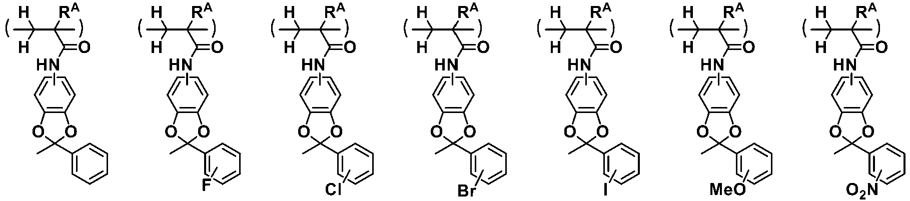

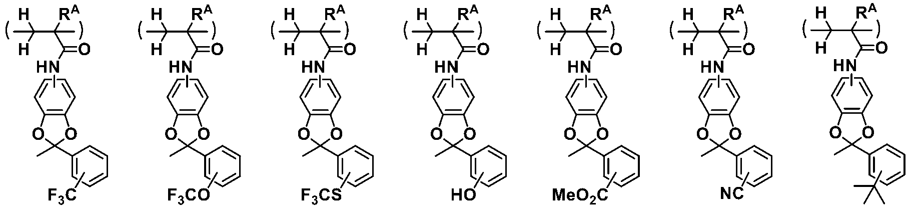

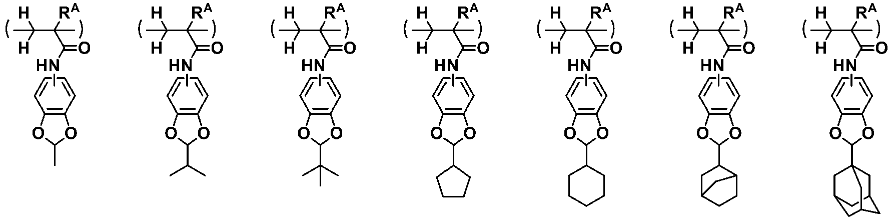

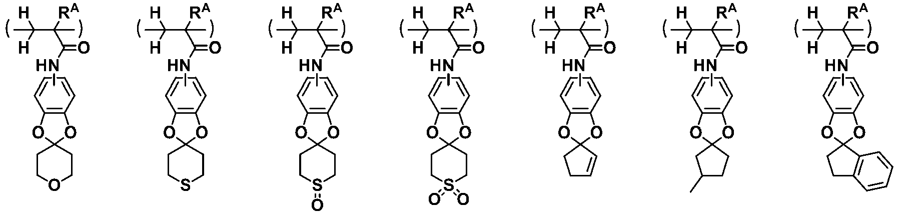

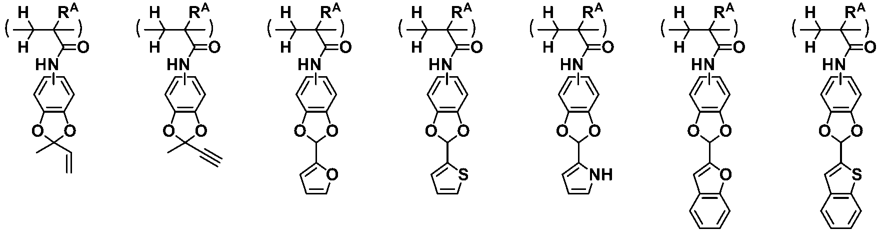

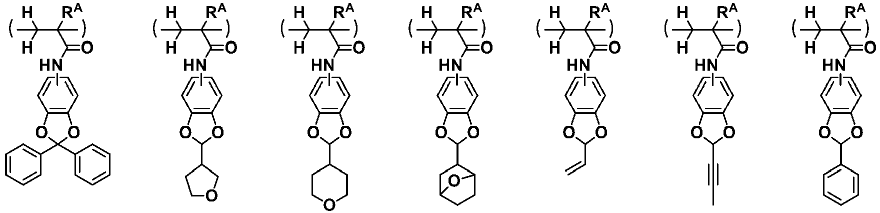

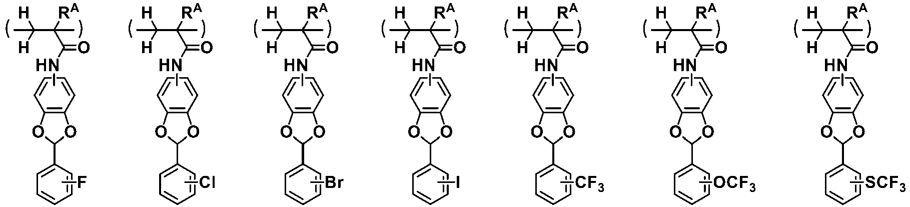

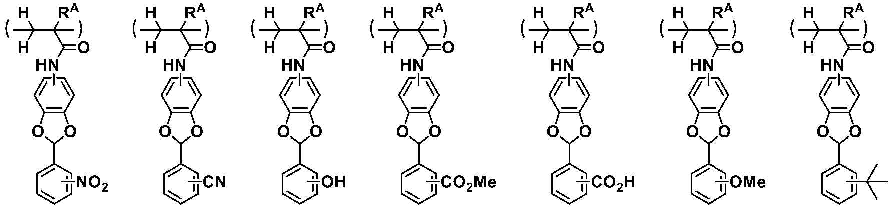

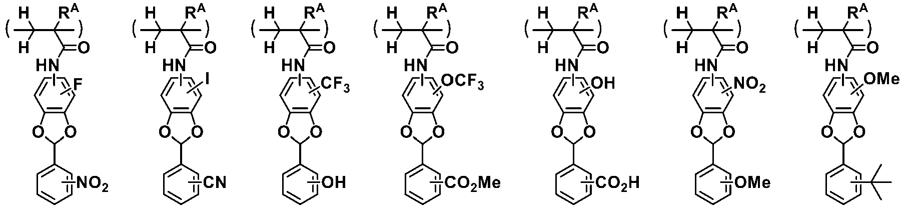

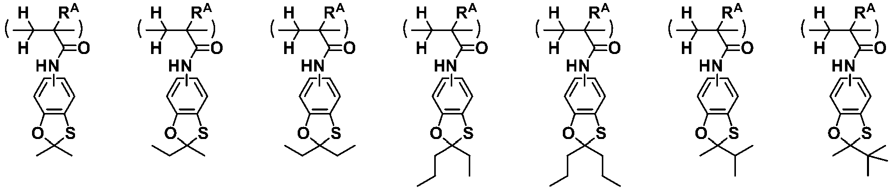

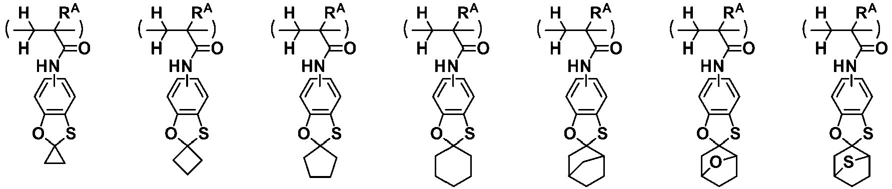

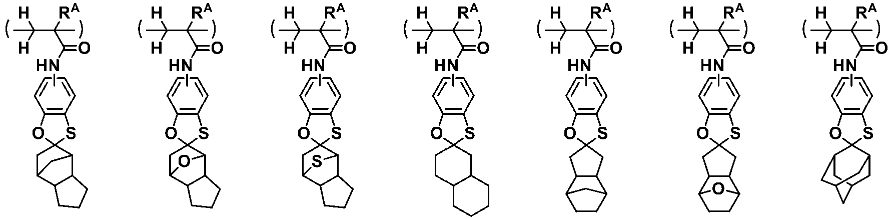

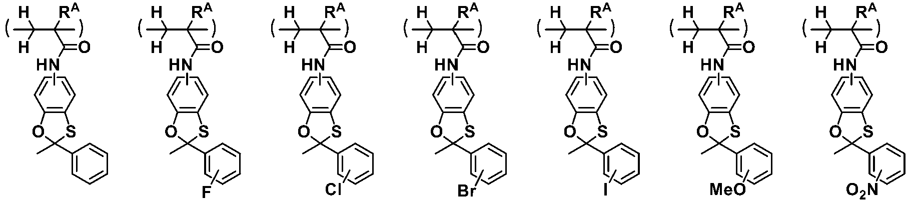

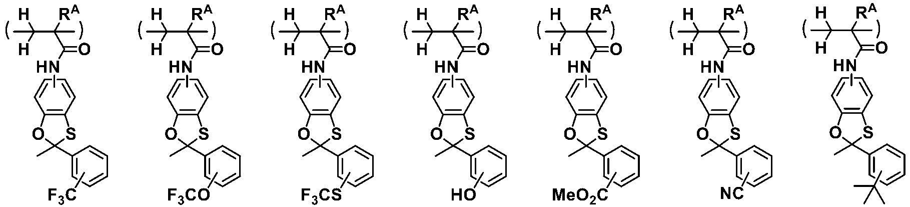

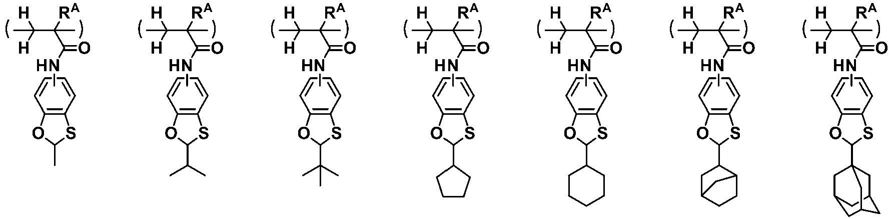

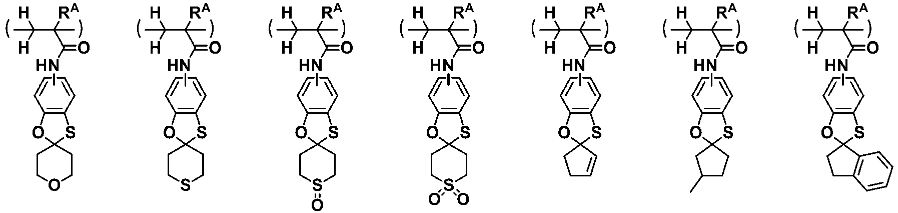

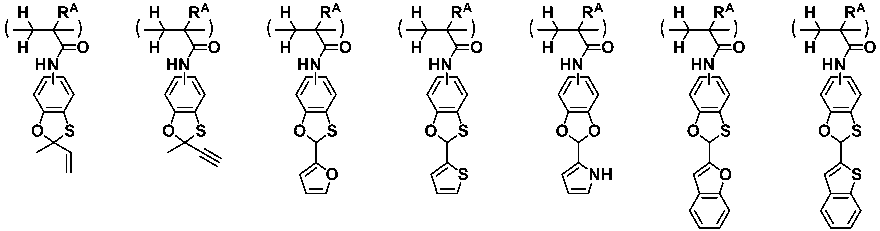

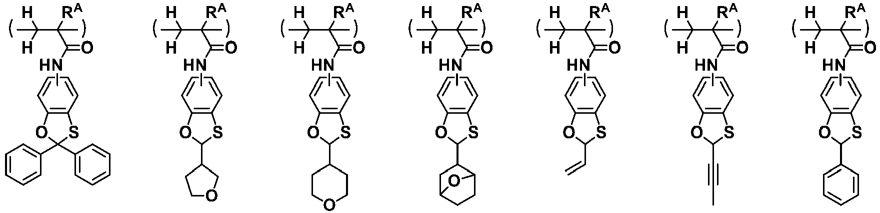

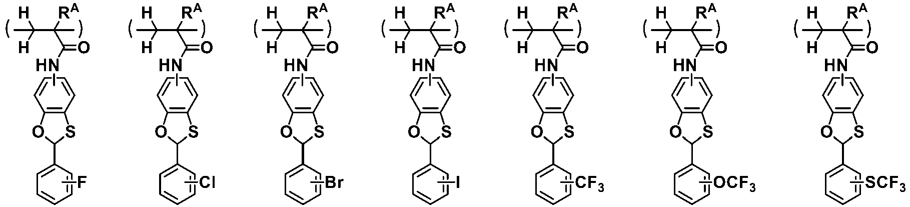

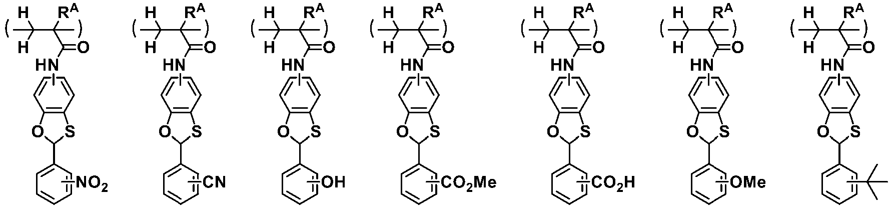

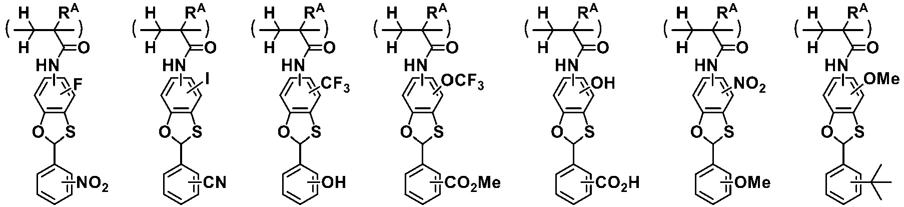

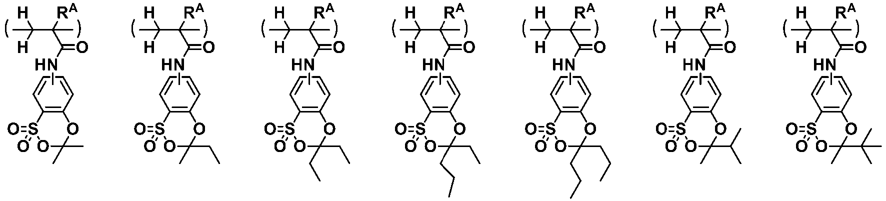

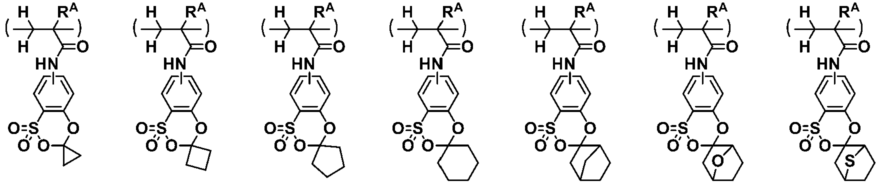

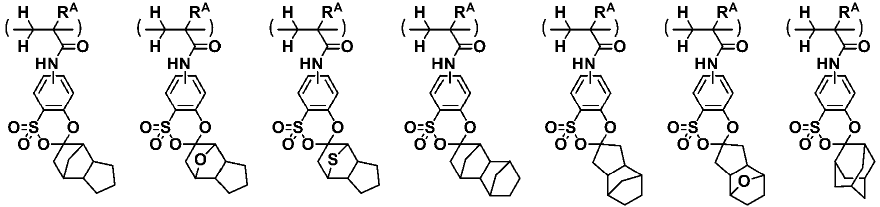

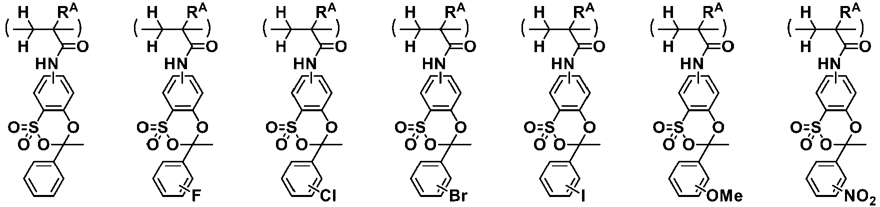

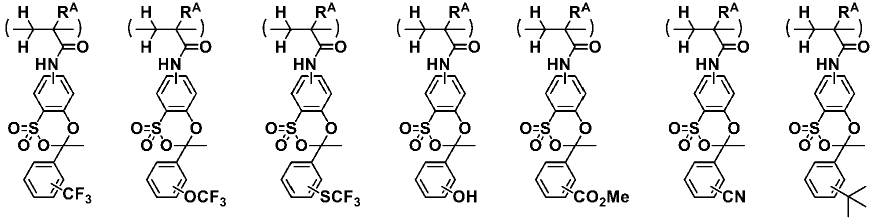

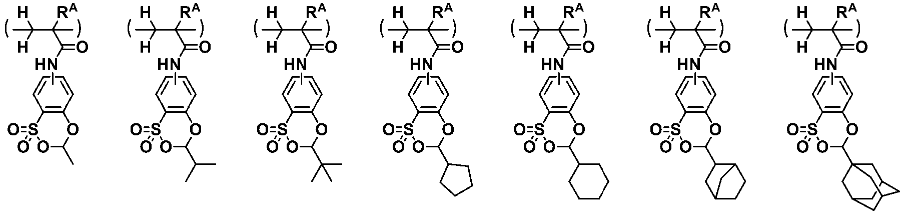

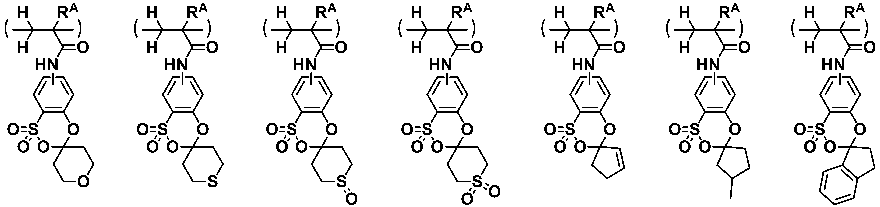

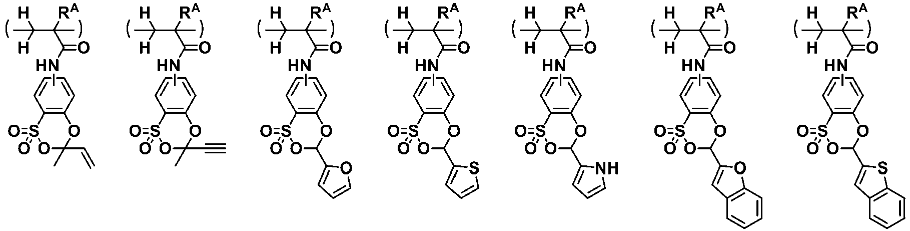

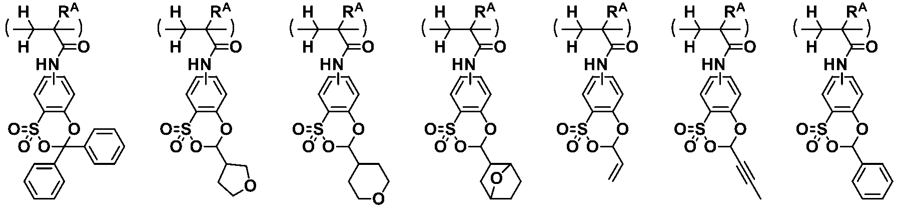

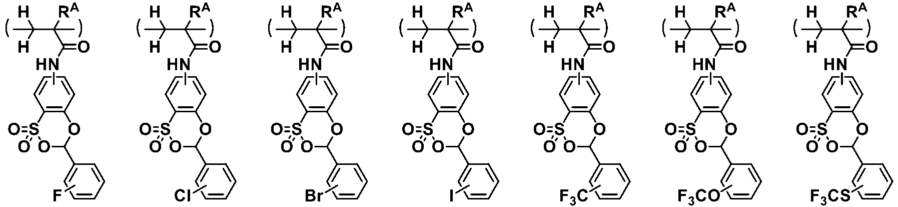

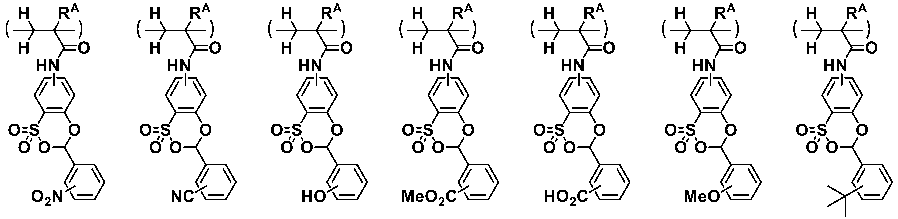

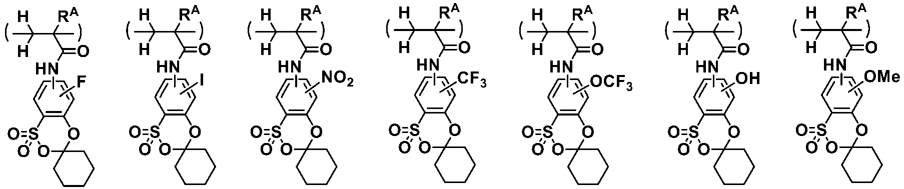

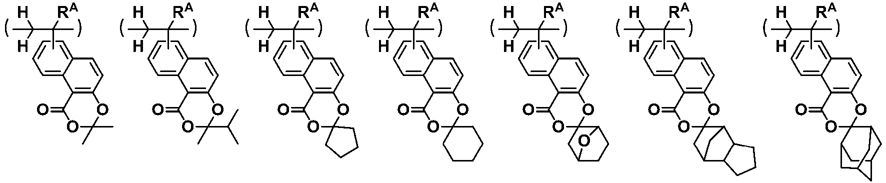

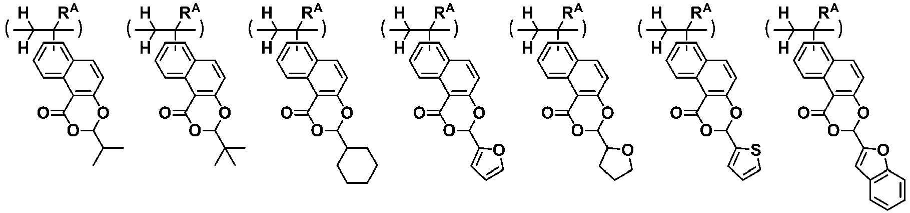

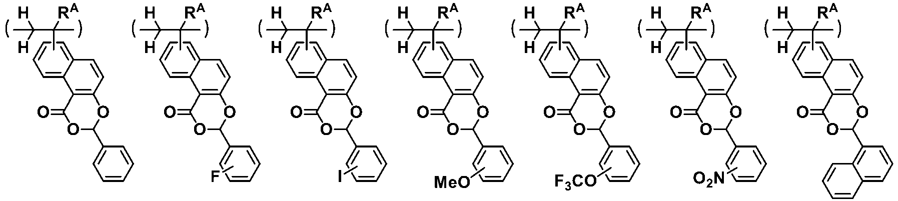

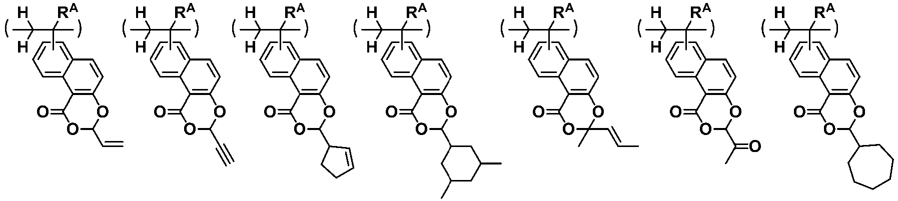

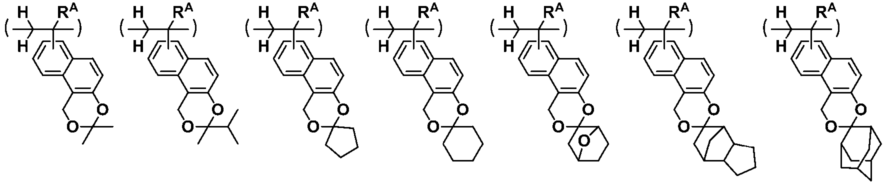

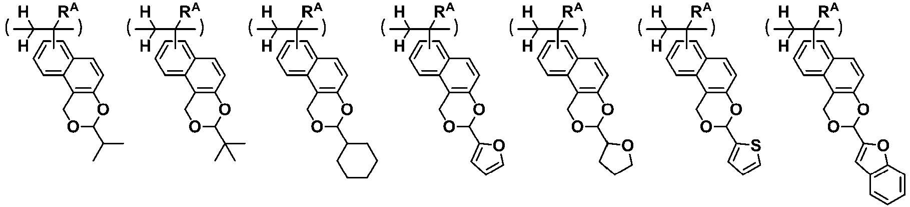

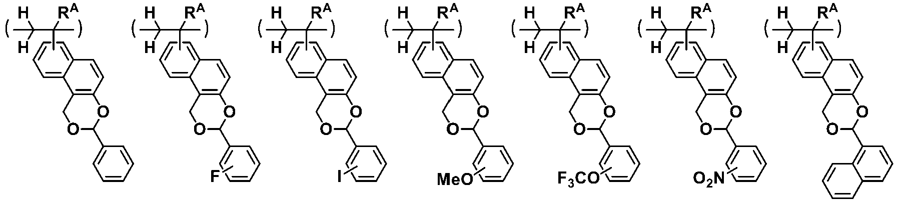

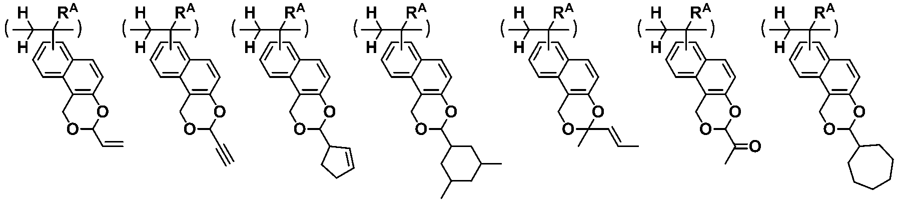

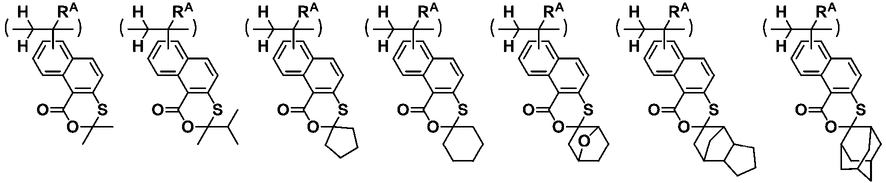

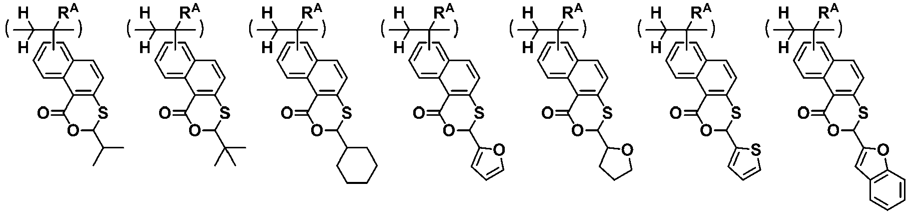

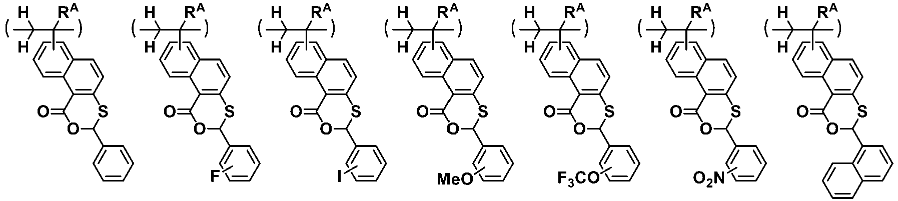

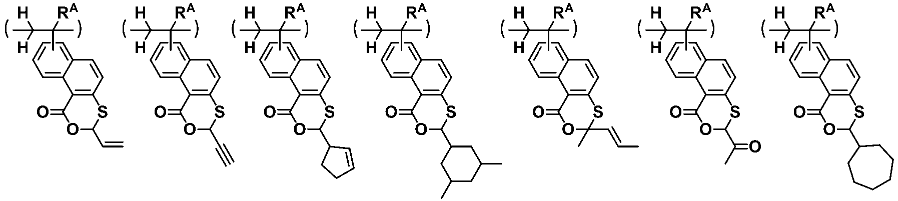

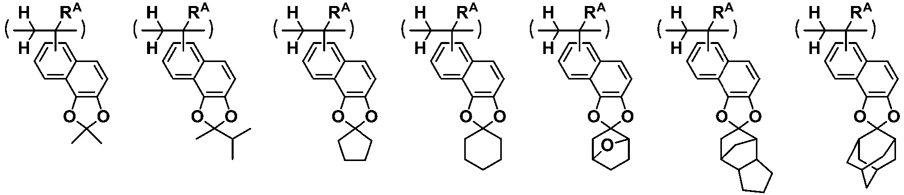

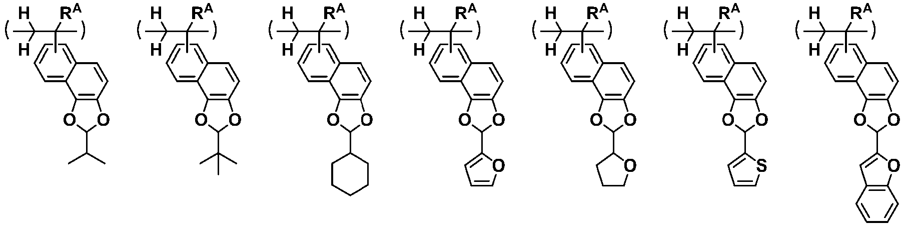

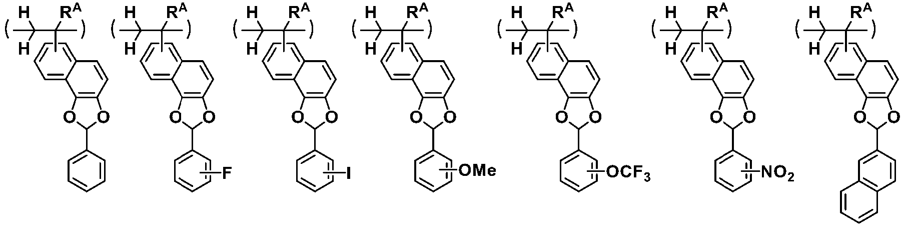

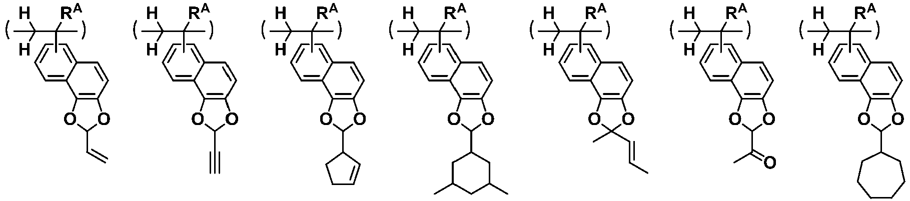

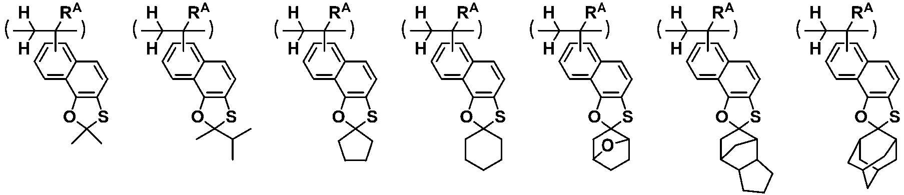

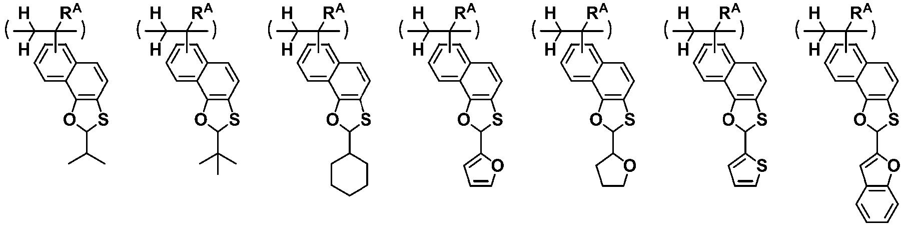

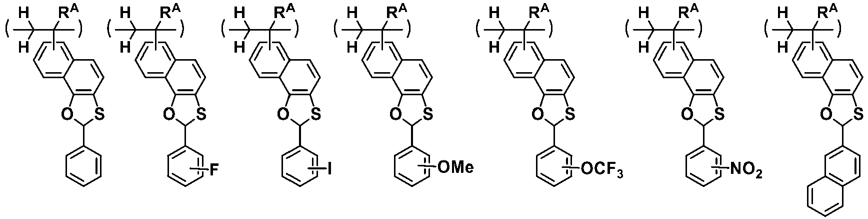

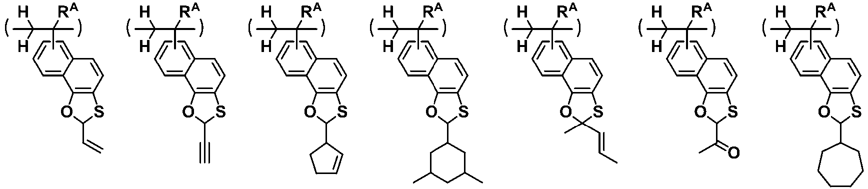

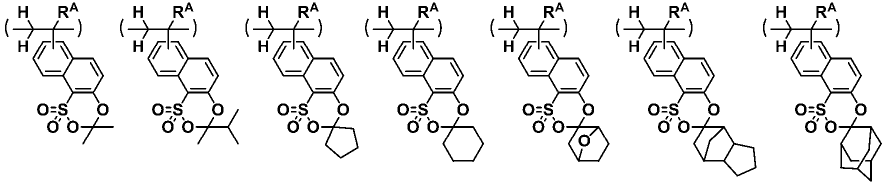

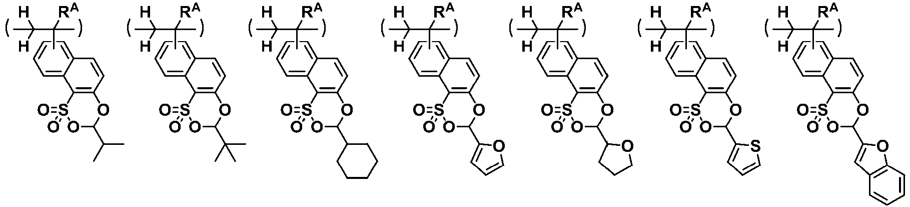

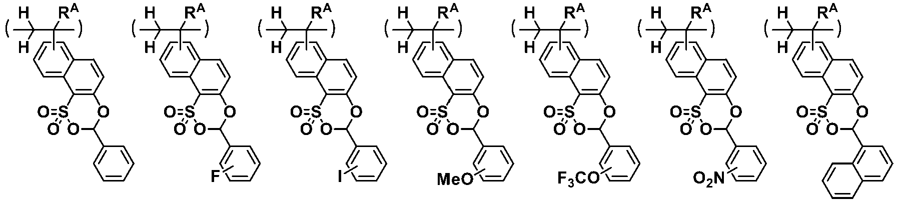

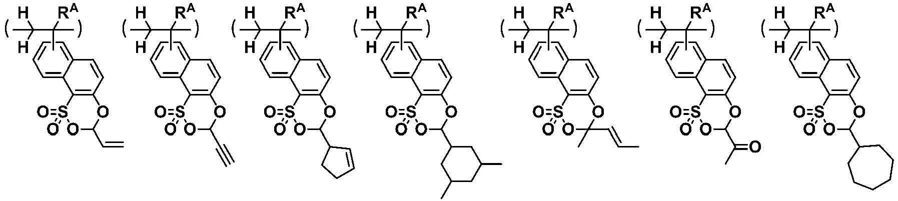

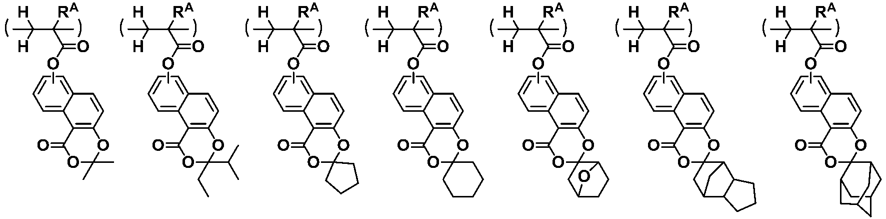

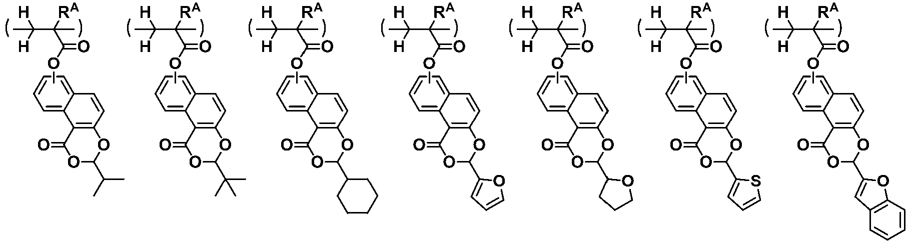

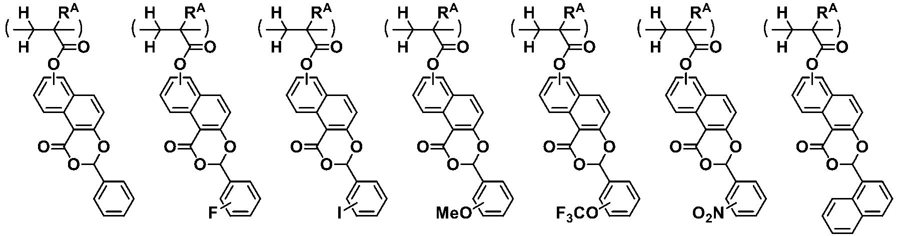

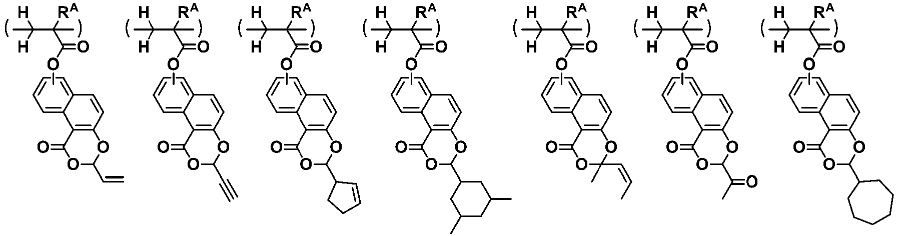

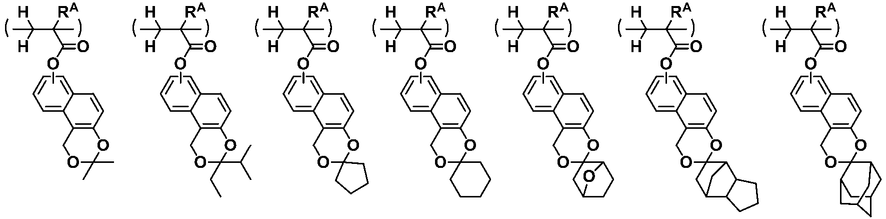

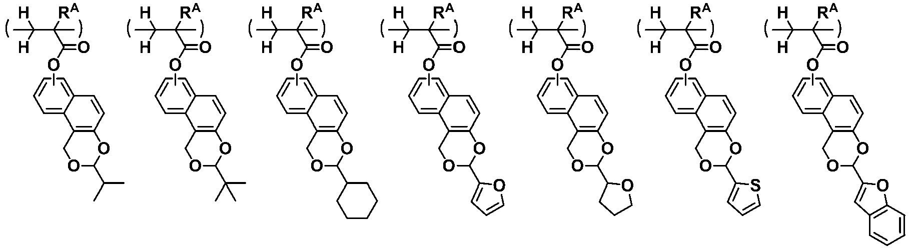

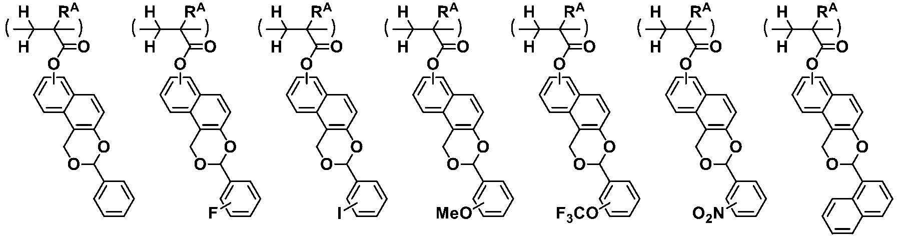

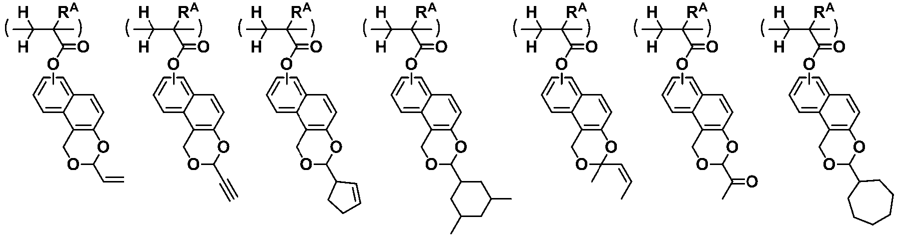

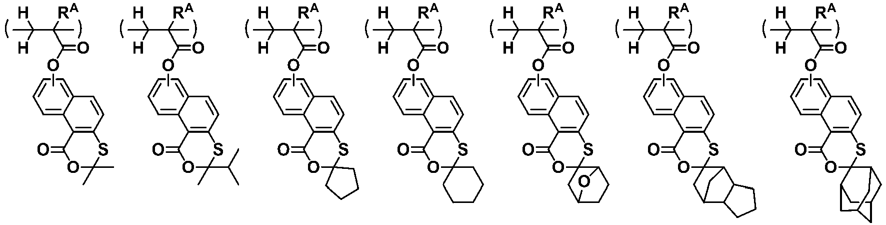

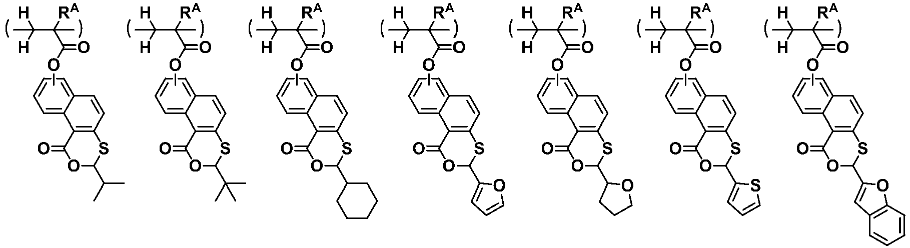

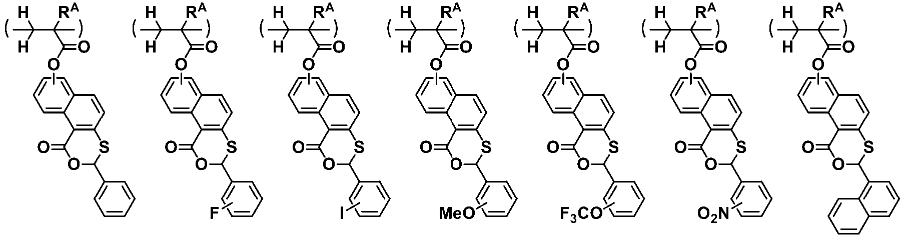

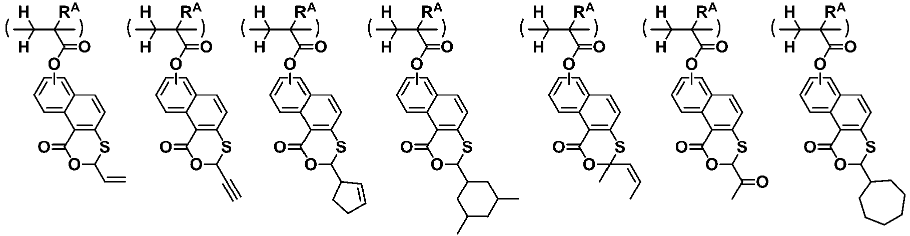

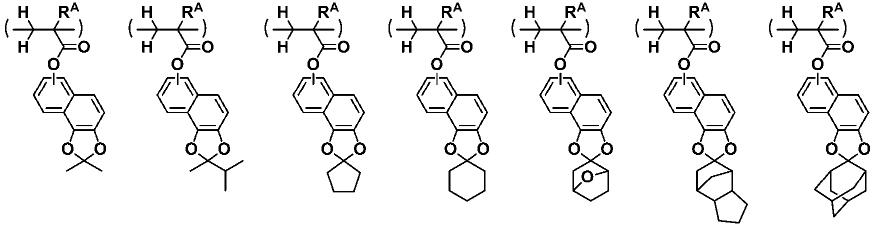

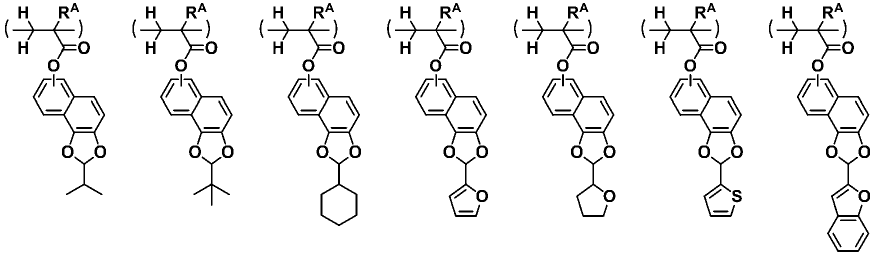

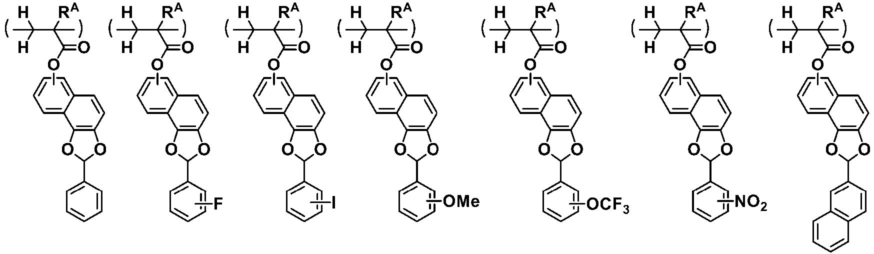

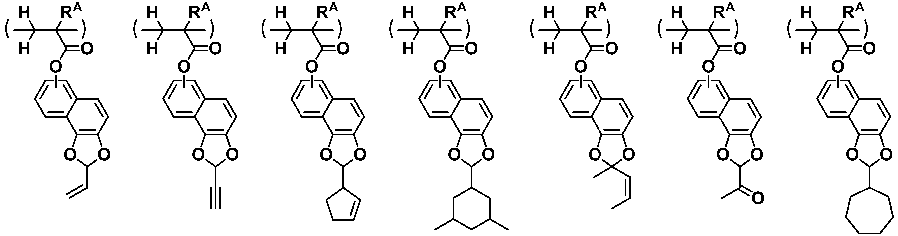

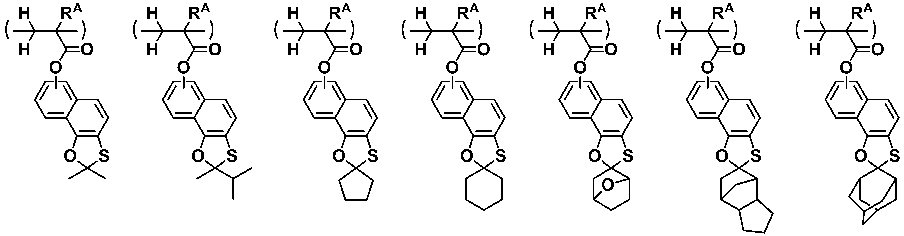

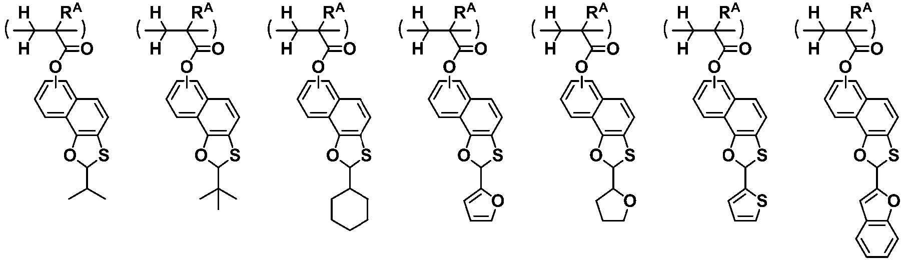

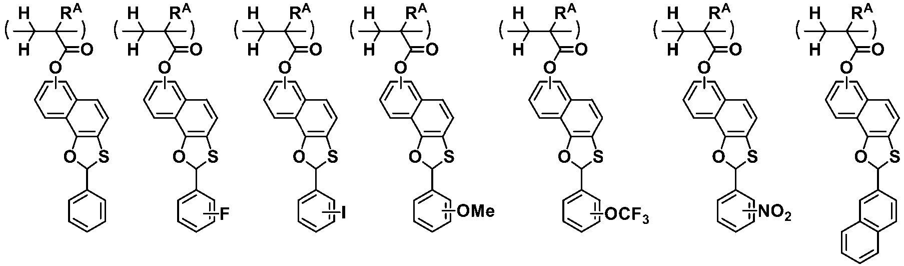

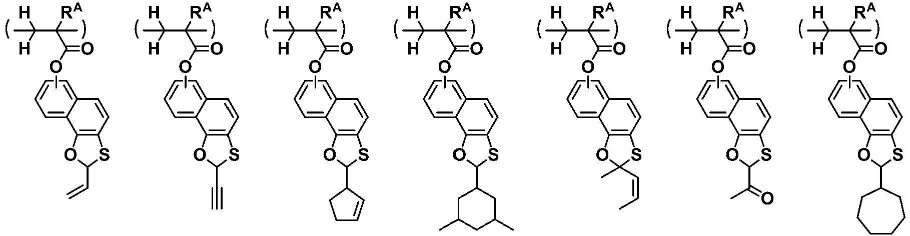

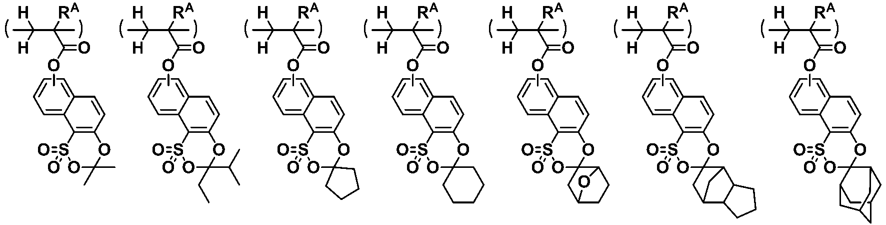

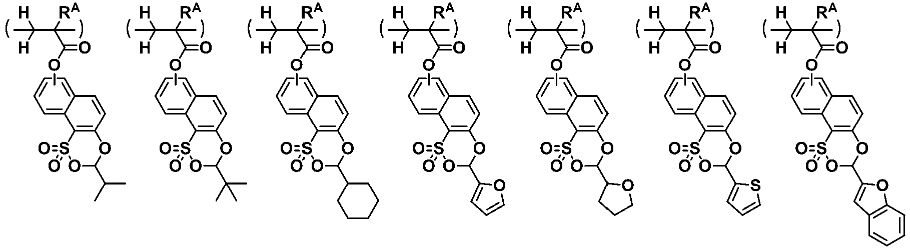

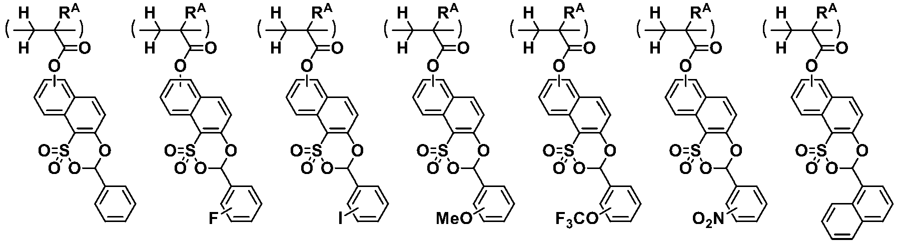

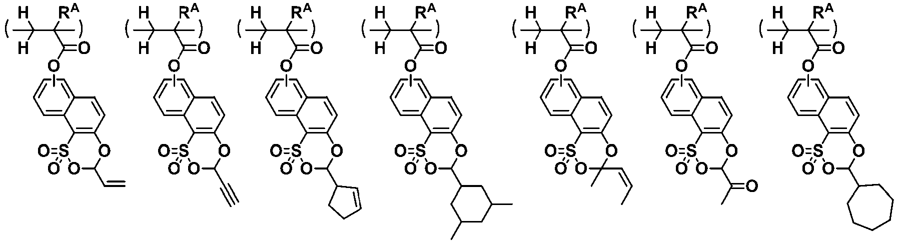

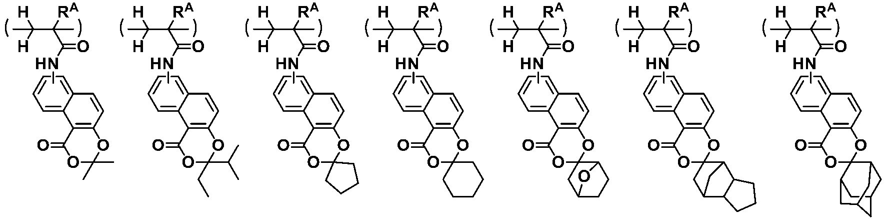

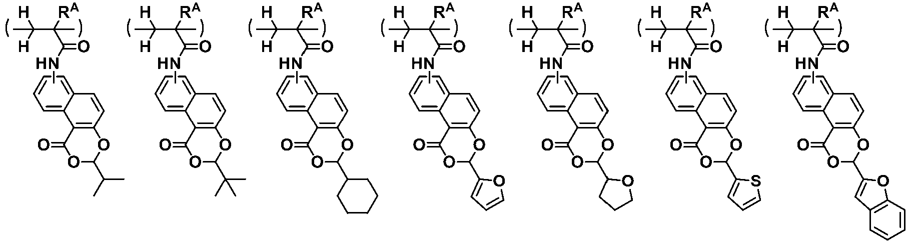

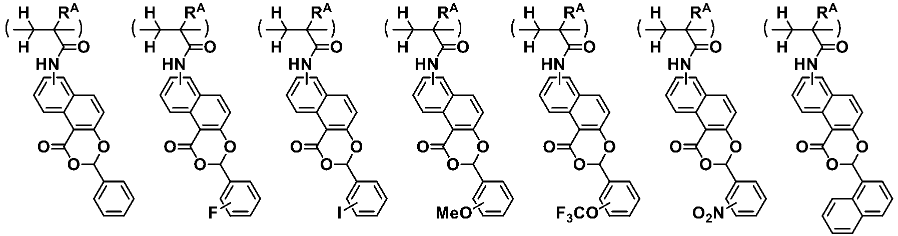

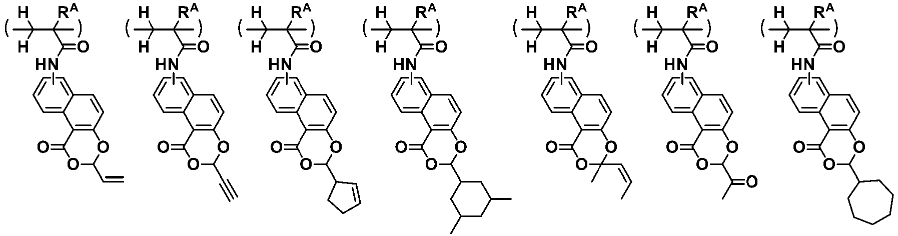

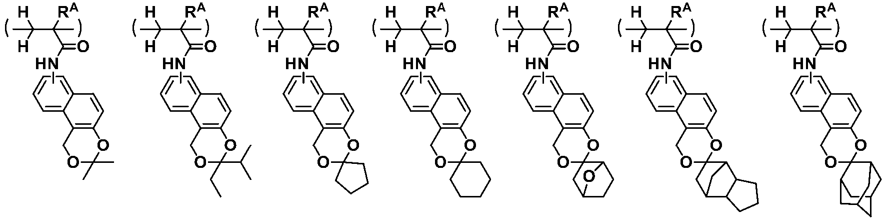

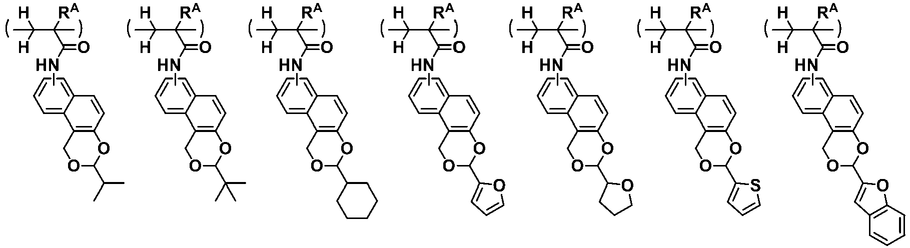

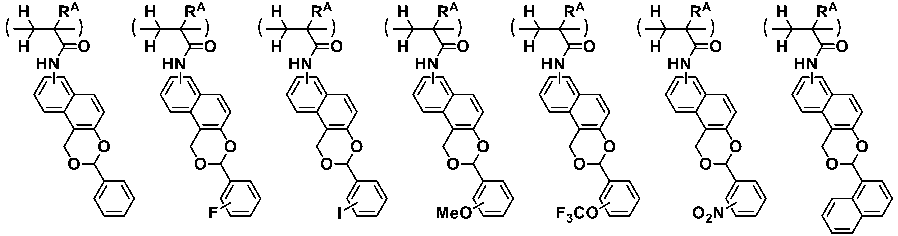

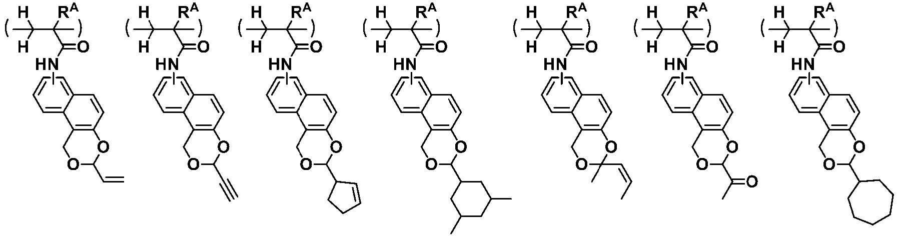

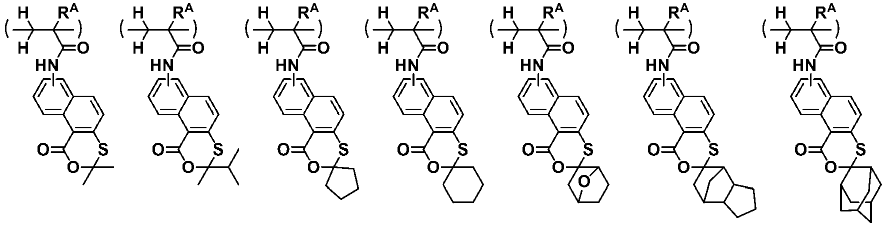

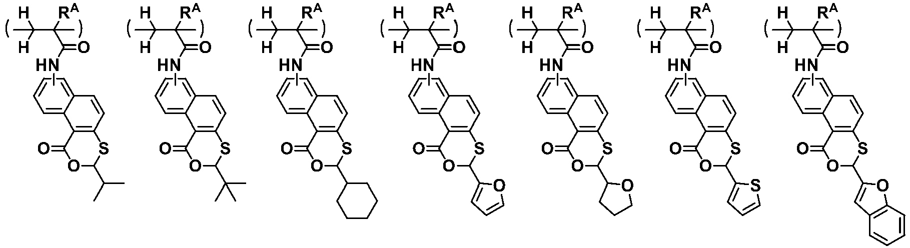

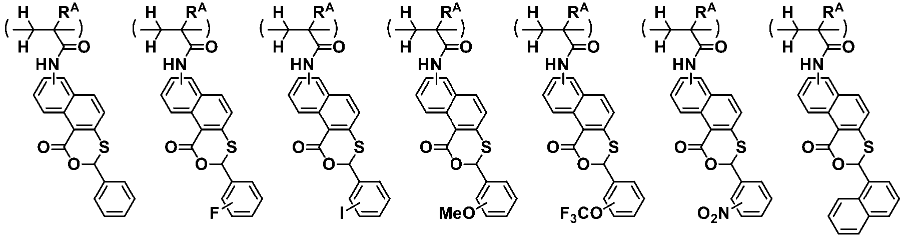

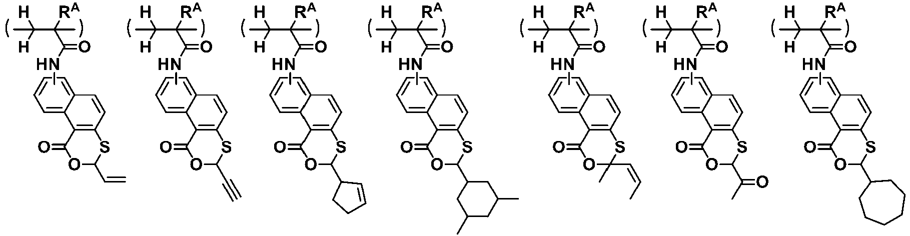

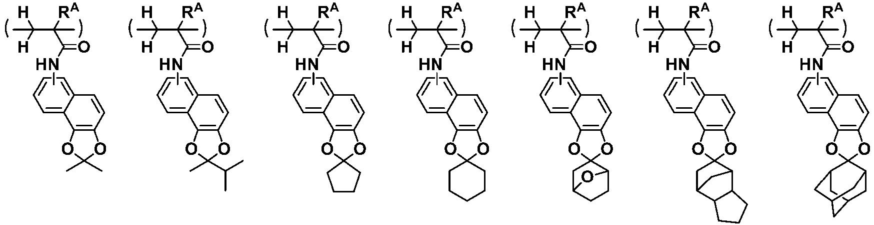

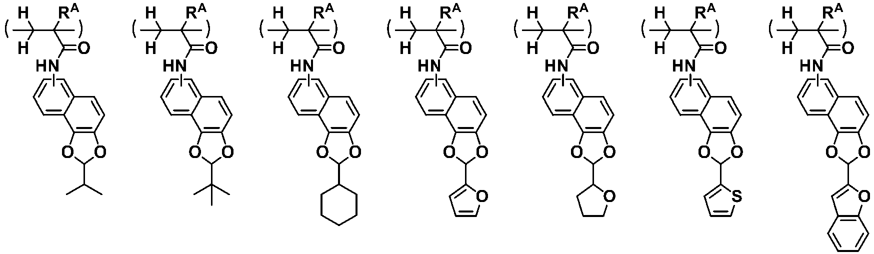

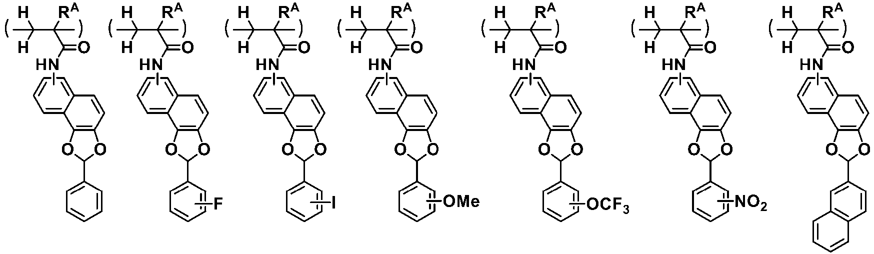

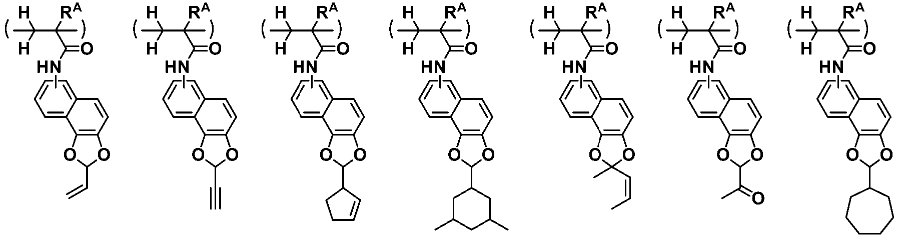

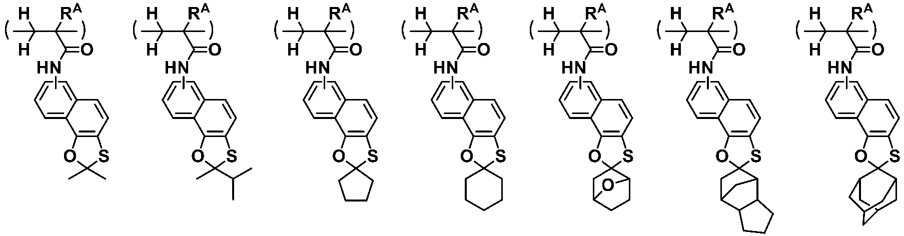

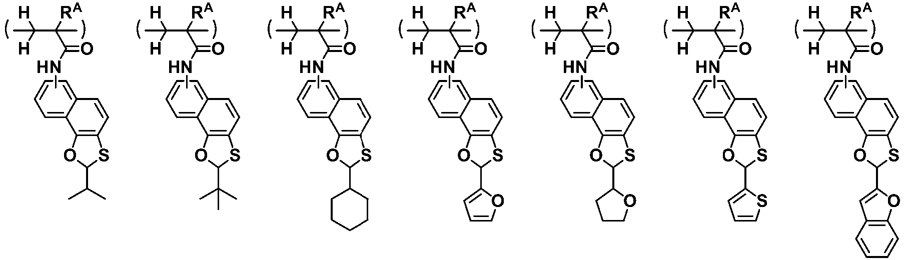

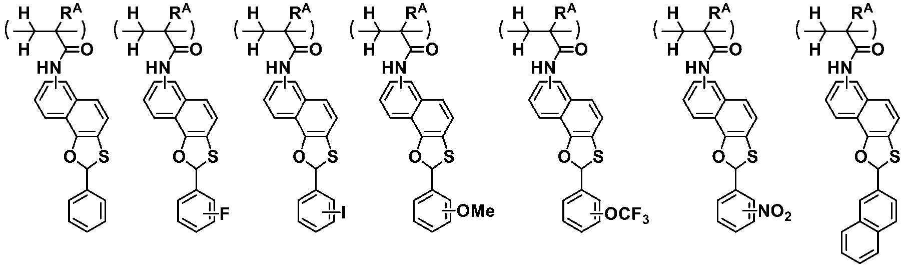

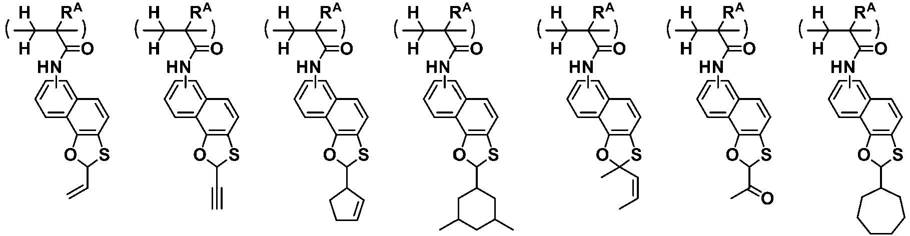

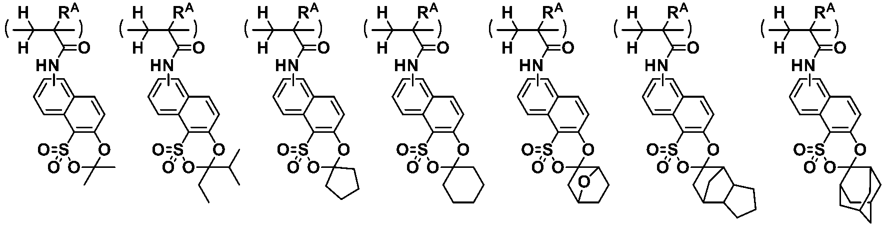

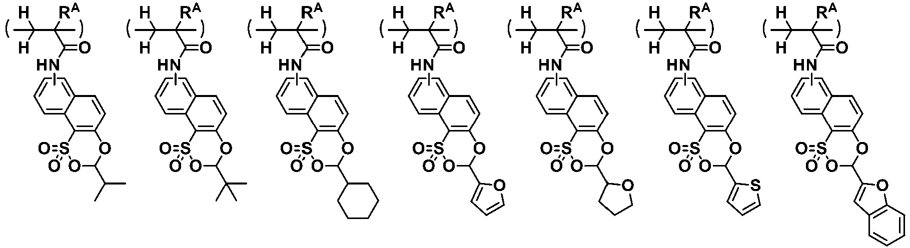

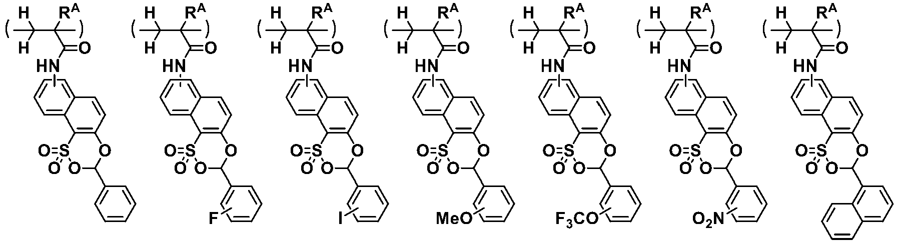

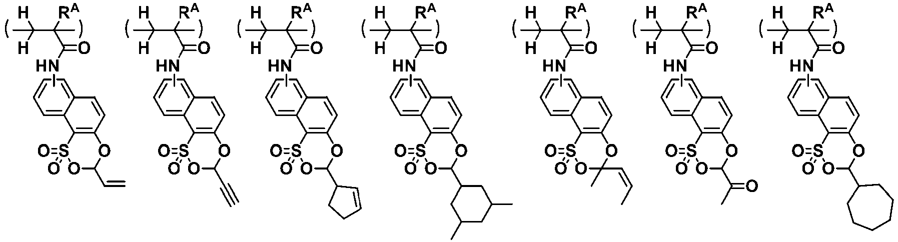

The content of repeat units B2 is preferably 5 to 95 mol%, more preferably 20 to 80 mol% of the overall repeat units of the polymer. The repeat units B2 may be of one type or a combination of plural types.

The polymer may further comprise repeat units of at least one type selected from repeat units having the formula (B3), repeat units having the formula (B4), and repeat units having the formula (B5). Notably these units are simply referred to as repeat units B3, B4, and B5.

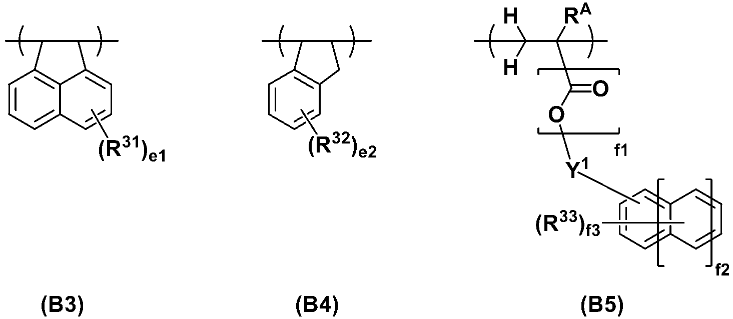

In formulae (B3) and (B4), e1 is 0, 1, 2, 3, 4, 5 or 6, and e2 is 0, 1, 2, 3 or 4.

In formulae (B3) and (B4), R³¹ and R³² are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group. The saturated hydrocarbyl, saturated hydrocarbyloxy, and saturated hydrocarbylcarbonyloxy groups may be straight, branched or cyclic. When e1 is 2, 3, 4, 5 or 6, a plurality of R³¹ may be identical or different. When e2 is 2, 3 or 4, a plurality of R³² may be identical or different.

In formula (B5), f1 is 0 or 1. The subscript f2 is 0, 1 or 2; the corresponding structure represents a benzene skeleton when f2=0, a naphthalene skeleton when f2=1, and an anthracene skeleton when f2=2. The subscript f3 is 0, 1, 2, 3, 4 or 5. When f2=0, f3 is preferably 0, 1, 2 or 3. When f2=1 or 2, f3 is preferably 0, 1, 2, 3 or 4.

In formula (B5), R^{A} is hydrogen, fluorine, methyl or trifluoromethyl.

In formula (B5), R³³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen atom, nitro group, cyano group, C₁-C₂₀ saturated hydrocarbylsulfinyl group, or C₁-C₂₀ saturated hydrocarbylsulfonyl group. R³³ may also be hydroxy when f2 is 1 or 2. The saturated hydrocarbyl group, saturated hydrocarbyloxy group, saturated hydrocarbylcarbonyloxy group, saturated hydrocarbyloxyhydrocarbyl group, saturated hydrocarbylthiohydrocarbyl group, saturated hydrocarbylsulfinyl group, and saturated hydrocarbylsulfonyl group may be straight, branched or cyclic. When f3 is 2, 3, 4 or 5, a plurality of R³³ may be identical or different.

R³³ is preferably selected from halogen atoms such as chlorine, bromine and iodine; saturated hydrocarbyl groups such as methyl, ethyl, propyl, butyl, pentyl, hexyl, cyclopentyl, cyclohexyl, and structural isomers thereof; and saturated hydrocarbyloxy groups such as methoxy, ethoxy, propoxy, butoxy, pentyloxy, hexyloxy, cyclopentyloxy, cyclohexyloxy, and structural isomers of their hydrocarbon moiety. Inter alia, methoxy and ethoxy are most useful.

The saturated hydrocarbylcarbonyloxy group may be readily introduced into a polymer even after polymerization, by a chemical modification method and is advantageously utilized for fine adjustment of the solubility of the polymer in alkaline developer. Examples of the saturated hydrocarbylcarbonyloxy group include methylcarbonyloxy, ethylcarbonyloxy, propylcarbonyloxy, butylcarbonyloxy, pentylcarbonyloxy, hexylcarbonyloxy, cyclopentylcarbonyloxy, cyclohexylcarbonyloxy, benzoyloxy, and structural isomers of their hydrocarbon moiety. As long as the carbon count is equal to or less than 20, an appropriate effect of controlling or adjusting (typically reducing) the solubility of the polymer in alkaline developer is obtainable, and the generation of scum or development defects may be suppressed.

Of the foregoing preferred substituent groups, such substituent groups as chlorine, bromine, iodine, methyl, ethyl and methoxy are useful because the corresponding monomers may be readily prepared.

In formula (B5), Y¹ is a single bond or C₁-C₁₀ saturated hydrocarbylene group in which some -CH₂- may be replaced by -O-. The saturated hydrocarbylene group may be straight, branched or cyclic. Examples thereof include C₁-C₁₀ alkanediyl groups such as methylene, ethane-1,2-diyl, propane-1,3-diyl, butane-1,4-diyl, pentane-1,5-diyl, hexane-1,6-diyl, and structural isomers thereof; C₃-C₁₀ cyclic saturated hydrocarbylene groups such as cyclopropanediyl, cyclobutanediyl, cyclopentanediyl, and cyclohexanediyl; and combinations thereof. For the saturated hydrocarbylene group containing an ether bond, in case of f1=1 in formula (B5), the ether bond may be incorporated at any position excluding the position between the α- and β-carbons relative to the ester oxygen. In case of f1=0, the atom bonding to the backbone becomes an ether oxygen atom, and a second ether bond may be incorporated at any position excluding the position between the α- and β-carbons relative to the ether oxygen. Saturated hydrocarbylene groups having no more than 10 carbon atoms are desirable because of a sufficient solubility in alkaline developer.

Preferred examples of the repeat units B6 wherein f1 is 0 and Y¹ is a single bond (meaning that the aromatic ring is directly bonded to the main chain of the polymer), that is, repeat units free of the linker: -C(=O)-O-Y¹- include units derived from styrene, 4-chlorostyrene, 4-bromostyrene, 4-methylstyrene, 4-methoxystyrene, 4-tert-butylstyrene, 4-acetoxystyrene, 2-hydroxypropylstyrene, 2-vinylnaphthalene, and 3-vinylnaphthalene.

Preferred examples of the repeat units B5 wherein f1 is 1, that is, having the linker: -C(=O)-O-Y¹- are shown below, but not limited thereto. R^{A} is as defined above.

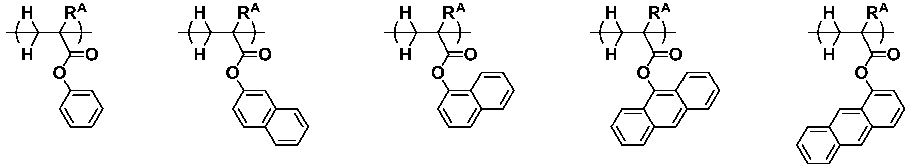

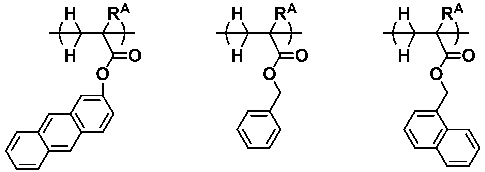

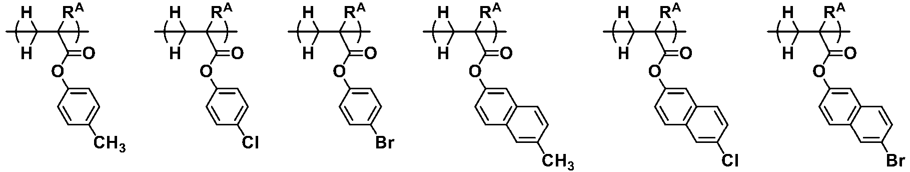

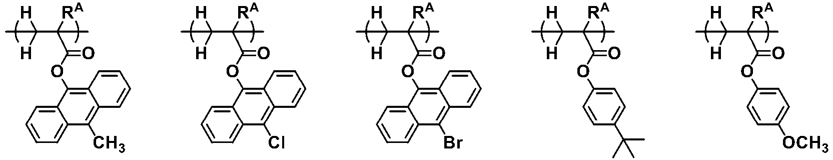

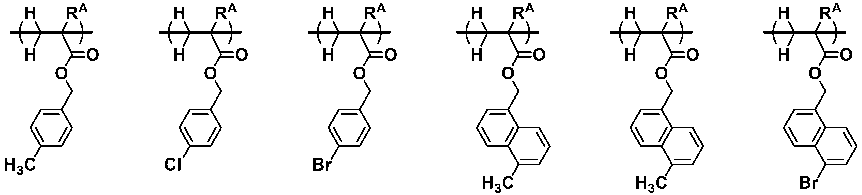

When repeat units of at least one type selected from repeat units B3 to B5 are incorporated, better performance is obtained because not only the aromatic ring possesses etch resistance, but the cyclic structure incorporated into the main chain also exerts the effect of improving resistance to etching and EB irradiation during pattern inspection step.

The content of repeat units B3 to B5 is preferably at least 5 mol% of the overall repeat units of the polymer for attaining the effect of improving etching resistance. The content of repeat units B3 to B5 is preferably up to 25 mol%, more preferably up to 20 mol% of the overall repeat units of the polymer. It is preferred that the polymer does not contain a functional group or contains up to 25 mol% of a functional group other than hydroxy because the risk of forming development defects is eliminated. The repeat units B3 to B5 may be of one type or a combination of plural types.

The polymer may further comprise repeat units of at least one type selected from repeat units having the formula (B6), repeat units having the formula (B7), repeat units having the formula (B8), repeat units having the formula (B8), and repeat units having the formula (B10). Notably these repeat units are also referred to as repeat units B6 to B10.

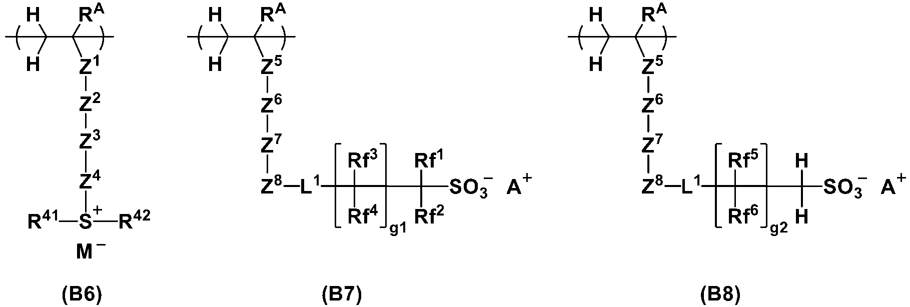

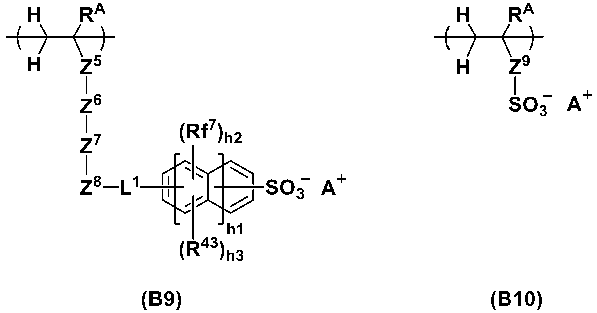

In formulae (B6) to (B10), R^{A} is each independently hydrogen, fluorine, methyl or trifluoromethyl. Z¹ is a single bond or an optionally substituted phenylene group. Z² is a single bond, **-C(=O)-O-Z²¹-, **-C(=O)-N(H)-Z²¹-, or **-O-Z²¹-, wherein Z²¹ is a C₁-C₆ aliphatic hydrocarbylene group, phenylene group or a divalent group obtained by combining the foregoing, which may contain halogen, carbonyl moiety, ester bond, ether bond or hydroxy moiety. Z³ is a single bond, ether bond, ester bond, amide bond, sulfonate ester bond, sulfonamide bond, carbonate bond or carbamate bond. Z⁴ is a single bond, or a C₁-C₆ aliphatic hydrocarbylene group, phenylene group or a divalent group obtained by combining the foregoing, which may contain halogen, carbonyl moiety, ester bond, ether bond or hydroxy moiety. Z⁵ is each independently a single bond, an optionally substituted phenylene, naphthylene, or *-C(=O)-O-Z⁵¹-, wherein Z⁵¹ is a C₁-C₁₀ aliphatic hydrocarbylene group which may contain halogen, hydroxy moiety, ether bond, ester bond or lactone ring, or phenylene or naphthylene group. Z⁶ is a single bond, ether bond, ester bond, amide bond, sulfonate ester bond, sulfonamide bond, carbonate bond or carbamate bond. Z⁷ is each independently a single bond, ***-Z⁷¹-C(=O)-O-, ***-C(=O)-N(H)-Z⁷¹-, or ***-O-Z⁷¹-, wherein Z⁷¹ is a C₁-C₂₀ hydrocarbylene group which may contain a heteroatom. Z⁸ is each independently a single bond, ****-Z⁸¹-C(=O)-O-, ****-C(=O)-N(H)-Z⁸¹-, or ****-O-Z⁸¹-, wherein Z⁸¹ is a C₁-C₂₀ hydrocarbylene group which may contain a heteroatom. Z⁹ is a single bond, methylene, ethylene, phenylene, fluorinated phenylene, trifluoromethyl-substituted phenylene, *-C(=O)-O-Z⁹¹-, *-C(=O)-N(H)-Z⁹¹-, or *-O-Z⁹¹-, wherein Z⁹¹ is a C₁-C₆ aliphatic hydrocarbylene group, phenylene group, fluorinated phenylene group or trifluoromethyl-substituted phenylene group, which may contain a carbonyl moiety, ester bond, ether bond or hydroxy moiety. The asterisk * designates a point of attachment to the carbon atom in the backbone, ** is a point of attachment to Z¹, *** is a point of attachment to Z⁶, and **** is a point of attachment to Z⁷.

The aliphatic hydrocarbylene group represented by Z²¹, Z⁵¹ and Z⁹¹ may be straight, branched or cyclic. Examples thereof include alkanediyl groups such as methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, 1,1-dimethylethane-1,2-diyl, pentane-1,5-diyl, 2-methylbutane-1,2-diyl, and hexane-1,6-diyl; cycloalkanediyl groups such as cyclopropanediyl, cyclobutanediyl, cyclopentanediyl, and cyclohexanediyl; and combinations thereof.

The hydrocarbylene group which may contain a heteroatom, represented by Z⁷¹ and Z⁸¹, may be saturated or unsaturated and straight, branched or cyclic. Examples thereof are shown below, but not limited thereto.

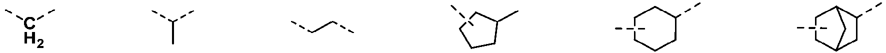

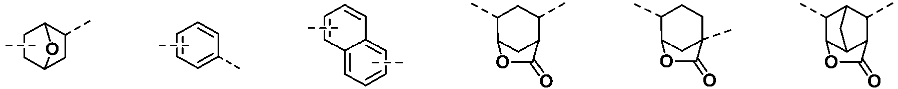

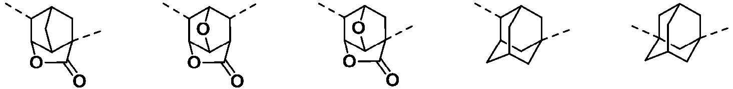

In formula (B6), R⁴¹ and R⁴² are each independently a C₁-C₂₀ hydrocarbyl group which may contain a heteroatom. The hydrocarbyl group may be saturated or unsaturated and straight, branched or cyclic. Examples thereof include C₁-C₂₀ alkyl groups such as methyl, ethyl, n-propyl, isopropyl, n-butyl, isobutyl, sec-butyl, and tert-butyl; C₃-C₂₀ cyclic saturated hydrocarbyl groups such as cyclopropyl, cyclopentyl, cyclohexyl, cyclopropylmethyl, 4-methylcyclohexyl, cyclohexylmethyl, norbornyl, and adamantyl; C₂-C₂₀ alkenyl groups such as vinyl, 1-propenyl, 2-propenyl, butenyl, and hexenyl; C₃-C₂₀ cyclic unsaturated hydrocarbyl groups such as cyclohexenyl; C₆-C₂₀ aryl groups such as phenyl, naphthyl and thienyl; C₇-C₂₀ aralkyl groups such as benzyl, 1-phenylethyl and 2-phenylethyl, and combinations thereof. Inter alia, aryl groups are preferred. In the hydrocarbyl group, some or all of the hydrogen atoms may be substituted by a moiety containing a heteroatom such as oxygen, sulfur, nitrogen or halogen and some -CH₂- may be replaced by a moiety containing a heteroatom such as oxygen, sulfur or nitrogen, so that the group may contain a hydroxy, fluorine, chlorine, bromine, iodine, cyano, carbonyl, ether bond, ester bond, sulfonate ester bond, carbonate bond, lactone ring, sultone ring, carboxylic anhydride (-C(=O)-O-C(=O)-), or haloalkyl moiety.

R⁴¹ and R⁴² may bond together to form a ring with the sulfur atom to which they are attached. Examples of the ring are shown below.

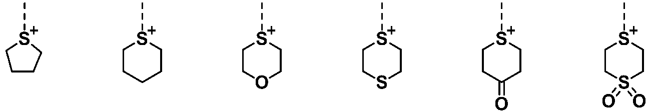

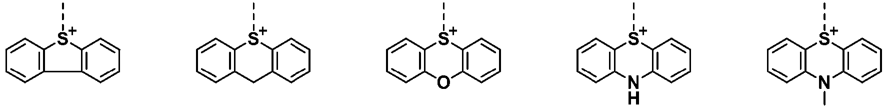

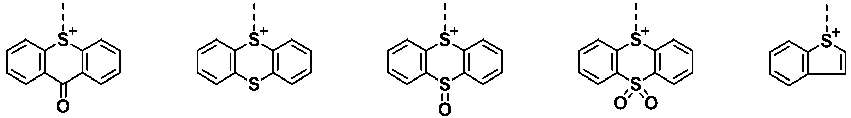

Herein the broken line designates a point of attachment to Z⁴.

Examples of the cation in repeat units B6 are shown below, but not limited thereto. Herein R^{A} is as defined above.

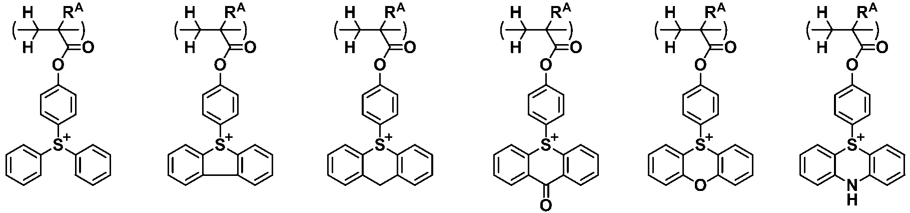

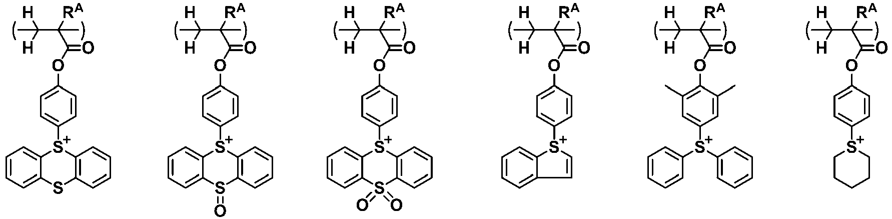

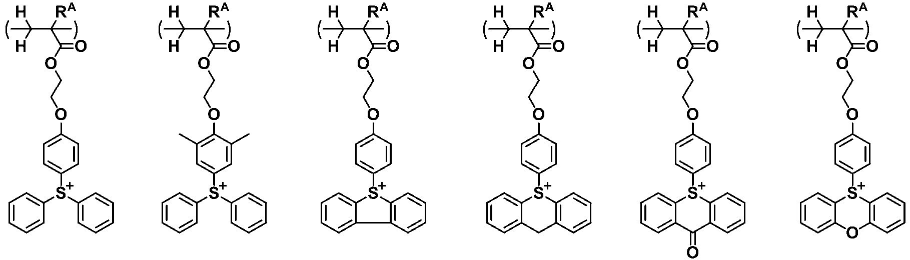

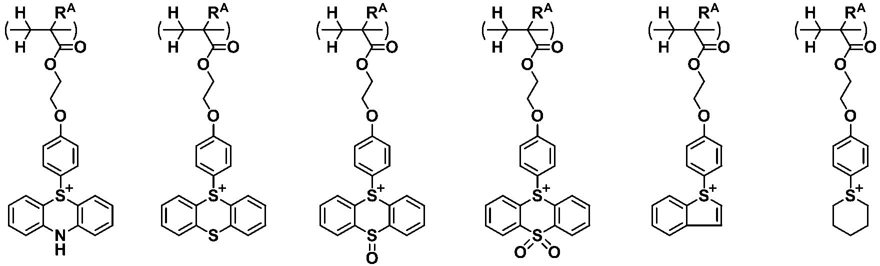

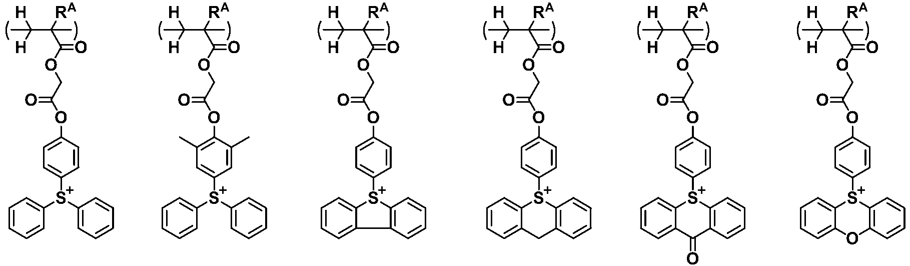

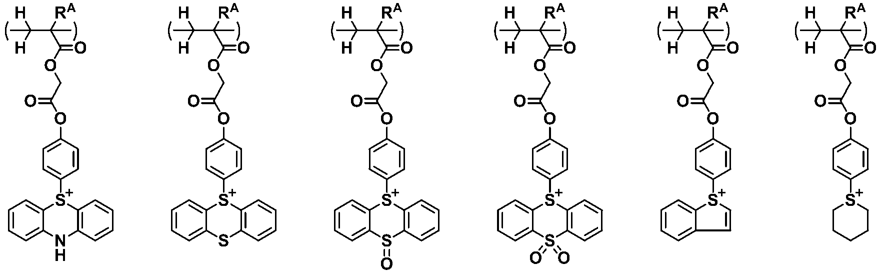

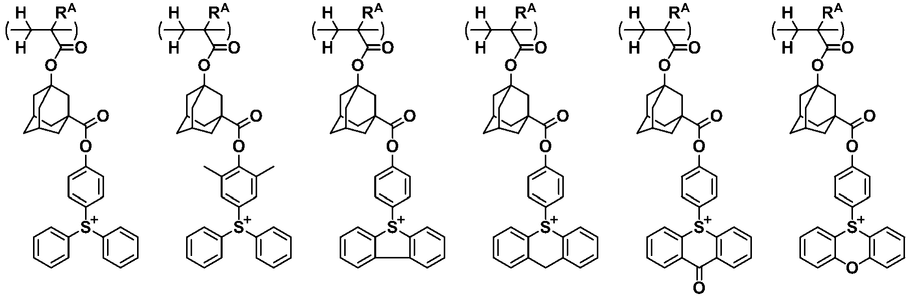

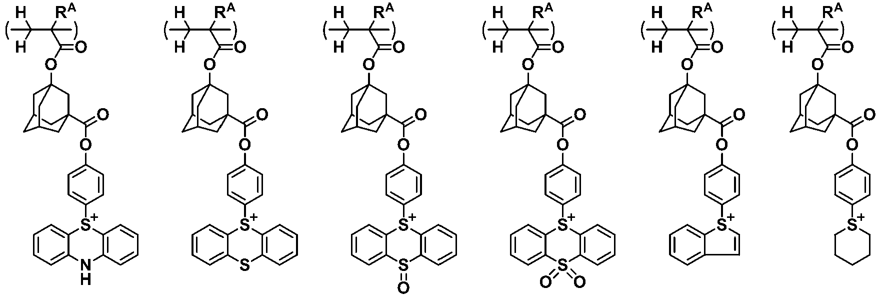

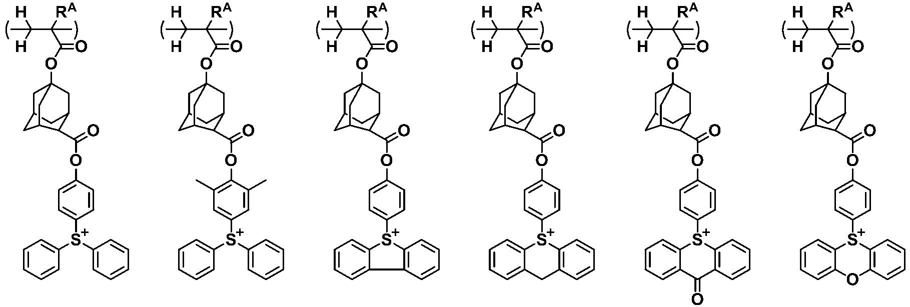

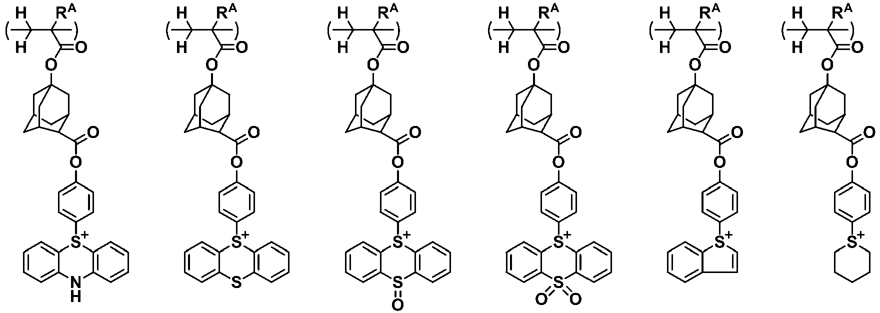

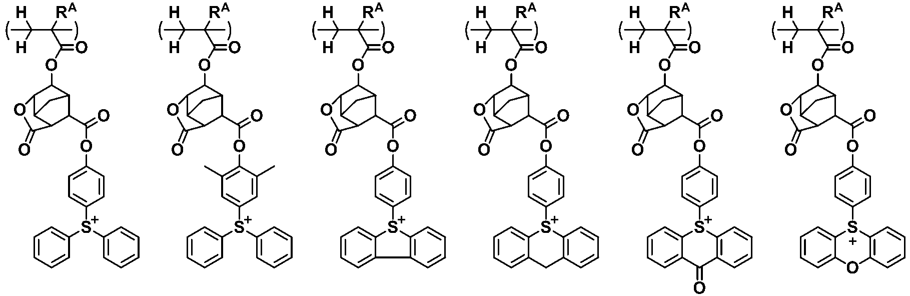

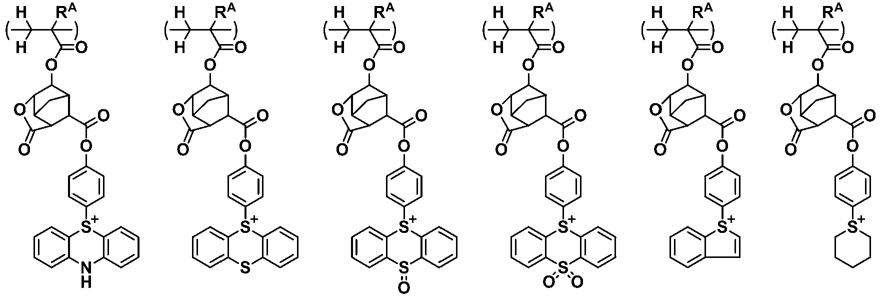

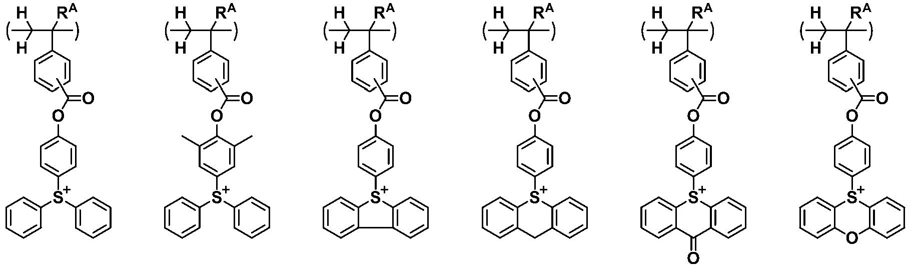

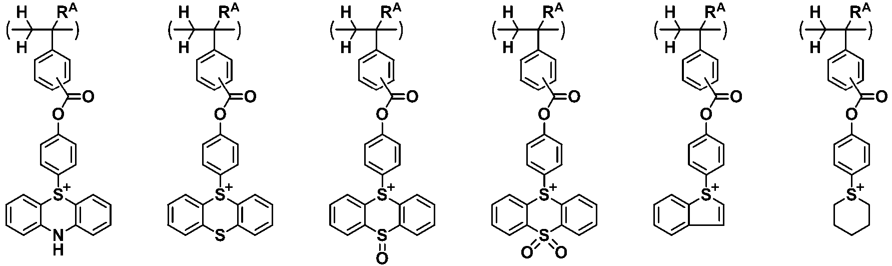

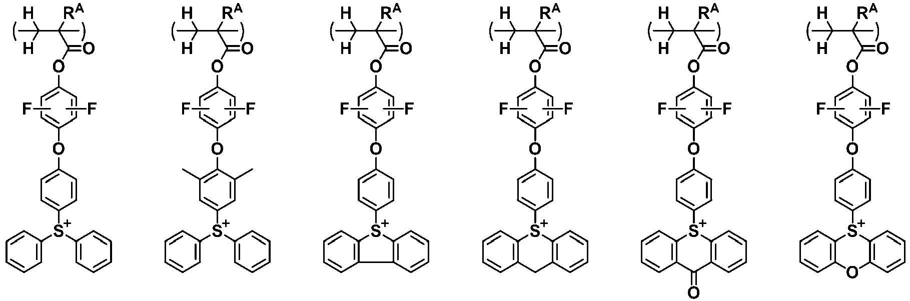

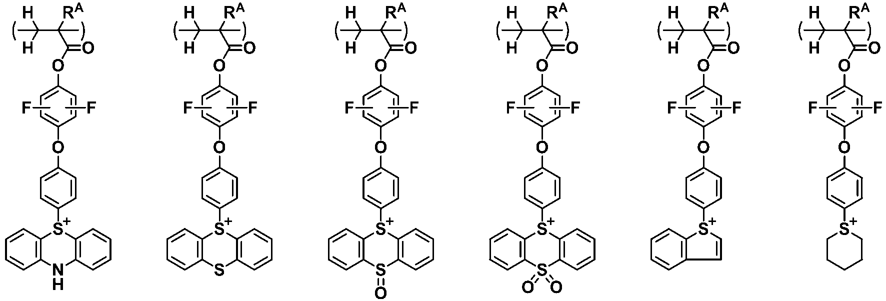

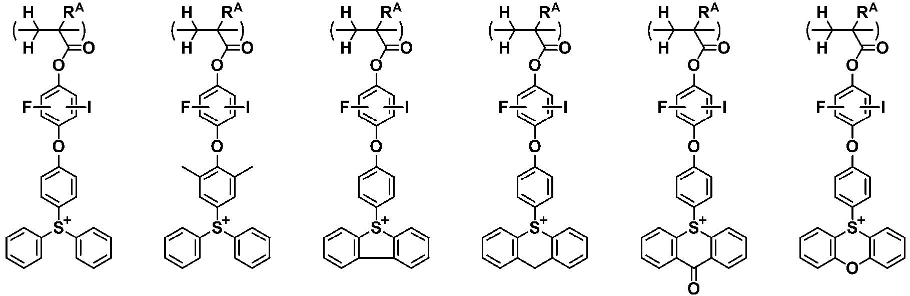

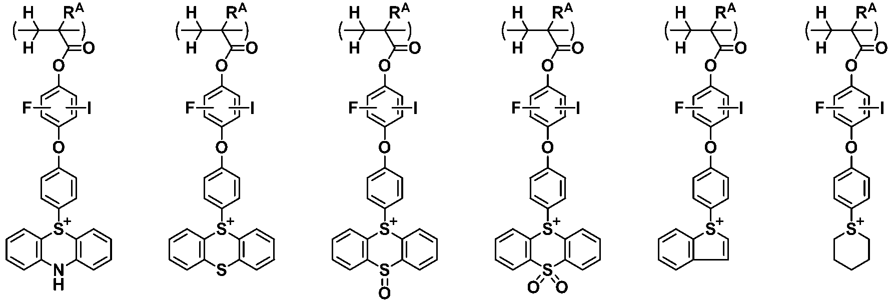

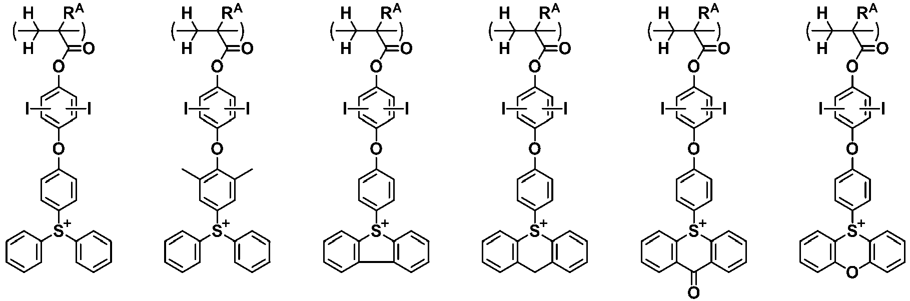

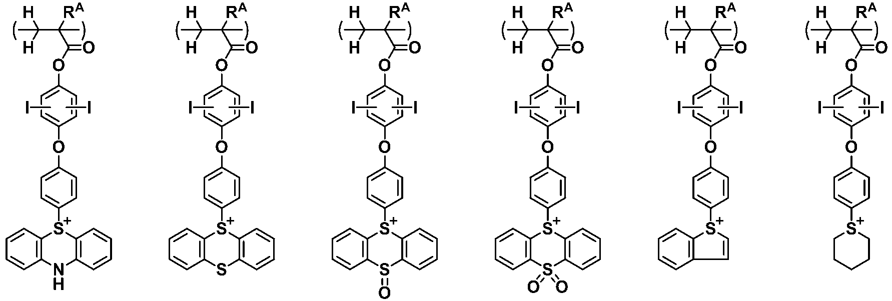

In formula (B6), M⁻ is a non-nucleophilic counter ion. Halide ions, sulfonate anions, imide anions, and methide anions are preferred. Examples of the non-nucleophilic counter ion include halide ions such as chloride and bromide ions; sulfonate anions, specifically fluoroalkylsulfonate ions such as triflate, 1,1,1-trifluoroethanesulfonate, and nonafluorobutanesulfonate, arylsulfonate ions such as tosylate, benzenesulfonate, 4-fluorobenzenesulfonate, and 1,2,3,4,5-pentafluorobenzenesulfonate, alkylsulfonate ions such as mesylate and butanesulfonate; imide ions such as bis(trifluoromethylsulfonyl)imide, bis(perfluoroethylsulfonyl)imide and bis(perfluorobutylsulfonyl)imide; and methide ions such as tris(trifluoromethylsulfonyl)methide and tris(perfluoroethylsulfonyl)methide.

Anions having the following formulae (B6-1) to (B6-4) are also useful as the non-nucleophilic counter ion.

R^{fa}-CF₂-SO₃- (B6-1)

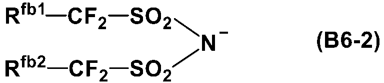

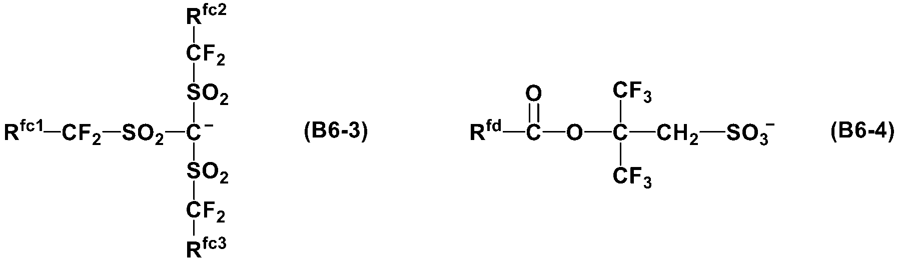

In formula (B6-1), R^{fa} is fluorine or a C₁-C₄₀ hydrocarbyl group which may contain a heteroatom. The hydrocarbyl group may be saturated or unsaturated and straight, branched or cyclic. Examples thereof are as will be exemplified below for the hydrocarbyl group R^{fa1} in formula (B6-1-1).

Of the anions of formula (B6-1), an anion having the formula (B6-1-1) is preferred.

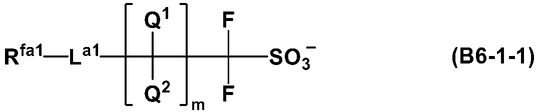

In formula (B6-1-1), Q¹ and Q² are each independently hydrogen, fluorine or a C₁-C₆ fluorinated saturated hydrocarbyl group. It is preferred for solvent solubility that at least one of Q¹ and Q² be trifluoromethyl. The subscript m is 0, 1, 2, 3 or 4, preferably 1.

R^{fa1} is a C₁-C₃₅ hydrocarbyl group which may contain a heteroatom. As the heteroatom, oxygen, nitrogen, sulfur and halogen atoms are preferred, with oxygen being most preferred. Of the hydrocarbyl groups, those groups of 6 to 30 carbon atoms are preferred from the aspect of achieving a high resolution in forming patterns of small feature size. The hydrocarbyl group may be saturated or unsaturated and straight, branched or cyclic. Examples thereof include C₁-C₃₅ alkyl groups such as methyl, ethyl, n-propyl, isopropyl, n-butyl, isobutyl, sec-butyl, tert-butyl, pentyl, neopentyl, hexyl, heptyl, 2-ethylhexyl, nonyl, undecyl, tridecyl, pentadecyl, heptadecyl, and icosyl; C₃-C₃₅ cyclic saturated hydrocarbyl groups such as cyclopentyl, cyclohexyl, 1-adamantyl, 2-adamantyl, 1-adamantylmethyl, norbornyl, norbornylmethyl, tricyclodecyl, tetracyclododecyl, tetracyclododecylmethyl, and dicyclohexylmethyl; C₂-C₃₅ unsaturated aliphatic hydrocarbyl groups such as 2-propenyl and 3-cyclohexenyl; C₆-C₃₅ aryl groups such as phenyl, 1-naphthyl, 2-naphthyl and 9-fluorenyl; and C₇-C₃₅ aralkyl groups such as benzyl and diphenylmethyl, and combinations thereof.

In the foregoing hydrocarbyl groups, some or all hydrogen may be substituted by a moiety containing a heteroatom such as oxygen, sulfur, nitrogen or halogen, or some -CH₂-may be replaced by a moiety containing a heteroatom such as oxygen, sulfur or nitrogen, so that the group may contain a hydroxy, fluorine, chlorine, bromine, iodine, cyano, nitro, carbonyl, ether bond, ester bond, sulfonate ester bond, carbonate bond, lactone ring, sultone ring, carboxylic anhydride (-C(=O)-O-C(=O)-) or haloalkyl moiety. Examples of the heteroatom-containing hydrocarbyl group include tetrahydrofuryl, methoxymethyl, ethoxymethyl, methylthiomethyl, acetamidomethyl, trifluoroethyl, (2-methoxyethoxy)methyl, acetoxymethyl, 2-carboxy-1-cyclohexyl, 2-oxopropyl, 4-oxo-1-adamantyl, and 3-oxocyclohexyl.

In formula (B6-1-1), L^{a1} is a single bond, ether bond, ester bond, sulfonate ester bond, carbonate bond or carbamate bond. From the aspect of synthesis, an ether bond or ester bond is preferred, with the ester bond being more preferred.

Examples of the anion having formula (B6-1) are shown below, but not limited thereto. Herein Q¹ is as defined above.

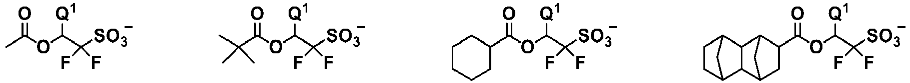

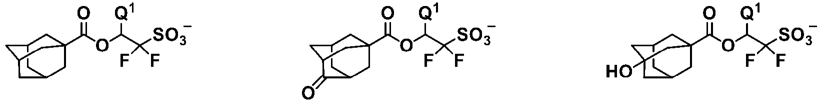

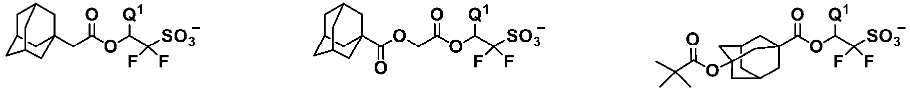

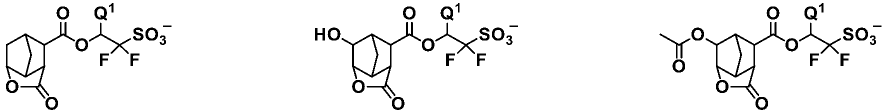

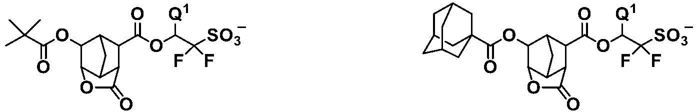

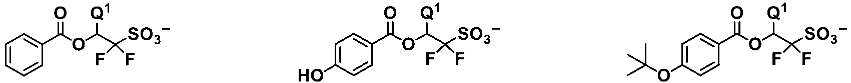

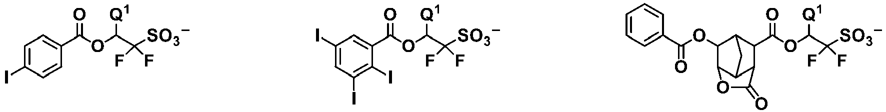

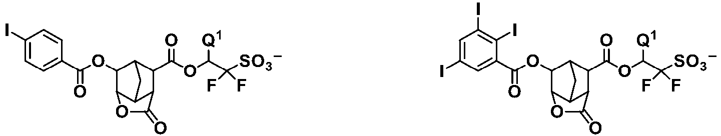

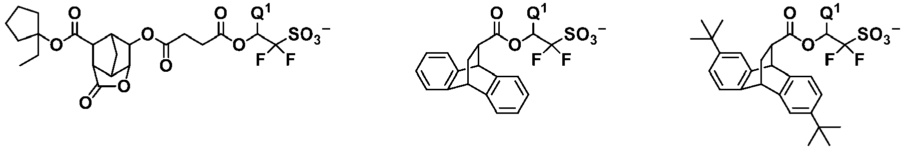

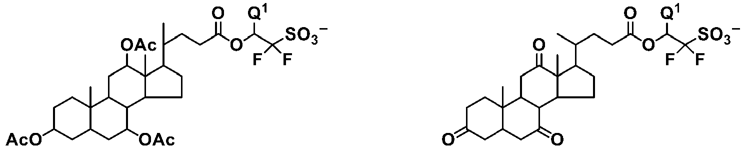

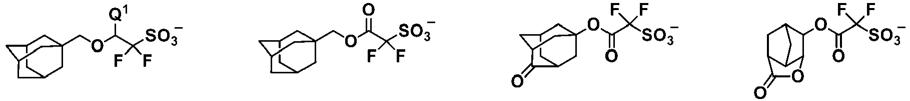

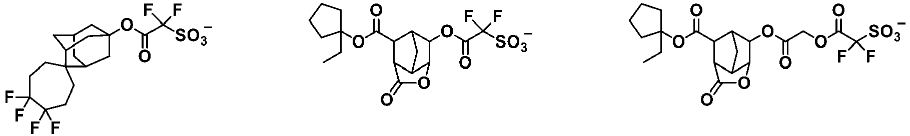

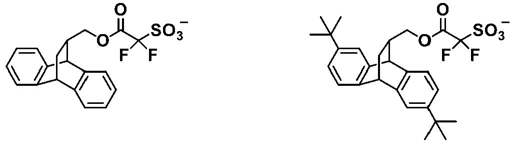

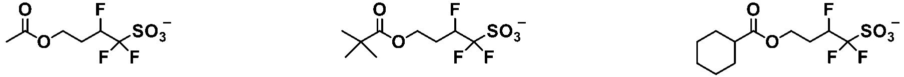

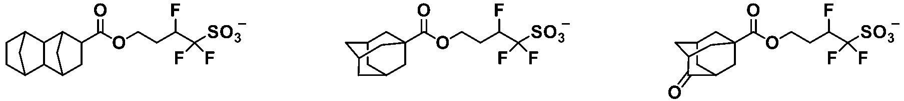

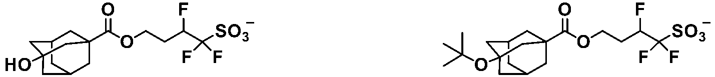

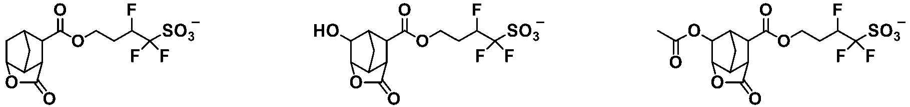

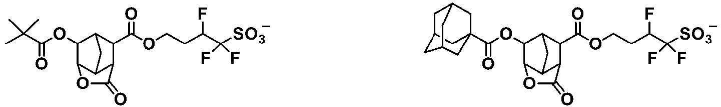

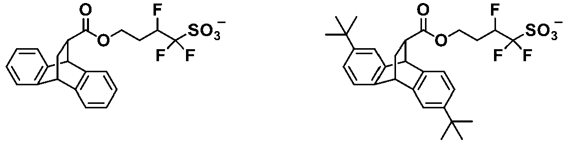

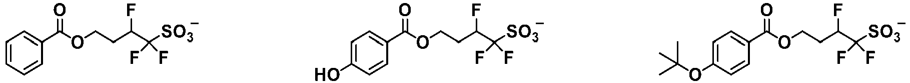

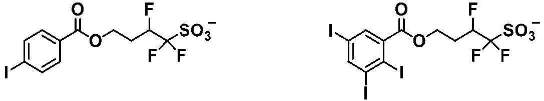

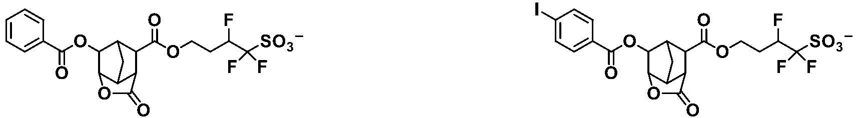

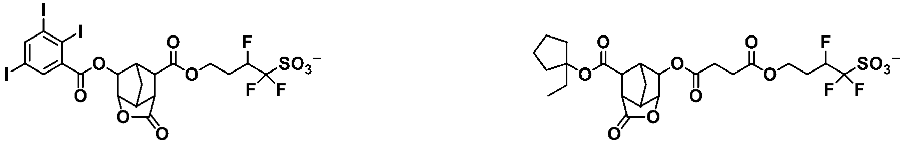

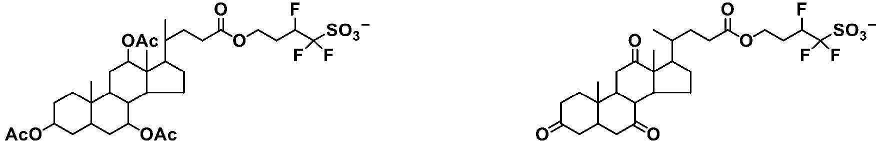

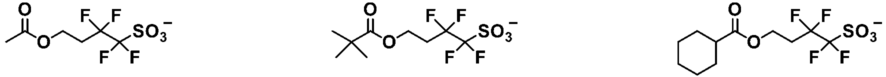

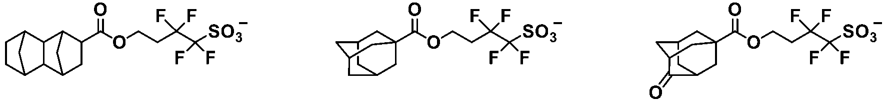

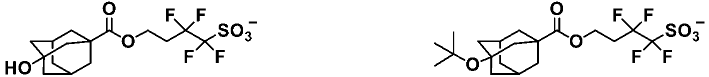

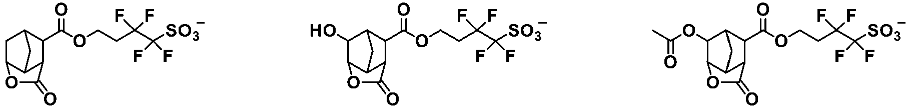

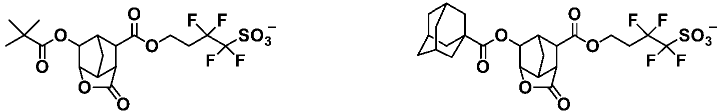

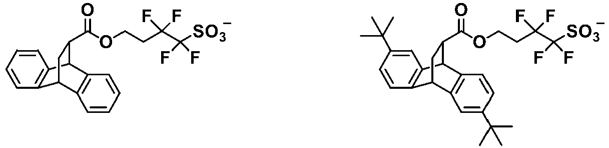

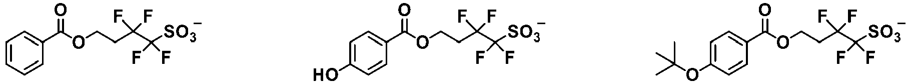

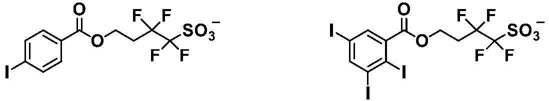

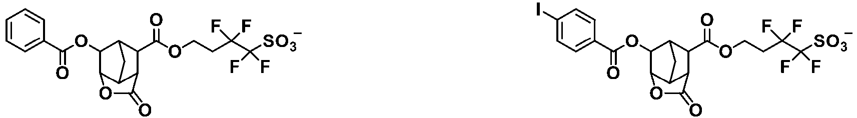

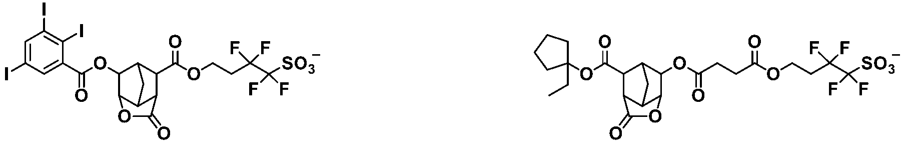

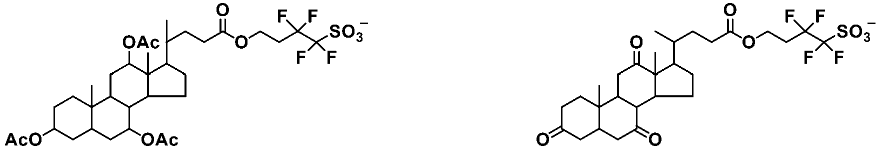

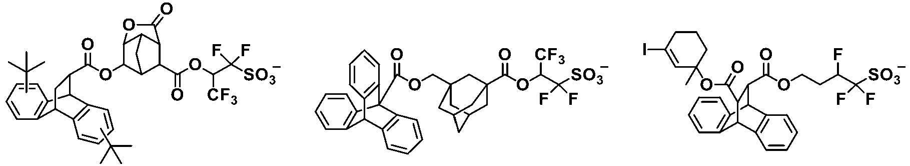

Other examples of the anion having formula (B6-1) include those described in JP-A 2025-023601, paragraphs [0042]-[0049], JP-A 2021-070692, paragraphs [0015]-[0017], JP 7091762, paragraphs [0145] and [0148], JP 7628783, paragraphs [0022]-[0023], and JP 7109178, paragraph [0224].

In formula (B6-2), R^{fb1} and R^{fb2} are each independently fluorine or a C₁-C₄₀ hydrocarbyl group which may contain a heteroatom. The hydrocarbyl group may be saturated or unsaturated and straight, branched or cyclic. Examples thereof are as exemplified above for the hydrocarbyl group R^{fa1} in formula (B6-1-1). Preferably R^{fb1} and R^{fb2} are fluorine or C₁-C₄ straight fluorinated alkyl groups. Also, R^{fb1} and R^{fb2} may bond together to form a ring with the linkage: -CF₂-SO₂-N⁻-SO₂-CF₂- to which they are attached. It is preferred that a combination of R^{fb1} and R^{fb2} be a fluorinated ethylene or fluorinated propylene group.

In formula (B6-3), R^{fc1}, R^{fc2} and R^{fc3} are each independently fluorine or a C₁-C₄₀ hydrocarbyl group which may contain a heteroatom. The hydrocarbyl group may be saturated or unsaturated and straight, branched or cyclic. Examples thereof are as exemplified for the hydrocarbyl group R^{fa1} in formula (B6-1-1). Preferably R^{fc1}, R^{fc2} and R^{fc3} are fluorine or C₁-C₄ straight fluorinated alkyl groups. Also, R^{fc1} and R^{fc2} may bond together to form a ring with the linkage: -CF₂-SO₂-C⁻-SO₂-CF₂- to which they are attached. It is preferred that a combination of R^{fc1} and R^{fc2} be a fluorinated ethylene or fluorinated propylene group.

In formula (B6-4), R^{fd} is a C₁-C₄₀ hydrocarbyl group which may contain a heteroatom. The hydrocarbyl group may be saturated or unsaturated and straight, branched or cyclic. Examples thereof are as exemplified above for the hydrocarbyl group R^{fa1} in formula (B6-1-1).

Examples of the anion having formula (B6-4) are shown below, but not limited thereto.

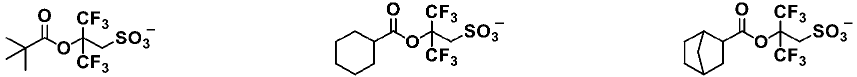

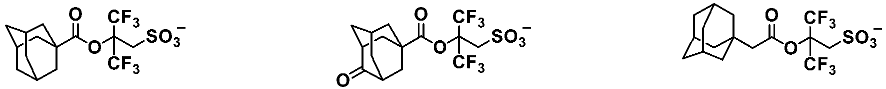

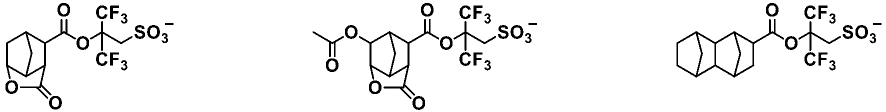

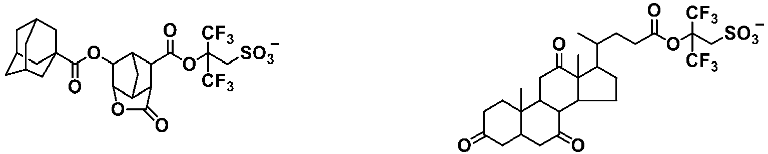

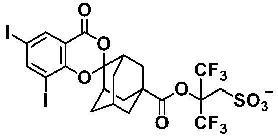

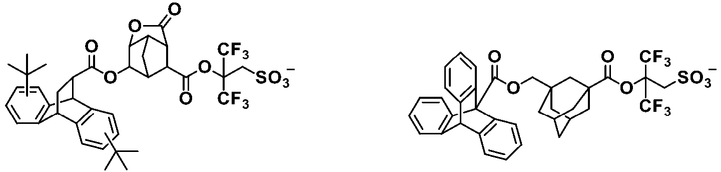

Other examples of the anion having formula (B6-4) include those described in JP-A 2025-023601, paragraphs [0050]-[0058].

Anions having an iodized or brominated aromatic ring are also useful as the non-nucleophilic counter ion. These anions have the formula (B6-5).

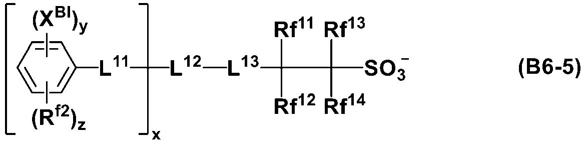

In formula (B6-5), x is 1, 2 or 3, y is 1, 2, 3, 4 or 5, z is 0, 1, 2 or 3, and y+z is from 1 to 5. Preferably, y is 1, 2 or 3, more preferably 2 or 3, and z is 0, 1 or 2.

In formula (B6-5), X^{BI} is iodine or bromine. A plurality of X^{BI} may be identical or different when x and/or y is 2 or more.

In formula (B6-5), L¹¹ is a single bond, ether bond, ester bond, sulfonate ester bond, carbonate bond, carbamate bond, or a C₁-C₆ saturated hydrocarbylene group in which some -CH₂- may be replaced by an ether bond or ester bond. The saturated hydrocarbylene group may be straight, branched or cyclic.

In formula (B6-5), L¹² is a single bond or a C₁-C₂₀ hydrocarbylene group which may contain a heteroatom when x=1, or a C₁-C₂₀ (x+1)-valent hydrocarbon group which may contain a heteroatom when x=2 or 3.

The C₁-C₂₀ hydrocarbylene group L¹² may be saturated or unsaturated and straight, branched or cyclic. Examples thereof include C₁-C₂₀ alkanediyl groups such as methanediyl, ethane-1,1-diyl, ethane-1,2-diyl, propane-1,3-diyl, butane-1,4-diyl, pentane-1,5-diyl, hexane-1,6-diyl, heptane-1,7-diyl, octane-1,8-diyl, nonane-1,9-diyl, decane-1,10-diyl, undecane-1,11-diyl, dodecane-1,12-diyl; C₃-C₂₀ cyclic saturated hydrocarbylene groups such as cyclopentanediyl, cyclohexanediyl, norbornanediyl, adamantanediyl, and tricyclo[5.2.1.0^{2,6}]decanediyl; C₂-C₂₀ unsaturated aliphatic hydrocarbylene groups such as vinylene and propene-1,3-diyl; C₆-C₂₀ arylene groups such as phenylene, naphthylene and anthracenediyl; C₇-C₂₀ aromatic ring-containing polycyclic hydrocarbylene group such as 9,10-ethano-9,10-dihydroanthracenediyl and 6,13-ethano-6,13-dihydropentacene, and combinations thereof. The C₁-C₂₀ (x+1)-valent hydrocarbon group L¹² may be saturated or unsaturated and straight, branched or cyclic. Examples thereof include those exemplified above for the C₁-C₂₀ hydrocarbylene group, with one or two hydrogen atoms being eliminated.

In the hydrocarbylene group and (x+1)-valent hydrocarbon group, some or all hydrogen may be substituted by a moiety containing a heteroatom such as oxygen, sulfur, nitrogen or halogen, and some -CH₂- may be replaced by a moiety containing a heteroatom such as oxygen, sulfur or nitrogen, so that the group may contain a hydroxy, cyano, fluorine, chlorine, bromine, iodine, carbonyl, ether bond, ester bond, sulfonate ester bond, carbonate bond, lactone ring, sultone ring, carboxylic anhydride (-C(=O)-O-C(=O)-) or haloalkyl moiety.

In formula (B6-5), L¹³ is a single bond, ether bond, ester bond, sulfonate ester bond, carbonate bond or carbamate bond.

In formula (B6-5), R^{fe} is hydroxy, carboxy, fluorine, chlorine, bromine, amino group, or a C₁-C₂₀ hydrocarbyl, C₁-C₂₀ hydrocarbyloxy, C₁-C₂₀ hydrocarbylthio, C₂-C₂₀ hydrocarbylcarbonyl, C₂-C₂₀ hydrocarbyloxycarbonyl, C₂-C₂₀ hydrocarbylcarbonyloxy, or C₁-C₂₀ hydrocarbylsulfonyloxy group, which may contain fluorine, chlorine, bromine, hydroxy, amino, ester bond or ether bond, or -N(R^{feA})(R^{feB}), -N(R^{feC})-C(=O)-R^{feD} or -N(R^{feC})-C(=O)-O-R^{feD}. R^{feA} and R^{feB} are each independently hydrogen or a C₁-C₆ saturated hydrocarbyl group. R^{feC} is hydrogen, or a C₁-C₆ saturated hydrocarbyl group which may contain halogen, hydroxy, C₁-C₆ saturated hydrocarbyloxy, C₂-C₆ saturated hydrocarbylcarbonyl or C₂-C₆ saturated hydrocarbylcarbonyloxy moiety. R^{feD} is a C₁-C₁₆ aliphatic hydrocarbyl group, C₆-C₁₂ aryl group or C₇-C₁₅ aralkyl group, which may contain halogen, hydroxy, C₁-C₆ saturated hydrocarbyloxy, C₂-C₆ saturated hydrocarbylcarbonyl or C₂-C₆ saturated hydrocarbylcarbonyloxy moiety. The aliphatic hydrocarbyl group may be saturated or unsaturated and straight, branched or cyclic. The hydrocarbyl, hydrocarbyloxy, hydrocarbylcarbonyl, hydrocarbyloxycarbonyl, hydrocarbylcarbonyloxy, and hydrocarbylsulfonyloxy groups may be straight, branched or cyclic. A plurality of R^{fe} may be identical or different when x and/or z is 2 or more.

Of these, R^{fe} is preferably hydroxy, -N(R^{feC})-C(=O)-R^{feD}, -N(R^{feC})-C(-O)-O-R^{feD}, fluorine, chlorine, bromine, methyl or methoxy.

In formula (B6-5), Rf¹¹ to Rf¹⁴ are each independently hydrogen, fluorine or trifluoromethyl, at least one of Rf¹¹ to Rf¹⁴ is fluorine or trifluoromethyl. Rf¹¹ and Rf¹², taken together, may form a carbonyl group. More preferably, both Rf¹³ and Rf¹⁴ are fluorine.

Examples of the anion having formula (B6-5) are shown below, but not limited thereto. X^{BI} is as defined above.

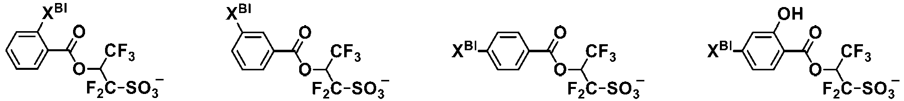

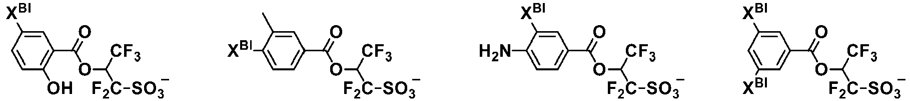

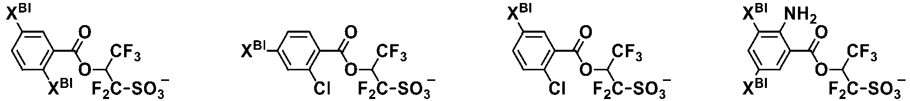

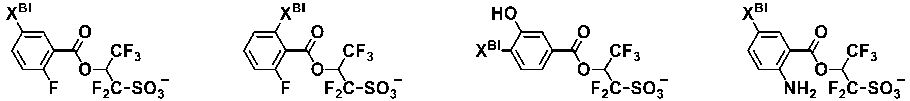

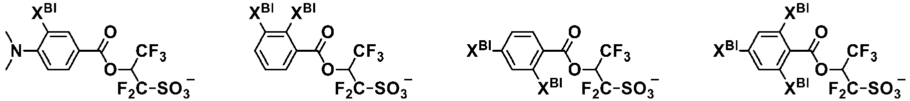

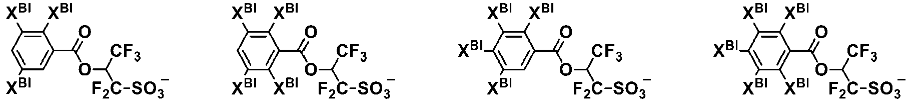

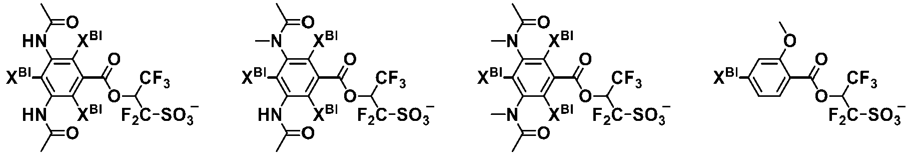

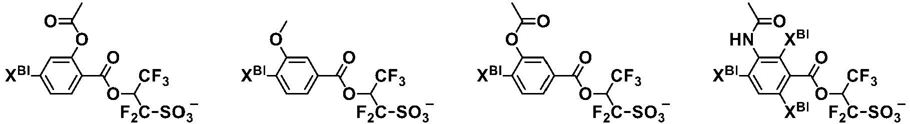

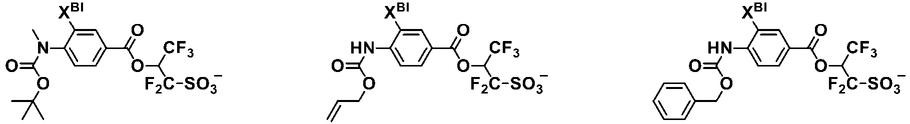

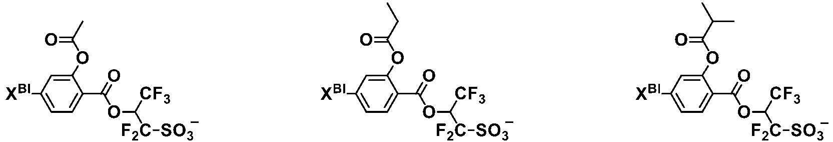

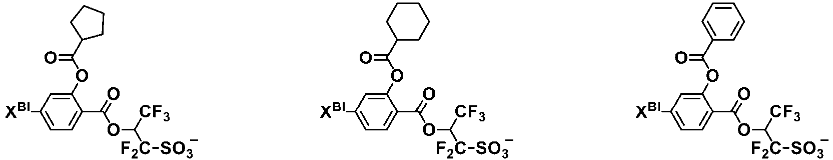

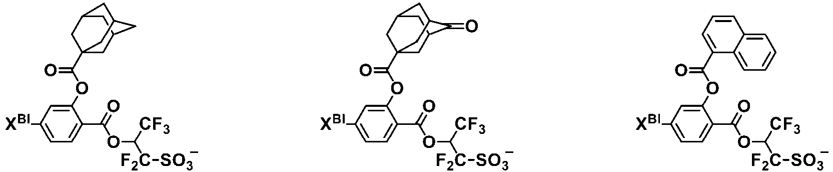

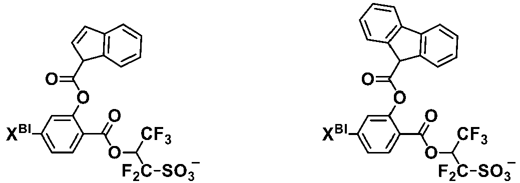

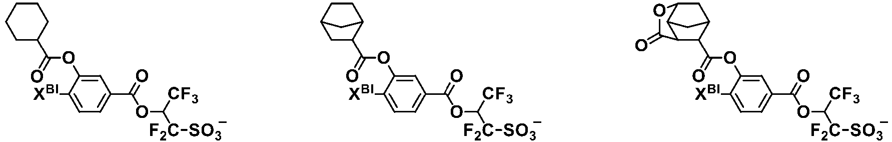

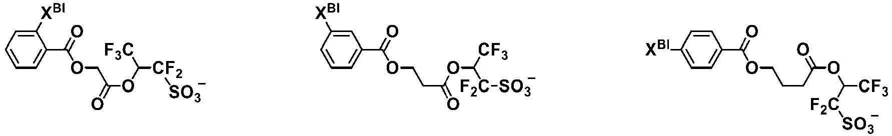

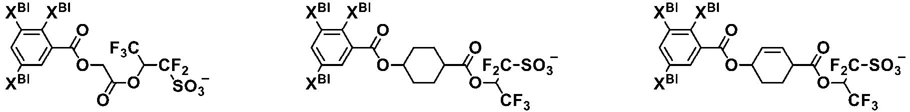

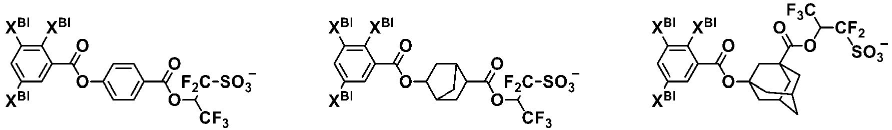

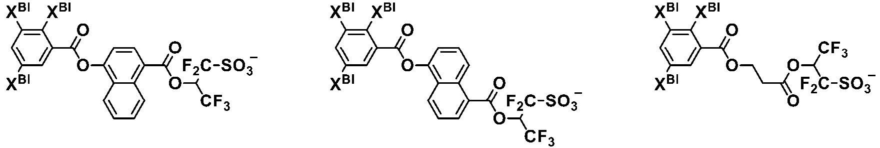

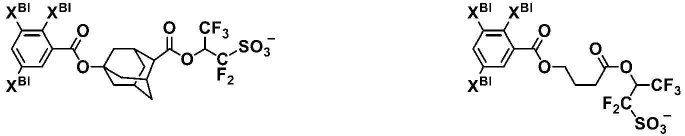

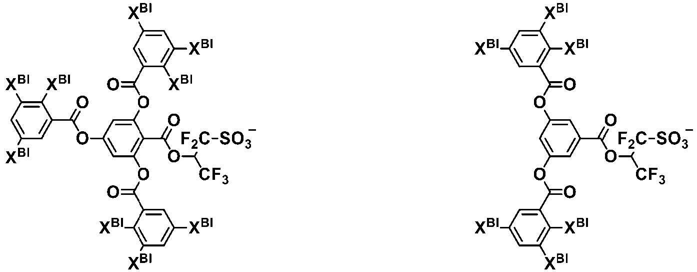

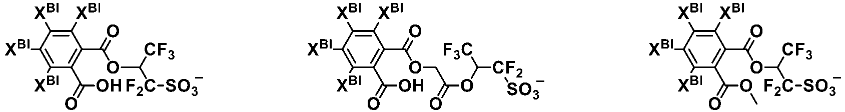

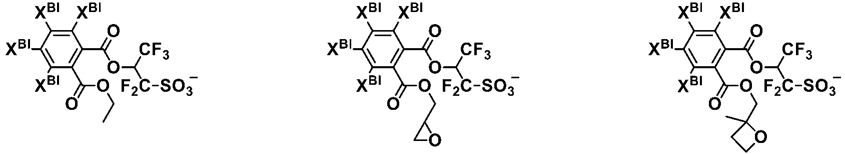

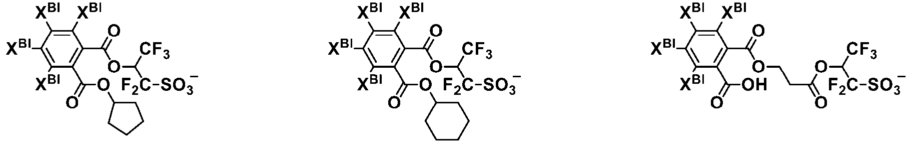

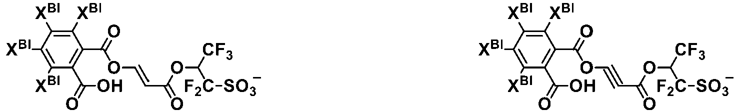

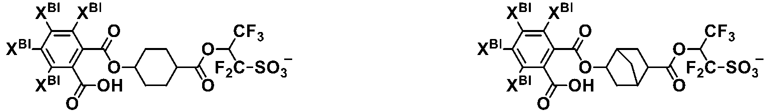

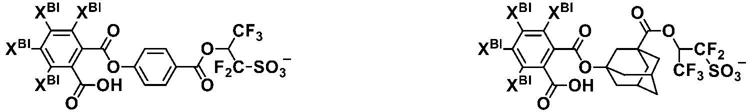

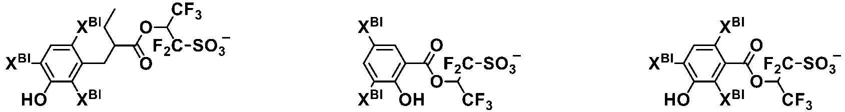

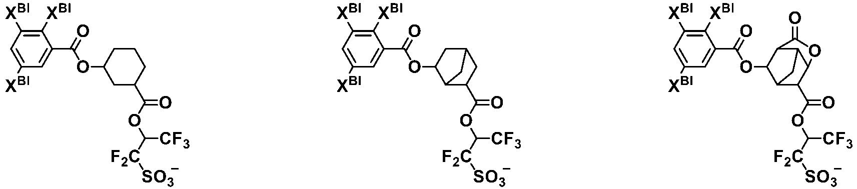

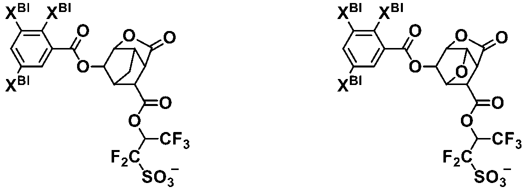

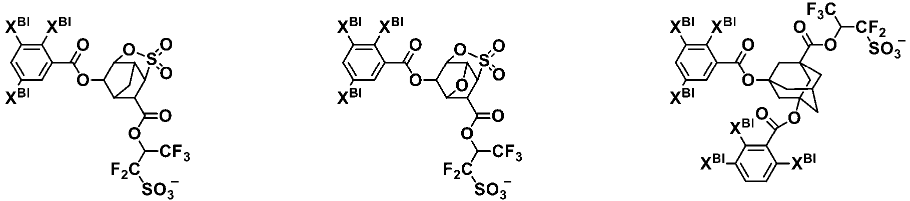

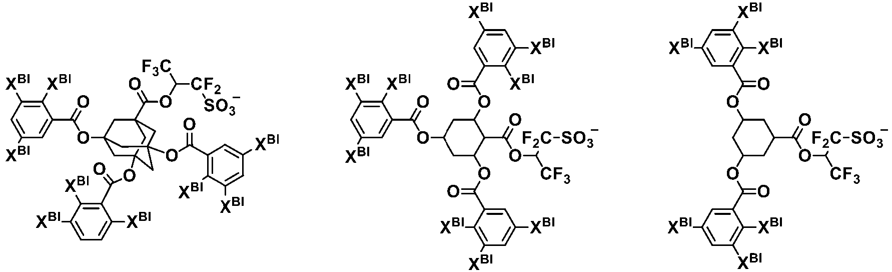

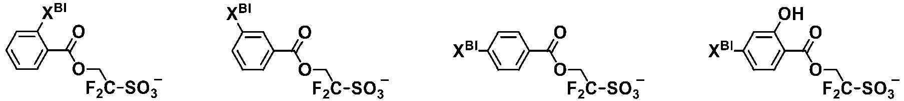

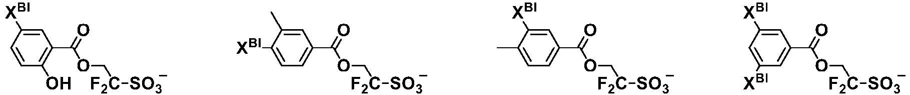

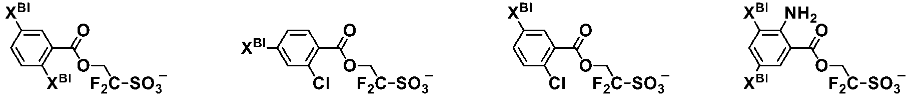

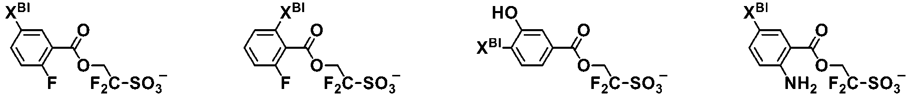

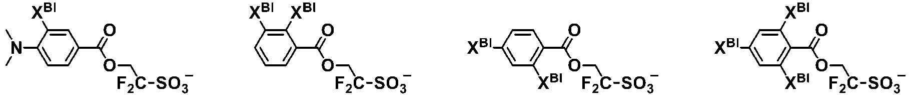

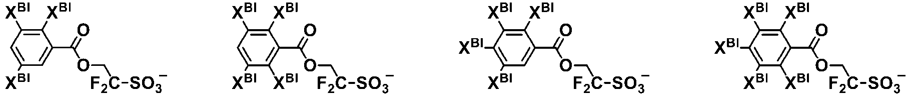

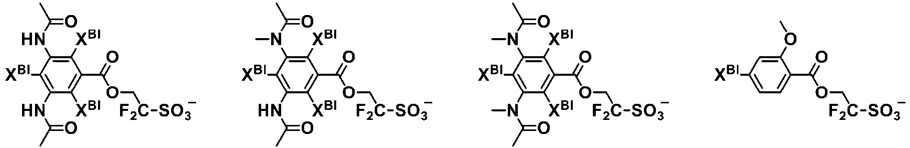

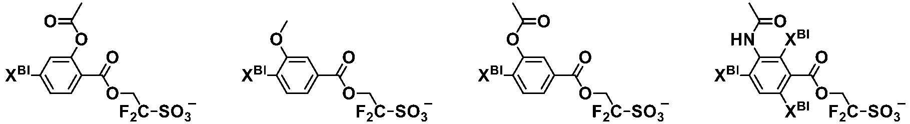

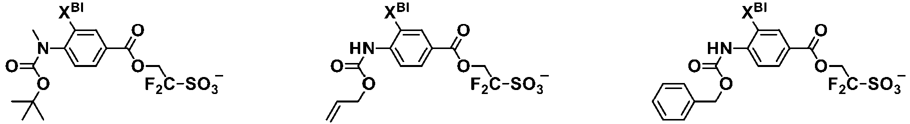

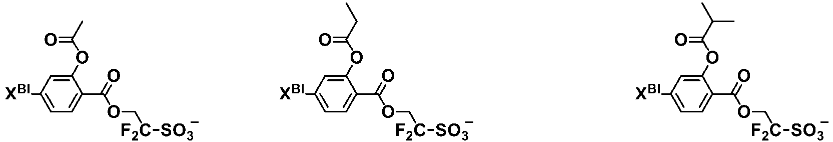

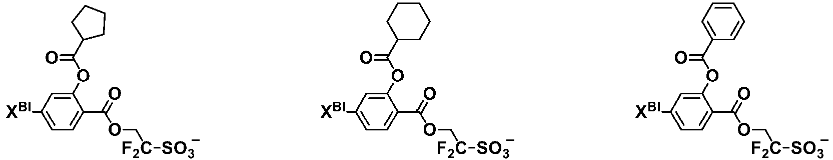

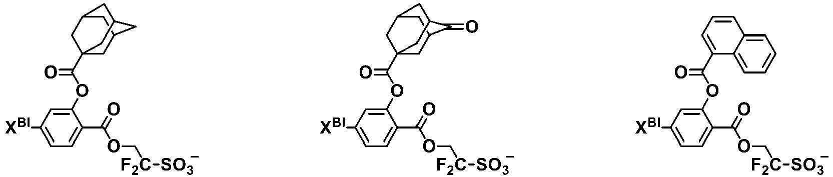

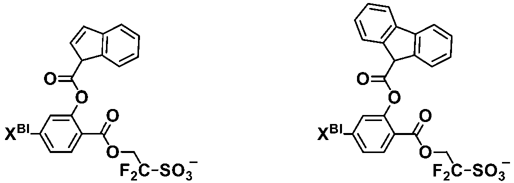

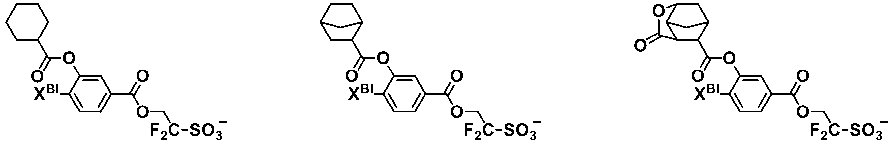

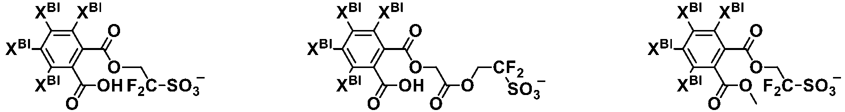

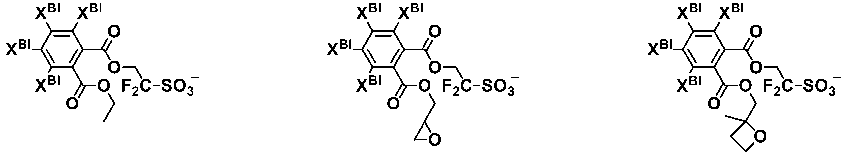

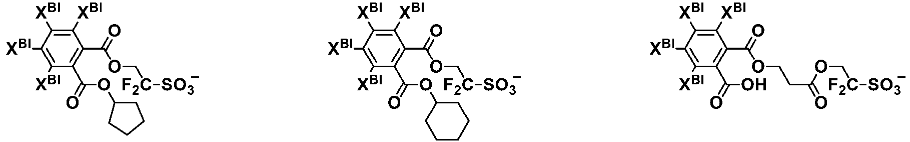

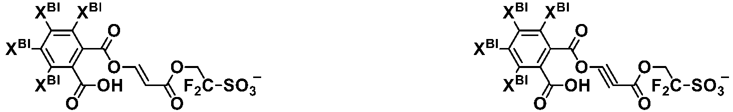

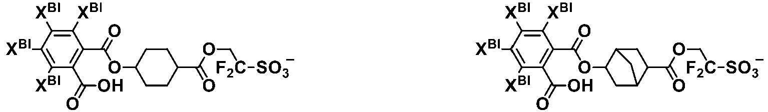

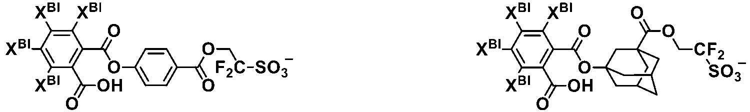

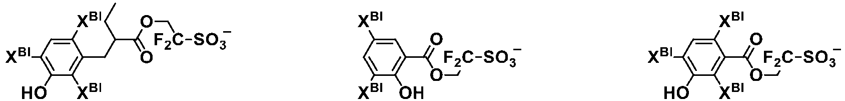

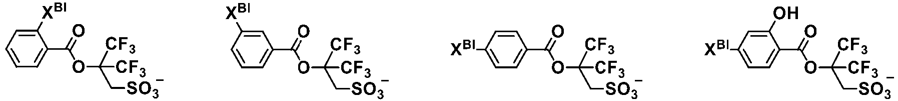

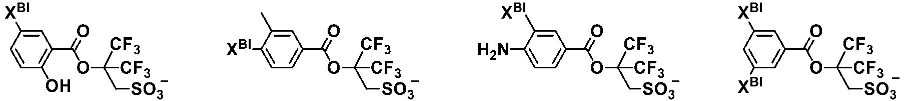

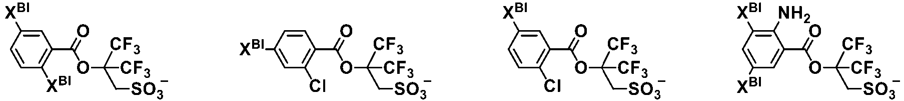

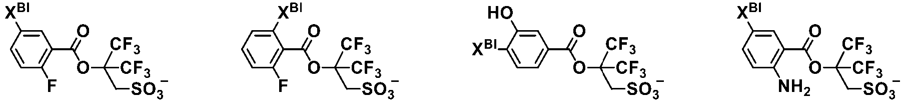

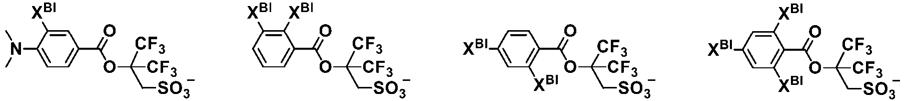

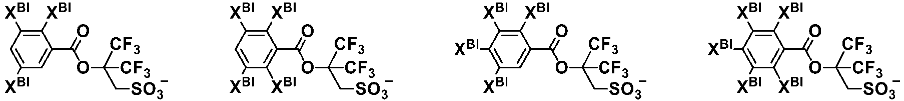

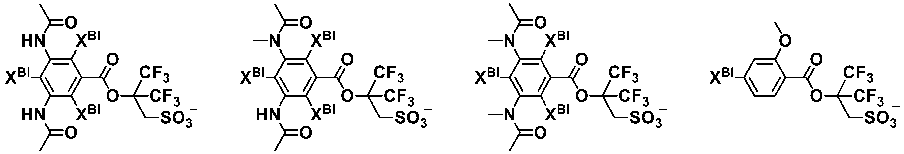

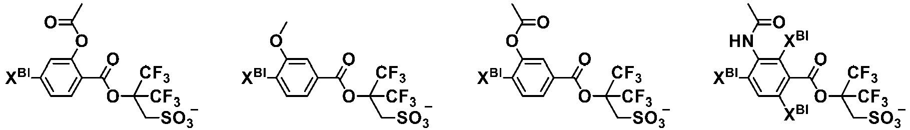

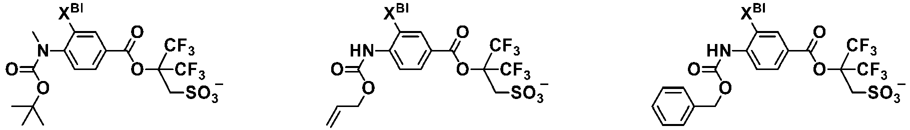

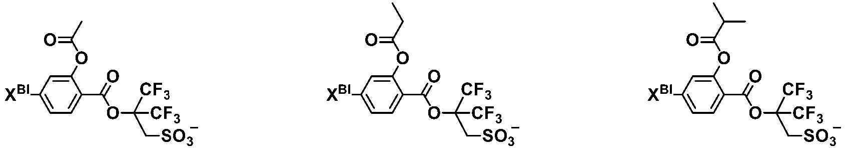

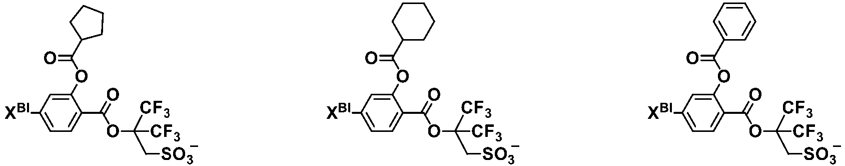

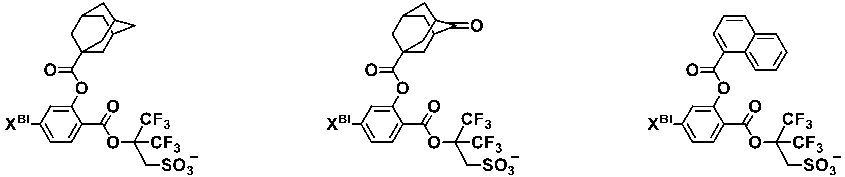

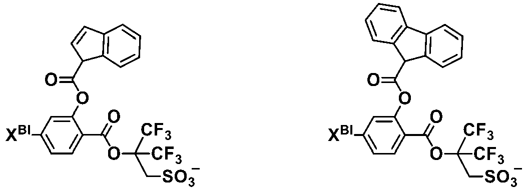

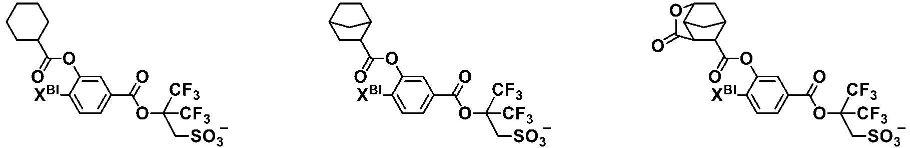

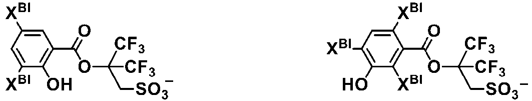

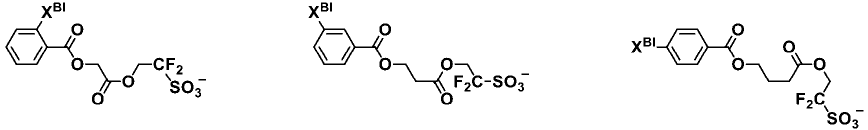

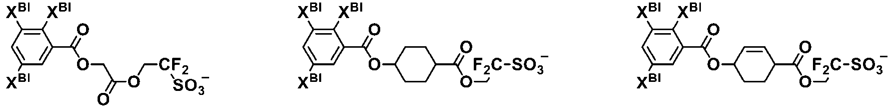

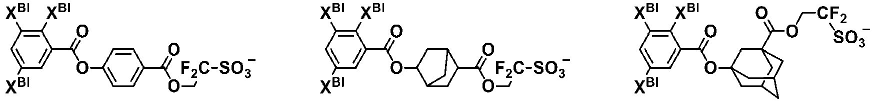

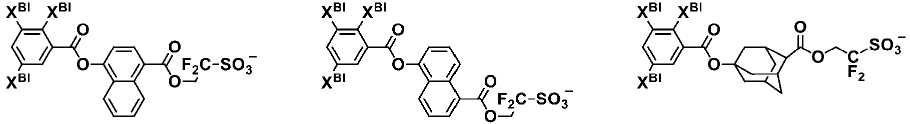

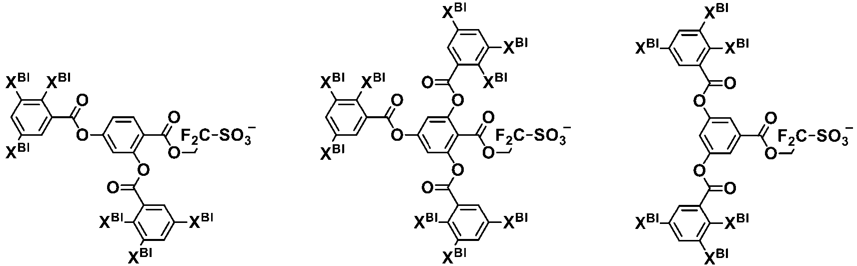

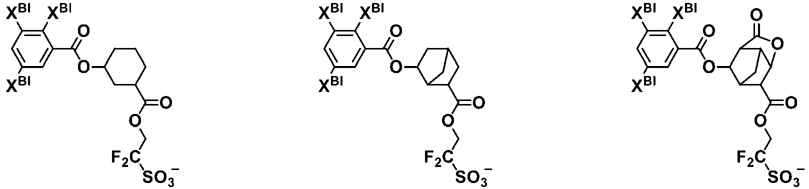

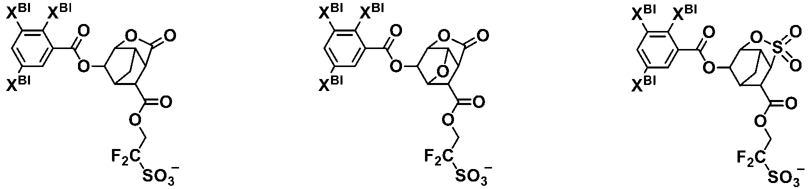

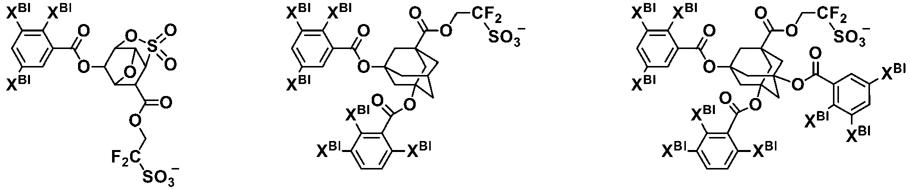

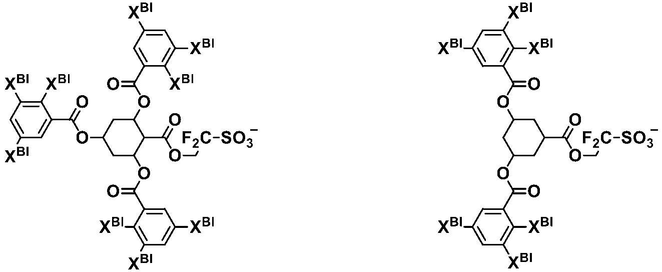

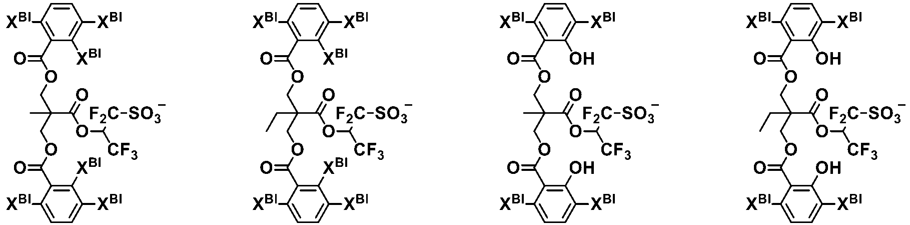

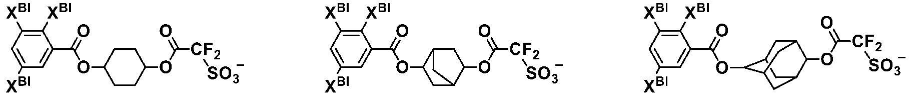

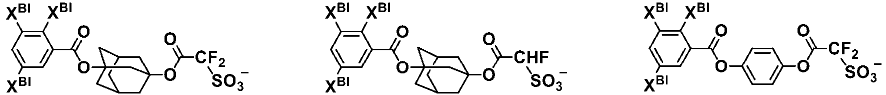

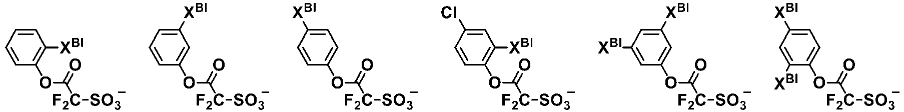

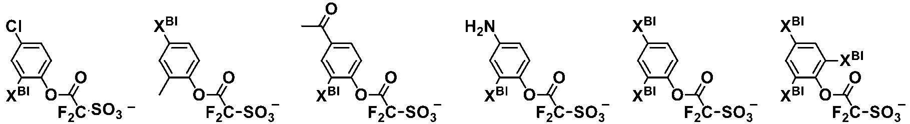

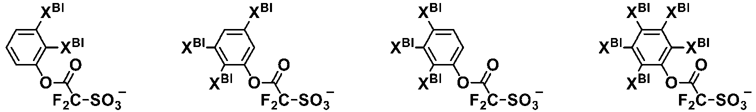

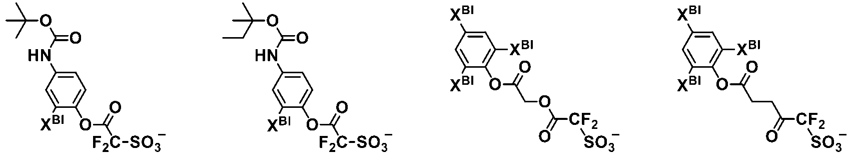

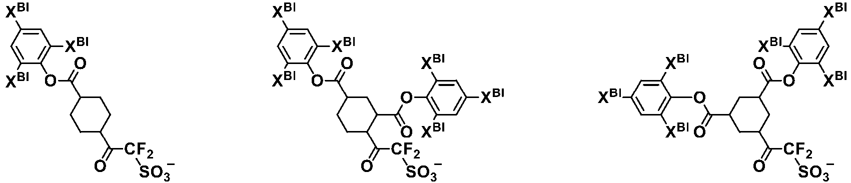

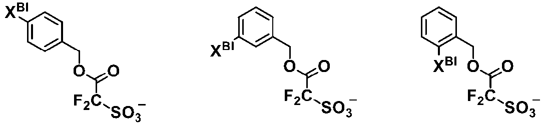

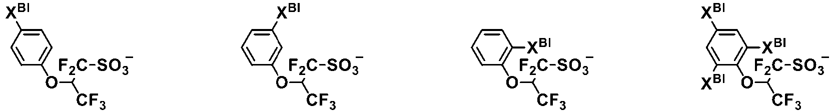

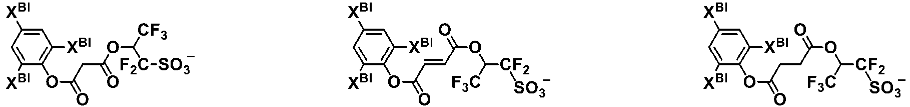

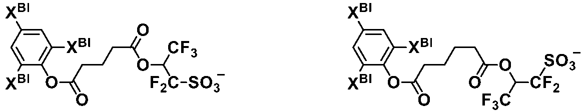

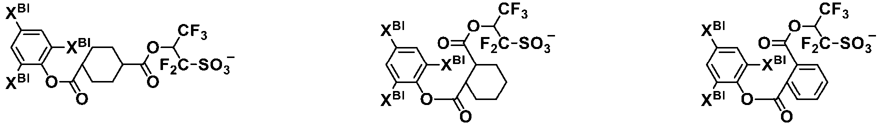

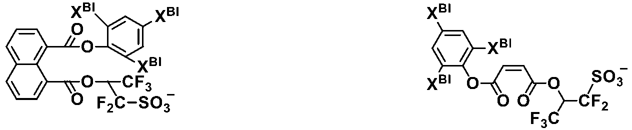

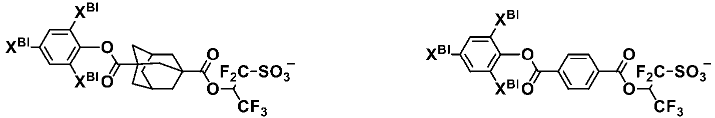

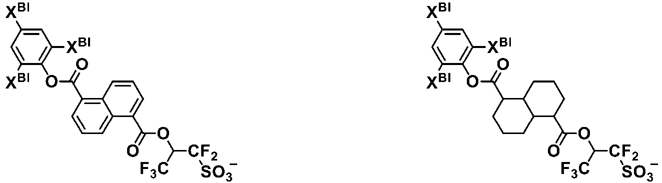

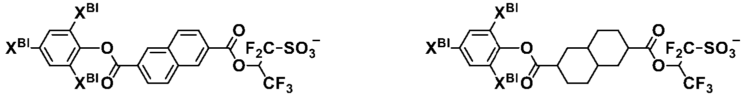

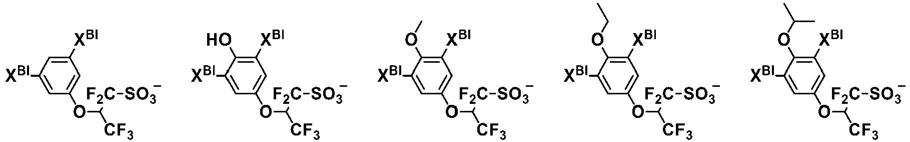

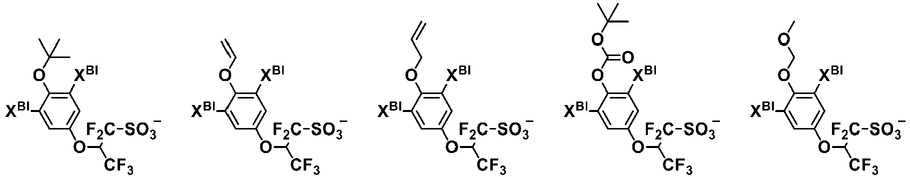

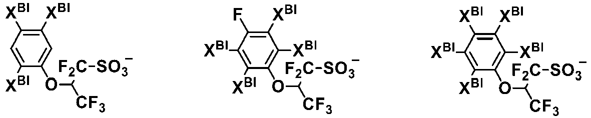

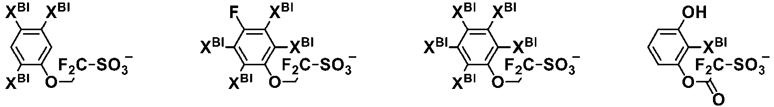

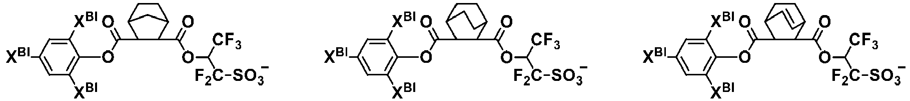

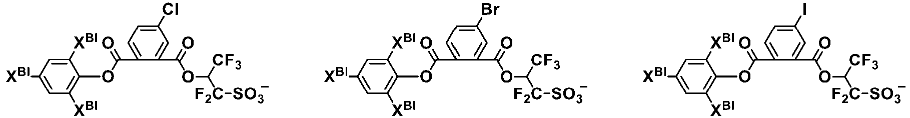

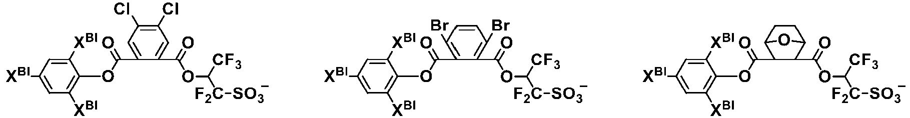

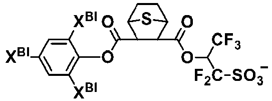

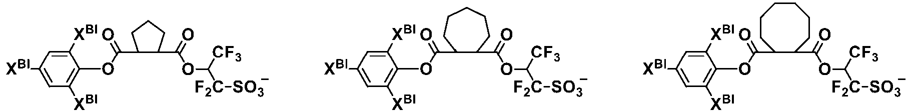

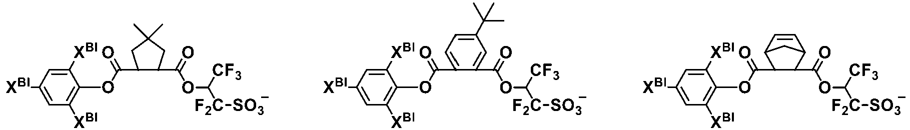

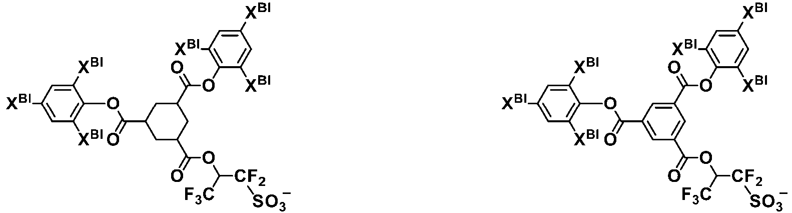

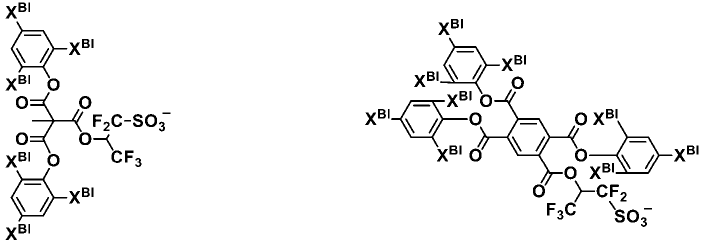

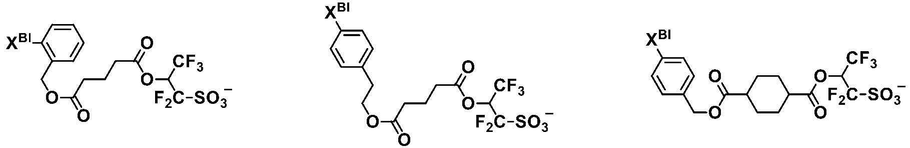

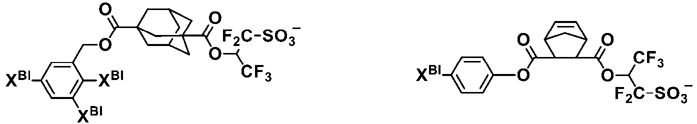

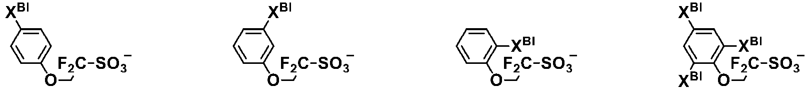

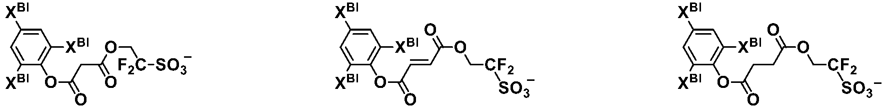

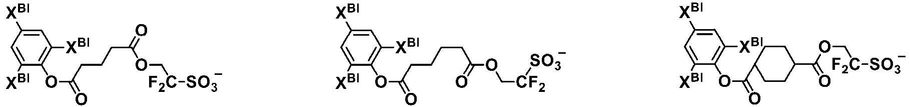

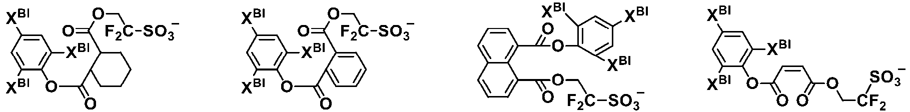

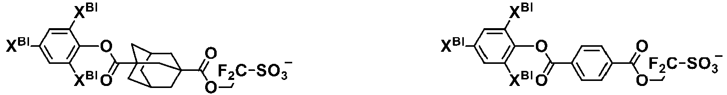

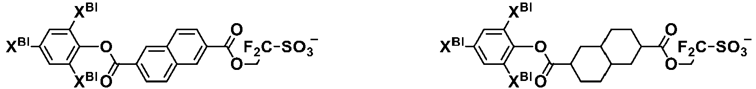

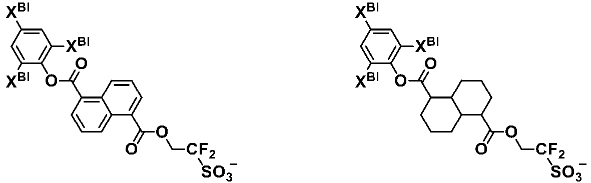

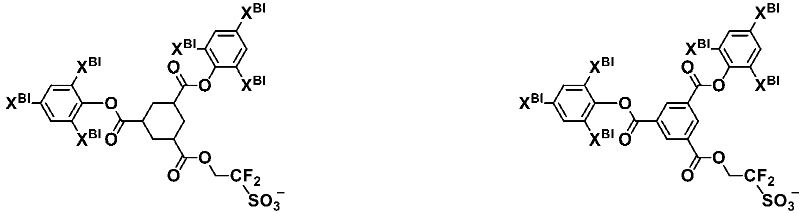

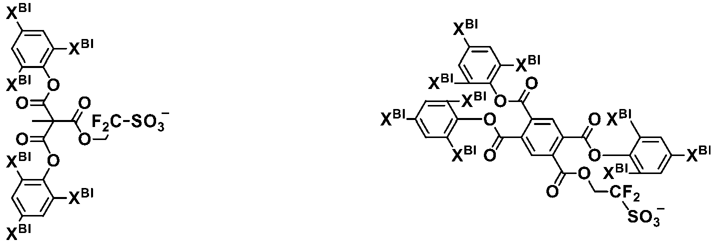

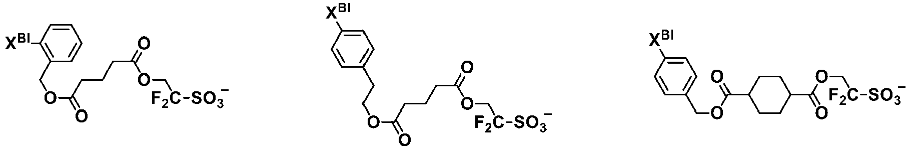

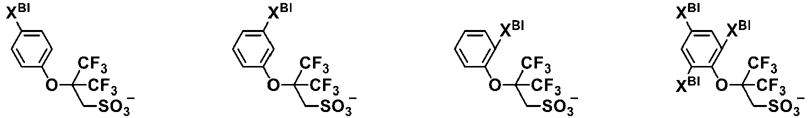

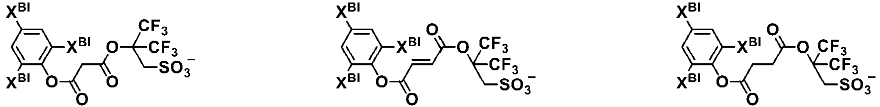

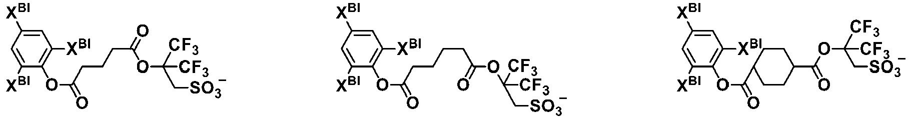

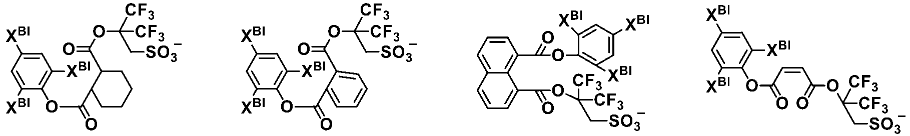

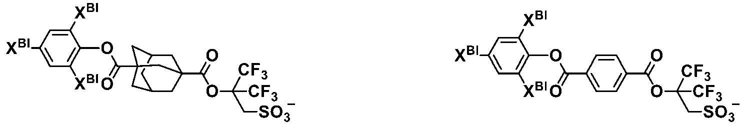

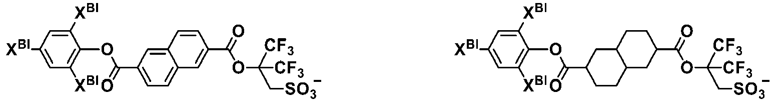

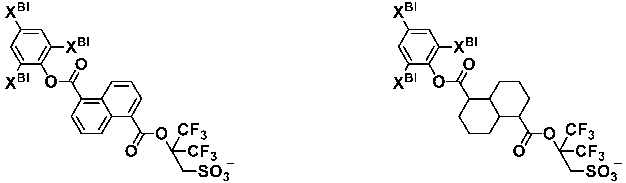

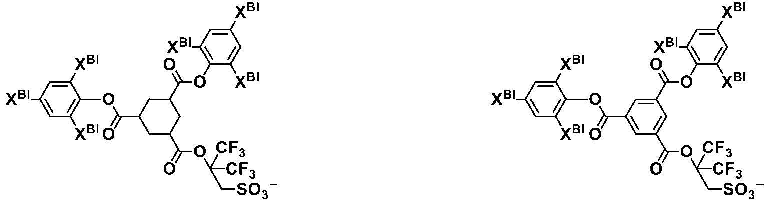

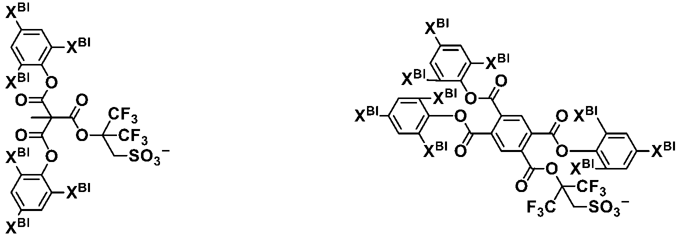

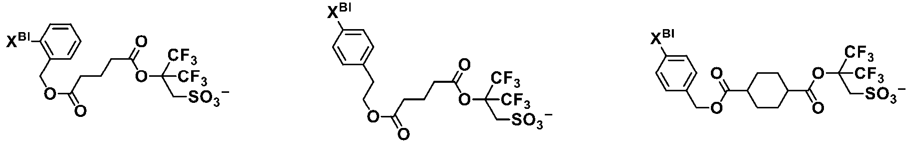

Other examples of the anion M⁻ include those described in the following patent documents.
WO 2023/157455, paragraphs [0076] and [0106]
WO 2024/024801, paragraph [0111]
WO 2024/043121, paragraphs [0253]-[0256]
WO 2024/057751, paragraphs [0044]-[0045]
WO 2024/122423, paragraphs [0205]-[0220]
JP-A 2023-123183, paragraphs [0170]-[0178]
JP-A 2024-062406, paragraphs [0026]-[0028]
JP-A 2024-062407, paragraphs [0022]-[0025]
JP-A 2024-062408, paragraphs [0026]-[0028]
JP-A 2024-068156, paragraphs [0028]-[0030]
JP-A 2024-068157, paragraphs [0026]-[0028]
JP-A 2024-068158, paragraphs [0028]-[0030]
JP-A 2024-068159, paragraphs [0028]-[0030]
JP-A 2024-072280, paragraphs [0031]-[0033]
JP-A 2024-072281, paragraphs [0023]-[0025]
JP-A 2024-077618, paragraphs [0026]-[0029]
JP-A 2024-077619, paragraphs [0020]-[0021]
JP-A 2024-080672, paragraphs [0140]-[0143]
JP-A 2024-083303, paragraphs [0023]-[0025]
JP-A 2024-083304, paragraphs [0028]-[0031]
JP-A 2024-099500, paragraphs [0030]-[0033]
JP-A 2024-099502, paragraphs [0028]-[0030]
JP-A 2024-101557, paragraphs [0030]-[0032]
JP-A 2024-102842, paragraphs [0025]-[0027]
JP-A 2024-102843, paragraphs [0033]-[0035]
JP-A 2024-127832, paragraphs [0021]-[0022]
JP-A 2024-144354, paragraphs [0169]-[0172]
JP-A 2024-144356, paragraphs [0178]-[0181]
JP-A 2024-160436, paragraphs [0040]-[0043]
JP-A 2025-000705, paragraphs [0030]-[0031]
JP 7247732, paragraphs [0157]-[0158]
JP 7446352, paragraphs [0227]-[0238]
JP 7466597, paragraphs [0253]-[0256]
JP 7466782, paragraphs [0309]-[0312]

The anion having formula (A2) may also be used as the non-nucleophilic counter ion.

Further useful examples of the non-nucleophilic counter ion include fluorine-free bulky benzenesulfonic acid anions as described in JP-A 2006-276759, JP-A 2015-117200, JP-A 2016-065016, and JP-A 2019-202974; fluorine-free benzenesulfonic acid or alkylsulfonic acid anions having an iodized aromatic group bonded thereto as described in JP 6645464.

Other examples of the non-nucleophilic counter ion include the fluorine-free aromatic sulfonate anions and alkanesulfonate anions described in JP 7398551, paragraphs [0186]-[0188], JP 7067271, paragraphs [0028]-[0029], JP 7032549, paragraphs [0220]-[0225], JP 6645464, paragraphs [0040]-[0045], JP 6248882, paragraphs [0027]-[0029], JP 6090585, paragraphs [0034]-[0037], JP-A 2024-104830, paragraphs [0037]-[0060], JP-A 2024-140135, paragraphs [0033]-[0093], JP-A 2023-177038, paragraphs [0039]-[0066], and JP-A 2006-276759, paragraphs [0100]-[0102], and the fluorine-containing aromatic sulfonate anions described in JP 6648726, paragraphs [0029]-[0034], JP-A 2024-077330, paragraphs [0264]-[0267], and JP-A 2025-000201, paragraphs [0040]-[0071].

Further useful non-nucleophilic counter ions include bissulfonic acid anions as described in JP-A 2015-206932, sulfonamide or sulfonimide anions having sulfonic acid side and different side as described in WO 2020/158366, and anions having a sulfonic acid side and a carboxylic acid side as described in JP-A 2015-024989.

In formulae (B7) and (B8), g1 and g2 are each independently 0, 1, 2 or 3, preferably 1.

In formula (B9), h1 is 0 or 1, h2 is 0, 1, 2, 3 or 4, h3 is 0, 1, 2, 3 or 4, meeting 0 ≤ h2+h3 ≤ 4 when h1=0, and 0 ≤ h2+h3 ≤ 6 when h1=1.

In formulae (B7), (B8) and (B9), L¹ is a single bond, ether bond, ester bond, carbonyl, sulfonate ester bond, sulfonamide bond, carbonate bond or carbamate bond. From the aspect of synthesis, an ether bond, ester bond or carbonyl is preferred, with the ester bond or carbonyl being more preferred.

In formula (B7), Rf¹ and Rf² are each independently fluorine or a C₁-C₆ fluorinated saturated hydrocarbyl group. It is preferred that both Rf¹ and Rf² be fluorine because the generated acid has a higher acid strength. Rf³ and Rf⁴ are each independently hydrogen, fluorine or a C₁-C₆ fluorinated saturated hydrocarbyl group. It is preferred for solvent solubility that at least one of Rf³ and Rf⁴ be trifluoromethyl.

In formula (B8), Rf⁵ and Rf⁶ are each independently hydrogen, fluorine or a C₁-C₆ fluorinated saturated hydrocarbyl group. It is excluded that all Rf⁶ and Rf⁶ are hydrogen at the same time. It is preferred for solvent solubility that at least one of Rf⁵ and Rf⁶ be trifluoromethyl.

In formula (B9), Rf⁷ is fluorine, a C₁-C₆ fluorinated alkyl group, C₁-C₆ fluorinated alkoxy group, or C₁-C₆ fluorinated alkylthio group. Rf⁷ is preferably fluorine, trifluoromethyl, difluoromethyl, trifluoromethoxy, difluoromethoxy, trifluoromethylthio or difluoromethylthio, more preferably fluorine, trifluoromethyl or trifluoromethoxy. When h2 is 2, 3 or 4, a plurality of Rf⁷ may be identical or different.

In formula (B9), R⁴³ is halogen exclusive of fluorine or a C₁-C₂₀ hydrocarbyl group which may contain a heteroatom. The hydrocarbyl group may be saturated or unsaturated and straight, branched or cyclic. Examples thereof are as exemplified above for the hydrocarbyl group R¹ to R³ in formula (A1), but not limited thereto. When h3 is 2, 3 or 4, a plurality of R⁴³ may be identical or different.

When g3 is 2, 3 or 4, a plurality of R⁴³ may bond together to form a ring with the carbon atom to which they are attached. Examples of the ring thus formed include cyclopropane, cyclobutane, cyclopentane, cyclohexane, norbornane, and adamantane rings. In the ring, some or all of the hydrogen atoms may be substituted by a moiety containing a heteroatom such as oxygen, sulfur, nitrogen or halogen, and some -CH₂- may be replaced by a moiety containing a heteroatom such as oxygen, sulfur or nitrogen, so that the ring may contain a hydroxy, fluorine, chlorine, bromine, iodine, cyano, carbonyl, ether bond, ester bond, sulfonate ester bond, carbonate bond, lactone ring, sultone ring, carboxylic anhydride (-C(=O)-O-C(=O)-) or haloalkyl moiety.

Examples of the anion in repeat unit B7 are shown below, but not limited thereto. Herein R^{A} is as defined above.

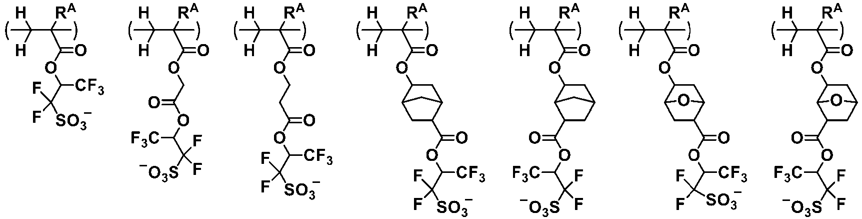

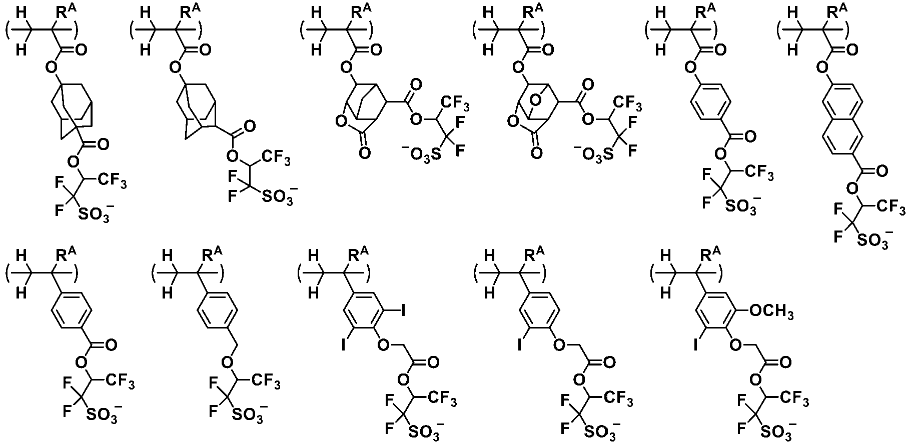

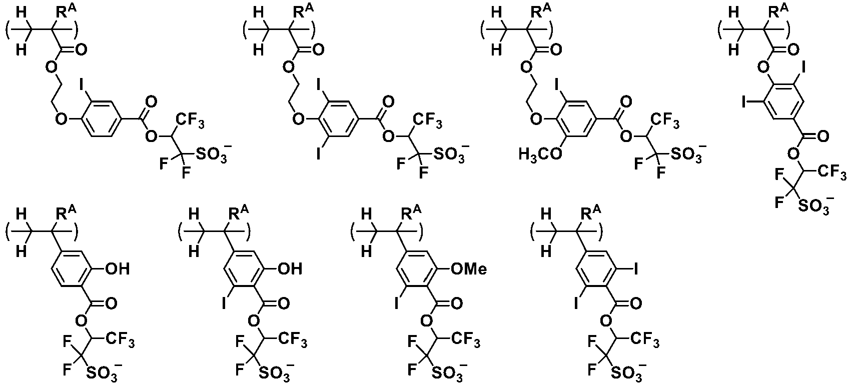

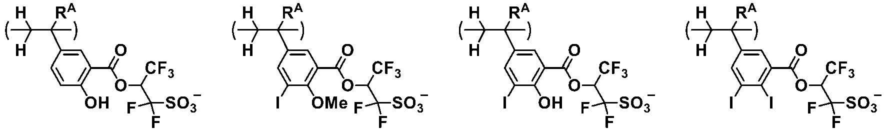

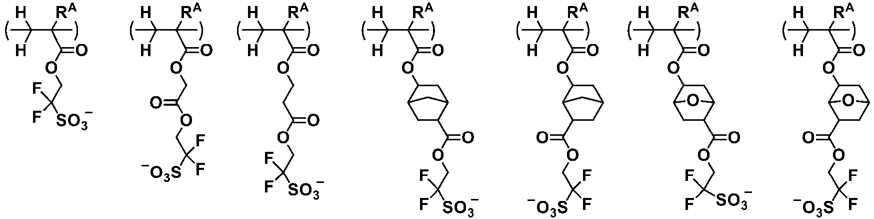

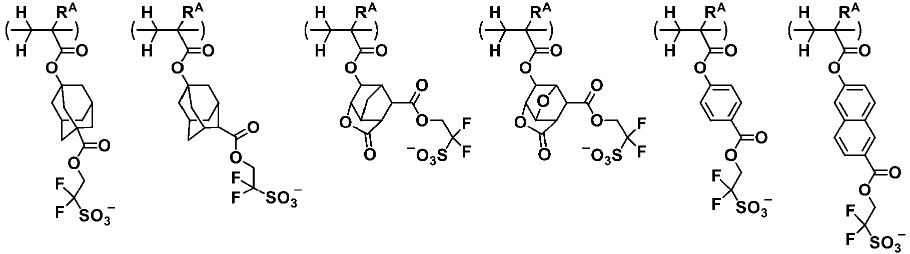

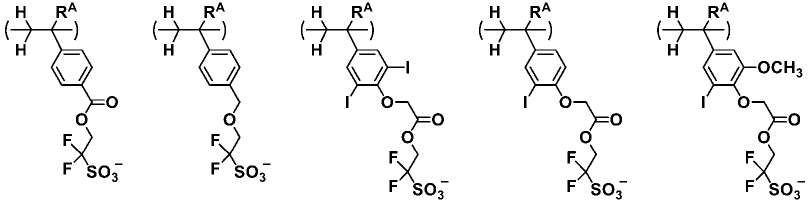

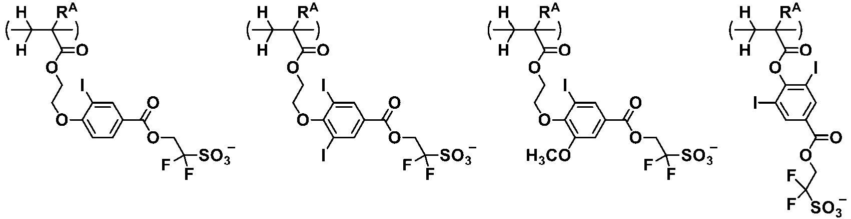

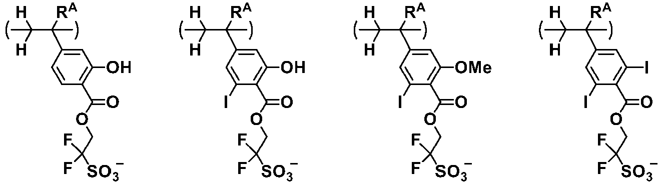

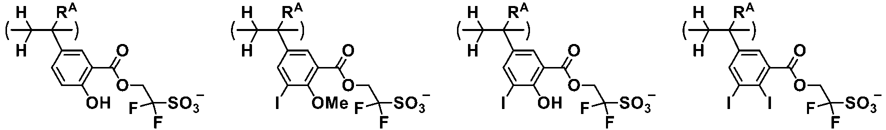

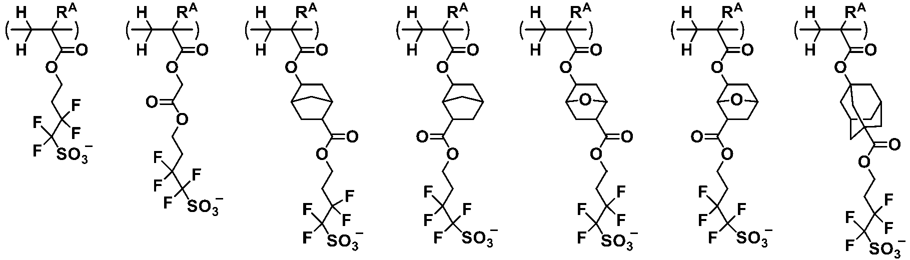

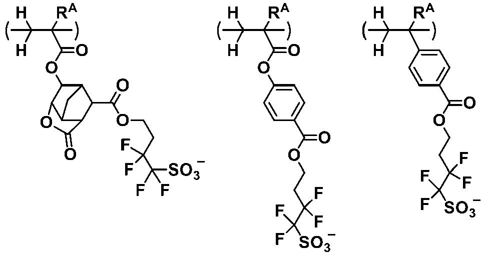

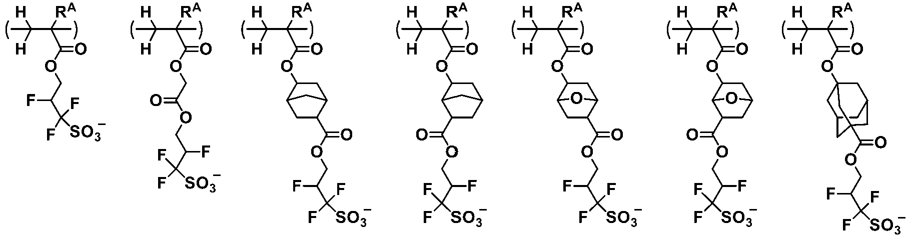

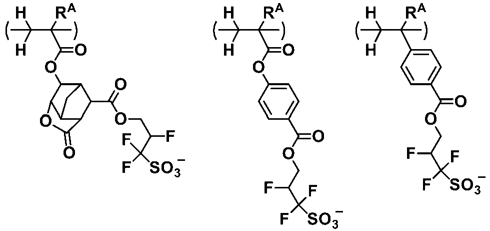

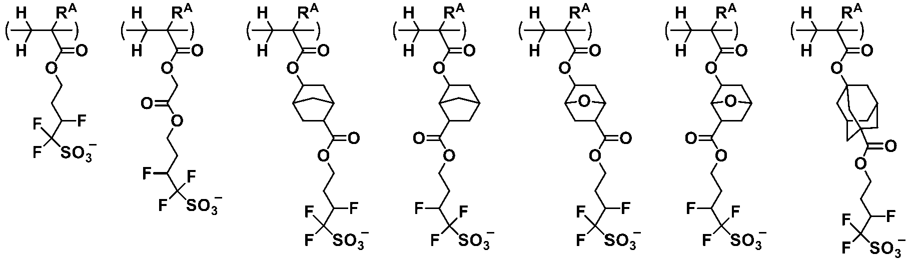

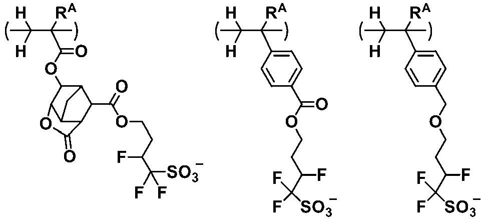

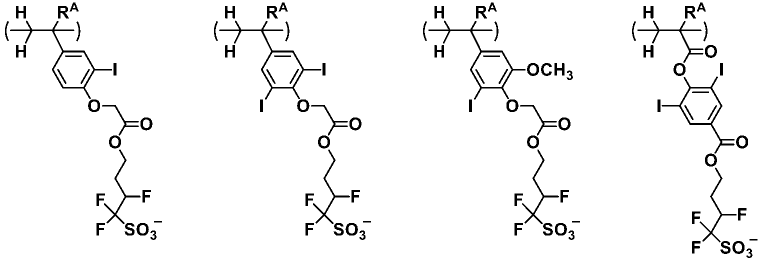

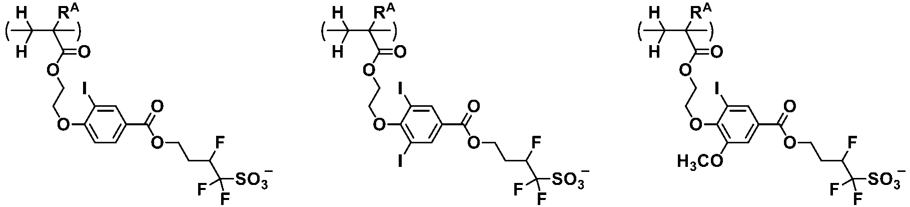

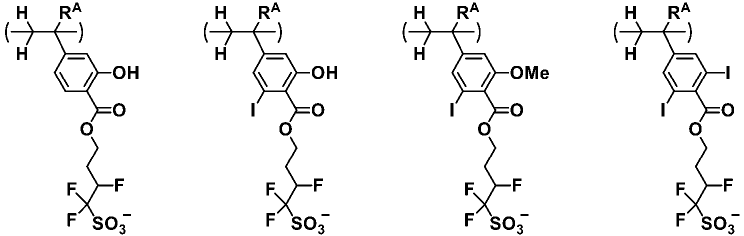

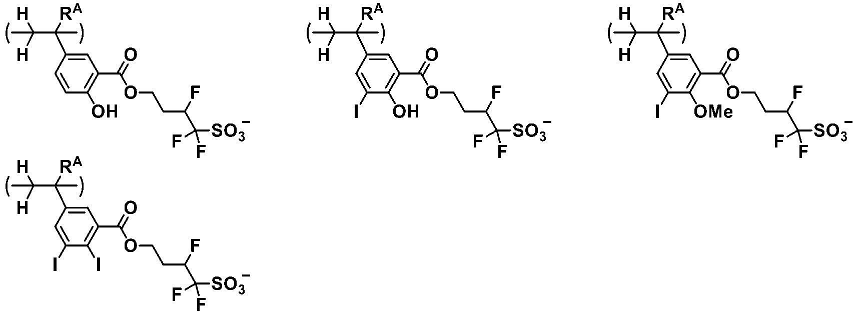

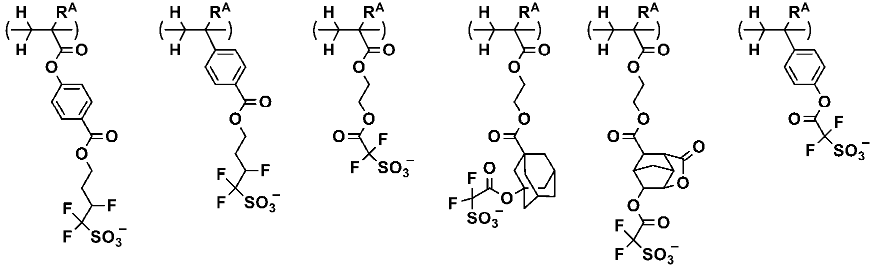

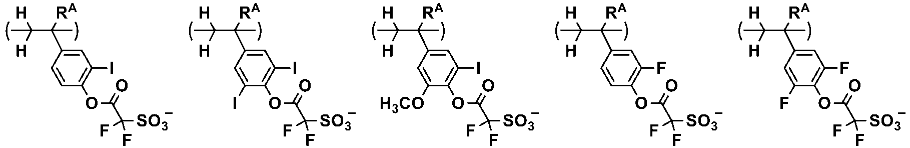

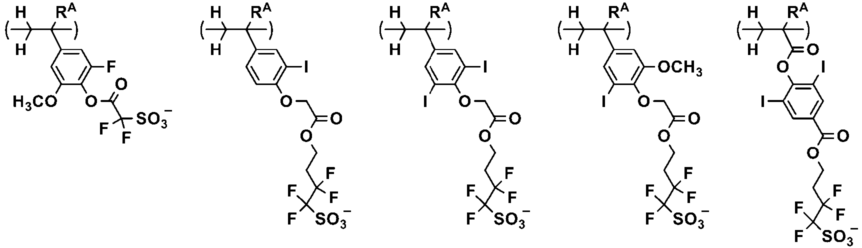

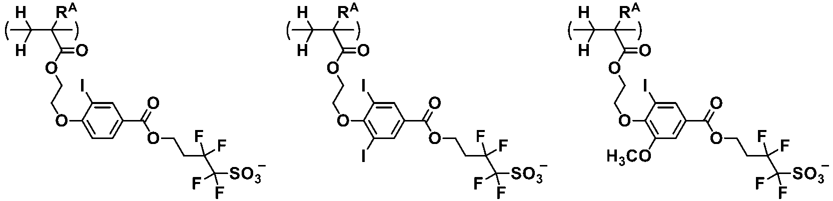

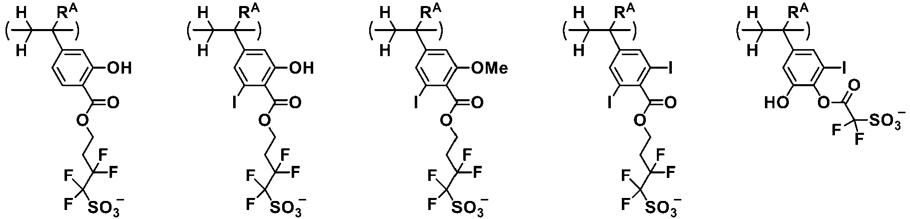

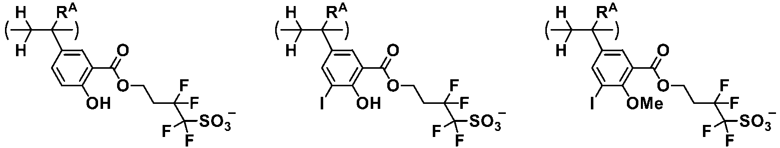

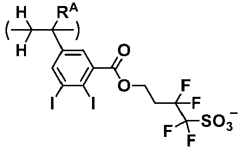

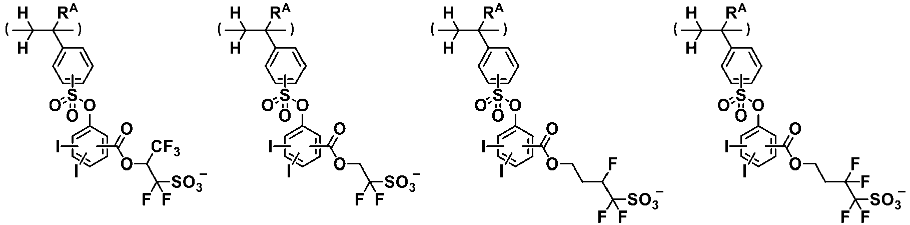

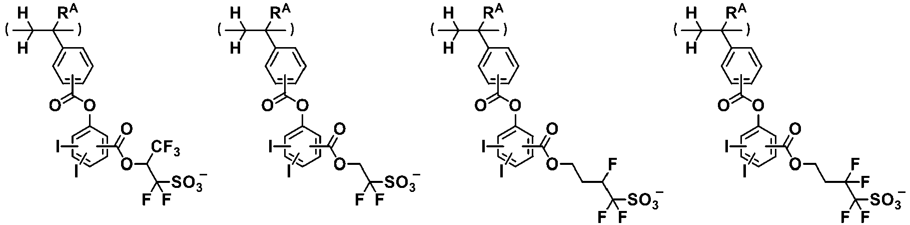

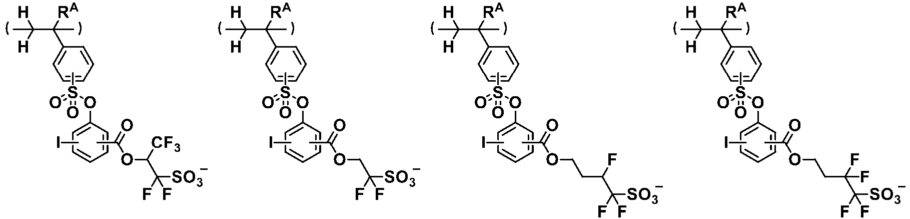

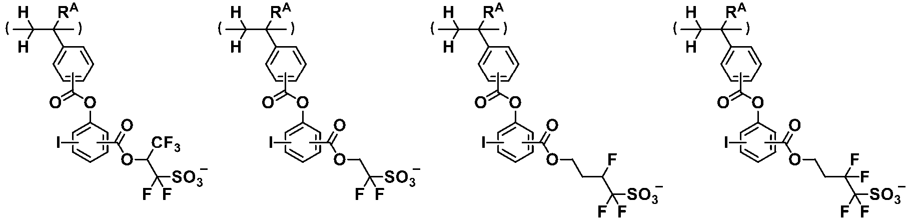

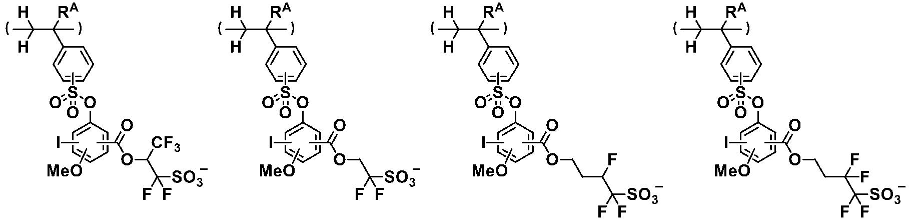

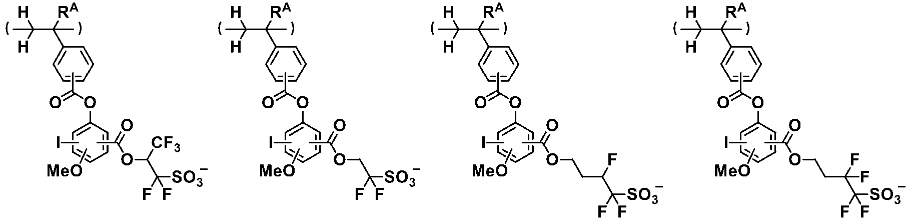

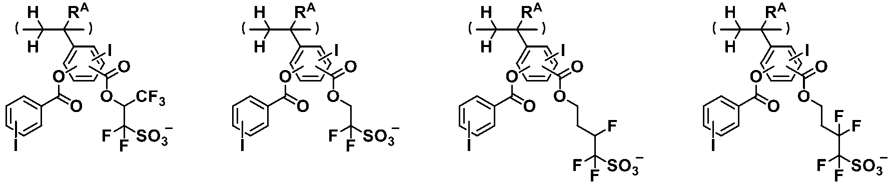

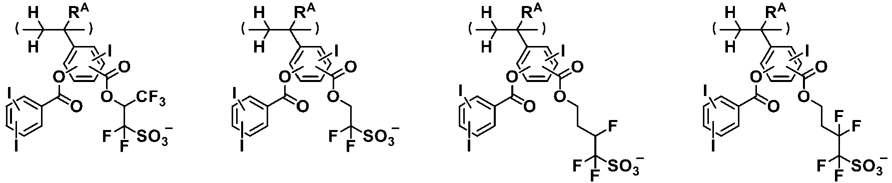

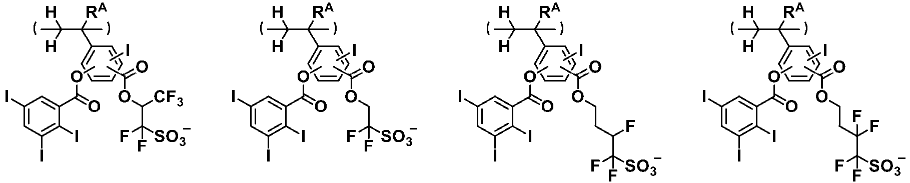

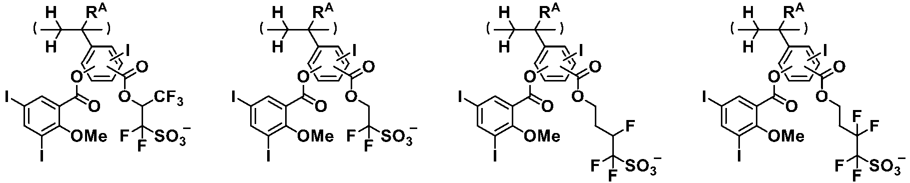

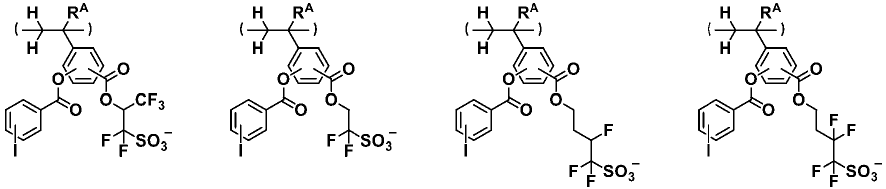

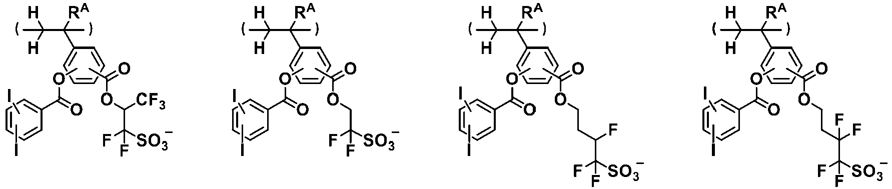

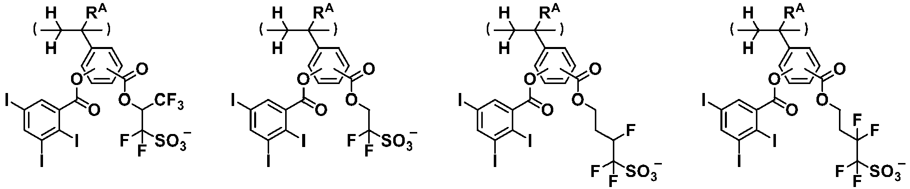

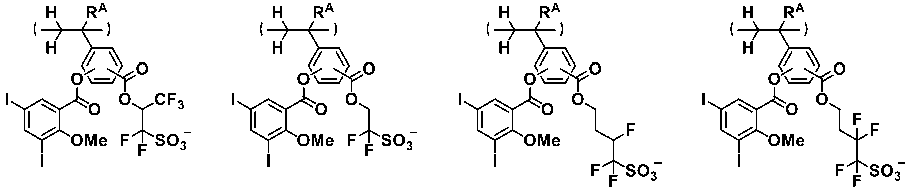

Other examples of repeat unit B7 include those described in WO 2024/176672, paragraphs [0043]-[0044], WO 2024/176701, paragraphs [0067]-[0070], WO 2024/190386, paragraphs [0057]-[0058], JP-A 2024-103465, paragraphs [0020]-[0023], JP-A 2024-120703, paragraphs [0067]-[0070], JP 7520258, paragraphs [0075]-[0084], JP-A 2024-043941, paragraphs [0032]-[0047], JP-A 2025-013053, paragraphs [0385]-[0390], and WO 2025/018169, paragraphs [0062]-[0064].

Examples of the anion in repeat unit B8 are shown below, but not limited thereto. Herein R^{A} is as defined above.

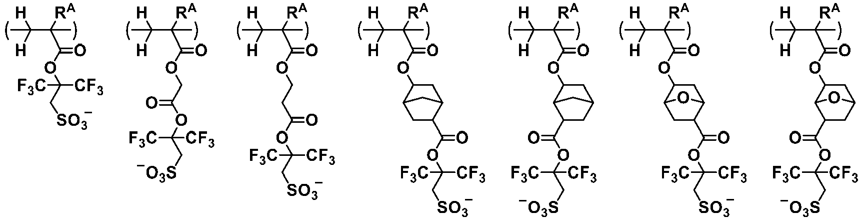

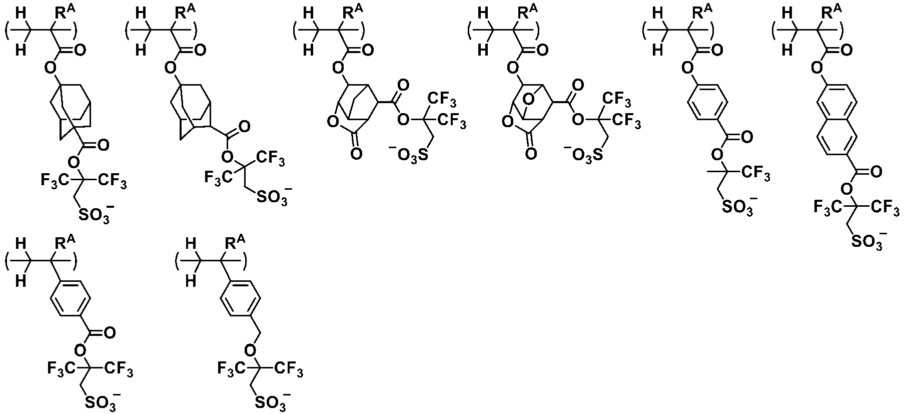

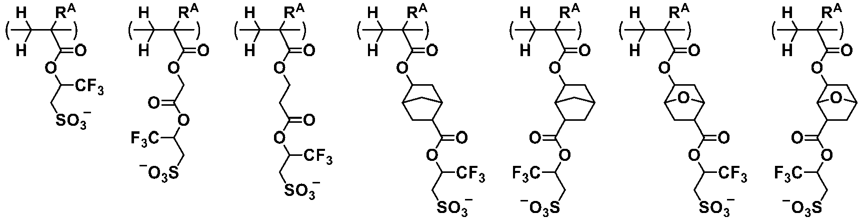

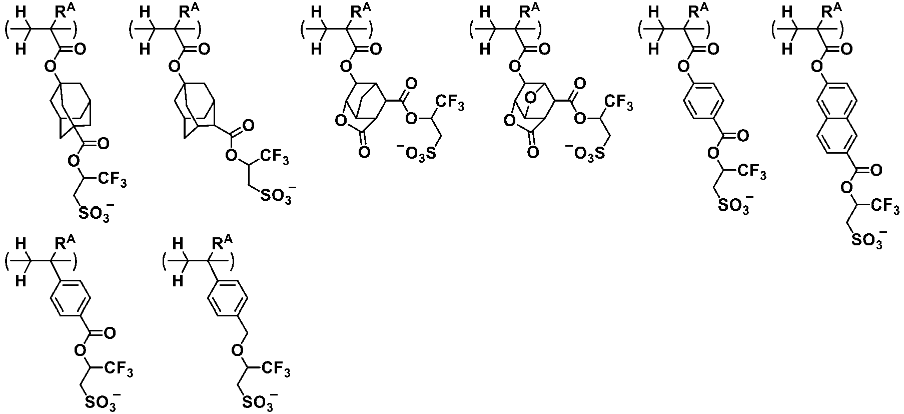

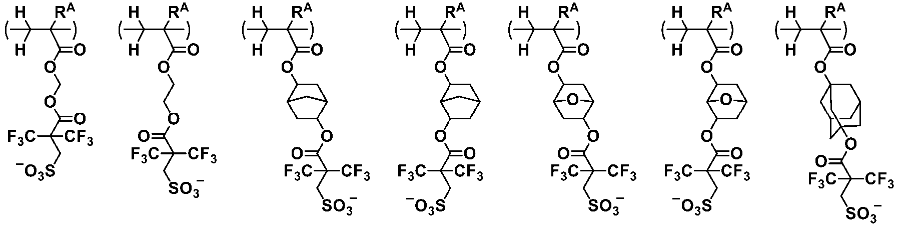

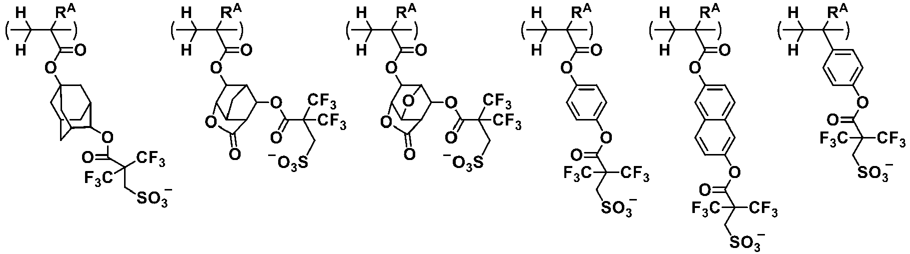

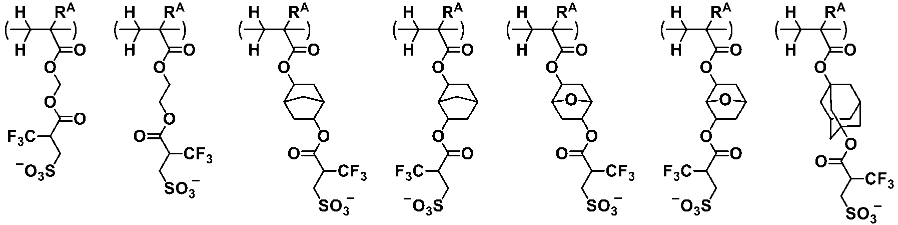

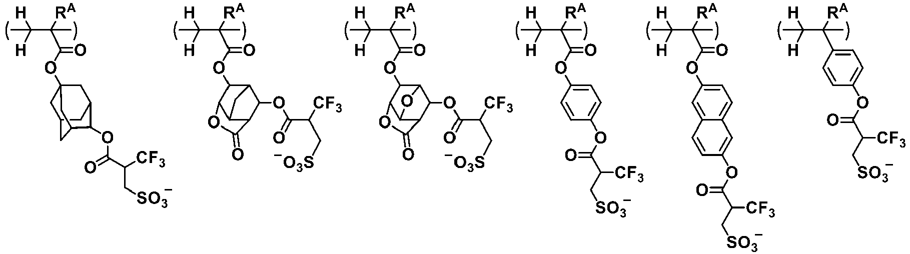

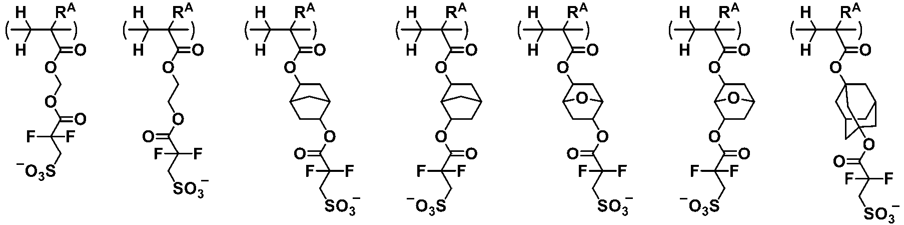

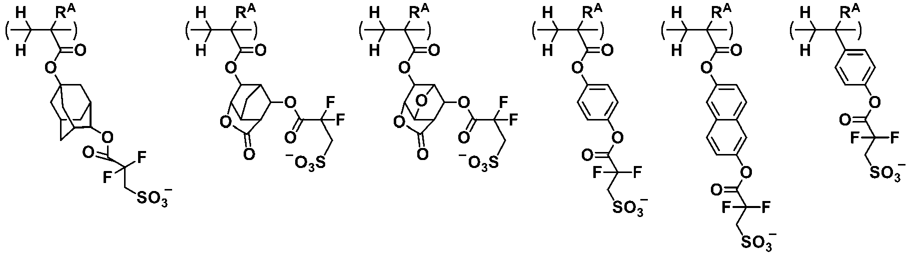

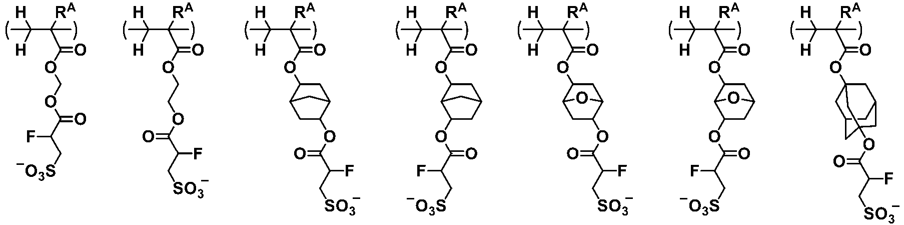

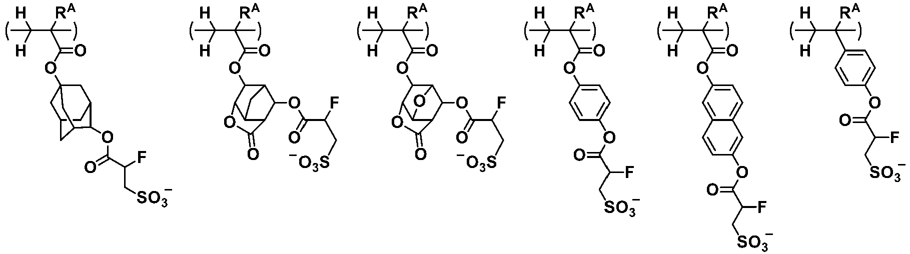

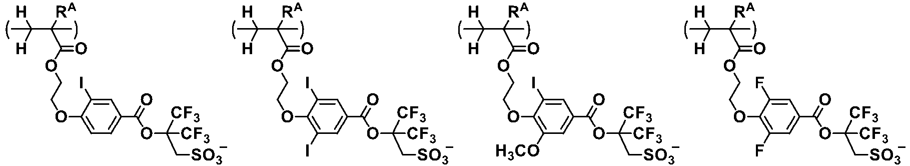

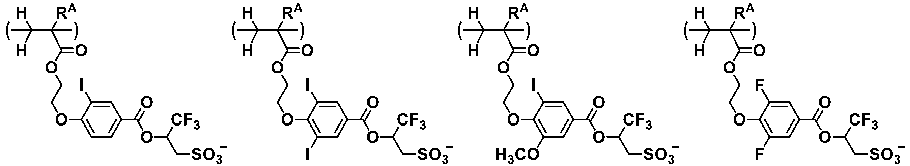

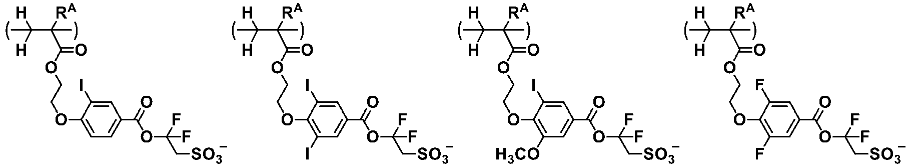

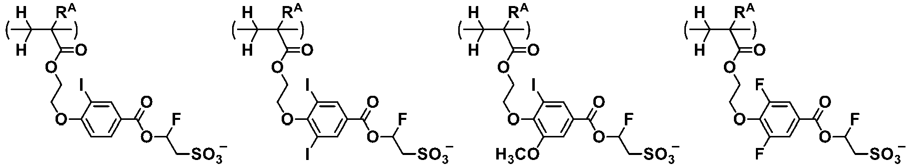

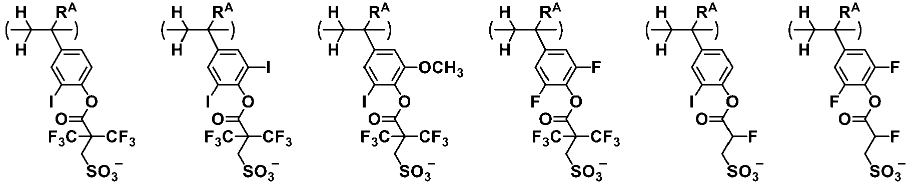

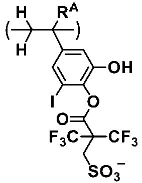

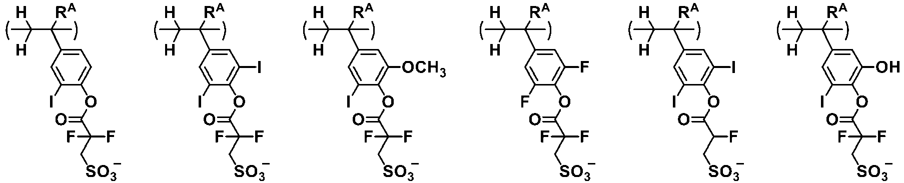

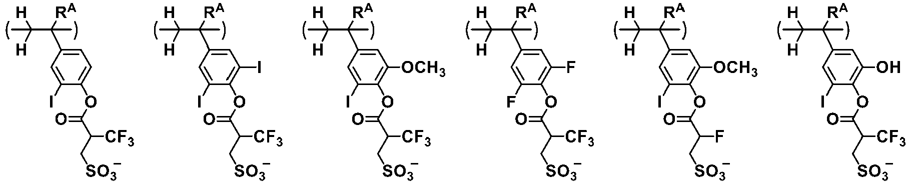

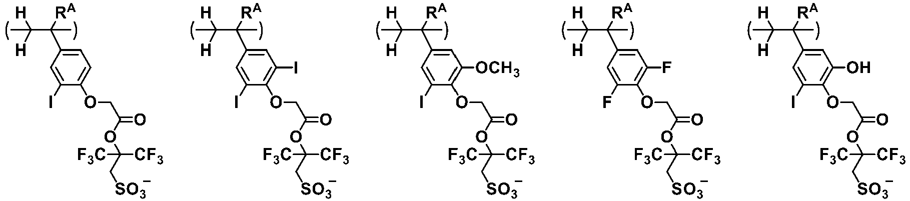

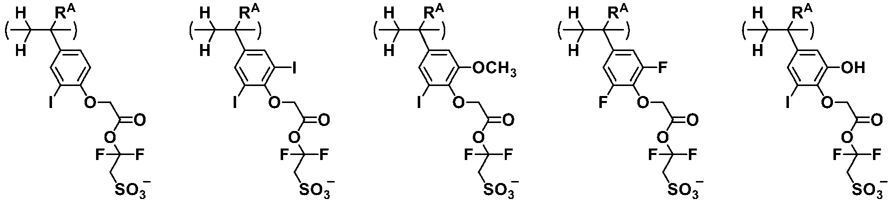

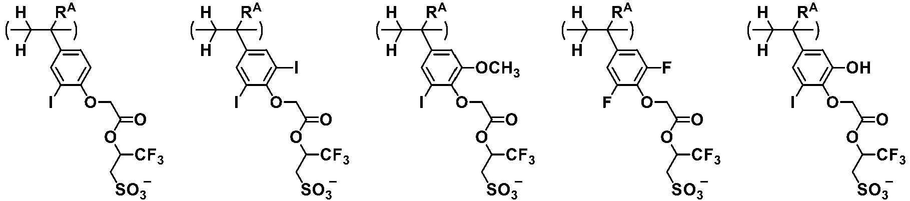

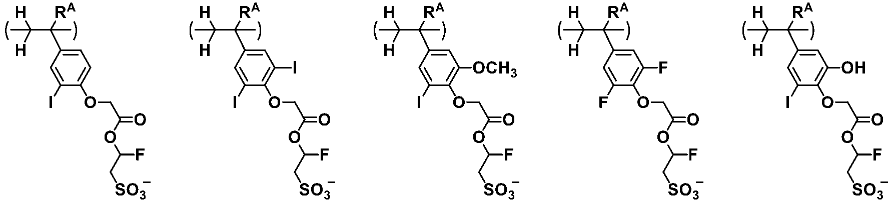

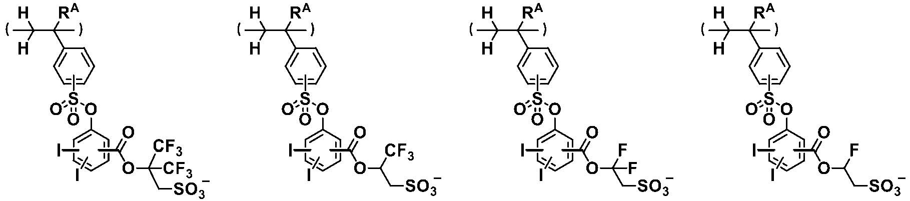

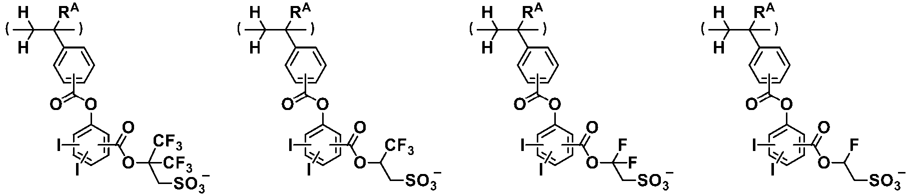

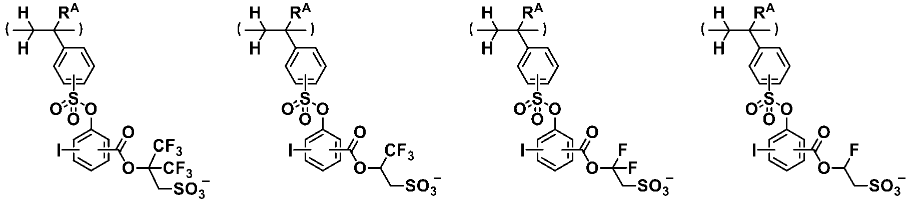

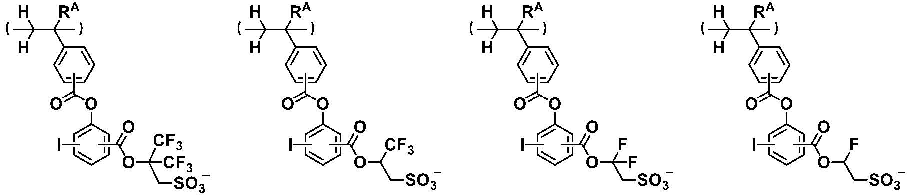

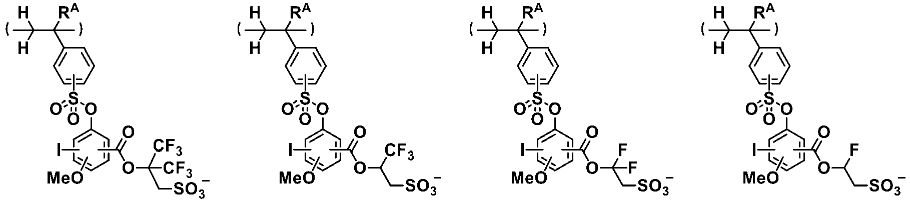

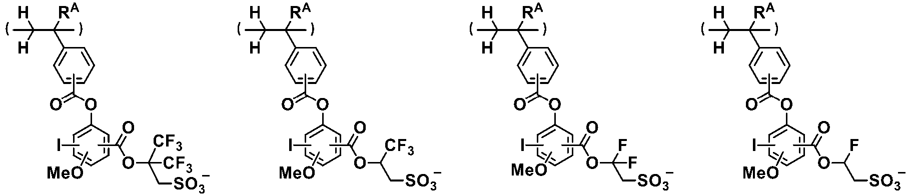

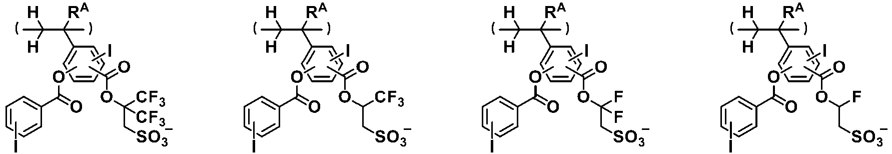

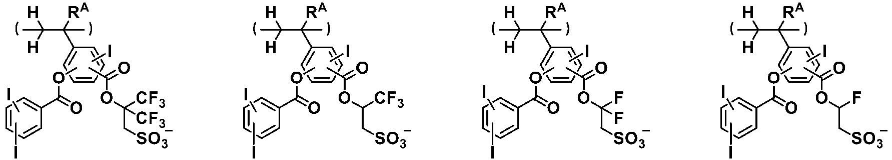

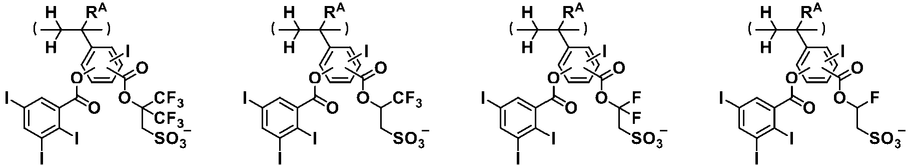

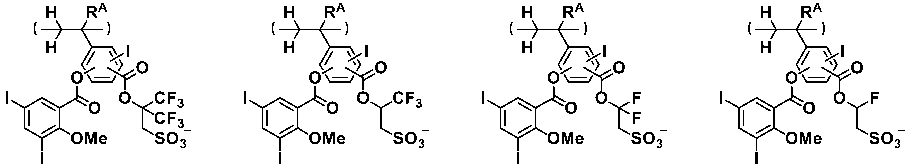

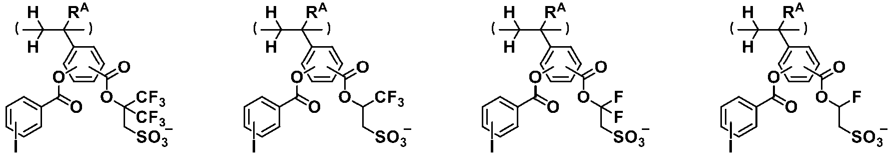

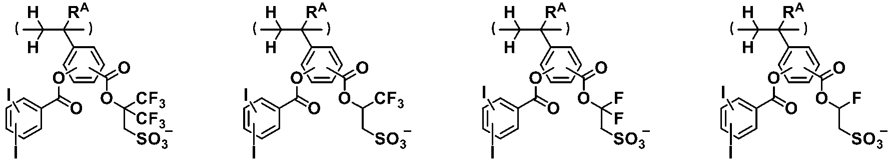

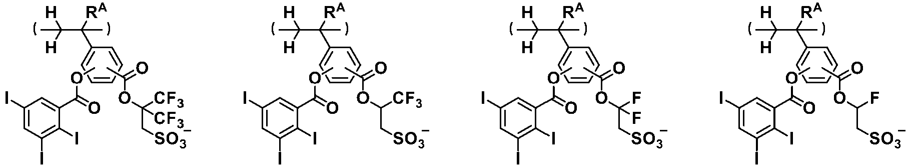

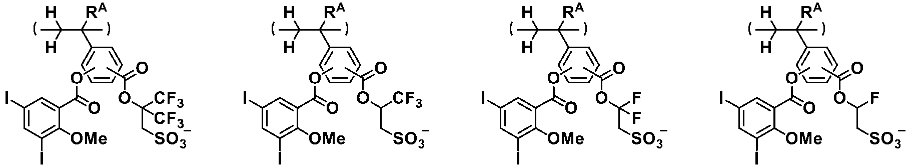

Examples of the anion in repeat unit B9 are shown below, but not limited thereto. Herein R^{A} is as defined above.

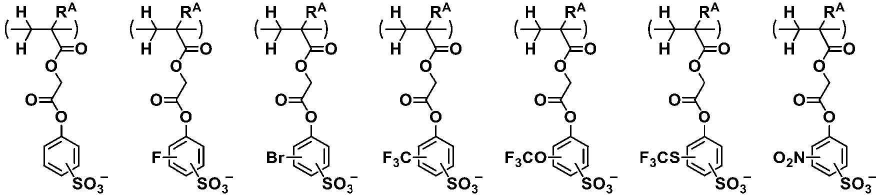

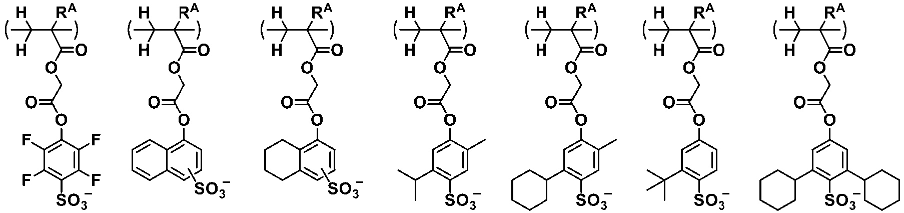

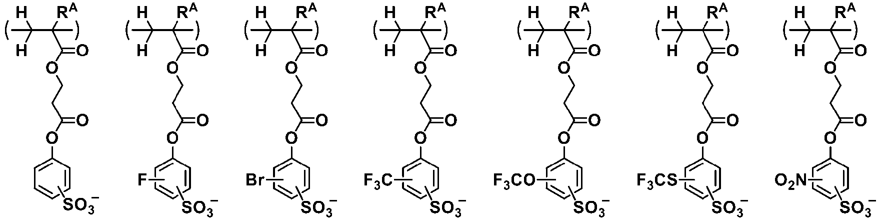

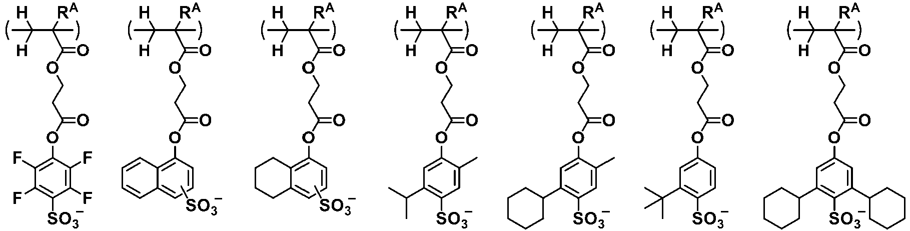

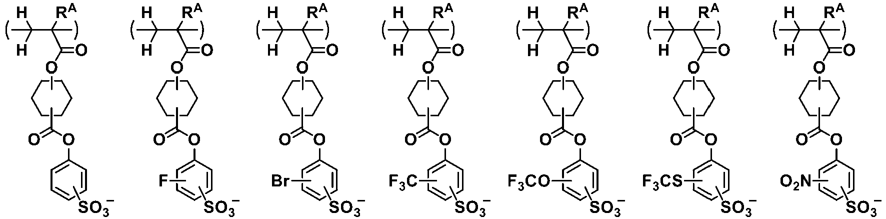

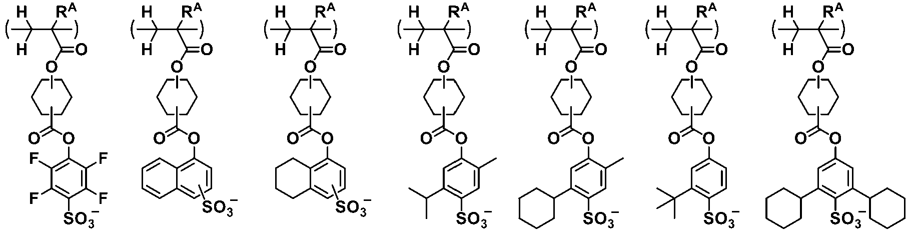

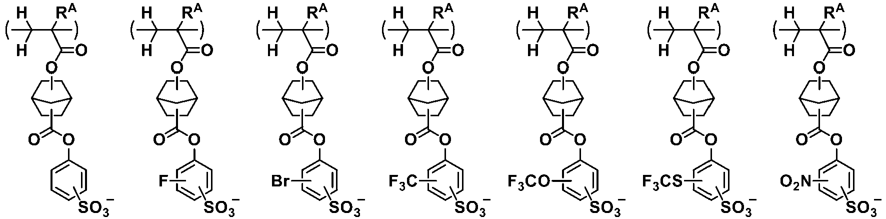

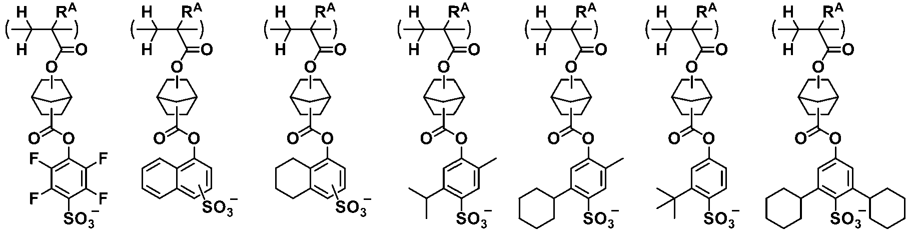

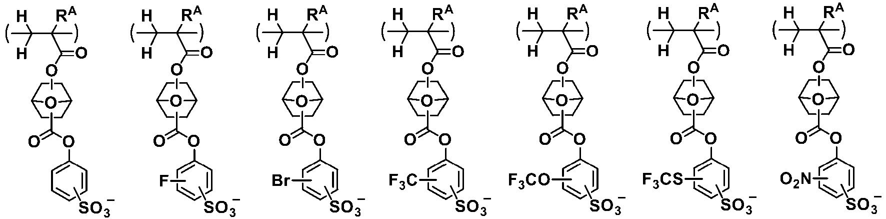

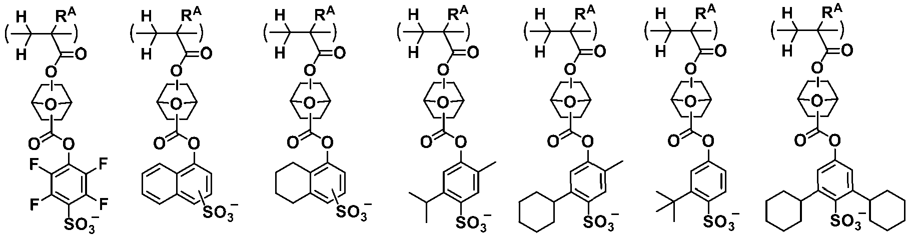

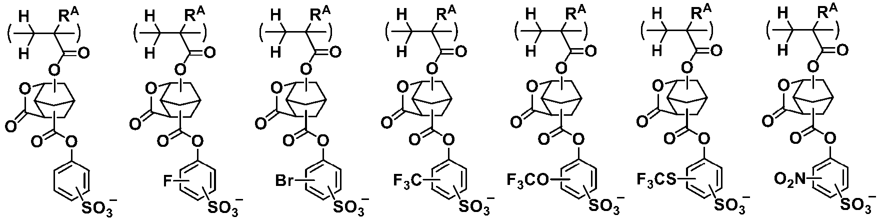

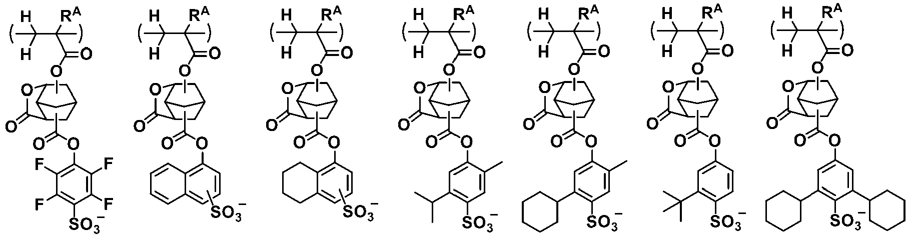

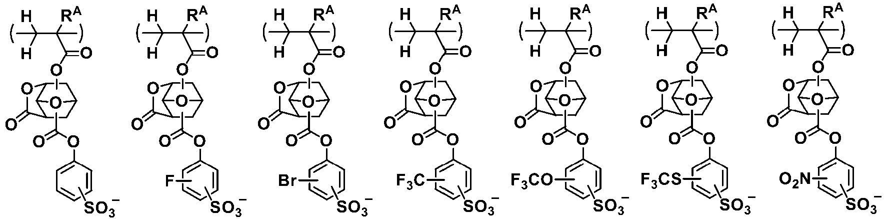

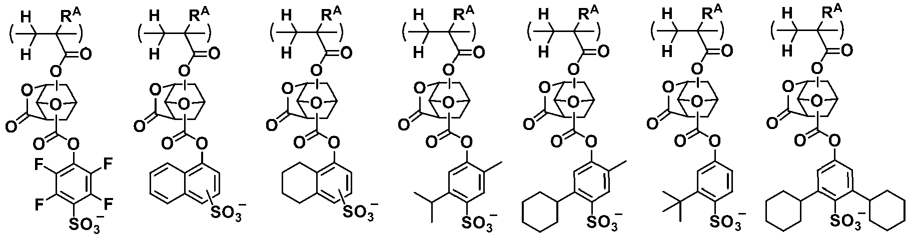

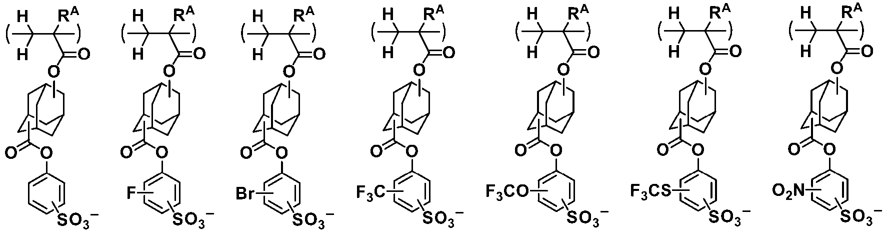

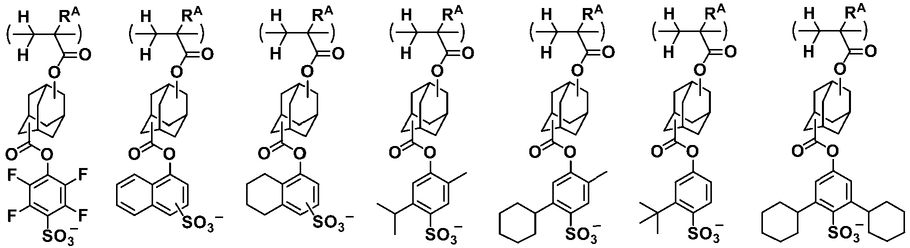

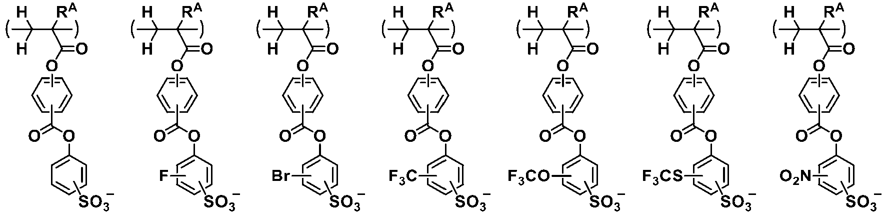

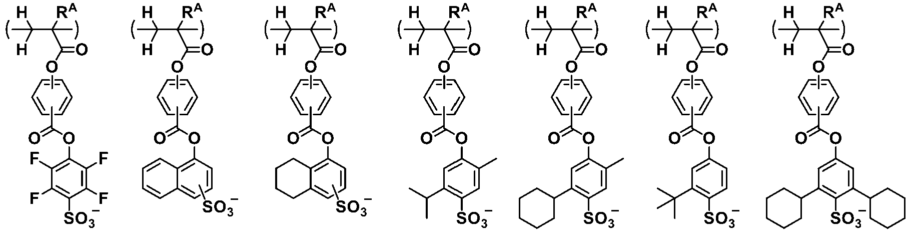

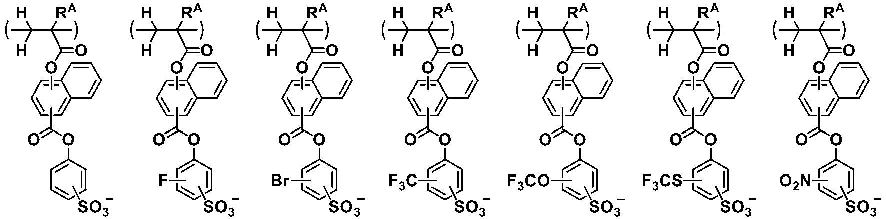

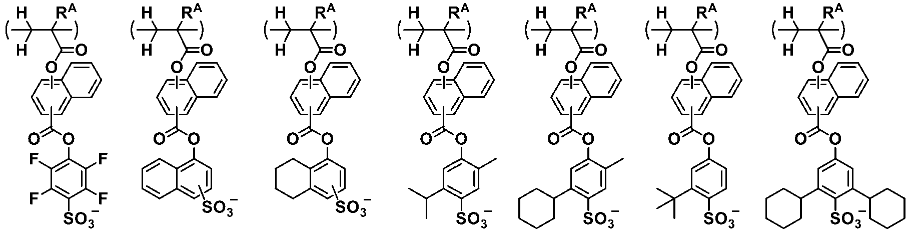

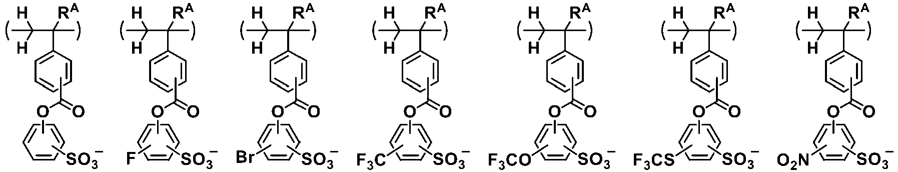

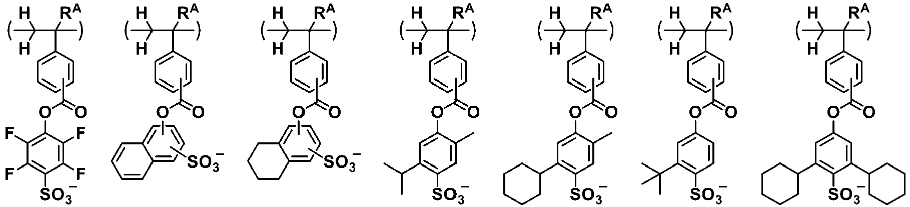

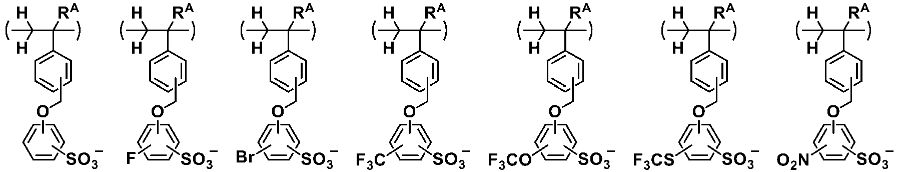

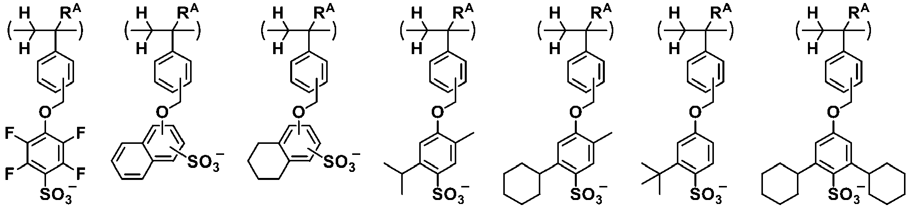

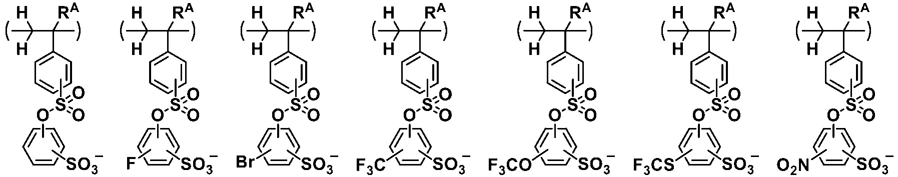

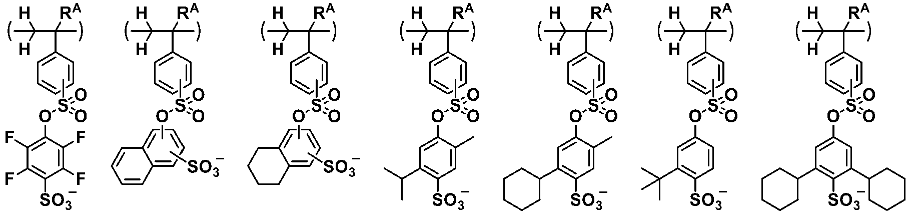

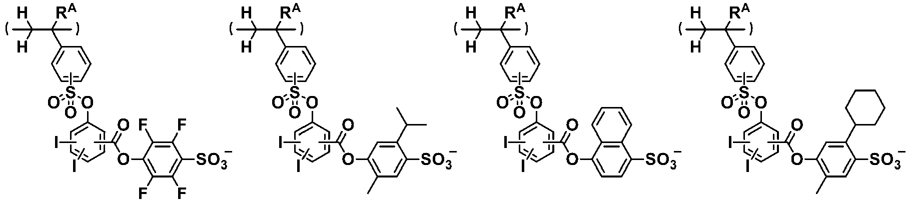

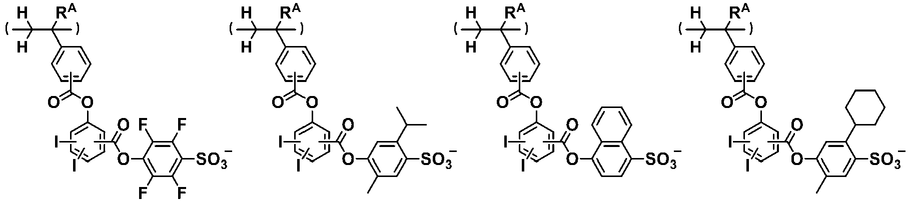

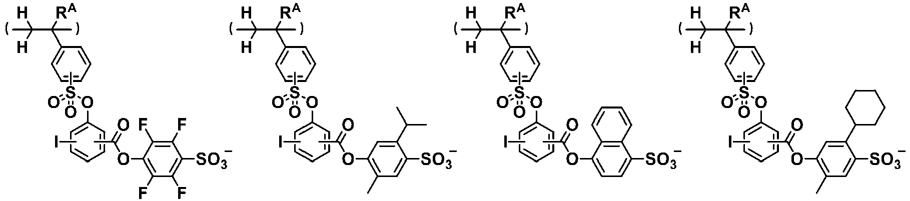

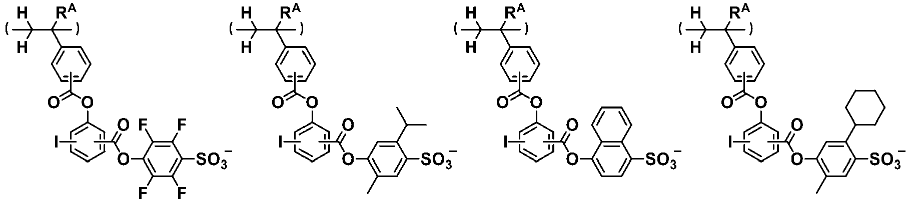

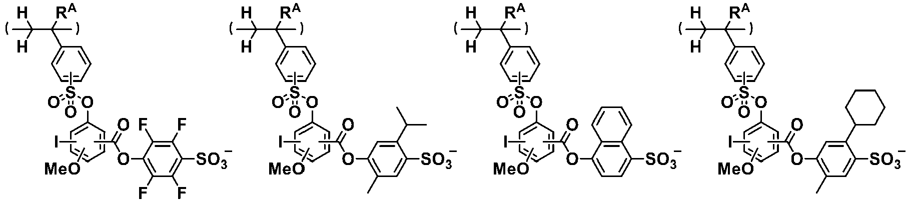

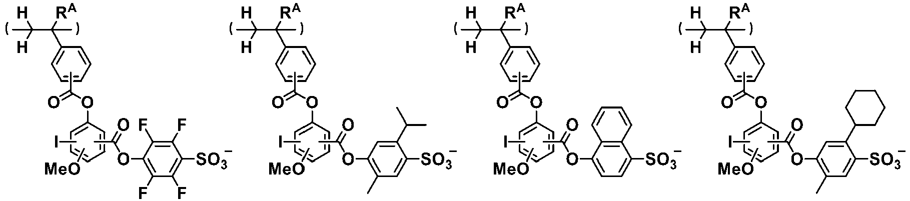

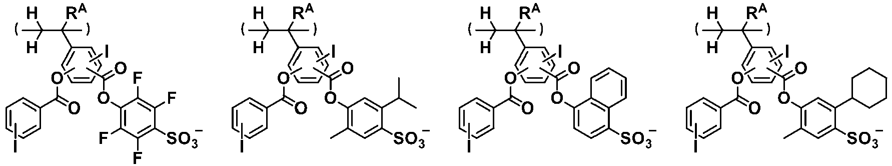

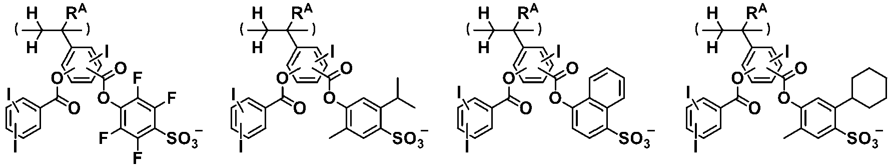

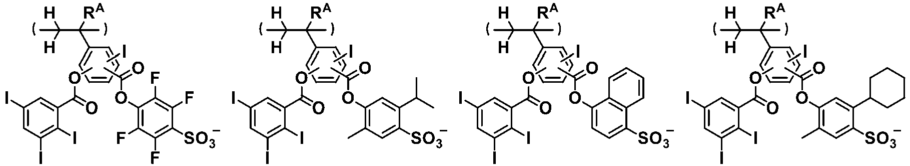

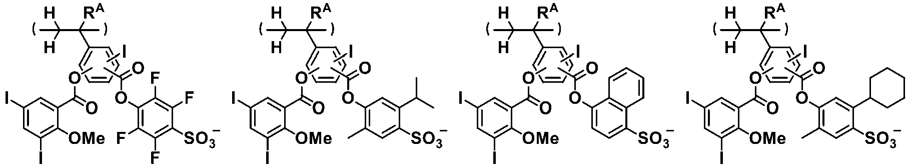

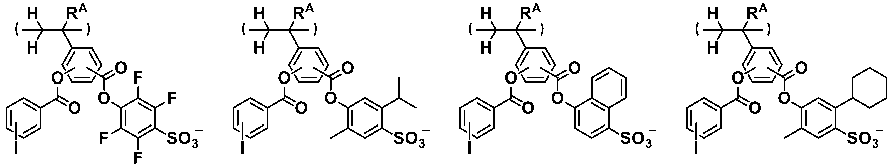

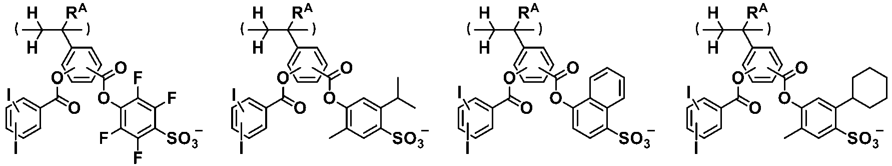

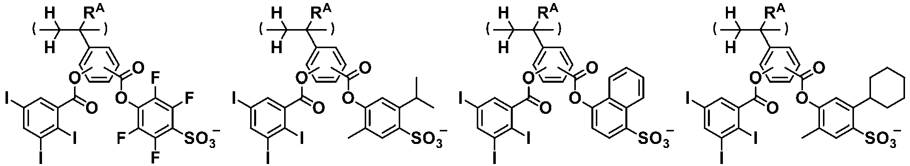

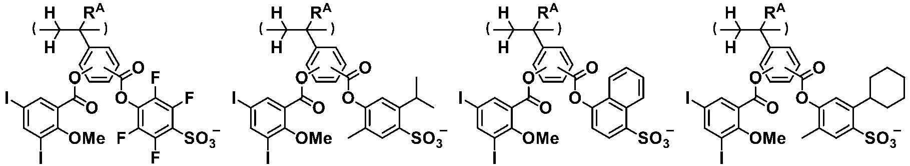

Other examples of the anion in repeat unit B9 include those described in JP-A 2024-103464, paragraphs [0023]-[0026] and JP-A 2024-120702, paragraphs [0419]-[0420].

Examples of the anion in repeat unit B10 are shown below, but not limited thereto. Herein R^{A} is as defined above.

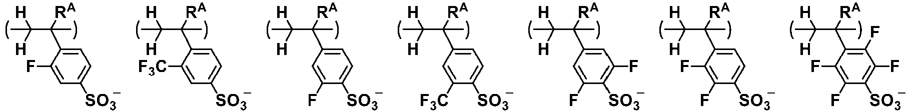

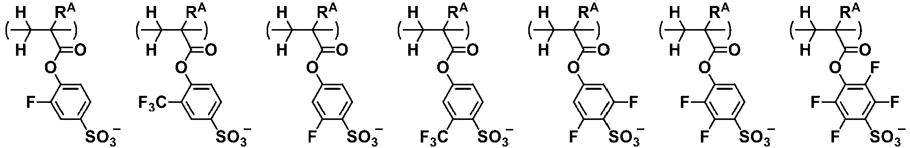

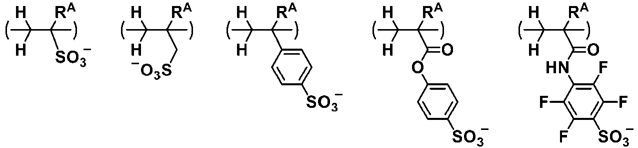

In formulae (B7) to (B10), A⁺ is an onium cation. Suitable onium cations include sulfonium, iodonium and ammonium cations, with the sulfonium and iodonium cations being preferred. Non-limiting examples of the sulfonium cation include those exemplified for the sulfonium cation having formula (A1), those described in JP-A 2024-003744, paragraphs [0102]-[0125], WO 2024/128017, paragraphs [0044]-[0049], JP 7491173, paragraphs [0035]-[0046], JP-A 2025-051616, paragraphs [0074]-[0109], and JP-A 2025-048682, paragraphs [0042]-[0043]. Examples of the iodonium cation include those described in JP-A 2024-000259, paragraph [0181], but are not limited thereto.

A sulfonium cation having the formula (sulfo-1) is also preferred as the sulfonium cation A⁺.

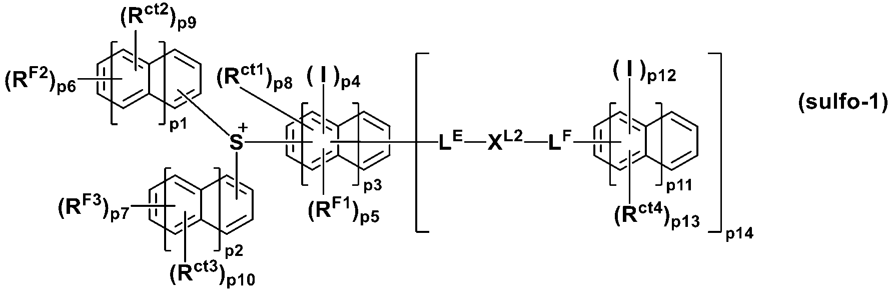

In formula (sulfo-1), p1 is 0 or 1. The relevant structure is a benzene ring when p1=0, and a naphthalene ring when p1=1. The benzene ring corresponding to p1=0 is preferred from the aspect of solvent solubility. The subscript p2 is 0 or 1. The relevant structure is a benzene ring when p2=0, and a naphthalene ring when p2=1. The benzene ring corresponding to p2=0 is preferred from the aspect of solvent solubility. The subscript p3 is 0 or 1. The relevant structure is a benzene ring when p3=0, and a naphthalene ring when p3=1. The benzene ring corresponding to p3=0 is preferred from the aspect of solvent solubility.

In formula (sulfo-1), p4 is 0, 1, 2, 3 or 4. As the number of iodine atoms in the cation structure increases, the compound becomes more absorptive to EUV, but so poor in solvent solubility that it may precipitate in a resist composition. For this reason, p4 is preferably 0, 1, 2 or 3, more preferably 0, 1 or 2.

In formula (sulfo-1), p5 is 0, 1, 2, 3 or 4. From the aspect of reactant availability, p5 is preferably 0, 1, 2 or 3, more preferably 0, 1 or 2. The subscript p6 is 0, 1, 2, 3, 4, 5 or 6. From the aspect of reactant availability, p6 is preferably 0, 1, 2 or 3, more preferably 0, 1 or 2. The subscript p7 is 0, 1, 2, 3, 4, 5 or 6. From the aspect of reactant availability, p7 is preferably 0, 1, 2 or 3, more preferably 0, 1 or 2.

In formula (sulfo-1), p8 is 0, 1 or 2. From the aspect of reactant availability, p8 is preferably 0 or 1. The subscript p9 is 0, 1 or 2. From the aspect of reactant availability, p9 is preferably 0 or 1. The subscript p10 is 0, 1 or 2. From the aspect of reactant availability, p10 is preferably 0 or 1.

In formula (sulfo-1), p11 is 0 or 1. The relevant structure is a benzene ring when p11=0, and a naphthalene ring when p11=1. The benzene ring corresponding to p11=0 is preferred from the aspect of solvent solubility.

In formula (sulfo-1), p12 is 0, 1, 2, 3 or 4. As the number of iodine atoms in the cation structure increases, the compound becomes more absorptive to EUV, but so poor in solvent solubility that it may precipitate in a resist composition. For this reason, p12 is preferably 0, 1, 2 or 3, more preferably 0, 1 or 2.

In formula (sulfo-1), p13 is 0, 1 or 2. From the aspect of reactant availability, p13 is preferably 0 or 1. The subscript p14 is 0, 1 or 2. From the aspect of synthesis, p14 is preferably 0 or 1.

The subscripts p1 to p14 are in the range: 0 ≤ p6+p9 ≤ 4 when p1=0, 0 ≤ p6+p9 ≤ 6 when p1=1; 0 ≤ p7+p10 ≤ 4 when p2=0, 0 ≤ p7+p10 ≤ 6 when p2=1; 1 ≤ p4+p5+p8+p14 ≤ 4 when p3=0, 1 ≤ p4+p5+p8+p14 ≤ 6 when p3=1; 0 ≤ p12+p13 ≤ 4 when p11=0, 0 ≤ p12+p13 ≤ 6 when p11=1; and p4+p12 ≥ 1.

In formula (sulfo-1), R^{F1} to R^{F3} are each independently fluorine, a C₁-C₆ fluorinated saturated hydrocarbyl group, C₁-C₆ fluorinated saturated hydrocarbyloxy group, or C₁-C₆ fluorinated saturated hydrocarbylthio group. Of these, trifluoromethyl, trifluoromethoxy, and trifluorothiomethoxy are preferred. A plurality of R^{F1} may be identical or different when p5 is 2, 3 or 4. A plurality of R^{F2} may be identical or different when p6 is 2, 3, 4, 5 or 6. A plurality of R^{F3} may be identical or different when p7 is 2, 3, 4, 5 or 6.

In formula (sulfo-1), R^{ct1} to R^{ct4} are each independently halogen exclusive of iodine and fluorine, nitro, cyano, a C₁-C₂₀ hydrocarbyl group which may contain a heteroatom, C₁-C₂₀ hydrocarbyloxy group which may contain a heteroatom, or C₁-C₂₀ hydrocarbylthio group which may contain a heteroatom. The hydrocarbyl group and hydrocarbyl moiety in the hydrocarbyloxy and hydrocarbylthio groups may be saturated or unsaturated and straight, branched or cyclic. Examples thereof are as exemplified above for the hydrocarbyl groups R¹ to R³ in formula (A1). In the hydrocarbyl group and hydrocarbyl moiety in the hydrocarbyloxy and hydrocarbylthio groups, some or all of the hydrogen atoms may be substituted by a moiety containing a heteroatom such as oxygen, sulfur, nitrogen or halogen, and some -CH₂- may be replaced by a moiety containing a heteroatom such as oxygen, sulfur or nitrogen, so that the group may contain a hydroxy moiety, cyano moiety, fluorine, chlorine, bromine, iodine, carbonyl moiety, ether bond, ester bond, sulfonate ester bond, carbonate bond, lactone ring, sultone ring, carboxylic anhydride (-C(=O)-O-C(=O)-) or haloalkyl moiety.

When p8=2, two R^{ct1} may be identical or different and two R^{ct1} may bond together to form a ring with the carbon atoms to which they are attached. When p9=2, two R^{ct2} may be identical or different and two R^{ct2} may bond together to form a ring with the carbon atoms to which they are attached. When p10=2, two R^{ct3} may be identical or different and two R^{ct3} may bond together to form a ring with the carbon atoms to which they are attached. When p13=2, two R^{ct4} may be identical or different and two R^{ct4} may bond together to form a ring with the carbon atoms to which they are attached. Examples of the ring thus formed include cyclopropane, cyclobutane, cyclopentane, cyclohexane, norbornane, and adamantane rings. In the ring, some or all of the hydrogen atoms may be substituted by a moiety containing a heteroatom such as oxygen, sulfur, nitrogen or halogen, and some constituent -CH₂- may be replaced by a moiety containing a heteroatom such as oxygen, sulfur or nitrogen, so that the ring may contain a hydroxy moiety, fluorine, chlorine, bromine, iodine, cyano moiety, carbonyl moiety, ether bond, ester bond, sulfonate ester bond, carbonate bond, lactone ring, sultone ring, carboxylic anhydride (-C(=O)-O-C(=O)-) or haloalkyl moiety.

The aromatic rings directly bonded to S⁺ in the sulfonium cation having formula (sulfo-1) may bond together to form a ring with S⁺. Exemplary structures of the ring are shown below.

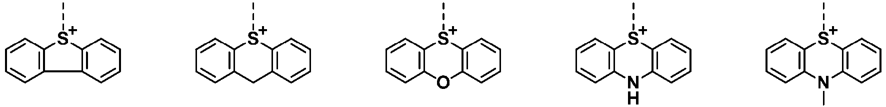

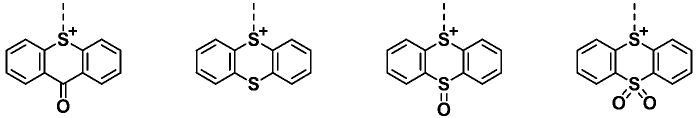

In formula (sulfo-1), L^{E} and L^{F} are each independently a single bond, ether bond, ester bond, sulfonate ester bond, amide bond, sulfonamide bond, carbonate bond or carbamate bond. L^{E} is preferably a single bond, ether bond, ester bond or sulfonate ester bond, more preferably an ester bond or sulfonate ester bond. L^{F} is preferably a single bond, ether bond or ester bond, more preferably a single bond.

In formula (sulfo-1), X^{L2} is a single bond or a C₁-C₄₀ hydrocarbylene group which may contain a heteroatom. The C₁-C₄₀ hydrocarbylene group may be straight, branched or cyclic. Suitable hydrocarbylene groups include alkanediyl, cyclic saturated hydrocarbylene and arylene groups. Suitable heteroatoms include oxygen, nitrogen and sulfur atoms. Examples of the optionally heteroatom-containing C₁-C₄₀ hydrocarbylene group X^{L2} include those exemplified above for the optionally heteroatom-containing C₁-C₄₀ hydrocarbylene group X^{L1} in formula (A2), specifically X^{L}-0 to X^{L}-58. X^{L2} is preferably selected from X^{L}-0 to X^{L}-22 and X^{L}-47 to X^{L}-58.

Of the sulfonium cations having formula (sulfo-1), those cations having the formula (sulfo-1-1): 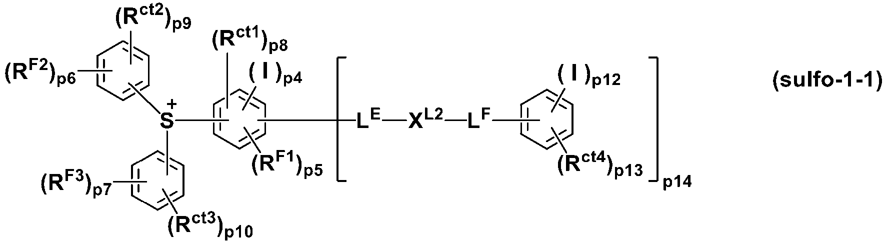 wherein p4 to p10, p12 to p14, R^{F1} to R^{F3}, R^{ct1} to R^{ct4}, L^{E}, L^{F}, and X^{L2} are as defined above are preferred.

Of the sulfonium cations having formula (sulfo-1-1), those cations having the formula (sulfo-1-2): 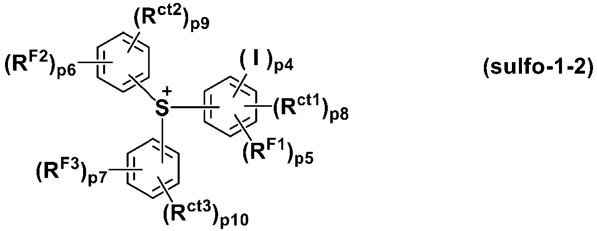 wherein p4 to p10, R^{F1} to R^{F3}, and R^{ct1} to R^{ct3} are as defined above are more preferred.

Examples of the sulfonium cation having formula (sulfo-1) are shown below, but not limited thereto.

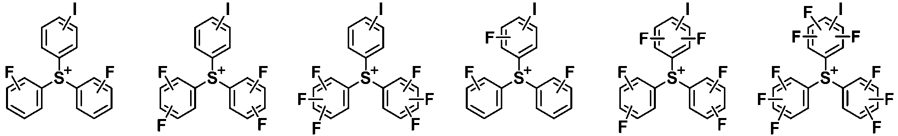

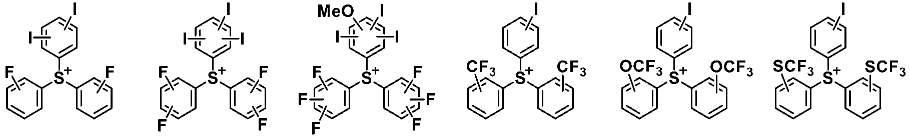

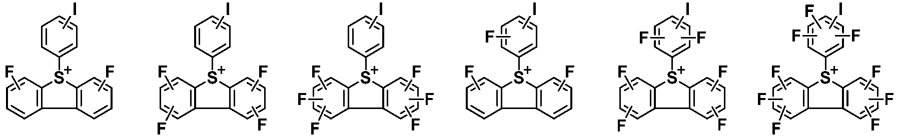

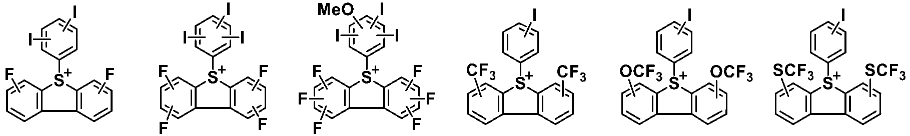

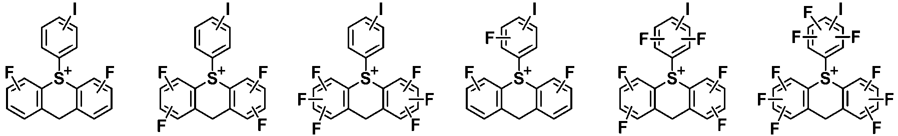

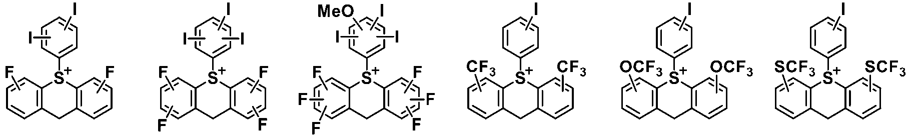

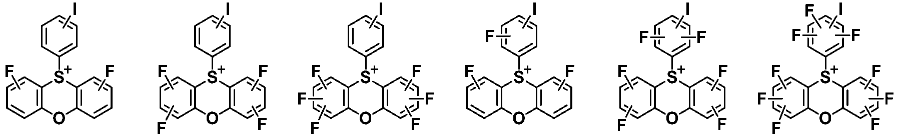

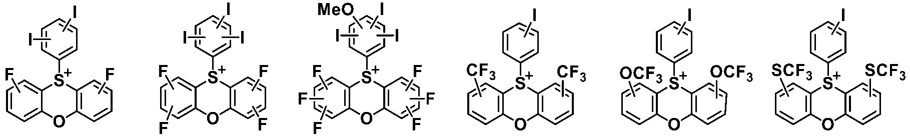

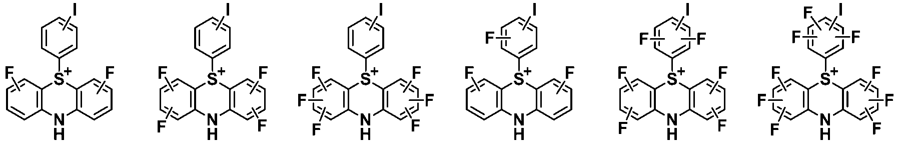

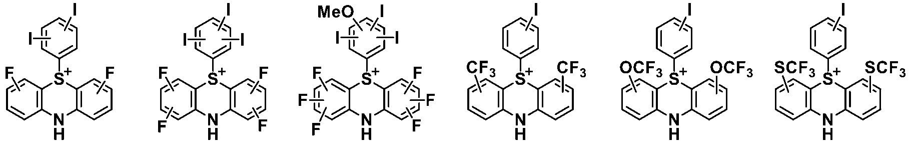

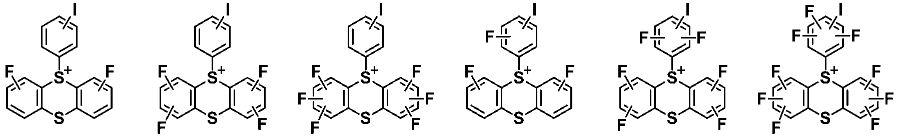

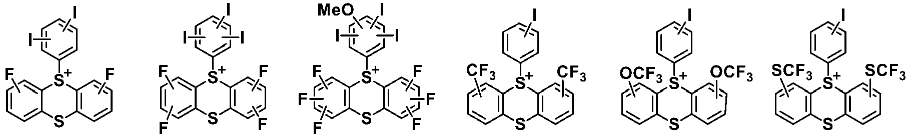

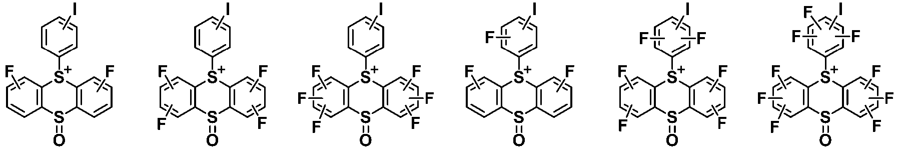

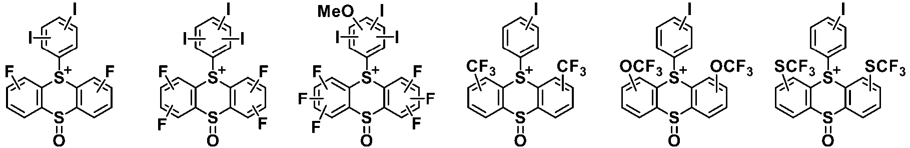

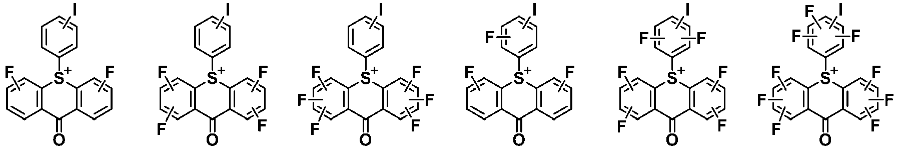

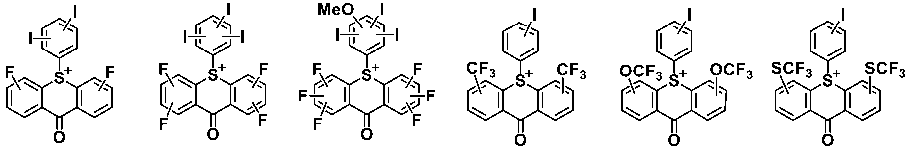

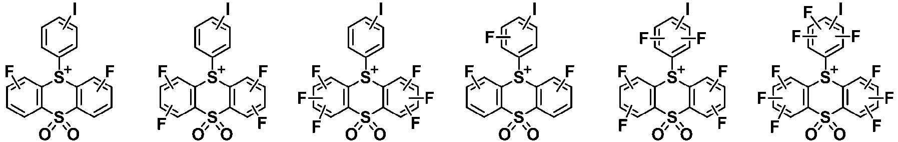

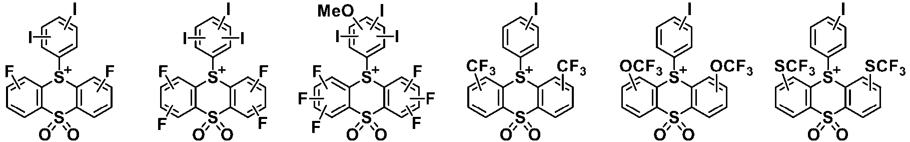

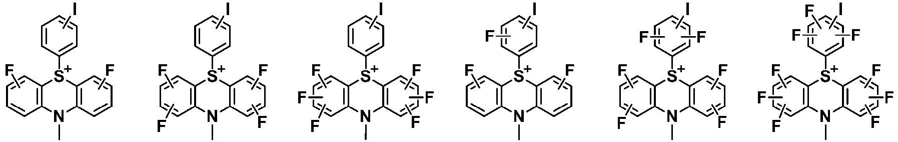

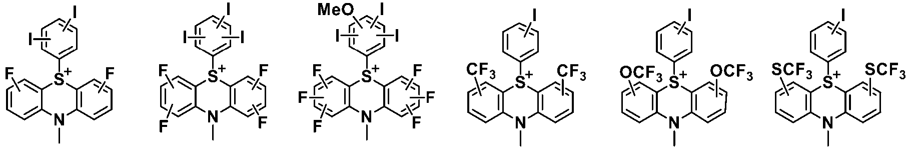

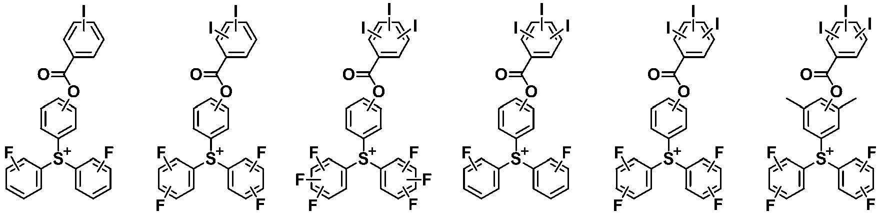

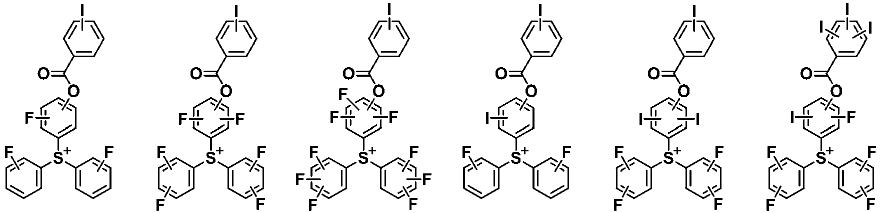

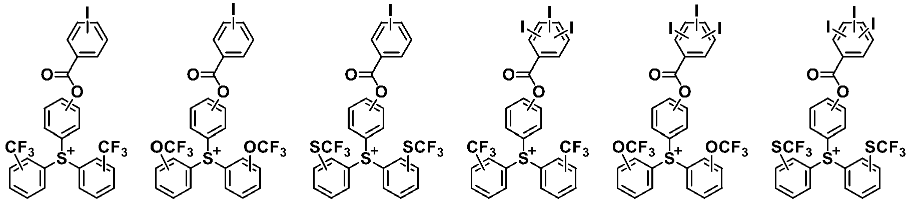

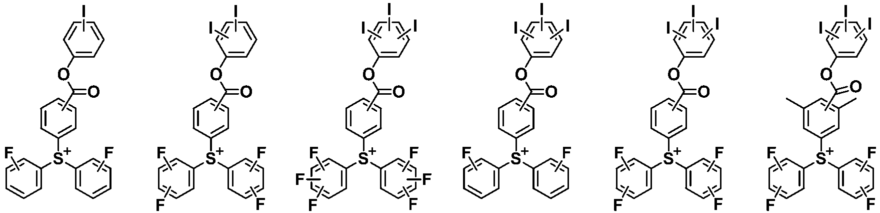

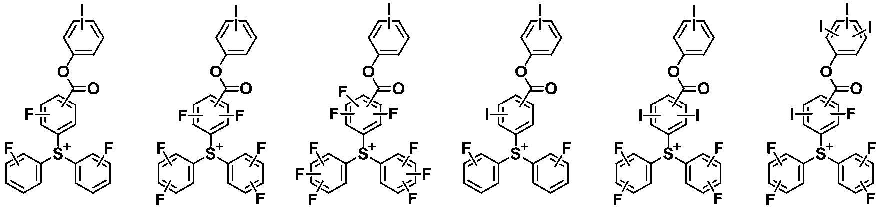

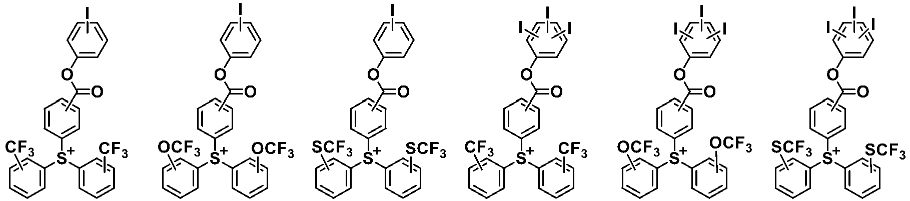

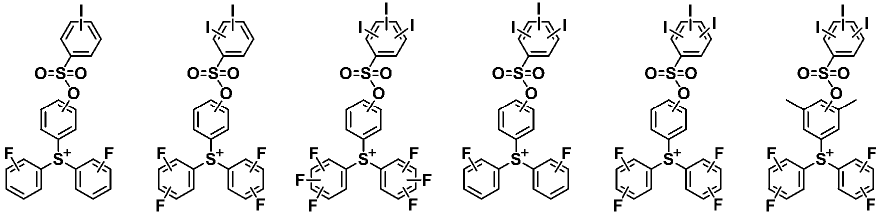

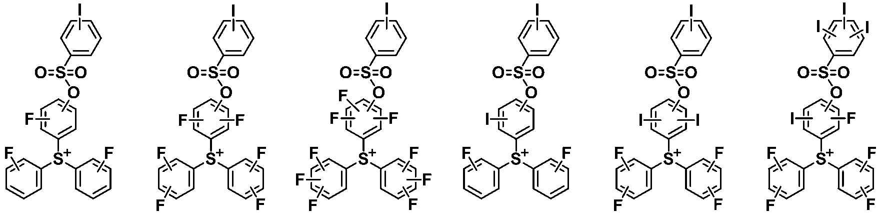

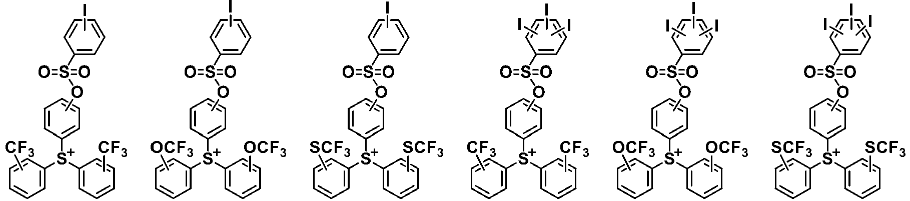

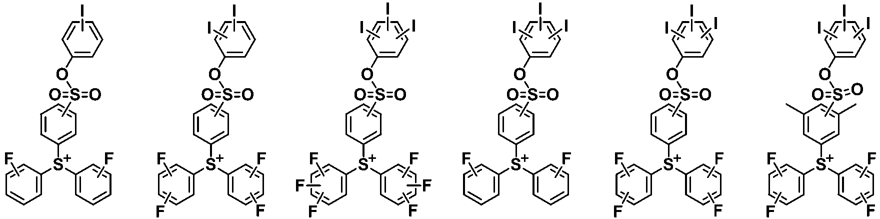

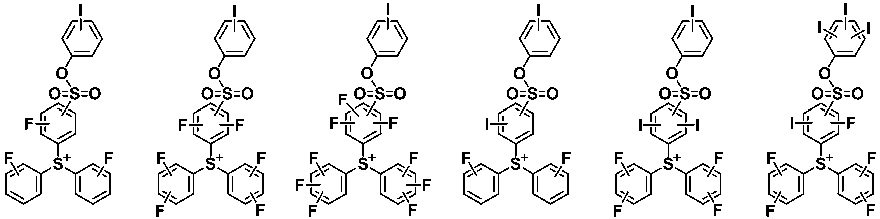

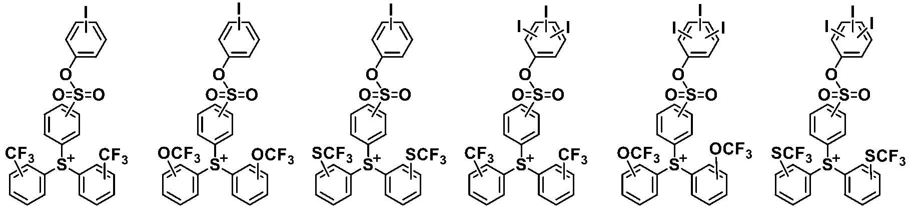

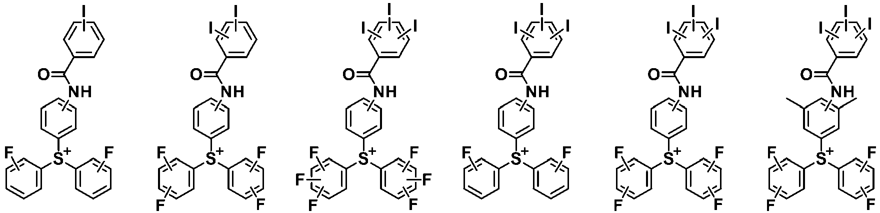

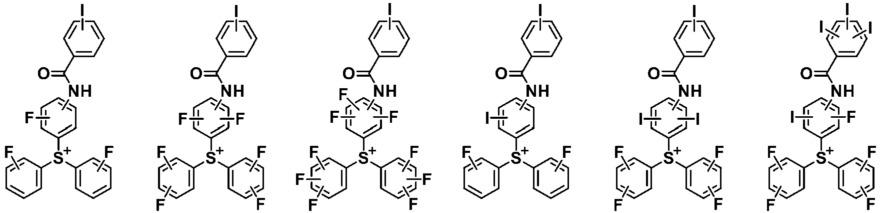

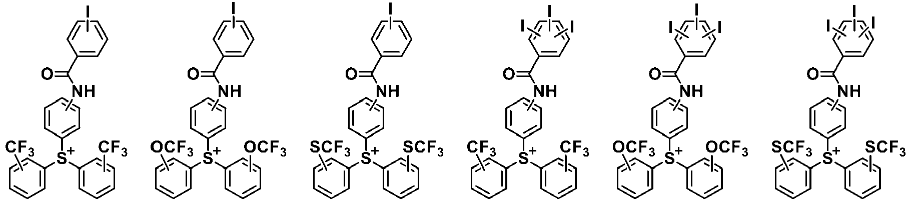

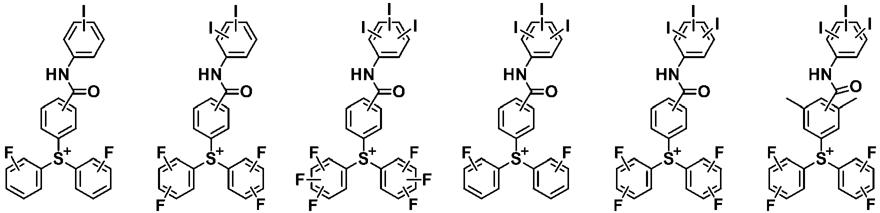

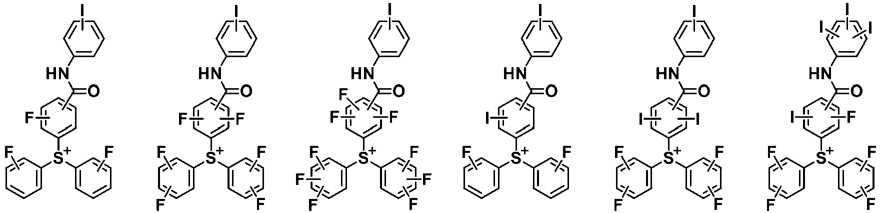

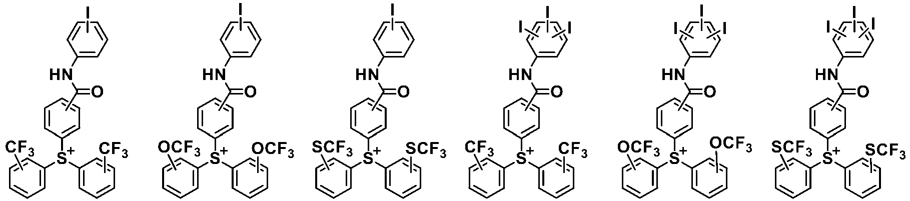

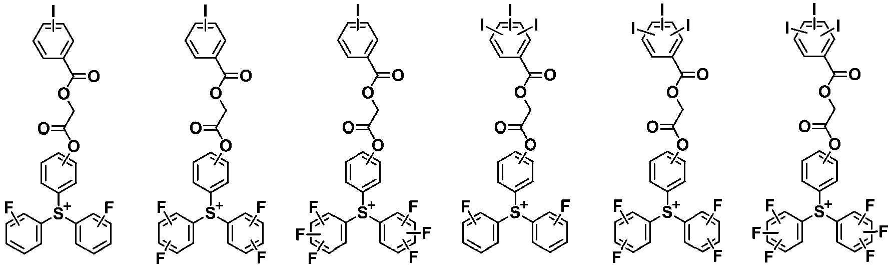

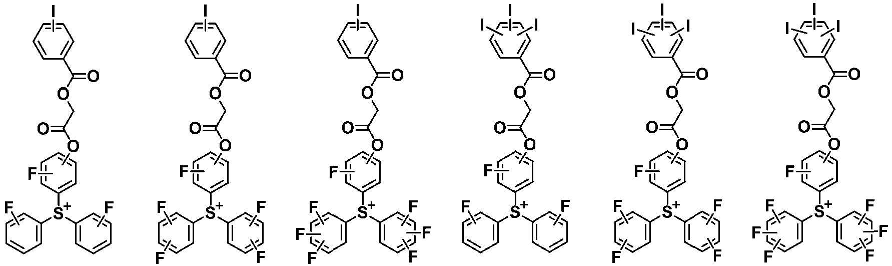

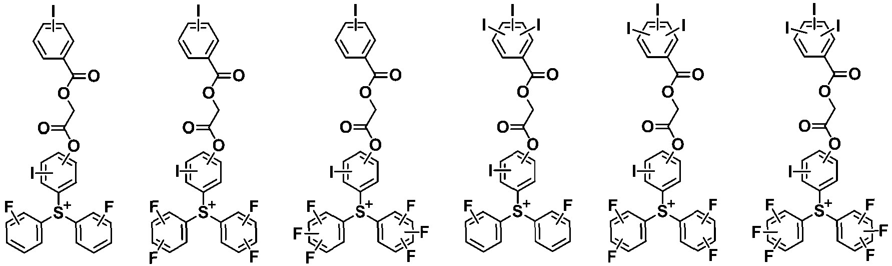

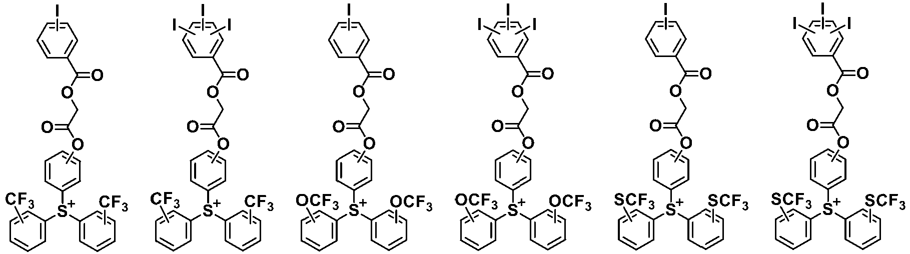

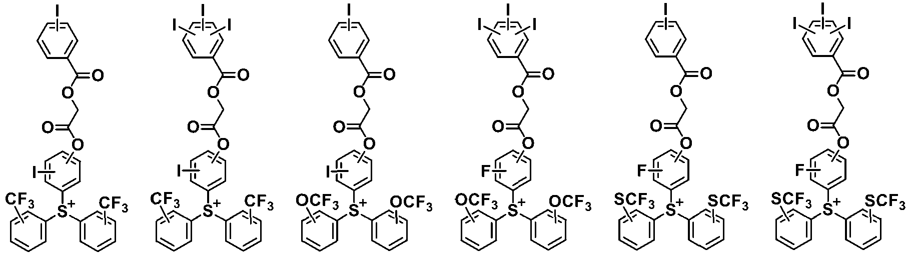

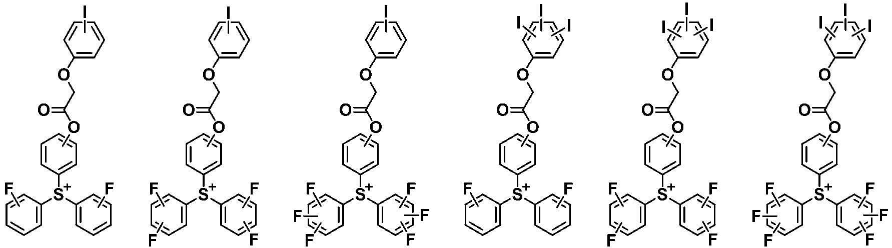

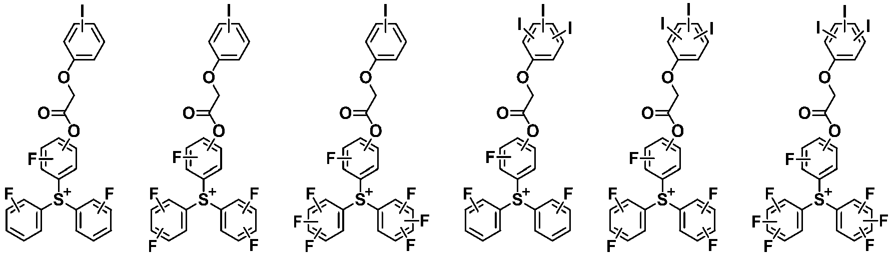

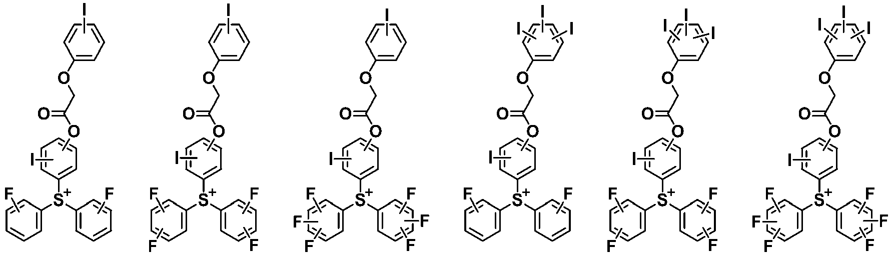

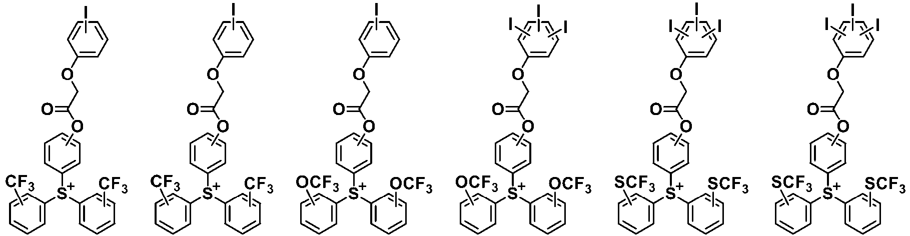

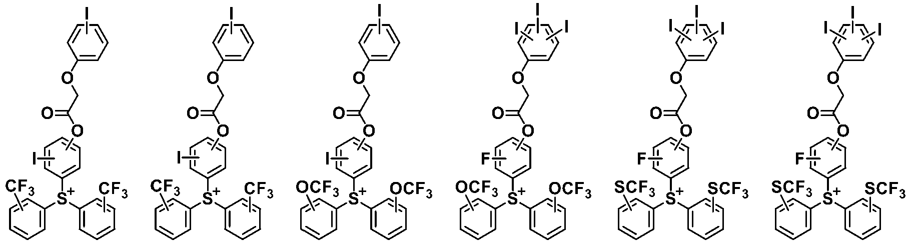

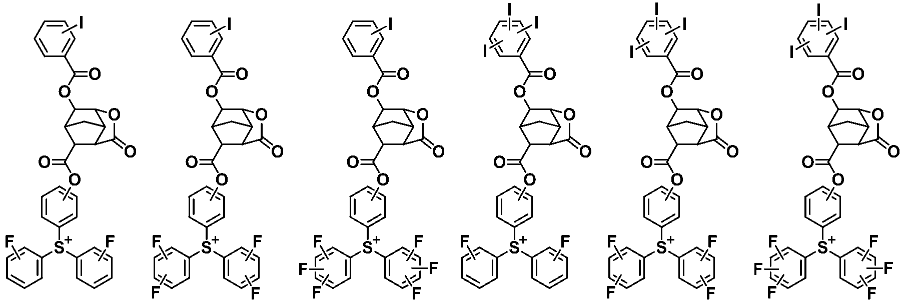

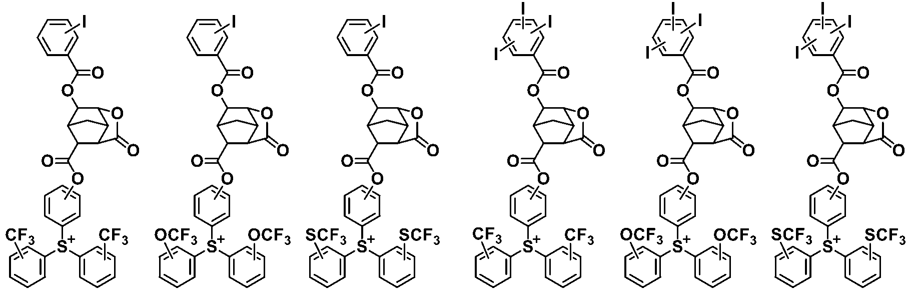

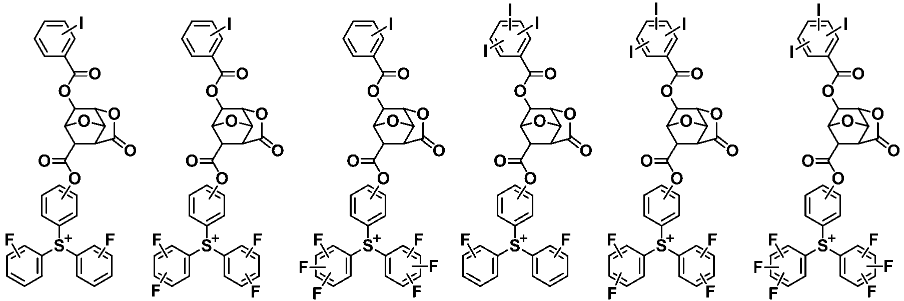

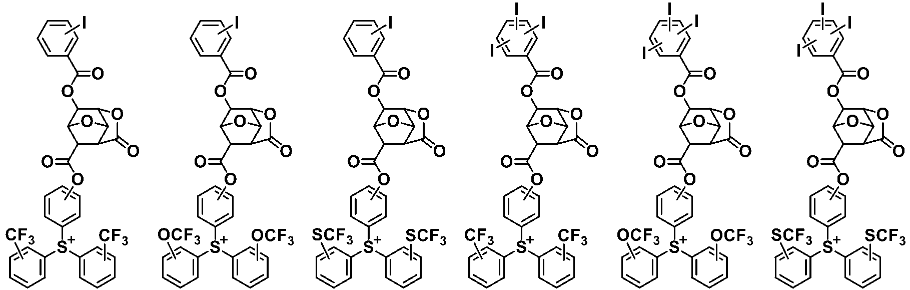

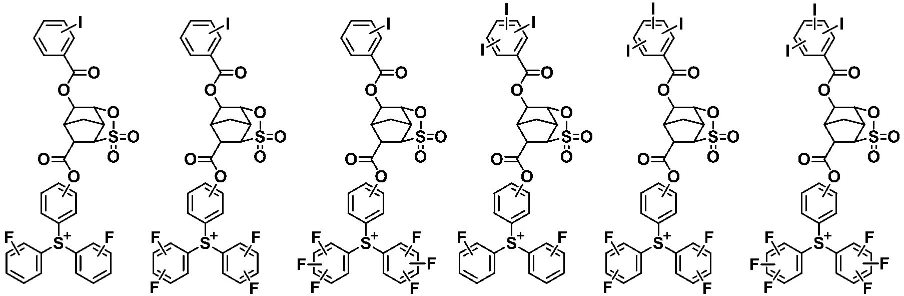

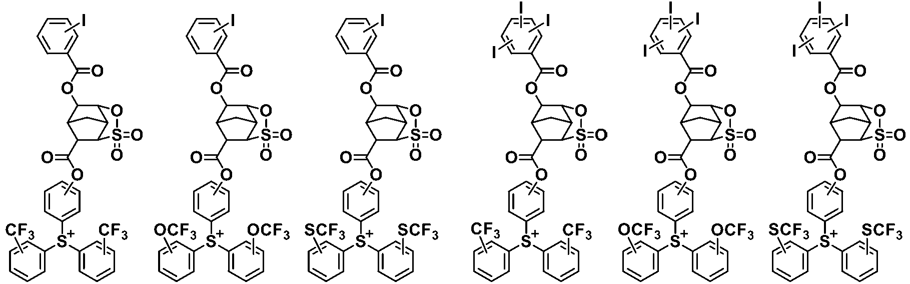

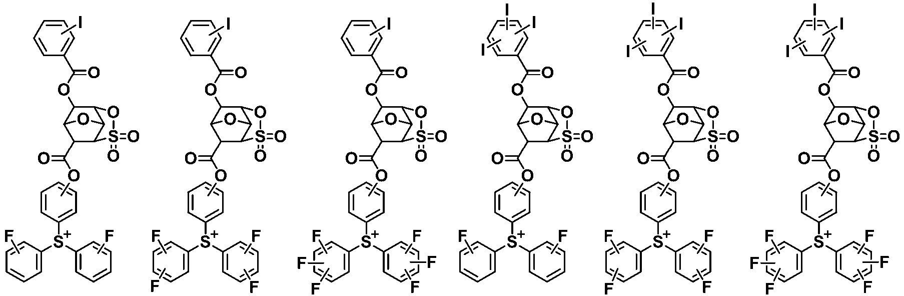

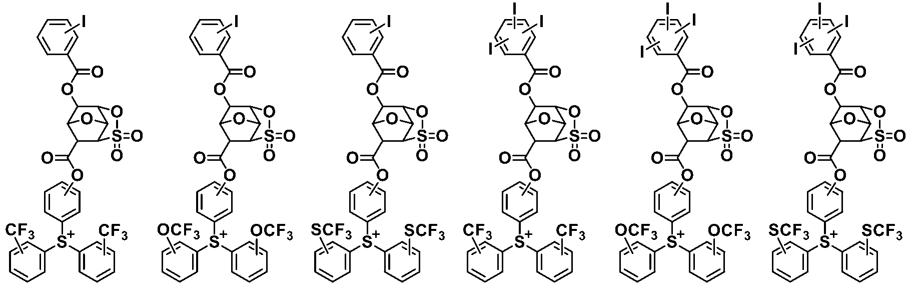

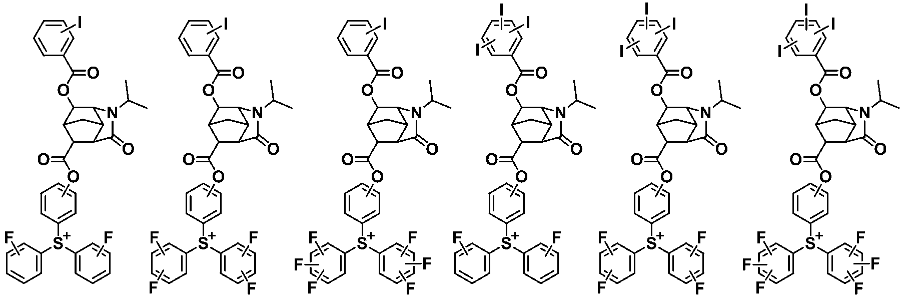

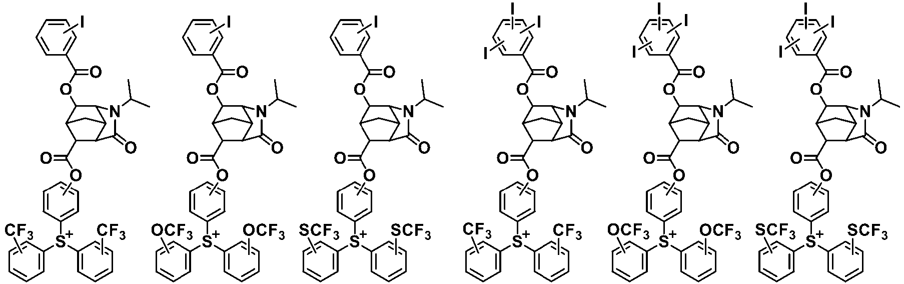

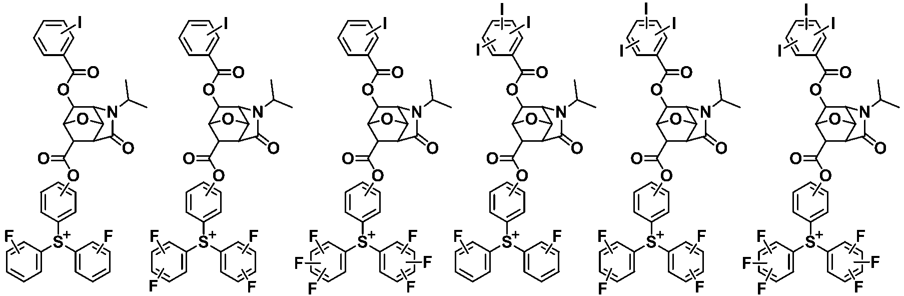

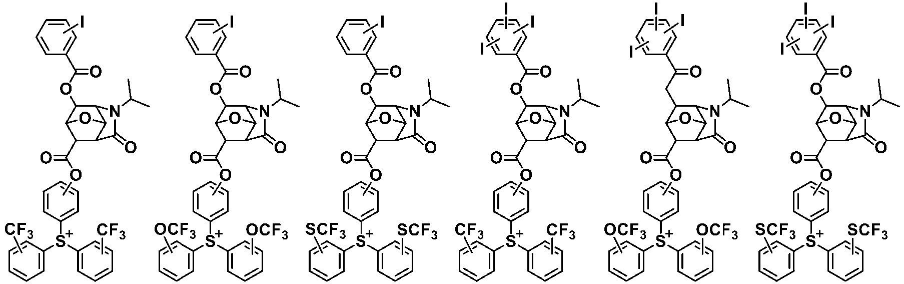

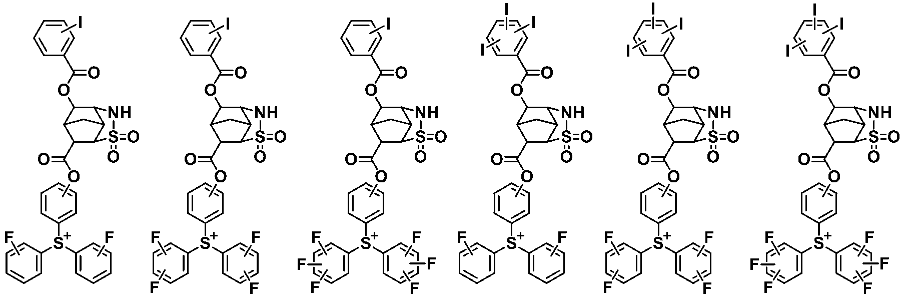

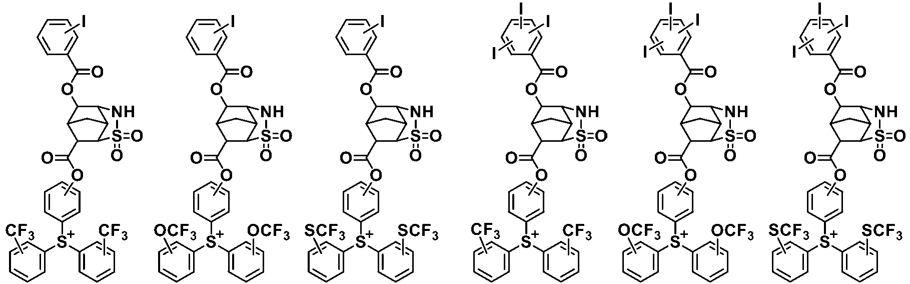

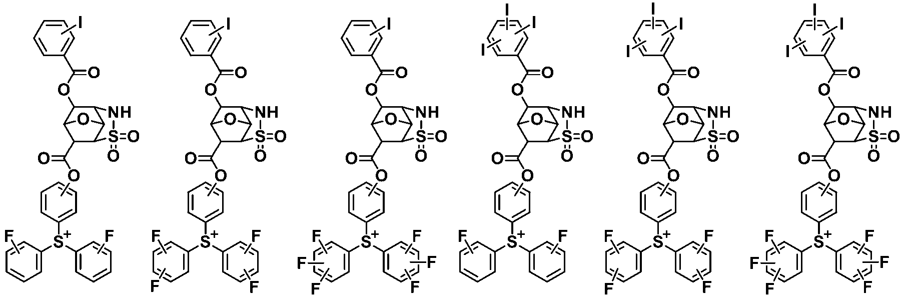

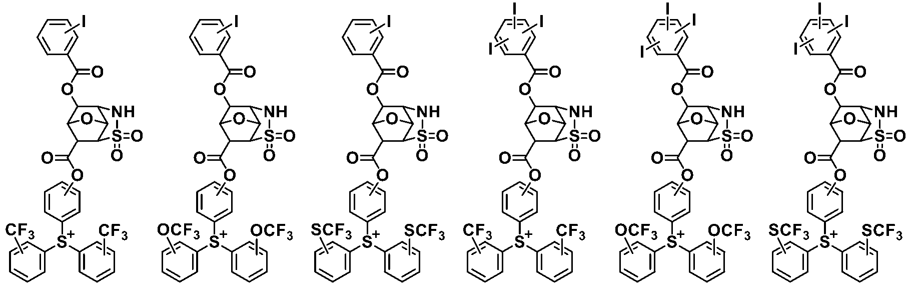

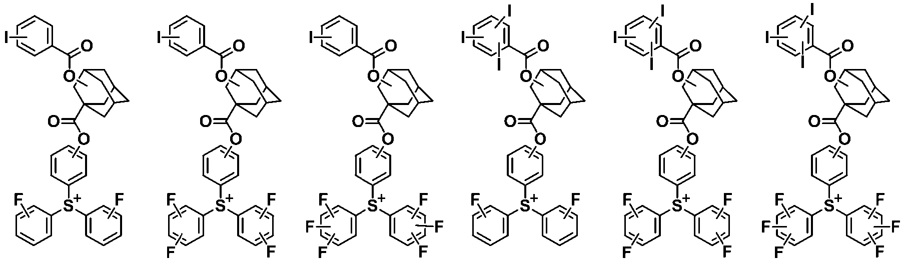

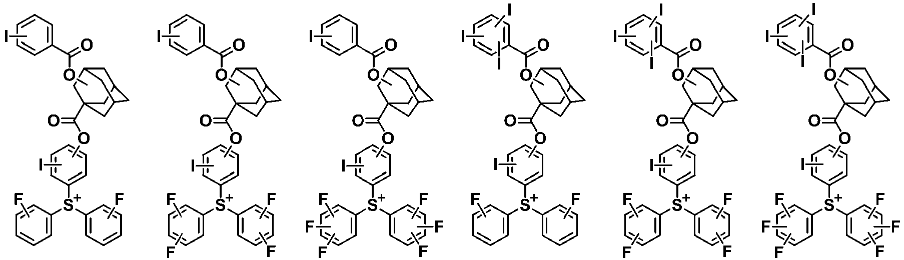

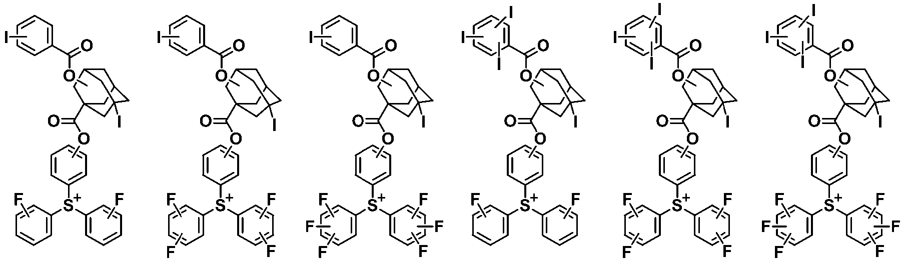

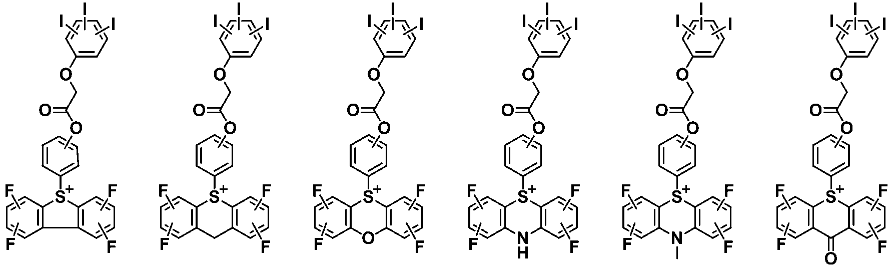

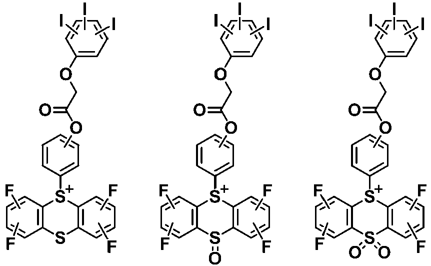

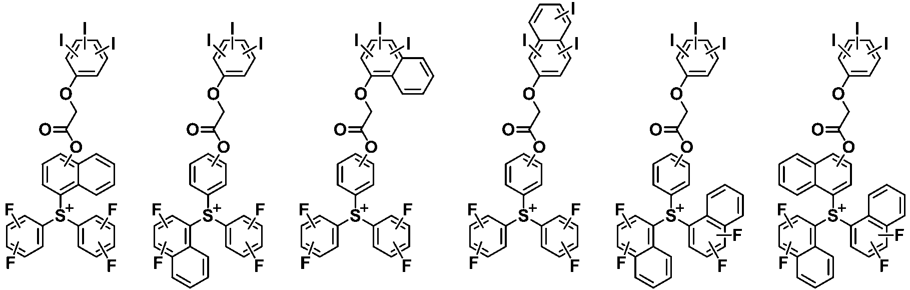

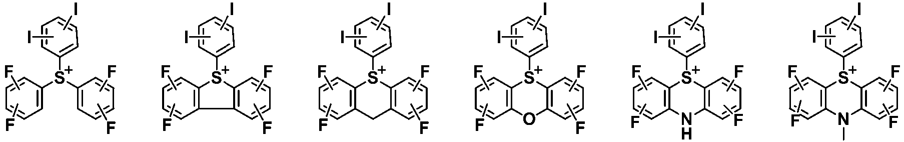

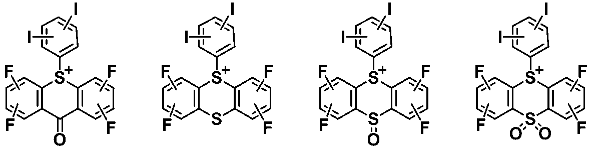

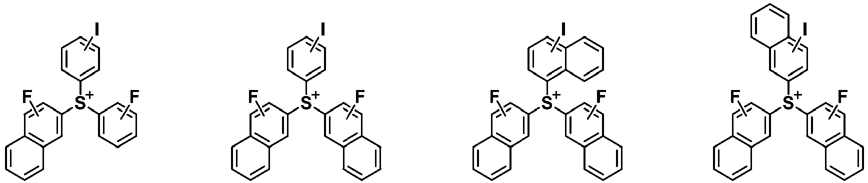

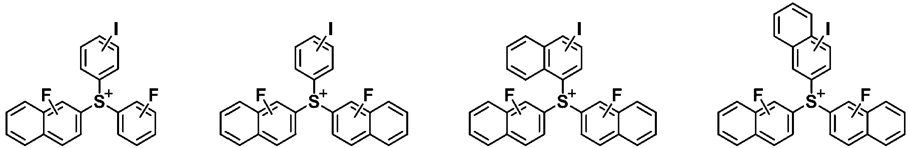

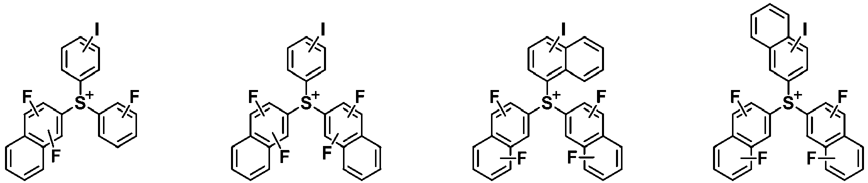

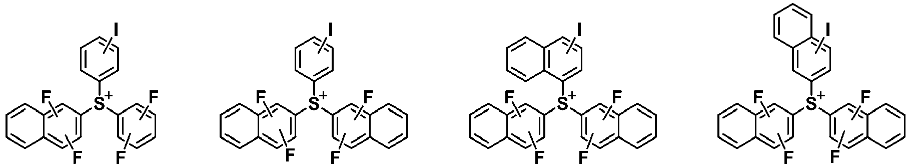

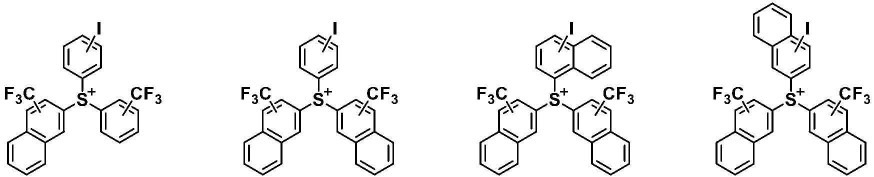

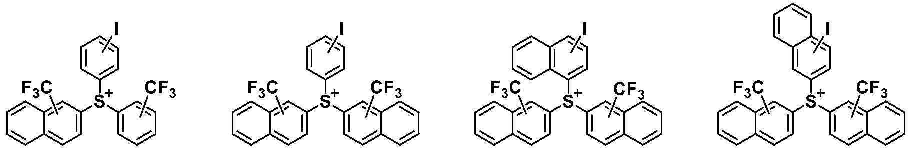

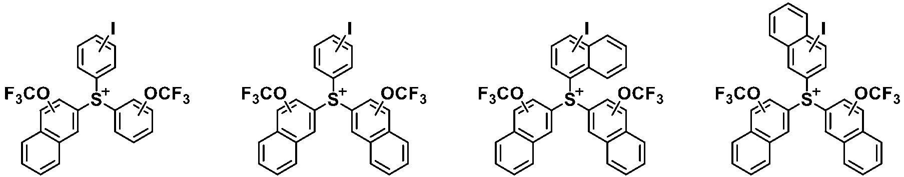

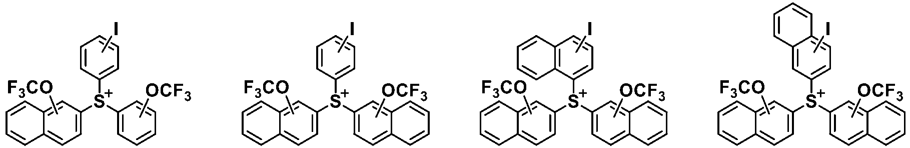

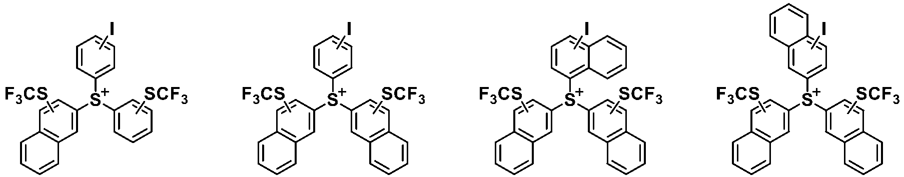

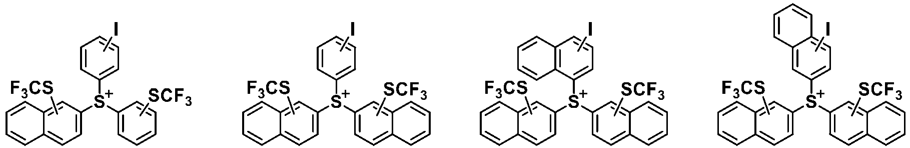

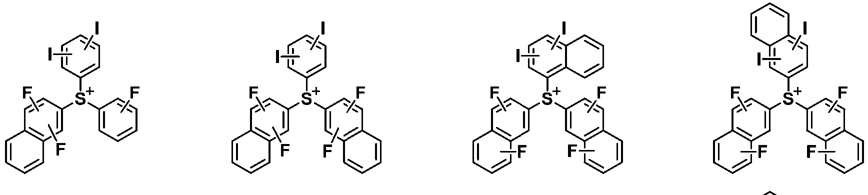

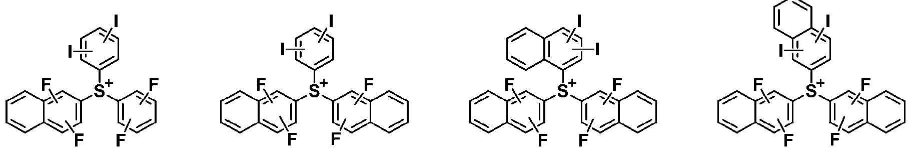

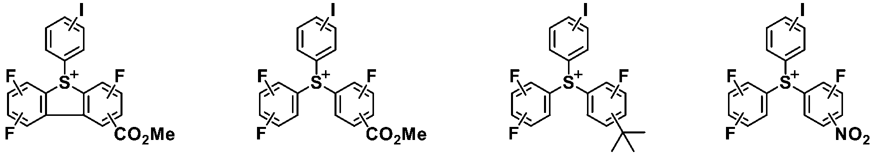

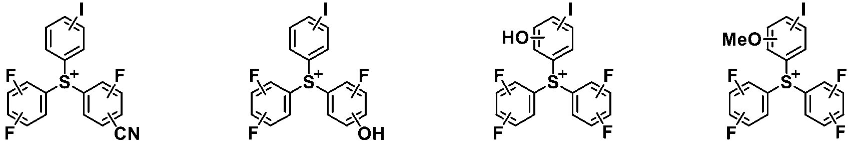

Illustrative structures of repeat units B6 to B10 include arbitrary combinations of anions with cations, both as mentioned above.

The repeat units B6 to B10 are capable of generating an acid upon exposure to high-energy radiation. It is believed that binding of the relevant units to a polymer enables to appropriately control acid diffusion and to form a pattern with reduced LER. Since the acid-generating unit is bound to a polymer, the phenomenon that acid volatilizes from the exposed region and re-deposits on the unexposed region during bake in vacuum is suppressed. This is effective for reducing LER and for suppressing unwanted negative-working reaction in the unexposed region for reducing defectiveness.

Of the repeat units B6 to B10, repeat units B7 to B10 are preferred because the acid strength is optimum for controlling acid diffusion and designing the acid labile group in the polymer, with repeat units B7, B9 and B10 being more preferred.

When the polymer contains repeat units B6 to B10, the content of these units is preferably 0.1 to 30 mol%, more preferably 0.5 to 20 mol% of the overall repeat units of the polymer. Each of repeat units B6 to B10 may be of one type or a mixture of plural types.

The content of repeat units having an aromatic ring structure is preferably at least 65 mol%, more preferably at least 75 mol%, even more preferably at least 85 mol% based on the overall repeat units of the polymer. When the polymer does not contain repeat units B6 to B10, it is preferred that all units have an aromatic ring structure.

The polymer may further comprise (meth)acrylate units protected with an acid labile group or (meth)acrylate units having an adhesive group such as lactone structure or hydroxy group other than phenolic hydroxy as commonly used in the art. These repeat units are effective for fine adjustment of properties of a resist film, but not essential.

Examples of the (meth)acrylate unit having an adhesive group include repeat units having the formula (B11), repeat units having the formula (B12), and repeat units having the formula (B13), which are also referred to as repeat units B11, B12, and B13, respectively. While these units do not exhibit acidity, they may be used as auxiliary units for providing adhesion to substrates or adjusting solubility.

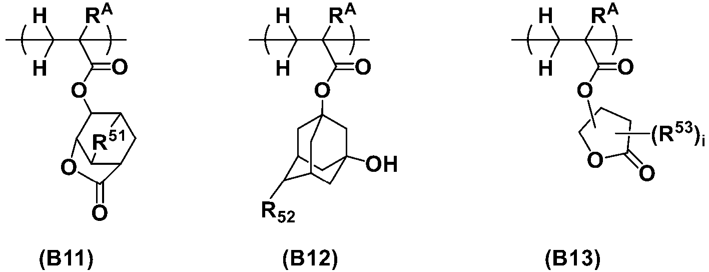

In formulae (B11) to (B13), R^{A} is each independently hydrogen, fluorine, methyl or trifluoromethyl. R⁵¹ is -O- or methylene. R⁵² is hydrogen or hydroxy. R⁵³ is a C₁-C₄ saturated hydrocarbyl group, and i is 0, 1, 2 or 3.

When the polymer contains repeat units B11 to B13, the content of these units is preferably 0 to 20 mol%, more preferably 0 to 10 mol% of the overall units of the polymer. Each of repeat units B11 to B13 may be of one type or a mixture of plural types.

The polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630.

The polymer should preferably have a Mw of 1,000 to 50,000, and more preferably 2,000 to 20,000. A Mw of at least 1,000 eliminates the risk that pattern features are rounded at their top, inviting degradations of resolution and LER. A Mw of up to 50,000 eliminates the risk that LER is increased when a pattern with a line width of up to 100 nm is formed. As used herein, Mw is measured by GPC versus polystyrene standards using tetrahydrofuran (THF) or dimethylformamide (DMF).

The polymer preferably has a narrow molecular weight distribution or dispersity (Mw/Mn) of 1.0 to 2.0, more preferably 1.0 to 1.9, even more preferably 1.0 to 1.8. A polymer with such a narrow dispersity eliminates the risk that foreign particles are left on the pattern after development and the pattern profile is aggravated.

The base polymer is designed such that the dissolution rate in alkaline developer is preferably up to 10 nm/min, more preferably up to 7 nm/min, even more preferably up to 5 nm/min. In the advanced generation of lithography wherein the coating film on the substrate is in a thin film range of up to 100 nm, the influence of pattern film thickness loss during alkaline development becomes strong. When the polymer has an alkaline dissolution rate of greater than 10 nm/min, pattern collapse occurs, i.e., a small-size pattern cannot be formed. The problem becomes outstanding in the fabrication of photomasks requiring to be defectless and having a tendency of strong development process. It is noted that the dissolution rate of a base polymer in alkaline developer is computed by spin coating a 16.7 wt% solution of a polymer in propylene glycol monomethyl ether acetate (PGMEA) solvent onto a 8-inch silicon wafer, baking at 100°C for 90 seconds to form a film of 1,000 nm thick, developing the film in a 2.38 wt% aqueous solution of tetramethylammonium hydroxide (TMAH) at 23°C for 100 seconds, and measuring a loss of film thickness.

In addition to the polymer defined above, the base polymer (B) may contain another polymer. The other polymer may be any of prior art well-known base polymers used in resist compositions. The content of the other polymer is not particularly limited as long as the benefits of the invention are not impaired.

### (C) Organic solvent

The chemically amplified positive resist composition may further comprise an organic solvent as component (C). The organic solvent used herein is not particularly limited as long as the components are soluble therein. Examples of the organic solvent are described in JP-A 2008-111103, paragraphs [0144] to [0145] (USP 7,537,880). Specifically, exemplary solvents include ketones such as cyclohexanone, cyclopentanone, methyl-2-n-pentyl ketone and 2-heptanone; alcohols such as 3-methoxybutanol, 3-methyl-3-methoxybutanol, 1-methoxy-2-propanol, 1-ethoxy-2-propanol, and diacetone alcohol; ethers such as propylene glycol monomethyl ether (PGME), ethylene glycol monomethyl ether, propylene glycol monoethyl ether, ethylene glycol monoethyl ether, propylene glycol dimethyl ether, and diethylene glycol dimethyl ether; esters such as propylene glycol monomethyl ether acetate (PGMEA), propylene glycol monoethyl ether acetate, ethyl lactate (EL), ethyl pyruvate, butyl acetate, methyl 3-methoxypropionate, ethyl 3-ethoxypropionate, tert-butyl acetate, tert-butyl propionate, and propylene glycol mono-tert-butyl ether acetate; and lactones such as γ-butyrolactone (GBL), and mixtures thereof. Where an acid labile group of acetal form is used, a high-boiling alcohol solvent such as diethylene glycol, propylene glycol, glycerol, 1,4-butanediol or 1,3-butanediol may be added to accelerate deprotection reaction of acetal.

Of the above organic solvents, it is recommended to use 1-ethoxy-2-propanol, PGMEA, PGME, cyclohexanone, EL, GBL, and mixtures thereof.

In the positive resist composition, the organic solvent (C) is preferably used in an amount of 200 to 10,000 parts, more preferably 400 to 5,000 parts by weight per 80 parts by weight of the base polymer (B). The organic solvent may be used alone or in admixture.

### (D) Fluorinated polymer

The positive resist composition may further comprise a fluorinated polymer for the purposes of enhancing contrast, preventing chemical flare of acid upon exposure to high-energy radiation, preventing mixing of acid from an anti-charging film in the step of coating an anti-charging film-forming material on a resist film, and suppressing unexpected unnecessary pattern degradation. The fluorinated polymer contains repeat units of at least one type selected from repeat units having the formula (D1), repeat units having the formula (D2), repeat units having the formula (D3), and repeat units having the formula (D4), and may contain repeat units of at least one type selected from repeat units having the formula (D5) and repeat units having the formula (D6). It is noted that repeat units having formulae (D1), (D2), (D3), (D4), (D5), and (D6) are also referred to as repeat units D1, D2, D3, D4, D5, and D6, respectively, hereinafter. Since the fluorinated polymer also has a surface active function, it can prevent insoluble residues from re-depositing onto the substrate during the development step and is thus effective for preventing development defects.

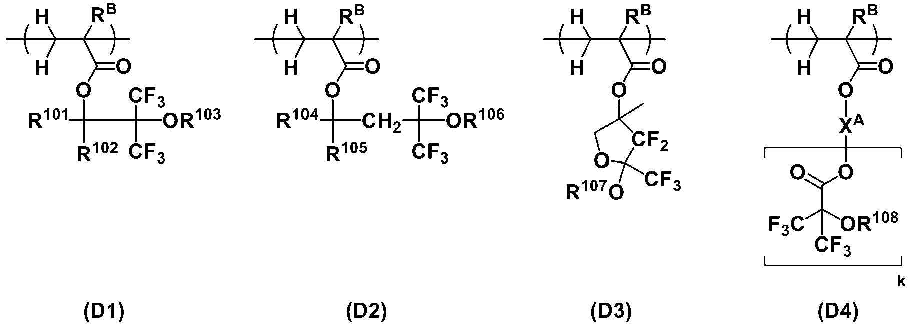

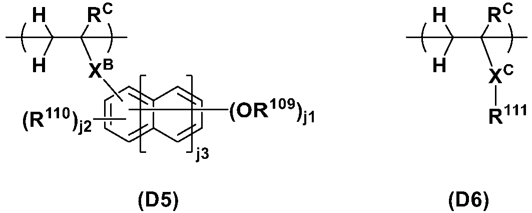

In formulae (D1) to (D6), j1 is 1, 2 or 3, j2 is an integer satisfying: 0 ≤ j2 ≤ 5+2(j3)j1, j3 is 0 or 1, and k is 1, 2 or 3. R^{B} is each independently hydrogen, fluorine, methyl or trifluoromethyl. R^{C} is each independently hydrogen or methyl. R¹⁰¹, R¹⁰², R¹⁰⁴ and R¹⁰⁵ are each independently hydrogen or a C₁-C₁₀ saturated hydrocarbyl group. R¹⁰³, R¹⁰⁶, R¹⁰⁷ and R¹⁰⁸ are each independently hydrogen, a C₁-C₁₅ hydrocarbyl group or fluorinated hydrocarbyl group, or an acid labile group, with the proviso that an ether bond or carbonyl moiety may intervene in a carbon-carbon bond in the hydrocarbyl groups or fluorinated hydrocarbyl groups represented by R¹⁰³, R¹⁰⁶, R¹⁰⁷ and R¹⁰⁸. R¹⁰⁹ is hydrogen or a C₁-C₅ straight or branched hydrocarbyl group in which a heteroatom-containing moiety may intervene in a carbon-carbon bond. When j1 is 2 or 3, a plurality of R¹⁰⁹ may be identical or different. R¹¹⁰ is a C₁-C₅ straight or branched hydrocarbyl group in which a heteroatom-containing moiety may intervene in a carbon-carbon bond. When j2 is 2 or more, a plurality of R¹¹⁰ may be identical or different. R¹¹¹ is a C₁-C₂₀ saturated hydrocarbyl group in which at least one hydrogen is substituted by fluorine and some -CH₂-may be replaced by an ester bond or ether bond. X^{A} is a C₁-C₂₀ (k+1)-valent hydrocarbon group or C₁-C₂₀ (k+1)-valent fluorinated hydrocarbon group. X^{B} is a single bond, *-C(=O)-O- or *-C(=O)-N(H)- wherein * designates a point of attachment to the carbon atom in the backbone. X^{C} is a single bond, -O-, *-C(=O)-O-X^{C1}-X^{C2}- or *-C(=O)-N(H)-X^{C1}-X^{C2}-, wherein X^{C1} is a single bond or a C₁-C₁₀ saturated hydrocarbylene group, X^{C2} is a single bond, ester bond, ether bond or sulfonamide bond, and * designates a point of attachment to the carbon atom in the backbone.

In formulae (D1) and (D2), examples of the C₁-C₁₀ saturated hydrocarbyl group represented by R¹⁰¹, R¹⁰², R¹⁰⁴ and R¹⁰⁵ include C₁-C₁₀ alkyl groups such as methyl, ethyl, n-propyl, isopropyl, n-butyl, isobutyl, sec-butyl, tert-butyl, n-pentyl, n-hexyl, n-heptyl, n-octyl, n-nonyl, and n-decyl, and C₃-C₁₀ cyclic saturated hydrocarbyl groups such as cyclopropyl, cyclobutyl, cyclopentyl, cyclohexyl, adamantyl, and norbornyl. Inter alia, C₁-C₆ saturated hydrocarbyl groups are preferred.

In formulae (D1) to (D4), the C₁-C₁₅ hydrocarbyl group represented by R¹⁰³, R¹⁰⁶, R¹⁰⁷ and R¹⁰⁸ may be straight, branched or cyclic and examples thereof include C₁-C₁₅ alkyl, C₂-C₁₅ alkenyl and C₂-C₁₅ alkynyl groups, with the alkyl groups being preferred. Suitable alkyl groups include methyl, ethyl, n-propyl, isopropyl, n-butyl, isobutyl, sec-butyl, n-pentyl, n-hexyl, n-heptyl, n-octyl, n-nonyl, n-decyl, n-undecyl, n-dodecyl, n-tridecyl, n-tetradecyl and n-pentadecyl. The fluorinated hydrocarbyl groups correspond to the foregoing hydrocarbyl groups in which some or all carbon-bonded hydrogen atoms are substituted by fluorine atoms.

In formula (D4), examples of the C₁-C₂₀ (k+1)-valent hydrocarbon group X^{A} include the foregoing C₁-C₂₀ alkyl groups and C₃-C₂₀ cyclic saturated hydrocarbyl groups, with "k" number of hydrogen atoms being eliminated. Examples of the C₁-C₂₀ (k+1)-valent fluorinated hydrocarbon group X^{A} include the foregoing (k+1)-valent hydrocarbon groups in which at least one hydrogen atom is substituted by fluorine.

Examples of the repeat units D1 to D4 are given below, but not limited thereto. Herein R^{B} is as defined above.

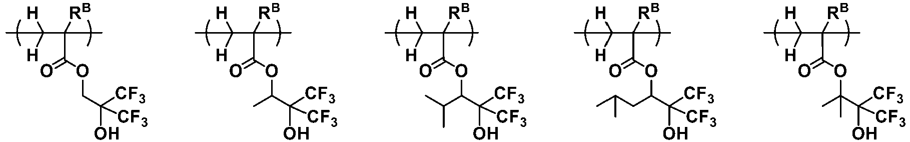

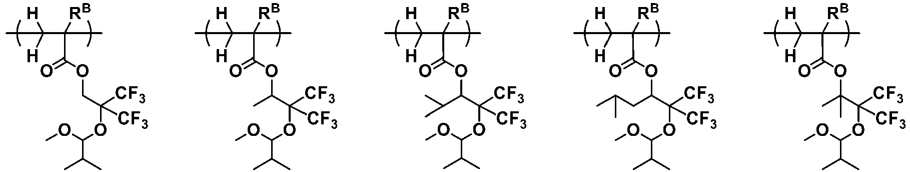

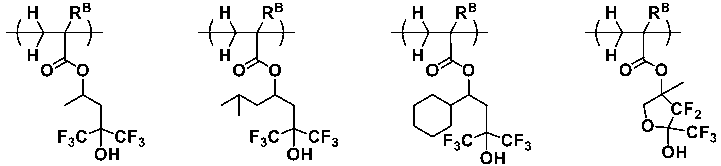

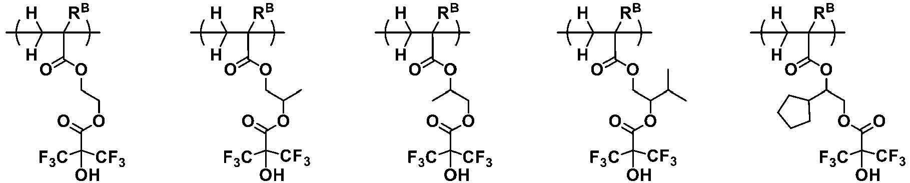

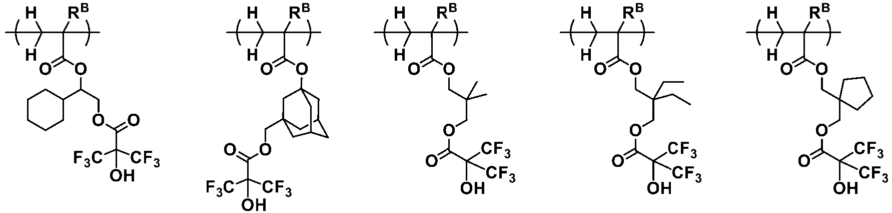

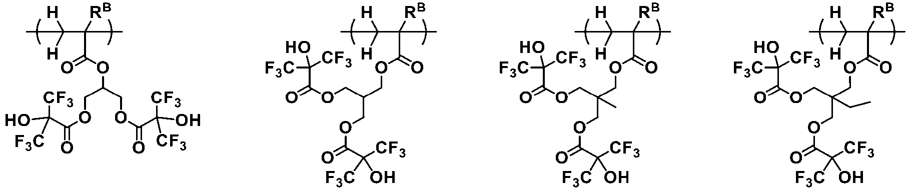

In formula (D5), examples of the C₁-C₅ hydrocarbyl groups R¹⁰⁹ and R¹¹⁰ include alkyl, alkenyl and alkynyl groups, with the alkyl groups being preferred. Suitable alkyl groups include methyl, ethyl, n-propyl, isopropyl, n-butyl, isobutyl, sec-butyl, and n-pentyl. In these groups, a moiety containing a heteroatom such as oxygen, sulfur or nitrogen may intervene in a carbon-carbon bond.

In formula (D5), -OR¹⁰⁹ is preferably a hydrophilic group. In this case, R¹⁰⁹ is preferably hydrogen or a C₁-C₅ alkyl group in which oxygen intervenes in a carbon-carbon bond.

In formula (D5), X^{B} is preferably *-C(=O)-O- or *-C(=O)-N(H)-. Also preferably R^{C} is methyl. The inclusion of carbonyl in X² enhances the ability to trap the acid originating from the anti-charging film. A polymer wherein R^{C} is methyl is a robust polymer having a high glass transition temperature (Tg) which is effective for suppressing acid diffusion. As a result, the resist film is improved in stability with time, and neither resolution nor pattern profile is degraded.

Examples of the repeat unit D5 are given below, but not limited thereto. Herein R^{C} is as defined above.

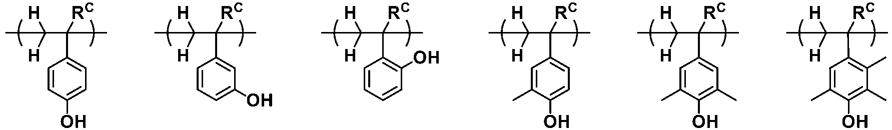

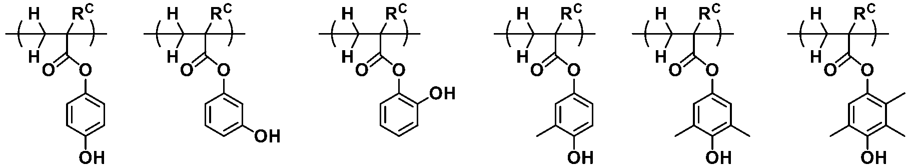

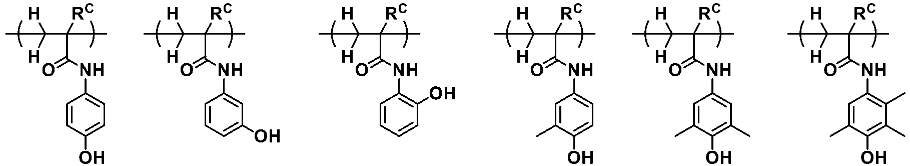

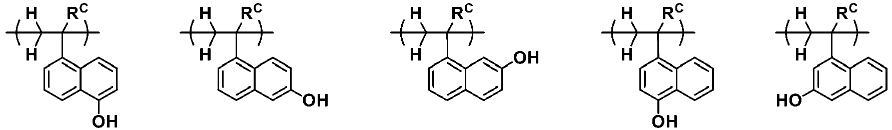

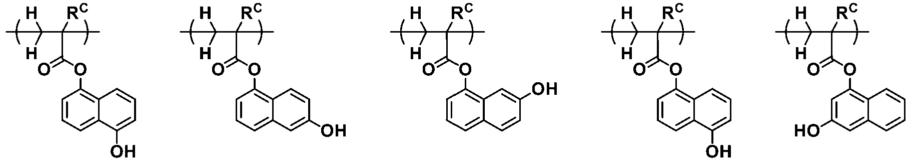

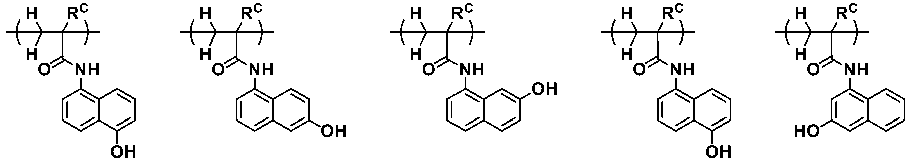

In formula (D6), the C₁-C₁₀ saturated hydrocarbylene group X^{C} may be straight, branched or cyclic and examples thereof include methanediyl, ethane-1,1-diyl, ethane-1,2-diyl, propane-1,1-diyl, propane-1,2-diyl, propane-1,3-diyl, propane-2,2-diyl, butane-1,1-diyl, butane-1,2-diyl, butane-1,3-diyl, butane-2,3-diyl, butane-1,4-diyl, and 1,1-dimethylethane-1,2-diyl.

The C₁-C₂₀ saturated hydrocarbyl group having at least one hydrogen substituted by fluorine, represented by R¹¹¹, may be straight, branched or cyclic and examples thereof include C₁-C₂₀ alkyl groups and C₃-C₂₀ cyclic saturated hydrocarbyl groups in which at least one hydrogen is substituted by fluorine.

Examples of the repeat unit D6 are given below, but not limited thereto. Herein R^{C} is as defined above.

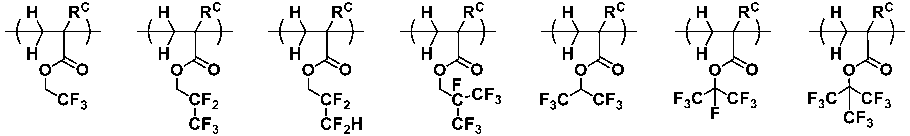

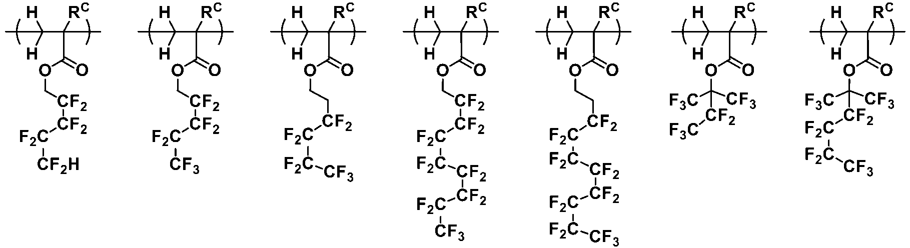

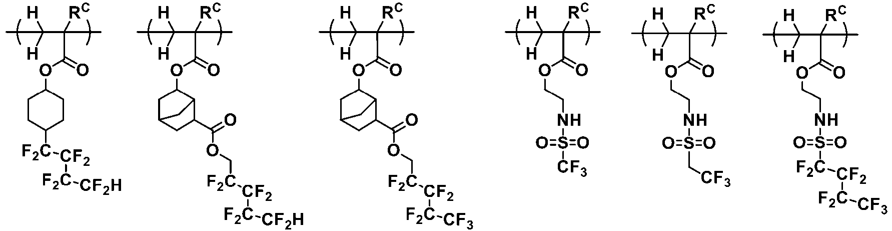

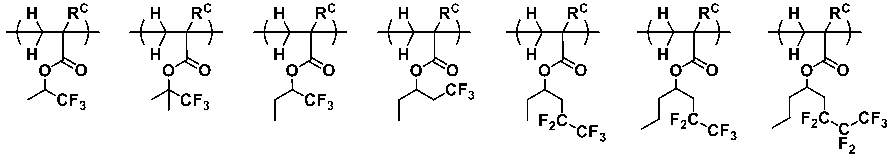

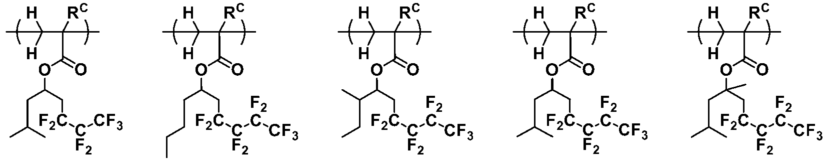

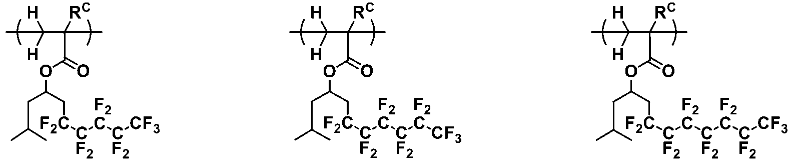

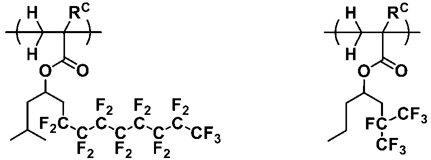

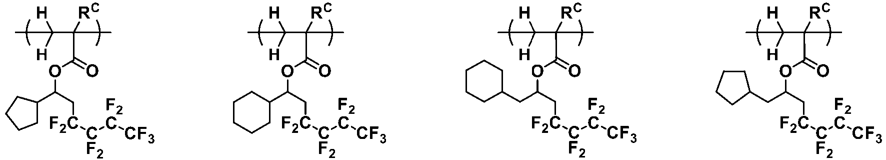

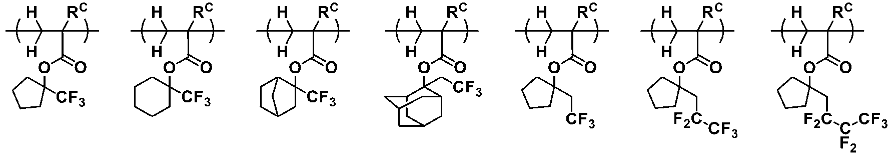

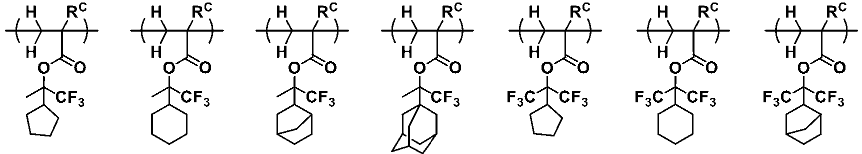

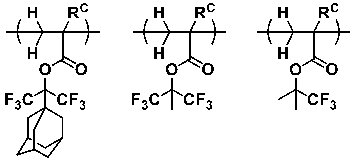

The repeat units D1 to D4 are preferably incorporated in an amount of 15 to 95 mol%, more preferably 20 to 85 mol% based on the overall repeat units of the fluorinated polymer. The repeat unit D5 and/or D6 is preferably incorporated in an amount of 5 to 85 mol%, more preferably 15 to 80 mol% based on the overall repeat units of the fluorinated polymer. Each of repeat units D1 to D6 may be used alone or in admixture.

The fluorinated polymer may comprise additional repeat units as well as the repeat units D1 to D6. Suitable additional repeat units include those described in USP 9,091,918 (JP-A 2014-177407, paragraphs [0046]-[0078]). When the fluorinated polymer comprises additional repeat units, their content is preferably up to 50 mol% based on the overall repeat units.

The fluorinated polymer may be synthesized by combining suitable monomers optionally protected with a protective group, copolymerizing them in the standard way, and effecting deprotection reaction if necessary. The copolymerization reaction is preferably radical or anionic polymerization though not limited thereto. For the polymerization reaction, reference may be made to JP-A 2004-115630.

The fluorinated polymer should preferably have a Mw of 2,000 to 50,000, and more preferably 3,000 to 20,000. A fluorinated polymer with a Mw of at least 2,000 does not cause excessive acid diffusion, degrade resolution or detract from age stability.

A polymer with a Mw of up to 50,000 has a sufficient solvent solubility to leave no coating defects. The fluorinated polymer preferably has a dispersity (Mw/Mn) of 1.0 to 2.2, more preferably 1.0 to 1.7.

In the positive resist composition, the fluorinated polymer (D) is preferably used in an amount of 0.01 to 30 parts, more preferably 0.1 to 20 parts by weight per 80 parts by weight of the base polymer (B). The fluorinated polymer may be used alone or in admixture.

### (E) Quencher

The positive resist composition preferably contains a quencher as component (E). As used herein, the quencher refers to a compound capable of trapping the acid generated by the PAG in the resist composition to prevent the acid from diffusing to the unexposed region for thereby forming the desired pattern.

The quencher is typically selected from conventional basic compounds. Conventional basic compounds include primary, secondary, and tertiary aliphatic amines, mixed amines, aromatic amines, heterocyclic amines, nitrogen-containing compounds with carboxy group, nitrogen-containing compounds with sulfonyl group, nitrogen-containing compounds with hydroxy group, nitrogen-containing compounds with hydroxyphenyl group, alcoholic nitrogen-containing compounds, amide derivatives, imide derivatives, and carbamate derivatives. Also included are primary, secondary, and tertiary amine compounds, specifically amine compounds having a hydroxy group, ether bond, ester bond, lactone ring, cyano group, or sulfonate ester bond as described in JP-A 2008-111103, paragraphs [0146]-[0164], and compounds having a carbamate group as described in JP 3790649. Inter alia, tris[2-(methoxymethoxy)ethyl]amine, tris[2-(methoxymethoxy)ethyl]amine-N-oxide, dibutylaminobenzoic acid, morpholine derivatives, and imidazole derivatives are preferred. Addition of a basic compound is effective for further suppressing the diffusion rate of acid in the resist film or correcting the pattern profile.

Onium salts such as sulfonium, iodonium and ammonium salts of carboxylic acids which are not fluorinated at α-position as described in USP 8,795,942 (JP-A 2008-158339) may also be used as the quencher. While an α-fluorinated sulfonic acid, imide acid, and methide acid are necessary to deprotect the acid labile group, an α-non-fluorinated carboxylic acid is released by salt exchange with an α-non-fluorinated onium salt. An α-non-fluorinated carboxylic acid functions as a quencher because it does not induce substantial deprotection reaction.

Examples of the onium salt of α-non-fluorinated carboxylic acid include compounds having the formula (E1).

**R²⁰¹-CO₂⁻ Mq_{A}⁺** **(E1)**

In formula (E1), R²⁰¹ is hydrogen or a C₁-C₄₀ hydrocarbyl group which may contain a heteroatom, exclusive of the hydrocarbyl group in which the hydrogen bonded to the carbon atom at α-position of the carboxy group is substituted by fluorine or fluoroalkyl.

The hydrocarbyl group R²⁰¹ may be saturated or unsaturated and straight, branched or cyclic. Examples thereof include C₁-C₄₀ alkyl groups such as methyl, ethyl, n-propyl, isopropyl, n-butyl, sec-butyl, tert-butyl, n-pentyl, tert-pentyl, n-hexyl, n-octyl, 2-ethylhexyl, n-nonyl, n-decyl; C₃-C₄₀ cyclic saturated hydrocarbyl groups such as cyclopentyl, cyclohexyl, cyclopentylmethyl, cyclopentylethyl, cyclopentylbutyl, cyclohexylmethyl, cyclohexylethyl, cyclohexylbutyl, norbornyl, tricyclo[5.2.1.0^{2,6}]decyl, adamantyl, and adamantylmethyl; C₂-C₄₀ alkenyl groups such as vinyl, allyl, propenyl, butenyl and hexenyl; C₃-C₄₀ cyclic unsaturated aliphatic hydrocarbyl groups such as cyclohexenyl; C₆-C₄₀ aryl groups such as phenyl, naphthyl, alkylphenyl groups (e.g., 2-methylphenyl, 3-methylphenyl, 4-methylphenyl, 4-ethylphenyl, 4-tert-butylphenyl, 4-n-butylphenyl), di- or trialkylphenyl groups (e.g., 2,4-dimethylphenyl and 2,4,6-triisopropylphenyl), alkylnaphthyl groups (e.g., methylnaphthyl and ethylnaphthyl), dialkylnaphthyl groups (e.g., dimethylnaphthyl and diethylnaphthyl); and C₇-C₄₀ aralkyl groups such as benzyl, 1-phenylethyl and 2-phenylethyl.

In the foregoing hydrocarbyl groups, some or all of the hydrogen atoms may be substituted by a moiety containing a heteroatom such as oxygen, sulfur, nitrogen or halogen, and some -CH₂- may be replaced by a moiety containing a heteroatom such as oxygen, sulfur or nitrogen, so that the group may contain a hydroxy moiety, cyano moiety, carbonyl moiety, ether bond, thioether bond, ester bond, sulfonate ester bond, carbonate bond, lactone ring, sultone ring, carboxylic anhydride (-C(=O)-O-C(=O)-) or haloalkyl moiety. Suitable heteroatom-containing hydrocarbyl groups include heteroaryl groups such as thienyl; alkoxyphenyl groups such as 4-hydroxyphenyl, 4-methoxyphenyl, 3-methoxyphenyl, 2-methoxyphenyl, 4-ethoxyphenyl, 4-tert-butoxyphenyl, 3-tert-butoxyphenyl; alkoxynaphthyl groups such as methoxynaphthyl, ethoxynaphthyl, n-propoxynaphthyl and n-butoxynaphthyl; dialkoxynaphthyl groups such as dimethoxynaphthyl and diethoxynaphthyl; and aryloxoalkyl groups, typically 2-aryl-2-oxoethyl groups such as 2-phenyl-2-oxoethyl, 2-(1-naphthyl)-2-oxoethyl and 2-(2-naphthyl)-2-oxoethyl.

In formula (E1), Mq_{A}⁺ is an onium cation. The onium cation is preferably selected from sulfonium, iodonium and ammonium cations, more preferably sulfonium and iodonium cations. Exemplary sulfonium cations include those exemplified above for the sulfonium cation having formula (A1), those described in JP-A 2024-003744, paragraphs [0102]-[0125], WO 2024/128017, paragraphs [0044]-[0049], JP 7491173, paragraphs [0035]-[0046], JP-A 2025-051616, paragraphs [0074]-[0109], and JP-A 2025-048682, paragraphs [0042]-[0043], and those exemplified above for the sulfonium cation having formula (sulfo-1), but are not limited thereto. Exemplary iodonium cations include those described in JP-A 2024-000259, paragraph [0181], but are not limited thereto.

The ammonium cation preferably has the formula (am-1).

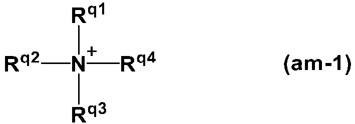

In formula (am-1), R^{q1} to R^{q4} are each independently a C₁-C₄₀ hydrocarbyl group which may contain a heteroatom. Any two of R^{q1} to R^{q4} may bond together to form a ring with the nitrogen atom to which they are attached. Examples of the hydrocarbyl group are as exemplified above for the hydrocarbyl group R¹ to R³ in formula (A1).

Examples of the ammonium cation having formula (am-1) are shown below, but not limited thereto.

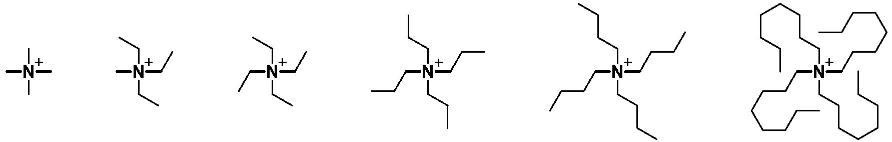

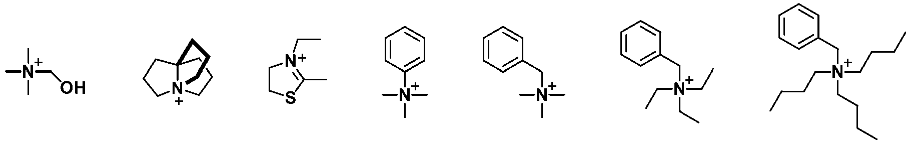

Examples of the anion in the onium salt having formula (E1) are shown below, but not limited thereto.

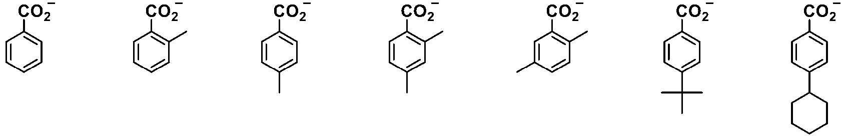

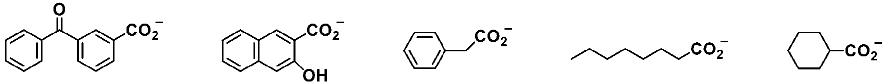

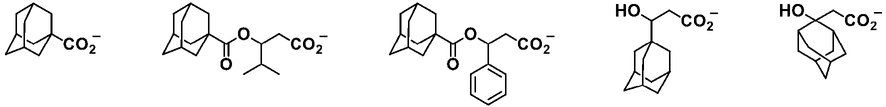

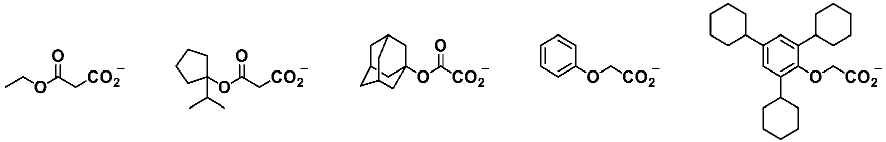

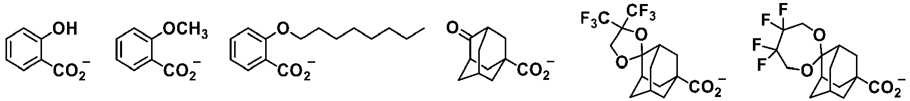

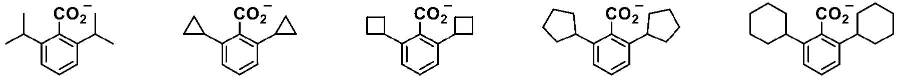

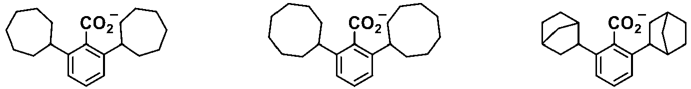

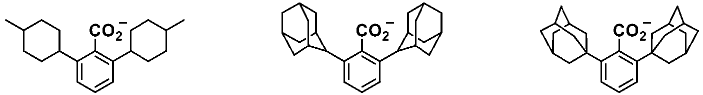

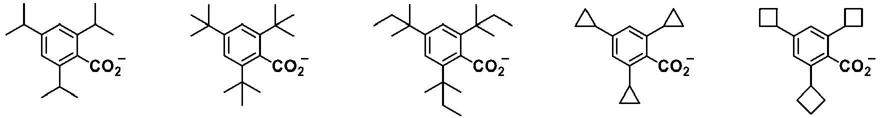

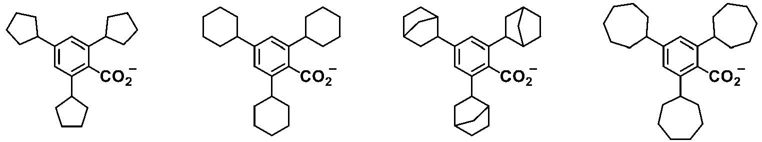

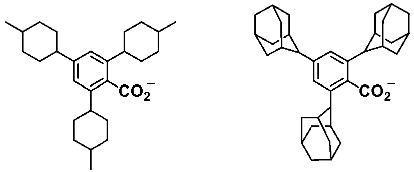

A sulfonium salt of iodized benzene ring-containing carboxylic acid having the formula (E2) is also useful as the quencher.

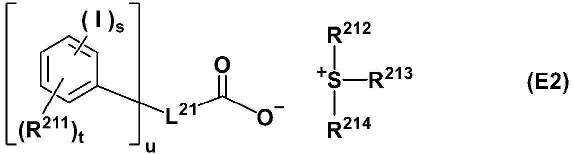

In formula (E2), s is 1, 2, 3, 4 or 5, t is 0, 1, 2 or 3, s+t is from 1 to 5, and u is 1, 2 or 3.

In formula (E2), R²¹¹ is hydroxy, fluorine, chlorine, bromine, amino, nitro, cyano, or a C₁-C₆ saturated hydrocarbyl, C₁-C₆ saturated hydrocarbyloxy, C₂-C₆ saturated hydrocarbylcarbonyloxy or C₁-C₄ saturated hydrocarbylsulfonyloxy group, in which some or all hydrogen may be substituted by halogen, or -N(R^{211A})-C(=O)-R^{211B}, or -N(R^{211A})-C(=O)-O-R^{211B}. R^{211A} is hydrogen or a C₁-C₆ saturated hydrocarbyl group. R^{211B} is a C₁-C₆ saturated hydrocarbyl or C₂-C₈ unsaturated aliphatic hydrocarbyl group. A plurality of R²¹¹ may be identical or different when t and/or u is 2 or 3.

In formula (E2), L²¹ is a single bond or a C₁-C₂₀ (u+1)-valent linking group which may contain at least one moiety selected from ether bond, carbonyl moiety, ester bond, amide bond, sultone ring, lactam ring, carbonate bond, halogen, hydroxy moiety, and carboxy moiety. The saturated hydrocarbyl, saturated hydrocarbyloxy, saturated hydrocarbylcarbonyloxy, and saturated hydrocarbylsulfonyloxy groups may be straight, branched or cyclic.

In formula (E2), R²¹², R²¹³ and R²¹⁴ are each independently halogen, or a C₁-C₂₀ hydrocarbyl group which may contain a heteroatom. The hydrocarbyl group may be saturated or unsaturated and straight, branched or cyclic. Examples thereof include C₁-C₂₀ alkyl, C₂-C₂₀ alkenyl, C₆-C₂₀ aryl, and C₇-C₂₀ aralkyl groups. In these groups, some or all hydrogen may be substituted by hydroxy, carboxy, halogen, oxo, cyano, nitro, sultone ring, sulfo, or sulfonium salt-containing moiety, or some -CH₂- may be replaced by an ether bond, ester bond, carbonyl moiety, amide bond, carbonate bond or sulfonate ester bond. Also, R²¹² and R²¹³ may bond together to form a ring with the sulfur atom to which they are attached.

Examples of the compound having formula (E2) are as described in JP-A 2017-219836. The compound having formula (E2) exerts a sensitizing effect due to remarkable absorption and an acid diffusion-controlling effect.

A nitrogen-containing carboxylic acid salt compound having the formula (E3) is also useful as the quencher.

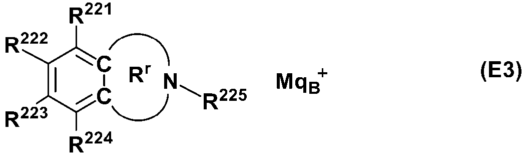

In formula (E3), R²²¹ to R²²⁴ are each independently hydrogen, -L²²-CO₂⁻, or a C₁-C₂₀ hydrocarbyl group which may contain a heteroatom. R²²¹ and R²²², R²²² and R²²³, or R²²³ and R²²⁴ may bond together to form a ring with the carbon atom to which they are attached. L²² is a single bond or a C₁-C₂₀ hydrocarbylene group which may contain a heteroatom. R²²⁵ is hydrogen or a C₁-C₂₀ hydrocarbyl group which may contain a heteroatom.

In formula (E3), the ring R^{r} is a C₂-C₆ ring containing the carbon and nitrogen atoms in the formula, in which some or all of the carbon-bonded hydrogen atoms may be substituted by a C₁-C₂₀ hydrocarbyl group or -L²²-CO₂⁻ and in which some -CH₂- may be replaced by sulfur, oxygen or nitrogen. The ring may be alicyclic or aromatic and is preferably a 5- or 6-membered ring. Suitable rings include pyridine, pyrrole, pyrrolidine, piperidine, pyrazole, imidazoline, pyridazine, pyrimidine, pyrazine, imidazoline, oxazole, thiazole, morpholine, thiazine, and triazole rings.

The carboxylic onium salt having formula (E3) has at least one -L²²-CO₂⁻. That is, at least one of R²²¹ to R²²⁴ is -L²²-CO₂⁻, and/or at least one of hydrogen atoms bonded to carbon atoms in the ring R^{r} is substituted by -L²²-CO₂⁻.

In formula (E3), Mq_{B}⁺ is a sulfonium, iodonium or ammonium cation, with the sulfonium cation being preferred. Non-limiting examples of the sulfonium cation include those described in JP-A 2024-003744, paragraphs [0102]-[0125], WO 2024/128017, paragraphs [0044]-[0049], JP 7491173, paragraphs [0035]-[0046], JP-A 2025-051616, paragraphs [0074]-[0109], and JP-A 2025-048682, paragraphs [0042]-[0043], and those exemplified above for the sulfonium cation having formula (sulfo-1).

Examples of the anion in the compound having formula (E3) are shown below, but not limited thereto.

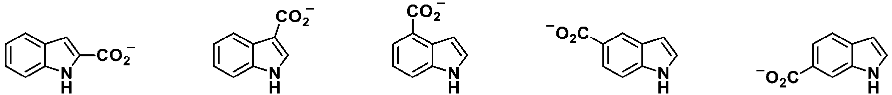

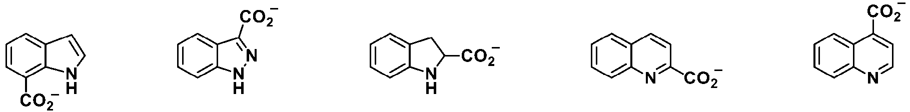

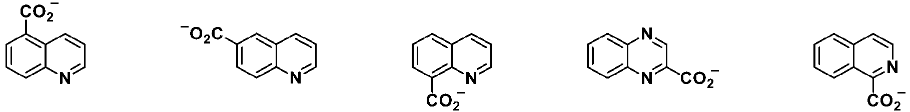

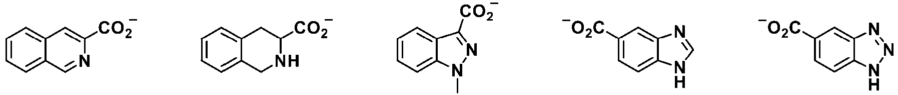

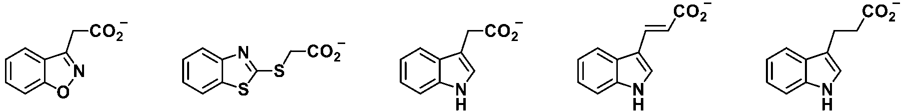

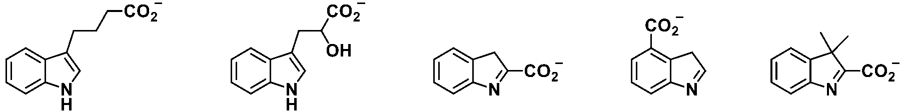

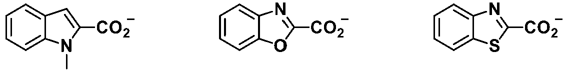

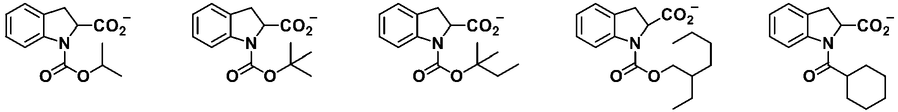

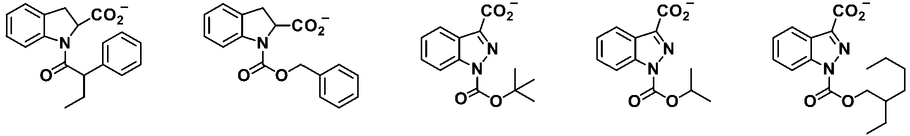

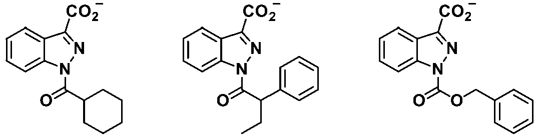

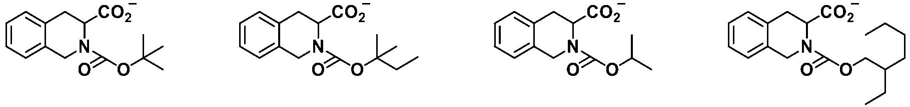

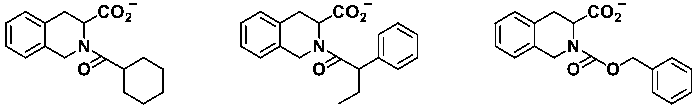

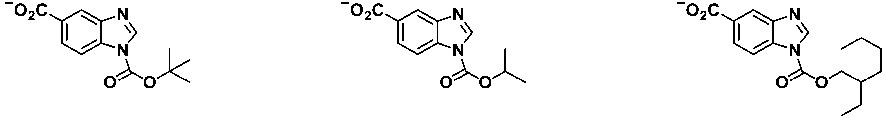

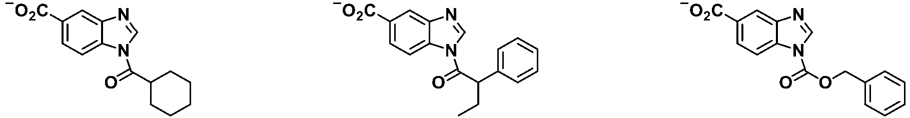

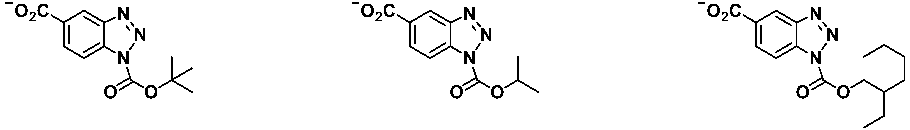

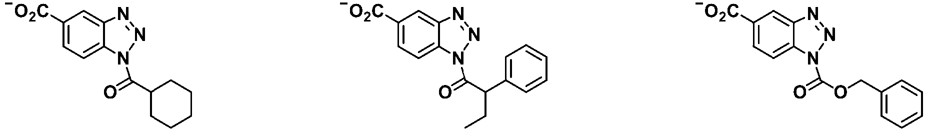

Weak acid betaine compounds are also useful as the quencher. Non-limiting examples thereof are shown below.

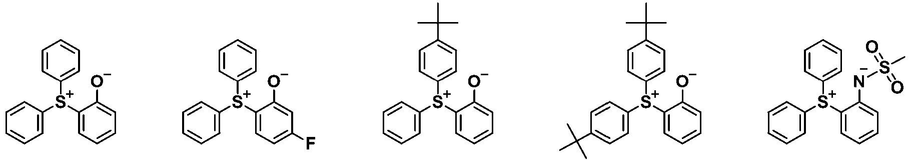

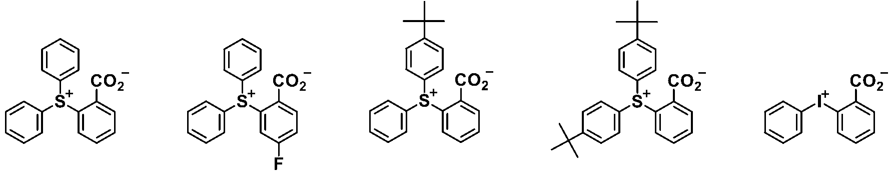

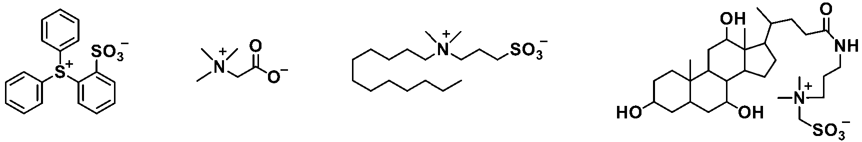

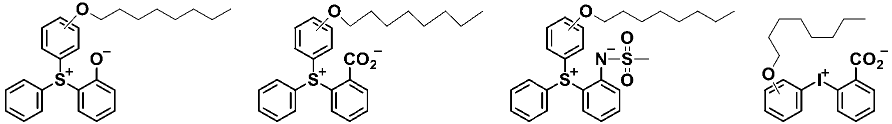

Also useful are quenchers of polymer type as described in USP 7,598,016 (JP-A 2008-239918). The polymeric quencher segregates at the resist surface after coating and thus enhances the rectangularity of resist pattern. When a protective film is applied as is often the case in the immersion lithography, the polymeric quencher is also effective for preventing a film thickness loss of resist pattern or rounding of pattern top.

When used, the quencher (E) is preferably added in an amount of 0 to 50 parts, more preferably 0.1 to 40 parts by weight per 80 parts by weight of the base polymer (B). The quencher may be used alone or in admixture.

When the chemically amplified positive resist composition contains both the PAG (A) and the quencher (E), the weight ratio of the PAG to the quencher, (A)/(E) is preferably less than 3/1, more preferably less than 2.5/1, even more preferably less than 2/1. As long as the weight ratio of the PAG to the quencher is in the range, the resist composition is able to fully suppress acid diffusion, leading to improved resolution and dimensional uniformity.

### (G) Other photoacid generator

In addition to the PAG of component (A), the chemically amplified positive resist composition may further comprise another photoacid generator (PAG) as component (G). The other PAG used herein may be any compound capable of generating an acid upon exposure to high-energy radiation. Suitable PAGs include sulfonium salts, iodonium salts, sulfonyldiazomethane, N-sulfonyloxyimide, and oxime-O-sulfonate acid generators.

The preferred PAGs are salt compounds having an anion of the structure shown below.

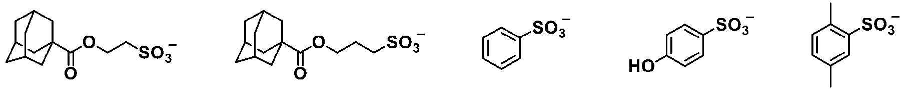

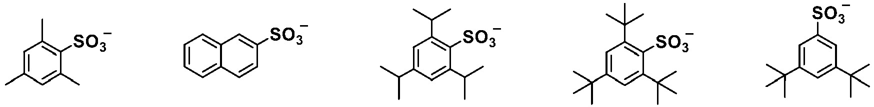

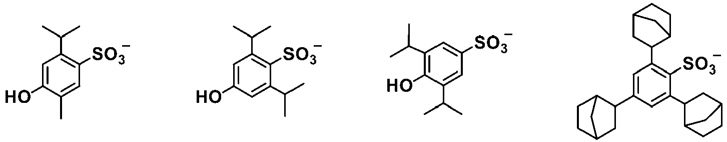

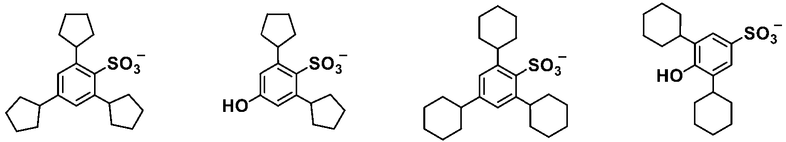

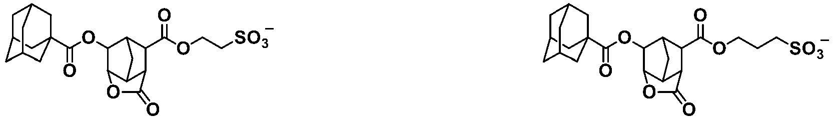

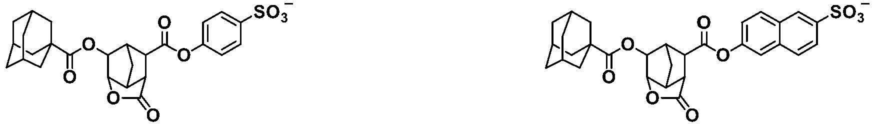

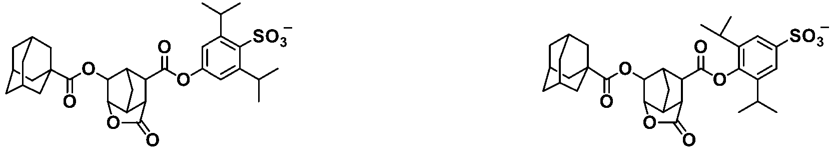

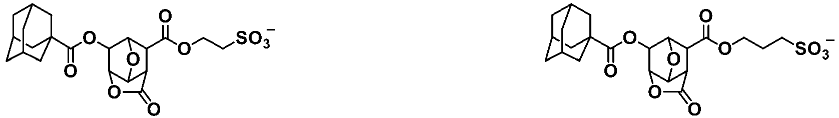

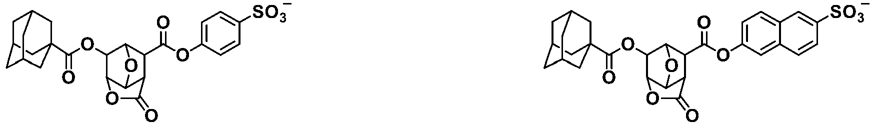

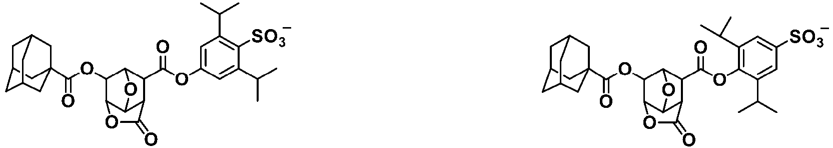

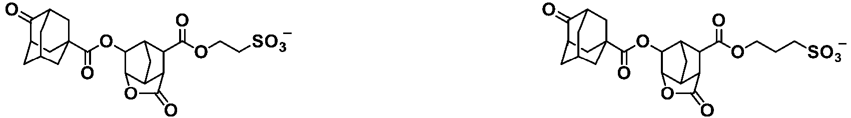

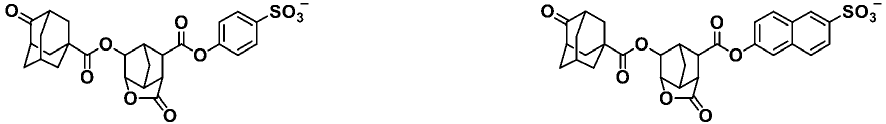

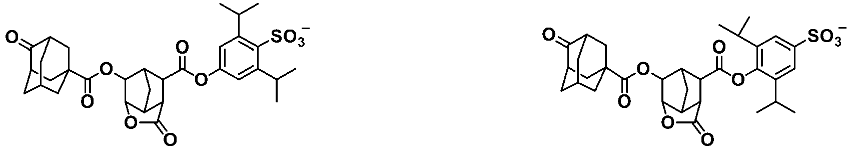

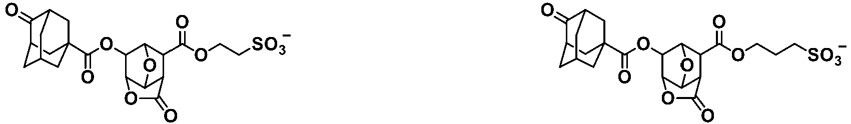

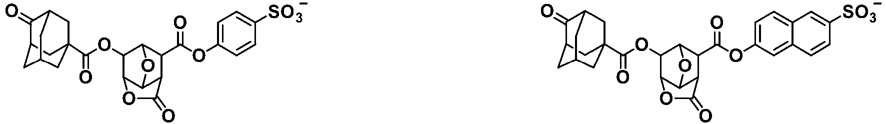

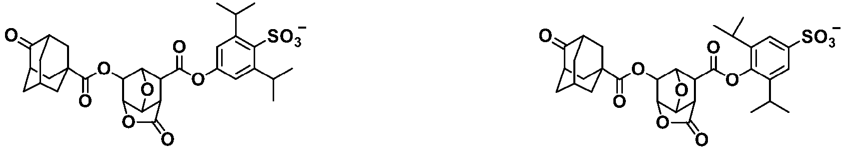

Suitable other PAGs include nonafluorobutane sulfonate, partially fluorinated sulfonates described in JP 5706778, paragraphs [0247]-[0251], partially fluorinated sulfonates described in JP 5852851, paragraphs [0261]-[0265], and those described in JP 4858714, paragraphs [0122]-[0138], JP 5368270, paragraphs [0080]-[0081], JP 6248882, paragraphs [0027]-[0029], JP 6648726, paragraphs [0029]-[0034], JP 7067271, paragraphs [0028]-[0029], JP-A 2024-104830, paragraphs [0037]-[0060], JP-A 2025-000201, paragraphs [0040]-[0071], JP-A 2023-177038, paragraphs [0039]-[0066], JP 7032549, paragraphs [0220]-[0225], JP-A 2024-077330, paragraphs [0229]-[0231], WO 2024/241820, paragraphs [0041]-[0042]. Among others, arenesulfonate and alkanesulfonate type PAGs are preferred because they generate acids having an appropriate strength to deprotect the acid labile group in repeat unit B2.

The cation that pairs with the anion in the other photoacid generator is preferably a sulfonium or iodonium cation. Non-limiting examples of the sulfonium cation include those described in JP-A 2024-003744, paragraphs [0102]-[0125], WO 2024/128017, paragraphs [0044]-[0049], JP 7491173, paragraphs [0035]-[0046], JP-A 2025-051616, paragraphs [0074]-[0109], and JP-A 2025-048682, paragraphs [0042]-[0043], as well as those exemplified for the cation having formula (sulfo-1). Examples of the iodonium cation include those described in JP-A 2024-000259, paragraph [0181], but are not limited thereto.

The other PAG generates an acid having a pKa value of preferably -2.0 or larger, more preferably -1.0 or larger. The upper limit of pKa is preferably 2.0. Notably, the pKa value is computed using pKa DB in software ACD/Chemsketch ver: 9.04 of Advanced Chemistry Development Inc.

When the resist composition contains the other PAG (G), the amount of PAG used is preferably 1 to 10 parts, more preferably 1 to 5 parts by weight per 80 parts by weight of the base polymer (B). The inclusion of the other PAG provides for appropriate adjustment of the amount of acid generated in the exposed region and the degree of dissolution inhibition in the unexposed region. The other PAG may be used alone or in admixture.

### (H) Surfactant

The positive resist composition may contain any conventional surfactants for facilitating to coat the composition to the substrate. Many surfactants are well known in the art as described in WO 2006/121096, JP-A 2008-102383, JP-A 2008-304590, JP-A 2004-115630, and JP-A 2005-008766. Any suitable one may be chosen therefrom.

When the resist composition contains the surfactant (H), the amount of surfactant used is preferably up to 2 parts, more preferably up to 1 part by weight per 80 parts by weight of the base polymer (B) and the lower limit of the amount is preferably 0.01 part by weight. The surfactant may be used alone or in admixture.

### Process

Another embodiment of the invention is a resist pattern forming process comprising the steps of applying the positive resist composition defined above onto a substrate to form a resist film thereon, exposing the resist film patternwise to high-energy radiation, and developing the exposed resist film in an alkaline developer to form a resist pattern.

Pattern formation using the positive resist composition of the invention may be performed by well-known lithography processes. In general, the resist composition is first applied onto a substrate for IC fabrication (e.g., Si, SiO, SiO₂, SiN, SiON, TiN, WSi, BPSG, SOG, organic antireflective coating, etc.) or a substrate for mask circuit fabrication (e.g., Cr, CrO, CrON, MoSi₂, Si, SiO, SiO₂, SiON, SiONC, CoTa, NiTa, TaBN, SnO₂, etc.) by a suitable coating technique such as spin coating. The coating is prebaked on a hotplate preferably at a temperature of 60 to 150°C for 1 to 20 minutes, more preferably at 80 to 140°C for 1 to 10 minutes to form a resist film of 0.03 to 2 µm thick.

Then the resist film is exposed patternwise to high-energy radiation such as UV, deep-UV, excimer laser (KrF, ArF), EUV of wavelength 3 to 15 nm, x-ray, γ-ray or synchrotron radiation or EB.

On use of UV, deep-UV, EUV, excimer laser, x-ray, γ-ray or synchrotron radiation as the high-energy radiation, the resist film is exposed through a mask having a desired pattern, preferably in a dose of 1 to 300 mJ/cm², more preferably 10 to 200 mJ/cm². On use of EB, a pattern may be written directly in a dose of preferably 1 to 300 µC/cm², more preferably 10 to 200 µC/cm². The resist composition of the invention is especially effective in the EUV or EB lithography.

The exposure may be performed by conventional lithography whereas the immersion lithography of holding a liquid, typically water between the mask and the resist film may be employed if desired. In the case of immersion lithography, a protective film which is insoluble in water may be used.

The resist film is then baked (PEB) on a hotplate preferably at 60 to 150°C for 1 to 20 minutes, more preferably at 80 to 140°C for 1 to 10 minutes.

Thereafter, the resist film is developed with a developer in the form of an aqueous base solution, for example, 0.1 to 5 wt%, preferably 2 to 3 wt% aqueous solution of tetramethylammonium hydroxide (TMAH) preferably for 0.1 to 3 minutes, more preferably 0.5 to 2 minutes by conventional techniques such as dip, puddle and spray techniques. In this way, a desired resist pattern is formed on the substrate.

The resist composition of the invention is advantageous particularly on use under the situation that requires high etching resistance, and a minimal change of pattern line width and minimal LER even when the time duration from exposure to PEB is prolonged. It is also advantageous for pattern formation on a substrate having a surface layer of material to which the resist pattern is less adherent with a likelihood of pattern stripping or pattern collapse, specifically a substrate having sputter deposited thereon a layer of metallic chromium or a chromium compound containing one or more light elements such as oxygen, nitrogen and carbon. The resist composition is particularly useful in forming a pattern on a photomask blank as the substrate.

### EXAMPLES

Examples of the invention are given below by way of illustration and not by way of limitation. The abbreviation "pbw" is parts by weight.

### [1] Synthesis of sulfonium salts

### Examples 1-1 to 1-8

### Synthesis of sulfonium salts PAG-1 to PAG-8

Sulfonium salts PAG-1 to PAG-8 shown below were synthesized by well-known organic synthesis reaction using corresponding reactants.

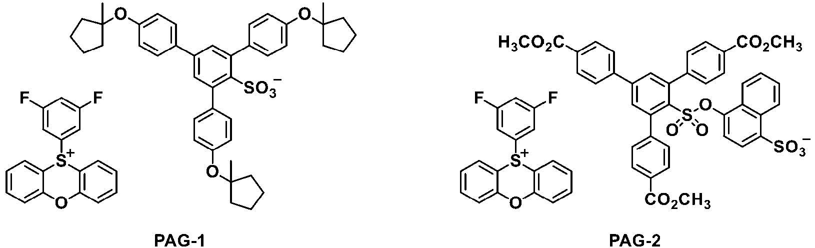

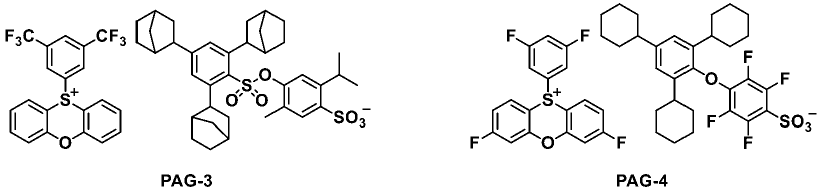

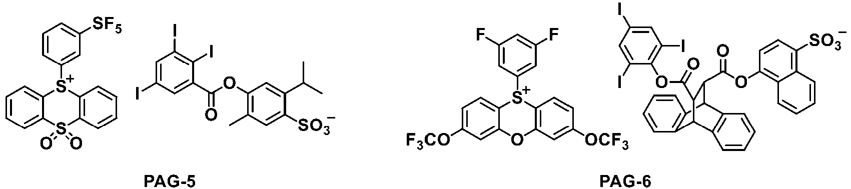

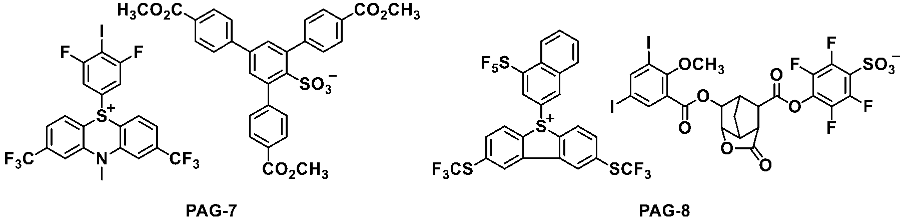

### [2] Synthesis of base polymers

### Synthesis Example

### Synthesis of base polymers P-1 to P-6

Base polymers P-1 to P-6 shown below were synthesized by combining selected monomers, performing copolymerization reaction in a solvent according to the well-known technique, pouring the reaction solution into hexane, washing the precipitated solids with hexane, isolation, and drying. The polymers were analyzed for composition by ¹H- and ¹³C-NMR spectroscopy and for Mw and Mw/Mn by GPC versus polystyrene standards using THF solvent.

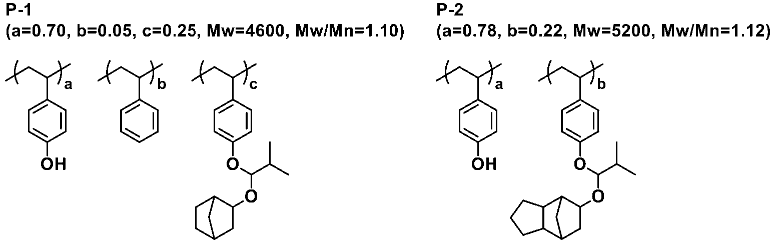

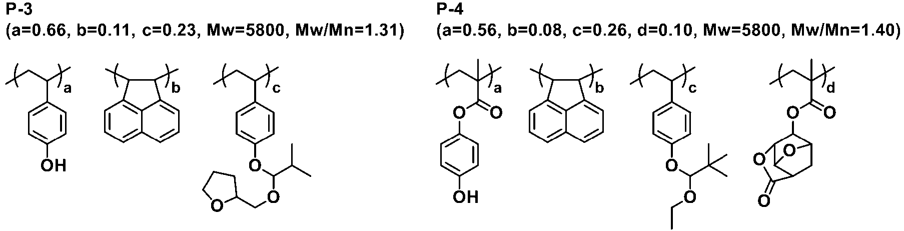

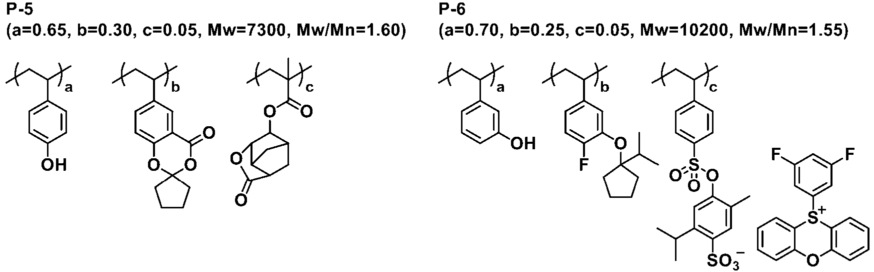

### [3] Preparation of chemically amplified positive resist compositions

### Examples 2-1 to 2-48 and Comparative Examples 1-1 to 1-42

Chemically amplified positive resist compositions were prepared by dissolving selected components in an organic solvent in accordance with the formulation shown in Tables 1 to 3, and filtering the solution through a nylon filter with a pore size of 5 nm and a UPE filter with a pore size of 1 nm. The organic solvent was a mixture of 940 pbw of PGMEA, 1,870 pbw of EL, and 1,870 pbw of PGME.

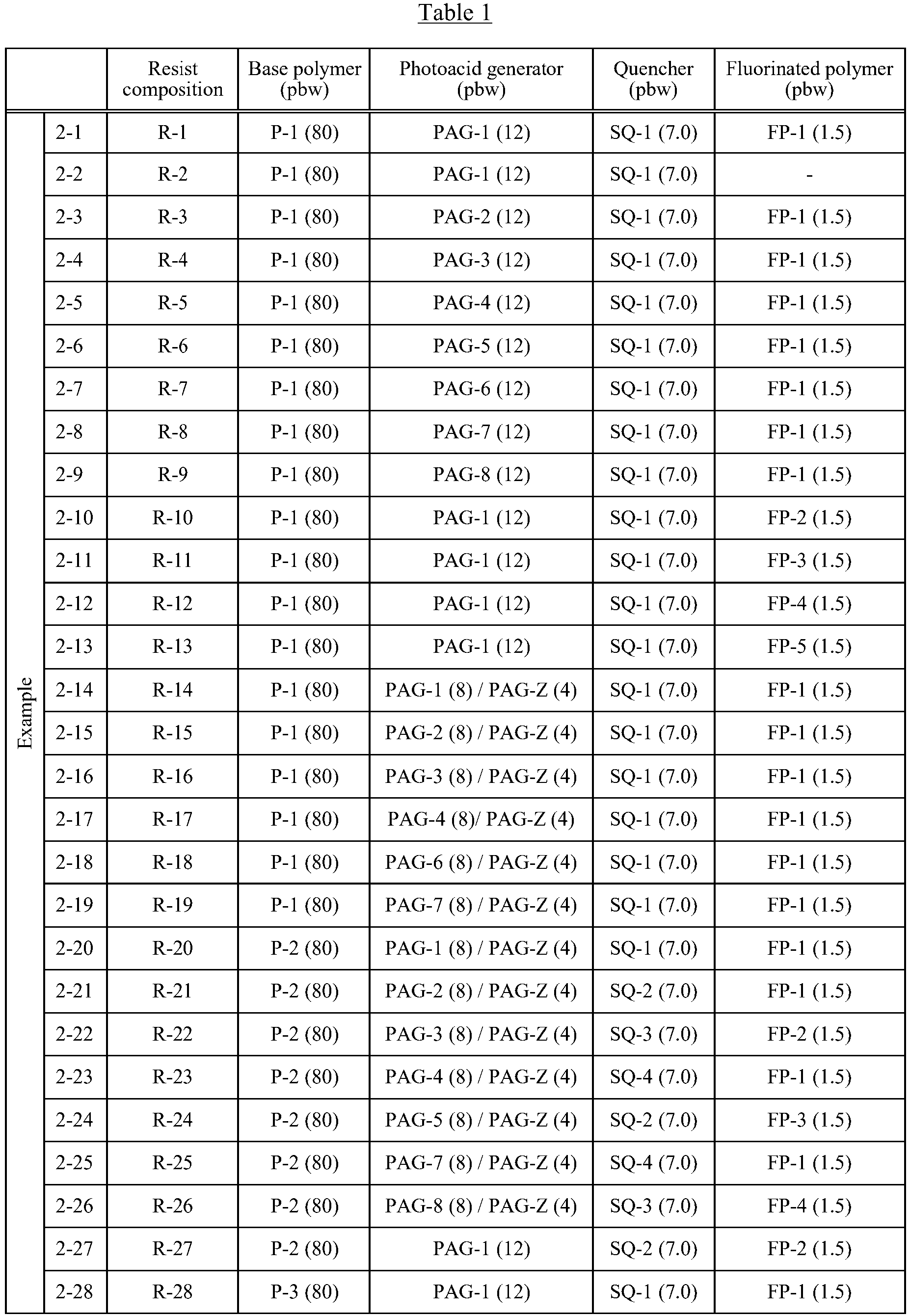

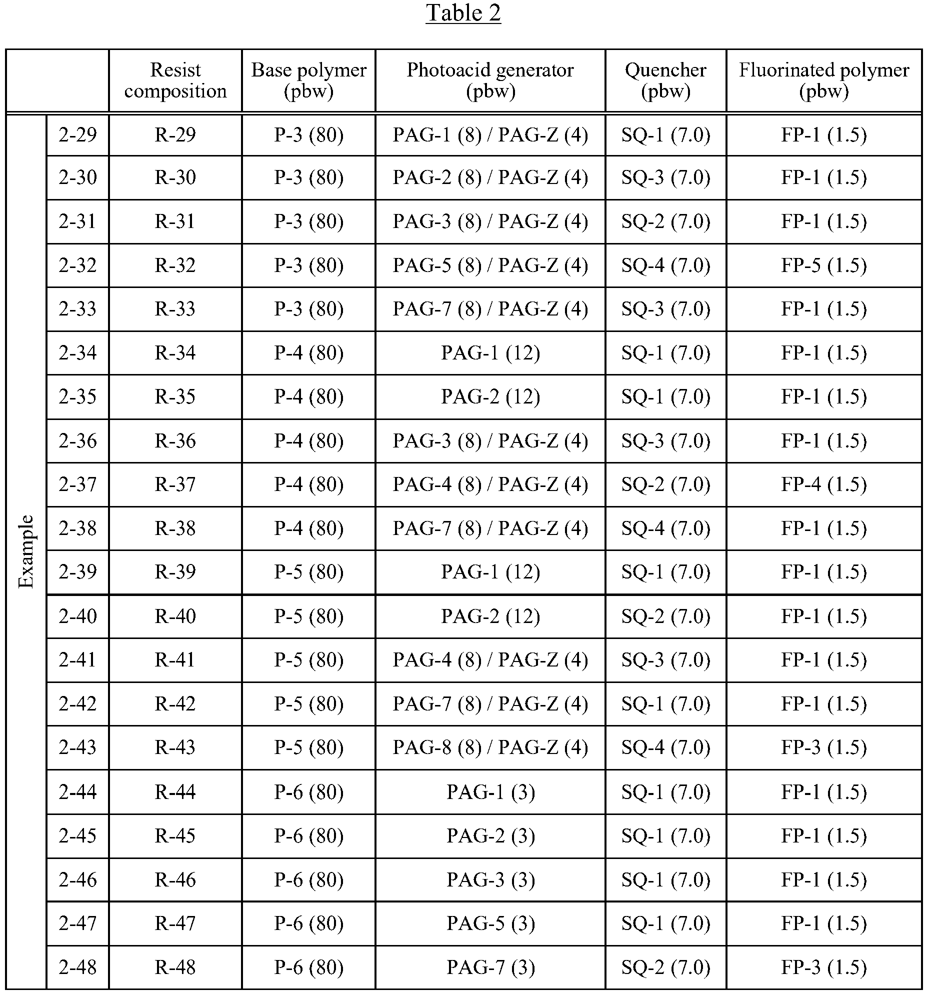

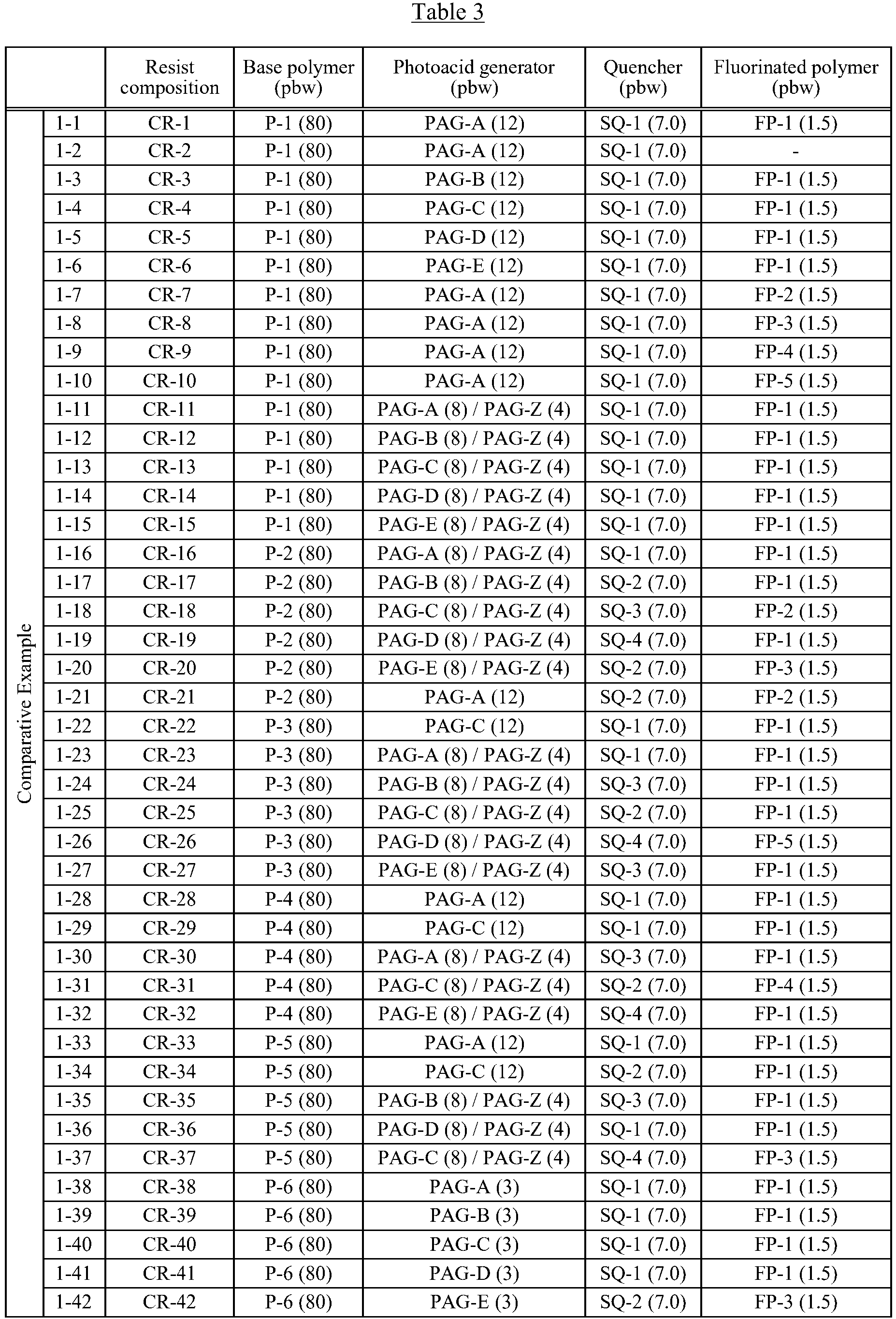

Comparative photoacid generators PAG-A to PAG-E, blending photoacid generator PAG-Z, quenchers SQ-1 to SQ-4, and fluorinated polymers FP-1 to FP-5 in Tables 1 to 3 are identified below.

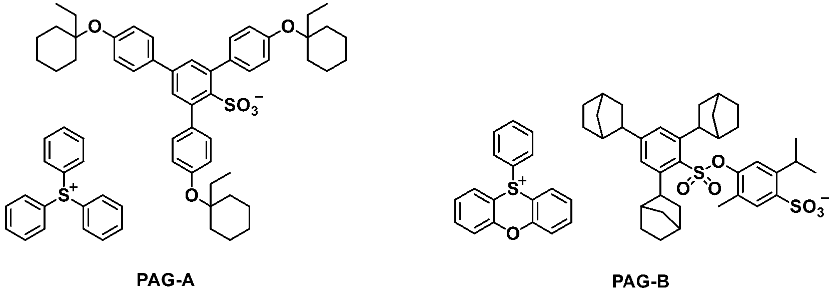

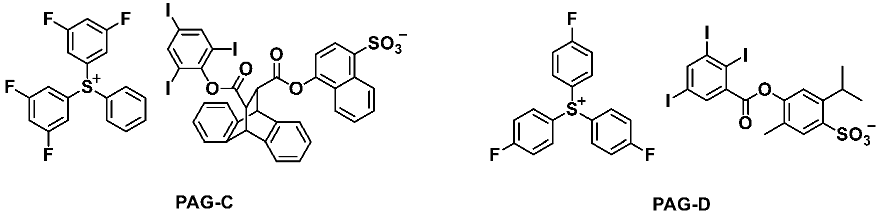

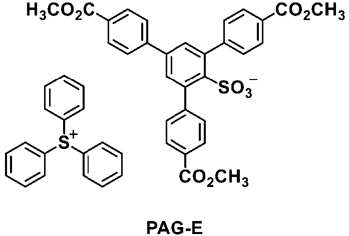

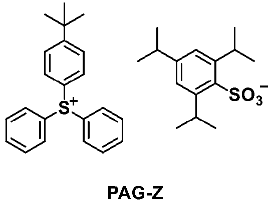

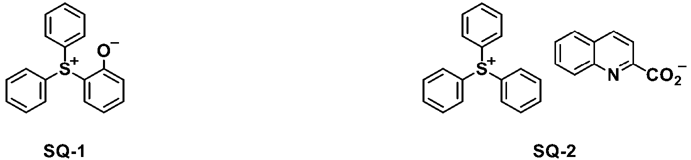

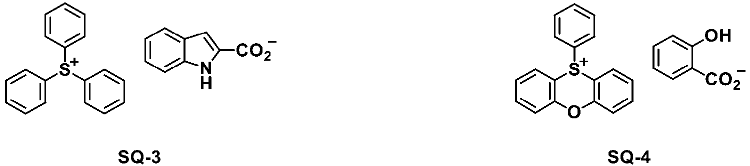

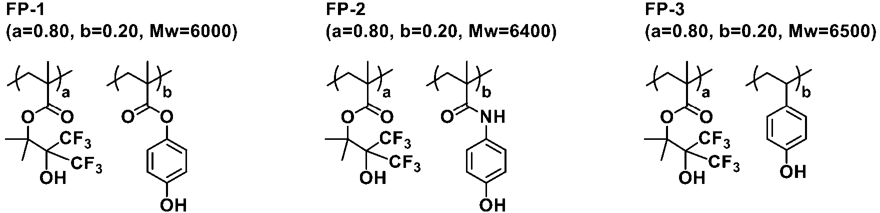

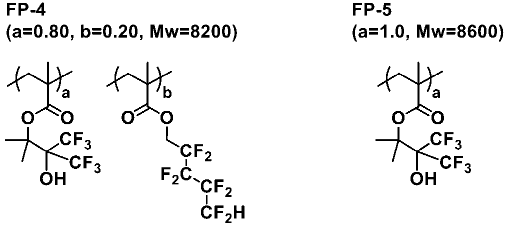

### [4] EB lithography test

### Examples 3-1 to 3-48 and Comparative Examples 2-1 to 2-42

Using a coater/developer system ACT-M (Tokyo Electron Ltd.), each of the resist compositions (R-1 to R-48, CR-1 to CR-42) was spin coated onto a mask blank of reflection type for an EUV lithography mask of 152 mm squares having an outermost surface of chromium compound. The coating was prebaked on a hotplate at 110°C for 600 seconds to form a resist film of 80 nm thick. The thickness of the resist film was measured by an optical film thickness measurement system Nanospec (Nanometrics Inc.). Measurement was made at 81 points in the plane of the blank substrate excluding a peripheral band extending 10 mm inward from the blank periphery, and an average film thickness and a film thickness range were computed therefrom.

The resist film was exposed to EB using an EB writer system EBM-5000Plus (NuFlare Technology Inc., accelerating voltage 50 kV), then baked (PEB) at 110°C for 600 seconds, and developed in a 2.38 wt% TMAH aqueous solution, thereby yielding a positive pattern.

The resist pattern was evaluated as follows. The patterned mask blank was observed under a top-down scanning electron microscope (TD-SEM). The optimum dose (Eop) was defined as the exposure dose (µC/cm²) which provided a 1:1 resolution at the top and bottom of a 200-nm 1:1 line-and-space (LS) pattern. The resolution (or maximum resolution) was defined as the minimum size at the dose which provided a 1:1 resolution of a 200-nm LS pattern. The edge roughness (LER) of a 200-nm LS pattern was measured under SEM. The resolution (or maximum IS resolution) was defined as the minimum size at the dose which provided a 9:1 resolution of a 200-nm 9:1 LS pattern. The results are shown in Tables 4 to 6.

**Table 4**

| | | Resist composition | Optimum dose (µC/cm²) | Maximum resolution (nm) | Maximum IS resolution (nm) | LER (nm) |
|---|---|---|---|---|---|---|
| | 3-1 | R-1 | 200 | 26 | 14 | 2.4 |
| | 3-2 | R-2 | 200 | 26 | 14 | 2.3 |
| | 3-3 | R-3 | 200 | 26 | 16 | 2.4 |
| | 3-4 | R-4 | 205 | 26 | 16 | 2.5 |
| | 3-5 | R-5 | 200 | 28 | 16 | 2.5 |
| | 3-6 | R-6 | 200 | 26 | 16 | 2.4 |
| | 3-7 | R-7 | 200 | 26 | 14 | 2.5 |
| | 3-8 | R-8 | 200 | 26 | 16 | 2.4 |
| | 3-9 | R-9 | 205 | 26 | 16 | 2.3 |
| | 3-10 | R-10 | 200 | 28 | 16 | 2.4 |
| | 3-11 | R-11 | 205 | 26 | 18 | 2.3 |
| | 3-12 | R-12 | 200 | 28 | 16 | 2.4 |
| | 3-13 | R-13 | 205 | 26 | 16 | 2.3 |
| | 3-14 | R-14 | 205 | 26 | 16 | 2.4 |
| Example | 3-15 | R-15 | 205 | 28 | 16 | 2.5 |
| | 3-16 | R-16 | 200 | 26 | 16 | 2.4 |
| | 3-17 | R-17 | 200 | 26 | 16 | 2.3 |
| | 3-18 | R-18 | 205 | 26 | 16 | 2.4 |
| | 3-19 | R-19 | 200 | 26 | 16 | 2.5 |
| | 3-20 | R-20 | 210 | 26 | 16 | 2.4 |
| | 3-21 | R-21 | 205 | 26 | 14 | 2.3 |
| | 3-22 | R-22 | 205 | 26 | 16 | 2.4 |
| | 3-23 | R-23 | 200 | 26 | 16 | 2.3 |
| | 3-24 | R-24 | 205 | 26 | 16 | 2.4 |
| | 3-25 | R-25 | 210 | 26 | 16 | 2.3 |
| | 3-26 | R-26 | 205 | 26 | 16 | 2.4 |
| | 3-27 | R-27 | 200 | 26 | 14 | 2.5 |
| | 3-28 | R-28 | 200 | 26 | 16 | 2.4 |
| | 3-29 | R-29 | 205 | 26 | 16 | 2.5 |
| | 3-30 | R-30 | 210 | 28 | 18 | 2.4 |

**Table 5**

| | | Resist composition | Optimum dose (µC/cm²) | Maximum resolution (nm) | Maximum IS resolution (nm) | LER (nm) |
|---|---|---|---|---|---|---|
| | 3-31 | R-31 | 200 | 26 | 14 | 2.5 |
| | 3-32 | R-32 | 200 | 26 | 16 | 2.5 |
| | 3-33 | R-33 | 205 | 26 | 16 | 2.4 |
| | 3-34 | R-34 | 200 | 26 | 16 | 2.5 |
| | 3-35 | R-35 | 210 | 26 | 16 | 2.6 |
| | 3-36 | R-36 | 205 | 26 | 16 | 2.5 |
| | 3-37 | R-37 | 200 | 26 | 16 | 2.4 |
| | 3-38 | R-38 | 205 | 26 | 16 | 2.5 |
| Example | 3-39 | R-39 | 205 | 26 | 16 | 2.4 |
| | 3-40 | R-40 | 200 | 26 | 16 | 2.5 |
| | 3-41 | R-41 | 205 | 26 | 16 | 2.4 |
| | 3-42 | R-42 | 200 | 26 | 18 | 2.5 |
| | 3-43 | R-43 | 205 | 26 | 16 | 2.5 |
| | 3-44 | R-44 | 200 | 26 | 16 | 2.4 |
| | 3-45 | R-45 | 210 | 28 | 16 | 2.5 |
| | 3-46 | R-46 | 205 | 26 | 18 | 2.6 |
| | 3-47 | R-47 | 200 | 26 | 16 | 2.5 |
| | 3-48 | R-48 | 205 | 26 | 16 | 2.4 |

**Table 6**

| | | Resist composition | Optimum dose (µC/cm²) | Maximum resolution (nm) | Maximum IS resolution (nm) | LER (nm) |
|---|---|---|---|---|---|---|
| | 2-1 | CR-1 | 200 | 30 | 20 | 3.3 |
| | 2-2 | CR-2 | 210 | 30 | 22 | 3.4 |
| | 2-3 | CR-3 | 200 | 30 | 22 | 3.4 |
| | 2-4 | CR-4 | 205 | 30 | 22 | 3.8 |
| | 2-5 | CR-5 | 200 | 30 | 22 | 3.6 |
| | 2-6 | CR-6 | 210 | 30 | 20 | 3.4 |
| | 2-7 | CR-7 | 205 | 32 | 20 | 3.4 |
| | 2-8 | CR-8 | 200 | 30 | 20 | 3.6 |
| | 2-9 | CR-9 | 210 | 30 | 20 | 3.5 |
| | 2-10 | CR-10 | 205 | 30 | 20 | 3.6 |
| | 2-11 | CR-11 | 200 | 32 | 20 | 3.5 |
| | 2-12 | CR-12 | 205 | 32 | 22 | 3.6 |
| | 2-13 | CR-13 | 210 | 30 | 22 | 3.3 |
| | 2-14 | CR-14 | 200 | 30 | 20 | 3.4 |
| | 2-15 | CR-15 | 210 | 30 | 20 | 3.4 |
| | 2-16 | CR-16 | 200 | 30 | 22 | 3.6 |
| | 2-17 | CR-17 | 205 | 30 | 20 | 3.4 |
| | 2-18 | CR-18 | 200 | 32 | 20 | 3.6 |
| | 2-19 | CR-19 | 210 | 32 | 20 | 3.5 |
| | 2-20 | CR-20 | 205 | 30 | 20 | 3.4 |
| Comparative Example | 2-21 | CR-21 | 200 | 30 | 20 | 3.6 |
| | 2-22 | CR-22 | 210 | 30 | 20 | 3.5 |
| | 2-23 | CR-23 | 200 | 30 | 20 | 3.6 |
| | 2-24 | CR-24 | 200 | 32 | 20 | 3.6 |
| | 2-25 | CR-25 | 210 | 30 | 20 | 3.4 |
| | 2-26 | CR-26 | 210 | 34 | 20 | 3.6 |
| | 2-27 | CR-27 | 200 | 30 | 20 | 3.6 |
| | 2-28 | CR-28 | 205 | 30 | 22 | 3.6 |
| | 2-29 | CR-29 | 200 | 30 | 20 | 3.5 |
| | 2-30 | CR-30 | 210 | 32 | 20 | 3.6 |
| | 2-31 | CR-31 | 205 | 32 | 22 | 3.6 |
| | 2-32 | CR-32 | 200 | 32 | 20 | 3.5 |
| | 2-33 | CR-33 | 210 | 30 | 20 | 3.6 |
| | 2-34 | CR-34 | 205 | 30 | 20 | 3.4 |
| | 2-35 | CR-35 | 200 | 32 | 22 | 3.5 |
| | 2-36 | CR-36 | 200 | 32 | 22 | 3.6 |
| | 2-37 | CR-37 | 200 | 30 | 22 | 3.2 |
| | 2-38 | CR-38 | 210 | 34 | 20 | 3.4 |
| | 2-39 | CR-39 | 210 | 30 | 20 | 3.3 |
| | 2-40 | CR-40 | 200 | 32 | 22 | 3.2 |
| | 2-41 | CR-41 | 205 | 32 | 22 | 3.4 |
| | 2-42 | CR-42 | 210 | 30 | 22 | 3.3 |

As is evident from Tables 4 to 6, chemically amplified positive resist compositions (R-1 to R-48) within the scope of the invention exhibit satisfactory resolution and reduced LER. In contrast, resist compositions (CR-1 to CR-42) of Comparative Examples fail in optimization of acid diffusion and contrast and exhibit poor results of resolution and LER.

It has been demonstrated that the chemically amplified positive resist composition and resist pattern forming process according to the invention are useful in the photolithography for the fabrication of semiconductor devices, especially the processing of photomask blanks of transmission and reflection types.

## Claims

1. A chemically amplified positive resist composition comprising (A) a photoacid generator in the form of a sulfonium salt consisting of a cation having the formula (A1) and an anion having the formula (A2) and (B) a base polymer containing a polymer which is decomposed under the action of acid to increase its solubility in an alkaline developer, the polymer comprising repeat units having the formula (B1): 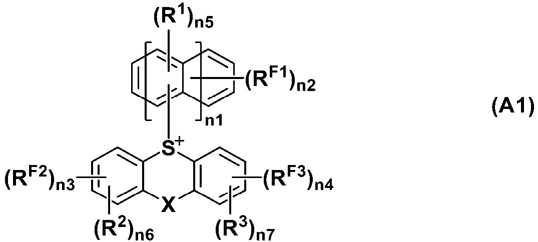
wherein n1 is 0 or 1, n2 is 1 or 2, n3 is 0, 1 or 2, n4 is 0, 1 or 2, n5 is 0, 1 or 2, n6 is 0, 1 or 2, n7 is 0, 1 or 2, meeting 1 ≤ n2+n5 ≤ 5 when n1=0, 0 ≤ n2+n5 ≤ 7 when n1=1, 0 ≤ n3+n6 ≤ 4, and 0 ≤ n4+n7 ≤ 4,
R^{F1}, R^{F2} and R^{F3} are each independently fluorine, a C₁-C₆ fluorinated alkyl group, C₁-C₆ fluorinated alkoxy group, C₁-C₆ fluorinated alkylthio group, or pentafluorosulfanyl,
R¹, R² and R³ are each independently halogen exclusive of fluorine, nitro, cyano, hydroxy, carboxy, a C₁-C₂₀ hydrocarbyl group which may contain a heteroatom, C₁-C₂₀ hydrocarbyloxy group which may contain a heteroatom, or C₁-C₂₀ hydrocarbylthio group which may contain a heteroatom, exclusive of C₁-C₆ fluorinated alkyl group, C₁-C₆ fluorinated alkoxy group, and C₁-C₆ fluorinated alkylthio group; when n5=2, two R¹ may be identical or different and two R¹ may bond together to form a ring with the carbon atom to which they are attached; when n6=2, two R² may be identical or different and two R² may bond together to form a ring with the carbon atom to which they are attached; when n7=2, two R³ may be identical or different and two R³ may bond together to form a ring with the carbon atom to which they are attached;
X is a single bond, -CH₂-, -O-, -S-, -S(=O)-, -SO₂-, -N(H)-, -N(CH₃)- or -C(=O)-, 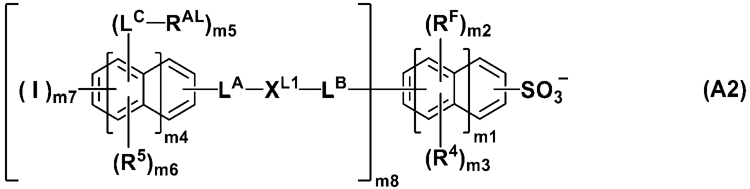
wherein m1 is 0 or 1, m2 is 0, 1, 2, 3 or 4, m3 is 0, 1, 2, 3 or 4, m4 is 0 or 1, m5 is 0, 1, 2, 3 or 4, m6 is 0, 1, 2, 3 or 4, m7 is 0, 1, 2, 3 or 4, m8 is 0, 1, 2, 3 or 4, meeting 1 ≤ m2+m3+m8 ≤ 5 when m1=0, 1 ≤ m2+m3+m8 ≤ 7 when m1=1, and 0 ≤ m5+m6+m7 ≤ 5 when m2=0, 0 ≤ m5+m6+m7 ≤ 7 when m2=1,
R⁴ is halogen exclusive of fluorine, nitro, cyano, hydroxy, carboxy, a C₁-C₂₀ hydrocarbyl group which may contain a heteroatom, C₁-C₂₀ hydrocarbyloxy group which may contain a heteroatom, C₁-C₂₀ hydrocarbylthio group which may contain a heteroatom, or C₂-C₂₀ hydrocarbyloxycarbonyl group which may contain a heteroatom; when m3 is 2, 3 or 4, a plurality of R⁴ may be identical or different and a plurality of R⁴ may bond together to form a ring with the carbon atoms to which they are attached;
R⁵ is halogen exclusive of iodine, nitro, cyano, hydroxy, carboxy, pentafluorosulfanyl, a C₁-C₂₀ hydrocarbyl group which may contain a heteroatom, C₁-C₂₀ hydrocarbyloxy group which may contain a heteroatom, C₁-C₂₀ hydrocarbylthio group which may contain a heteroatom, or C₂-C₂₀ hydrocarbyloxycarbonyl group which may contain a heteroatom; when m6 is 2, 3 or 4, a plurality of R⁵ may be identical or different and a plurality of R⁵ may bond together to form a ring with the carbon atoms to which they are attached;
R^{F} is fluorine, a C₁-C₆ fluorinated saturated hydrocarbyl group, C₁-C₆ fluorinated saturated hydrocarbyloxy group, C₁-C₆ fluorinated saturated hydrocarbylthio group, or pentafluorosulfanyl; when m2 is 2, 3 or 4, a plurality of R^{F} may be identical or different,
R^{AL} is an acid labile group,
L^{A} and L^{B} are each independently a single bond, ether bond, ester bond, sulfonate ester bond, amide bond, sulfonamide bond, carbonate bond or carbamate bond,
L^{C} is an ether bond, ester bond or carbonate bond,
X^{L1} is a single bond or a C₁-C₄₀ hydrocarbylene group which may contain a heteroatom, 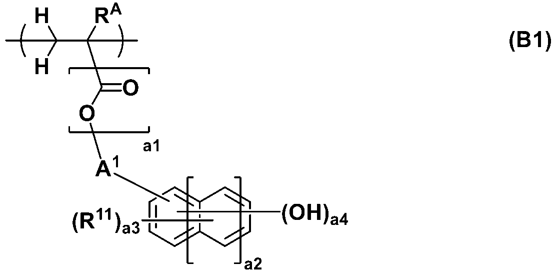
wherein a1 is 0 or 1, a2 is 0, 1 or 2, a3 is an integer meeting 0 ≤ a3 ≤ 5+2(a2)-a4, a4 is 1, 2 or 3,
R^{A} is hydrogen, fluorine, methyl or trifluoromethyl,
R¹¹ is halogen, nitro, carboxy, an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group; when a3 is 2 or more, a plurality of R¹¹ may be identical or different, and
A¹ is a single bond or a C₁-C₁₀ saturated hydrocarbylene group in which some -CH₂-may be replaced by -O-.

2. The positive resist composition of claim 1 wherein the anion has the formula (A2-2): 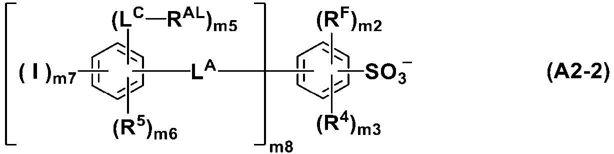 wherein m2, m3, m5 to m8, R⁴, R⁵, R^{F}, R^{AL}, L^{A}, and L^{C} are as defined above.

3. The positive resist composition of claim 1 or 2wherein the acid labile group has the formula (AL-1) or (AL-2): 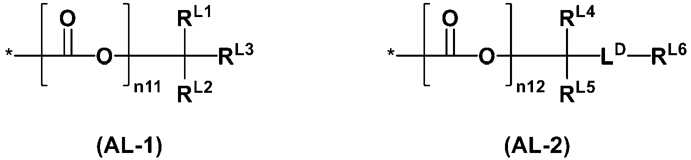 wherein n11 is 0 or 1, n12 is 0 or 1,
R^{L1} and R^{L2} are each independently a C₁-C₁₂ hydrocarbyl group, R^{L3} is hydrogen or a C₁-C₁₂ hydrocarbyl group; some -CH₂- in the hydrocarbyl group represented by R^{L1}, R^{L2} and R^{L3} may be replaced by -O- or -S-; when the hydrocarbyl group contains an aromatic ring, some or all of the hydrogen atoms on the aromatic ring may be substituted by halogen, cyano, nitro, a C₁-C₄ alkyl moiety which may contain halogen, or C₁-C₄ alkoxy moiety which may contain halogen; R^{L1} and R^{L2} may bond together to form a ring with the carbon atom to which they are attached, some -CH₂- in the ring may be replaced by -O- or -S-, with the proviso that when R^{L3} is hydrogen, R^{L1} and R^{L2} bond together to form a multiple bond-containing alicyclic structure with the carbon atom to which they are attached, some hydrogen on the alicyclic structure may be substituted by halogen,
R^{L4} and R^{L5} are each independently hydrogen or a C₁-C₁₀ hydrocarbyl group, R^{L6} is a C₁-C₂₀ hydrocarbyl group, some -CH₂- in the hydrocarbyl group may be replaced by -O- or -S-; R^{L5} and R^{L6} may bond together to form a C₃-C₂₀ heterocyclic group with the carbon atom and L^{D} to which they are attached, some -CH₂- in the heterocyclic group may be replaced by -O- or -S-,
L^{D} is -O- or -S-,
* designates a point of attachment to L^{C}.

4. The positive resist composition of any one of claims 1 to 3 wherein the polymer further comprises repeat units having the formula (B2-1): 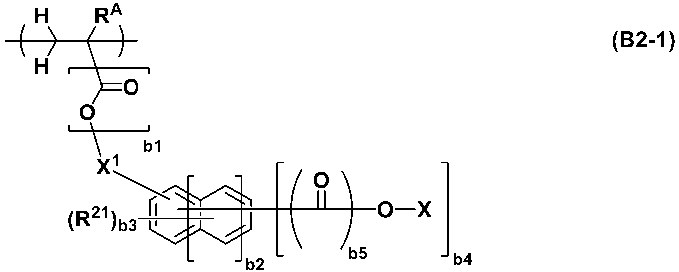 wherein b1 is 0 or 1, b2 is 0, 1 or 2, b3 is an integer meeting 0 ≤ b3 ≤ 5+2(b2)-b4, b4 is 1, 2 or 3, b5 is 0 or 1,
R^{A} is hydrogen, fluorine, methyl or trifluoromethyl,
R²¹ is halogen or an optionally halogenated C₁-C₆ saturated hydrocarbyl group, optionally halogenated C₁-C₆ saturated hydrocarbyloxy group, or optionally halogenated C₂-C₈ saturated hydrocarbylcarbonyloxy group, a plurality of R²¹ may be identical or different when b3 is 2 or more,
X¹ is a single bond or C₁-C₁₀ saturated hydrocarbylene group in which some -CH₂-may be replaced by -O-, and
X is an acid labile group when b4=1, and X is each independently hydrogen or an acid labile group, at least one being an acid labile group, when b4 is 2 or 3.

5. The positive resist composition of any one of claims 1 to 4 wherein the polymer further comprises repeat units having the formula (B2-2): 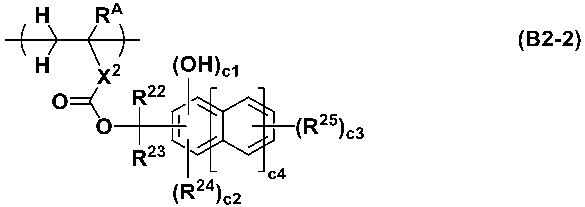 wherein c1 is 0, 1 or 2, c2 is 0, 1 or 2, c3 is 0, 1, 2, 3, 4 or 5, c4 is 0, 1 or 2,
R^{A} is hydrogen, fluorine, methyl or trifluoromethyl,
R²² and R²³ are each independently a C₁-C₁₀ hydrocarbyl group which may contain a heteroatom, R²² and R²³ may bond together to form a ring with the carbon atom to which they are attached,
R²⁴ is each independently fluorine, a C₁-C₅ fluorinated alkyl group or C₁-C₅ fluorinated alkoxy group, two R²⁴ may be identical or different when c2=2,
R²⁵ is each independently a C₁-C₁₀ hydrocarbyl group which may contain a heteroatom, a plurality of R²⁵ may be identical or different when c3 is 2, 3, 4 or 5, and
X² is a single bond, phenylene group, naphthylene group or *-C(=O)-O-X²¹-, X²¹ is a C₁-C₂₀ aliphatic hydrocarbylene group which may contain a hydroxy, ether bond, ester bond or lactone ring, or phenylene group or naphthylene group.

6. The positive resist composition of any one of claims 1 to 5 wherein the polymer further comprises repeat units having the formula (B2-3): 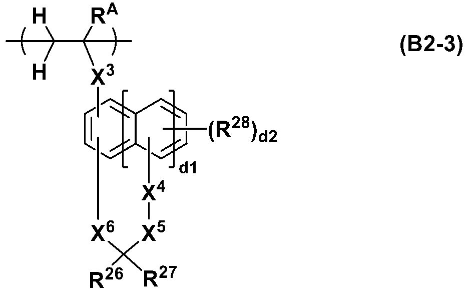 wherein d1 is 0 or 1, d2 is 0, 1, 2 or 3 when d1=0, d2 is 0, 1, 2, 3, 4 or 5 when d1=1,
R^{A} is hydrogen, fluorine, methyl or trifluoromethyl,
X³ is a single bond, *-C(=O)-O- or *-C(=O)-N(H)-, * designates a point of attachment to the carbon atom in the backbone,
X⁴ is a single bond, a C₁-C₄ aliphatic hydrocarbylene group, carbonyl, sulfonyl or a group obtained by combining the foregoing,
X⁵ and X⁶ are each independently oxygen or sulfur, with the proviso that X⁴ and X⁶ are bonded to adjoining carbon atoms on the aromatic ring,
R²⁶ and R²⁷ are each independently hydrogen or a C₁-C₂₀ hydrocarbyl group which may contain a heteroatom, R²⁶ and R²⁷ may bond together to form a ring with the carbon atom to which they are attached, and
R²⁸ is halogen, hydroxy, cyano, nitro, pentafluorosulfanyl, a C₁-C₂₀ hydrocarbyl group which may contain a heteroatom, C₁-C₂₀ hydrocarbyloxy group which may contain a heteroatom, C₂-C₂₀ hydrocarbyloxycarbonyl group which may contain a heteroatom, C₁-C₂₀ hydrocarbylthio group which may contain a heteroatom, or -N(R^{28A})(R^{28B}), R^{28A} and R^{28B} are each independently hydrogen or a C₁-C₆ hydrocarbyl group; when b2 is 2 or more, a plurality of R²⁸ may be identical or different and a plurality of R²⁸ may bond together to form a ring with the carbon atoms on the aromatic ring to which they are attached.

7. The positive resist composition of any one of claims 1 to 6 wherein the polymer further comprises repeat units of at least one type selected from repeat units having the formula (B3), repeat units having the formula (B4), and repeat units having the formula (B5): 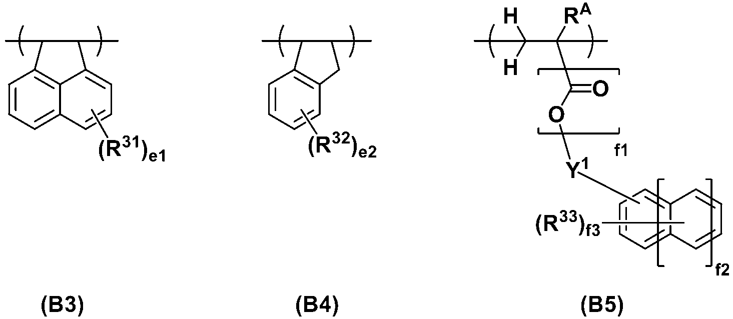 wherein e1 is 0, 1, 2, 3, 4, 5 or 6, e2 is 0, 1, 2, 3 or 4, f1 is 0 or 1, f2 is 0, 1 or 2, f3 is 0, 1, 2, 3, 4 or 5,
R^{A} is hydrogen, fluorine, methyl or trifluoromethyl,
R³¹ and R³² are each independently hydroxy, halogen, an optionally halogenated C₁-C₈ saturated hydrocarbyl group, optionally halogenated C₁-C₈ saturated hydrocarbyloxy group, or optionally halogenated C₂-C₈ saturated hydrocarbylcarbonyloxy group; a plurality of R³¹ may be identical or different when e1 is 2, 3, 4, 5 or 6, and a plurality of R³² may be identical or different when e2 is 2, 3 or 4,
R³³ is a C₁-C₂₀ saturated hydrocarbyl group, C₁-C₂₀ saturated hydrocarbyloxy group, C₂-C₂₀ saturated hydrocarbylcarbonyloxy group, C₂-C₂₀ saturated hydrocarbyloxyhydrocarbyl group, C₂-C₂₀ saturated hydrocarbylthiohydrocarbyl group, halogen, nitro, cyano, C₁-C₂₀ saturated hydrocarbylsulfinyl group, or C₁-C₂₀ saturated hydrocarbylsulfonyl group, R³³ may also be hydroxy when f2 is 1 or 2, a plurality of R³³ may be identical or different when f3 is 2, 3, 4 or 5, and
Y¹ is a single bond or C₁-C₁₀ saturated hydrocarbylene group in which some -CH₂-may be replaced by -O-.

8. The positive resist composition of any one of claims 1 to 7 wherein the polymer further comprises repeat units of at least one type selected from repeat units having the formula (B6), repeat units having the formula (B7), repeat units having the formula (B8), repeat units having the formula (B9), and repeat units having the formula (B10): 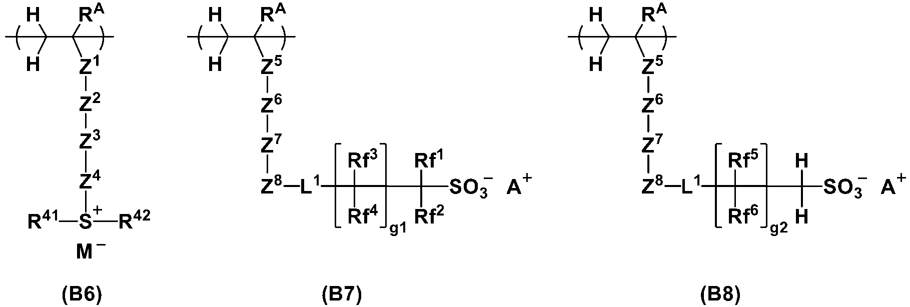 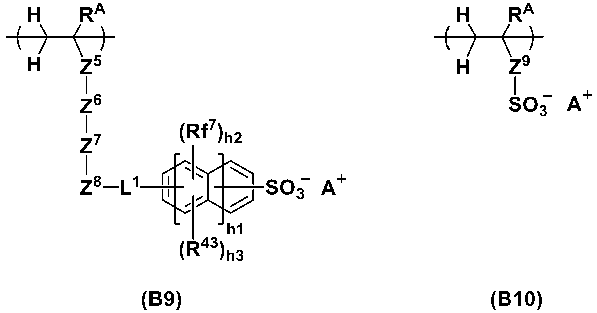 wherein g1 and g2 are each independently 0, 1, 2 or 3, h1 is 0 or 1, h2 is 0, 1, 2, 3 or 4, h3 is 0, 1, 2, 3 or 4, meeting 0 ≤ h2+h3 ≤ 4 when h1=0, and 0 ≤ h2+h3 ≤ 6 when h1=1,
R^{A} is each independently hydrogen, fluorine, methyl or trifluoromethyl,
Z¹ is a single bond or an optionally substituted phenylene group,
Z² is a single bond, **-C(=O)-O-Z²¹-, **-C(=O)-N(H)-Z²¹-, or **-O-Z²¹-, Z²¹ is a C₁-C₆ aliphatic hydrocarbylene group, phenylene group or a divalent group obtained by combining the foregoing, which may contain halogen, carbonyl moiety, ester bond, ether bond or hydroxy moiety,
Z³ is a single bond, ether bond, ester bond, amide bond, sulfonate ester bond, sulfonamide bond, carbonate bond or carbamate bond,
Z⁴ is a single bond, or a C₁-C₆ aliphatic hydrocarbylene group, phenylene group or a divalent group obtained by combining the foregoing, which may contain halogen, carbonyl moiety, ester bond, ether bond or hydroxy moiety,
Z⁵ is each independently a single bond, an optionally substituted phenylene, naphthylene, or *-C(=O)-O-Z⁵¹-, Z⁵¹ is a C₁-C₁₀ aliphatic hydrocarbylene group which may contain halogen, hydroxy moiety, ether bond, ester bond or lactone ring, or phenylene or naphthylene group,
Z⁶ is a single bond, ether bond, ester bond, amide bond, sulfonate ester bond, sulfonamide bond, carbonate bond or carbamate bond,
Z⁷ is each independently a single bond, ***-Z⁷¹-C(=O)-O-, ***-C(=O)-N(H)-Z⁷¹-, or ***-O-Z⁷¹-, Z⁷¹ is a C₁-C₂₀ hydrocarbylene group which may contain a heteroatom,
Z⁸ is each independently a single bond, ****-Z⁸¹-C(=O)-O-, ****-C(=O)-N(H)-Z⁸¹. or ****-O-Z⁸¹-, Z⁸¹ is a C₁-C₂₀ hydrocarbylene group which may contain a heteroatom,
Z⁹ is a single bond, methylene, ethylene, phenylene, fluorinated phenylene, trifluoromethyl-substituted phenylene, *-C(=O)-O-Z⁹¹-, *-C(=O)-N(H)-Z⁹¹-, or *-O-Z⁹¹-, Z⁹¹ is a C₁-C₆ aliphatic hydrocarbylene group, phenylene group, fluorinated phenylene group or trifluoromethyl-substituted phenylene group, which may contain a carbonyl moiety, ester bond, ether bond or hydroxy moiety,
* is a point of attachment to the carbon atom in the backbone, ** is a point of attachment to Z¹, *** is a point of attachment to Z⁶, **** is a point of attachment to Z⁷,
L¹ is a single bond, ether bond, ester bond, carbonyl group, sulfonate ester bond, sulfonamide bond, carbonate bond or carbamate bond,
Rf¹ and Rf² are each independently fluorine or a C₁-C₆ fluorinated saturated hydrocarbyl group,
Rf³ and Rf⁴ are each independently hydrogen, fluorine, or a C₁-C₆ fluorinated saturated hydrocarbyl group,
Rf⁵ and Rf⁶ are each independently hydrogen, fluorine, or a C₁-C₆ fluorinated saturated hydrocarbyl group, excluding that all Rf⁵ and Rf⁶ are hydrogen at the same time,
Rf⁷ is fluorine, a C₁-C₆ fluorinated alkyl group, C₁-C₆ fluorinated alkoxy group, or C₁-C₆ fluorinated alkylthio group, a plurality of Rf⁷ may be identical or different when h2 is 2, 3 or 4,
R⁴¹ and R⁴² are each independently a C₁-C₂₀ hydrocarbyl group which may contain a heteroatom, R⁴¹ and R⁴² may bond together to form a ring with the sulfur atom to which they are attached,
R⁴³ is halogen exclusive of fluorine, or a C₁-C₂₀ hydrocarbyl group which may contain a heteroatom; when h3 is 2, 3 or 4, a plurality of R⁴³ may be identical or different and a plurality of R⁴³ may bond together to form a ring with the carbon atoms to which they are attached,
M⁻ is a non-nucleophilic counter ion, and
A⁺ is an onium cation.

9. The positive resist composition of any one of claims 1 to 8 wherein repeat units having an aromatic ring structure account for at least 60 mol% of the overall repeat units of the polymer in the base polymer.

10. The positive resist composition of any one of claims 1 to 9, further comprising an organic solvent.

11. The positive resist composition of any one of claims 1 to 10, further comprising a quencher.

12. The positive resist composition of any one of claims 1 to 11, further comprising (D) a fluorinated polymer comprising repeat units of at least one type selected from repeat units having the formula (D1), repeat units having the formula (D2), repeat units having the formula (D3) and repeat units having the formula (D4) and optionally repeat units of at least one type selected from repeat units having the formula (D5) and repeat units having the formula (D6): 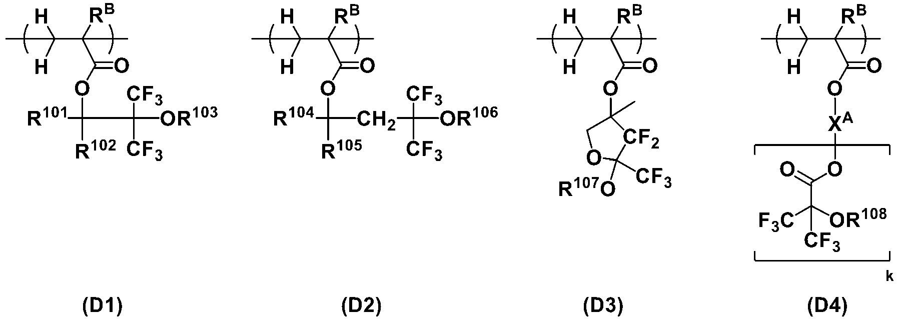 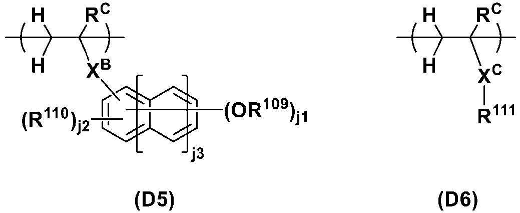 wherein j1 is 1, 2 or 3, j2 is an integer meeting 0 ≤ j2 ≤ 5+2(j3)-j1, j3 is 0 or 1, k is 1, 2 or 3,
R^{B} is each independently hydrogen, fluorine, methyl or trifluoromethyl,
R^{C} is each independently hydrogen or methyl,
R¹⁰¹, R¹⁰², R¹⁰⁴ and R¹⁰⁵ are each independently hydrogen or a C₁-C₁₀ saturated hydrocarbyl group,
R¹⁰³, R¹⁰⁶, R¹⁰⁷ and R¹⁰⁸ are each independently hydrogen, a C₁-C₁₅ hydrocarbyl group, C₁-C₁₅ fluorinated hydrocarbyl group, or acid labile group, and when R¹⁰³, R¹⁰⁶, R¹⁰⁷ and R¹⁰⁸ each are a hydrocarbyl or fluorinated hydrocarbyl group, an ether bond or carbonyl moiety may intervene in a carbon-carbon bond,
R¹⁰⁹ is hydrogen or a C₁-C₅ straight or branched hydrocarbyl group in which a heteroatom-containing moiety may intervene in a carbon-carbon bond, a plurality of R¹⁰⁹ may be identical or different when j1 is 2 or 3,
R¹¹⁰ is a C₁-C₅ straight or branched hydrocarbyl group in which a heteroatom-containing moiety may intervene in a carbon-carbon bond, a plurality of R¹¹⁰ may be identical or different when j2 is 2 or more,
R¹¹¹ is a C₁-C₂₀ saturated hydrocarbyl group in which at least one hydrogen is substituted by fluorine, and in which some -CH₂- may be replaced by an ester bond or ether bond,
X^{A} is a C₁-C₂₀ (k+1)-valent hydrocarbon group or C₁-C₂₀ (k+1)-valent fluorinated hydrocarbon group,
X^{B} is a single bond, *-C(=O)-O- or *-C(=O)-N(H)-, * designates a point of attachment to the carbon atom in the backbone,
X^{C} is a single bond, -O-, *-C(=O)=O-X^{C1}-X^{C2}- or *-C(=O)-N(H)-X^{C1}-X^{C2}. X^{C1} is a single bond or C₁-C₁₀ saturated hydrocarbylene group, X^{C2} is a single bond, ester bond, ether bond, or sulfonamide bond, and * designates a point of attachment to the carbon atom in the backbone.

13. A resist pattern forming process comprising the steps of:
applying the chemically amplified positive resist composition of any one of claims 1 to 12 onto a substrate to form a resist film thereon,
exposing the resist film patternwise to high-energy radiation, and
developing the exposed resist film in an alkaline developer.

14. The process of claim 13 wherein the substrate is a photomask blank.
